# EUROPÄISCHE PATENTSCHRIFT

(11) **EP 3 507 294 B1**
(45) Veröffentlichungstag und Bekanntmachung des Hinweises auf die Patenterteilung: **24.02.2021**
(21) Anmeldenummer: 17757557.8
(22) Anmeldetag: 28.08.2017
(51) Int. Cl.: C07F 15/00, H01L 51/50, H05B 33/14, C09K 11/06, H01L 51/00

(54) **BI- UND TRINUKLEARE METALLKOMPLEXE AUFGEBAUT AUS ZWEI MITEINANDER VERKNÜPFTEN TRIPODALEN HEXADENTATEN LIGANDEN ZUR VERWENDUNG IN ELEKTROLUMINESZENZVORRICHTUNGEN**
BINUCLEAR AND TRINUCLEAR METAL COMPLEXES COMPOSED OF TWO INTER-LINKED TRIPODAL HEXADENTATE LIGANDS FOR USE IN ELECTROLUMINESCENT DEVICES
COMPLEXES MÉTALLIQUES BINUCLÉAIRES ET TRINUCLÉAIRES OBTENUS À PARTIR DE DEUX LIGANDS HEXADENTÉS TRIPODAUX LIÉS ENTRE EUX, DESTINÉS À ÊTRE UTILISÉS DANS DES DISPOSITIFS ÉLECTROLUMINESCENTS

(30) Priorität: 30.08.2016 EP 16186313; 10.05.2017 KR 20170058261
(43) Veröffentlichungstag der Anmeldung: 10.07.2019
(73) Patentinhaber: Merck Patent GmbH, 64293 Darmstadt (DE)
(72) Erfinder: STOESSEL, Philipp, 60389 Frankfurt Am Main (DE); EHRENREICH, Christian, 64285 Darmstadt (DE); HARBACH, Philipp, 64367 Muehtal (DE); HAYER, Anna, 64293 Darmstadt (DE)
(86) Internationale Anmeldenummer: PCT/EP2017/071521
(87) Internationale Veröffentlichungsnummer: WO 2018/041769

(56) Entgegenhaltungen:
- WO-A1-2016/124304
- US-A1- 2003 152 802

## Beschreibung

Die vorliegende Erfindung betrifft bi- und trinukleare Metallkomplexe, welche sich für den Einsatz als Emitter in organischen Elektrolumineszenzvorrichtungen eignen.

Gemäß dem Stand der Technik werden in phosphoreszierenden organischen Elektrolumineszenzvorrichtungen (OLEDs) als Triplettemitter vor allem bis- und tris-ortho-metallierte Iridiumkomplexe mit aromatischen Liganden eingesetzt, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)-iridium(III) und Derivate davon, wobei als Liganden beispielsweise 1- oder 3-Phenylisochinoline, 2-Phenylchinoline oder Phenylcarbene einsetzt werden. Dabei weisen diese Iridiumkomplexe im Allgemeinen eine recht lange Lumineszenzlebensdauer auf, z. B. 1.6 µs im Fall von Tris(phenyl-pyridyl)iridium(III) bei einer Photolumineszenzquantenausbeute von 90 ± 5% in Dichlormethan (Inorg. Chem. 2010, 9290). Für die Verwendung in OLEDs sind jedoch kurze Lumineszenzlebensdauern gewünscht, um die OLED bei einer hohen Helligkeit mit einem geringen Roll-off-Verhalten betreiben zu können. Auch bei der Effizienz rot phosphoreszierender Emitter gibt es noch Verbesserungsbedarf. Durch das geringe Triplettniveau T₁ liegt bei üblichen rot phosphoreszierenden Emittern die Photolumineszenzquantenausbeute häufig deutlich unter dem theoretisch möglichen Wert, da bei kleinem T₁ auch nicht-radiative Kanäle eine größere Rolle spielen, insbesondere wenn der Komplex eine hohe Lumineszenzlebensdauer aufweist. Hier ist eine Verbesserung durch Erhöhung der radiativen Raten wünschenswert, was wiederum durch eine Reduktion der Photolumineszenzlebensdauer erreicht werden kann. Aus US 2003/0152802 sind zweikernige Metallkomplexe bekannt, in denen zwei Metallatome durch einen quadridentaten Liganden, der an die beiden Metallatome koordiniert, verknüpft sind.

Eine Verbesserung der Stabilität der Komplexe konnte durch die Verwendung polypodaler Liganden erreicht werden, wie beispielsweise in WO 2004/081017, US 7,332,232 und WO 2016/124304 beschrieben. Auch wenn diese Komplexe Vorteile gegenüber Komplexen zeigen, die ansonsten die gleiche Ligandenstruktur aufweisen, deren einzelne Liganden jedoch nicht polypodal verbrückt sind, gibt es auch noch Verbesserungsbedarf. So sind auch bei Komplexen mit polypodalen Liganden noch Verbesserungen in Bezug auf die Eigenschaften bei Verwendung in einer organischen Elektrolumineszenzvorrichtung, insbesondere in Bezug auf Effizienz, Spannung und/oder Lebensdauer, wünschenswert.

Aufgabe der vorliegenden Erfindung ist daher die Bereitstellung neuer Metallkomplexe, welche sich als Emitter für die Verwendung in OLEDs eignen. Insbesondere ist die Aufgabe, Emitter bereitzustellen, welche verbesserte Eigenschaften in Bezug Photolumineszenzquantenausbeute und/oder Lumineszenzlebensdauer zeigen und/oder welche bei Verwendung in OLEDs verbesserte Eigenschaften in Bezug auf Effizienz, Betriebsspannung und/oder Lebensdauer zeigen.

Überraschend wurde gefunden, dass die unten beschriebenen bi- und trinuklearen Rhodium- und Iridiumkomplexe deutliche Verbesserungen der photophysikalischen Eigenschaften zeigen gegenüber entsprechenden mononuklearen Komplexen und dadurch auch zu verbesserten Eigenschaften bei Verwendung in einer organischen Elektrolumineszenzvorrichtung führen. Insbesondere weisen die erfindungsgemäßen Verbindungen eine verbesserte Photolumineszenzquantenausbeute sowie eine deutlich reduzierte Lumineszenzlebensdauer auf. Eine geringere Lumineszenzlebensdauer führt zu einem verbesserten Roll-off-Verhalten der organischen Elektrolumineszenzvorrichtung. Diese Komplexe und organische Elektrolumineszenzvorrichtungen, welche diese Komplexe enthalten, sind der Gegenstand der vorliegenden Erfindung.

Gegenstand der Erfindung ist somit eine Verbindung gemäß der folgenden Formel (1) oder (2), 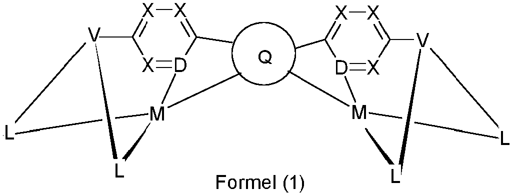 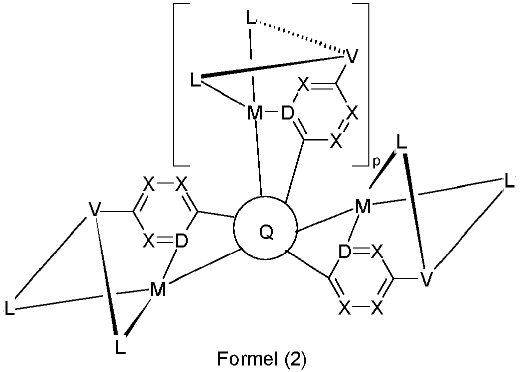 wobei für die verwendeten Symbole und Indizes gilt:
- M: ist bei jedem Auftreten gleich oder verschieden Iridium oder Rhodium;
- Q: ist eine Aryl- oder Heteroarylgruppe mit 6 oder 10 aromatischen Ringatomen, welche gleich oder verschieden über jeweils ein Kohlenstoff- oder Stickstoffatom an jedes der beiden bzw. drei M koordiniert und welche mit einem oder mehreren Resten R substituiert sein kann; dabei sind die koordinierenden Atome in Q nicht in ortho-Position zueinander gebunden;
- D: ist bei jedem Auftreten gleich oder verschieden C oder N;
- X: ist bei jedem Auftreten gleich oder verschieden und ist CR oder N;
- p: ist 0 oder 1 ;
- V: ist bei jedem Auftreten gleich oder verschieden eine Gruppe der folgenden Formel (3) oder (4), 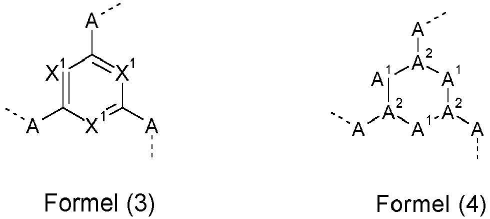 wobei eine der gestrichelten Bindungen die Bindung an die entsprechende in Formel (1) bzw. (2) dargestellte 6-Ring-Aryl- bzw. Heteroarylgruppe darstellt und die beiden anderen gestrichelten Bindungen jeweils die Bindungen an die Teilliganden L darstellen;
- L: ist bei jedem Auftreten gleich oder verschieden ein bidentater, monoanionischer Teilligand, ausgewählt aus den Strukturen der Formeln (L-1), (L-2) oder (L-3), 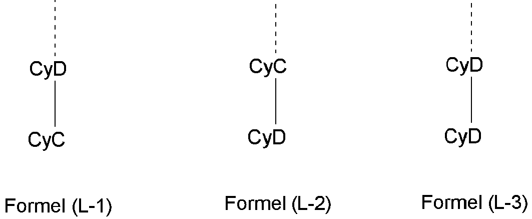 wobei die gestrichelte Bindung die Bindung des Teilliganden L an die Gruppe der Formel (3) bzw. (4) darstellt und für die weiteren verwendeten Symbole gilt:
CyC ist gleich oder verschieden bei jedem Auftreten eine substituierte oder unsubstituierte Aryl- oder Heteroarylgruppe mit 5 bis 14 aromatischen Ringatomen, welche über ein Kohlenstoffatom an M koordiniert und welche über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an M koordiniert und welche über eine kovalente Bindung mit CyC verbunden ist; dabei können mehrere der optionalen Substituenten miteinander ein Ringsystem bilden;
- X¹: ist bei jedem Auftreten gleich oder verschieden CR oder N;
- A¹: ist bei jedem Auftreten gleich oder verschieden C(R)₂;
- A²: ist bei jedem Auftreten gleich oder verschieden CR;
- A: ist bei jedem Auftreten gleich oder verschieden -CR=CR-, -C(=O)-NR'-, -C(=O)-O-, -CR₂-CR₂-, -CR₂-O- oder eine Gruppe der folgenden Formel (5), 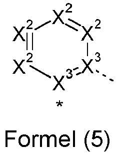 wobei die gestrichelte Bindung die Position der Bindung eines bidentaten Teilliganden L bzw. der entsprechenden in Formel (1) bzw. (2) abgebildeten 6-Ring-Aryl- bzw. Heteroarylgruppe an diese Struktur darstellt und * die Position der Verknüpfung der Einheit der Formel (5) mit der zentralen cyclischen Gruppe darstellt, also der Gruppe, die explizit in Formel (3) bzw. (4) aufgeführt ist;
- X²: ist bei jedem Auftreten gleich oder verschieden CR oder N oder zwei benachbarte Gruppen X² stehen zusammen für NR, O oder S, so dass ein Fünfring entsteht, und die verbleibenden X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² für N stehen;
- X³: ist bei jedem Auftreten C oder eine Gruppe X³ steht für N und die andere Gruppe X³ in demselben Cyclus steht für C; mit der Maßgabe, dass zwei benachbarte Gruppen X² zusammen für CR oder N stehen, wenn in dem Cyclus eine der Gruppen X³ für N steht;
- R: ist bei jedem Auftreten gleich oder verschieden H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, COO(Kation), SO₃(Kation), OSO₃(Kation), OPO₃(Kation)₂, O(Kation), N(R¹)₃(Anion), P(R¹)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
- R': ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann;
- R¹: ist bei jedem Auftreten gleich oder verschieden H, D, F, Cl, Br, I, N(R²)₂, CN, NO₂, OR₂, SR², Si(R²)₃, B(OR²)₂, C(=O)R², P(=O)(R²)₂, S(=O)R², S(=O)₂R², OSO₂R², COO(Kation), SO₃(Kation), OSO₃(Kation), OPO₃(Kation)₂, O(Kation), N(R²)₃(Anion), P(R²)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können;
- Kation: ist bei jedem Auftreten gleich oder verschieden ausgewählt aus der Gruppe bestehend aus Proton, Deuteron, Alkaliionen, Erdalkaliionen, Ammonium, Tetraalkylammonium und Tetraalkylphosphonium;
- Anion: ist bei jedem Auftreten gleich oder verschieden ausgewählt aus der Gruppe bestehend aus Halogeniden, Carboxylaten R²-COO-, Cyanid, Cyanat, Isocyanat, Thiocyanat, Thioisocyanat, Hydroxid, BF₄⁻, PF₆⁻, B(C₆F₅)₄⁻, Carbonat und Sulfonaten.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können die Reste, die miteinander ein Ringsystem bilden, benachbart sein, d. h. diese Reste sind an dasselbe Kohlenstoffatom oder an Kohlenstoffatome, die direkt aneinander gebunden sind, gebunden, oder sie können weiter voneinander entfernt sein. Bevorzugt ist eine solche Ringbildung bei Resten, die an direkt aneinander gebundene Kohlenstoffatome oder an dasselbe Kohlenstoffatom gebunden sind.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

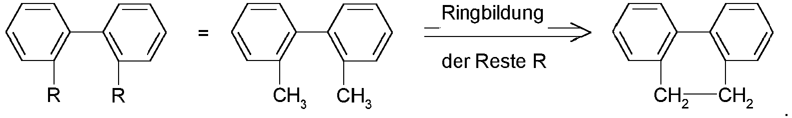

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

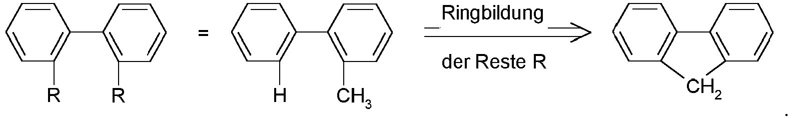

Die Bildung eines aromatischen Ringsystems soll durch das folgende Schema verdeutlicht werden:

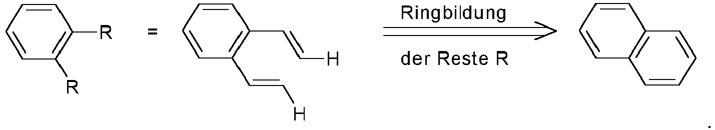

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryloder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden. Bevorzugt ist das aromatische bzw. heteroaromatische Ringsystem ein System, in dem zwei oder mehrere Aryl- bzw. Heteroarylgruppen direkt über eine Einfachbindung miteinander verknüpft sind, oder ist Fluoren, Spirobifluoren oder eine andere Aryl- oder Heteroarylgruppe, an die eine gegebenenfalls substituierte Indengruppe ankondensiert ist, wie beispielsweise Indenocarbazol.

Unter einer cyclischen Alkylgruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1 -yl-, 1,1-Dimethyl-n-dodec-1-yl-, 1,1-Dimethyl-n-tetradec-1 -yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1 -Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₂₀-Alkoxygruppe, wie sie für OR¹ bzw. OR² vorliegt, werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Zur weiteren Veranschaulichung der Verbindung wird im Folgenden eine einfache Struktur gemäß Formel (1) vollständig dargestellt und erläutert:

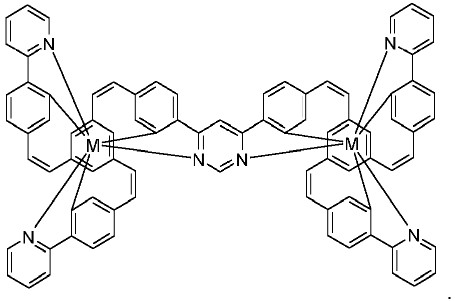

In dieser Struktur steht Q für eine Pyrimidingruppe, wobei das Pyrimidin über jedes der beiden Stickstoffatome an jeweils eines der beiden Metalle M koordiniert. An das Pyrimidin sind zwei Phenylgruppen gebunden, welche den beiden Sechsringaryl- bzw. Heteroarylgruppen in Formel (1) enthaltend D entsprechen und welche jeweils über ein Kohlenstoffatom an eines der beiden Metalle M koordinieren. An jede dieser beiden Phenylgruppen ist in der oben abgebildeten Beispielstruktur jeweils eine Gruppe der Formel (3) gebunden, d. h. V steht in dieser Struktur für eine Gruppe der Formel (3). Darin ist der zentrale Cyclus jeweils eine Phenylgruppe und die drei Gruppen A stehen jeweils für -HC=CH-, also für cis-Alkenylgruppen. An diese Gruppe der Formel (3) sind jeweils noch zwei Teilliganden L gebunden, welche in der oben abgebildeten Struktur jeweils für Phenylpyridin stehen. Jedes der beiden Metalle M ist somit in der oben abgebildeten Struktur mit jeweils zwei Phenylpyridinliganden und einem Phenylpyrimidinliganden koordiniert, wobei die Pyrimidingruppe des Phenylpyrimidins an beide Metalle M koordiniert. Dabei sind die Teilliganden jeweils durch die Gruppe der Formel (3) zu einem polypodalen System verknüpft.

Der Begriff "bidentater Teilligand" für L bedeutet im Sinne dieser Anmeldung, dass es sich bei dieser Einheit um einen bidentaten Liganden handeln würde, wenn die Gruppe V, also die Gruppe der Formel (3) bzw. (4) nicht vorhanden wäre. Durch die formale Abstraktion eines Wasserstoffatoms an diesem bidentaten Liganden und die Verknüpfung mit der Gruppe V, also der Gruppe der Formel (3) bzw. (4) ist dieser jedoch kein separater Ligand, sondern ein Teil des so entstehenden dodekadentaten Liganden für p = 0, also eines Liganden mit insgesamt 12 Koordinationsstellen, so dass hierfür der Begriff "Teilligand" verwendet wird. Entsprechend weist für p = 1 der Ligand 18 Koordinationsstellen auf.

Die Bindung des Liganden an das Metall M kann sowohl eine Koordinationsbindung als auch eine kovalente Bindung sein bzw. der kovalente Anteil an der Bindung kann je nach Ligand variieren. Wenn in der vorliegenden Anmeldung die Rede davon ist, dass der Ligand bzw. der Teilligand an M koordiniert oder bindet, so bezeichnet dies im Sinne der vorliegenden Anmeldung jede Art der Bindung des Liganden bzw. Teilliganden an M, unabhängig vom kovalenten Anteil der Bindung.

Die erfindungsgemäßen Verbindungen sind bevorzugt nicht geladen, d. h. sie sind elektrisch neutral. Dies wird dadurch erreicht, dass Rh bzw. Ir jeweils in der Oxidationsstufe +III vorliegen. Jedes der Metalle ist dann von drei monoanionischen bidentaten Teilliganden koordiniert, so dass die Teilliganden die Ladung des komplexierten Metallatoms kompensieren.

Wie oben beschrieben, können die beiden Metalle M in der erfindungsgemäßen Verbindung gleich oder verschieden sein und liegen bevorzugt in der Oxidationsstufe +III vor. Es kommen daher für p = 0 die Kombinationen Ir/Ir, Ir/Rh und Rh/Rh in Frage. In einer bevorzugten Ausführungsform der Erfindung stehen beide Metalle M für Ir(III). Analog kommen für p = 1 die Kombinationen Ir/Ir/Ir, Ir/Ir/Rh, Ir/Rh/Rh und Rh/Rh/Rh in Frage, und bevorzugt stehen alle drei Metalle M für Ir(III).

In einer bevorzugten Ausführungsform der Erfindung sind die Verbindungen der Formeln (1) und (2) gewählt aus den Verbindungen der folgenden Formeln (1a) und (2a), 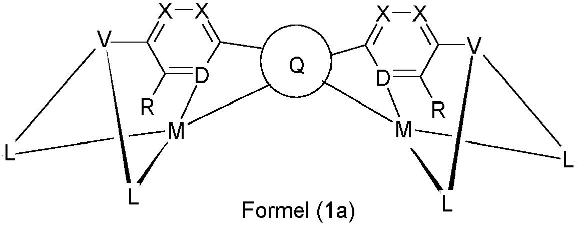 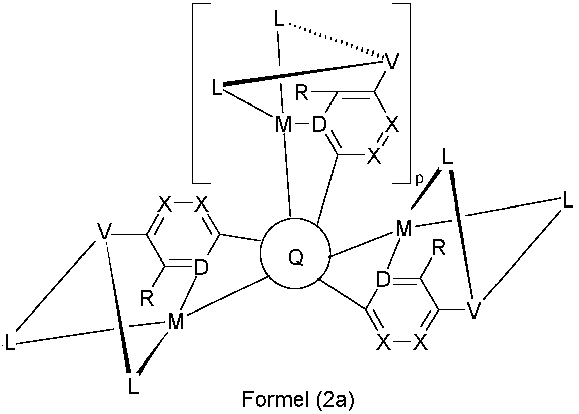 wobei der explizit eingezeichnete Rest R in ortho-Position zu D jeweils gleich oder verschieden bei jedem Auftreten ausgewählt ist aus der Gruppe bestehend aus H, D, F, CH₃ und CD₃ und bevorzugt für H steht und die weiteren verwendeten Symbole und Indizes die oben aufgeführten Bedeutungen aufweisen.

In einer bevorzugten Ausführungsform steht die Gruppe Q in Formel (1) bzw. (1a) für eine Gruppe gemäß einer der folgenden Formeln (Q-1) bis (Q-3) und in Formel (2) bzw. (2a) für eine Gruppe gemäß einer der folgenden Formeln (Q-4) bis (Q-15) für p = 0 bzw. für eine Gruppe gemäß einer der Formeln (Q-16) bis (Q-19) für p = 1,

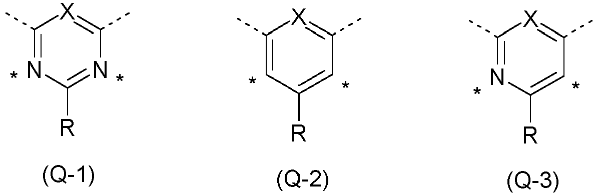

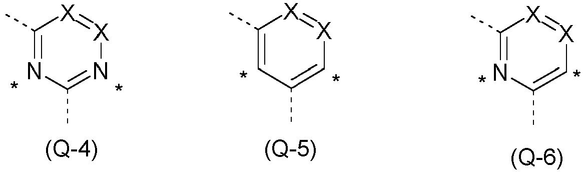

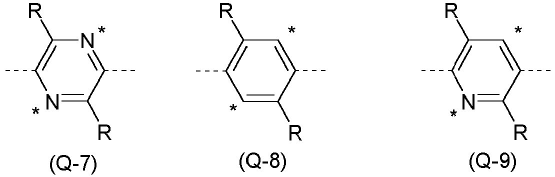

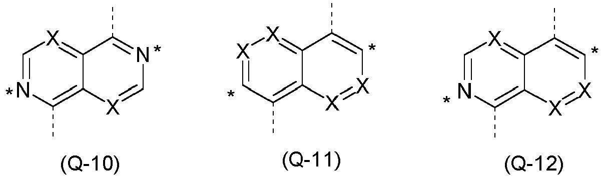

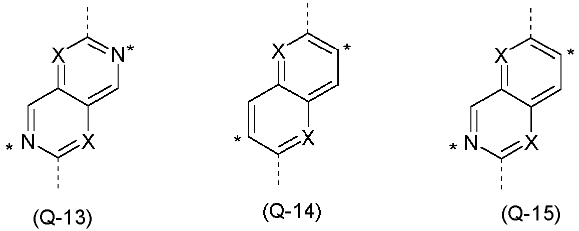

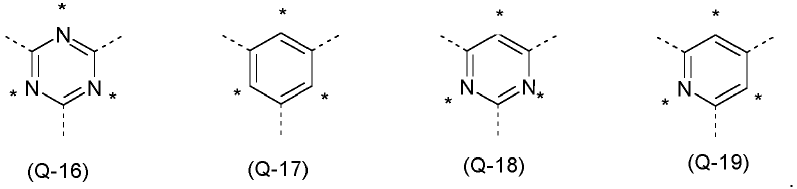

Dabei deutet die gestrichelte Bindung jeweils die Verknüpfung innerhalb der Formel (1) bzw. (2) an, und * markiert die Position, an der diese Gruppe an M koordiniert ist, und X und R weisen die oben genannten Bedeutungen auf. Dabei stehen bevorzugt nicht mehr als zwei Gruppen X pro Gruppe Q, die nicht direkt aneinander gebunden sind, für N, und besonders bevorzugt steht nicht mehr als eine Gruppe X für N. Ganz besonders bevorzugt stehen alle X für CR und insbesondere für CH, und alle R in (Q-1) bis (Q-3) und (Q-7) bis (Q-9) stehen für H oder D, insbesondere für H.

Bevorzugt sind für Verbindungen der Formel (2) bzw. (2a) die Gruppen (Q-4), (Q-5) und (Q-7) bis (Q-9) für p = 0 und die Gruppe (Q-16) für p = 1.

In einer bevorzugten Ausführungsform der Erfindung ist jedes der beiden Metalle M in der Verbindung der Formel (1) bzw. (2) bzw. den bevorzugten Ausführungsformen von genau einem Kohlenstoffatom und einem Stickstoffatom koordiniert, welche als koordinierende Atome in Q und als koordinierendes Atom D vorliegen, und ist weiterhin jeweils von zwei Teilliganden L koordiniert. Wenn also die Gruppe Q eine Gruppe der Formel (Q-1), (Q-4), (Q-7), (Q-10) oder (Q-13) darstellt, also über Stickstoffatome an jedes der beiden Metalle M koordiniert, dann stellen bevorzugt die beiden Gruppen D Kohlenstoffatome dar. Wenn die Gruppe Q eine Gruppe der Formel (Q-2), (Q-5), (Q-8), (Q-11) oder (Q-14) darstellt, also über Kohlenstoffatome an jedes der beiden Metalle M koordiniert, dann stellen bevorzugt die beiden Gruppen D Stickstoffatome dar. Wenn die Gruppe Q eine Gruppe der Formel (Q-3), (Q-6), (Q-9), (Q-12) oder (Q-15) darstellt, also über ein Kohlenstoffatom und ein Stickstoffatom an die beiden Metalle M koordiniert, dann stellt bevorzugt die eine der beiden Gruppen D ein Stickstoffatom und die andere Gruppe D ein Kohlenstoffatom dar, so dass jedes M von einem Kohlenstoffatom und einem Stickstoffatom koordiniert ist. Dasselbe gilt analog für die Gruppen der Formeln (Q-16) bis (Q-19).

In einer bevorzugten Ausführungsform der vorliegenden Erfindung stehen weiterhin die in Formel (1) bzw. (2) bzw. in den bevorzugten Ausführungsformen aufgeführten Symbole X gleich oder verschieden bei jedem Auftreten für CR, insbesondere für CH.

In einer weiteren bevorzugten Ausführungsform der Erfindung ist p in Formel (2) = 0.

Nachfolgend werden bevorzugte Ausführungsformen für V, also die Gruppe der Formel (3) bzw. (4), ausgeführt.

Geeignete Ausführungsformen der Gruppe der Formel (3) sind die Strukturen der folgenden Formeln (6) bis (9), und geeignete Ausführungsformen der Gruppe der Formel (4) sind die Strukturen der folgenden Formel (10), 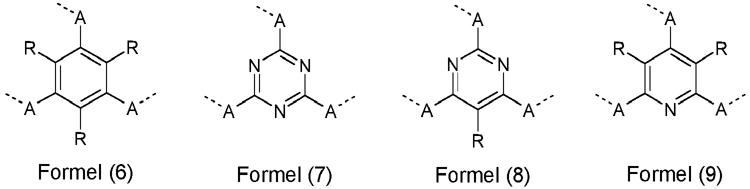 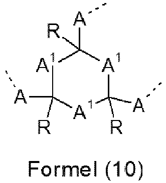 wobei die Symbole die oben genannten Bedeutungen aufweisen.

Für bevorzugte Reste R in Formeln (6) bis (10) gilt:
- R: ist bei jedem Auftreten gleich oder verschieden H, D, F, CN, OR¹, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R¹ substituiert sein kann, oder ein aromatisches oder heteroaromatisches Ringsystem mit 5 bis 24 aromatischen Ringatomen, das jeweils durch einen oder mehrere Reste R¹ substituiert sein kann;
- R¹: ist bei jedem Auftreten gleich oder verschieden H, D, F, CN, OR², eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch F ersetzt sein können.

Für besonders bevorzugte Reste R in Formeln (6) bis (10) gilt:
- R: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R¹ substituiert sein kann, oder ein aromatisches oder heteroaromatisches Ringsystem mit 6 bis 12 aromatischen Ringatomen, das jeweils durch einen oder mehrere Reste R¹ substituiert sein kann;
- R¹: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R² substituiert sein kann, oder ein aromatisches oder heteroaromatisches Ringsystem mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer oder aromatischer Kohlenwasserstoffrest mit 1 bis 12 C-Atomen.

In einer bevorzugten Ausführungsform der Erfindung stehen alle Gruppen X¹ in der Gruppe der Formel (3) für CR, so dass der zentrale trivalente Cyclus der Formel (3) ein Benzol darstellt. Besonders bevorzugt stehen alle Gruppen X¹ für CH oder CD, insbesondere für CH. In einer weiteren bevorzugten Ausführungsform der Erfindung stehen alle Gruppen X¹ für ein Stickstoffatom, so dass der zentrale trivalente Cyclus der Formel (3) ein Triazin darstellt. Bevorzugte Ausführungsformen der Formel (3) sind somit die Strukturen der oben abgebildeten Formeln (6) und (7), insbesondere der Formel (6). Besonders bevorzugt ist die Struktur der Formel (6) eine Struktur der folgenden Formel (6'), 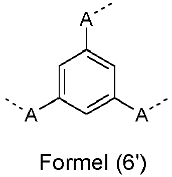 wobei die Symbole die oben genannten Bedeutungen aufweisen.

Besonders bevorzugt stehen alle Gruppen A² in Formel (4) für CH. Bevorzugte Ausführungsformen der Formel (4) sind somit die Strukturen der folgenden Formel (10'), 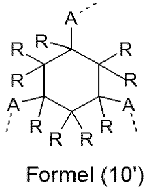 wobei die Symbole die oben genannten Bedeutungen aufweisen und R für H steht.

Besonders bevorzugt ist die Gruppe V eine Gruppe der Formel (3) bzw. der entsprechenden bevorzugten Ausführungsformen.

Im Folgenden werden bevorzugte Gruppen A beschrieben, wie sie in den Strukturen der Formeln (3) und (4) sowie (6) bis (10) vorkommen. Die Gruppe A kann gleich oder verschieden bei jedem Auftreten eine Alkenylgruppe, eine Amidgruppe, eine Estergruppe, eine Alkylengruppe, eine Methylenethergruppe oder eine ortho-verknüpfte Arylen- bzw. Heteroarylengruppe der Formel (5) darstellen. Wenn A für eine Alkenylgruppe steht, dann handelt es sich um eine cis-verknüpfte Alkenylgruppe. Wenn A für eine Alkylengruppe steht, dann handelt es sich bevorzugt um -CH₂-CH₂-. Bei unsymmetrischen Gruppen A ist jede Orientierung der Gruppen möglich. Dies ist nachfolgend schematisch am Beispiel von A = -C(=O)-O- erläutert. Hieraus ergeben sich die folgenden möglichen Orientierungen von A, die alle von der vorliegenden Erfindung umfasst sind:

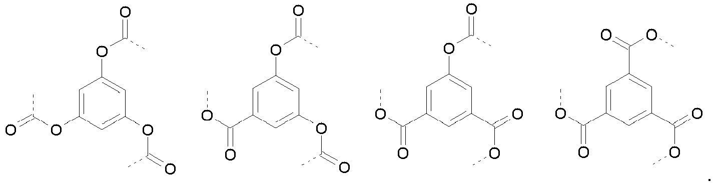

In einer bevorzugten Ausführungsform der Erfindung ist A gleich oder verschieden, bevorzugt gleich, bei jedem Auftreten ausgewählt aus der Gruppe bestehend aus -C(=O)-O-, -C(=O)-NR'-, -CH₂-CH₂- oder einer Gruppe der Formel (5). Besonders bevorzugt sind die Gruppen A gleich oder verschieden, bevorzugt gleich, bei jedem Auftreten ausgewählt aus der Gruppe bestehend aus -C(=O)-O-, -C(=O)-NR'- oder einer Gruppe der Formel (5). Ganz besonders bevorzugt ist eine Gruppe der Formel (5). Weiterhin bevorzugt sind zwei Gruppen A gleich und auch gleich substituiert, und die dritte Gruppe A ist von den ersten beiden Gruppen A verschieden, oder alle drei Gruppen A sind gleich und auch gleich substituiert. Bevorzugte Kombinationen für die drei Gruppen A in Formeln (3) und (4) und den bevorzugten Ausführungsformen sind:

| A | A | A |
|---|---|---|
| Formel (5) | Formel (5) | Formel (5) |
| -C(=O)-O- | -C(=O)-O- | -C(=O)-O- |
| -C(=O)-O- | -C(=O)-O- | Formel (5) |
| -C(=O)-O- | Formel (5) | Formel (5) |
| -C(=O)-N'- | -C(=O)-NR'- | -C(=O)-NR'- |
| -C(=O)-NR'- | -C(=O)-NR'- | Formel (5) |
| -C(=O)-NR'- | Formel (5) | Formel (5) |
| -CH₂-CH₂- | -CH₂-CH₂- | -CH₂-CH₂- |
| -CH₂-CH₂- | -CH₂-CH₂- | Formel (5) |
| -CH₂-CH₂- | Formel (5) | Formel (5) |

Wenn A für -C(=O)-NR'- steht, dann steht R' bevorzugt gleich oder verschieden bei jedem Auftreten für eine geradkettige Alkylgruppe mit 1 bis 10 C-Atomen oder eine verzweigte oder cyclische Alkylgruppe mit 3 bis 10 C-Atomen oder ein aromatisches oder heteroaromatisches Ringsystem mit 6 bis 24 aromatischen Ringatomen, das jeweils durch einen oder mehrere Reste R¹ substituiert sein kann. Besonders bevorzugt steht R' gleich oder verschieden bei jedem Auftreten für eine geradkettige Alkylgruppe mit 1, 2, 3, 4 oder 5 C-Atomen oder eine verzweigte oder cyclische Alkylgruppe mit 3, 4, 5 oder 6 C-Atomen oder ein aromatisches oder heteroaromatisches Ringsystem mit 6 bis 12 aromatischen Ringatomen, das jeweils durch einen oder mehrere Reste R¹ substituiert sein kann, bevorzugt aber unsubstituiert ist.

Im Folgenden werden bevorzugte Ausführungsformen der Gruppe der Formel (5) beschrieben. Die Gruppe der Formel (5) kann einen heteroaromatischen Fünfring oder einen aromatischen oder heteroaromatischen Sechsring darstellen. In einer bevorzugten Ausführungsform der Erfindung enthält die Gruppe der Formel (5) maximal zwei Heteroatome in der aromatischen bzw. heteroaromatischen Einheit, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc..

Wenn beide Gruppen X³ in Formel (5) für Kohlenstoffatome stehen, sind bevorzugte Ausführungsformen der Gruppe der Formel (5) die Strukturen der folgenden Formeln (15) bis (31), und wenn eine Gruppe X³ für ein Kohlenstoffatom und die andere Gruppe X³ in demselben Cyclus für ein Stickstoffatom steht, sind bevorzugte Ausführungsformen der Gruppe der Formel (5) die Strukturen der folgenden Formeln (32) bis (39), 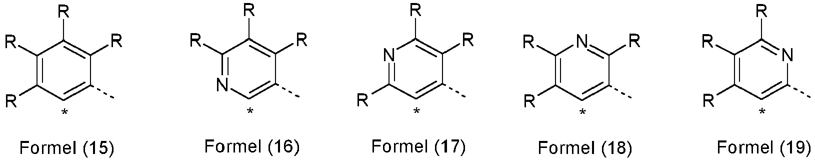 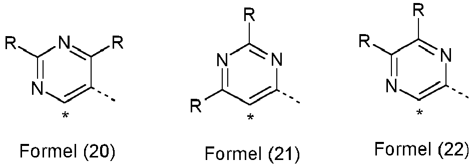 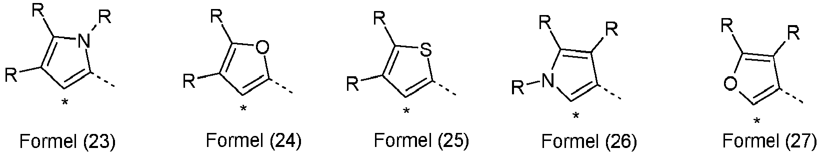 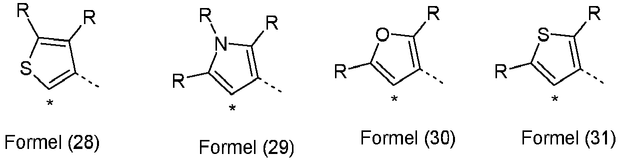 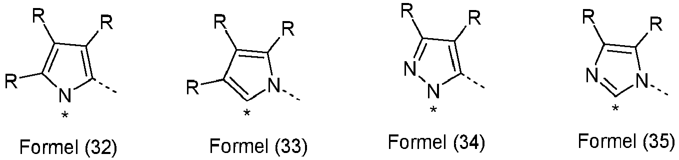 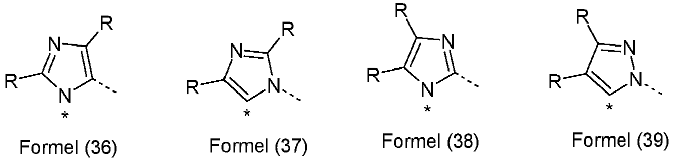 wobei die Symbole die oben genannten Bedeutungen aufweisen.

Besonders bevorzugt sind die Sechsring-Aromaten und -Heteroaromaten der oben abgebildeten Formeln (15) bis (19). Ganz besonders bevorzugt ist ortho-Phenylen, also eine Gruppe der oben genannten Formel (15).

Dabei können auch benachbarte Substituenten R miteinander ein Ringsystem bilden, so dass kondensierte Strukturen, auch kondensierte Aryl-und Heteroarylgruppen, wie beispielsweise Naphthalin, Chinolin, Benzimidazol, Carbazol, Dibenzofuran oder Dibenzothiophen, entstehen können. Eine solche Ringbildung ist im Folgenden schematisch an Gruppen der oben genannten Formel (15) aufgeführt, was beispielsweise zu Gruppen der folgenden Formeln (15a) bis (15j) führen kann: 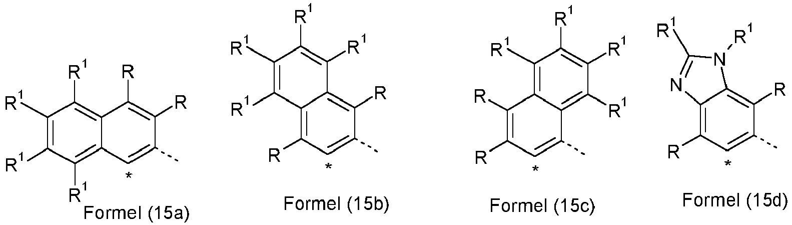 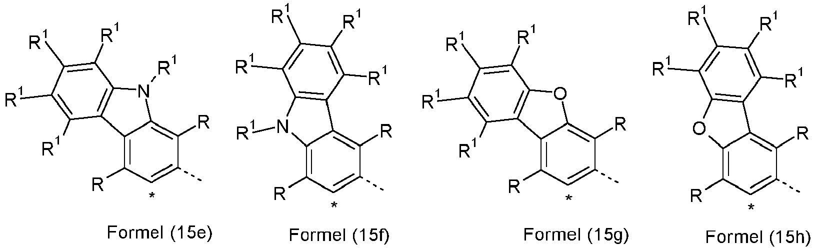 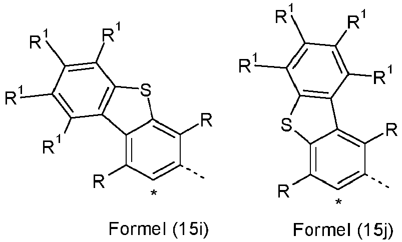 wobei die Symbole die oben genannten Bedeutungen aufweisen.

Generell können die ankondensierten Gruppen an jeder Position der Einheit gemäß Formel (5) ankondensiert sein, wie durch die ankondensierte Benzogruppe in den Formeln (15a) bis (15c) dargestellt. Die Gruppen, wie sie in den Formeln (15d) bis (15j) an die Einheit der Formel (5) ankondensiert sind, können daher auch an anderen Positionen der Einheit der Formel (5) ankondensiert werden.

Die Gruppe der Formel (3) kann bevorzugt durch die folgenden Formeln (3a) bis (3m) dargestellt werden, und die Gruppe der Formel (4) kann bevorzugt durch die folgenden Formeln (4a) bis (4m) dargestellt werden: 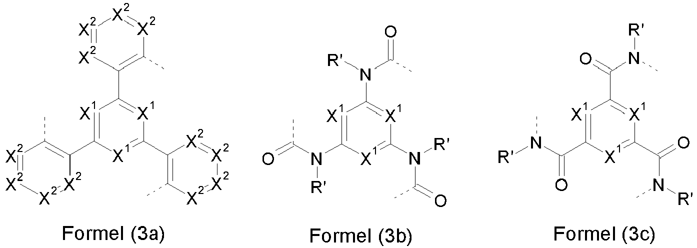 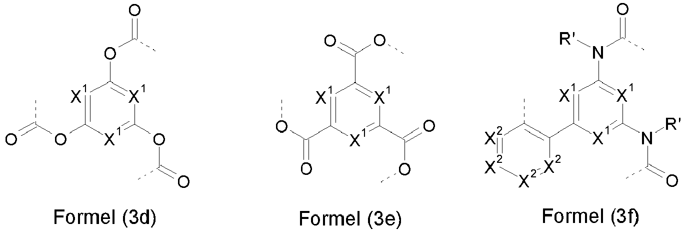 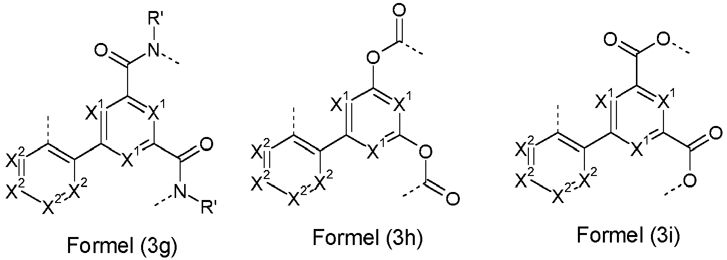 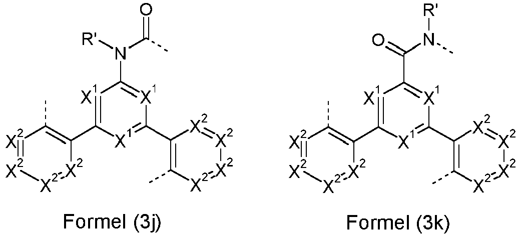 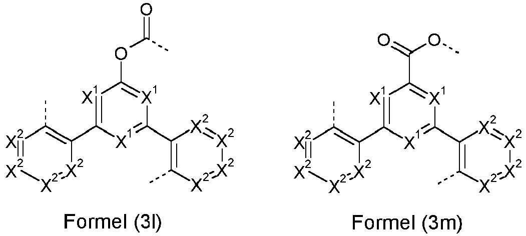 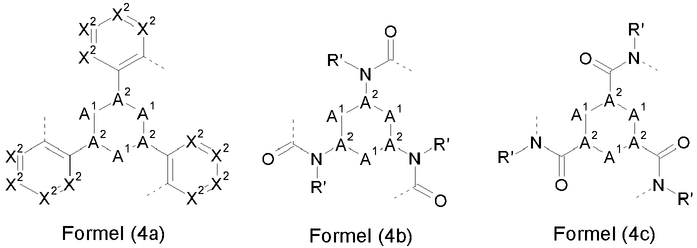 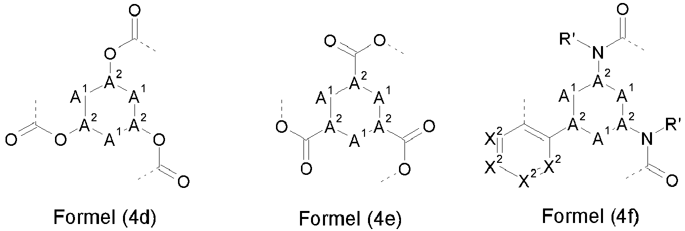 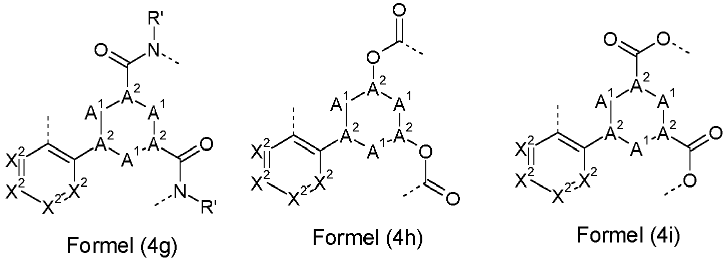 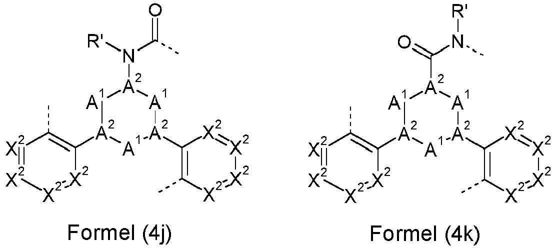 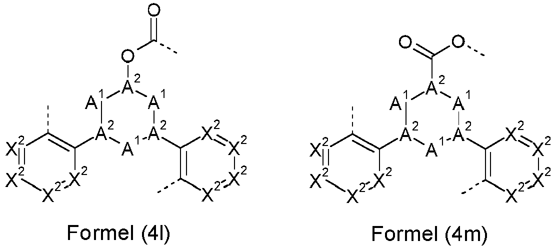 wobei die Symbole die oben genannten Bedeutungen aufweisen. Bevorzugt steht X² gleich oder verschieden bei jedem Auftreten für CR.

In einer bevorzugten Ausführungsform der Erfindung ist die Gruppe der Formeln (3a) bis (3m) ausgewählt aus den Gruppen der Formeln (6a') bis (6m') und die Gruppe der Formeln (4a) bis (4m) aus den Gruppen der Formeln (10a') bis (10m'), 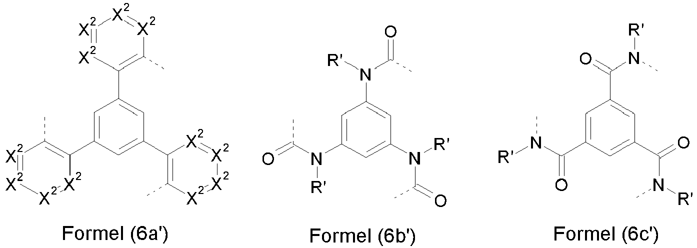 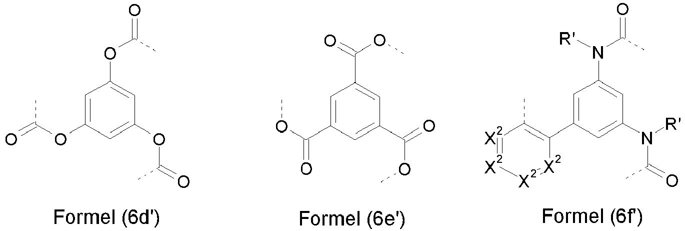 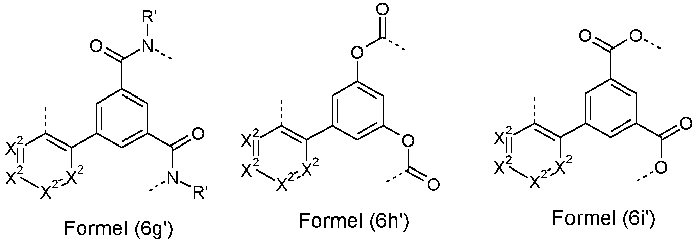 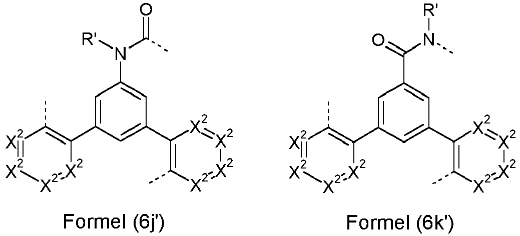 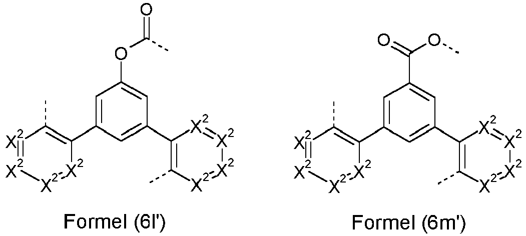 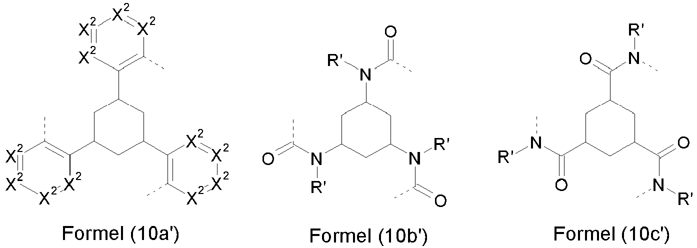 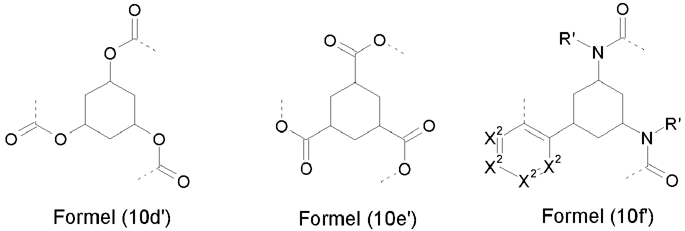 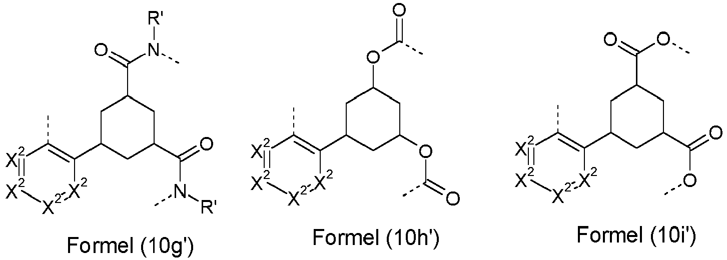 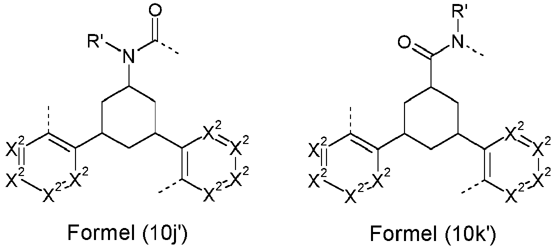 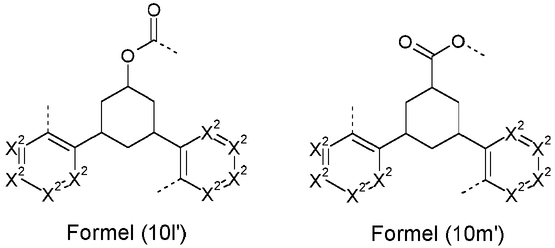 wobei die Symbole die oben genannten Bedeutungen aufweisen. Bevorzugt steht X² gleich oder verschieden bei jedem Auftreten für CR.

Eine besonders bevorzugte Ausführungsform der Gruppe der Formel (3) ist die Gruppe der folgenden Formel (6a"), 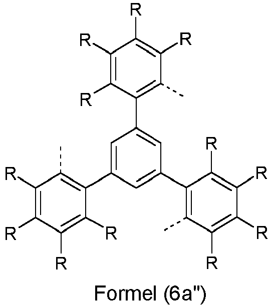 wobei die gestrichelte Bindung die oben genannte Bedeutung aufweist.

Besonders bevorzugt sind die Gruppen R in den oben genannten Formeln gleich oder verschieden H, D oder eine Alkylgruppe mit 1 bis 4 C-Atomen. Ganz besonders bevorzugt ist R = H. Ganz besonders bevorzugt ist also die Struktur der folgenden Formel (6a'"), 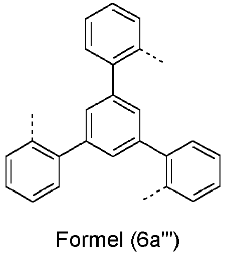 wobei die Symbole die oben genannten Bedeutungen aufweisen.

Im Folgenden werden die bidentaten, monoanionischen Teilliganden L beschrieben. Die Teilliganden L können gleich oder verschieden sein. Dabei ist es bevorzugt, wenn jeweils die beiden Teilliganden L, die an dasselbe Metall M koordinieren, gleich sind und auch gleich substituiert sind. Diese Bevorzugung ist durch die einfachere Synthese der entsprechenden Liganden begründet.

In einer weiteren bevorzugten Ausführungsform sind alle vier bidentaten Teilliganden L für p = 0 bzw. alle sechs bidentaten Teilliganden L für p = 1 gleich und sind auch gleich substituiert.

Die koordinierenden Atome von jedem der Teilliganden L können gleich sein, oder sie können unterschiedlich sein. Bei den erfindungsgemäßen Komplexen handelt es sich um einen Metallkomplex, in dem alle Teilliganden ortho-metalliert sind, d. h. mit dem Metall M einen Metallacyclus bilden, in dem mindestens eine Metall-Kohlenstoff-Bindung vorliegt.

Es ist weiterhin bevorzugt, wenn es sich bei dem Metallacyclus, der aus dem Metall M und dem bidentaten Teilliganden L aufgespannt wird, um einen Fünfring handelt. Dies wird im Folgenden schematisch dargestellt: 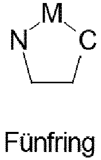 wobei N ein koordinierendes Stickstoffatom, C ein koordinierendes Kohlenstoffatom darstellen und die eingezeichneten Kohlenstoffatome Atome des bidentaten Teilliganden L darstellen.

CyD koordiniert in den Teilliganden der Formeln (L-1) und (L-2) bevorzugt über ein neutrales Stickstoffatom oder über ein Carben-Kohlenstoffatom, insbesondere über ein neutrales Stickstoffatom. Weiterhin bevorzugt koordiniert eine der beiden Gruppen CyD in dem Liganden der Formel (L-3) über ein neutrales Stickstoffatom und die andere der beiden Gruppen CyD über ein anionisches Stickstoffatom. Weiterhin bevorzugt koordiniert CyC in den Teilliganden der Formeln (L-1) und (L-2) über anionische Kohlenstoffatome.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD in den Formeln (L-1) und (L-2) bzw. die Substituenten an den beiden Gruppen CyD in Formel (L-3) miteinander einen Ring bilden, wodurch CyC und CyD bzw. die beiden Gruppen CyD auch zusammen eine einzige kondensierte Aryl- bzw. Heteroarylgruppe als bidentaten Liganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, insbesondere eine Phenylgruppe, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-20), 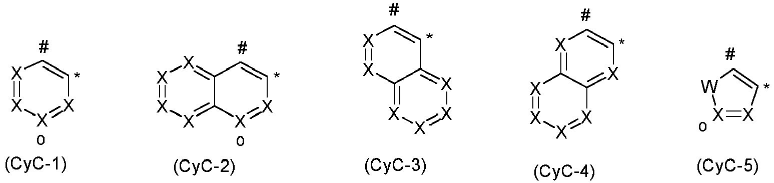 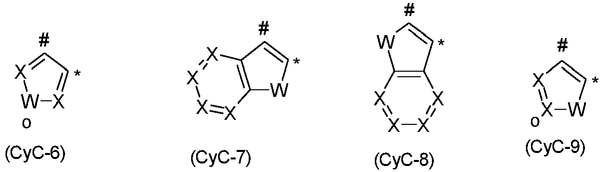 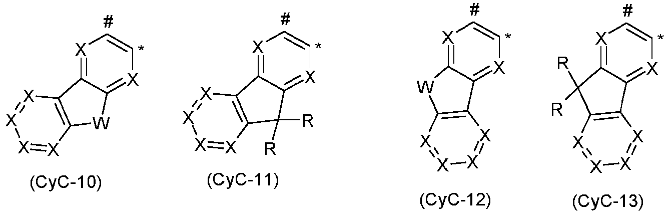 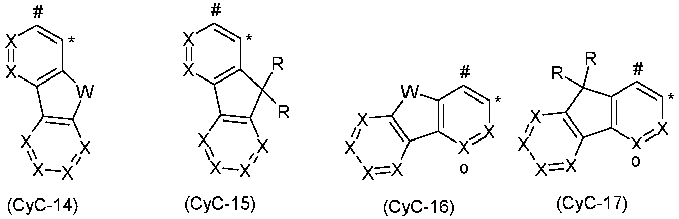 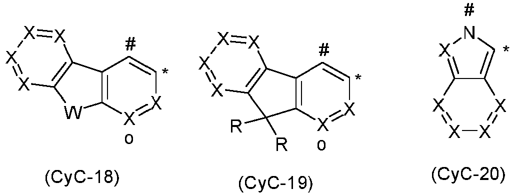 wobei CyC jeweils an der durch # gekennzeichneten Position an CyD bindet und an der durch * gekennzeichneten Position an das Metall koordiniert, R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist NR, O oder S;
mit der Maßgabe, dass, wenn der Teilligand L über CyC an V, d.h. an die Gruppe der Formel (3) bzw. (4) gebunden ist, ein Symbol X für C steht und die Gruppe V, d.h. die Gruppe der Formel (3) bzw. (4) bzw. die bevorzugten Ausführungsformen an dieses Kohlenstoffatom gebunden ist. Wenn der Teilligand L über die Gruppe CyC an die Gruppe der Formel (3) bzw. (4) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht an die Gruppe der Formel (3) bzw. (4) gebunden, da eine Bindung dieser Gruppen an die Gruppe V aus sterischen Gründen nicht vorteilhaft ist.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn CyC direkt an die Gruppe V, d.h. an die Gruppe der Formel (3) bzw. (4) gebunden ist, ein Symbol X für C steht und die Brücke der Formel (3) bzw. (4) bzw. die bevorzugten Ausführungsformen an dieses Kohlenstoffatom gebunden ist.

Besonders bevorzugte Gruppen CyC sind die Gruppen der folgenden Formeln (CyC-1a) bis (CyC-20a), 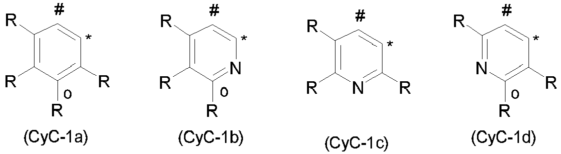 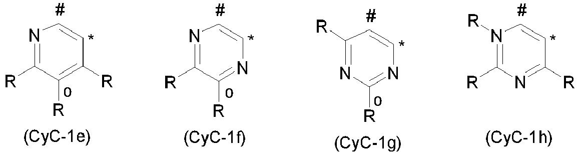 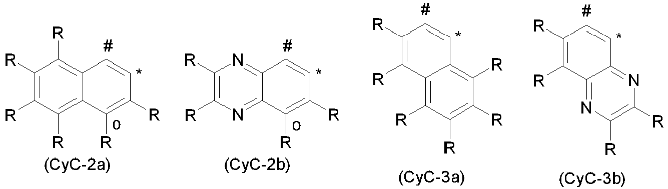 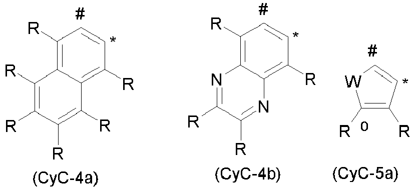 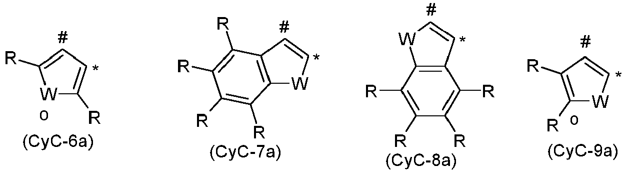 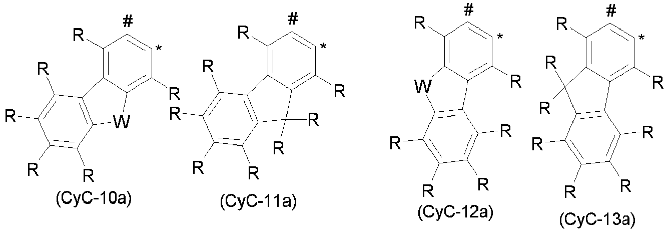 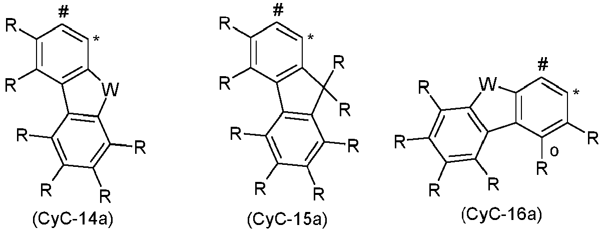 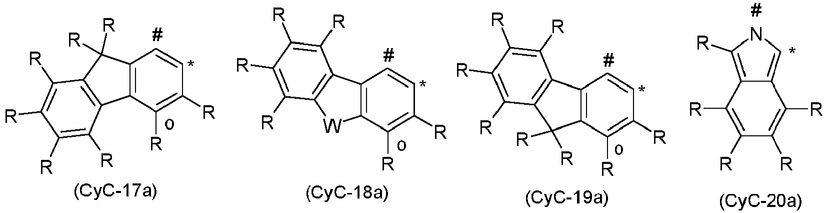 wobei die Symbole die oben genannten Bedeutungen aufweisen und, wenn CyC direkt an die Gruppe V, d.h. an die Gruppe der Formel (3) bzw. (4) gebunden ist, ein Rest R nicht vorhanden ist und die Gruppe der Formel (3) bzw. (4) bzw. die bevorzugten Ausführungsformen an das entsprechende Kohlenstoffatom gebunden ist. Wenn die Gruppe CyC direkt an die Gruppe der Formel (3) bzw. (4) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Gruppe der Formel (3) bzw. (4) gebunden.

Bevorzugte Gruppen unter den Gruppen (CyC-1) bis (CyC-20) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe mit 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-14), 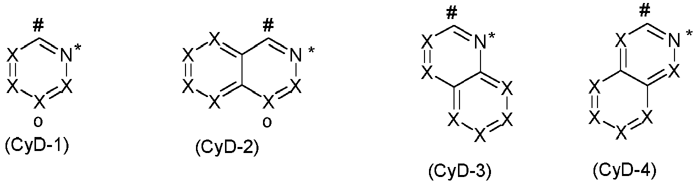 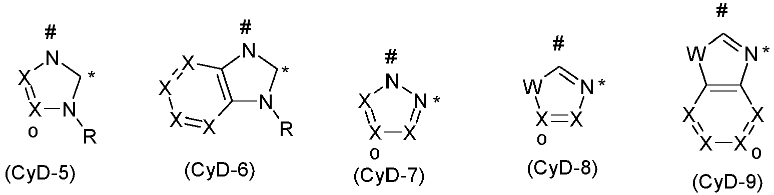 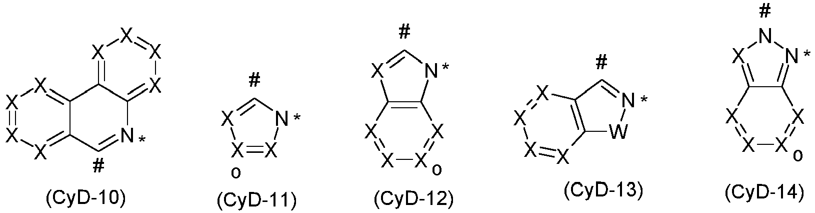 wobei die Gruppe CyD jeweils an der durch # gekennzeichneten Position an CyC bindet und an der durch * gekennzeichneten Position an das Metall koordiniert und wobei X, W und R die oben genannten Bedeutungen aufweisen, mit der Maßgabe, dass, wenn CyD direkt an die Gruppe V, d.h. an die Gruppe der Formel (3) bzw. (4) gebunden ist, ein Symbol X für C steht und die Brücke der Formel (3) bzw. (4) bzw. die bevorzugten Ausführungsformen an dieses Kohlenstoffatom gebunden ist. Wenn die Gruppe CyD direkt an die Gruppe der Formel (3) bzw. (4) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Gruppe der Formel (3) bzw. (4) gebunden, da eine Bindung dieser Gruppen an die Gruppe V aus sterischen Gründen nicht vorteilhaft ist.

Dabei koordinieren die Gruppen (CyD-1) bis (CyD-4), (CyD-7) bis (CyD-10), (CyD-13) und (CyD-14) über ein neutrales Stickstoffatom, (CyD-5) und (CyD-6) über ein Carben-Kohlenstoffatom und (CyD-11) und (CyD-12) über ein anionisches Stickstoffatom an das Metall.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn CyD direkt an die Gruppe V, d.h. an die Gruppe der Formel (3) bzw. (4) gebunden ist, ein Symbol X für C steht und die Brücke der Formel (3) bzw. (4) bzw. die bevorzugten Ausführungsformen an dieses Kohlenstoffatom gebunden ist.

Besonders bevorzugte Gruppen CyD sind die Gruppen der folgenden Formeln (CyD-1a) bis (CyD-14b), 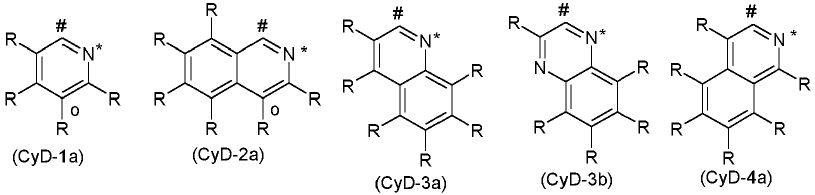 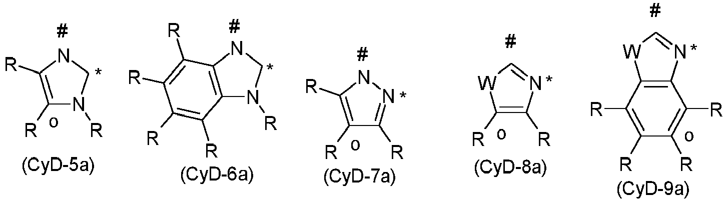 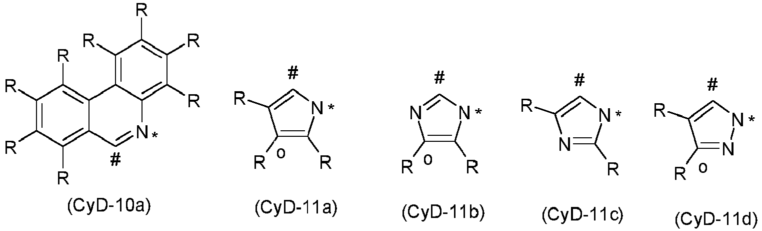 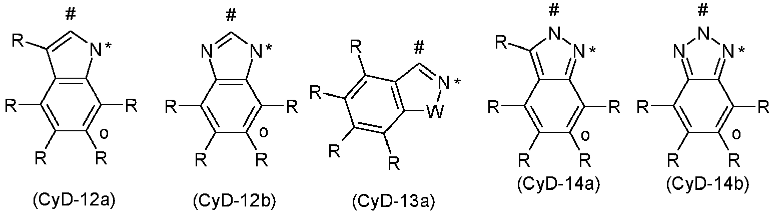 wobei die verwendeten Symbole die oben genannten Bedeutungen aufweisen und, wenn CyD direkt an die Gruppe V, d.h. an die Gruppe der Formel (3) bzw. (4) gebunden ist, ein Rest R nicht vorhanden ist und die Brücke der Formel (3) bzw. (4) bzw. die bevorzugten Ausführungsformen an das entsprechende Kohlenstoffatom gebunden ist. Wenn CyD direkt an die Gruppe der Formel (3) bzw. (4) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Gruppe der Formel (3) bzw. (4) gebunden.

Bevorzugte Gruppen unter den Gruppen (CyD-1) bis (CyD-14) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1a), (CyD-2a), (CyD-3a), (CyD-4a), (CyD-5a) und (CyD-6a), insbesondere (CyD-1a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen, insbesondere Phenyl, und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-14) können in den Teilliganden der Formeln (L-1) und (L-2) beliebig miteinander kombiniert werden, sofern mindestens eine der Gruppen CyC bzw. CyD eine geeignete Anknüpfungsstelle an die Gruppe der Formel (3) bzw. (4) aufweist, wobei geeignete Anknüpfungsstellen in den oben genannten Formeln mit "o" gekennzeichnet sind. Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD-1a) bis (CyD-14b) miteinander kombiniert werden, sofern mindestens eine der bevorzugten Gruppen CyC bzw. CyD eine geeignete Anknüpfungsstelle an die Gruppe der Formel (3) bzw. (4) aufweist, wobei geeignete Anknüpfungsstellen in den oben genannten Formeln mit "o" gekennzeichnet sind. Kombinationen, in denen weder CyC noch CyD eine solche geeignete Anknüpfungsstelle an die Brücke der Formel (3) bzw. (4) aufweist, sind daher nicht bevorzugt.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Teilliganden (L-1) sind die Strukturen der folgenden Formeln (L-1-1) und (L-1-2), und bevorzugte Teilliganden (L-2) sind die Strukturen der folgenden Formeln (L-2-1) bis (L-2-3), 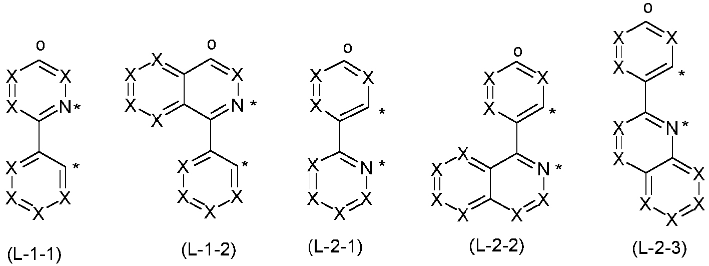 wobei die verwendeten Symbole die oben genannten Bedeutungen aufweisen, * die Position der Koordination an das Metall M andeutet und "o" die Position der Bindung an die Gruppe V, d.h. an die Gruppe der Formel (3) bzw. (4) darstellt.

Besonders bevorzugte Teilliganden (L-1) sind die Strukturen der folgenden Formeln (L-1-1a) und (L-1-2b), und besonders bevorzugte Teilliganden (L-2) sind die Strukturen der folgenden Formeln (L-2-1 a) bis (L-2-3a), 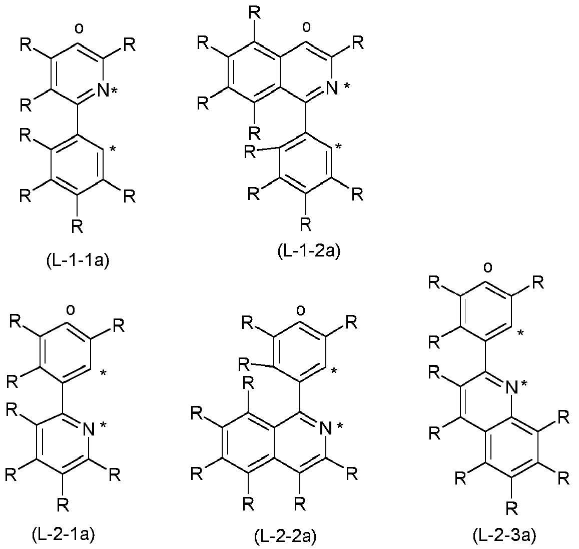 wobei die verwendeten Symbole die oben genannten Bedeutungen aufweisen und "o"die Position der Bindung an die Gruppe V, d.h. an die Gruppe der Formel (3) bzw. (4) darstellt.

Ebenso können die oben genannten bevorzugten Gruppen CyD in den Teilliganden der Formel (L-3) beliebig miteinander kombiniert werden, wobei eine neutrale Gruppe CyD, also eine Gruppe (CyD-1) bis (CyD-10), (CyD-13) oder (CyD-14), mit einer anionischen Gruppe CyD, also einer Gruppe (CyD-11) oder (CyD-12) kombiniert wird, sofern mindestens eine der bevorzugten Gruppen CyD eine geeignete Anknüpfungsstelle an die Gruppe der Formel (3) bzw. (4) aufweist, wobei geeignete Anknüpfungsstellen in den oben genannten Formeln mit "o" gekennzeichnet sind.

Wenn zwei Reste R, von denen einer an CyC und der andere an CyD in den Formeln (L-1) und (L-2) gebunden sind bzw. von denen einer an die eine Gruppe CyD und der andere an die andere Gruppe CyD in Formel (L-3) gebunden sind, miteinander ein Ringsystem bilden, können sich überbrückte Teilliganden und auch Teilliganden ergeben, die insgesamt eine einzige größere Heteroarylgruppe darstellen, wie beispielsweise Benzo[h]chinolin, etc.. Die Ringbildung zwischen den Substituenten an CyC und CyD in den Formeln (L-1) und (L-2) bzw. zwischen den Substituenten an den beiden Gruppen CyD in Formel (L-3) erfolgt dabei bevorzugt durch eine Gruppe gemäß einer der folgenden Formeln (40) bis (49), 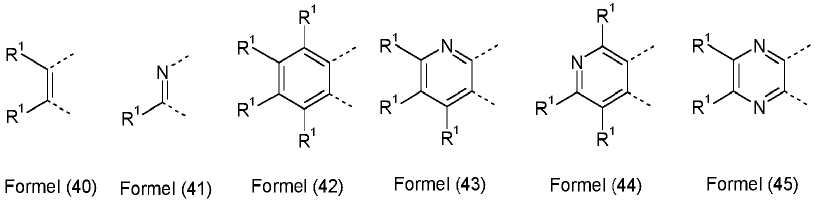 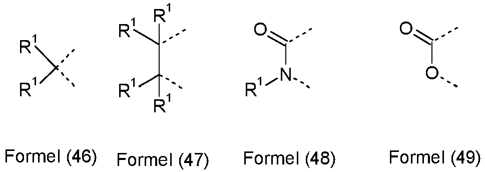 wobei R¹ die oben genannten Bedeutungen aufweist und die gestrichelten Bindungen die Bindungen an CyC bzw. CyD andeuten. Dabei können die unsymmetrischen der oben genannten Gruppen in jeder der beiden Orientierungen eingebaut werden, beispielsweise kann bei der Gruppe der Formel (49) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (46) besonders dann bevorzugt, wenn sich dadurch die Ringbildung zu einem Sechsring ergibt, wie beispielsweise unten durch die Formeln (L-22) und (L-23) dargestellt.

Bevorzugte Liganden, die durch Ringbildung zweier Reste R an den unterschiedlichen Cyclen entstehen, sind die im Folgenden aufgeführten Strukturen der Formeln (L-4) bis (L-31), 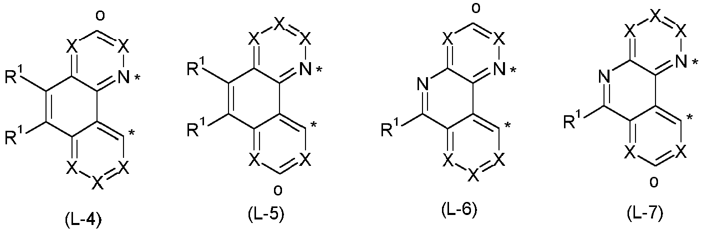 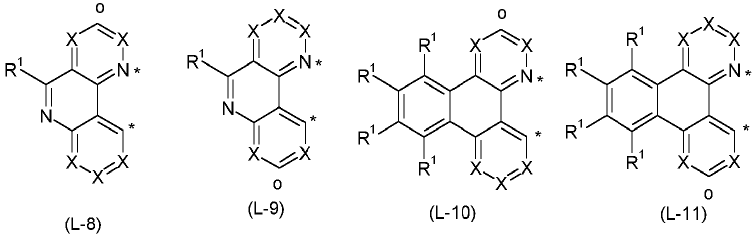 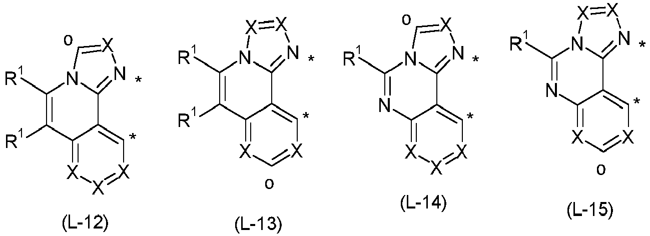 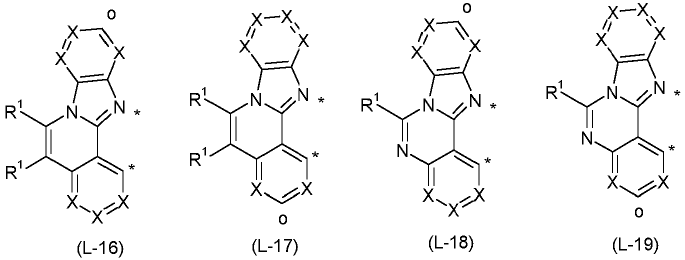 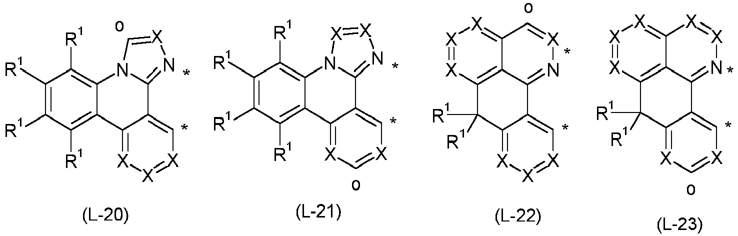 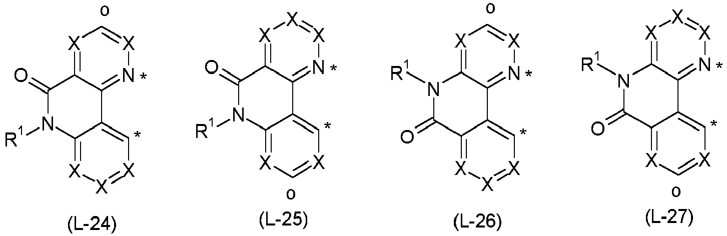 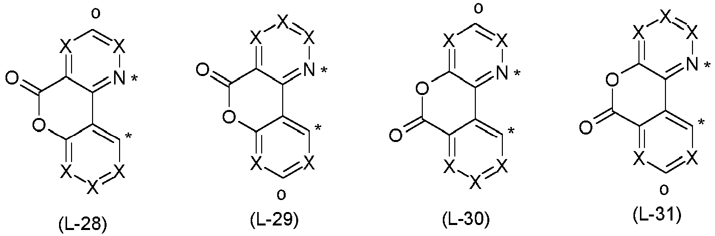 wobei die verwendeten Symbole die oben genannten Bedeutungen aufweisen und "o" die Position angibt, an denen dieser Teilligand mit der Gruppe der Formel (3) bzw. (4) verknüpft ist.

In einer bevorzugten Ausführungsform der Teilliganden der Formeln (L-4) bis (L-31) steht insgesamt ein Symbol X für N und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Teilliganden (L-1-1 ) bis (L-2-3), (L-4) bis (L-31) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OR¹ wobei R¹ für eine Alkylgruppe mit 1 bis 10 C-Atomen steht, Alkylgruppen mit 1 bis 10 C-Atomen, insbesondere verzweigten oder cyclischen Alkylgruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Im Folgenden werden bevorzugte Substituenten beschrieben, wie sie an den oben beschriebenen Teilliganden, aber auch an A, wenn A für eine Gruppe der Formel (5) steht, vorliegen können.

In einer bevorzugten Ausführungsform der Erfindung enthält die erfindungsgemäße Verbindung zwei Substituenten R, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke der Formel (3) bzw. (4) bzw. den bevorzugten Ausführungsformen vorliegen und/oder an einem oder mehreren der bidentaten Teilliganden L vorliegen. Der aliphatische Ring, der durch die Ringbildung von zwei Substituenten R miteinander gebildet wird, wird bevorzugt durch eine der folgenden Formeln (51) bis (57) beschrieben, 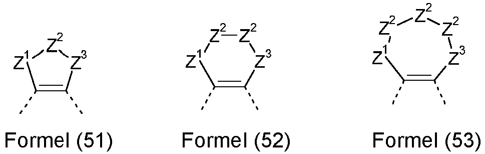 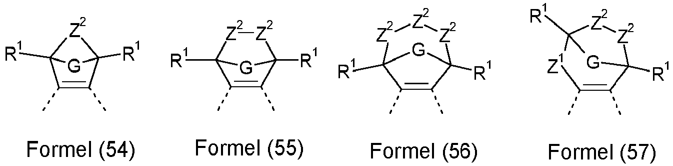 wobei R¹ und R² die oben genannten Bedeutungen aufweisen, die gestrichelten Bindungen die Verknüpfung der beiden Kohlenstoffatome im Liganden andeuten und weiterhin gilt:
- Z¹, Z³: sind gleich oder verschieden bei jedem Auftreten C(R³)₂, O, S, NR³ oder C(=O);
- Z²: ist C(R¹)₂, O, S, NR³ oder C(=O);
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C=C, Si(R²)₂, C=O, NR², 0, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In einer bevorzugten Ausführungsform der Erfindung ist R³ ungleich H.

In den oben abgebildeten Strukturen der Formeln (51) bis (57) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden ist. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (51) bis (53) dadurch erreicht, dass Z¹ und Z³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (54) bis (57) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (54) bis (57) für H steht, handelt es sich dabei daher um ein nicht-azides Proton im Sinne der vorliegenden Anmeldung.

In einer bevorzugten Ausführungsform der Struktur gemäß den Formeln (51) bis (57) steht maximal eine der Gruppen Z¹, Z² und Z³ für ein Heteroatom, insbesondere für O oder NR³, und die anderen Gruppen stehen für C(R³)₂ bzw. C(R¹)₂ oder Z¹ und Z³ stehen gleich oder verschieden bei jedem Auftreten für O oder NR³ und Z² steht für C(R¹)₂. In einer besonders bevorzugten Ausführungsform der Erfindung stehen Z¹ und Z³ gleich oder verschieden bei jedem Auftreten für C(R³)₂ und Z² steht für C(R¹)₂ und besonders bevorzugt für C(R³)₂ oder CH₂.

Bevorzugte Ausführungsformen der Formel (51) sind somit die Strukturen der Formeln (51-A), (51-B), (51-C) und (51-D), und eine besonders bevorzugte Ausführungsform der Formel (51-A) sind die Strukturen der Formeln (51-E) und (51-F), 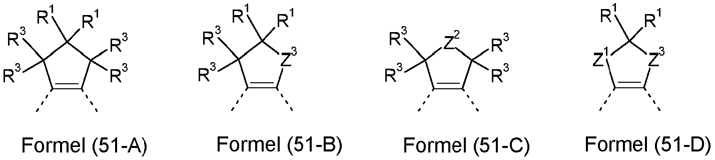 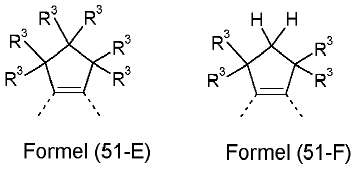 wobei R¹ und R³ die oben genannten Bedeutungen aufweisen und Z¹, Z² und Z³ gleich oder verschieden bei jedem Auftreten für 0 oder NR³ stehen.

Bevorzugte Ausführungsformen der Formel (52) sind die Strukturen der folgenden Formeln (52-A) bis (52-F), 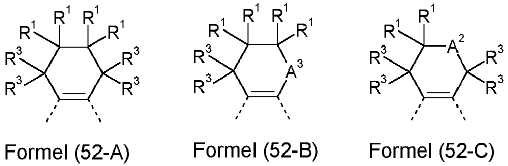 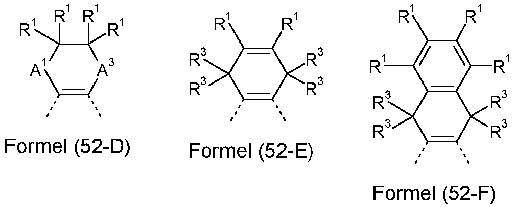 wobei R¹ und R³ die oben genannten Bedeutungen aufweisen und Z¹, Z² und Z³ gleich oder verschieden bei jedem Auftreten für 0 oder NR³ stehen.

Bevorzugte Ausführungsformen der Formel (53) sind die Strukturen der folgenden Formeln (53-A) bis (53-E), 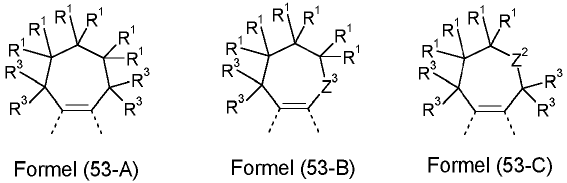 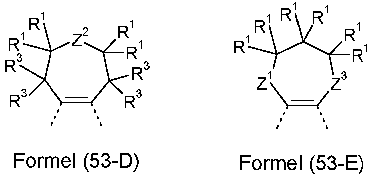 wobei R¹ und R³ die oben genannten Bedeutungen aufweisen und Z¹, Z² und Z³ gleich oder verschieden bei jedem Auftreten für 0 oder NR³ stehen.

In einer bevorzugten Ausführungsform der Struktur gemäß Formel (54) stehen die Reste R¹, die an den Brückenkopf gebunden sind, für H, D, F oder CH₃. Weiterhin bevorzugt steht Z² für C(R¹)₂ oder O, und besonders bevorzugt für C(R³)₂. Bevorzugte Ausführungsformen der Formel (54) sind somit die Strukturen der Formeln (54-A) und (54-B), und eine besonders bevorzugte Ausführungsform der Formel (54-A) ist eine Struktur der Formel (54-C), 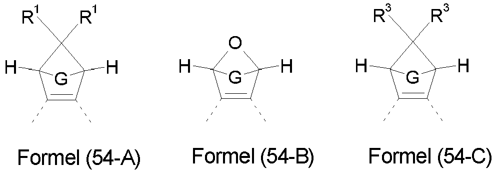 wobei die verwendeten Symbole die oben genannten Bedeutungen aufweisen.

In einer bevorzugten Ausführungsform der Strukturen gemäß den Formeln (55), (56) und (57) stehen die Reste R¹, die an den Brückenkopf gebunden sind, für H, D, F oder CH₃. Weiterhin bevorzugt steht Z² für C(R¹)₂. Bevorzugte Ausführungsformen der Formeln (55), (56) und (57) sind somit die Strukturen der Formeln (55-A), (56-A) und (57-A), 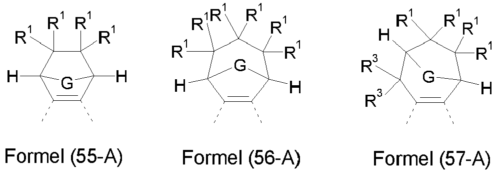 wobei die verwendeten Symbole die oben genannten Bedeutungen aufweisen.

Weiterhin bevorzugt steht die Gruppe G in den Formeln (54), (54-A), (54-B), (54-C), (55), (55-A), (56), (56-A), (57) und (57-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formeln (51) bis (57) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (51) bis (57) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (51) sind die im Folgenden abgebildeten Gruppen:

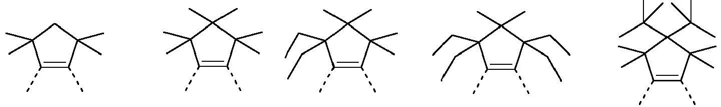

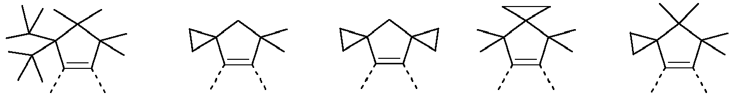

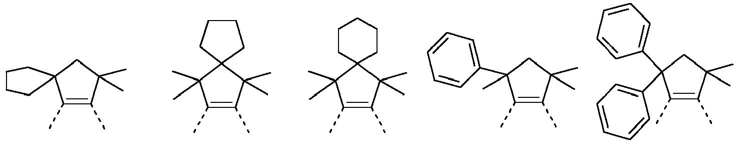

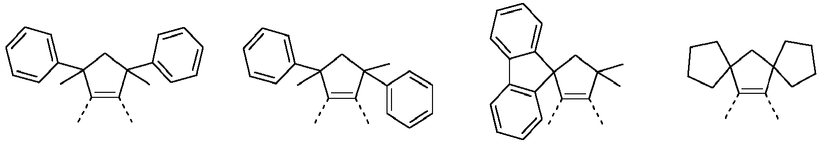

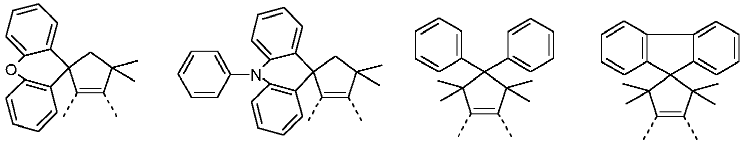

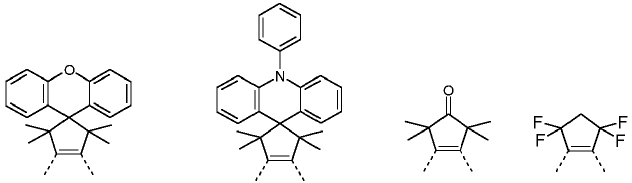

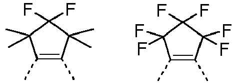

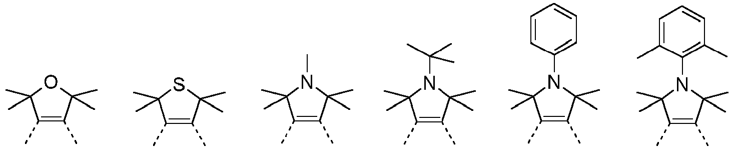

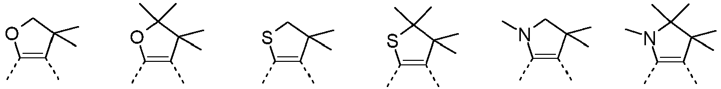

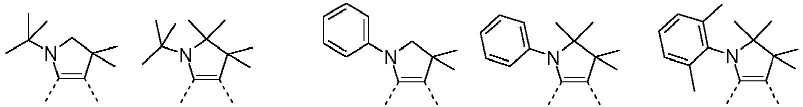

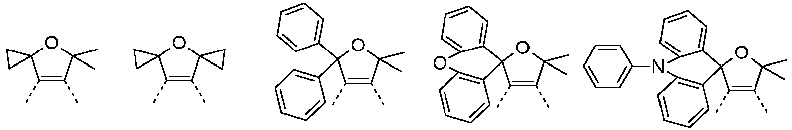

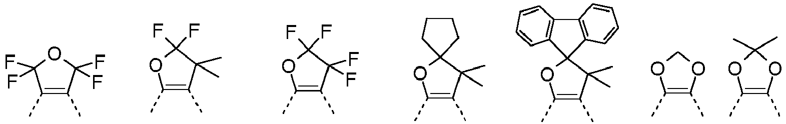

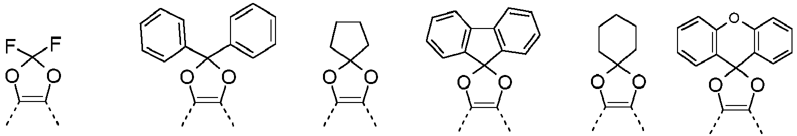

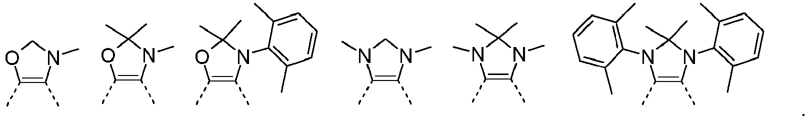

Beispiele für besonders geeignete Gruppen der Formel (52) sind die im Folgenden abgebildeten Gruppen:

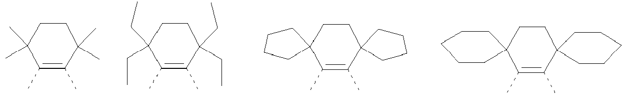

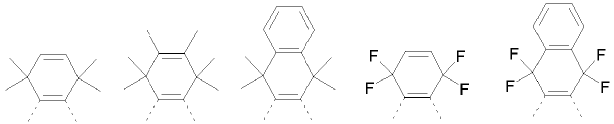

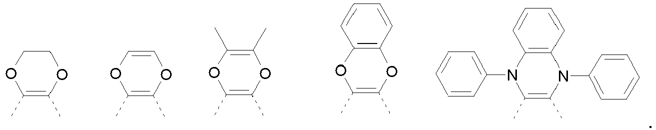

Beispiele für besonders geeignete Gruppen der Formel (53), (56) und (57) sind die im Folgenden abgebildeten Gruppen:

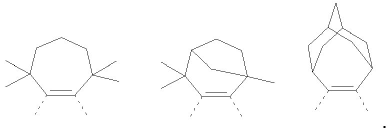

Beispiele für besonders geeignete Gruppen der Formel (54) sind die im Folgenden abgebildeten Gruppen:

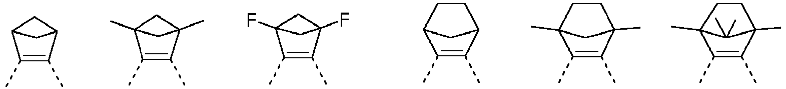

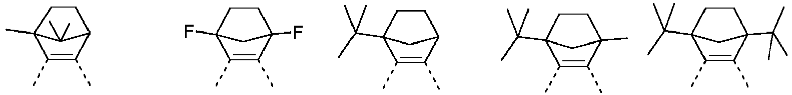

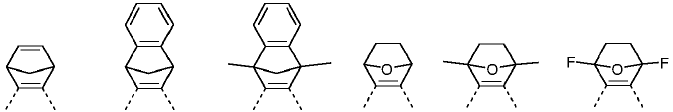

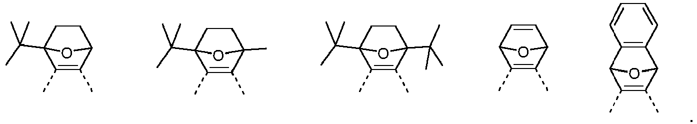

Beispiele für besonders geeignete Gruppen der Formel (55) sind die im Folgenden abgebildeten Gruppen:

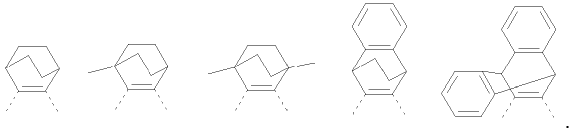

Wenn in den bidentaten Teilliganden L bzw. Liganden bzw. in den bivalenten Arylen- bzw. Heteroarylengruppen der Formel (5), welche in den Formeln (3) bzw. (4) bzw. den bevorzugten Ausführungsformen gebunden sind, Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, bevorzugt mit 6 bis 13 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono-oder polycyclisches, aliphatisches Ringsystem bilden.

Die oben genannten bevorzugten Ausführungsformen sind innerhalb des Umfangs der Ansprüche beliebig miteinander kombinierbar. In einer besonders bevorzugten Ausführungsform der Erfindung gelten die oben genannten bevorzugten Ausführungsformen gleichzeitig.

Bei den erfindungsgemäßen Verbindungen handelt es sich um chirale Strukturen. Je nach genauer Struktur der Komplexe und Liganden ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Bei der ortho-Metallierungsreaktion der Liganden fallen die zugehörigen bimetallischen Komplexe typischerweise als Gemisch aus ΛΛ- und ΔΔ-Isomeren sowie ΔΛ- und ΛΔ-Isomeren an. Entsprechendes gilt für die trimetallischen Komplexe. ΛΛ- und ΔΔ-Isomere bilden ein Enantiomerenpaar ebenso wie das ΔΛ- und ΛΔ-Isomere. Die Diastereomerenpaare können mit herkömmlichen Methoden, z. B. chromatographisch oder durch fraktionierte Kristallisation, getrennt werden. Je nach Symmetrie der Liganden können Stereozentren zusammenfallen, so dass auch Mesoformen möglich sind. So fallen z. B. bei der ortho-Metallierung von C₂ᵥ oder Cₛ symmetrischen Liganden ΛΛ- und ΔΔ-Isomere (Racemat, C₂-symmetrisch) und ein ΛΔ-Isomer (Mesoverbindung, Cₛ-symmetrisch) an. Die Darstellung sowie Trennung der Diastereomerenpaare soll an dem nachfolgenden Beispiel verdeutlicht werden.

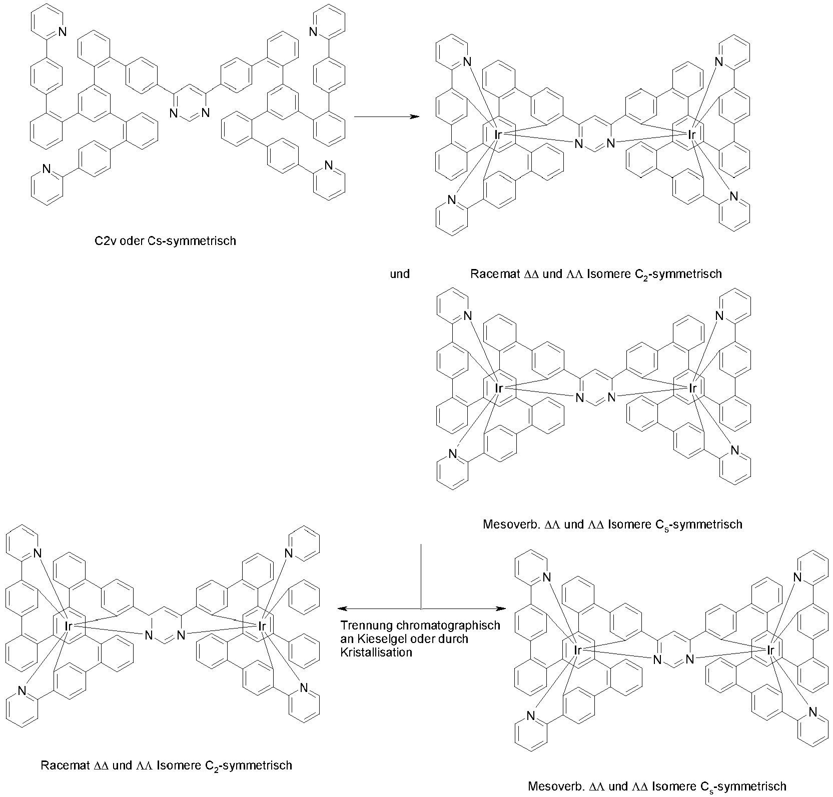

Die Racemattrennung der ΔΔ- und ΔΔ-Isomere kann via fraktionierter Kristallisation von diastereomeren Salzpaaren oder an chiralen Säulen nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(III)/Ir(IV)- oder die zweifach kationischen Ir(IV)/Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu dem enantiomerenreinen neutralen Komplex zu reduzieren, wie im Folgenden schematisch dargestellt. 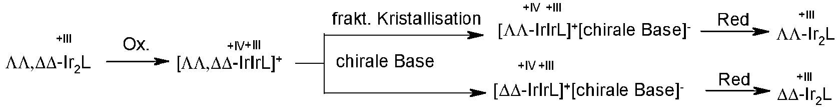 oder

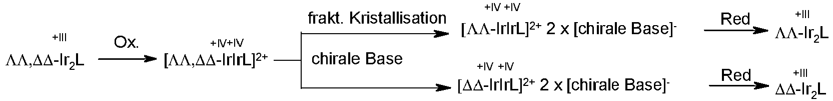

Enantiomerenreine Komplexe können auch gezielt synthetisiert werden, wie im folgenden Schema dargestellt. Dazu werden, wie oben beschrieben, die bei der ortho-Metallierung entstehenden Diastereomerpaare getrennt, bromiert und dann mit einer Boronsäure R*A-B(OH)₂ enthaltend einen chiralen Rest R* (bevorzugt >99% Enantiomerenüberschuss) via Kreuzkupplungsreaktion umgesetzt. Die enstehenden Diastereomerenpaare können chromatographisch an Kieselgel oder durch fraktionierte Kristallisation nach üblichen Methoden getrennt werden. So werden die enantiomeren-angereicherten bzw. enantiomerenreinen Komplexe erhalten. Anschließend kann die chirale Gruppe optional abgespalten werden oder auch im Molkül verbleiben.

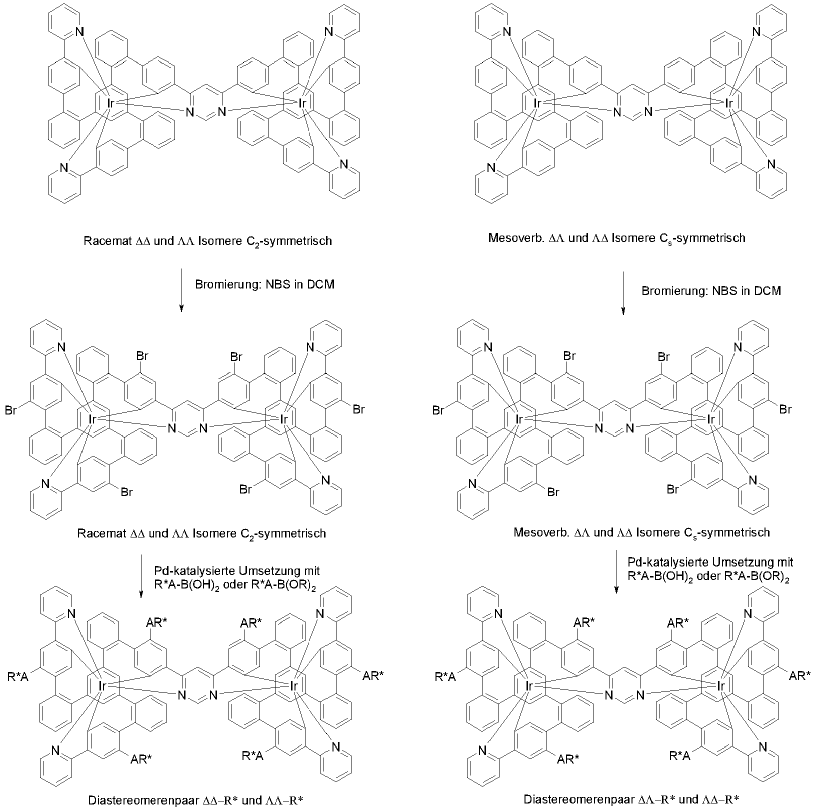

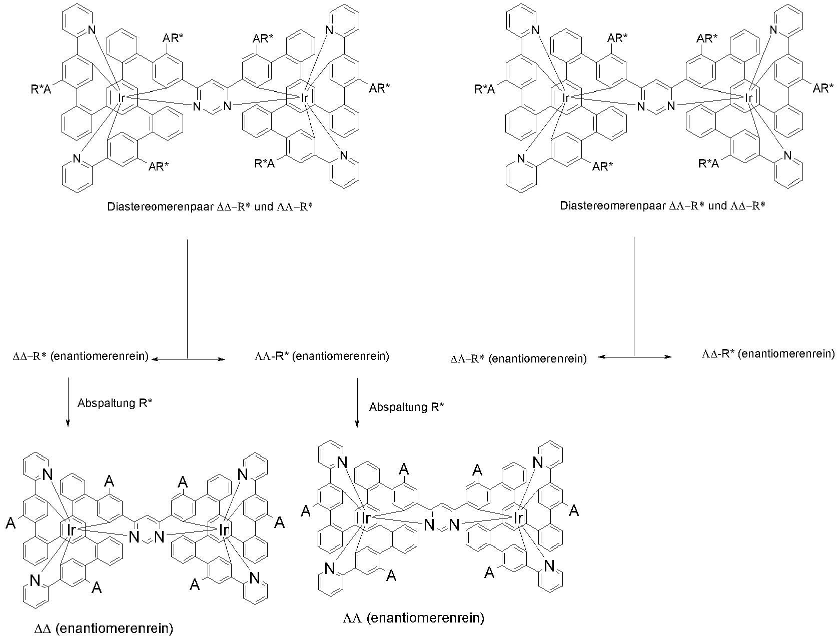

Üblicherweise fallen die Komplexe bei der ortho-Metallierung als Gemisch aus Diastereomerenpaaren an. Es gibt jedoch auch die Möglichkeit, nur eines der Diastereomerenpaare gezielt zu synthetisieren, da sich das andere, je nach Ligandenstruktur, aus sterischen Gründen nicht oder weniger bevorzugt bildet. Dies soll anhand des folgenden Beispiels aufgezeigt werden.

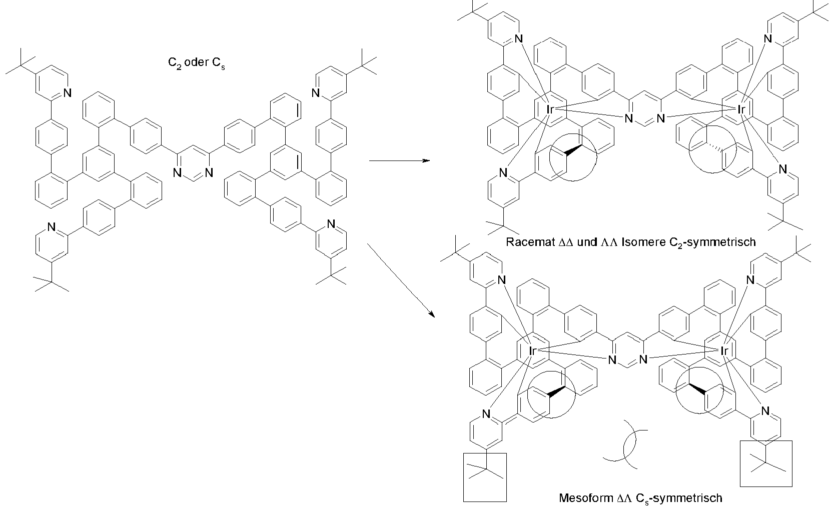

Durch den hohen Platzanspruch der *tert*-Butylgruppen wird bei der ortho-Metallierung bevorzugt oder ausschließlich das Racemat aus ΛΛ- und ΔΔ-Isomeren gebildet und nicht die Mesoform. Bei der Mesoform (Cₛ-symmetrisch) stehen die kreisrund umrandeten Bindungen der 2-Phenylpyridinliganden aus der Zeichenebene heraus. Durch den hohen sterischen Anspruch der *tert*-Butylgruppen am Pyridinring wird das Meso-Isomer nicht oder weniger bevorzugt gebildet. Beim Racemat (C₂-symmetrisch) hingegen zeigt eine Bindung zum 2-Phenylpyridinligand in die Zeichenebene hinein, die andere aus der Zeichenebene hinaus. Je nach sterischem Anspruch der Gruppe entsteht das Racemat bevorzugt oder ausschließlich.

Die erfindungsgemäßen Komplexe können insbesondere durch den nachfolgend beschriebenen Weg dargestellt werden. Dazu wird der 12- bzw. 18-zähnige Ligand dargestellt und dann an die Metalle M durch eine ortho-Metallierungsreaktion koordiniert. Generell wird hierzu ein Iridium- bzw. Rhodiumsalz mit dem entsprechenden freien Liganden umgesetzt.

Daher ist ein weiterer Gegenstand der vorliegenden Erfindung ein Verfahren zur Herstellung der erfindungsgemäßen Verbindung durch Umsetzung des entsprechenden freien Liganden mit Metallalkoholaten der Formel (58), mit Metallketoketonaten der Formel (59), mit Metallhalogeniden der Formel (60) oder mit Metallcarboxylaten der Formel (61), 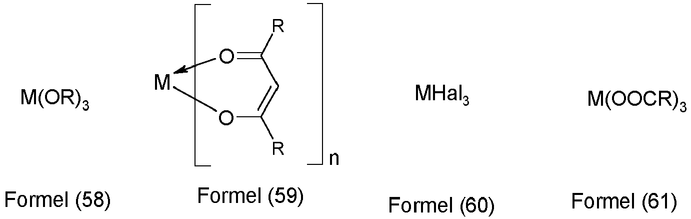 wobei M und R die oben angegebenen Bedeutungen aufweisen, Hal = F, Cl, Br oder I ist und die Iridium- bzw. Rhodiumedukte auch als die entsprechenden Hydrate vorliegen können. Dabei steht R bevorzugt für eine Alkylgruppe mit 1 bis 4 C-Atomen.

Es können ebenfalls Iridium- bzw. Rhodiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [lrCl₂(acac)₂]⁻, beispielsweise Na[lrCl₂(acac)_{2]}, Metallkomplexe mit Acetylacetonat-Derivaten als Ligand, beispielsweise Ir(acac)₃ oder Tris-(2,2,6,6-Tetramethylheptan-3,5-dionato)iridium, und IrCl₃·xH₂O, wobei x üblicherweise für eine Zahl zwischen 2 und 4 steht.

Die Synthese der Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und/oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bis-phenoxybenzol, Triphenylphosphinoxid, 18-Krone-6, Phenol, 1-Naphthol, Hydrochinon, etc.. Dabei ist die Verwendung von Hydrochinon besonders bevorzugt.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (51) bis (57) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Metallkomplexe aus flüssiger Phase, beispielsweise durch Spin-Coating oder durch Druckverfahren, sind Formulierungen der erfindungsgemäßen Metallkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Der oben beschriebene erfindungsgemäße Metallkomplex bzw. die oben aufgeführten bevorzugten Ausführungsformen können in der elektronischen Vorrichtung als aktive Komponente oder als Sauerstoff-Sensibilisatoren verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Metallkomplex enthält. Dabei sind bevorzugte elektronische Vorrichtungen ausgewählt aus der Gruppe bestehend aus organischen Elektrolumineszenzvorrichtungen (OLEDs, PLEDs), organischen Infrarot-Elektrolumineszenzsensoren, organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen (Grätzel-Zellen) verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens einen erfindungsgemäßen Metallkomplex. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Weiß emittierende organische Elektrolumineszenzvorrichtungen können für Beleuchtungsanwendungen oder mit Farbfilter auch für Vollfarb-Displays verwendet werden. Weiß emittierende OLEDs können auch durch Tandem-OLEDs realisiert werden. Weiterhin können weiß emittierende OLEDs auch dadurch realisiert werden, dass zwei oder mehr Emitter, die Licht in unterschiedlicher Farbe emittieren und von denen mindestens einer eine erfindungsgemäße Verbindung ist, in einer emittierenden Schicht vorliegen, so dass sich das emittierte Licht der einzelnen Emitter zu weißem Licht addiert.

In einer bevorzugten Ausführungsform der Erfindung enthält die organische Elektrolumineszenzvorrichtung den erfindungsgemäßen Metallkomplex als emittierende Verbindung in einer oder mehreren emittierenden Schichten.

Viele der erfindungsgemäßen Verbindungen emittieren Licht im roten Spektralbereich. Es ist aber auch möglich, durch geeignete Wahl der Liganden und Substitutionsmuster, die Emission einerseits bis in den infraroten Bereich zu verschieben und andererseits hypsochrom zu verschieben, bevorzugt in den orange, gelben oder grünen Bereich, aber auch in den blauen Bereich zu verschieben.

Wenn der erfindungsgemäße Metallkomplex als emittierende Verbindung in einer emittierenden Schicht eingesetzt wird, wird er bevorzugt in Kombination mit einem oder mehreren Matrixmaterialien eingesetzt, wobei nachfolgend die Begriffe "Matrixmaterial" und "Hostmaterial" synonym verwendet werden. Die Mischung aus dem erfindungsgemäßen Metallkomplex und dem Matrixmaterial enthält zwischen 0.1 und 99 Gew.-%, vorzugsweise zwischen 1 und 90 Gew.-%, besonders bevorzugt zwischen 3 und 40 Gew.-%, insbesondere zwischen 5 und 25 Gew.-% des erfindungsgemäßen Metallkomplexes bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 60 Gew.-%, insbesondere zwischen 95 und 75 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011/042107 oder WO 2011/088877.

Für lösungsprozessierte OLEDs eignen sich als Matrixmaterialien auch Polymere, z. B. gemäß WO 2012/008550 oder WO 2012/048778, Oligomere oder Dendrimere, z. B. gemäß Journal of Luminescence 183 (2017), 150-158.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial (so genannter "wide bandgap host"), welches nicht bzw. nicht in wesentlichem Maße am Ladungstransport beteiligt ist, wie z. B. in WO 2010/108579 oder WO 2016/184540 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Nachfolgend sind Beispiele für Verbindungen abgebildet, die sich als Matrixmaterialien für die erfindungsgemäßen Verbindungen eignen.

Nachfolgend sind Beispiele für Verbindungen abgebildet, die sich als Matrixmaterialien für die erfindungsgemäßen Verbindungen eignen.

Beispiele für Triazine und Pyrimidine, welche als elektronentransportierende Matrixmaterialien eingesetzt werden können:

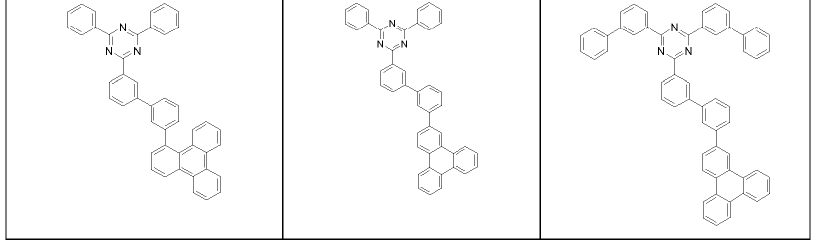

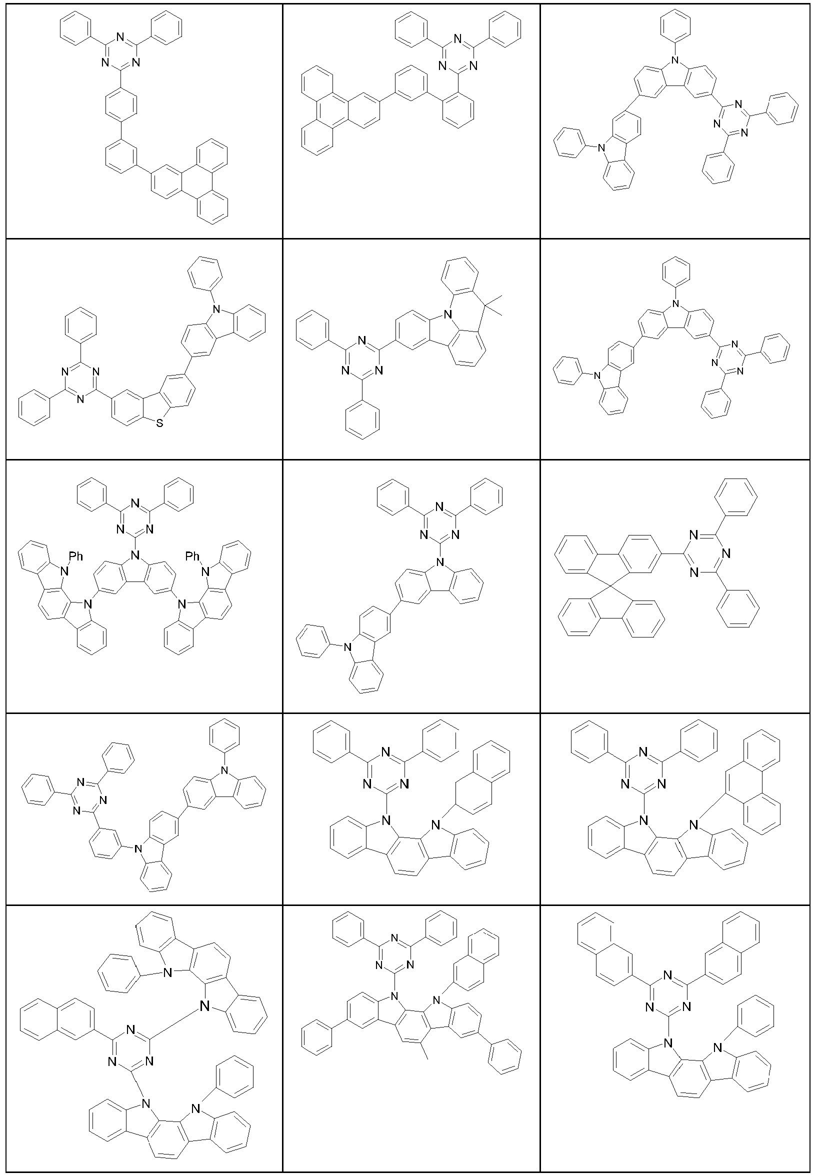

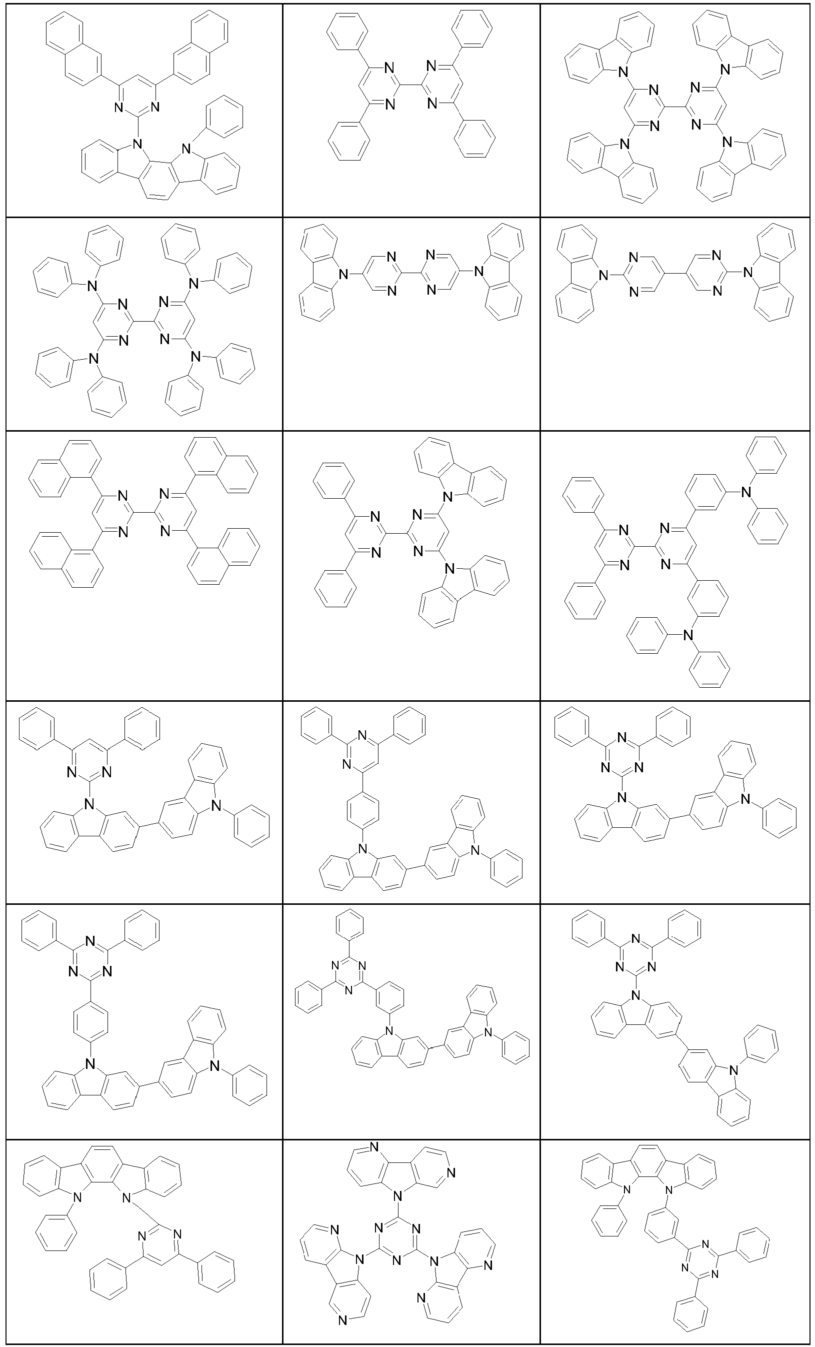

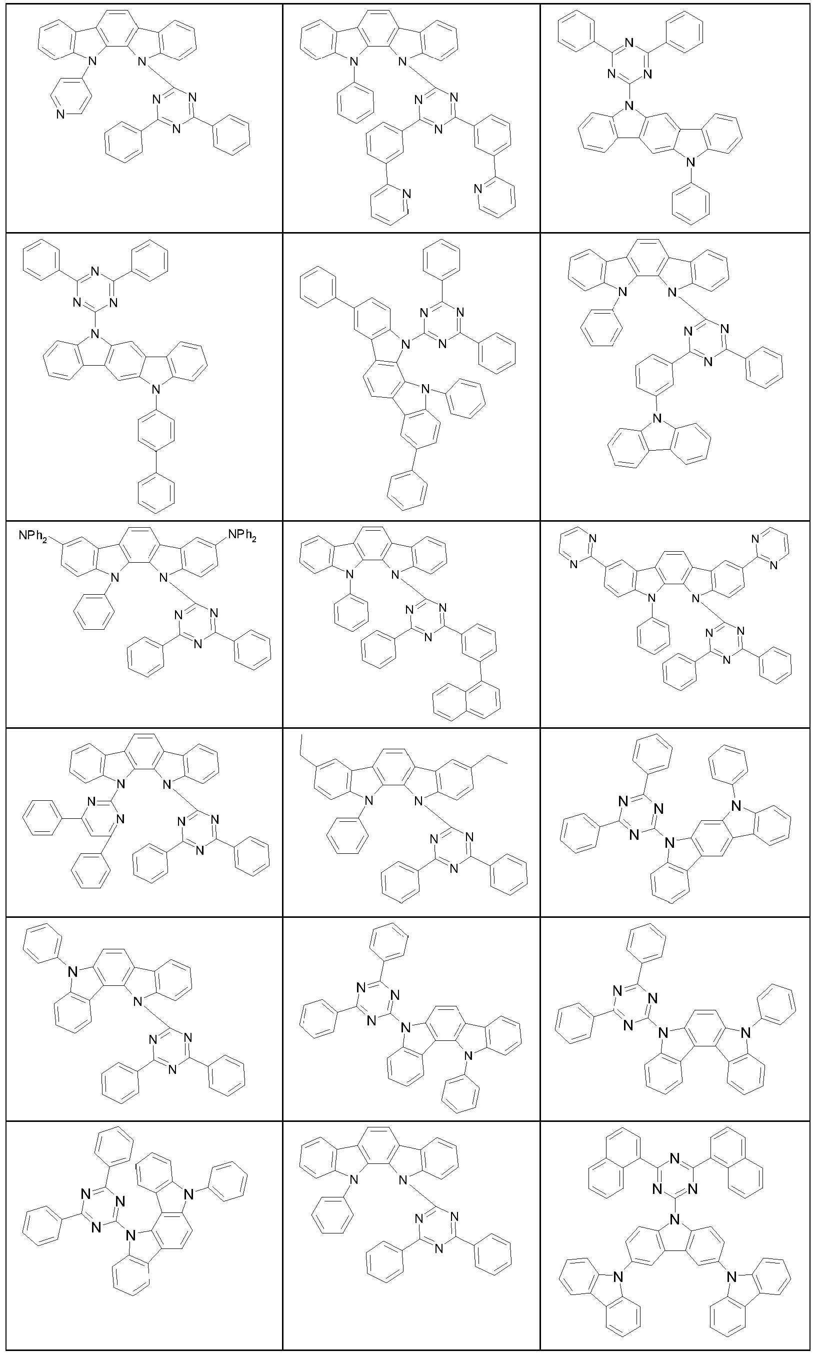

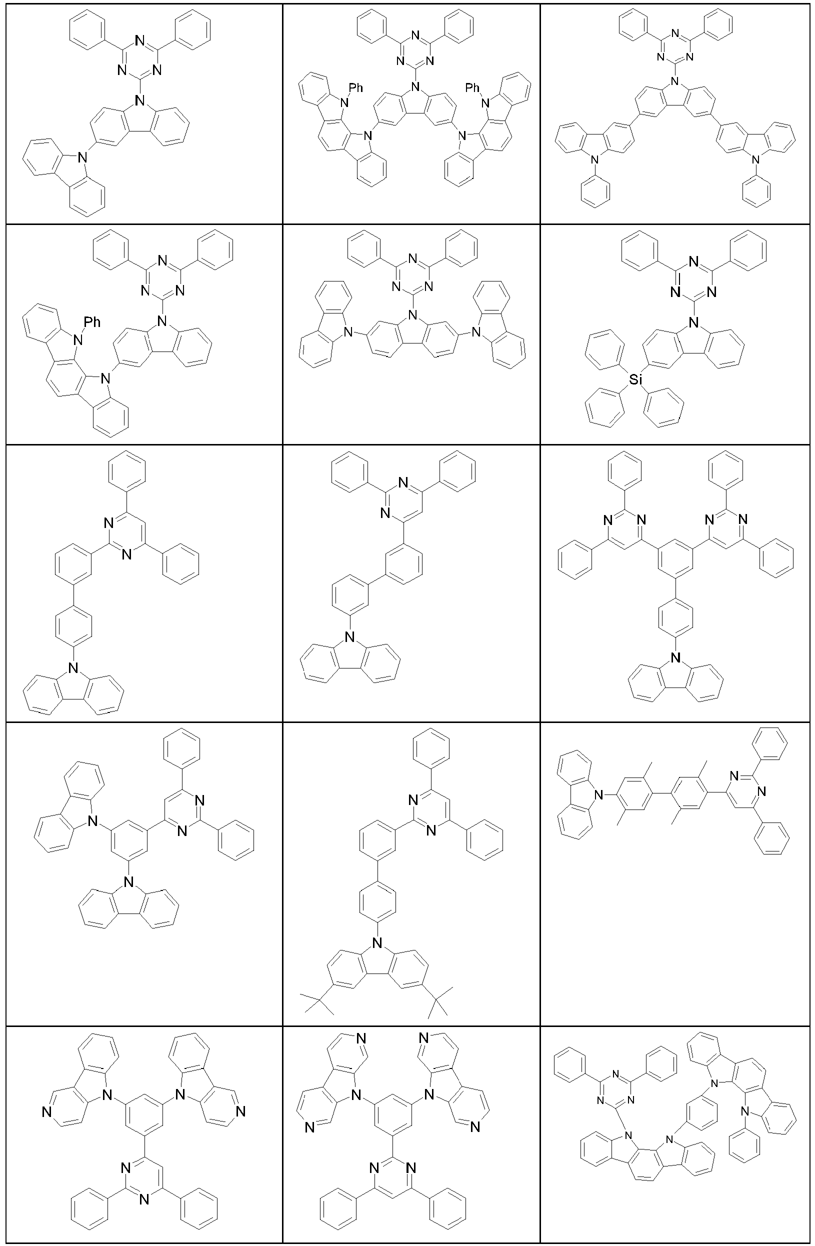

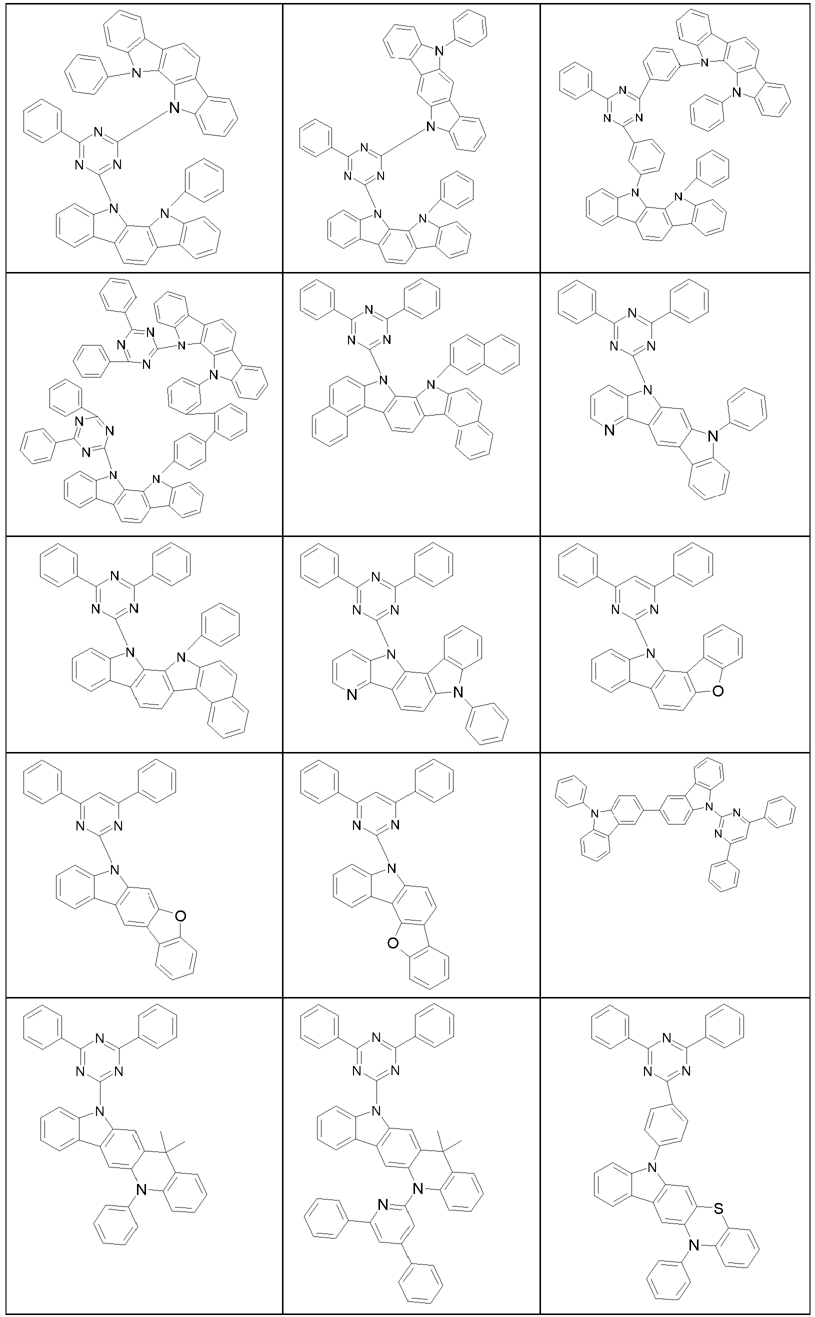

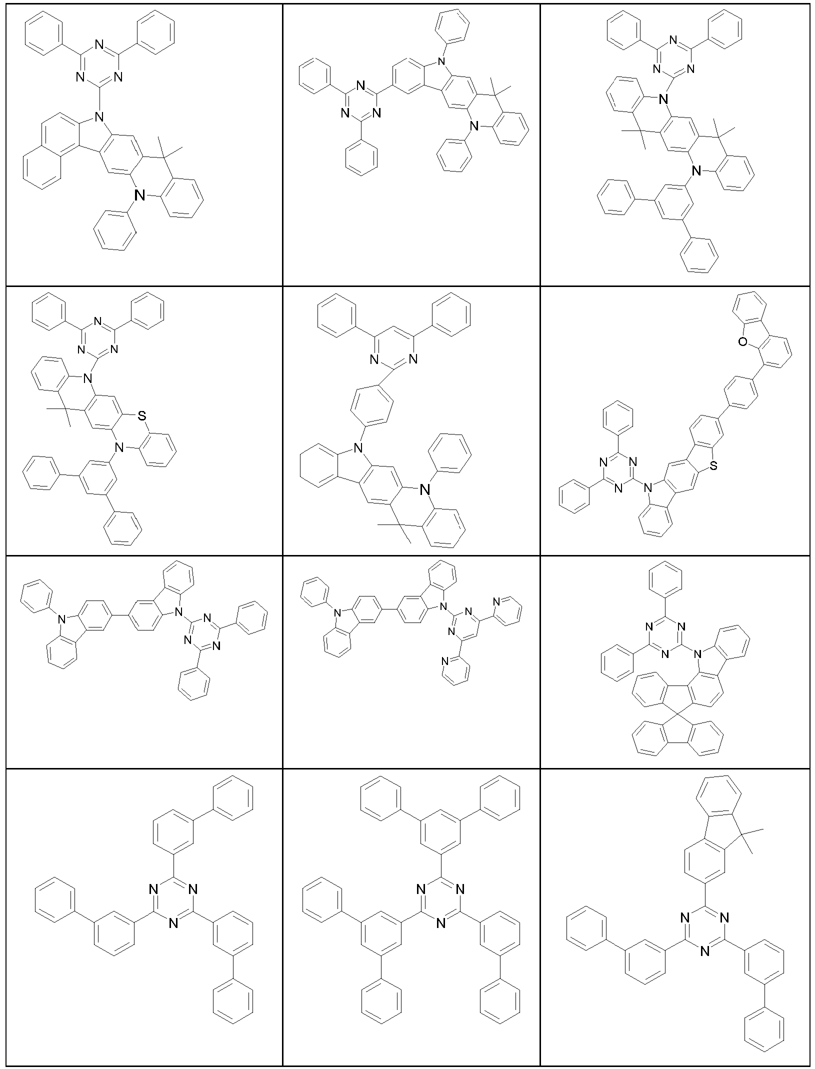

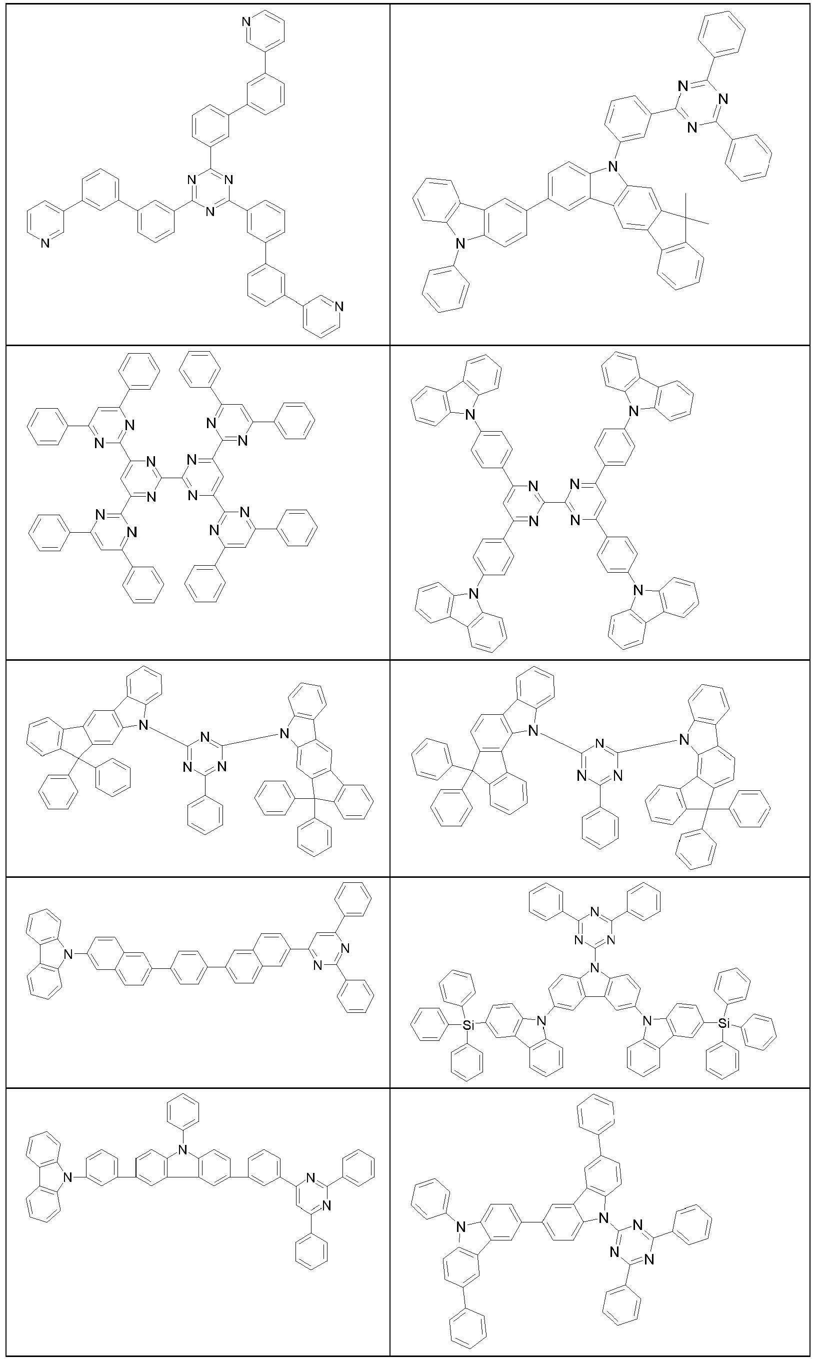

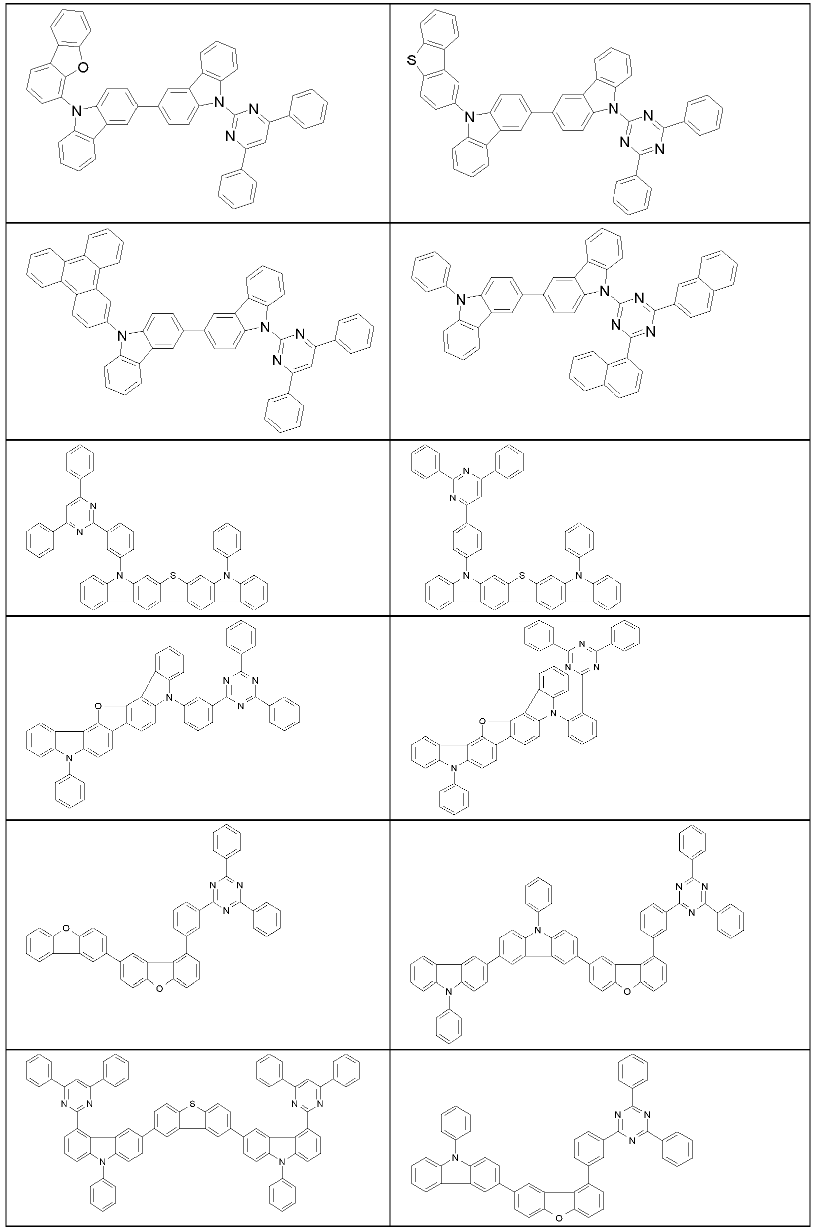

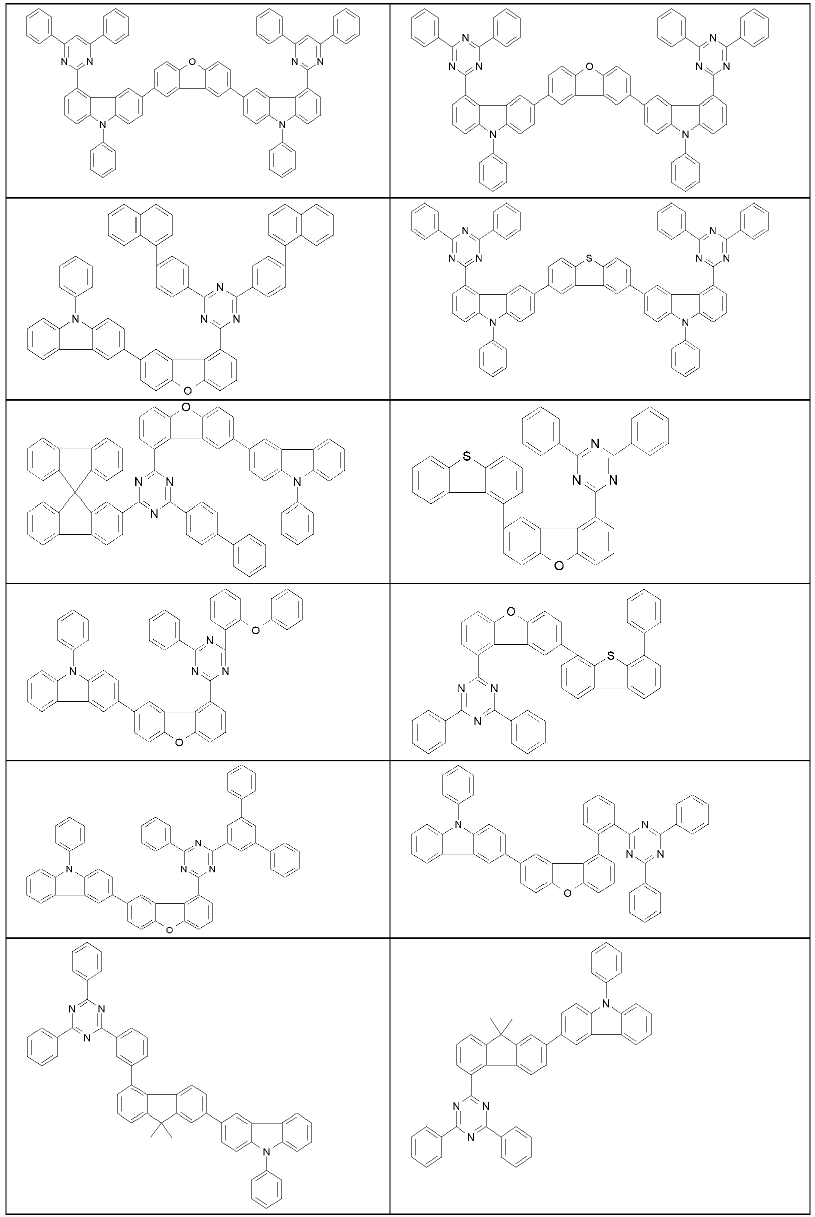

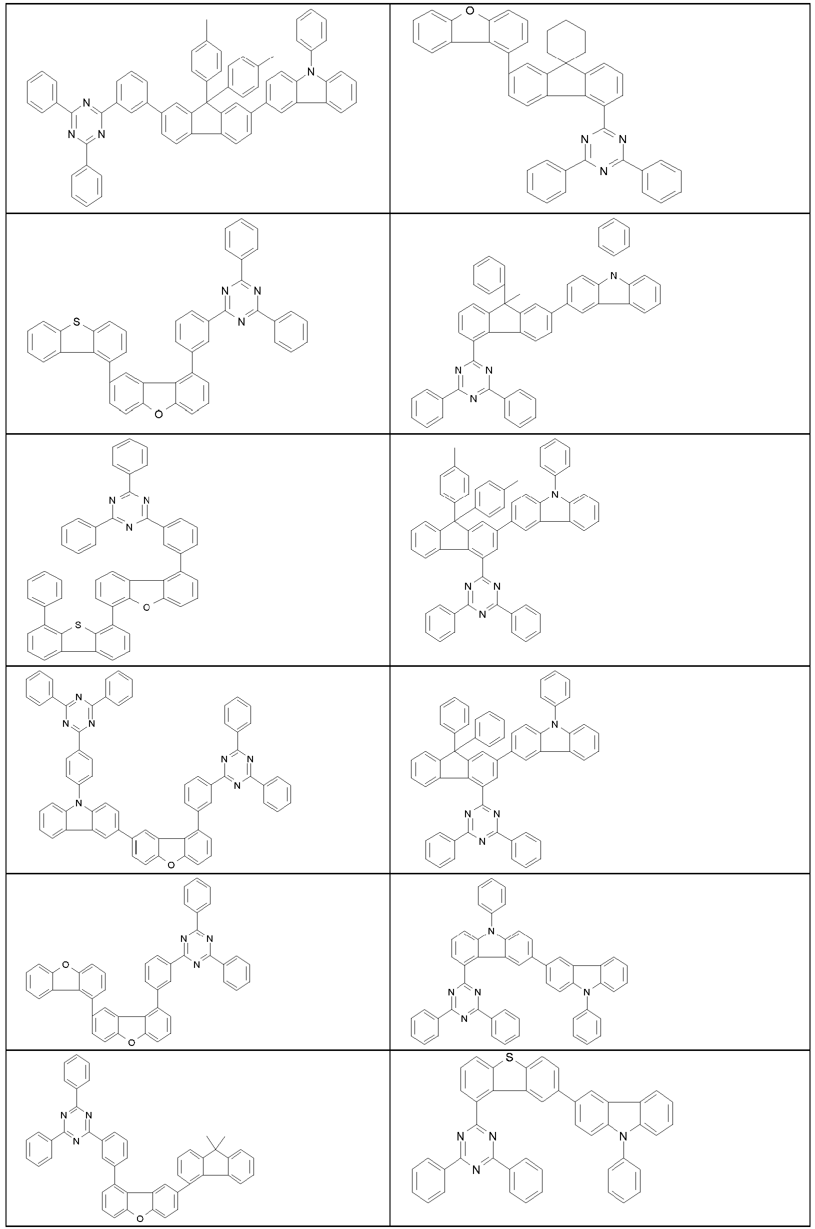

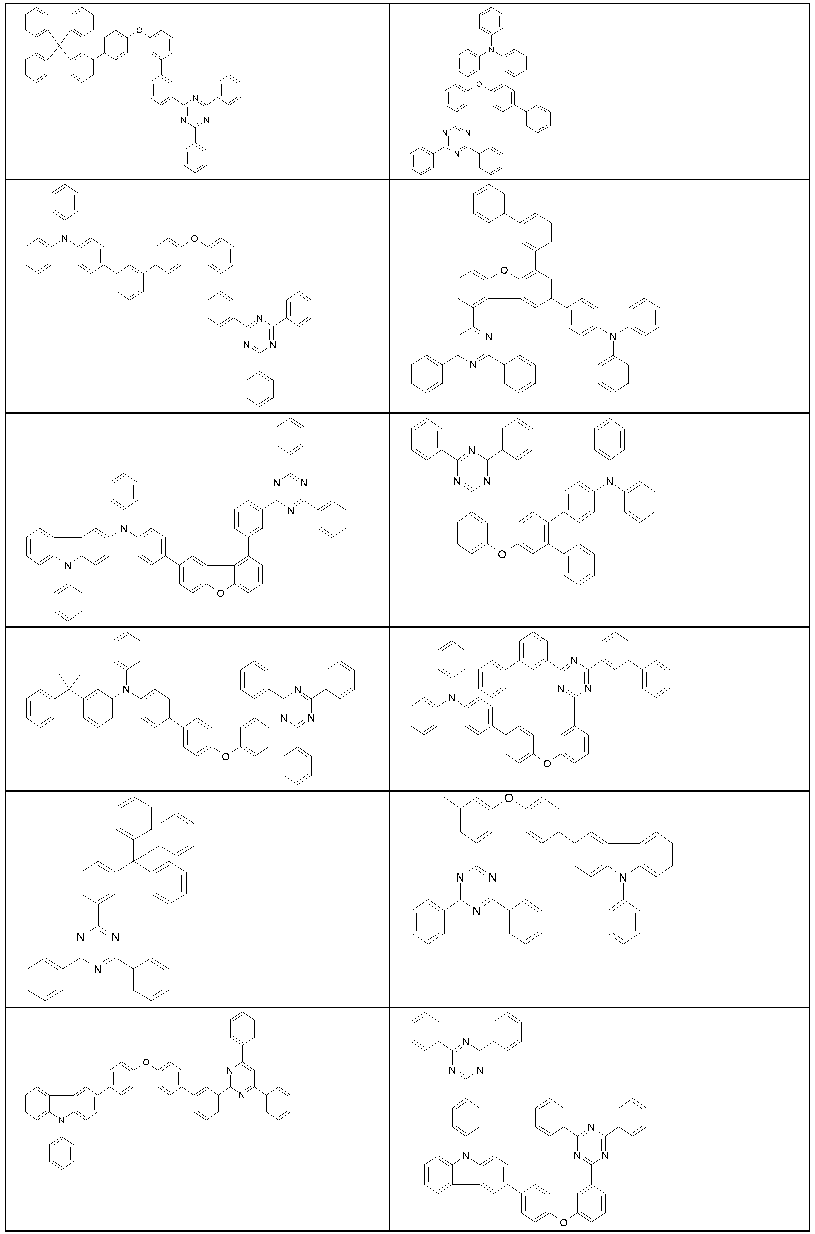

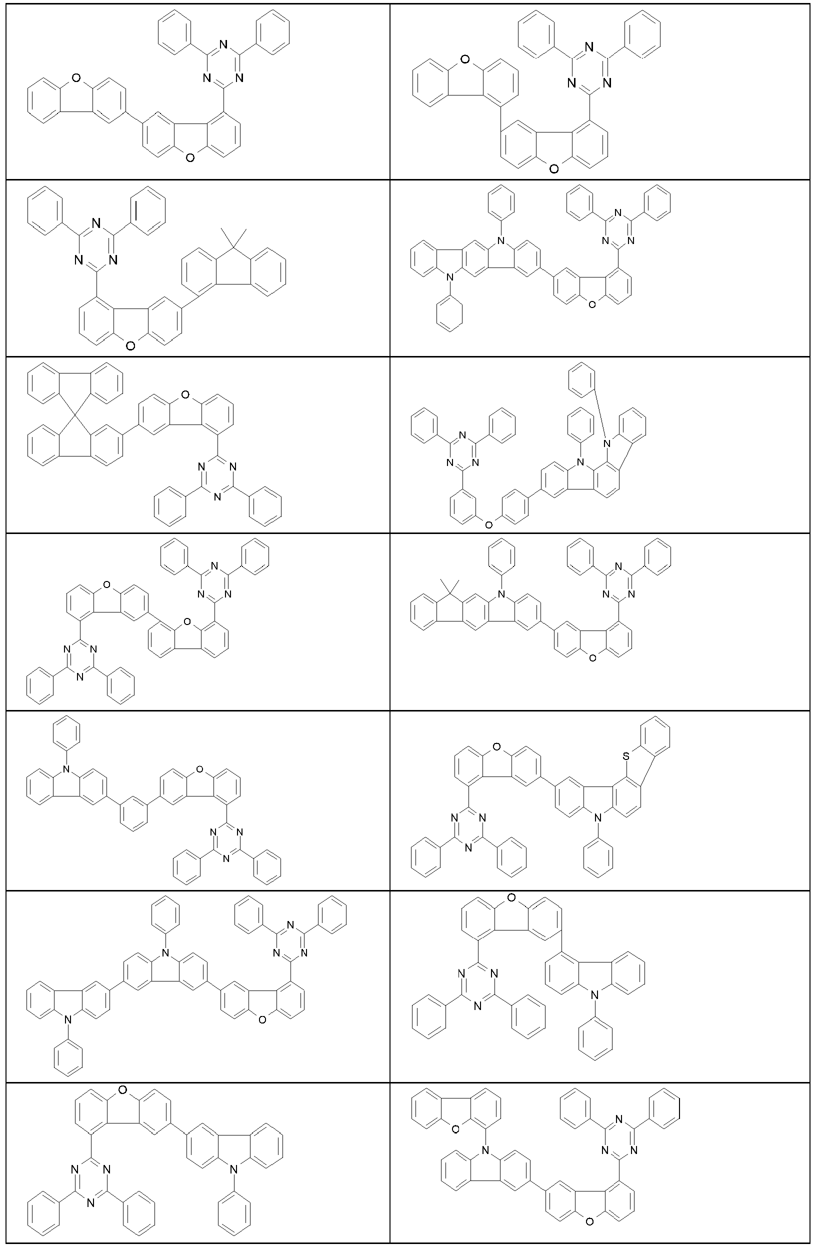

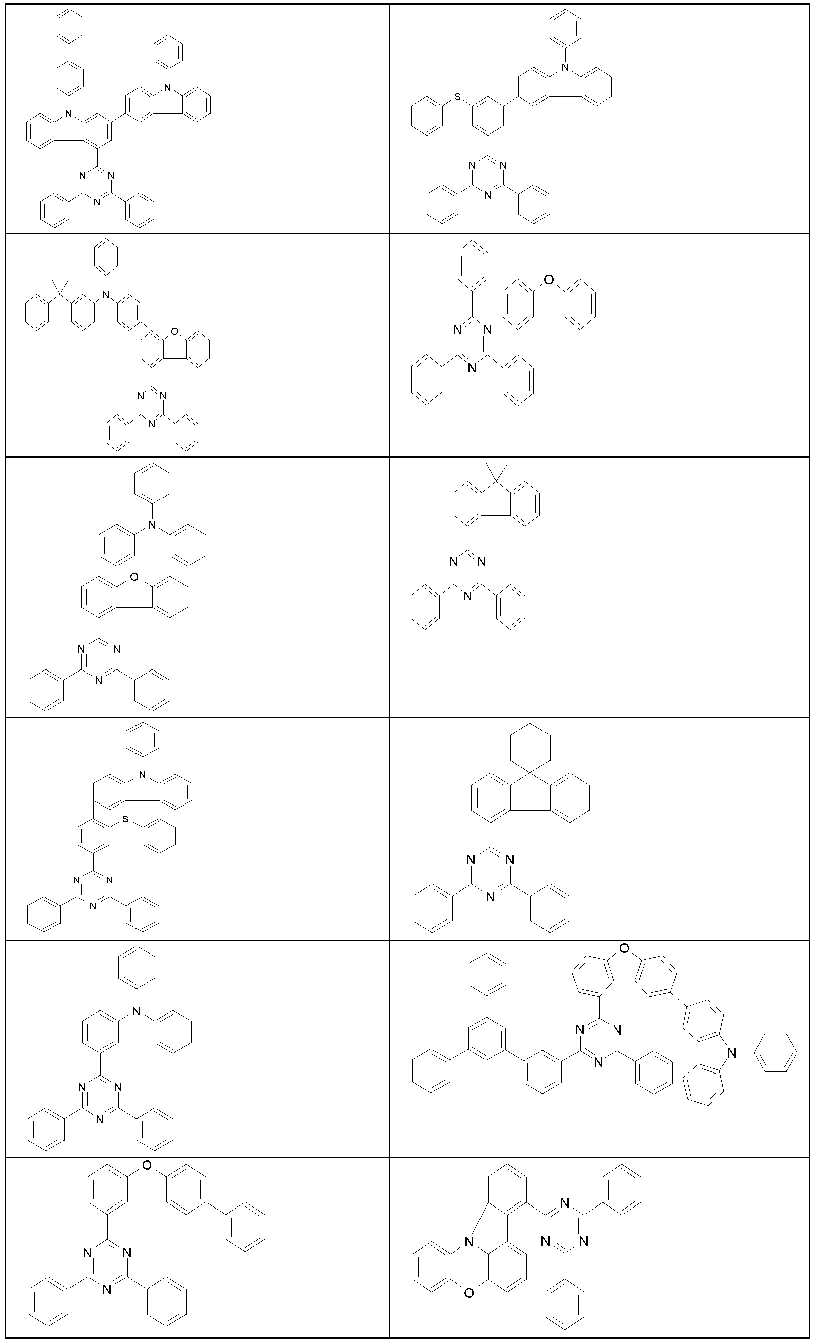

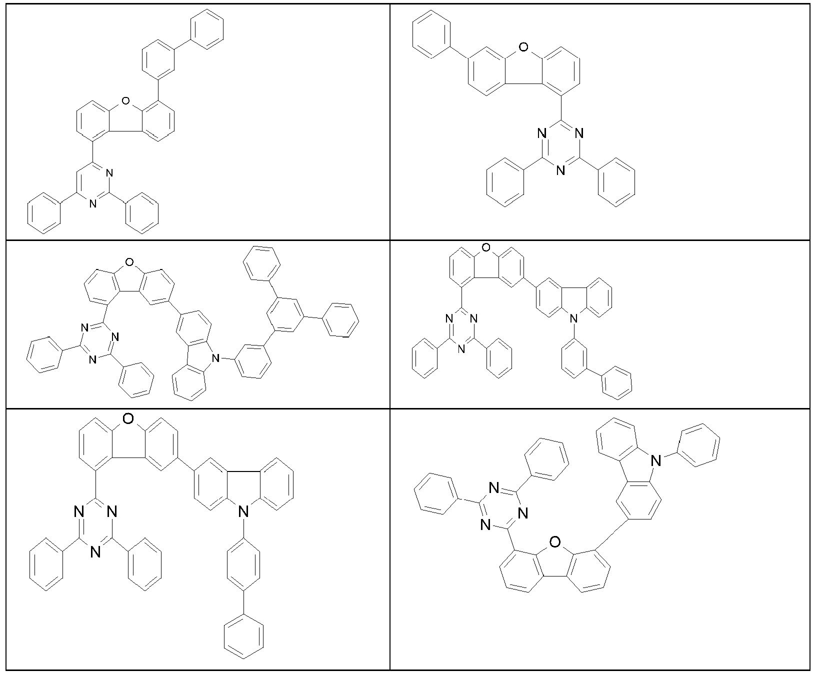

Beispiele für Lactame, welche als elektronentransportierende Matrixmaterialien eingesetzt werden können:

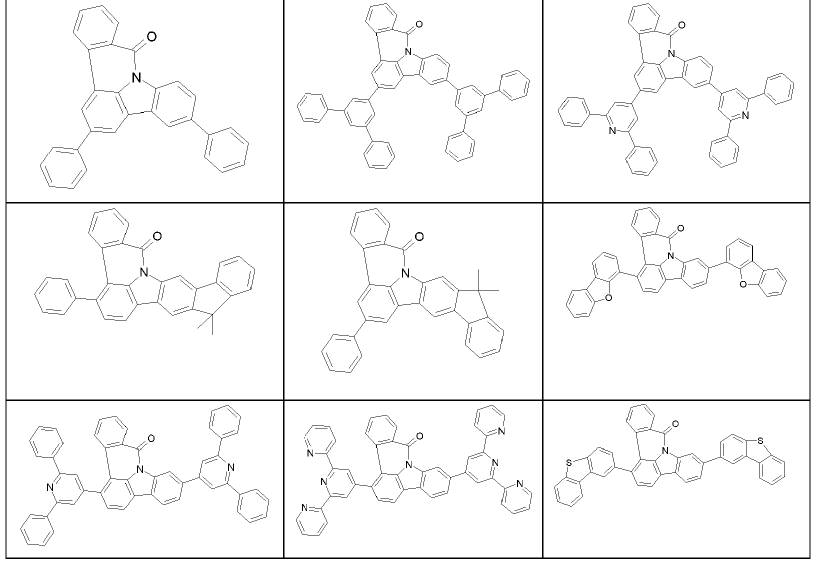

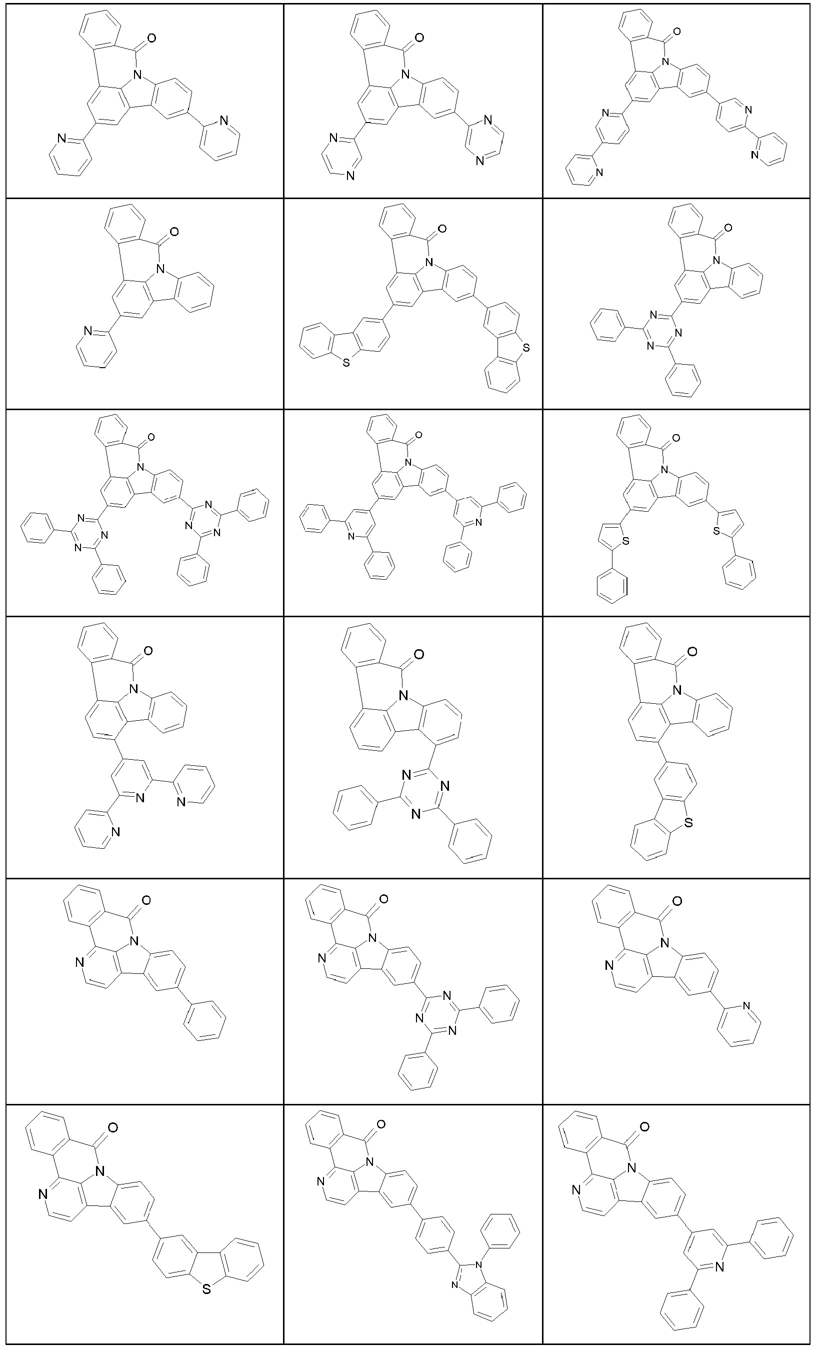

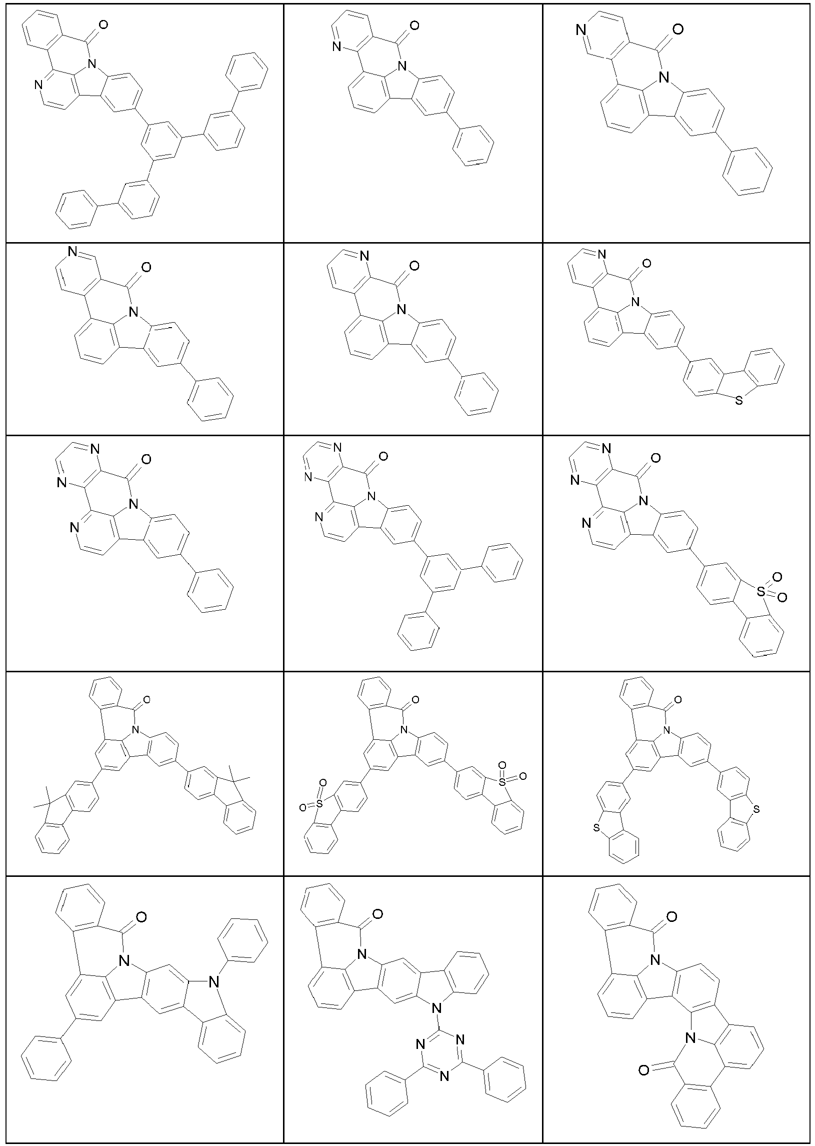

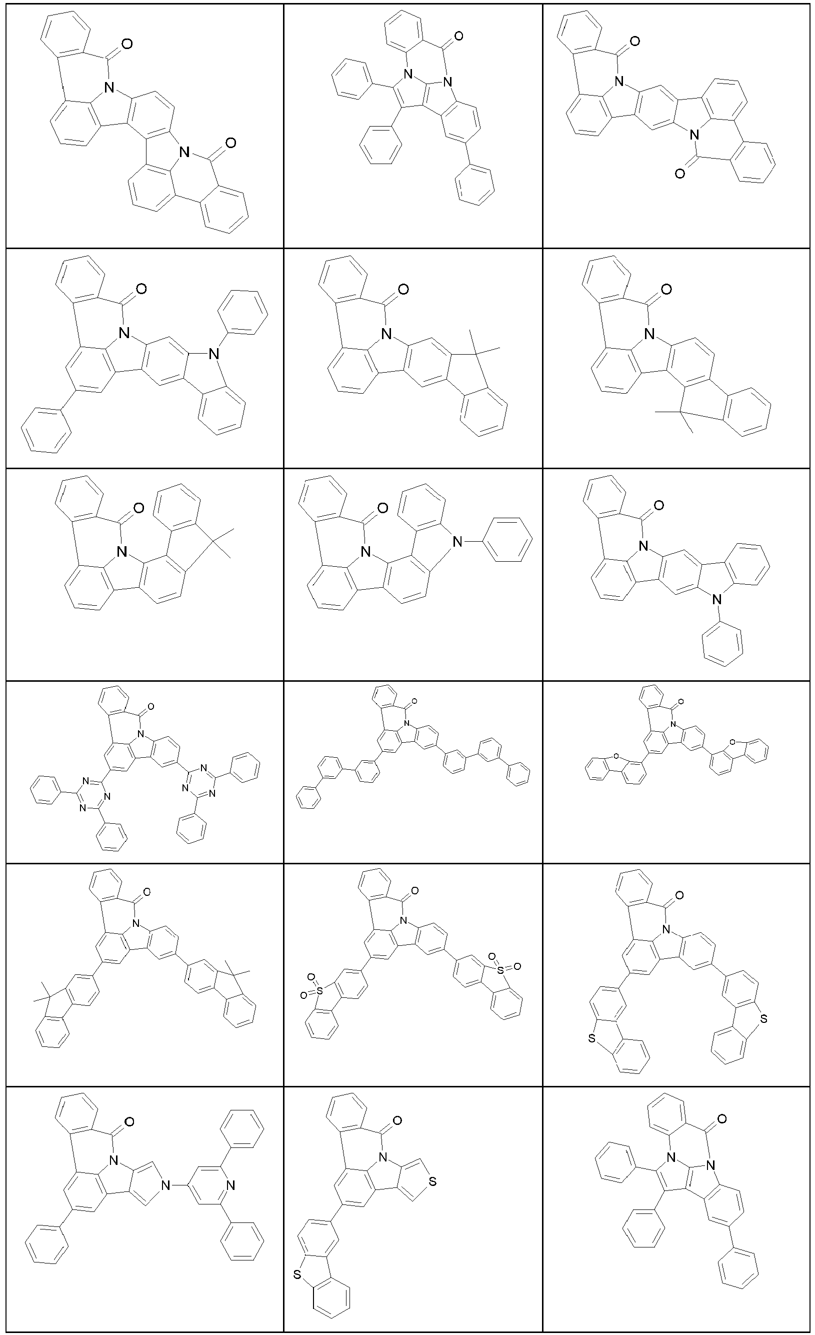

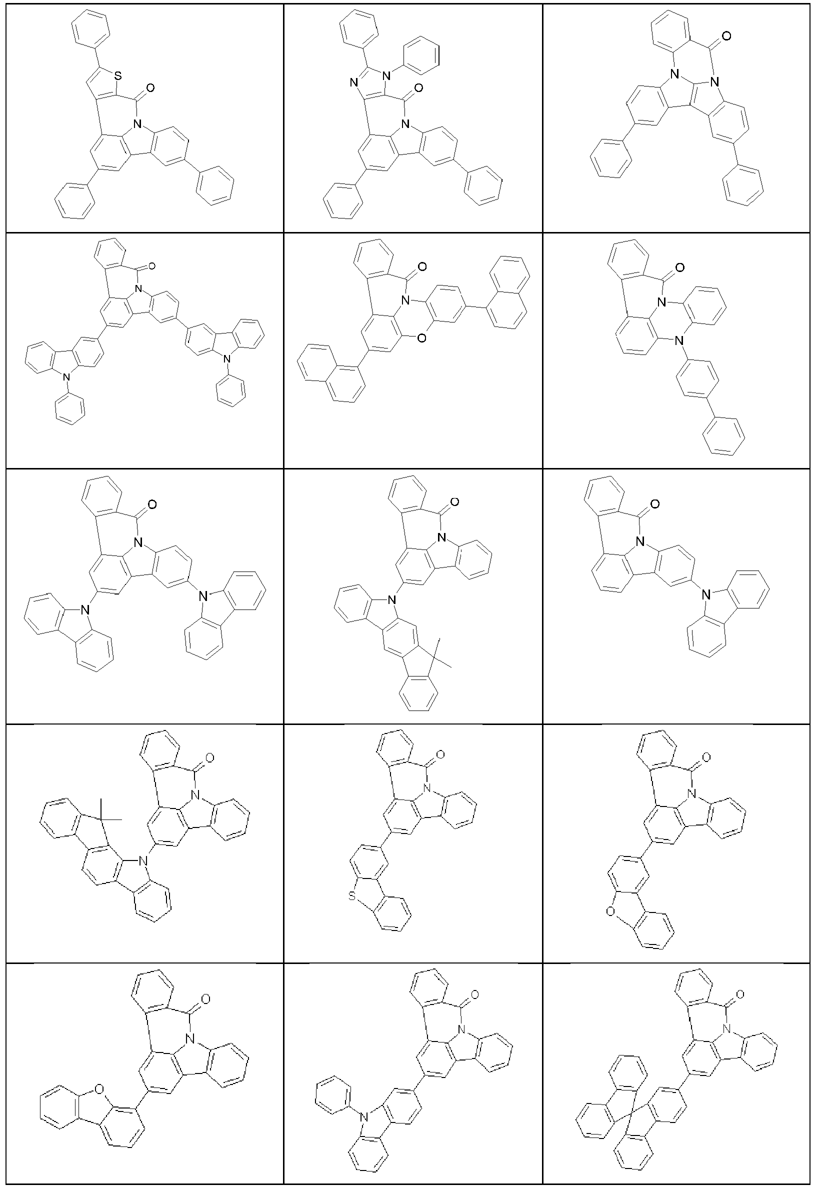

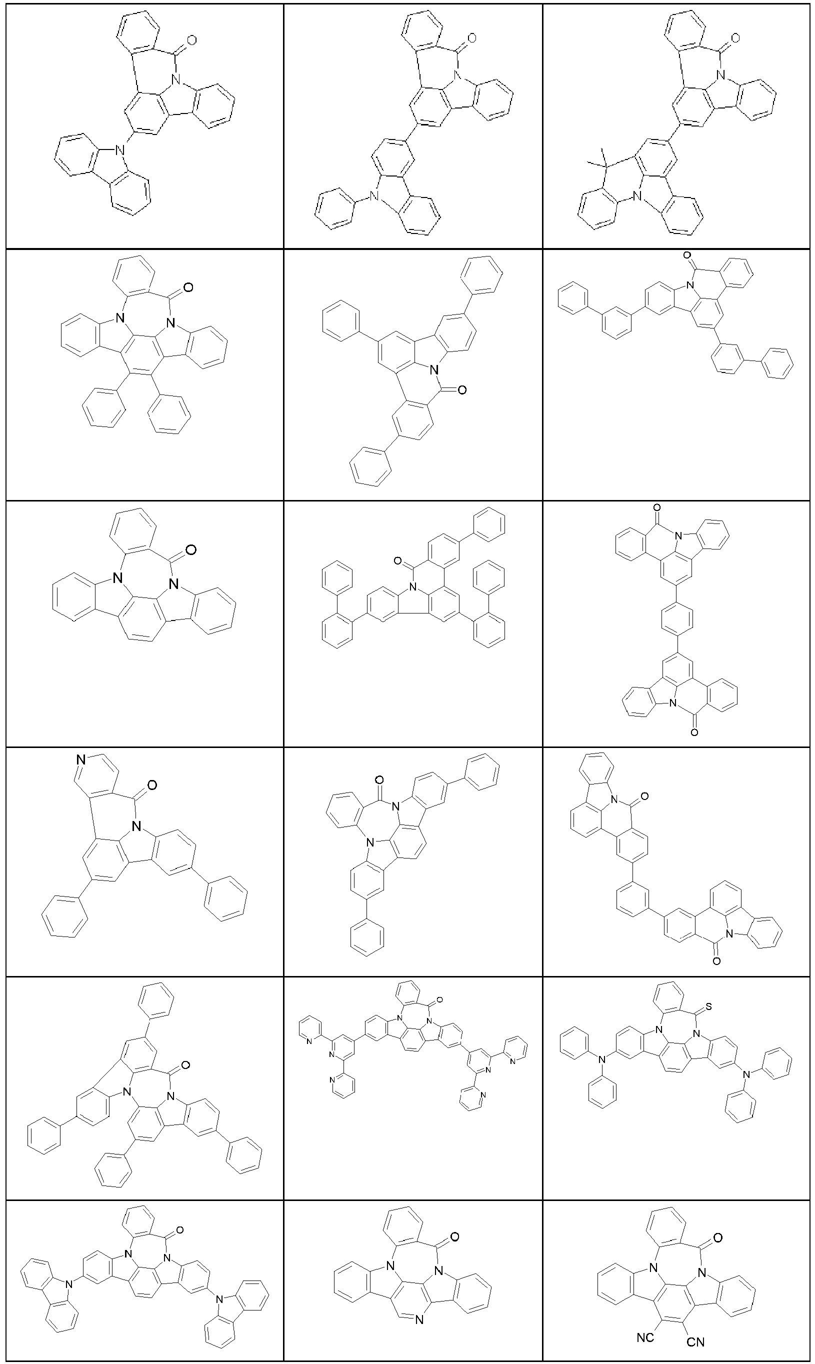

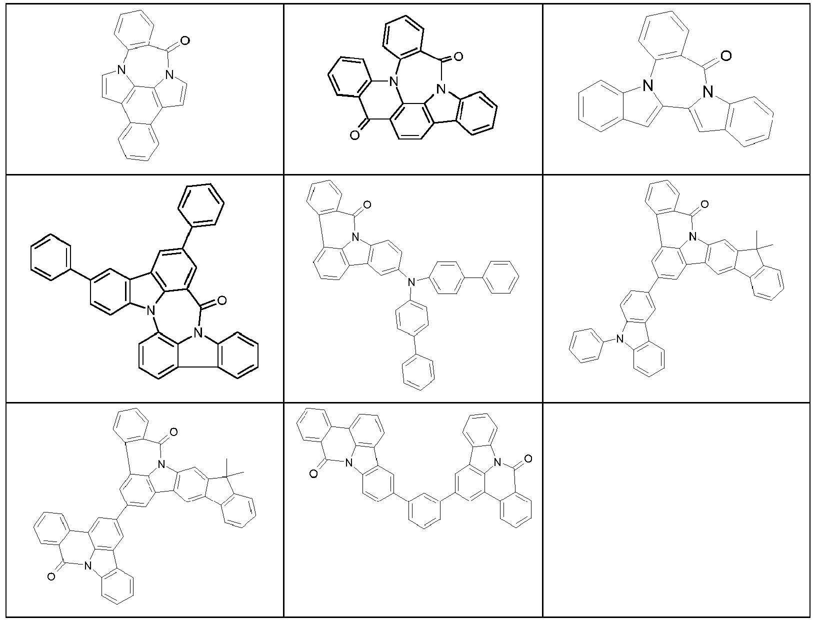

Beispiele für Ketone, welche als elektronentransportierende Matrixmaterialien eingesetzt werden können:

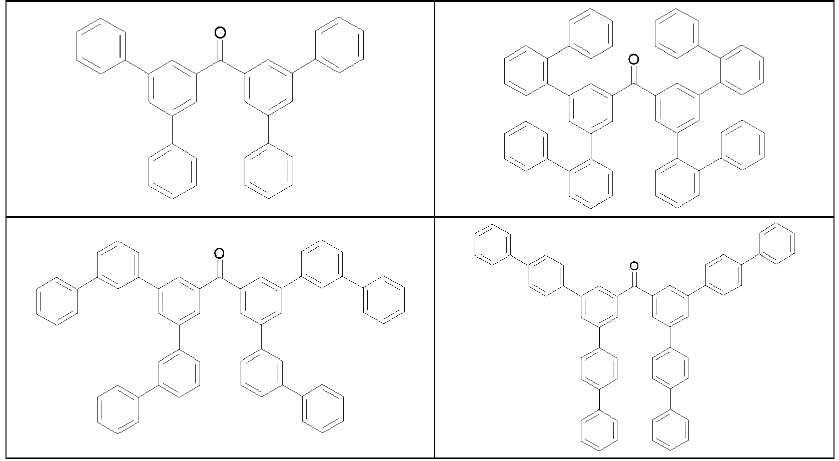

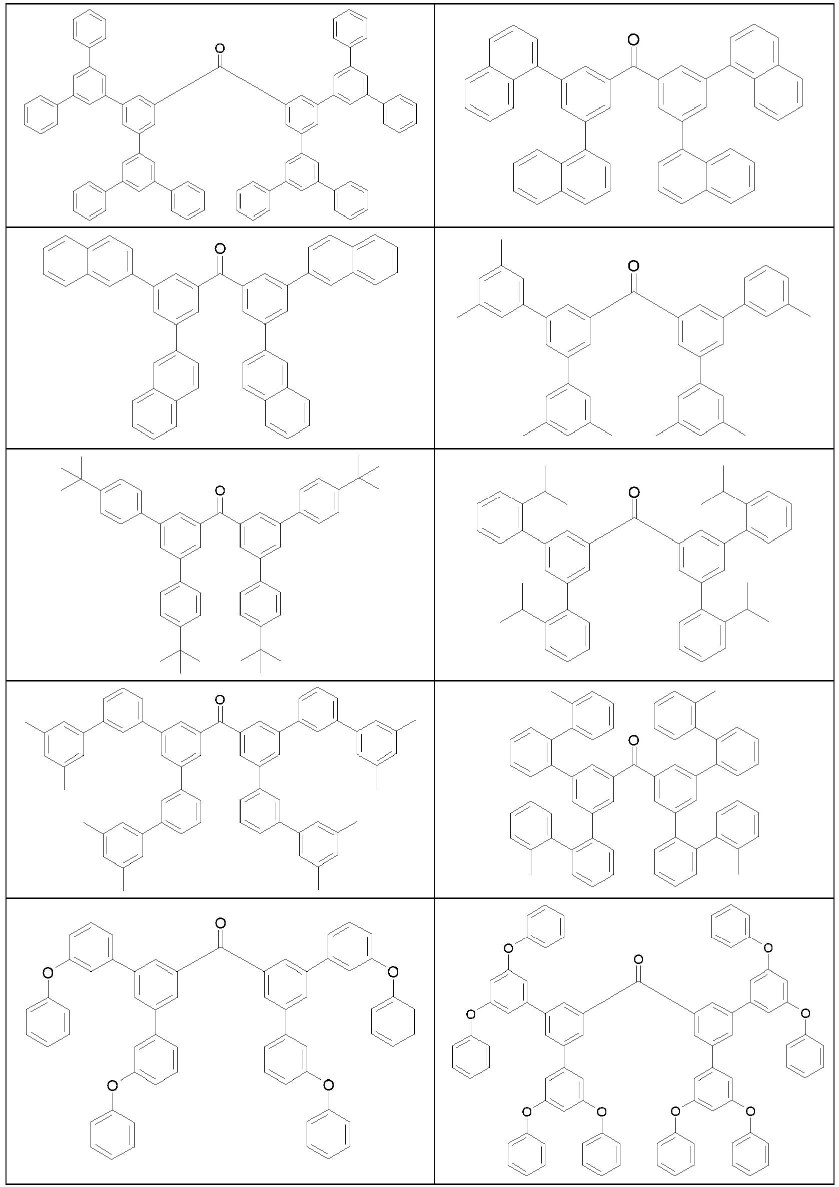

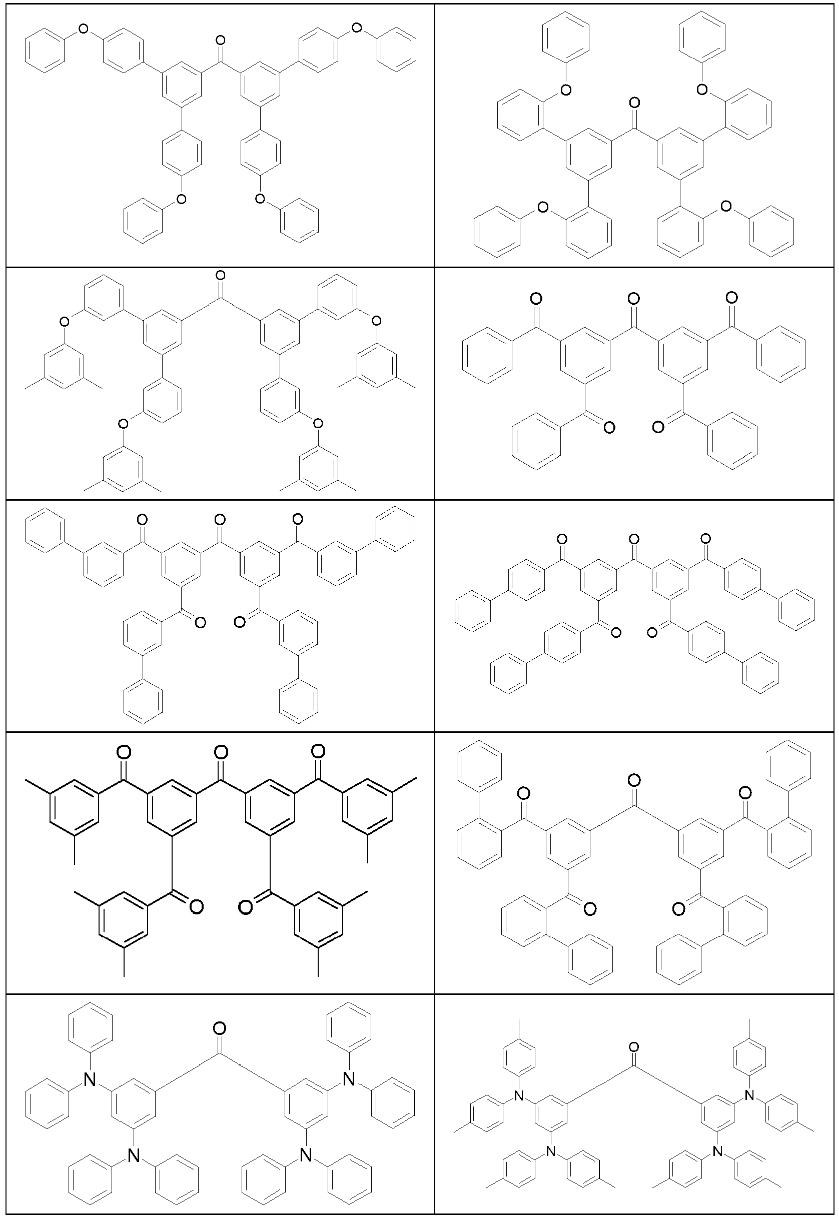

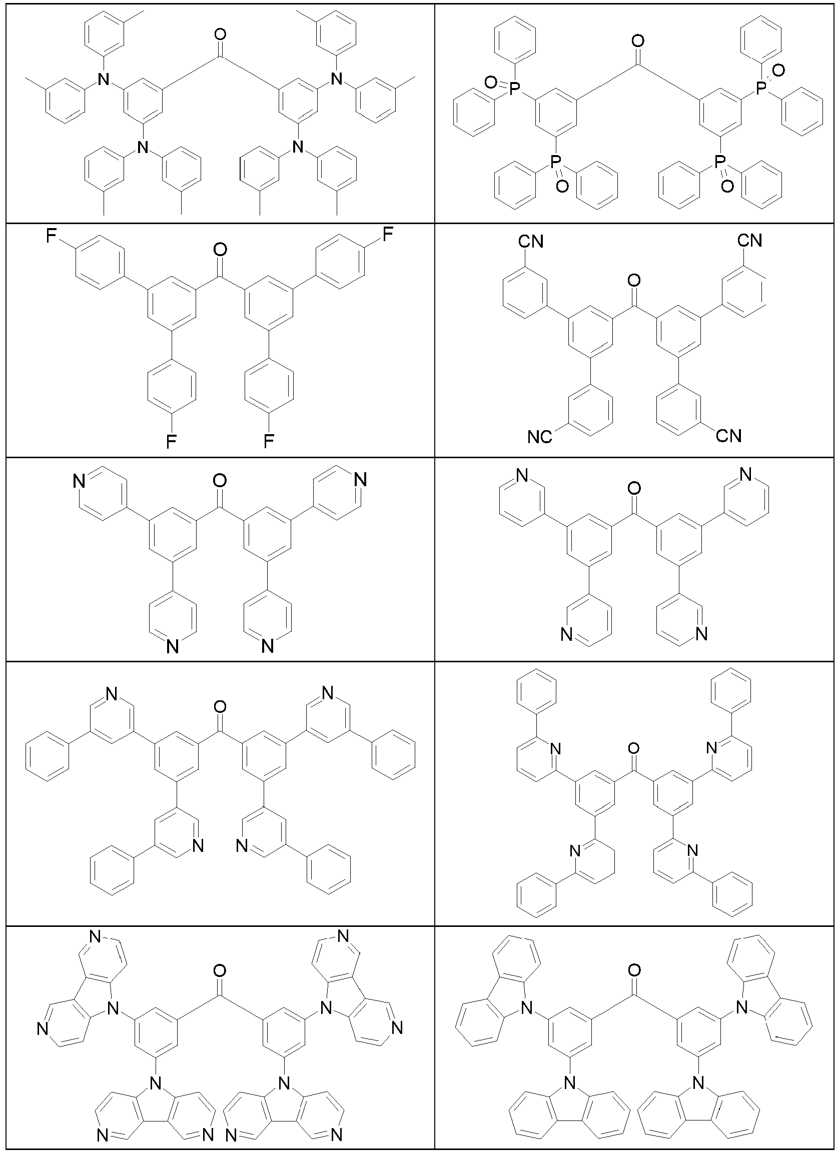

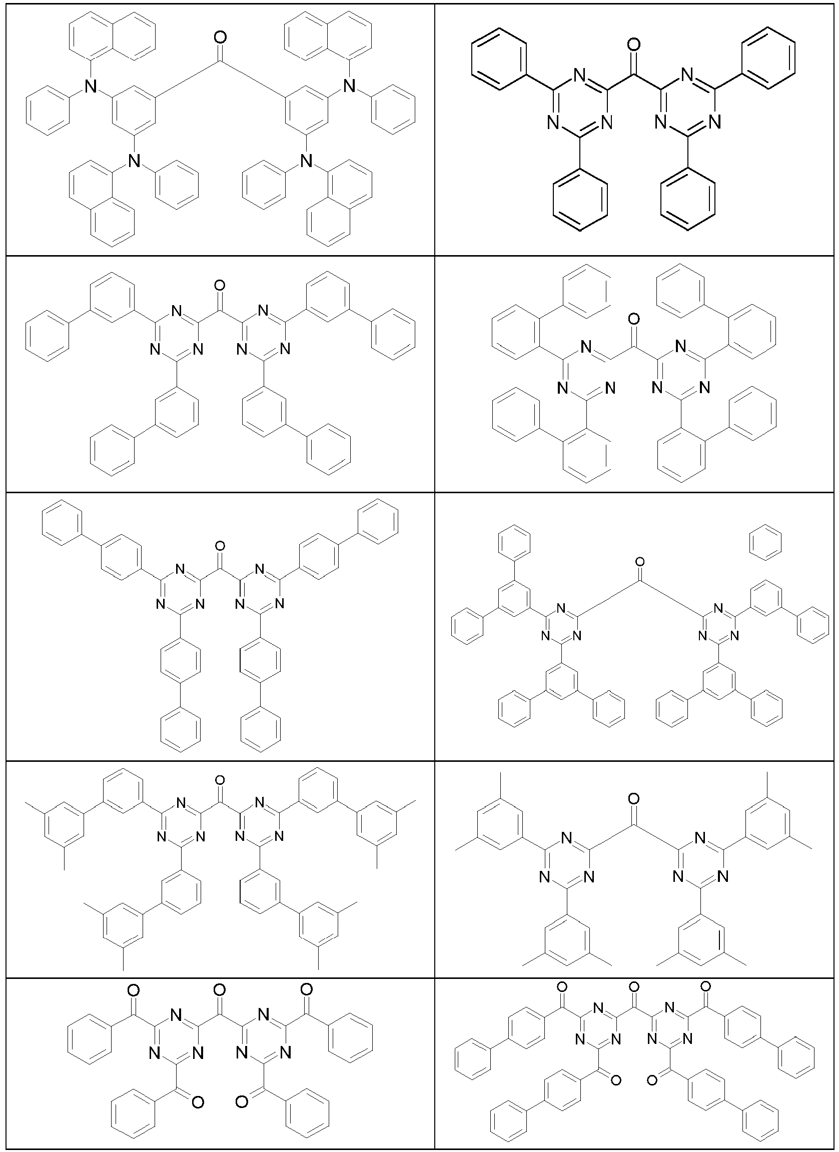

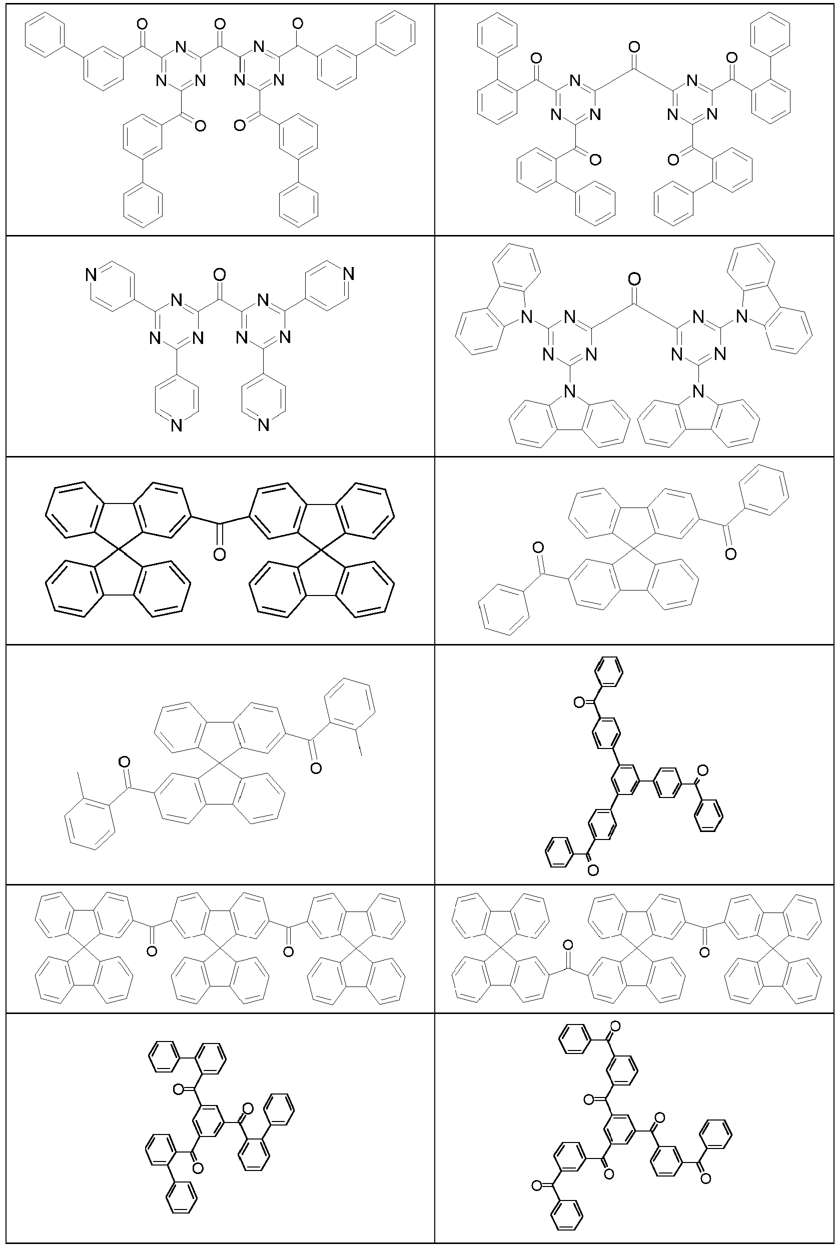

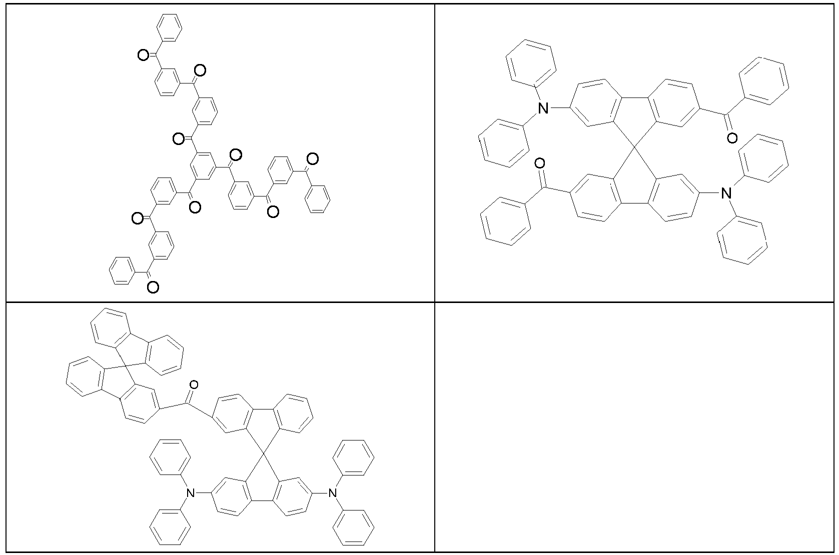

Beispiele für Metallkomplexe, welche als elektronentransportierende Matrixmaterialien eingesetzt werden können:

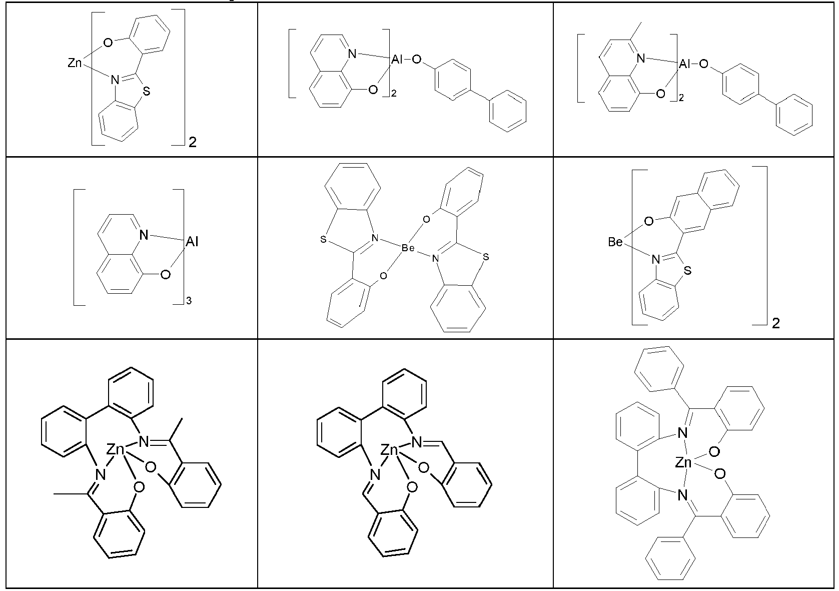

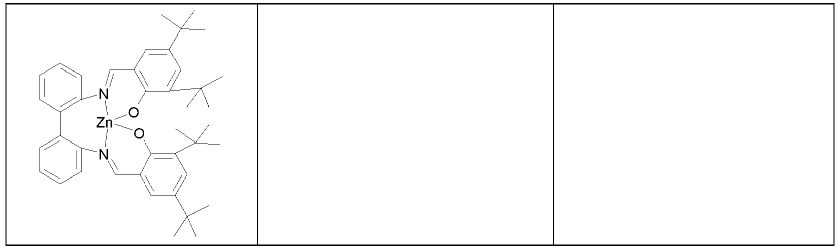

Beispiele für Phosphinoxide, welche als elektronentransportierende Matrixmaterialien eingesetzt werden können:

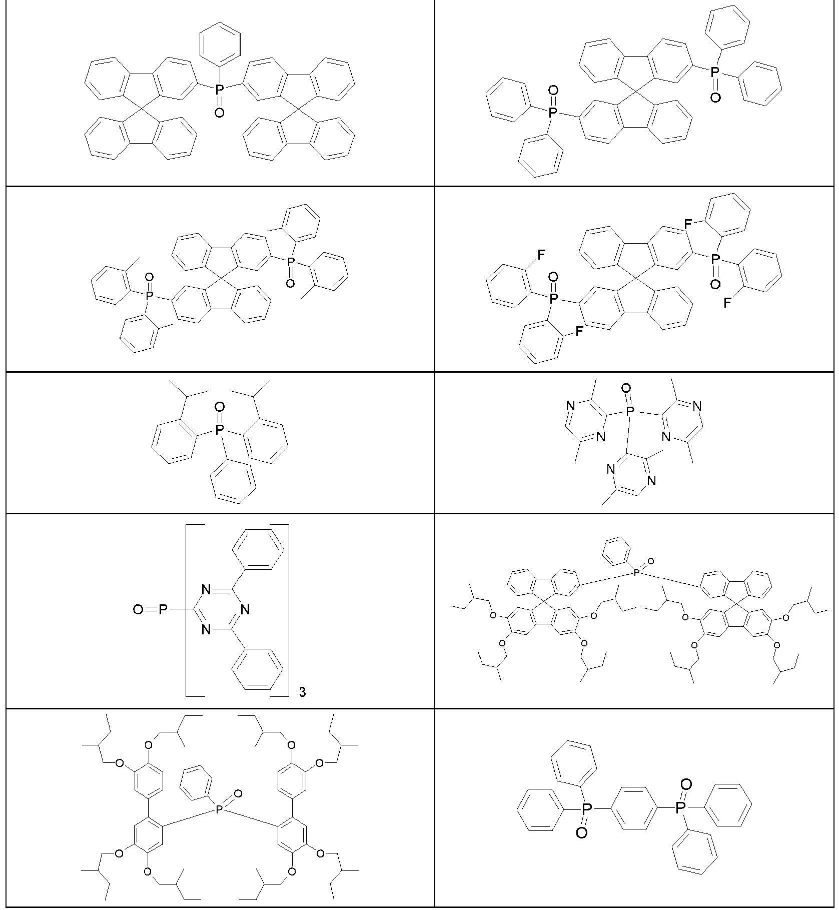

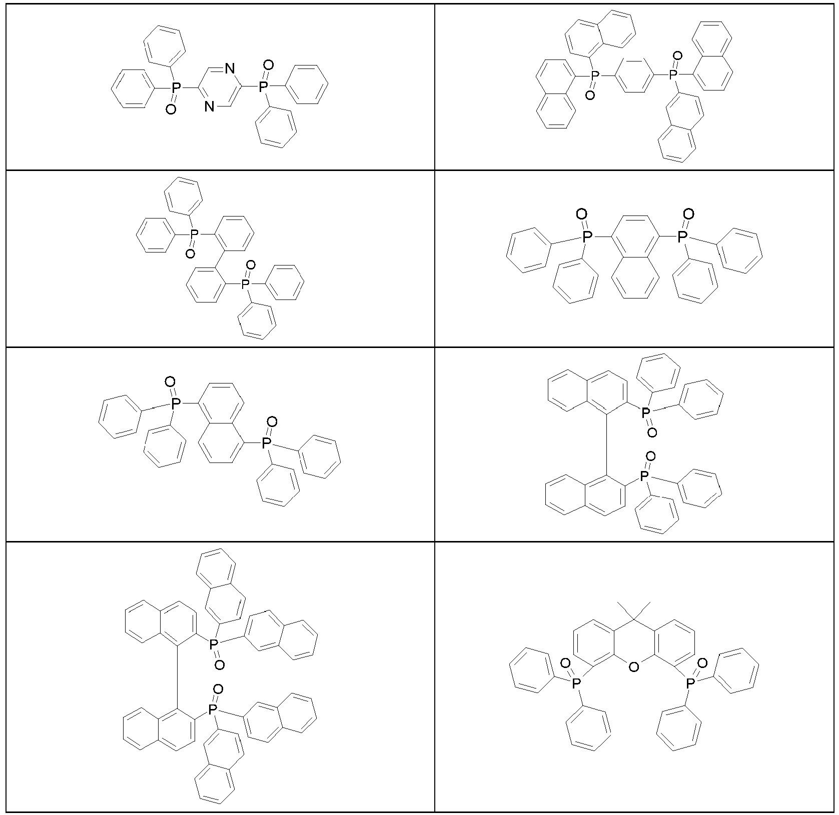

Beispiele für Indolo- und Indenocarbazolderivate im weitesten Sinn, welche je nach Substitutionsmuster als loch- oder elektronentransportierende Matrixmaterialien eingesetzt werden können:

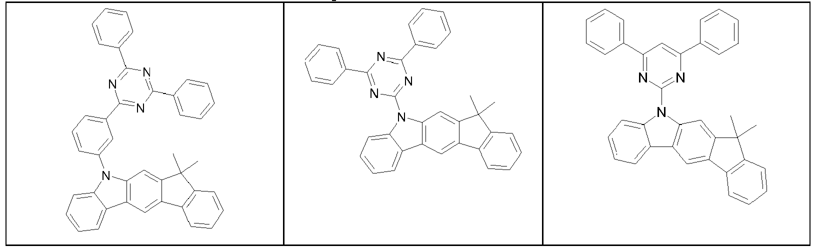

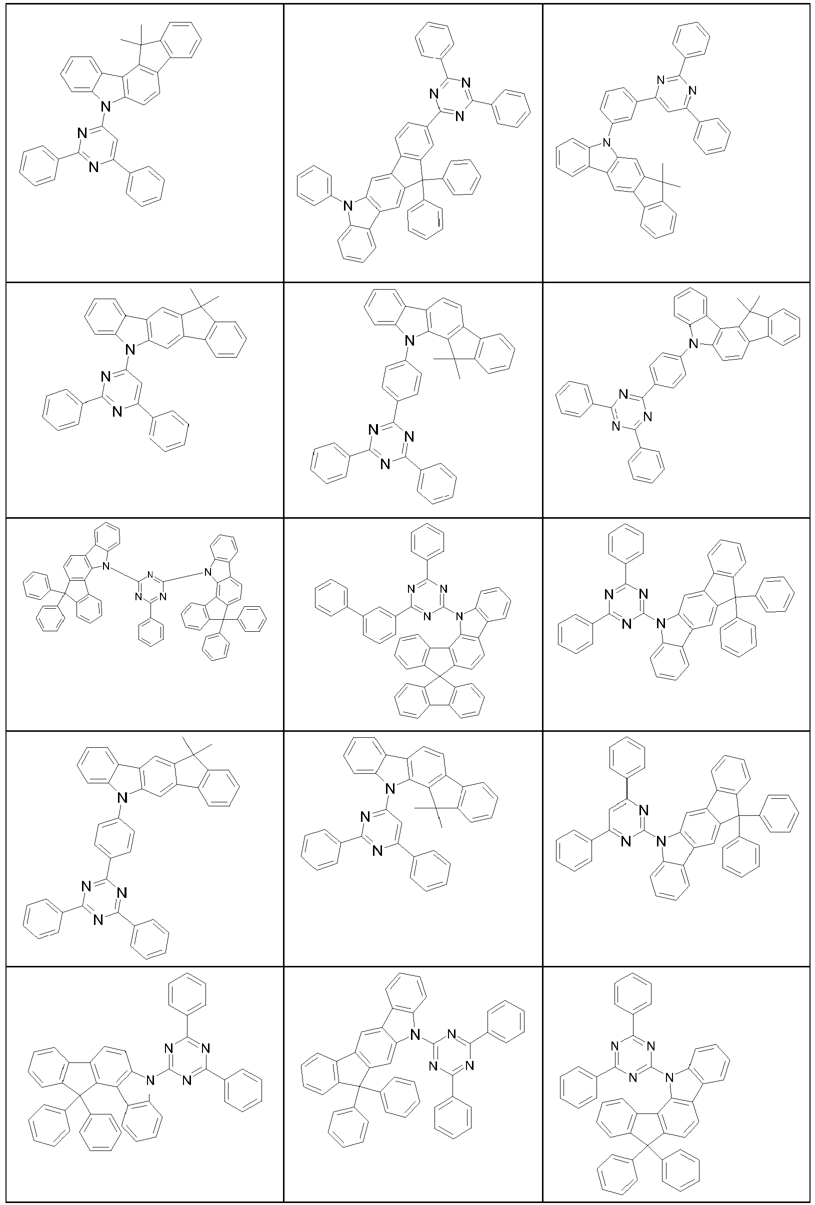

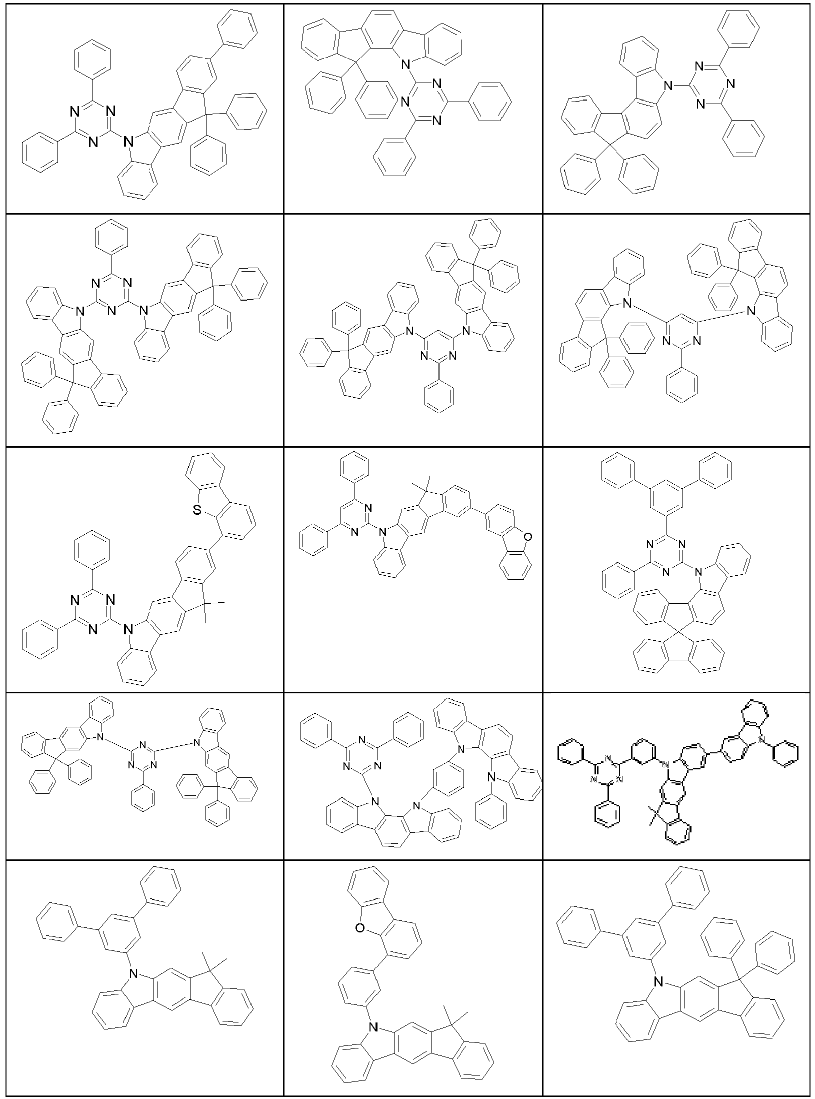

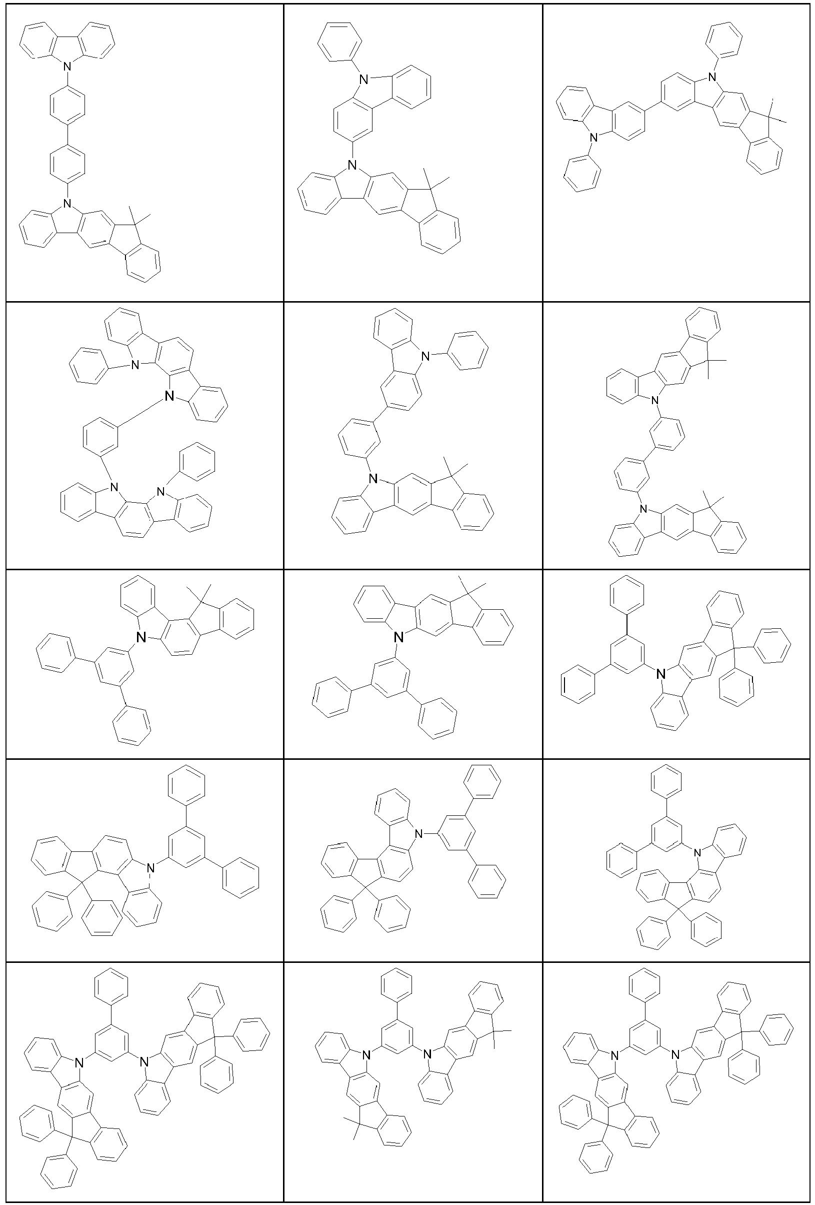

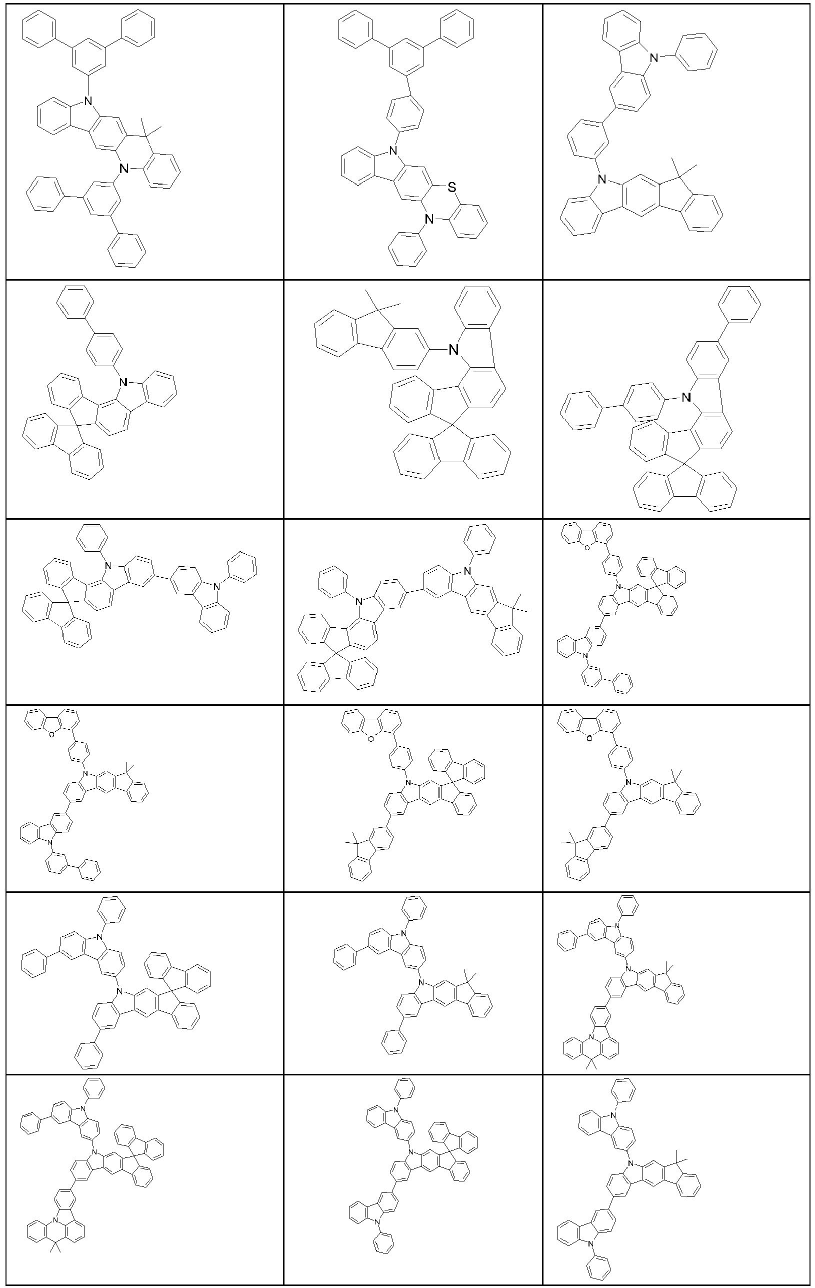

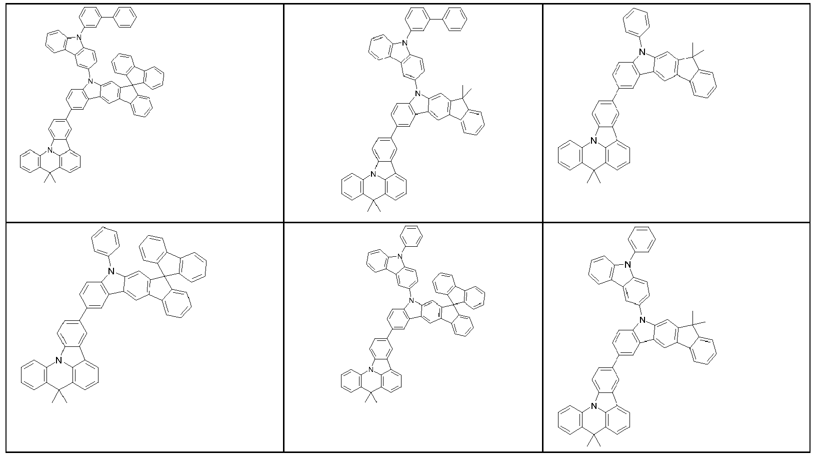

Beispiele für Carbazolderivate, welche je nach Substitutionsmuster als loch- oder elektronentransportierende Matrixmaterialien eingesetzt werden können:

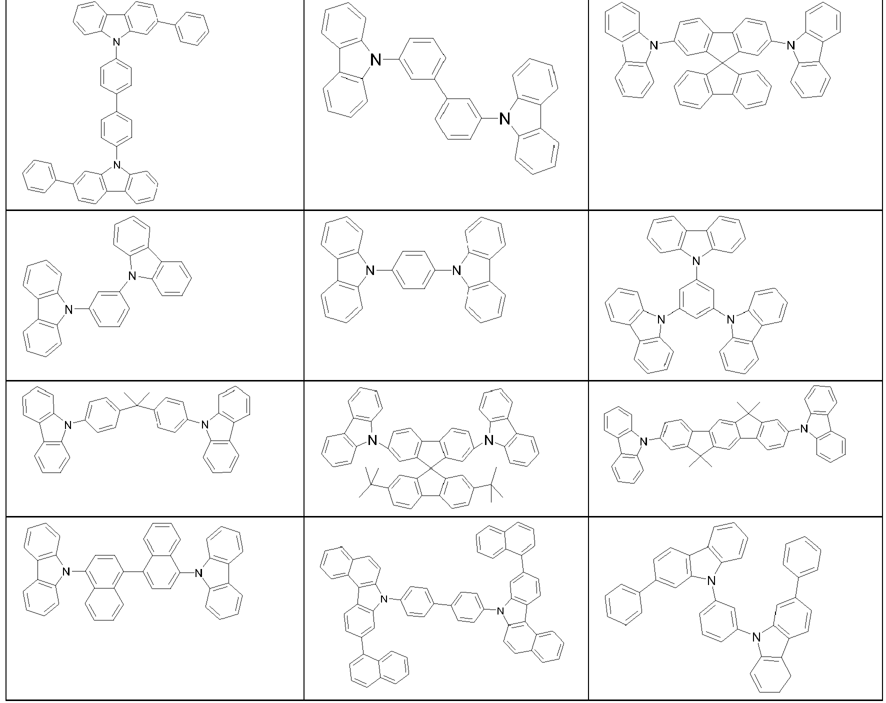

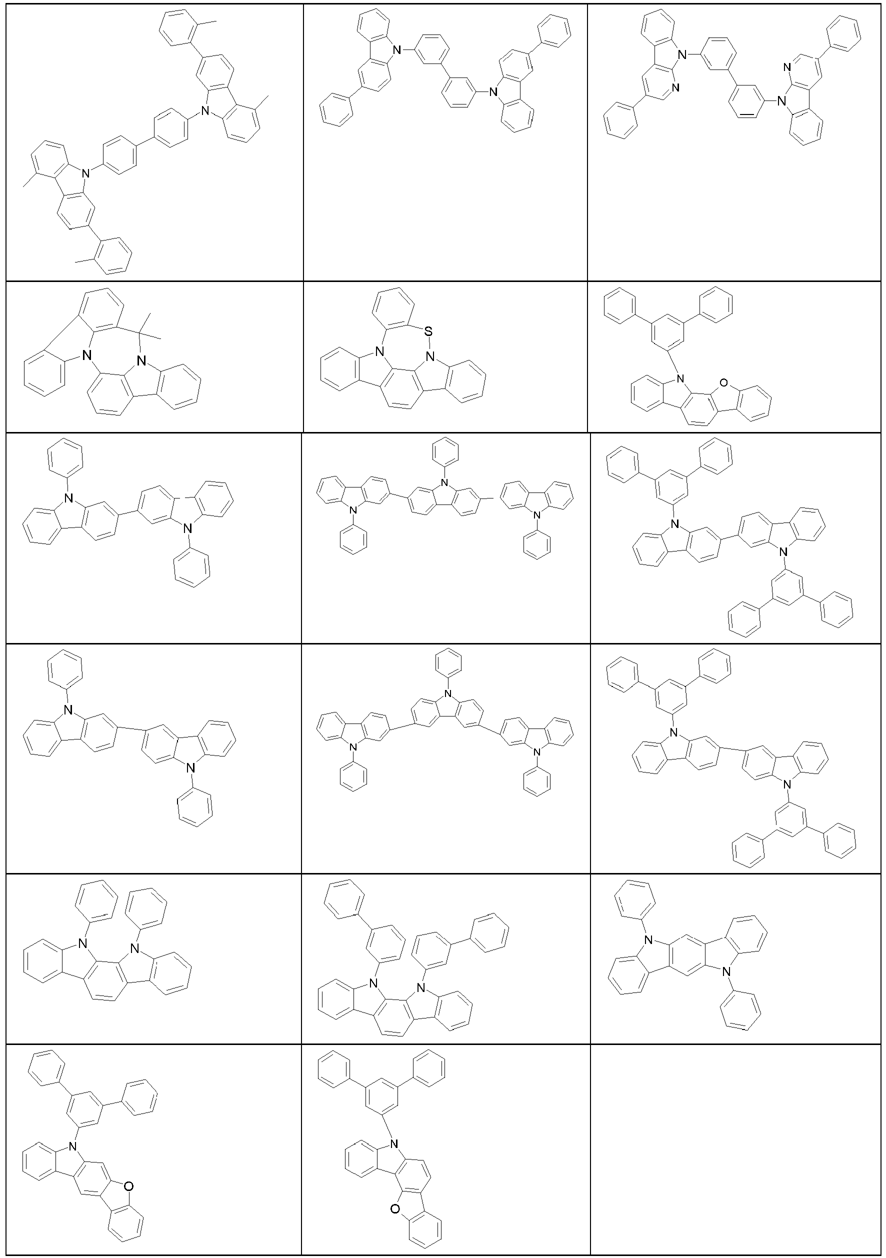

Beispiele für verbrückte Carbazolderivate, welche als lochtransportierende Matrixmaterialien eingesetzt werden können:

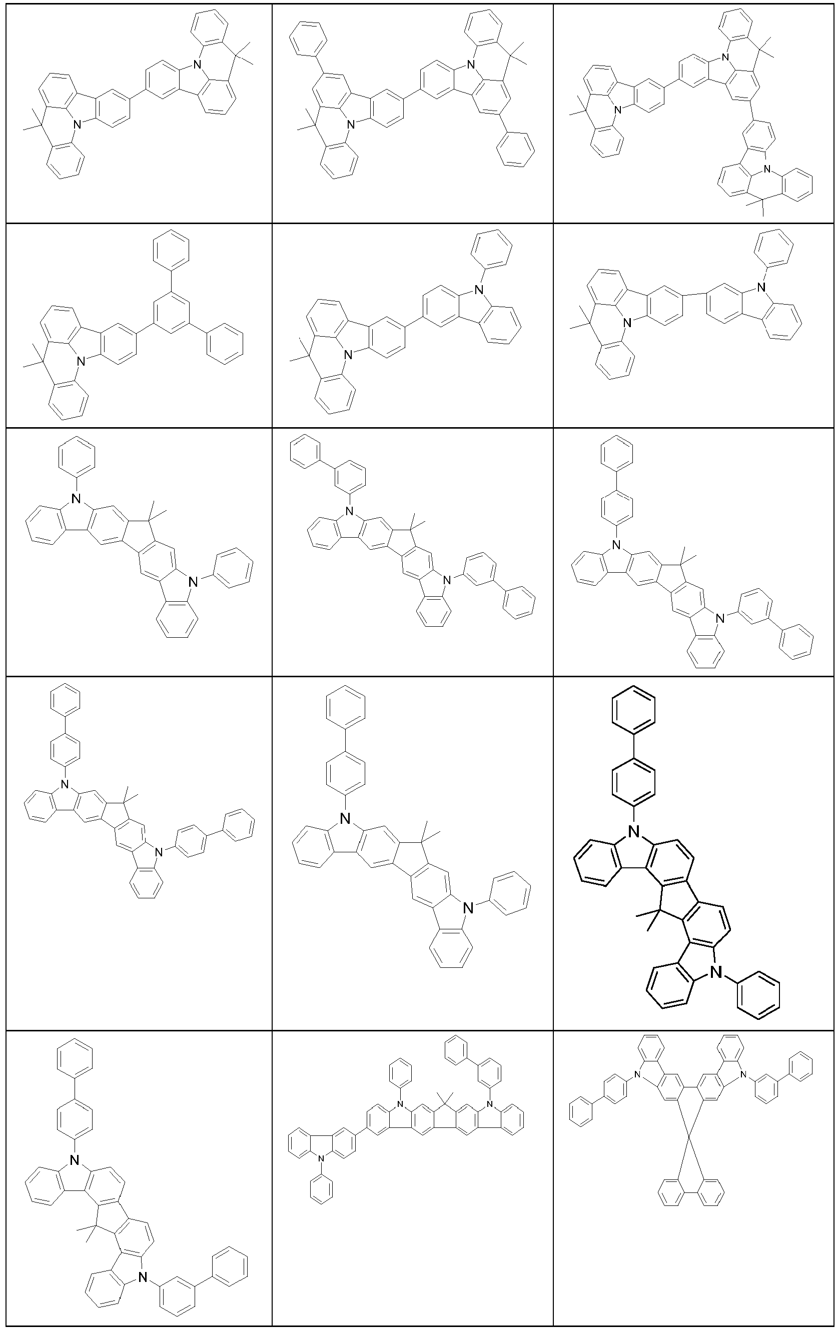

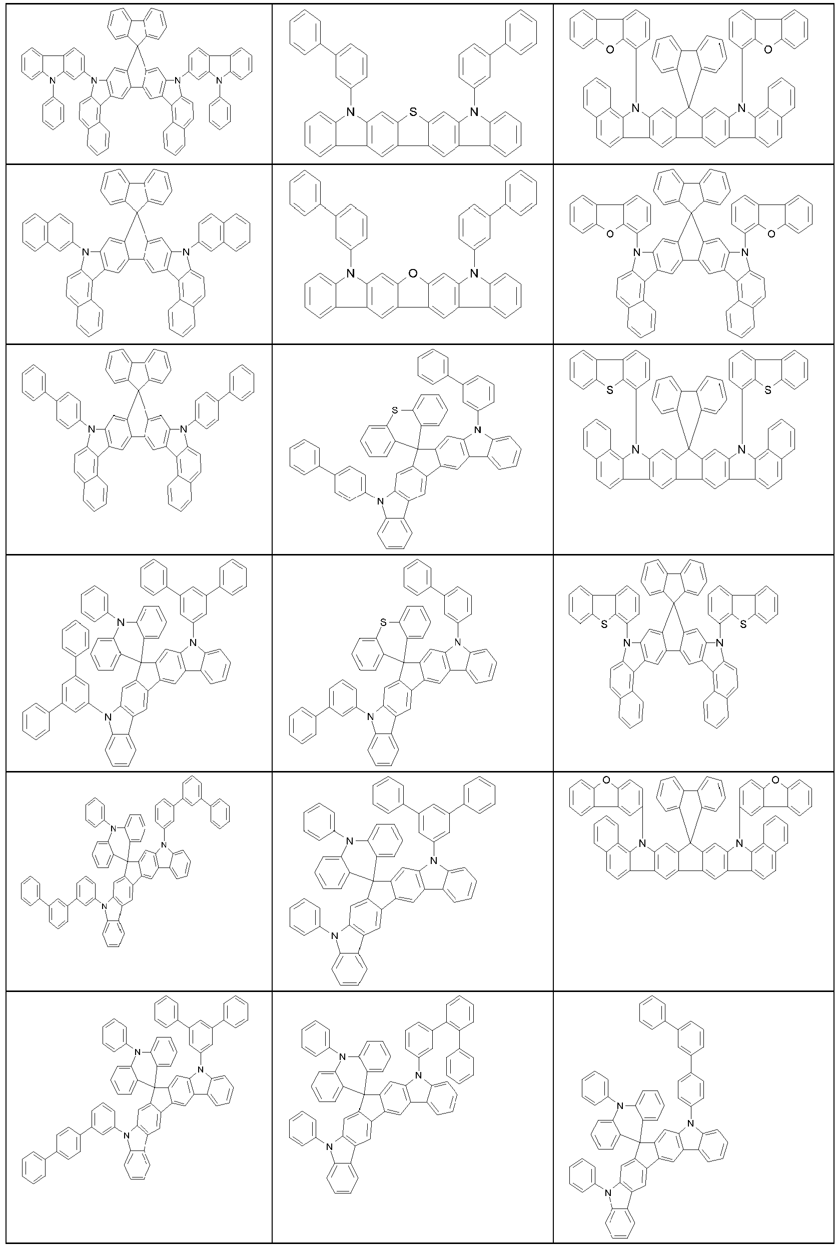

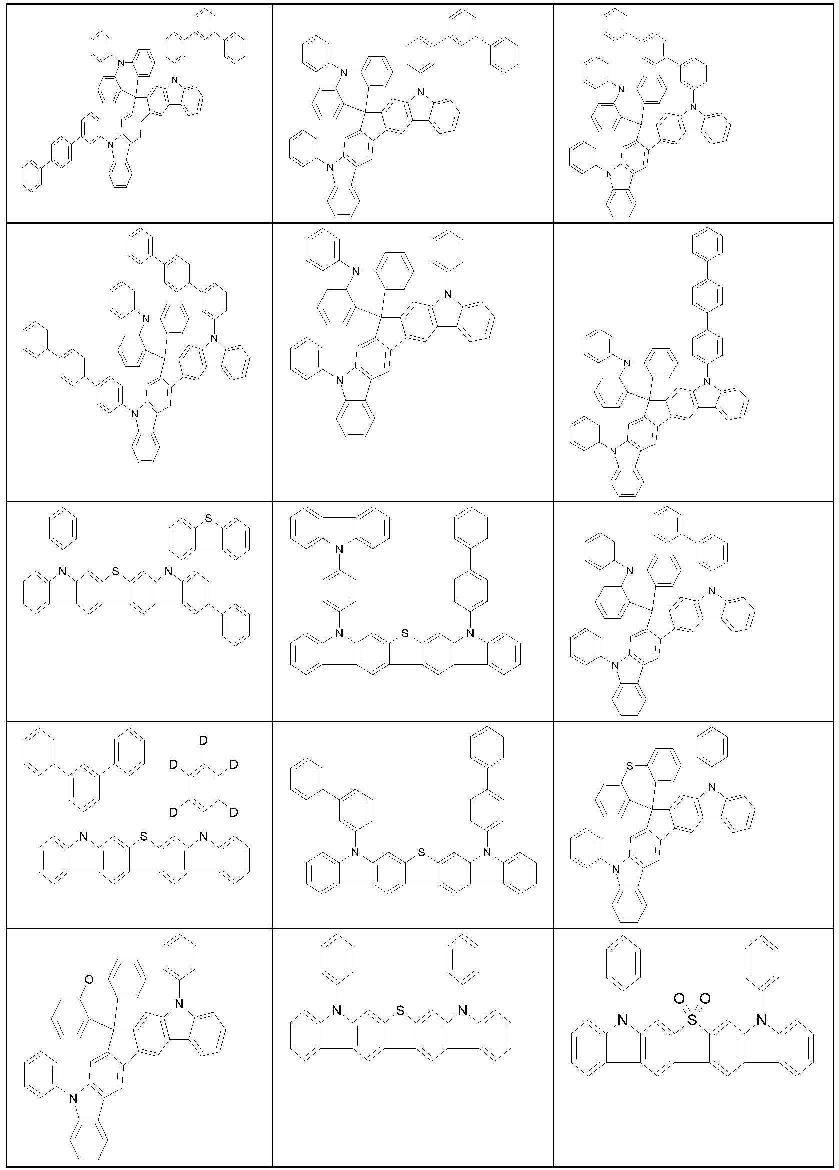

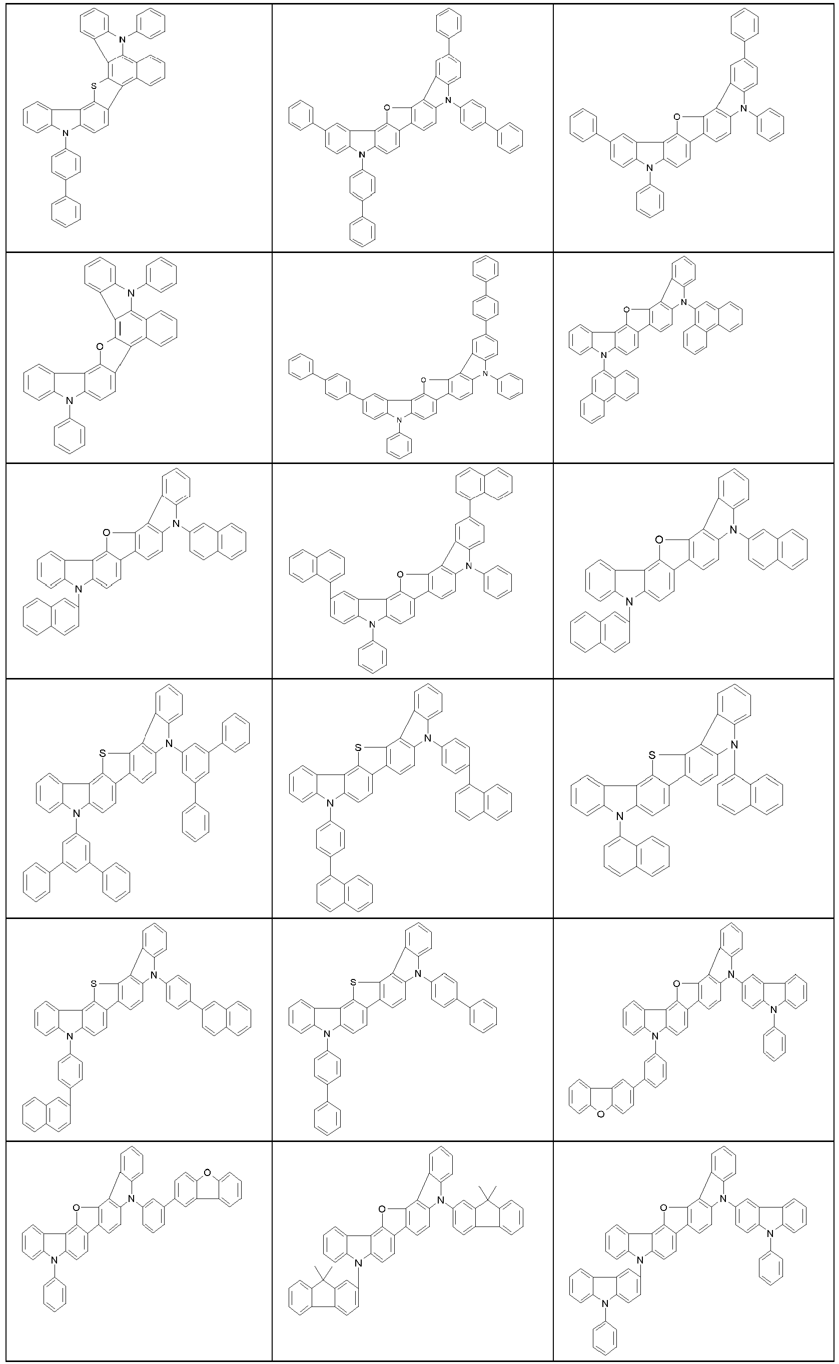

Beispiele für Biscarbazole, welche als lochtransportierende Matrixmaterialien eingesetzt werden können:

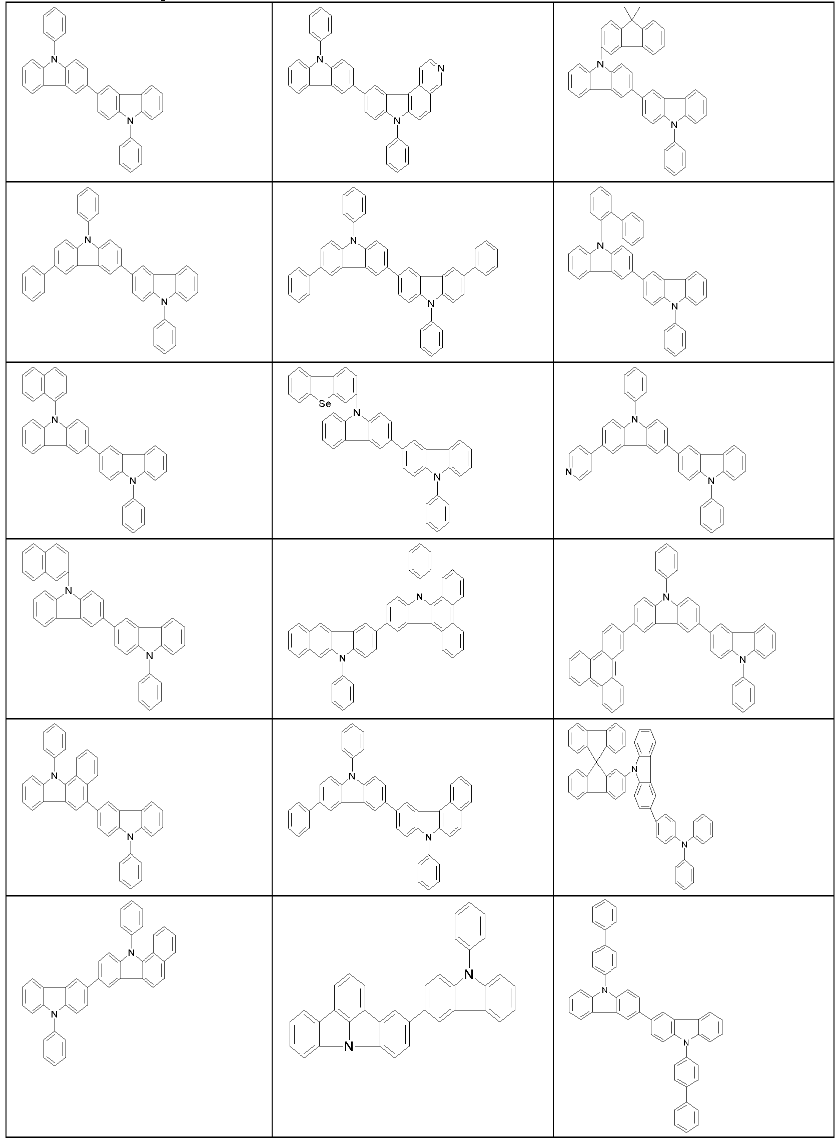

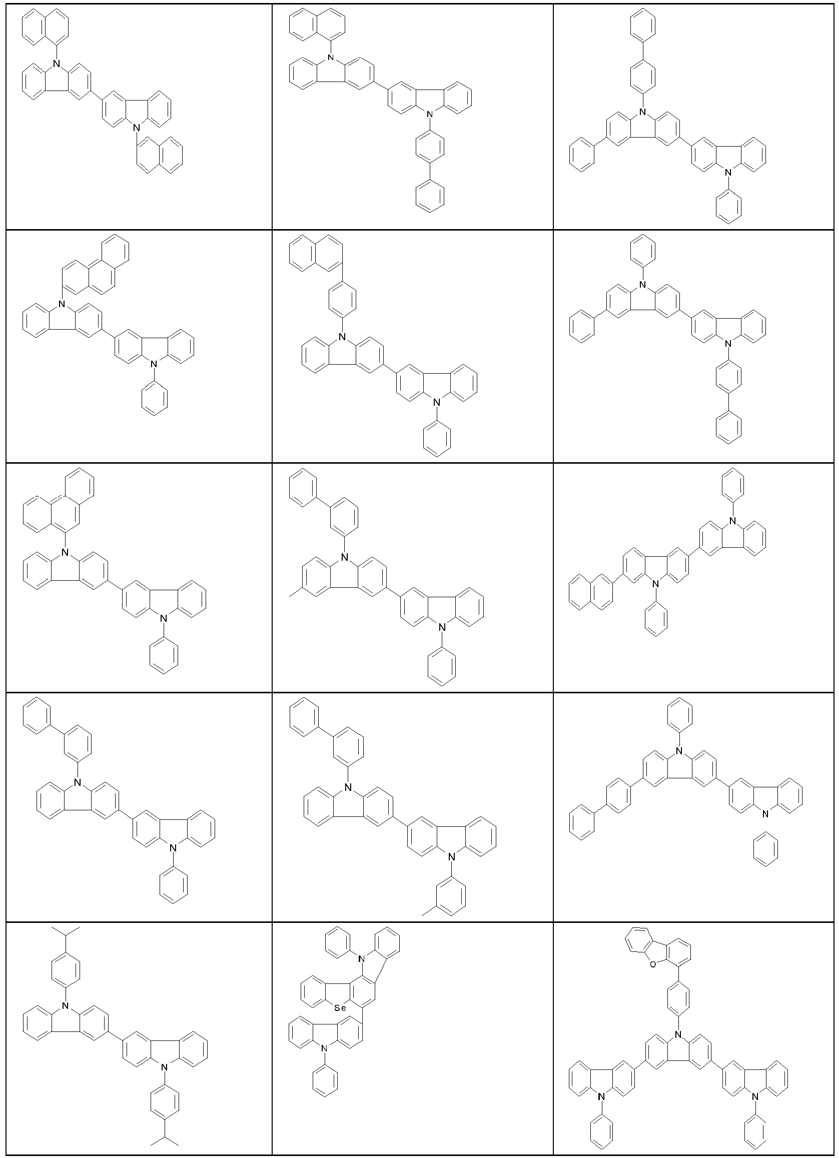

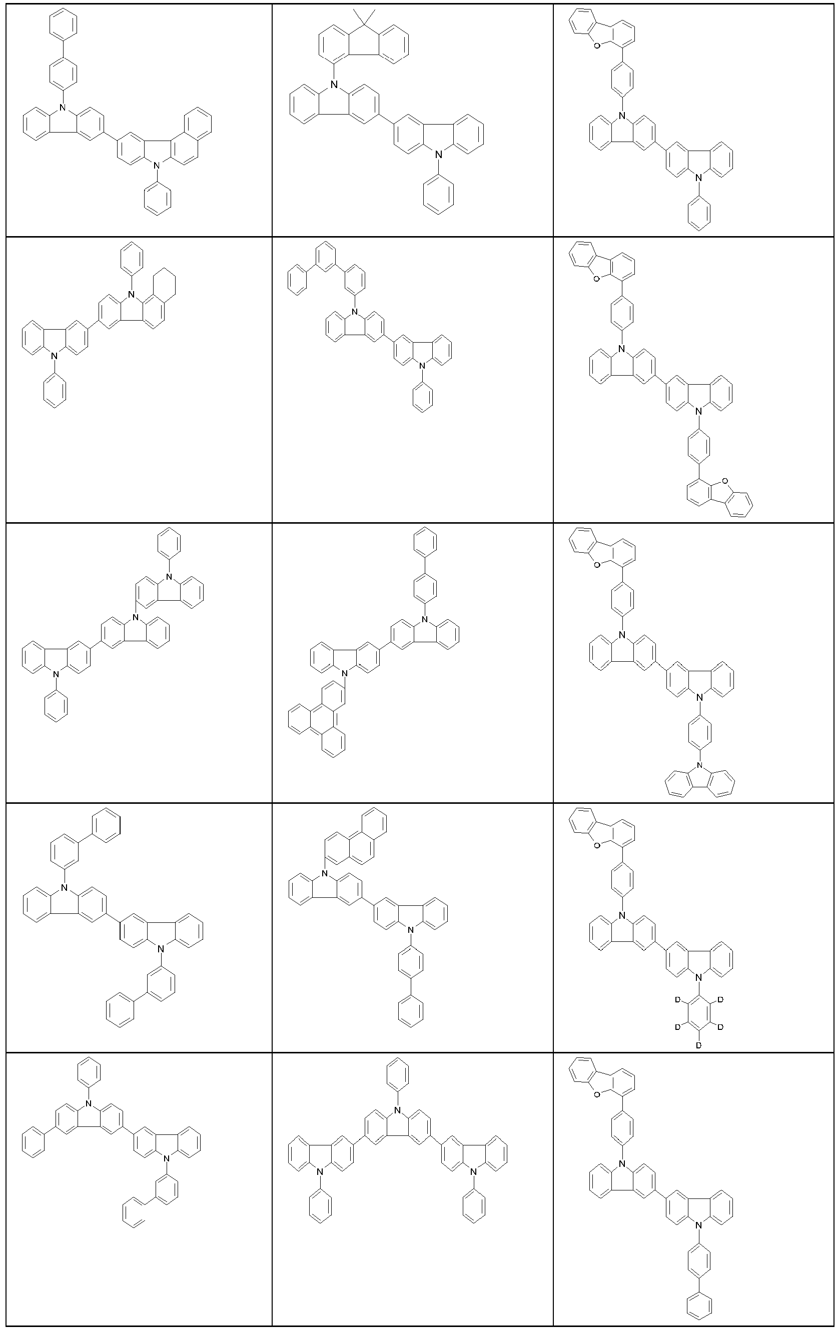

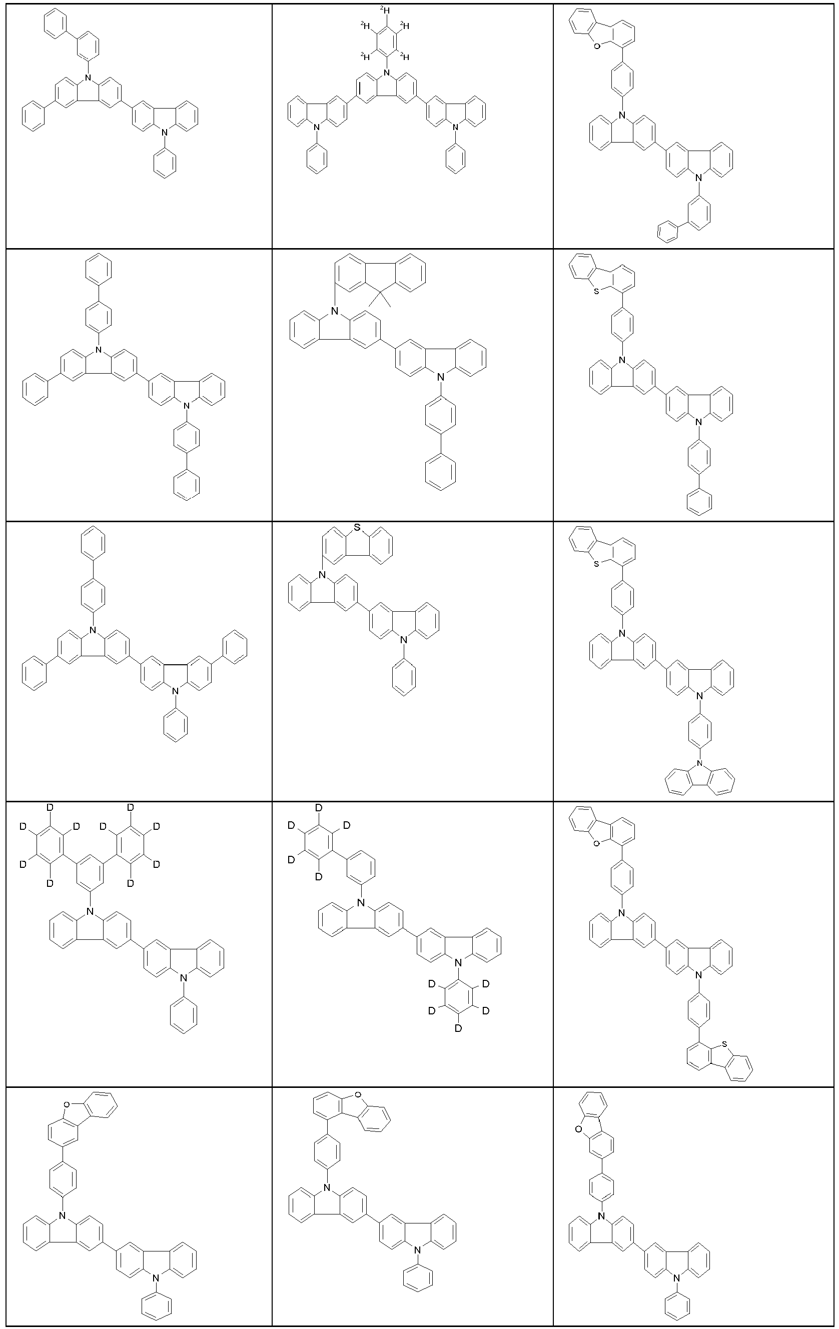

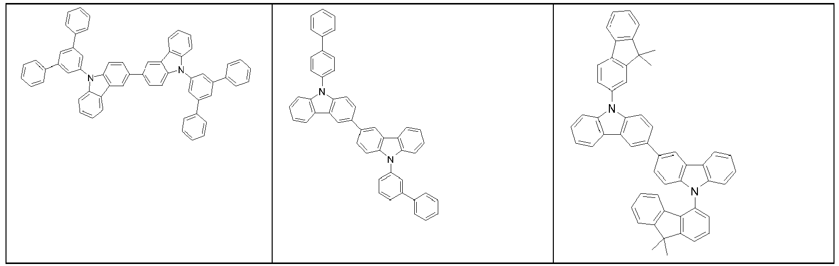

Beispiele für Amine, welche als lochtransportierende Matrixmaterialien eingesetzt werden können:

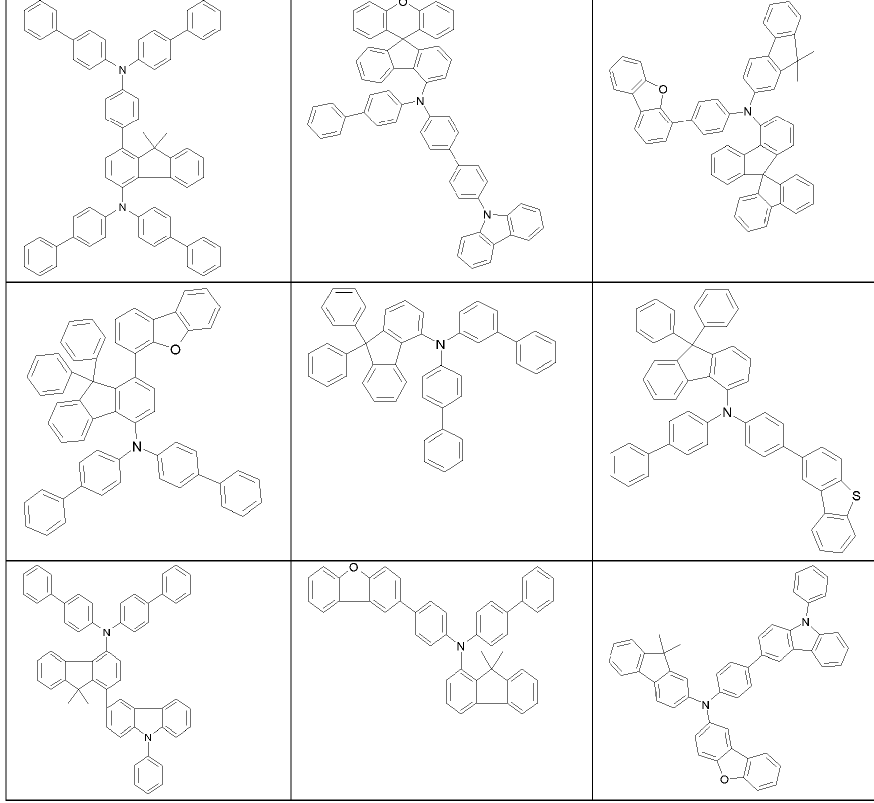

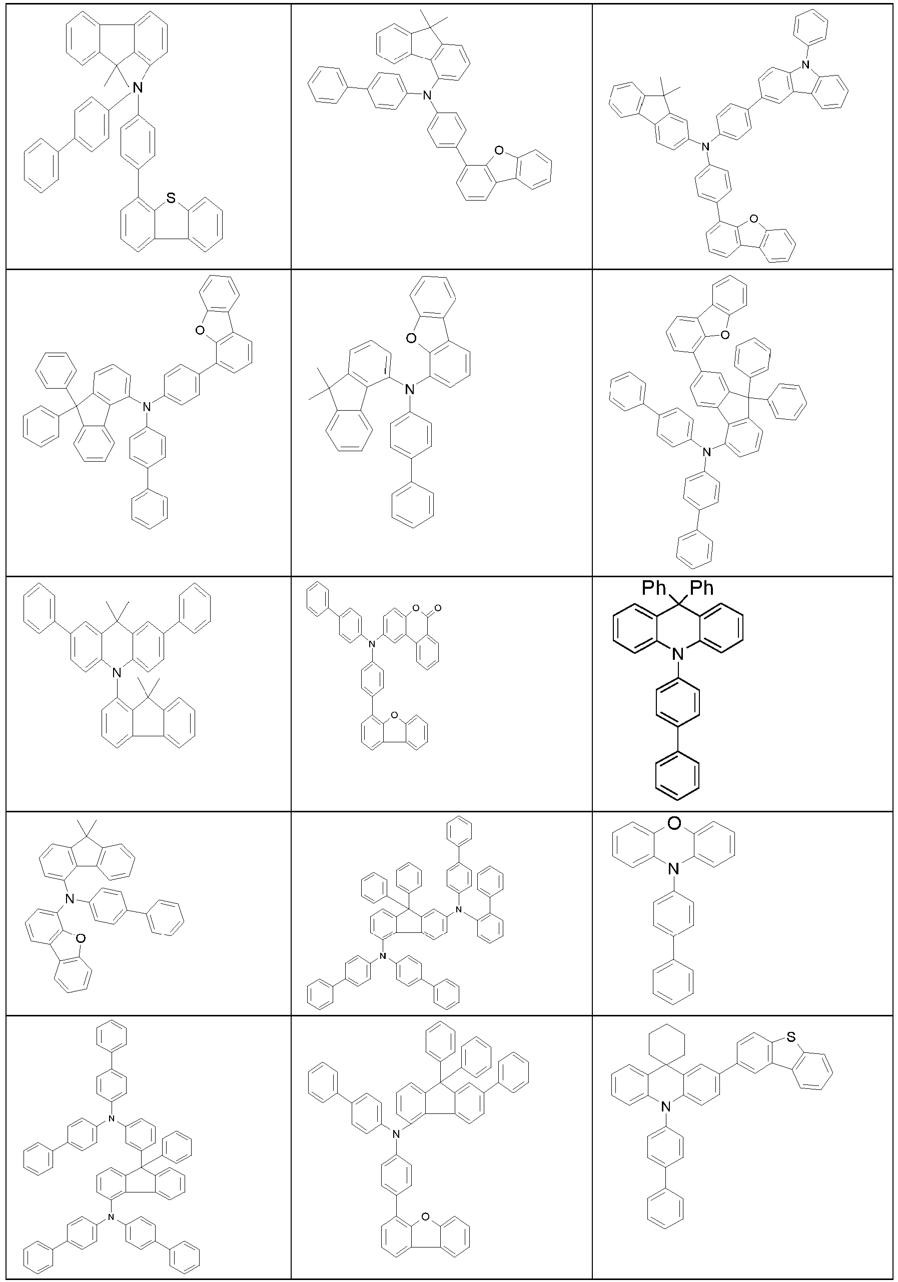

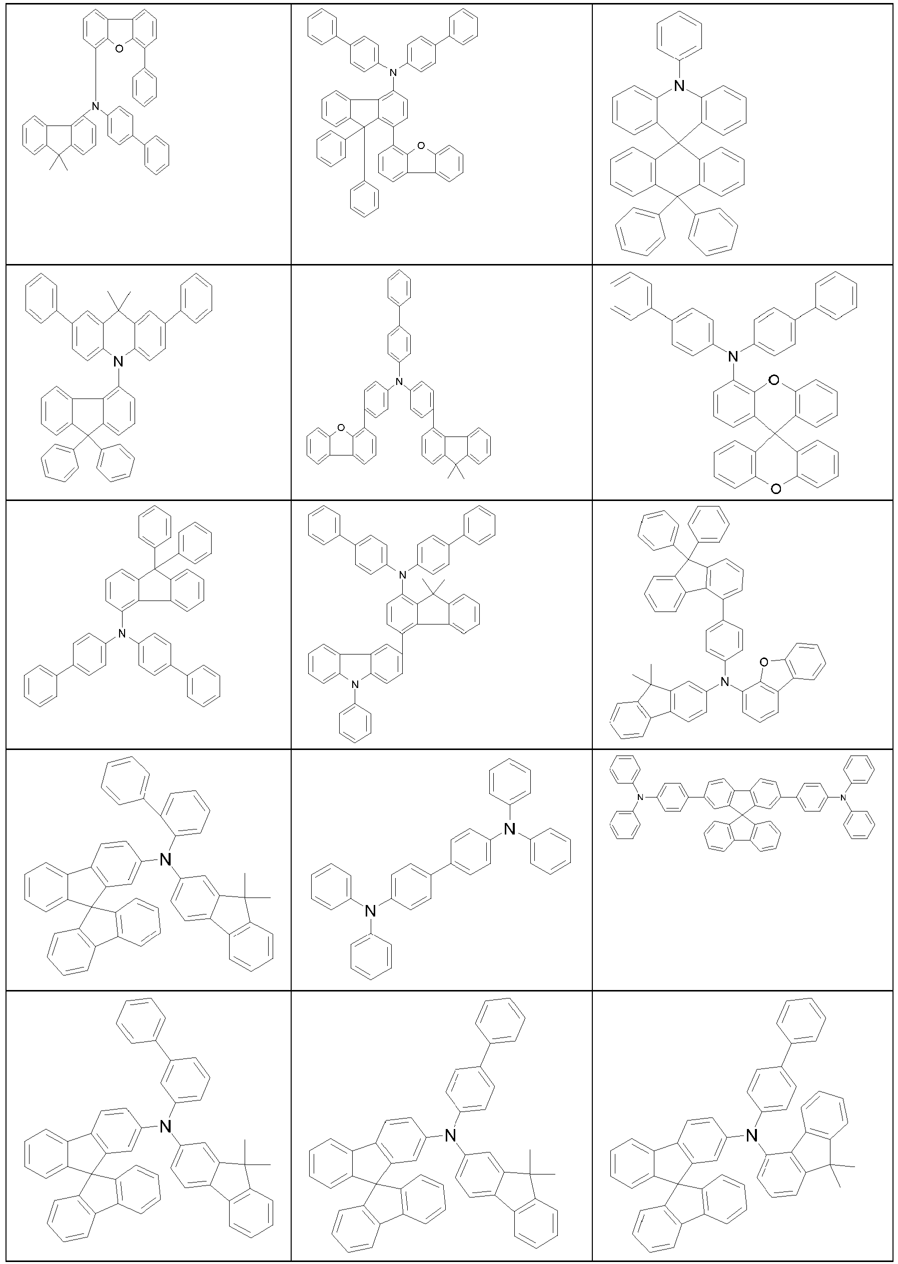

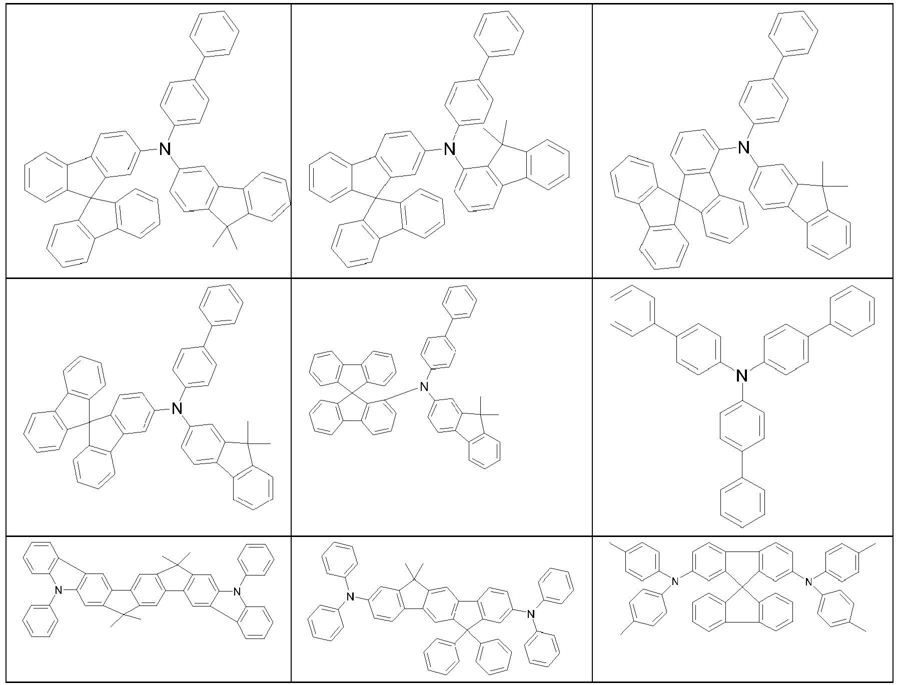

Beispiele für Materialien, welche als Wide Bandgap Matrixmaterialien eingesetzt werden können:

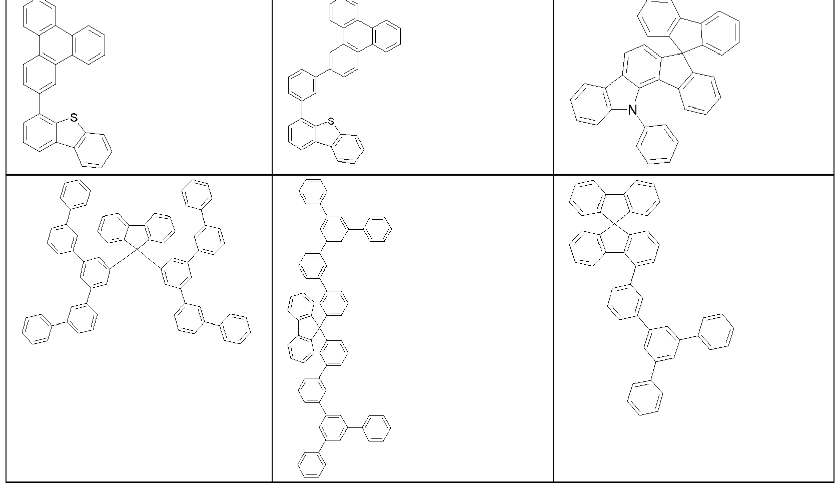

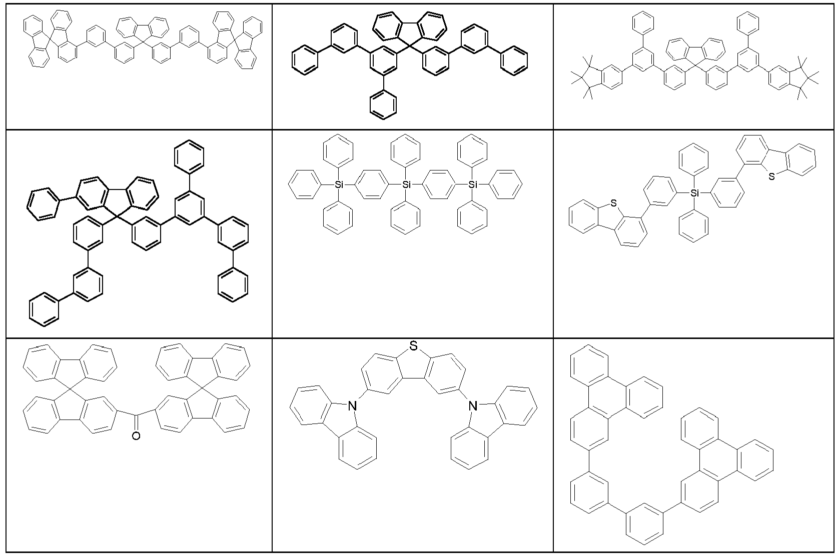

Weiterhin bevorzugt ist es, eine Mischung aus zwei oder mehr Triplett-Emittern, insbesondere zwei oder drei Triplettemittern, zusammen mit einem oder mehreren Matrixmaterialien einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe mit einem kürzerwelligen, z.B. blau, grün oder gelb emittierenden, Metallkomplex als Co-Matrix kombiniert werden. Es können beispislweise auch erfindungsgemäße Metallkomplexe als Co-Matrix für längerwellig emittierende Triplettemitter, beispielsweise für rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist. Eine bevorzugte Ausführungsform bei Verwendung einer Mischung aus drei Triplett-Emittern ist, wenn zwei als Co-Host und einer als emittierendes Material eingesetzt werden. Dabei weisen diese Triplett-Emitter bevorzugt die Emissionsfarben Grün, Gelb und Rot oder Blau, Grün und Orange auf.

Eine bevorzugte Mischung in der emittierenden Schicht enthält ein elektronentransportierendes Hostmaterial, ein so genanntes "wide bandgap" Hostmaterial, das aufgrund seiner elektronischen Eigenschaften nicht oder nicht in wesentlichem Umfang am Ladungstransport in der Schicht beteiligt ist, einen Co-Dotanden, welcher ein Triplettemitter ist, welcher bei einer kürzeren Wellenlänge als die erfindungsgemäße Verbindung emittiert, sowie eine erfindungsgemäße Verbindung.

Eine weitere bevorzugte Mischung in der emittierenden Schicht enthält ein elektronentransportierendes Hostmaterial, ein so genanntes "wide band gap" Hostmaterial, das aufgrund seiner elektronischen Eigenschaften nicht oder nicht in wesentlichem Umfang am Ladungstransport in der Schicht beteiligt ist, ein lochtransportierendes Hostmaterial, einen Co-Dotanden, welcher ein Triplettemitter ist, welcher bei einer kürzeren Wellenlänge als die erfindungsgemäße Verbindung emittiert, sowie eine erfindungsgemäße Verbindung.

Beispiele für geeignete Triplettemitter, welche als Co-Dotanden für die erfindungsgemäßen Verbindungen eingesetzt werden können, sind in der folgenden Tabelle abgebildet.

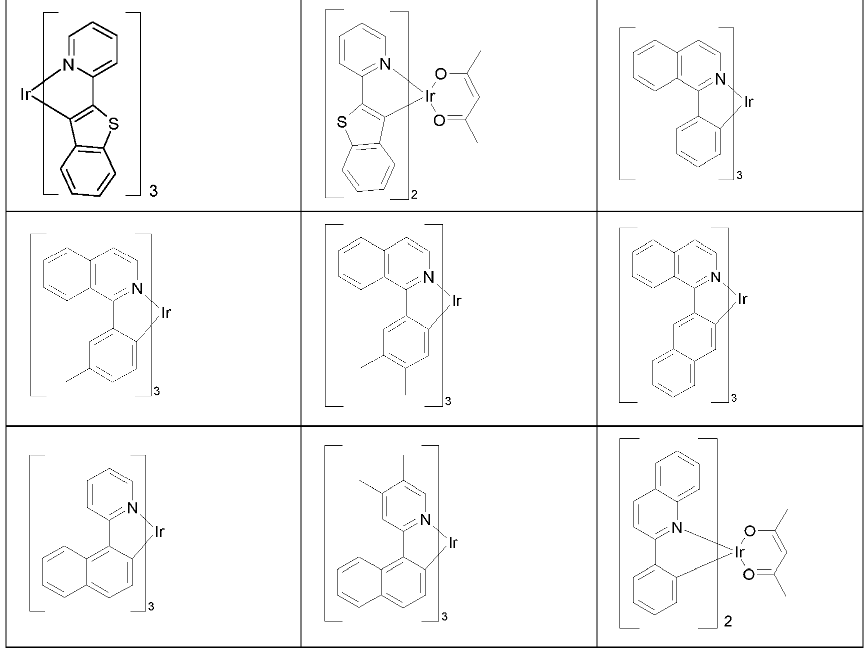

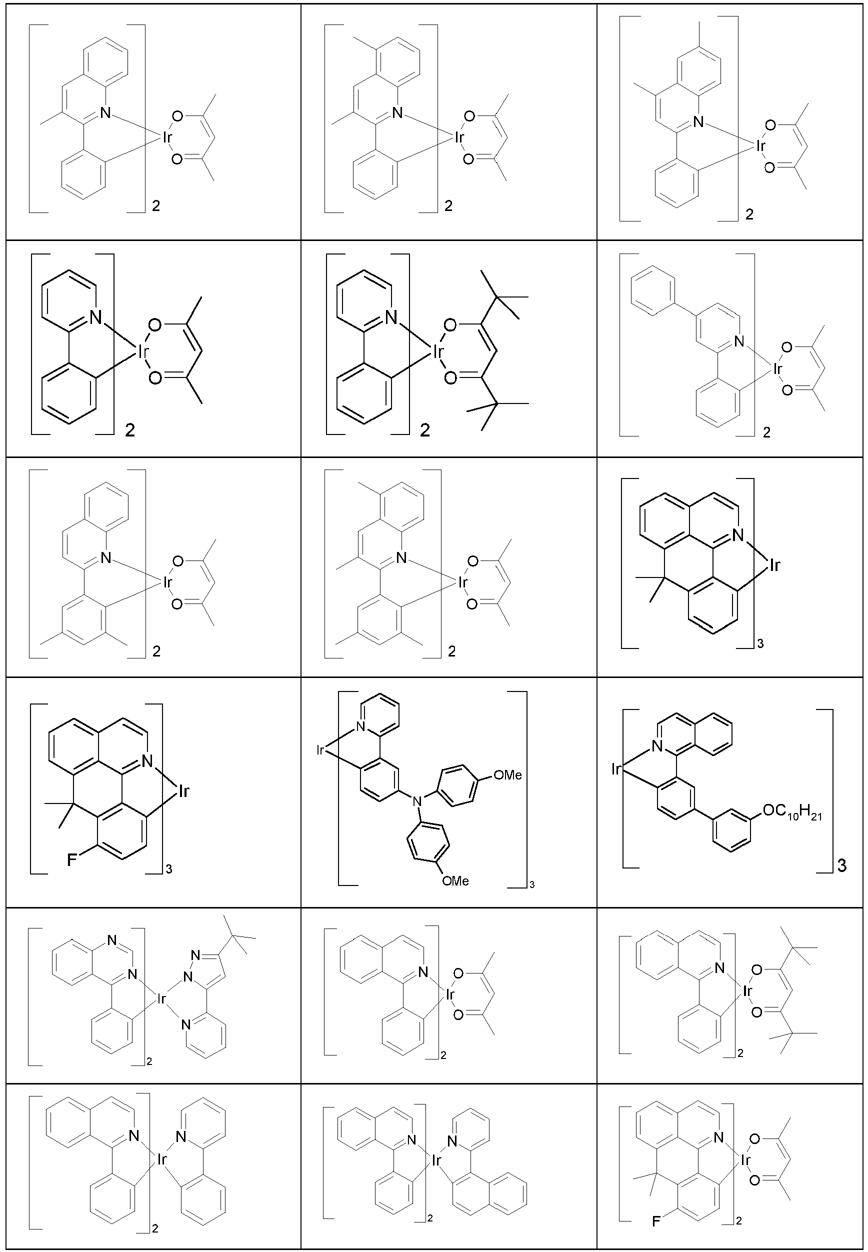

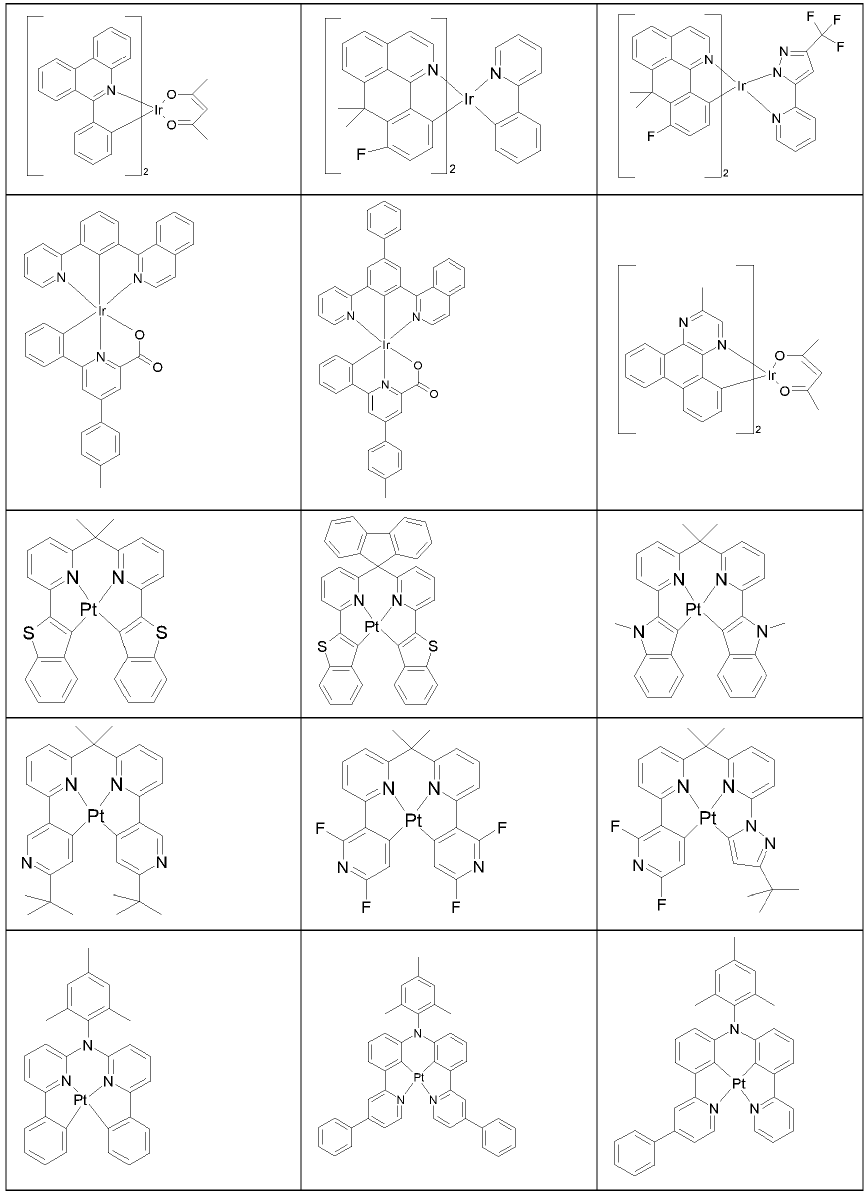

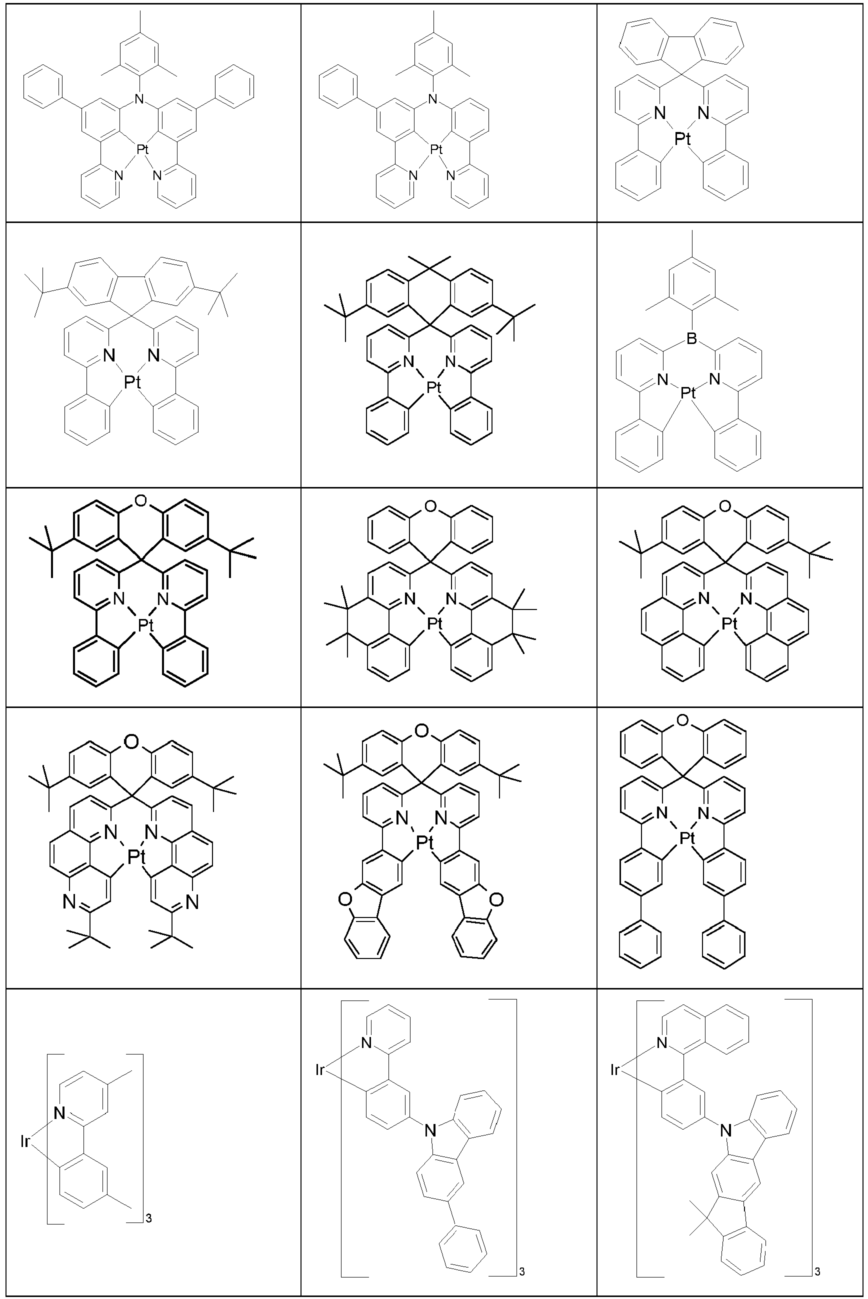

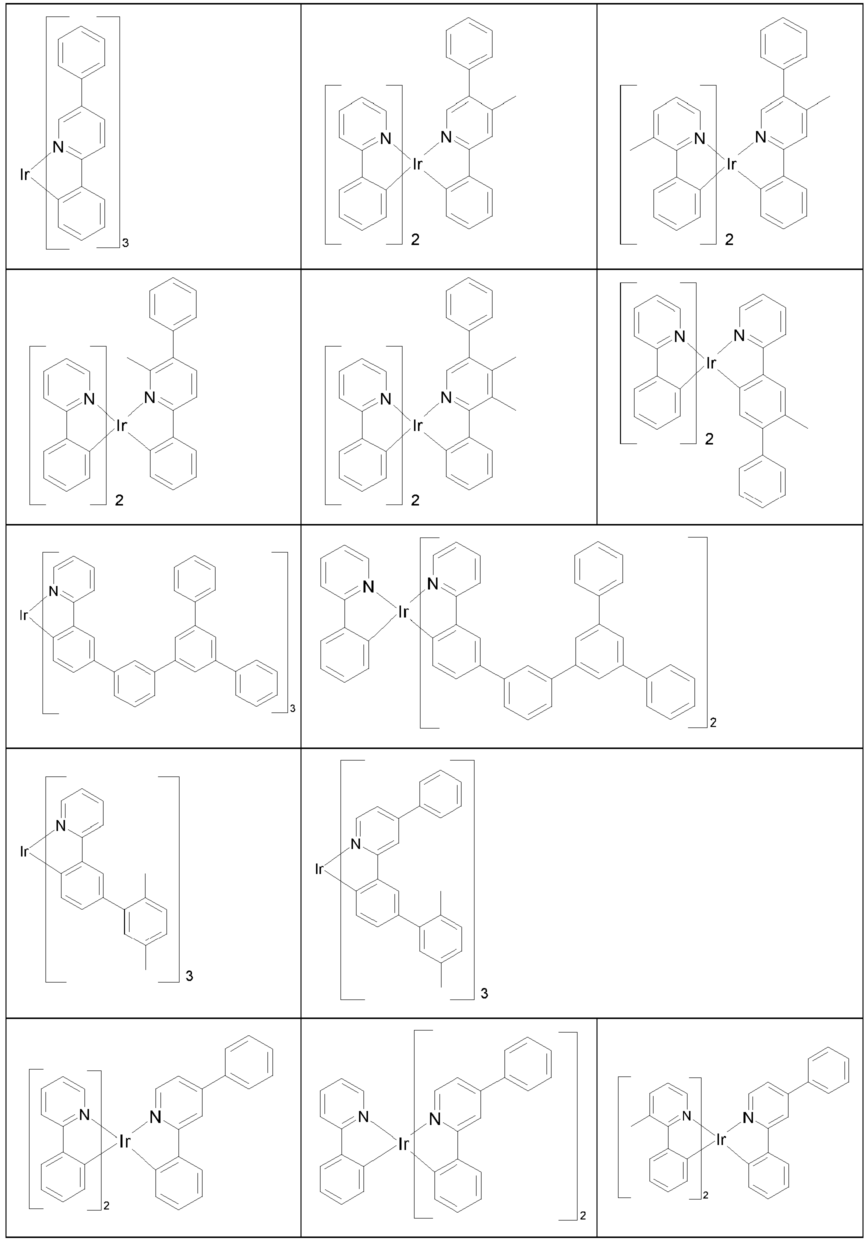

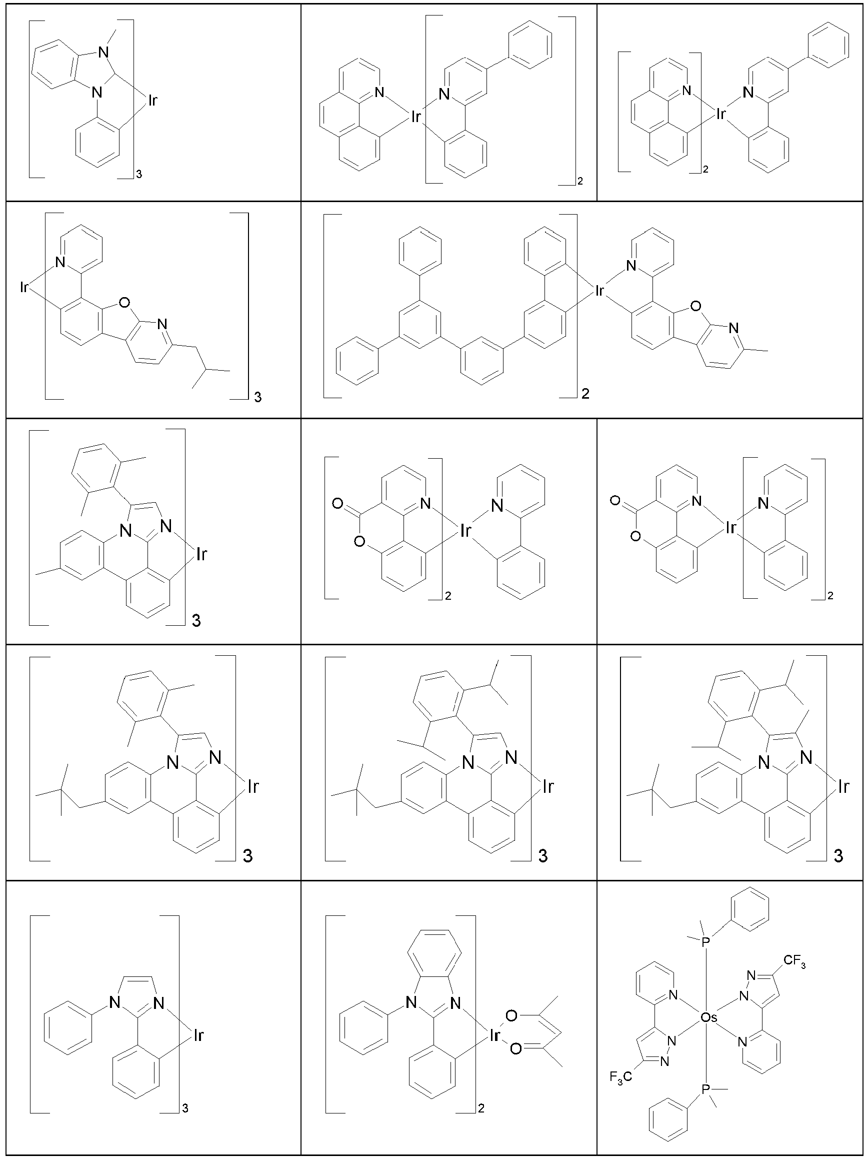

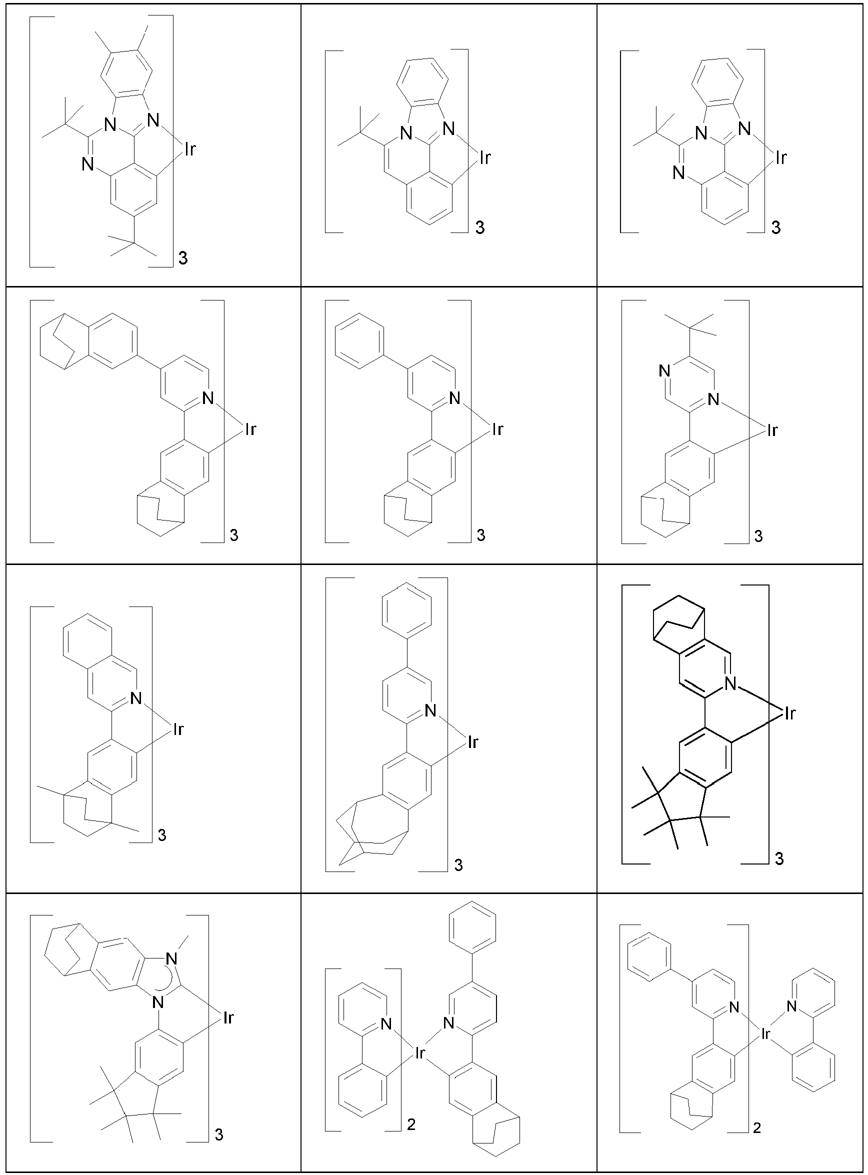

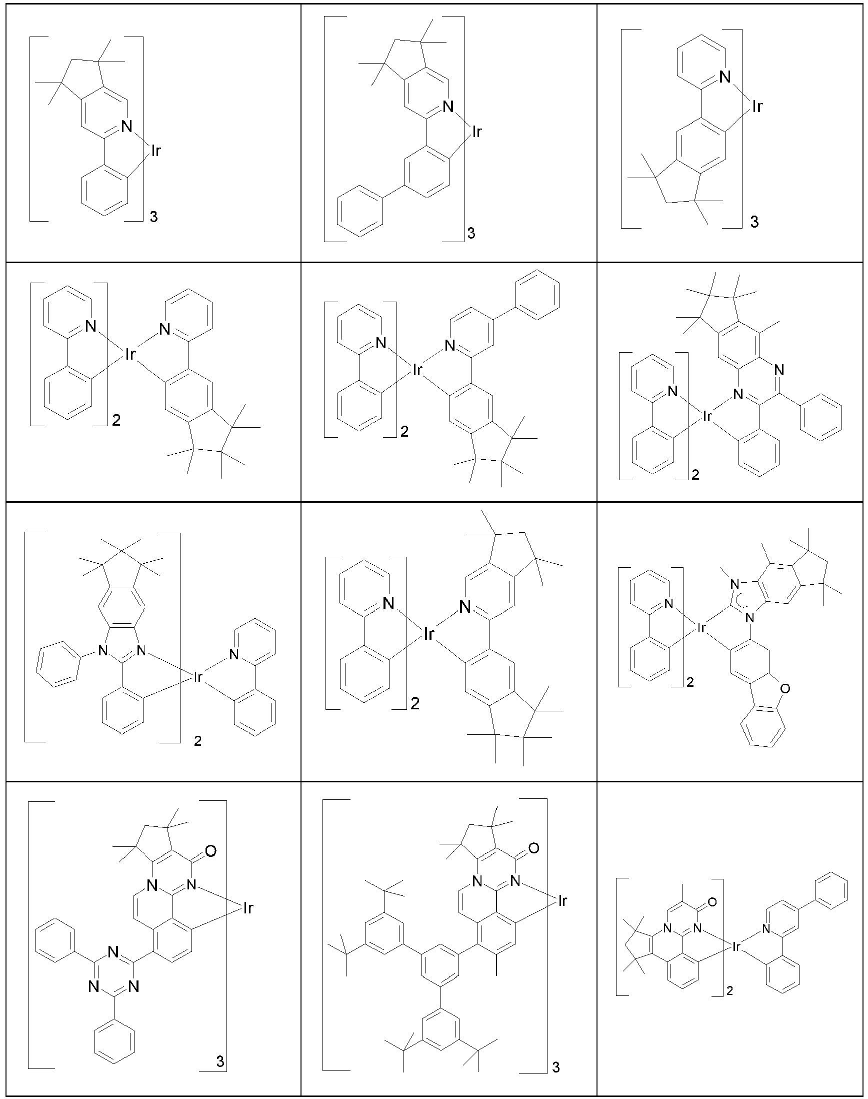

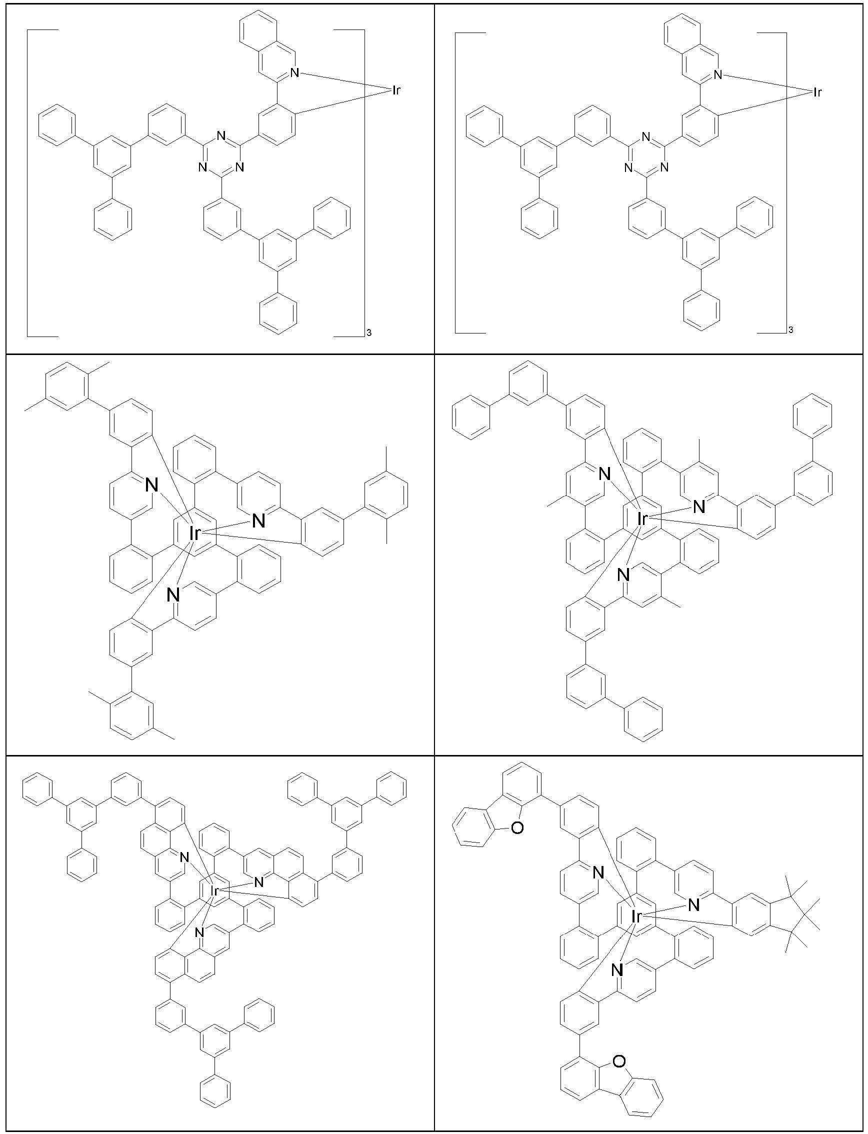

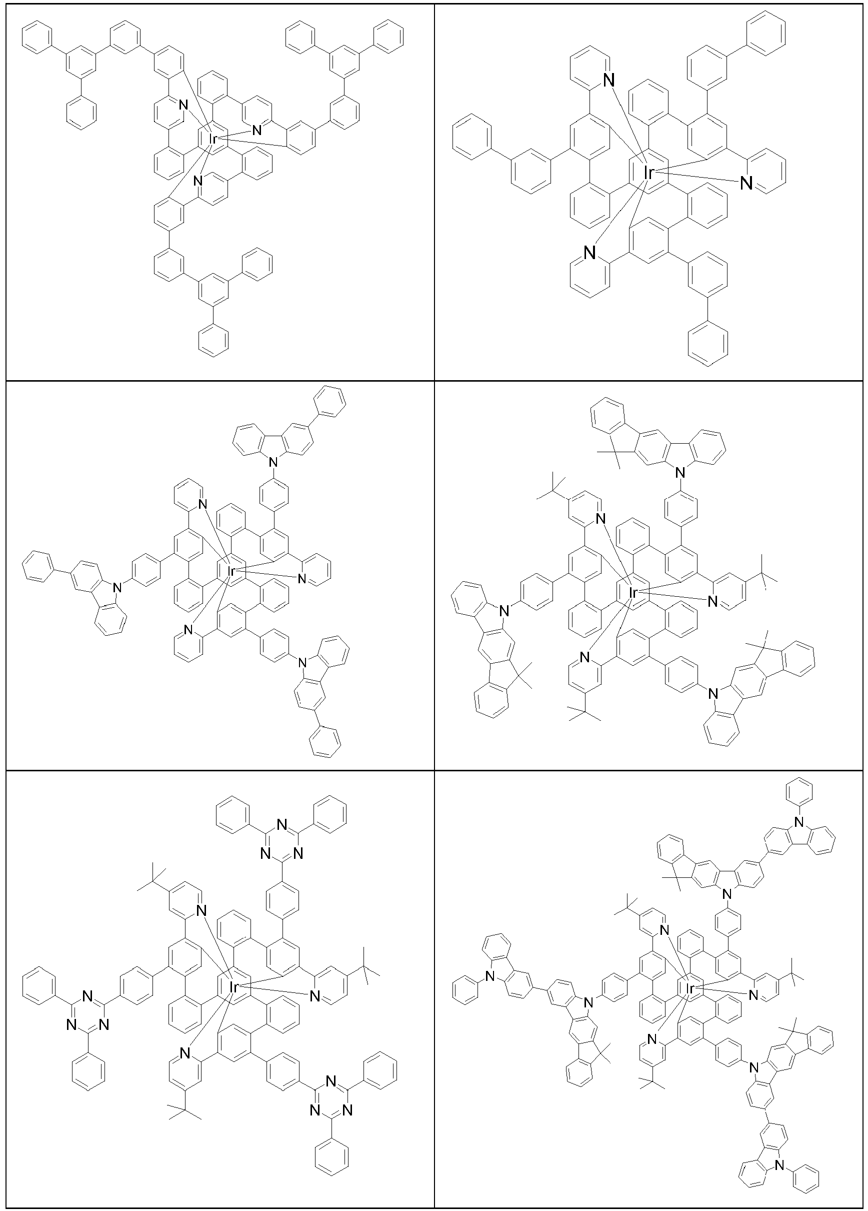

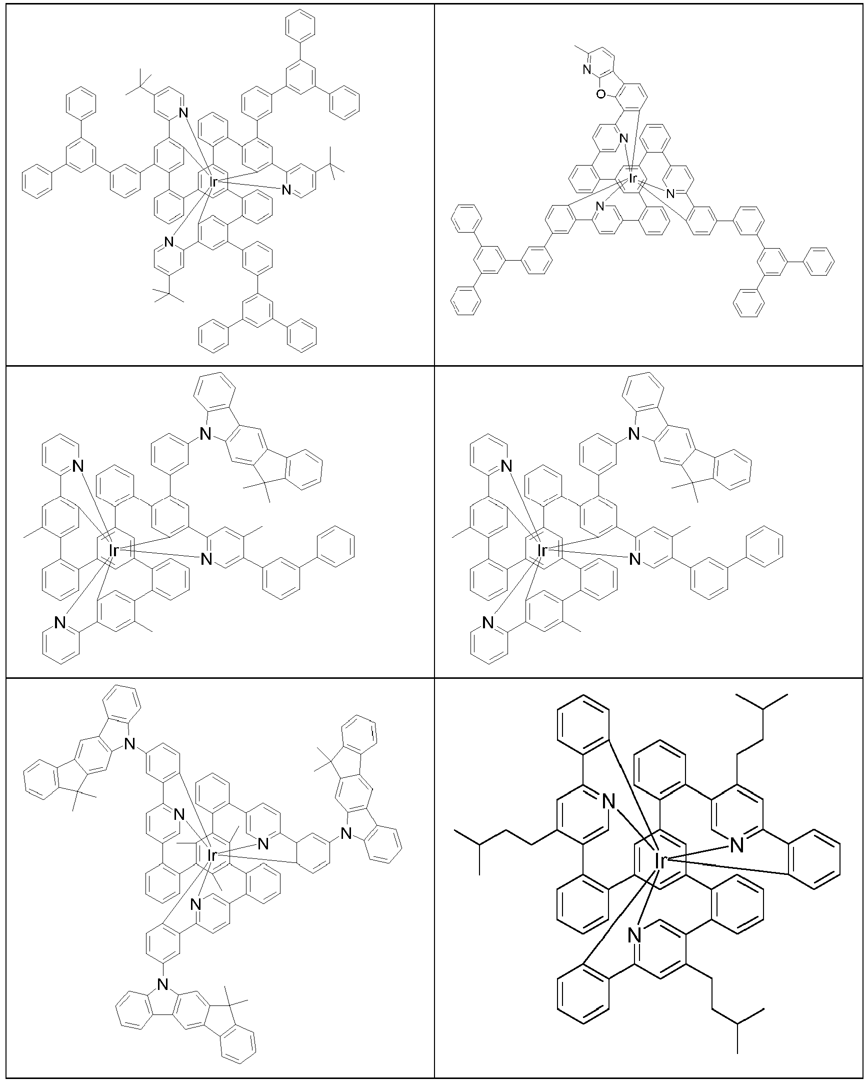

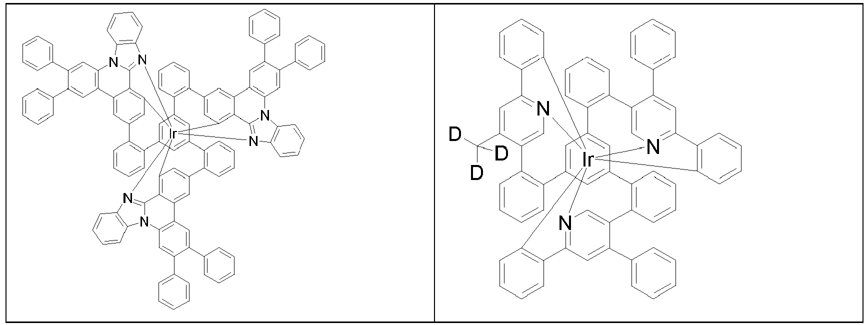

Weiterhin eignen sich die polypodalen Komplexe mit den folgenden CAS-Nummern:

| | | | |
|---|---|---|---|
| CAS-1269508-30-6 | CAS-1989601-68-4 | CAS-1989602-19-8 | CAS-1989602-70-1 |
| CAS-1215692-34-4 | CAS-1989601-69-5 | CAS-1989602-20-1 | CAS-1989602-71-2 |
| CAS-1370364-40-1 | CAS-1989601-70-8 | CAS-1989602-21-2 | CAS-1989602-72-3 |
| CAS-1370364-42-3 | CAS-1989601-71-9 | CAS-1989602-22-3 | CAS-1989602-73-4 |
| CAS-1989600-74-9 | CAS-1989601-72-0 | CAS-1989602-23-4 | CAS-1989602-74-5 |
| CAS-1989600-75-0 | CAS-1989601-73-1 | CAS-1989602-24-5 | CAS-1989602-75-6 |
| CAS-1989600-77-2 | CAS-1989601-74-2 | CAS-1989602-25-6 | CAS-1989602-76-7 |
| CAS-1989600-78-3 | CAS-1989601-75-3 | CAS-1989602-26-7 | CAS-1989602-77-8 |
| CAS-1989600-79-4 | CAS-1989601-76-4 | CAS-1989602-27-8 | CAS-1989602-78-9 |
| CAS-1989600-82-9 | CAS-1989601-77-5 | CAS-1989602-28-9 | CAS-1989602-79-0 |
| CAS-1989600-83-0 | CAS-1989601-78-6 | CAS-1989602-29-0 | CAS-1989602-80-3 |
| CAS-1989600-84-1 | CAS-1989601-79-7 | CAS-1989602-30-3 | CAS-1989602-82-5 |
| CAS-1989600-85-2 | CAS-1989601-80-0 | CAS-1989602-31-4 | CAS-1989602-84-7 |
| CAS-1989600-86-3 | CAS-1989601-81-1 | CAS-1989602-32-5 | CAS-1989602-85-8 |
| CAS-1989600-87-4 | CAS-1989601-82-2 | CAS-1989602-33-6 | CAS-1989602-86-9 |
| CAS-1989600-88-5 | CAS-1989601-83-3 | CAS-1989602-34-7 | CAS-1989602-87-0 |
| CAS-1989600-89-6 | CAS-1989601-84-4 | CAS-1989602-35-8 | CAS-1989602-88-1 |
| CAS-1989601-11-7 | CAS-1989601-85-5 | CAS-1989602-36-9 | CAS-1989604-00-3 |
| CAS-1989601-23-1 | CAS-1989601-86-6 | CAS-1989602-37-0 | CAS-1989604-01-4 |
| CAS-1989601-26-4 | CAS-1989601-87-7 | CAS-1989602-38-1 | CAS-1989604-02-5 |
| CAS-1989601-28-6 | CAS-1989601-88-8 | CAS-1989602-39-2 | CAS-1989604-03-6 |
| CAS-1989601-29-7 | CAS-1989601-89-9 | CAS-1989602-40-5 | CAS-1989604-04-7 |
| CAS-1989601-33-3 | CAS-1989601-90-2 | CAS-1989602-41-6 | CAS-1989604-05-8 |
| CAS-1989601-40-2 | CAS-1989601-91-3 | CAS-1989602-42-7 | CAS-1989604-06-9 |
| CAS-1989601-41-3 | CAS-1989601-92-4 | CAS-1989602-43-8 | CAS-1989604-07-0 |
| CAS-1989601-42-4 | CAS-1989601-93-5 | CAS-1989602-44-9 | CAS-1989604-08-1 |
| CAS-1989601-43-5 | CAS-1989601-94-6 | CAS-1989602-45-0 | CAS-1989604-09-2 |
| CAS-1989601-44-6 | CAS-1989601-95-7 | CAS-1989602-46-1 | CAS-1989604-10-5 |
| CAS-1989601-45-7 | CAS-1989601-96-8 | CAS-1989602-47-2 | CAS-1989604-11-6 |
| CAS-1989601-46-8 | CAS-1989601-97-9 | CAS-1989602-48-3 | CAS-1989604-13-8 |
| CAS-1989601-47-9 | CAS-1989601-98-0 | CAS-1989602-49-4 | CAS-1989604-14-9 |
| CAS-1989601-48-0 | CAS-1989601-99-1 | CAS-1989602-50-7 | CAS-1989604-15-0 |
| CAS-1989601-49-1 | CAS-1989602-00-7 | CAS-1989602-51-8 | CAS-1989604-16-1 |
| CAS-1989601-50-4 | CAS-1989602-01-8 | CAS-1989602-52-9 | CAS-1989604-17-2 |
| CAS-1989601-51-5 | CAS-1989602-02-9 | CAS-1989602-53-0 | CAS-1989604-18-3 |
| CAS-1989601-52-6 | CAS-1989602-03-0 | CAS-1989602-54-1 | CAS-1989604-19-4 |
| CAS-1989601-53-7 | CAS-1989602-04-1 | CAS-1989602-55-2 | CAS-1989604-20-7 |
| CAS-1989601-54-8 | CAS-1989602-05-2 | CAS-1989602-56-3 | CAS-1989604-21-8 |
| CAS-1989601-55-9 | CAS-1989602-06-3 | CAS-1989602-57-4 | CAS-1989604-22-9 |
| CAS-1989601-56-0 | CAS-1989602-07-4 | CAS-1989602-58-5 | CAS-1989604-23-0 |
| CAS-1989601-57-1 | CAS-1989602-08-5 | CAS-1989602-59-6 | CAS-1989604-24-1 |
| CAS-1989601-58-2 | CAS-1989602-09-6 | CAS-1989602-60-9 | CAS-1989604-25-2 |
| CAS-1989601-59-3 | CAS-1989602-10-9 | CAS-1989602-61-0 | CAS-1989604-26-3 |
| CAS-1989601-60-6 | CAS-1989602-11-0 | CAS-1989602-62-1 | CAS-1989604-27-4 |
| CAS-1989601-61-7 | CAS-1989602-12-1 | CAS-1989602-63-2 | CAS-1989604-28-5 |
| CAS-1989601-62-8 | CAS-1989602-13-2 | CAS-1989602-64-3 | CAS-1989604-29-6 |
| CAS-1989601-63-9 | CAS-1989602-14-3 | CAS-1989602-65-4 | CAS-1989604-30-9 |
| CAS-1989601-64-0 | CAS-1989602-15-4 | CAS-1989602-66-5 | CAS-1989604-31-0 |
| CAS-1989601-65-1 | CAS-1989602-16-5 | CAS-1989602-67-6 | CAS-1989604-32-1 |
| CAS-1989601-66-2 | CAS-1989602-17-6 | CAS-1989602-68-7 | CAS-1989604-33-2 |
| CAS-1989601-67-3 | CAS-1989602-18-7 | CAS-1989602-69-8 | CAS-1989604-34-3 |
| CAS-1989604-35-4 | CAS-1989604-88-7 | CAS-1989605-52-8 | CAS-1989606-07-6 |
| CAS-1989604-36-5 | CAS-1989604-89-8 | CAS-1989605-53-9 | CAS-1989606-08-7 |
| CAS-1989604-37-6 | CAS-1989604-90-1 | CAS-1989605-54-0 | CAS-1989606-09-8 |
| CAS-1989604-38-7 | CAS-1989604-92-3 | CAS-1989605-55-1 | CAS-1989606-10-1 |
| CAS-1989604-39-8 | CAS-1989604-93-4 | CAS-1989605-56-2 | CAS-1989606-11-2 |
| CAS-1989604-40-1 | CAS-1989604-94-5 | CAS-1989605-57-3 | CAS-1989606-12-3 |
| CAS-1989604-41-2 | CAS-1989604-95-6 | CAS-1989605-58-4 | CAS-1989606-13-4 |
| CAS-1989604-42-3 | CAS-1989604-96-7 | CAS-1989605-59-5 | CAS-1989606-14-5 |
| CAS-1989604-43-4 | CAS-1989604-97-8 | CAS-1989605-61-9 | CAS-1989606-15-6 |
| CAS-1989604-45-6 | CAS-1989605-09-5 | CAS-1989605-62-0 | CAS-1989606-16-7 |
| CAS-1989604-46-7 | CAS-1989605-10-8 | CAS-1989605-63-1 | CAS-1989606-17-8 |
| CAS-1989604-47-8 | CAS-1989605-11-9 | CAS-1989605-64-2 | CAS-1989606-18-9 |
| CAS-1989604-48-9 | CAS-1989605-13-1 | CAS-1989605-65-3 | CAS-1989606-19-0 |
| CAS-1989604-49-0 | CAS-1989605-14-2 | CAS-1989605-66-4 | CAS-1989606-20-3 |
| CAS-1989604-50-3 | CAS-1989605-15-3 | CAS-1989605-67-5 | CAS-1989606-21-4 |
| CAS-1989604-52-5 | CAS-1989605-16-4 | CAS-1989605-68-6 | CAS-1989606-22-5 |
| CAS-1989604-53-6 | CAS-1989605-17-5 | CAS-1989605-69-7 | CAS-1989606-23-6 |
| CAS-1989604-54-7 | CAS-1989605-18-6 | CAS-1989605-70-0 | CAS-1989606-24-7 |
| CAS-1989604-55-8 | CAS-1989605-19-7 | CAS-1989605-71-1 | CAS-1989606-26-9 |
| CAS-1989604-56-9 | CAS-1989605-20-0 | CAS-1989605-72-2 | CAS-1989606-27-0 |
| CAS-1989604-57-0 | CAS-1989605-21-1 | CAS-1989605-73-3 | CAS-1989606-28-1 |
| CAS-1989604-58-1 | CAS-1989605-22-2 | CAS-1989605-74-4 | CAS-1989606-29-2 |
| CAS-1989604-59-2 | CAS-1989605-23-3 | CAS-1989605-75-5 | CAS-1989606-30-5 |
| CAS-1989604-60-5 | CAS-1989605-24-4 | CAS-1989605-76-6 | CAS-1989606-31-6 |
| CAS-1989604-61-6 | CAS-1989605-25-5 | CAS-1989605-77-7 | CAS-1989606-32-7 |
| CAS-1989604-62-7 | CAS-1989605-26-6 | CAS-1989605-78-8 | CAS-1989606-33-8 |
| CAS-1989604-63-8 | CAS-1989605-27-7 | CAS-1989605-79-9 | CAS-1989606-34-9 |
| CAS-1989604-64-9 | CAS-1989605-28-8 | CAS-1989605-81-3 | CAS-1989606-35-0 |
| CAS-1989604-65-0 | CAS-1989605-29-9 | CAS-1989605-82-4 | CAS-1989606-36-1 |
| CAS-1989604-66-1 | CAS-1989605-30-2 | CAS-1989605-83-5 | CAS-1989606-37-2 |
| CAS-1989604-67-2 | CAS-1989605-31-3 | CAS-1989605-84-6 | CAS-1989606-38-3 |
| CAS-1989604-68-3 | CAS-1989605-32-4 | CAS-1989605-85-7 | CAS-1989606-39-4 |
| CAS-1989604-69-4 | CAS-1989605-33-5 | CAS-1989605-86-8 | CAS-1989606-40-7 |
| CAS-1989604-70-7 | CAS-1989605-34-6 | CAS-1989605-87-9 | CAS-1989606-41-8 |
| CAS-1989604-71-8 | CAS-1989605-35-7 | CAS-1989605-88-0 | CAS-1989606-42-9 |
| CAS-1989604-72-9 | CAS-1989605-36-8 | CAS-1989605-89-1 | CAS-1989606-43-0 |
| CAS-1989604-73-0 | CAS-1989605-37-9 | CAS-1989605-90-4 | CAS-1989606-44-1 |
| CAS-1989604-74-1 | CAS-1989605-38-0 | CAS-1989605-91-5 | CAS-1989606-45-2 |
| CAS-1989604-75-2 | CAS-1989605-39-1 | CAS-1989605-92-6 | CAS-1989606-46-3 |
| CAS-1989604-76-3 | CAS-1989605-40-4 | CAS-1989605-93-7 | CAS-1989606-48-5 |
| CAS-1989604-77-4 | CAS-1989605-41-5 | CAS-1989605-94-8 | CAS-1989606-49-6 |
| CAS-1989604-78-5 | CAS-1989605-42-6 | CAS-1989605-95-9 | CAS-1989606-53-2 |
| CAS-1989604-79-6 | CAS-1989605-43-7 | CAS-1989605-96-0 | CAS-1989606-55-4 |
| CAS-1989604-80-9 | CAS-1989605-44-8 | CAS-1989605-97-1 | CAS-1989606-56-5 |
| CAS-1989604-81-0 | CAS-1989605-45-9 | CAS-1989605-98-2 | CAS-1989606-61-2 |
| CAS-1989604-82-1 | CAS-1989605-46-0 | CAS-1989605-99-3 | CAS-1989606-62-3 |
| CAS-1989604-83-2 | CAS-1989605-47-1 | CAS-1989606-00-9 | CAS-1989606-63-4 |
| CAS-1989604-84-3 | CAS-1989605-48-2 | CAS-1989606-01-0 | CAS-1989606-67-8 |
| CAS-1989604-85-4 | CAS-1989605-49-3 | CAS-1989606-04-3 | CAS-1989606-69-0 |
| CAS-1989604-86-5 | CAS-1989605-50-6 | CAS-1989606-05-4 | CAS-1989606-70-3 |
| CAS-1989604-87-6 | CAS-1989605-51-7 | CAS-1989606-06-5 | CAS-1989606-74-7 |
| CAS-1989658-39-0 | CAS-2088184-56-7 | CAS-2088185-07-1 | CAS-2088185-66-2 |
| CAS-1989658-41-4 | CAS-2088184-57-8 | CAS-2088185-08-2 | CAS-2088185-67-3 |
| CAS-1989658-43-6 | CAS-2088184-58-9 | CAS-2088185-09-3 | CAS-2088185-68-4 |
| CAS-1989658-47-0 | CAS-2088184-59-0 | CAS-2088185-10-6 | CAS-2088185-69-5 |
| CAS-1989658-49-2 | CAS-2088184-60-3 | CAS-2088185-11-7 | CAS-2088185-70-8 |
| CAS-2088184-07-8 | CAS-2088184-61-4 | CAS-2088185-12-8 | CAS-2088185-71-9 |
| CAS-2088184-08-9 | CAS-2088184-62-5 | CAS-2088185-13-9 | CAS-2088185-72-0 |
| CAS-2088184-09-0 | CAS-2088184-63-6 | CAS-2088185-14-0 | CAS-2088185-73-1 |
| CAS-2088184-10-3 | CAS-2088184-64-7 | CAS-2088185-15-1 | CAS-2088185-74-2 |
| CAS-2088184-11-4 | CAS-2088184-65-8 | CAS-2088185-16-2 | CAS-2088185-75-3 |
| CAS-2088184-13-6 | CAS-2088184-66-9 | CAS-2088185-17-3 | CAS-2088185-76-4 |
| CAS-2088184-14-7 | CAS-2088184-67-0 | CAS-2088185-18-4 | CAS-2088185-77-5 |
| CAS-2088184-15-8 | CAS-2088184-68-1 | CAS-2088185-19-5 | CAS-2088185-78-6 |
| CAS-2088184-16-9 | CAS-2088184-69-2 | CAS-2088185-20-8 | CAS-2088185-79-7 |
| CAS-2088184-17-0 | CAS-2088184-70-5 | CAS-2088185-21-9 | CAS-2088185-80-0 |
| CAS-2088184-18-1 | CAS-2088184-71-6 | CAS-2088185-22-0 | CAS-2088185-81-1 |
| CAS-2088184-19-2 | CAS-2088184-72-7 | CAS-2088185-23-1 | CAS-2088185-82-2 |
| CAS-2088184-20-5 | CAS-2088184-73-8 | CAS-2088185-32-2 | CAS-2088185-83-3 |
| CAS-2088184-21-6 | CAS-2088184-74-9 | CAS-2088185-33-3 | CAS-2088185-84-4 |
| CAS-2088184-22-7 | CAS-2088184-75-0 | CAS-2088185-34-4 | CAS-2088185-85-5 |
| CAS-2088184-23-8 | CAS-2088184-76-1 | CAS-2088185-35-5 | CAS-2088185-86-6 |
| CAS-2088184-24-9 | CAS-2088184-77-2 | CAS-2088185-36-6 | CAS-2088185-87-7 |
| CAS-2088184-25-0 | CAS-2088184-78-3 | CAS-2088185-37-7 | CAS-2088185-88-8 |
| CAS-2088184-26-1 | CAS-2088184-79-4 | CAS-2088185-38-8 | CAS-2088185-89-9 |
| CAS-2088184-27-2 | CAS-2088184-80-7 | CAS-2088185-39-9 | CAS-2088185-90-2 |
| CAS-2088184-28-3 | CAS-2088184-81-8 | CAS-2088185-40-2 | CAS-2088185-91-3 |
| CAS-2088184-29-4 | CAS-2088184-82-9 | CAS-2088185-41-3 | CAS-2088185-92-4 |
| CAS-2088184-30-7 | CAS-2088184-83-0 | CAS-2088185-42-4 | CAS-2088185-93-5 |
| CAS-2088184-32-9 | CAS-2088184-84-1 | CAS-2088185-43-5 | CAS-2088185-94-6 |
| CAS-2088184-34-1 | CAS-2088184-85-2 | CAS-2088185-44-6 | CAS-2088185-95-7 |
| CAS-2088184-35-2 | CAS-2088184-86-3 | CAS-2088185-45-7 | CAS-2088185-96-8 |
| CAS-2088184-36-3 | CAS-2088184-87-4 | CAS-2088185-46-8 | CAS-2088185-97-9 |
| CAS-2088184-37-4 | CAS-2088184-88-5 | CAS-2088185-47-9 | CAS-2088185-98-0 |
| CAS-2088184-38-5 | CAS-2088184-89-6 | CAS-2088185-48-0 | CAS-2088185-99-1 |
| CAS-2088184-39-6 | CAS-2088184-90-9 | CAS-2088185-49-1 | CAS-2088186-00-7 |
| CAS-2088184-40-9 | CAS-2088184-91-0 | CAS-2088185-50-4 | CAS-2088186-01-8 |
| CAS-2088184-41-0 | CAS-2088184-92-1 | CAS-2088185-51-5 | CAS-2088186-02-9 |
| CAS-2088184-42-1 | CAS-2088184-93-2 | CAS-2088185-52-6 | CAS-2088195-88-2 |
| CAS-2088184-43-2 | CAS-2088184-94-3 | CAS-2088185-53-7 | CAS-2088195-89-3 |
| CAS-2088184-44-3 | CAS-2088184-95-4 | CAS-2088185-54-8 | CAS-2088195-90-6 |
| CAS-2088184-45-4 | CAS-2088184-96-5 | CAS-2088185-55-9 | CAS-2088195-91-7 |
| CAS-2088184-46-5 | CAS-2088184-97-6 | CAS-2088185-56-0 | CAS-861806-70-4 |
| CAS-2088184-47-6 | CAS-2088184-98-7 | CAS-2088185-57-1 | CAS-1269508-30-6 |
| CAS-2088184-48-7 | CAS-2088184-99-8 | CAS-2088185-58-2 | |
| CAS-2088184-49-8 | CAS-2088185-00-4 | CAS-2088185-59-3 | |
| CAS-2088184-50-1 | CAS-2088185-01-5 | CAS-2088185-60-6 | |
| CAS-2088184-51-2 | CAS-2088185-02-6 | CAS-2088185-61-7 | |
| CAS-2088184-52-3 | CAS-2088185-03-7 | CAS-2088185-62-8 | |
| CAS-2088184-53-4 | CAS-2088185-04-8 | CAS-2088185-63-9 | |
| CAS-2088184-54-5 | CAS-2088185-05-9 | CAS-2088185-64-0 | |
| CAS-2088184-55-6 | CAS-2088185-06-0 | CAS-2088185-65-1 | |

Die erfindungsgemäßen Metallkomplexe lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht, je nach Wahl des Metalls und genauer Struktur des Liganden. Wenn es sich bei dem erfindungsgemäßen Metallkomplex um einen Aluminiumkomplex handelt, so wird dieser bevorzugt in einer Elektronentransportschicht eingesetzt. Ebenso lassen sich die erfindungsgemäßen Metallkomplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. In einer bevorzugten Ausführungsform der Erfindung wird die Schicht, die die erfindungsgemäße Verbindung enthält, aus Lösung aufgebracht.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. (2) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden Vorteile gegenüber dem Stand der Technik aus:
1. Die erfindungsgemäßen Verbindungen weisen eine sehr hohe Photolumineszenz-Quantenausbeute auf. Dies führt bei Verwendung in einer organischen Elektrolumineszenzvorrichtung zu hervorragenden Effizienzen.
2. Die erfindungsgemäßen Verbindungen weisen eine sehr geringe Lumineszenzlebensdauer auf. Dies führt bei Verwendung in einer organischen Elektrolumineszenzvorrichtung zu einem verbesserten Roll-off-Verhalten sowie durch Vermeidung nicht-radiativer Relaxationskanäle zu einer höheren Lumineszenz-Quantenausbeute.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Synthese der Bausteine B

### Beispiel B1:

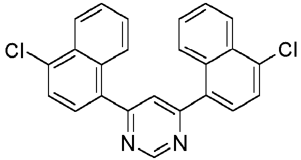

Ein Gemisch aus 23.8 g (100 mmol) 4,6-Dibrompyrimidin [36847-10-6], 41.3 g (200 mmol) (4-Chlor-naphthalin-1-yl)boronsäure [147102-97-4], 63.6 g (600 mmol) Natriumcarbonat, 5.8 g (5 mmol) Tetrakis(triphenylphosphin)palladium(0) [14221-01-3], 800 ml Toluol, 300 mL Ethanol und 700 mL Wasser wird 24 h unter Rückfluss erhitzt. Nach dem Abkühlen wird die organische Phase abgetrennt, 2x mit 300 mL Wasser und einmal mit 200 mL gesättigter NaCI-Lösung gewaschen, über ein Celitebett filtriert und das Filtrat zur Trockene eingeengt. Der Rückstand wird zweimal durch Umkristallisation aus Acetonitril gereinigt. Ausbeute 20.5 g (51 mmol), 51 %, Reinheit 95%ig nach ¹H-NMR.

### Beispiel B204:

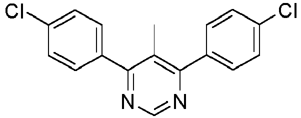

Analog zur Durchführung für B1 kann der Baustein B204 dargestellt werden, wobei statt 4,6-Dibrompyrimidin 4,6-Dibrom-5-methylpyrimidin [83941-93-9] eingesetzt wird und anstatt (4-Chlor-naphthalin-1-yl)boronsäure 4-Chlorphenylboronsäure [1679-18-1]. Ausbeute 55%.

### Beispiel B2:

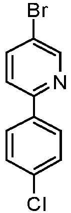

In einen 4 L-Vierhalskolben mit Rückflusskühler, Argonüberlagerung, KPG-Rührer und Innenthermometer werden 134 g 4-Chlorphenylboronsäure (860 mmol) [1679-18-1], 250.0 g 5-Brom-2-iod-pyridin (880 mmol) [223463-13-6] und 232.7 g Kaliumcarbonat (1.68 mol) eingewogen, der Kolben mit Argon inertisiert und mit 1500 ml Acetonitril und 1000 ml absolutem Ethanol versetzt. Es werden 100 g Glasperlen (Durchmesser 3 mm) hinzugegeben, und die Suspension wird für 5 Minuten homogenisiert. Dann werden 5.8 g Bis(triphenylphosphin)-palladium(II)chlorid (8.3 mmol) [13965-03-2] zugegeben. Die Reaktionsmischung wird über Nacht unter starkem Rühren auf Rückfluss erwärmt. Nach dem Abkühlen wird das Lösungsmittel abrotiert und der Rückstand extraktiv mit Toluol und Wasser im Scheidetrichter aufgearbeitet. Die organische Phase wird 2x mit 500 ml Wasser und 1x mit 300 ml gesättigter Kochsalzlösung gewaschen, über wasserfreiem Natriumsulfat getrocknet und anschließend das Lösungsmittel im Vakuum entfernt. Der Rückstand wird in Dichlormethan aufgenommen und über eine Kieselgelfritte filtriert. Das Kieselgelbett wird zweimal mit je 500 mL Dichlormethan nachgewaschen. Zum Filtrat werden 800 mL Ethanol gegeben, das Dichlormethan am Rotationsverdampfer bis 500 mbar abgezogen. Beim Abrotieren des Dichlormethans fällt aus dem verbleibenden Ethanol ein Feststoff aus, dieser wird abgesaugt und mit Ethanol gewaschen. Der erhaltene gelbe Feststoff wird aus 800 ml Acetonitril am Rückfluss umkristallisiert. Es wird ein beiger Feststoff erhalten. Ausbeute: 152.2 g (567.0 mmol), 66%; Reinheit: ca. 95%ig nach ¹H-NMR.

### Beispiel B3:

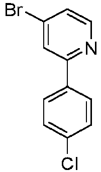

Analog zur Durchführung für B2 kann der folgende Baustein B3 dargestellt werden, wobei statt 5-Brom-2-iod-pyridin 2,4-Dibrompyridin [58530-53-3] eingesetzt wird. Ausbeute 54%.

### Beispiel B4:

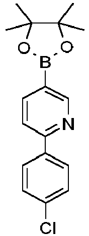

In einen 4 L-Vierhalskolben mit Rückflusskühler, KPG-Rührer, Heizbad und Argonanschluss werden 162.0 g (600 mmol) B2, 158.0 g (622 mmol) Bis(pinacolato)diboran [73183-34-3], 180.1 g (1.83 mol) Kaliumacetat [127-08-2] und 8.9 g (12.1 mmol) trans-Dichlorobis(tricyclohexyl-phosphin)-palladium(II) [29934-17-6] eingewogen und mit 2200 ml 1,4-Dioxan versetzt. Es werden 100 g Glasperlen (Durchmesser 3 mm) zugegeben, die Reaktionsmischung wird mit Argon inertisiert und unter Rückfluss für 24 h gerührt. Nach Abkühlen wird das Lösungsmitel im Vakuum entfernt, der erhaltene Rückstand extraktiv im Scheidetrichter mit 1000 ml Ethylacetat und 1500 ml Wasser aufgearbeitet. Die organische Phase wird 1x mit 500 ml Wasser und 1x mit 300 ml gesättigter Kochsalzlösung gewaschen, über wasserfreiem Natriumsulfat getrocknet und über eine mit Kieselgel gepackte Fritte filtriert. Das Kieselgelbett wird 2x mit 500 ml Ethylacetat nachgewaschen und das erhaltene Filtrat im Vakuum eingeengt. Der erhaltene braune Feststoff wird aus 1000 ml n-Heptan unter Rückfluss umkristallisiert. Es wird ein beiger Feststoff erhalten. Ausbeute: 150.9 g (478 mmol), 80%; Reinheit: 97%ig nach ¹H-NMR.

### Beispiel B5:

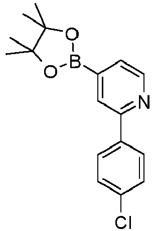

Analog der Durchführung zu B4 kann der Baustein B5 ausgehend von Verbindung B3 dargestellt werden: Statt 12.1 mmol trans-Dichlorobis(tri-cyclohexylphosphin)-palladium(II) werden 12 mmol [1,1'-Bis(diphenyl-phosphino)ferrocen]dichloropalladium(II) Komplex mit Dichlormethan [95464-05-4] eingesetzt. Ausbeute: 75%.

### Beispiel B6:

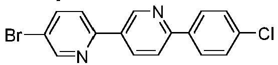

In einen 2 L-Vierhalskolben mit Rückflusskühler, Argonüberlagerung, KPG-Rührer und Innenthermometer werden 31.5 g (100 mmol) B4, 28.4 g 5-Brom-2-iod-pyridin (100mmol) [223463-13-6] und 34.6 g Kaliumcarbonat (250 mmol) eingewogen, der Kolben mit Argon inertisiert und mit 500 ml Acetonitril und 350 ml absolutem Ethanol versetzt. Es werden 30 g Glasperlen (Durchmesser 3 mm) hinzugegeben und die Suspension wird für 5 Minuten homogenisiert. Dann werden 702 mg Bis(triphenylphosphin)-palladium(II)chlorid (1 mmol) [13965-03-2] zugegeben. Die Reaktionsmischung wird über Nacht unter starkem Rühren auf Rückfluss erwärmt. Nach dem Abkühlen wird das Lösungsmittel abrotiert und der Rückstand extraktiv mit Toluol und Wasser im Scheidetrichter aufgearbeitet. Die organische Phase wird 2x mit 500 ml Wasser und 1x mit 300 ml gesättigter Kochsalzlösung gewaschen, über wasserfreiem Natriumsulfat getrocknet und anschließend das Lösungsmittel im Vakuum entfernt. Der Rückstand wird in Dichlormethan aufgenommen und über eine Kieselgelfritte filtriert, das Kieselgel wird zweimal mit je 200 mL Dichlormethan/Ethylacetat 1:1 nachgewaschen, das Dichlormethan am Rotationsverdampfer bis 500 mbar abgezogen. Beim Abrotieren des Dichlormethans fällt aus dem verbleibenden Ethylacetat ein Feststoff aus, dieser wird abgesaugt und mit Ethylacetat gewaschen. Das Rohprodukt wird nochmals aus Ethylacetat umkristallisiert. Ausbeute: 24.2 g (72 mmol), 72%; Reinheit: ca. 95%ig nach ¹H-NMR.

### Beispiel B7:

Durchführung analog der Beschreibung für B6. Umristallisation aus Acetonitril statt aus Ethylacetat. Ausbeute 68%.

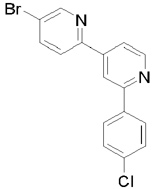

### Beispiel B8:

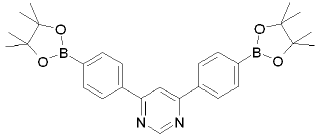

Ein Gemisch aus 30.1 g (100 mmol) 4,6-Bis(4-chlorophenyl)pyrimidin [141034-82-4], 54.6 g (215 mmol) Bis(pinacolato)diboran [73183-34-3], 58.9 g (600 mmol) Kaliumacetat, 2.3 g (8 mmol) S-Phos [657408-07-6], 1.3 g (6 mmol) Palladium(II)acetat, 900 ml 1,4-Dioxan wird 16 h unter Rückfluss erhitzt. Das Dioxan wird am Rotationsverdampfer abrotiert und der schwarze Rückstand wird mit 1000 ml Ethylacetat und 500 mL Wasser extraktiv im Scheidtrichter aufgearbeitet, die organische Phase wird 1x mit 300 mL Wasser und einmal mit 150 mL gesättigter Natriumchloridlösung gewaschen und über ein Kieselgel-Bett filtriert. Das Kieselgel wird 2x mit 250 mL Ethylacetat nachgewaschen. Das Filtrat wird über Natriumsulfat getrocknet und auf 150 mL eingeengt. Dann werden 400 mL n-Heptan zugegeben und das restliche Ethylacetat am Rotationsverdampfer bis 200 mbar bei 55 °C Badtemperatur abgezogen. Beim Abrotieren des Ethylacetats fällt ein Feststoff aus dem verbleibenden n-Heptan aus. Der ausgefallene Feststoff wird 30 min unter Rückfluss erhitzt und nach dem Abkühlen abfiltriert und 2x mit je 30 mL n-Heptan gewaschen. Ausbeute: 37.8 g (78 mmol), 78 %. Reinheit: ca. 98%ig nach ¹H-NMR.

Analog können folgende Verbindungen dargestellt werden:

| Bsp. | Edukt | Produkt/ Reaktionsbedingungen falls abweichend | Ausbeute |
|---|---|---|---|
| B9 | 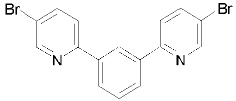 | 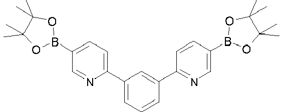 | 91% |
| | [1124297-90-0] | | |
| B10 | 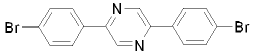 | 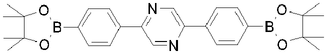 | 87% |
| | [55453-06-0] | | |
| B11 | 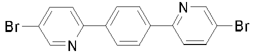 | 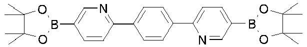 | 90% |
| | [183619-17-2] | | |
| B12 | 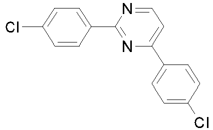 | 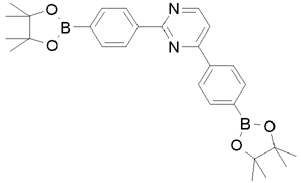 | 82% |
| | [1292783-80-2] | | |
| B13 | 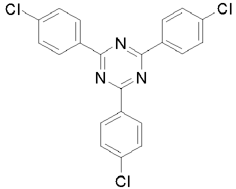 | 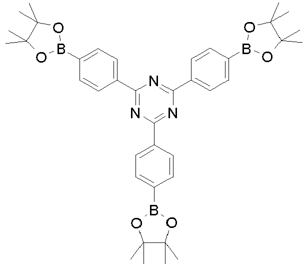 | 66% |
| | [3114-54-3] | 3.3 Equiv. Bis(pinacolato )diboran, 9 Equiv. KOAc | |
| B14 | 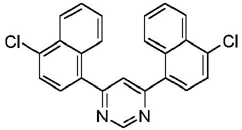 | 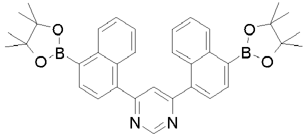 | 63% |
| | B1 | | |
| B15 | 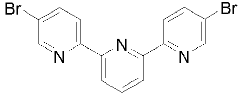 | 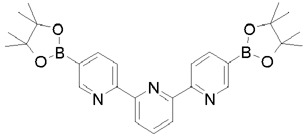 | 85% |
| | [223463-10-3] | | |
| B16 | 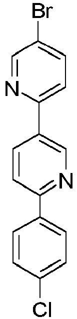 | 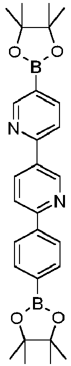 | 87% |
| | B6 | | |
| B17 | 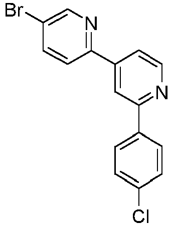 | 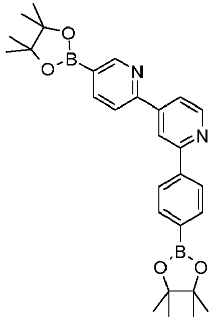 | 85% |
| | B7 | | |
| B205 | 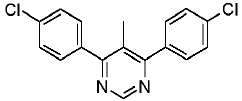 | 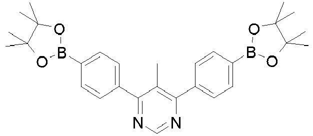 | 82% |
| | B204 | | |

### Beispiel B18:

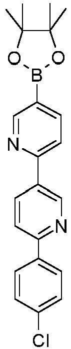

In einen 1000 mL-Vierhalskolben mit Rückflusskühler, KPG-Rührer, Heizbad und Argonanschluss werden 34.6 g (100 mmol) B6, 25.4 g (100 mmol) Bis(pinacolato)diboran [73183-34-3], 29.4 g (300 mmol) Kaliumacetat [127-08-2] und 1.63 g (2 mmol) ([1,1'-Bis(diphenyl-phosphino)-ferrocen]dichloropalladium(II) Komplex mit Dichloromethan [95464-05-4] eingewogen und mit 500 ml 1,4-Dioxan versetzt. Es werden 30 g Glasperlen (Durchmesser 3 mm) zugegeben, und die Reaktionsmischung wird mit Argon inertisiert und unter Rückfluss für 24 h gerührt. Nach Abkühlen wird das Lösungsmitel im Vakuum entfernt, der erhaltene Rückstand extraktiv im Scheidetrichter mit 600 ml Ethylacetat und 600 ml Wasser aufgearbeitet. Die organische Phase wird 1x mit 500 ml Wasser und 1x mit 300 ml gesättigter Kochsalzlösung gewaschen, über wasserfreiem Natriumsulfat getrocknet und über eine mit Kieselgel gepackte Fritte filtriert. Das Kieselgelbett wird 2x mit 500 ml Ethylacetat nachgewaschen und das erhaltene Filtrat im Vakuum eingeengt. Der erhaltene braune Feststoff wird mit 500 ml n-Heptan versetzt und die enstandene Suspension 1 h unter Rückfluss ausgekocht. Der Feststoff wird abgesaugt und mit 50 mL n-Heptan gewaschen. Es wird ein beiger Feststoff erhalten. Ausbeute: 34.6 g (89 mmol), 89%; Reinheit: 98%ig nach ¹H-NMR.

### Beispiel B19:

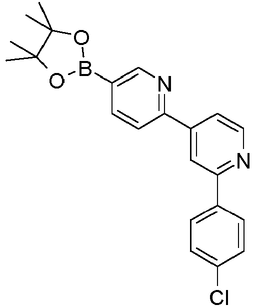

Durchführung analog zu der von Beispiel B18. Statt B6 wird B7 als Edukt eingesetzt. Ausbeute 82%.

### Beispiel B20:

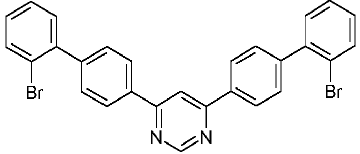

Ein Gemisch aus 48.4 g (100 mmol) B8, 56.6 g (200 mmol) 1-Brom-2-iod-benzol [583-55-1], 63.6 g (600 mmol) Natriumcarbonat, 5.8 g (5 mmol) Tetrakis(triphenylphosphin)palladium(0) [14221-01-3], 1000 ml 1,2-Dimethoxyethan und 500 mL Wasser wird 60 h unter Rückfluss erhitzt. Nach dem Abkühlen wird der ausgefallene Feststoff abgesaugt und 3x mit 100 mL Ethanol gewaschen. Das Rohprodukt wird in 1000 mL Dichlormethan gelöst und über ein mit Dichlormethan vorgeschlämmtes Kieselgel-Bett filtriert. Das Kieselgel wird 3x mit je 100 mL Ethylacetat nachgewaschen. Das Dichlormethan wird am Rotationsverdampfer bis 500 mbar bei 50 °C Badtemperatur abrotiert. Beim Abrotieren des Dichlormethans fällt ein Feststoff aus dem verbleibenden Ethylacetat aus. Der ausgefallene Feststoff wird abfiltriert und 2x mit 20 mL Ethylacetat gewaschen. Der erhaltene Feststoff wird nochmals aus 2000 mL Ethylacetat in der Siedehitze umkristallisiert. Ausbeute 29.3 g (54 mmol), 54%; Reinheit 97%ig nach ¹H-NMR.

Analog können folgende Verbindungen dargestellt werden, wobei zur Umkristallisation Lösemittel, wie z. B. Ethylacetat, Cyclohexan, Toluol, Acetonitril, n-Heptan, Ethanol oder Methanol verwendet werden können. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Edukt | Produkt/ Reaktionsbedingungen falls abweichend | Ausbeute |
|---|---|---|---|
| B21 | B9 | 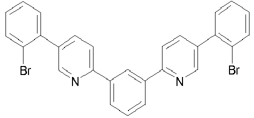 | 42% |
| B22 | B10 | 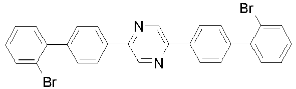 | 53% |
| B23 | B11 | 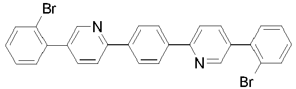 | 47% |
| B24 | B12 | 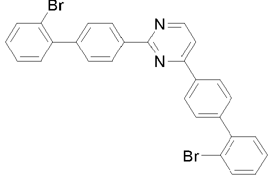 | 40% |
| B25 | B13 | 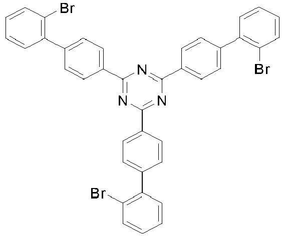 | 32% |
| | | 3 Equiv. 1-Brom-2-iodbenzol, 9 Equiv. Na₂CO₃, 7 mol% Tetrakis(triphenylphosphin)palladium (0) | |
| B26 | B14 | 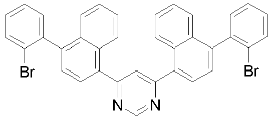 | 35% |
| B27 | B15 | 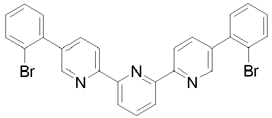 | 47% |
| B28 | B16 | 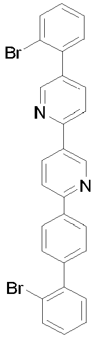 | 41% |
| B29 | B17 | 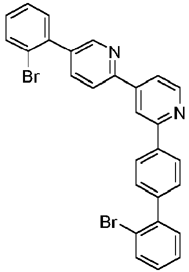 | 44% |
| B30 | B18, 1 Equiv. 1-Brom-2-iodbenzol | 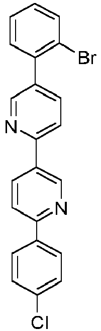 | 67% |
| B31 | B19, 1 Equiv. 1-Brom-2-iodbenzol | 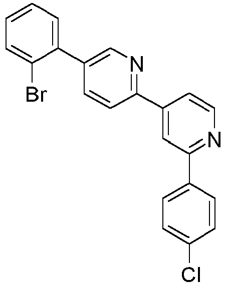 | 52% |
| B206 | B205 | 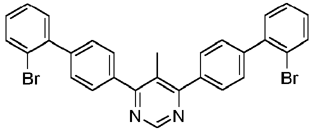 | 46% |

### Beispiel B32:

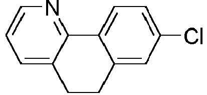

Ein Gemisch aus 18.1 g (100 mmol) 6-Chlor-tetralon [26673-31-4], 16,5 g (300 mmol) Propargylamin [2450-71-7], 796 mg (2 mmol) Natrium-tetra-chloroaurat(III) Dihydrat und 200 ml Ethanol wird 24 h im Autoklaven bei 120 °C gerührt. Nach Erkalten entfernt man das Ethanol im Vakuum, nimmt den Rückstand in 200 ml Ethylacetat auf, wäscht die Lösung dreimal mit 200 ml Wasser, einmal mit 100 ml gesättigter Kochsalzlösung, trocknet über Magnesiumsulfat und filtriert dann von diesem über ein vorgeschlämmtes Kieselgelbett ab. Nach Entfernen des Ethylacetats im Vakuum wird der Rückstand an Kieselgel mit n-Heptan/Ethylaceat (1:2 vv) chromatographiert. Ausbeute: 9.7 g (45 mmol), 45% . Reinheit: ca. 98 %ig n. ¹H-NMR.

### Beispiel B33:

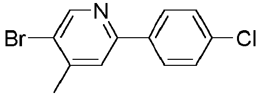

Ein Gemisch aus 25.1 g (100 mmol) 2,5-Dibrom-4-methyl-pyridin [3430-26-0], 15.6 g (100 mmol) 4-Chlorphenylboronsäure [1679-18-1], 27.6 g (200 mmol) Kaliumcarbonat,1.57 g (6 mmol) Triphenylphosphin [603-35-0], 676 mg (3 mmol) Palladium(II)acetat [3375-31-3], 200 g Glaskugeln (3 mm Durchmesser), 200 ml Acetonitril und 100 ml Ethanol wird 48 h unter Rückfluss erhitzt. Nach Erkalten entfernt man die Lösemittel im Vakuum, gibt 500 ml Toluol zu, wäscht zweimal mit je 300 ml Wasser, einmal mit 200 ml gesättigter Kochsalzlösung, trocknet über Magnesiumsulfat, filtriert über ein vorgeschlämmtes Kieselgelbett ab und wäscht dieses mit 300 ml Toluol nach. Nach Entfernen des Toluols im Vakuum kristallisiert man einmal aus Methanol/Ethanol (1:1 vv) und einmal aus n-Heptan um. Ausbeute: 17.3 g (61 mmol), 61 %. Reinheit: ca. 95 %ig n. ¹H-NMR.

### Beispiel B34:

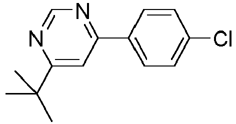

Analog zur Durchfühung beschrieben für Beispiel B33 kann B34 dargestellt werden. Hierzu wird statt 2,5-Dibrom-4-methyl-pyridin 4-Brom-6-tert-butylpyrimidin [19136-36-8] verwendet. Ausbeute: 70%.

### Beispiel B35:

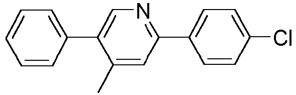

Ein Gemisch aus 28.3 g (100 mmol) B33, 12.8 g (105 mmol) Phenylboronsäure, 31.8 g (300 mmol) Natriumcarbonat, 787 mg (3 mmol) Triphenylphosphin, 225 mg (1 mmol) Palladium(II)acetat, 300 ml Toluol, 150 ml Ethanol und 300 ml Wasser wird 48 h unter Rückfluss erhitzt. Nach Erkalten wird mit 300 ml Toluol erweitert, die organische Phase wird abgetrennt, einmal mit 300 ml Wasser, einmal mit 200 ml gesättigter Kochsalzlösung gewaschen und über Magnesiumsulfat getrocknet. Nach Entfernen das Lösungsmittels wird der Rückstand an Kieselgel (Toluol/Ethylacetat, 9:1 vv) chromatographiert. Ausbeute: 17.1 g (61 mmol), 61 %. Reinheit: ca. 97 %ig n. ¹H-NMR.

Analog können die folgenden Verbindungen synthetisiert werden:

| Bsp. | Boronester | Produkt | Ausbeute |
|---|---|---|---|
| B36 | 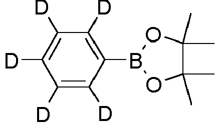 [245043-33-8] | 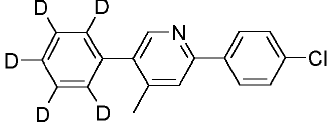 | 56 % |
| B37 | 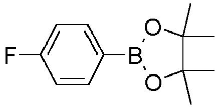 [214360-58-4] | 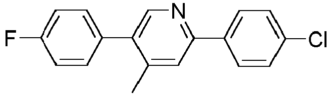 | 61 % |
| B38 | 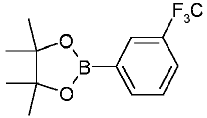 [325142-82-3] | 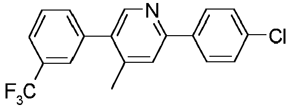 | 55 % |
| B199 | 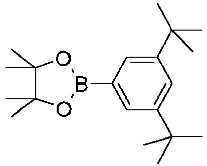 [1071924-13-4] | 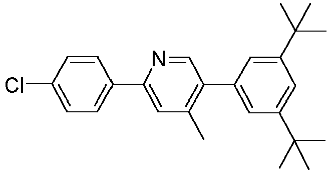 | 65% |

### Beispiel B39:

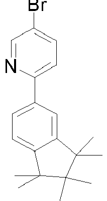

Ein Gemisch aus 164.2 g (500 mmol) 2-(1,1,2,2,3,3-Hexamethyl-indan-5-yl)-4,4,5,5-tetramethyl-[1,3,2]dioxaborolan [152418-16-9] (analog können Boronsäuren eingesetzt werden), 142.0 g (500 mmol) 5-Brom-2-iod-pyridin [223463-13-6], 159.0 g (1.5 mol) Natriumcarbonat, 5.8 g (5 mmol) Tetrakis(triphenylphosphino)-palladium(0), 700 ml Toluol, 300 ml Ethanol und 700 ml Wasser wird unter gutem Rühren 16 h unter Rückfluss erhitzt. Nach dem Abkühlen werden 1000 ml Toluol zugegeben, die organische Phase wird abgetrennt, und die wässrige Phase wird mit 300 ml Toluol nachextrahiert. Die vereinigten organischen Phasen werden einmal mit 500 ml gesättigter Kochsalzlösung gewaschen. Nach Trocknen der organischen Phase über Natriumsulfat und Entfernen des Lösemittels im Vakuum kristallisiert man das Rohprodukt zweimal aus ca. 300 ml EtOH um. Ausbeute: 130.8 g (365 mmol), 73 %. Reinheit: ca. 95 % n. ¹H-NMR.

Analog können folgende Verbindungen dargestellt werden, wobei als Pyridinderivat im Allgemeinen 5-Brom-2-iod-pyridin ([223463-13-6]) eingesetzt wird, welches in der folgenden Tabelle nicht separat aufgeführt ist; lediglich davon abweichende Pyridinderivate sind in der Tabelle explizit aufgeführt. Zur Umkristallisation können Lösungsmittel wie Ethylacetat, Cyclohexan, Toluol, Acetonitril, n-Heptan, Ethanol oder Methanol verwendet werden. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Boronsäure/-ester Pyridin | Produkt | Ausbeute |
|---|---|---|---|
| B40 | 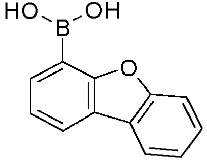 [100124-06-9] | 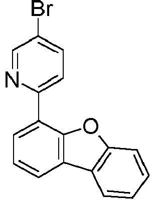 | 69 % |
| B41 | 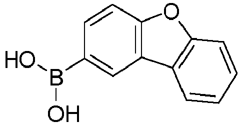 [402936-15-6] | 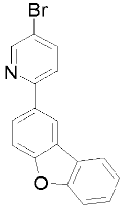 | 71 % |
| B42 | 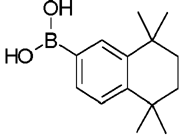 [169126-63-0] | 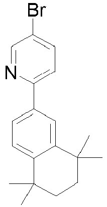 | 78 % |
| B43 | 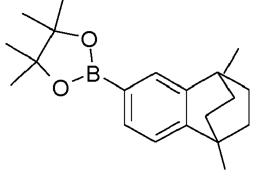 [1801624-61-2] | 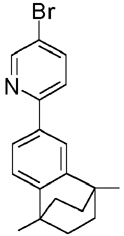 | 78 % |
| B44 | 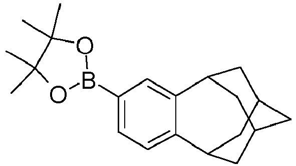 gemäß WO 2016/124304 | 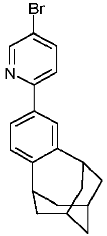 | 81 % |
| B45 | 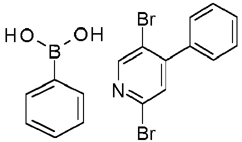 [98-80-6] / [1381937-40-1] | 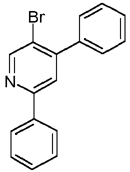 | 73 % |
| B46 | 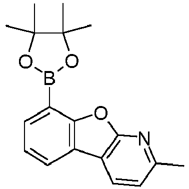 [1609374-04-0] | 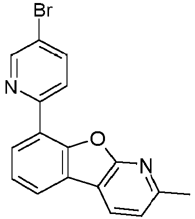 | 68 % |
| B47 | 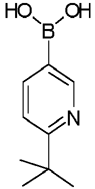 1174312-53-8 | 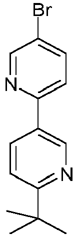 | 63 % |

### Beispiel B48:

### Variante A:

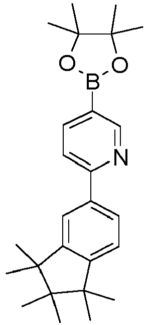

Ein Gemisch aus 35.8 g (100 mmol) B39, 25.4 g (100 mmol) Bis(pinacolato)diboran [73183-34-3], 49.1 g (500 mmol) Kaliumacetat, 1.5 g (2 mmol) 1,1-Bis(diphenylphosphino)ferrocendichlorpalladium(II)-Komplex mit Dichlormethan [95464-05-4], 200 g Glaskugeln (3 mm Durchmesser), 700 ml 1,4-Dioxan und 700 ml Toluol wird 16 h unter Rückfluss erhitzt. Nach Abkühlen wird die Suspension über ein Celite-Bett filtriert und das Lösemittel im Vakuum entfernt. Der schwarze Rückstand wird mit 1000 ml heißem n-Heptan, Cyclohexan oder Toluol digeriert, es wird noch heiß über ein Celite-Bett abfiltriert, dann auf ca. 200 ml eingeengt, wobei das Produkt zu kristallisieren beginnt. Alternativ kann mit Ethylacetat heißextrahiert werden. Die Kristallisation wird über Nacht im Kühlschrank vervollständigt, die Kristalle werden abfiltriert und mit wenig n-Heptan gewaschen. Aus der Mutterlauge kann eine zweite Produktfraktion gewonnen werden. Ausbeute: 31.6 g (78 mmol), 78 %. Reinheit: ca. 95 %ig n. ¹H-NMR.

### Variante B: Umsetzung von Arylchloriden

Wie Variante A, jedoch wird an Stelle von 1,1 -Bis(diphenylphosphino)-ferrocendichlorpalladium(II)-Komplex mit Dichlormethan 2 mmol SPhos [657408-07-6] und 1 mmol Palladium(II)acetat eingesetzt.

Analog können folgende Verbindungen dargestellt werden, wobei zur Reinigung anstelle von n-Heptan auch Cyclohexan, Toluol, Acetonitril bzw. Gemische der genannten Lösungsmittel verwendet werden können:

| Bsp. | Bromid - Variante A | Produkt | Ausbeute |
|---|---|---|---|
| | Chlorid - Variante B | | |
| B49 | 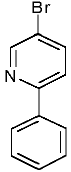 | 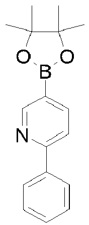 | 85 % |
| | [27012-25-5] | | |
| B50 | 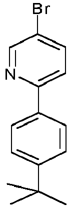 | 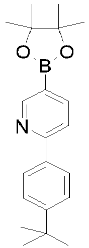 | 80% |
| | [1215073-34-9] | | |
| B51 | 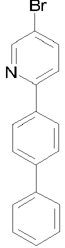 | 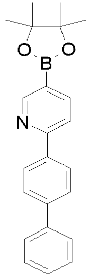 | 83 % |
| | [1035556-84-3] | | |
| B52 | 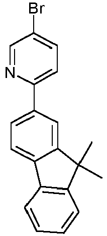 | 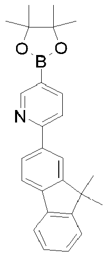 | 77 % |
| | [1486482-87-4] | | |
| B53 | 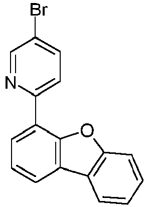 | 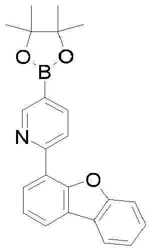 | 67 % |
| | B40 | | |
| B54 | 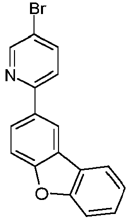 | 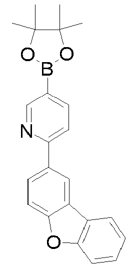 | 70 % |
| | B41 | | |
| B55 | 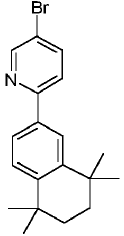 | 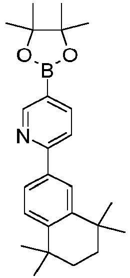 | 80 % |
| | B42 | | |
| B56 | 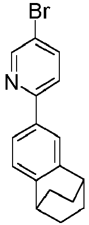 | 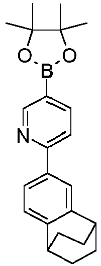 | 80 % |
| | B43 | | |
| B57 | 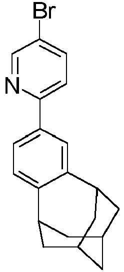 | 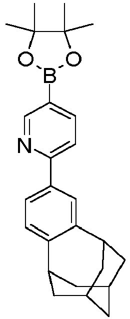 | 78 % |
| | B44 | | |
| B58 | 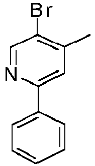 | 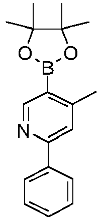 | 74 % |
| | [31686-64-3] | | |
| B59 | 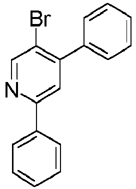 | 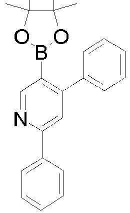 | 70 % |
| | B45 | | |
| B60 | 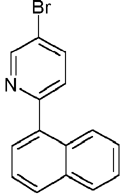 | 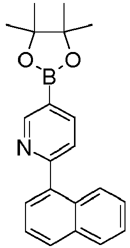 | 68 % |
| | [88345-95-3] | | |
| B61 | 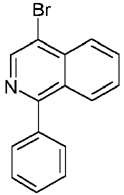 | 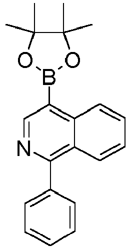 | 76 % |
| | [22960-25-4 ] | | |
| B62 | 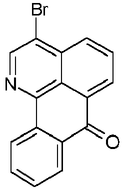 | 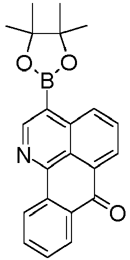 | 83 % |
| | [57669-37-1] | | |
| B63 | 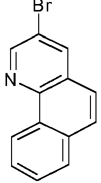 | 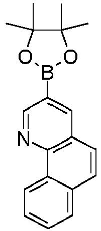 | 85 % |
| | [68473-51-8] | | |
| B64 | 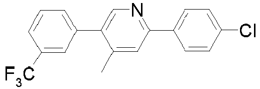 | 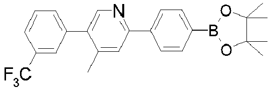 | 55 % |
| | B38 | | |
| B65 | 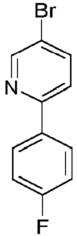 | 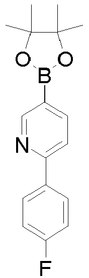 | 72 % |
| | [463336-07-4] | | |
| B66 | 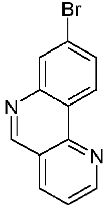 | 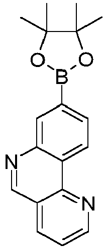 | 78% |
| | [1039080-00-6] | | |
| B67 | 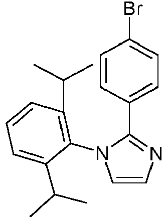 | 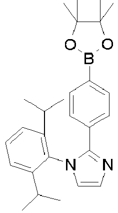 | 82 % |
| | [1492036-00-6] | | |
| B68 | 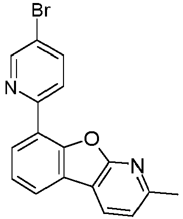 | 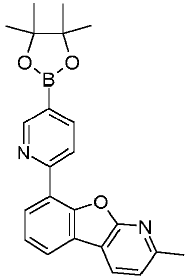 | 60 % |
| | B45 | | |
| B69 | 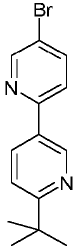 | 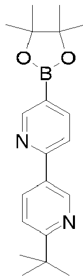 | 75 % |
| | B47 | | |
| B70 | 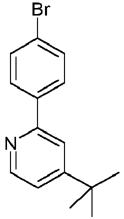 | 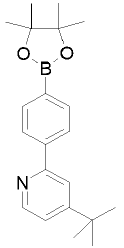 | 88 % |
| | [1246851-70-6] | | |
| B71 | 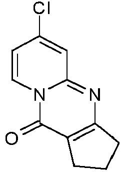 | 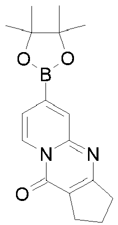 | 78 % |
| | [60781-85-3] | | |
| B72 | 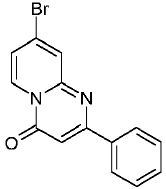 | 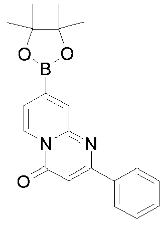 | 82 % |
| | [1338923-08-2] | | |
| B73 | 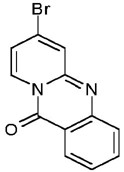 | 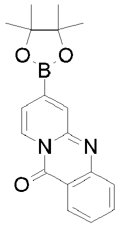 | 80 % |
| | [1446208-20-3] | | |
| B74 | 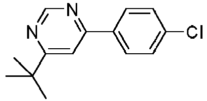 | 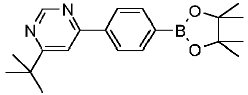 | 85% |
| | B34 | | |
| B75 | 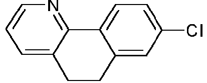 | 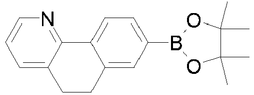 | 88 % |
| | B32 | | |
| B76 | 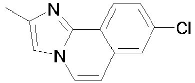 | 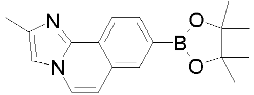 | 76 % |
| | [102200-03-3] | | |
| B77 | 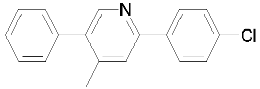 | 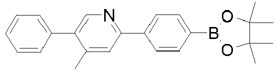 | 81 % |
| | B35 | | |
| B78 | 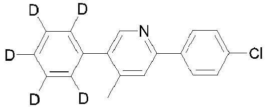 | 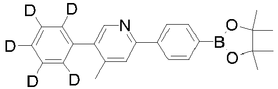 | 78 % |
| | B36 | | |
| B79 | 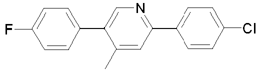 | 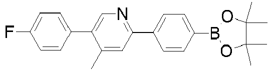 | 75 % |
| | B37 | | |
| B200 | 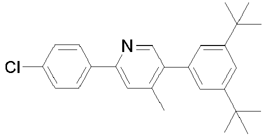 | 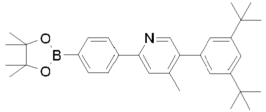 | 78% |
| | B199 | | |

### Beispiel B80:

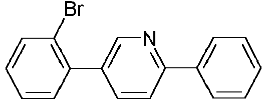

Ein Gemisch aus 28.1 g (100 mmol) B49, 28.2 g (100 mmol) 1-Brom-2-iod-benzol [583-55-1], 31.8 g (300 mmol) Natriumcarbonat, 787 mg (3 mmol) Triphenylphosphin, 225 mg (1 mmol) Palladium(II)acetat, 300 ml Toluol, 150 ml Ethanol und 300 ml Wasser wird 24 h unter Rückfluss erhitzt. Nach Erkalten wird mit 500 ml Toluol erweitert, die organische Phase wird abgetrennt, einmal mit 500 ml Wasser, einmal mit 500 ml gesättigter Kochsalzlösung gewaschen und über Magnesiumsulfat getrocknet. Nach Entfernen das Lösungsmittels wird der Rückstand aus Ethylacetat/n-Heptan umkristallisiert oder an Kieselgel (Toluol/Ethylacetat, 9:1 vv) chromatographiert. Ausbeute: 22.7 g (73 mmol), 73 %. Reinheit: ca. 97 %ig n. ¹H-NMR.

Analog können folgende Verbindungen dargestellt werden, wobei zur Umkristallisation Lösemittel, wie z. B. Ethylacetat, Cyclohexan, Toluol, Acetonitril, n-Heptan, Ethanol oder Methanol verwendet werden können. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Boronester | Produkt | Ausbeute |
|---|---|---|---|
| B81 | 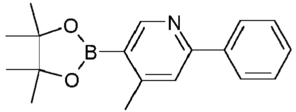 | 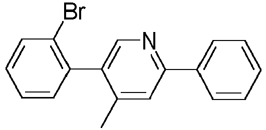 | 56 % |
| | B58 | | |
| B82 | 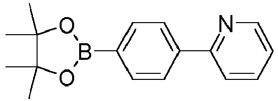 | 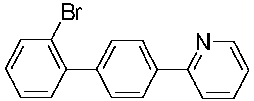 | 72 % |
| | [908350-80-1] | | |
| B83 | 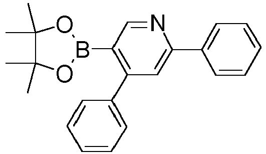 | 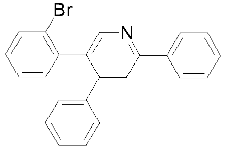 | 71 % |
| | B59 | | |
| B84 | 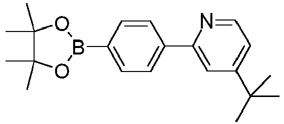 | 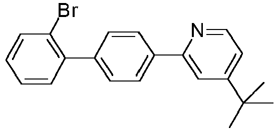 | 70 % |
| | B70 | | |
| B85 | 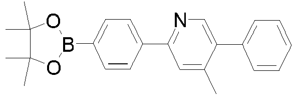 | 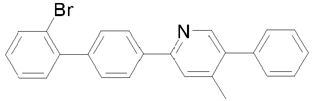 | 69 % |
| | B77 | | |
| B86 | 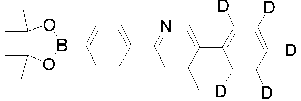 | 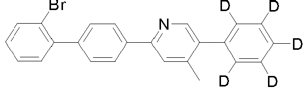 | 67 % |
| | B78 | | |
| B87 | 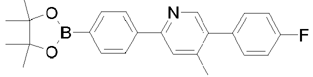 | 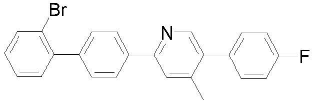 | 63 % |
| | B79 | | |
| B88 | 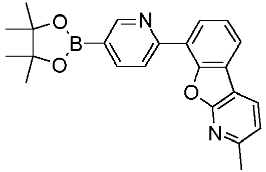 | 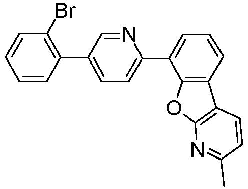 | 70 % |
| | B68 | | |
| B89 | 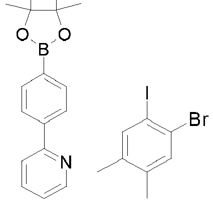 | 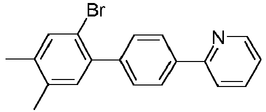 | 73 % |
| | [908350-80-1] /[96843-22-0] | | |
| B90 | 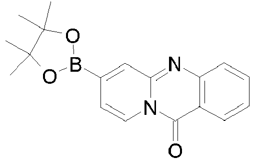 | 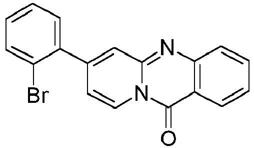 | 72 % |
| | B73 | | |
| B91 | 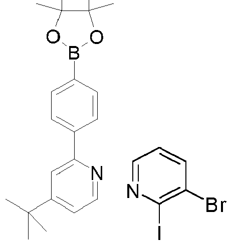 | 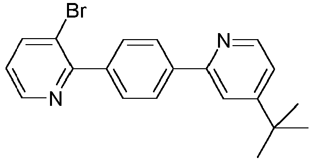 | 48% |
| | B70/ [408502-43-2] | | |
| B92 | 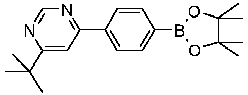 | 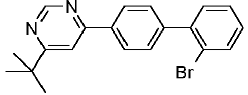 | 65% |
| | B74 | | |
| B93 | 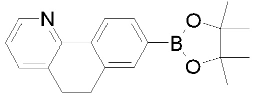 | 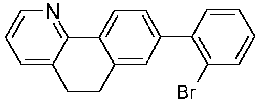 | 65 % |
| | B75 | | |
| B94 | 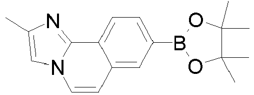 | 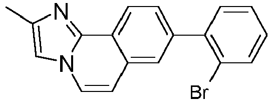 | 68% |
| | B76 | | |
| B95 | 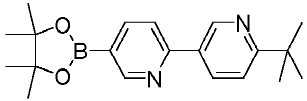 | 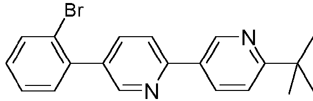 | 77% |
| | B69 | | |
| B96 | 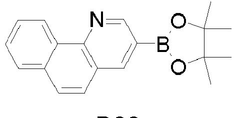 | 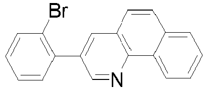 | 70% |
| | B63 | | |
| B97 | 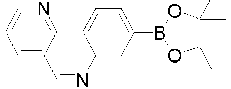 | 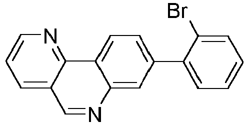 | 66% |
| | B66 | | |
| B98 | 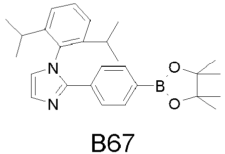 | 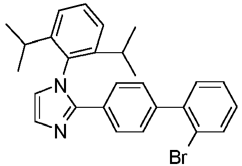 | 71% |
| | | | |
| B99 | 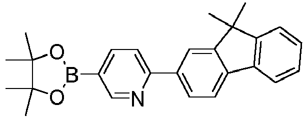 | 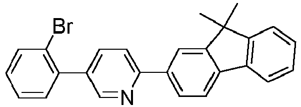 | 64% |
| | B52 | | |
| B100 | 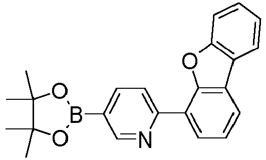 | 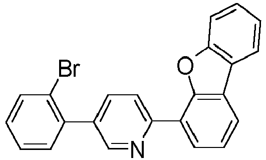 | 58 % |
| | B53 | | |
| B101 | 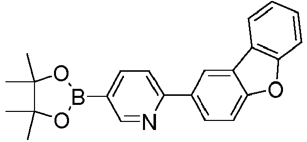 | 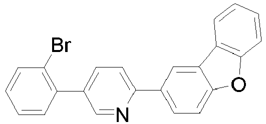 | 62 % |
| | B54 | | |
| B102 | 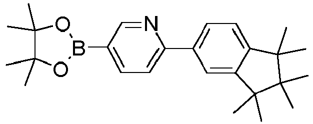 | 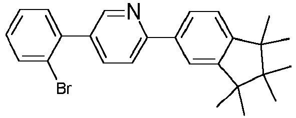 | 75% |
| | B48 | | |
| B103 | 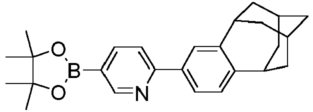 | 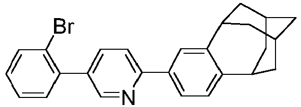 | 78 % |
| | B57 | | |
| B104 | 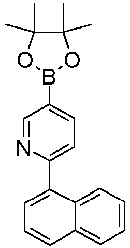 | 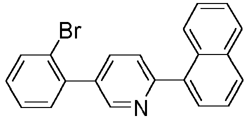 | 82 % |
| | B60 | | |
| B201 | 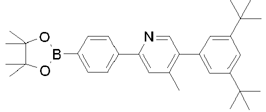 | 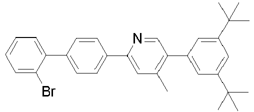 | 74 % |
| | B200 | | |

### Beispiel B106:

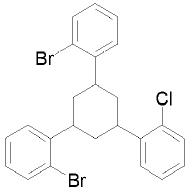

a) 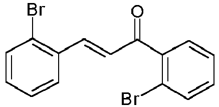
   Darstellung gemäß G. Markopoulos et al., Angew. Chem., Int. Ed., 2012, 51, 12884.
b) 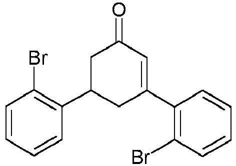
   Durchführung nach JP 2000-169400. Eine Lösung von 36.6 g (100 mmol) 1,3-Bis(2-bromphenyl)-2-propen-1-on [126824-93-9], Stufe a) in 300 ml trockenem Aceton wird portionsweise mit 5.7 g (105 mmol) Natriummethanolat versetzt und dann 12 h bei 40 °C gerührt. Man entfernt das Lösungsmittel im Vakuum, nimmt den Rückstand in Ethylacetat auf, wäscht dreimal mit je 200 ml Wasser, zweimal mit je 200 ml gesättigter Kochsalzlösung und trocknet über Magnesiumsulfat. Das nach Entfernen das Lösungsmittels im Vakuum erhaltene Öl wird Flash-chromatographiert (Torrent CombiFlash, Fa. Axel Semrau). Ausbeute: 17.9 g (44 mmol), 44 %. Reinheit: ca. 97 %ig n. ¹H-NMR.
c) 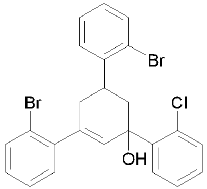
   Zu einer Lösung von 2-Chlor-phenylmagnesiumbromid (200 mmol) [36692-27-0] in 200 ml Di-n-butylether fügt man bei 0 °C 2.4 g (2.4 mmol) wasserfreies Kupfer(I)chlorid [7758-89-6] zu und rührt 30 min. nach. Dann tropft man eine Lösung von 40.6 g (100 mmol) Stufe b) in 200 ml Toluol während 30 min. zu und rührt 5 h bei 0 °C nach. Man quencht die Reaktionsmischung durch vorsichtige Zugabe von 100 ml Wasser und dann mit 220 ml 1N Salzsäure. Man trennt die organische Phase ab, wäscht diese zweimal mit je 200 ml Wasser, einmal mit 200 ml gesättigter Natriumhydrogencarbonat-Lösung, einmal mit 200 ml gesättigter Kochsalzlösung und trocknet über Magnesiumsulfat. Das nach Entfernen das Lösungsmittels im Vakuum erhaltene Öl wird mit Toluol über Kieselgel filtriert. Das so erhaltene Rohprodukt wird ohne weitere Reinigung weiter umgesetzt. Ausbeute: 49.8 g (96 mmol), 96 %. Reinheit: ca. 90-95 %ig n. ¹H-NMR.
d) 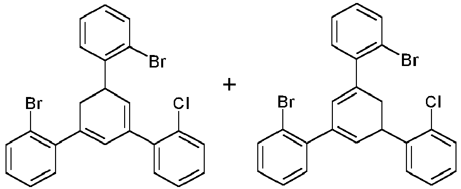
   Eine auf 0 °C gekühlte Lösung von 51.9 g (100 mmol) Stufe c) in 500 ml Dichlormethan (DCM) wird mit 1.0 ml Trifluormethansulfonsäure und dann portionsweise mit 50 g Phosphorpentoxid versetzt. Man lässt auf Raumtemperatur erwärmen und rührt 2 h nach. Man dekantiert vom Phosphorpentoxid ab, schlämmt dieses in 200 ml DCM auf und dekantiert erneut ab. Die vereinigten DCM-Phasen werden zweimal mit Wasser und einmal mit gesättigter Kochsalzlösung gewaschen und über Magnesiumsulfat getrocknet. Das nach Entfernen des Lösungsmittels im Vakuum erhaltene Wachs wird Flash-chromatographiert (Torrent CombiFlash, Fa. Axel Semrau). Ausbeute: 31.5 g (63 mmol), 63 %, Isomerengemisch. Reinheit: ca. 90-95 %ig n. ¹H-NMR.
e) 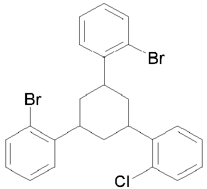
   Ein Gemisch aus 25.0 g (50 mmol) Stufe d), 2 g Pd/C (10 %), 200 ml Methanol und 300 ml Ethylacetat wird im Rührautoklaven mit 3 bar Wasserstoff beaufschlagt und bei 30 °C bis zur beendeten Wasserstoffaufnahme hydriert. Man filtriert über ein mit Ethylacetat vorgeschlämmtes Celtite-Bett ab, engt das Filtrat zur Trockene ein. Das so erhaltene Öl wird Flash-chromatographiert (Torrent CombiFlash, Fa. Axel Semrau). Ausbeute: 17.2 g (34 mmol), 68 %. Reinheit: ca. 95 %ig n. ¹H-NMR, cis, cis-Isomer.

Analog können folgende Verbindungen hergestellt werden.

| Bsp. | Edukte sofern von B106 abweichend | Produkt | Ausbeute a) bis e) |
|---|---|---|---|
| B107 | 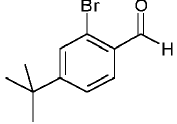 | 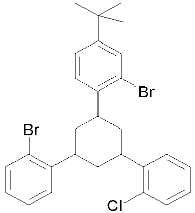 | 21 % |
| | [246139-77-5] | | |
| B108 | [246139-77-5] + [147438-85-5] | 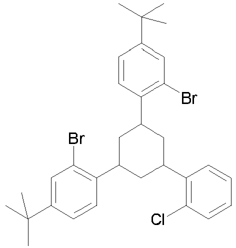 | 19 % |
| | 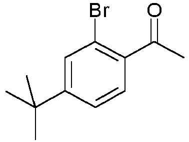 | | |
| B109 | [246139-77-5] + [147438-85-5] | 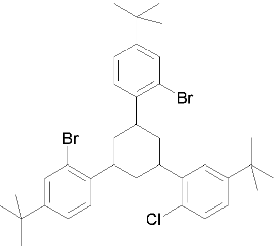 | 14 % |
| | 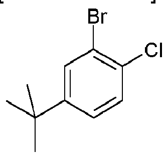 | | |

### Beispiel B110:

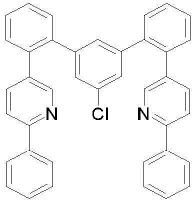

Ein Gemisch aus 36.4 g (100 mmol) 2,2'-(5-chloro-1,3-phenylen)-bis-[4,4,5,5-tetramethyl-1,3,2-dioxaborolan [1417036-49-7], 65.2 g (210 mmol) B80, 42.4 g (400 mmol) Natriumcarbonat, 1.57 g (6 mmol) Triphenylphosphin, 500 mg (2 mmol) Palladium(II)acetat, 500 ml Toluol, 200 ml Ethanol und 500 ml Wasser wird 48 h unter Rückfluss erhitzt. Nach Erkalten wird mit 500 ml Toluol erweitert, die organische Phase wird abgetrennt, einmal mit 500 ml Wasser, einmal mit 500 ml gesättigter Kochsalzlösung gewaschen und über Magnesiumsulfat getrocknet. Nach Entfernen des Lösungsmittels wird der Rückstand an Kieselgel (n-Heptan/Ethylacetat 2:1 vv) chromatographiert. Ausbeute: 41.4 g (68 mmol), 68 %. Reinheit: ca. 95 %ig nach ¹H-NMR.

Analog können folgende Verbindungen dargestellt werden, wobei zur Umkristallisation Lösemittel, wie z. B. Ethylacetat, Cyclohexan, Toluol, Acetonitril, n-Heptan, Ethanol oder Methanol verwendet werden können. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Bromid | Produkt | Ausbeute |
|---|---|---|---|
| B111 | 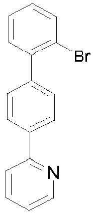 | 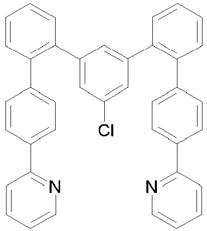 | 67 % |
| | B82 | | |
| B112 | 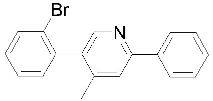 | 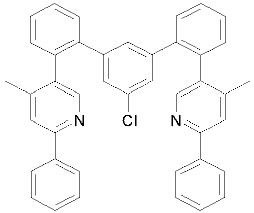 | 62% |
| | B81 | | |
| B113 | 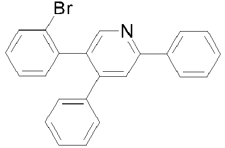 | 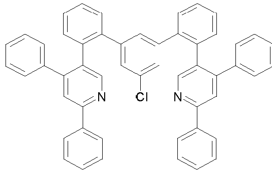 | 55% |
| | B83 | | |
| B114 | 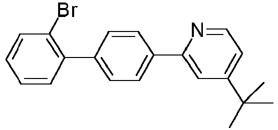 | 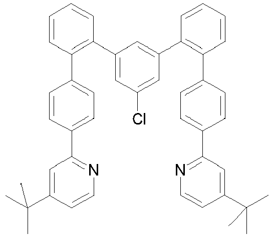 | 63% |
| | B84 | | |
| B115 | 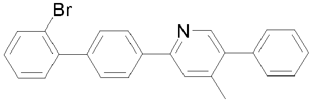 | 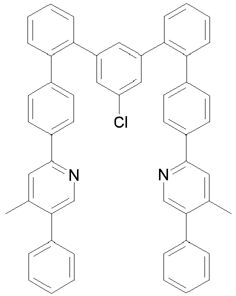 | 60% |
| | B85 | | |
| B116 | 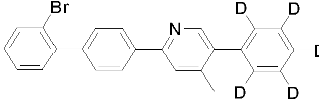 | 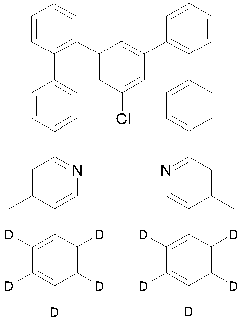 | 61% |
| | B86 | | |
| B117 | 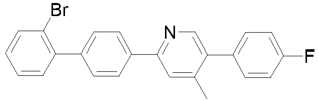 | 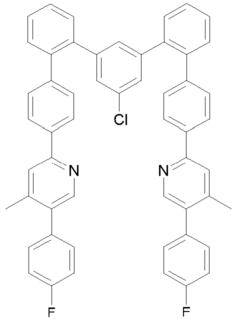 | 58% |
| | B87 | | |
| B118 | 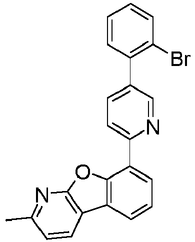 | 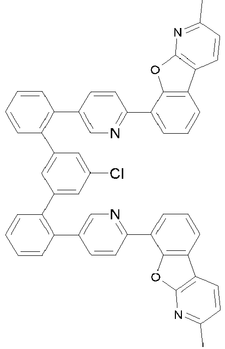 | 56% |
| | B88 | | |
| B119 | 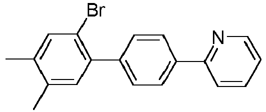 | 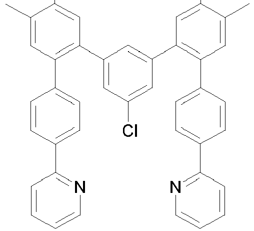 | 60% |
| | B89 | | |
| B120 | 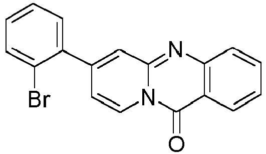 | 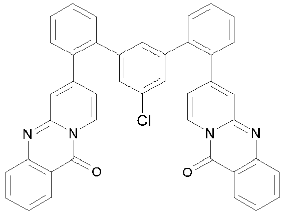 | 64% |
| | B90 | | |
| B121 | 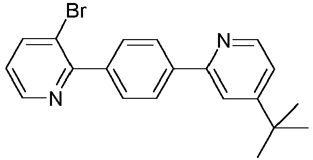 | 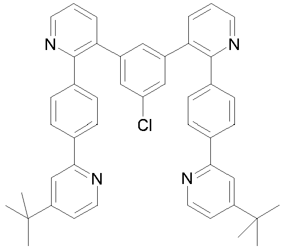 | 60% |
| | B91 | | |
| B202 | 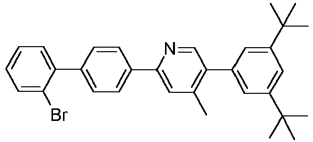 | 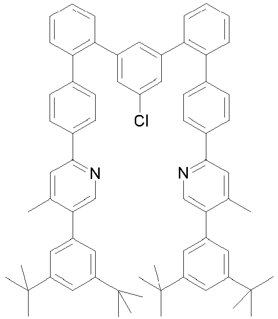 | 65% |
| | B201 | | |

### Beispiel B122:

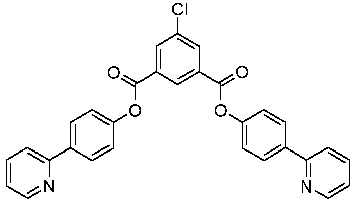

Ein Gemisch aus 17.1 g (100 mmol) 4-(2-Pyridyl)phenol [51035-40-6] und 12.9 g (100 mmol) Diisopropylethylamin [7087-68-5] wird in 400 mL Dichlormethan für 10 min bei Raumtemperatur gerührt. Es werden 6.2 mL (40 mmol) 5-Chloroisophthaloyl-dichlorid, gelöst in 30 mL Dichlormethan, zugetropft und die Reaktionsmischung wird für 14 h bei Raumtemperatur gerührt. Anschließend werden 10 mL Wasser zugetropft und die Reaktionsmischung in einen Scheidetrichter überführt. Die organische Phase wird zweimal mit 100 mL Wasser und einmal mit 50 mL gesättigter NaCl-Lösung gewaschen, über Natriumsulfat getrocknet und zur Trockene eingeengt. Ausbeute: 18.0 g (38 mmol), 95 %. Reinheit: ca. 95 %ig nach ¹H-NMR.

Analog können folgende Verbindungen hergestellt werden. Die Stoffmengen der eingesetzten Edukte sind angegeben, falls sie von den in der Durchführung zu B122 beschriebenen abweichen:

| Bsp. | Alkohol od. Amin Säurechlorid Reaktionszeit | Produkt | Ausbeute |
|---|---|---|---|
| B123 | 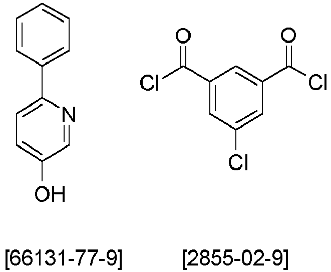 | 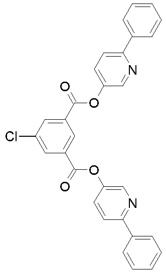 | 90 % |
| | 12 h | | |
| B124 | 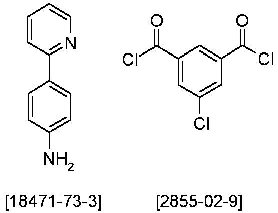 | 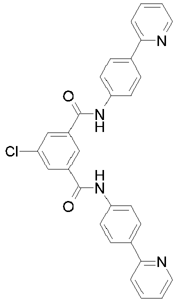 | 96% |
| | 1 h | | |
| B125 | 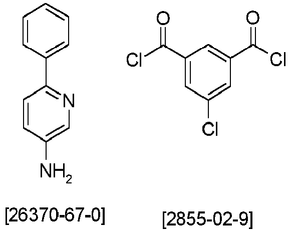 | 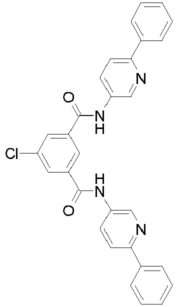 | 88% |
| | 0.5 h | | |
| B126 | 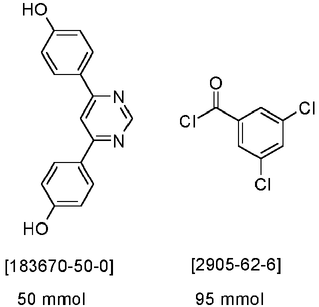 | 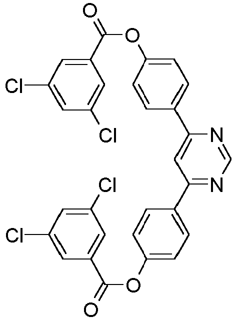 | 75% |
| | 24 h | | |
| B127 | 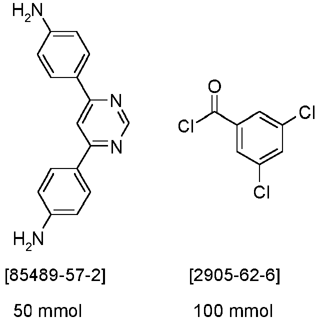 | 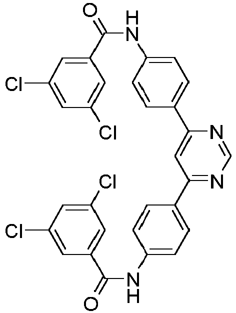 | 82% |
| | 2 h | | |
| B128 | 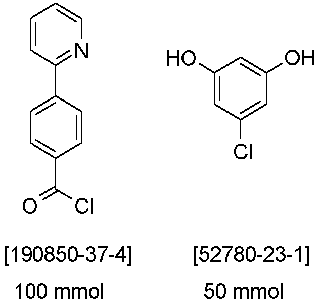 | 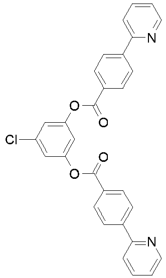 | 76% |
| | 14 h, Rückfluss | | |
| B129 | 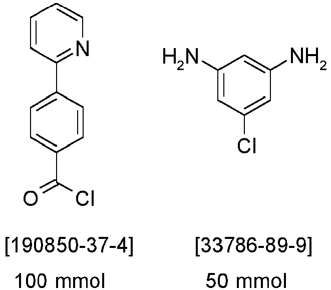 | 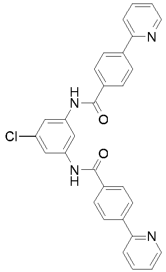 | 80% |
| | 10 h | | |
| B130 | 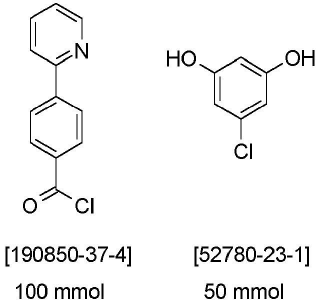 | 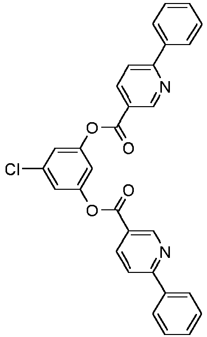 | 73% |
| | 18 h, Rückfluss | | |
| B131 | 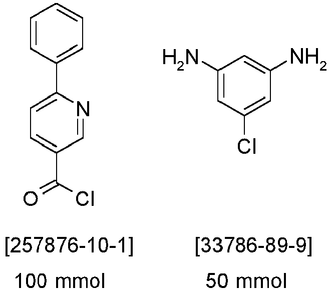 | 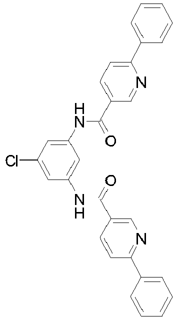 | 78% |
| | 5 h | | |

### Beispiel B132:

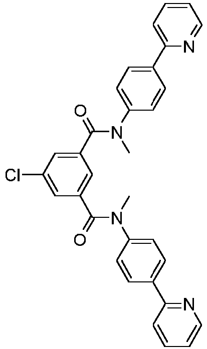

2.0 g (50 mmol) Natriumhydrid (60%ige Dispersion in Paraffinöl) [7646-69-7] werden in 300 mL THF suspensiert, dann werden 5.0 g (10 mmol) B124 zugegeben und die Suspension für 30 Minuten bei Raumtemperatur gerührt. Anschließend werden 1.2 mL lodmethan (50 mmol) [74-88-4] zugegeben und die Reaktionsmischung für 50 h bei Raumtemperatur gerührt. Es werden 20 mL konz. Ammoniaklösung zugegeben, 30 Minuten nachgerührt und das Lösungsmittel weitgehend im Vakuum abgezogen. Man nimmt den Rückstand in 300 ml Dichlormethan auf, wäscht einmal mit 200 ml 5 Gew.-%igem Ammoniakwasser, zweimal mit je 100 ml Wasser, einmal mit 100 ml gesättigter Kochsalzlösung und trocknet dann über Magnesiumsulfat. Man entfernt das Dichlormethan im Vakuum und kristallisiert das Rohprodukt aus Ethylacetat/Methanol um. Ausbeute: 4.3 g (8 mmol), 80 %. Reinheit: ca. 98 % n. ¹H-NMR.

Analog können folgende Verbindungen dargestellt werden:

| Bsp. | Edukt | Produkt | Ausbeute |
|---|---|---|---|
| B133 | 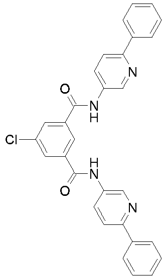 | 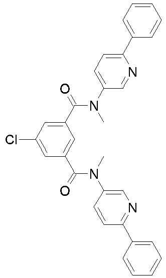 | 70% |
| | B125 | | |
| B134 | 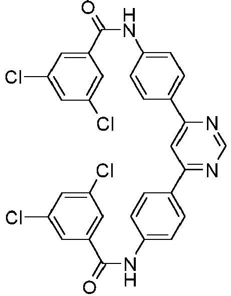 | 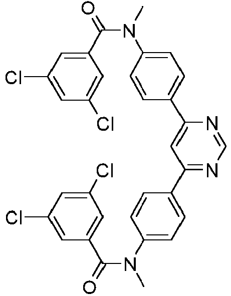 | 75% |
| | B127 | | |
| B135 | 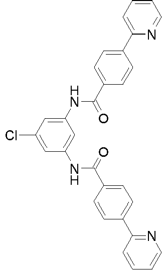 | 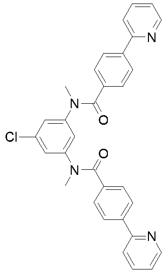 | 69% |
| | B129 | | |
| B136 | 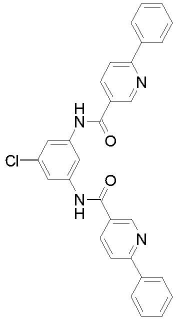 | 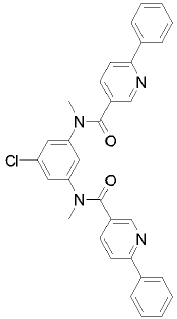 | 72% |
| | B131 | | |

### Beispiel B137:

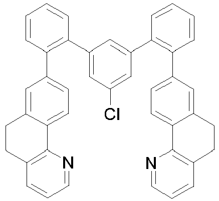

Ein Gemisch aus 36.4 g (100 mmol) 2,2'-(5-chloro-1,3-phenylen)bis-[4,4,5,5-tetramethyl-1,3,2-dioxaborolan [1417036-49-7], 70.6 g (210 mmol) B93, 42.4 g (400 mmol) Natriumcarbonat, 2.3 g (2 mmol) Tetrakis(triphenylphosphin)palladium(0), 1000 ml 1,2-Dimethoxyethan und 500 ml Wasser wird 48 h unter Rückfluss erhitzt. Nach Erkalten wird der ausgefallene Feststoff abgesaugt und zweimal mit 20 mL Ethanol gewaschen. Der Feststoff wird in 500 mL Dichlormethan gelöst und über ein Celitebett filtriert. Das Filtrat wird bis auf 100 mL eingeengt, dann werden 400 mL Ethanol zugegeben und der ausgefallene Feststoff abgesaugt. Das Rohprodukt wird einmal aus Ethylacetat umkristallisiert. Ausbeute: 43.6 g (70 mmol), 70 %. Reinheit: ca. 96 %ig nach ¹H-NMR.

Analog können folgende Verbindungen dargestellt werden, wobei zur Umkristallisation Lösemittel, wie z. B. Ethylacetat, Cyclohexan, Toluol, Acetonitril, n-Heptan, Ethanol oder Methanol verwendet werden können. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Edukt | Produkt | Ausbeute |
|---|---|---|---|
| B138 | 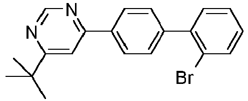 | 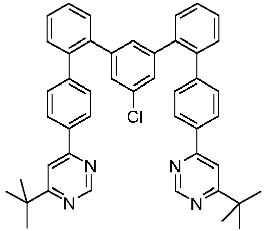 | 64% |
| | B92 | | |
| B139 | 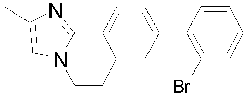 | 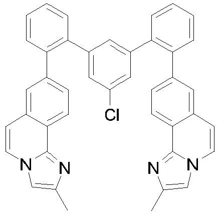 | 54% |
| | B94 | | |
| B140 | 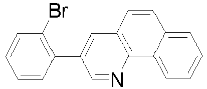 | 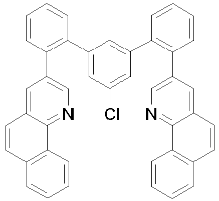 | 75% |
| | B96 | | |
| B141 | 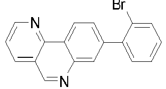 | 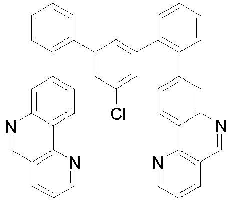 | 71% |
| | B97 | | |
| B142 | 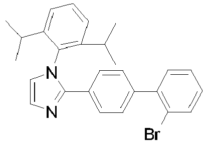 | 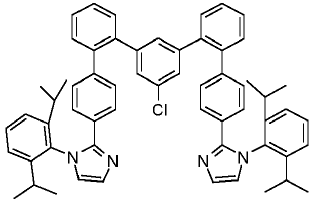 | 58% |
| | B98 | | |
| B143 | 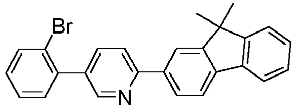 | 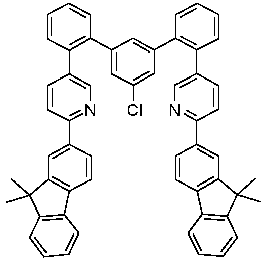 | 60% |
| | B99 | | |
| B144 | 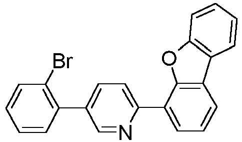 | 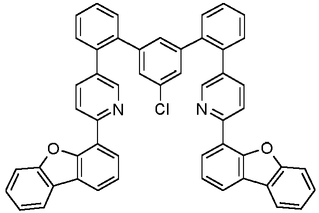 | 66% |
| | B100 | | |
| B145 | 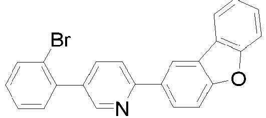 | 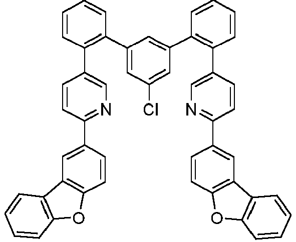 | 70 % |
| | B101 | | |
| B146 | 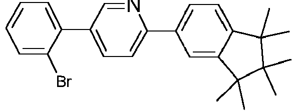 | 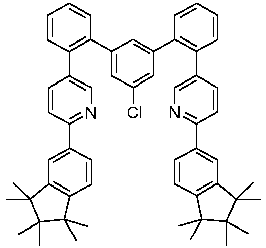 | 70% |
| | B102 | | |
| B147 | 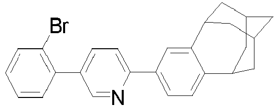 | 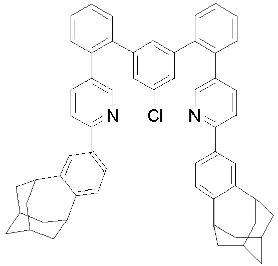 | 63% |
| | B103 | | |
| B148 | 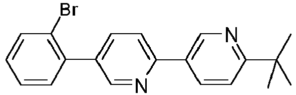 | 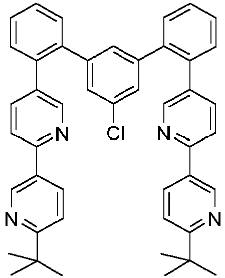 | 60% |
| | B95 | | |
| B149 | 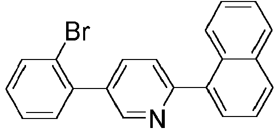 | 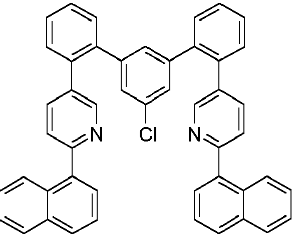 | 61% |
| | B104 | | |
| B150 | 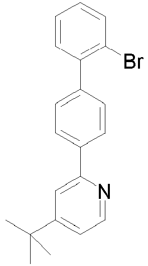 | 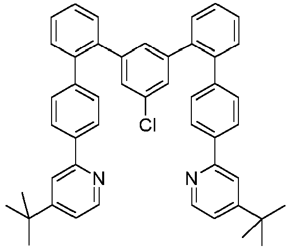 | 58% |
| | B105 | | |

### Beispiel B151

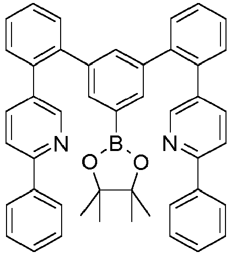

Ein Gemisch aus 57.1 g (100 mmol) B110, 25.4 g (100 mmol) Bis(pinaco-lato)diboran [73183-34-3], 49.1 g (500 mmol) Kaliumacetat, 2 mmol S-Phos [657408-07-6] und 1 mmol Palladium(II)acetat, 200 g Glaskugeln (3 mm Durchmesser), 700 ml 1,4-Dioxan wird 16 h unter Rühren unter Rückfluss erhitzt. Nach Abkühlen wird die Suspension über ein Celite-Bett filtriert und das Lösemittel im Vakuum entfernt. Der schwarze Rückstand wird mit 1000 ml heißem Ethylacetat digeriert, es wird noch heiß über ein Celite-Bett abfiltriert, dann auf ca. 200 ml eingeengt, wobei das Produkt zu kristallisieren beginnt. Die Kristallisation wird über Nacht im Kühlschrank vervollständigt, die Kristalle werden abfiltriert und mit wenig Ethylacetat gewaschen. Aus der Mutterlauge kann eine zweite Produktfraktion gewonnen werden. Ausbeute: 31.6 g (78 mmol), 78 %. Reinheit: ca. 95 %ig n. ¹H-NMR.

Analog können folgende Verbindungen dargestellt werden. Anstelle von Ethylacetat können auch Toluol, n-Heptan, Cyclohexan oder Acetonitril zur Umkristallisatoin oder bei schlecht löslichen zur Heißextraktion verwendet werden.

| Bsp. | Bromid | Produkt | Ausbeute |
|---|---|---|---|
| B152 | 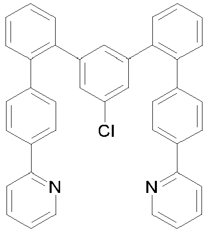 | 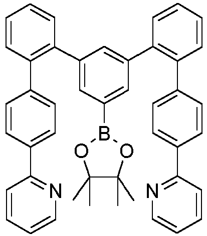 | 80% |
| | B111 | | |
| B153 | 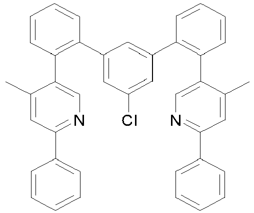 | 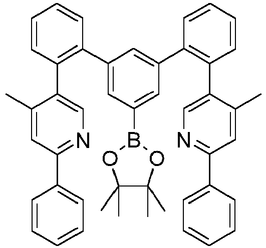 | 84% |
| | B112 | | |
| B154 | 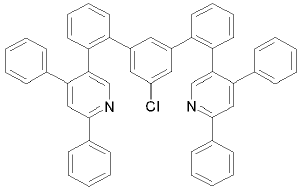 | 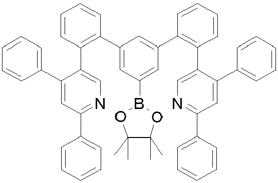 | 71% |
| | B113 | | |
| B155 | 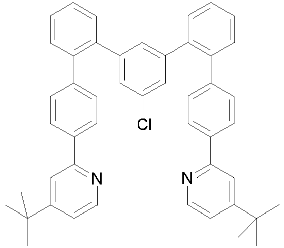 | 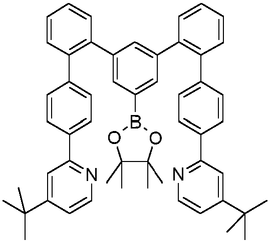 | 80% |
| | B114 | | |
| B156 | 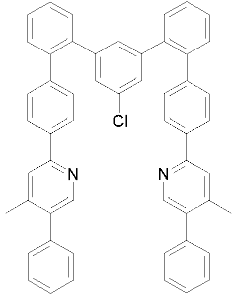 | 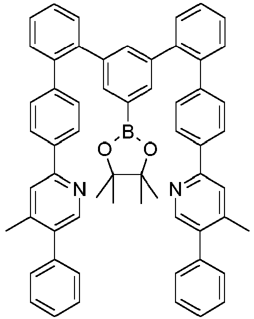 | 85% |
| | B115 | | |
| B157 | 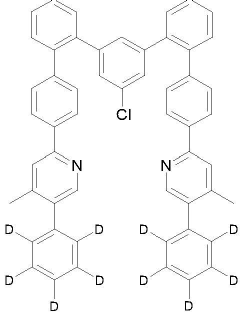 | 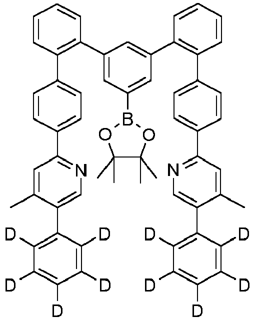 | 82% |
| | B116 | | |
| B158 | 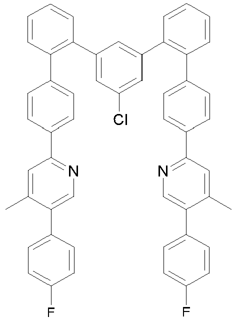 | 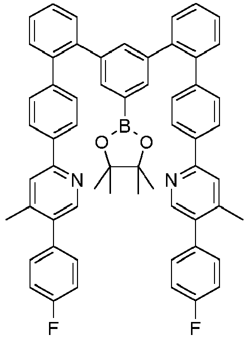 | 77% |
| | B117 | | |
| B159 | 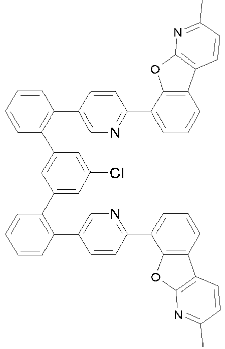 | 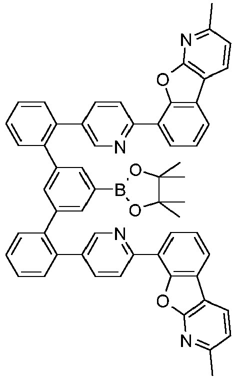 | 72% |
| | B118 | | |
| B160 | 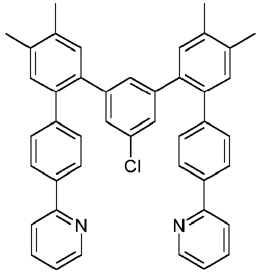 | 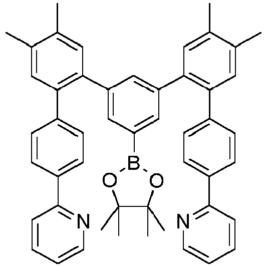 | 77% |
| | B119 | | |
| B161 | 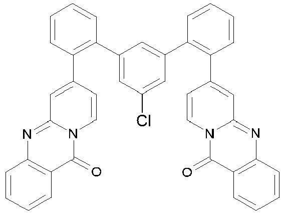 | 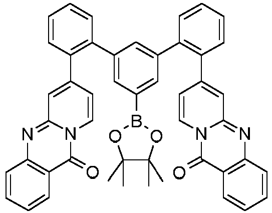 | 80% |
| | B120 | | |
| B162 | 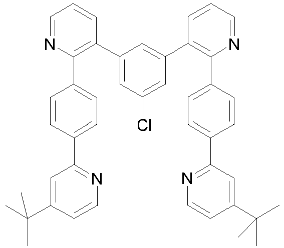 | 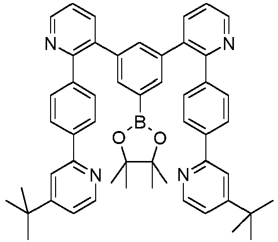 | 81% |
| | B121 | | |
| B163 | 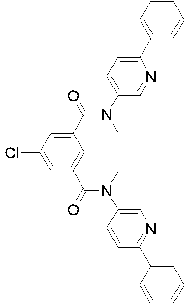 | 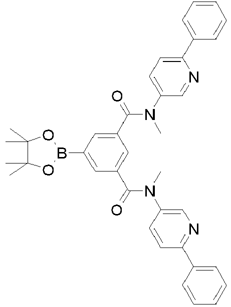 | 88% |
| | B133 | | |
| B164 | 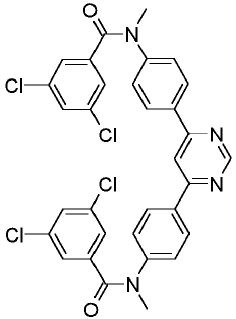 | 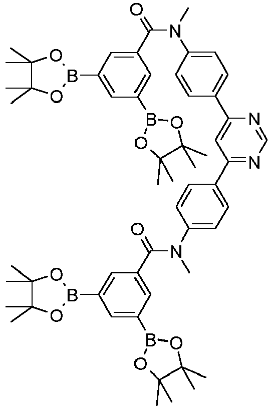 | 55% |
| | B134 4.1 Äquiv. Boronester, 4 mmol S-Phos, 2 mmol Pd(OAc)₂ | | |
| B165 | 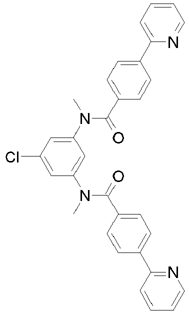 | 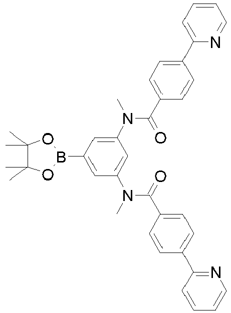 | 79% |
| | B135 | | |
| B166 | 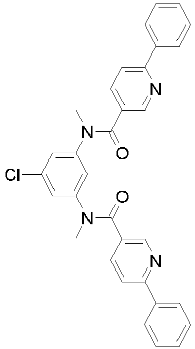 | 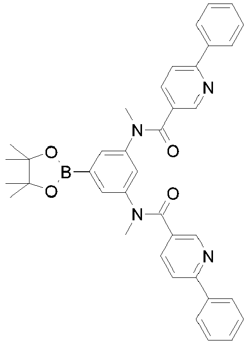 | 76% |
| | B136 | | |
| B167 | 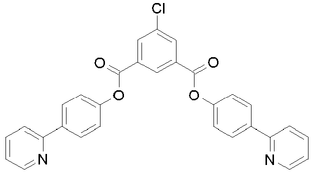 | 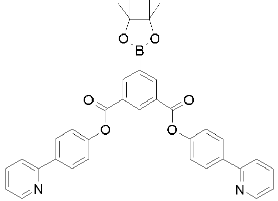 | 89% |
| | B122 | | |
| B168 | 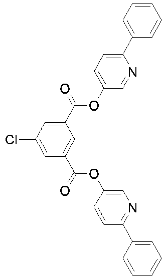 | 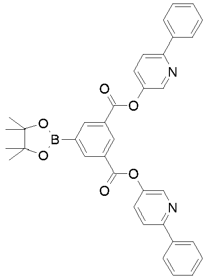 | 84% |
| | B123 | | |
| B169 | 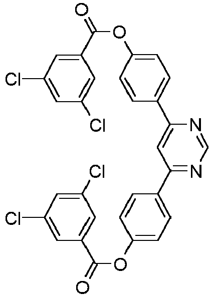 | 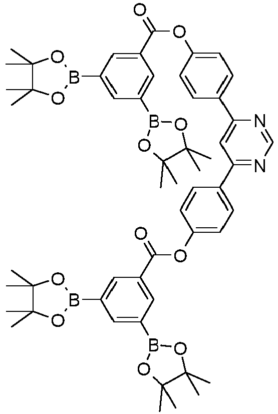 | 50% |
| | B126 4.1 Äquiv. Boronester, 4 mmol S-Phos, 2 mmol Pd(OAc)₂ | | |
| B170 | 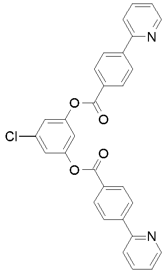 | 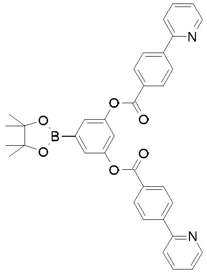 | 79% |
| | B128 | | |
| B171 | 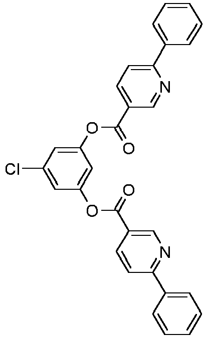 | 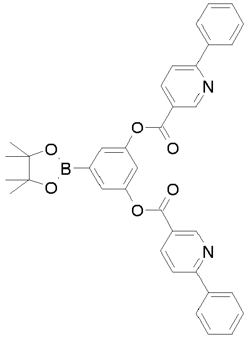 | 75% |
| | B130 | | |
| B172 | 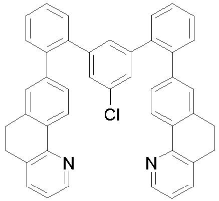 | 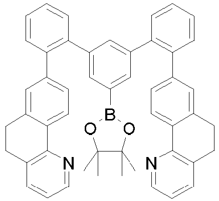 | 77% |
| | B137 | | |
| B173 | 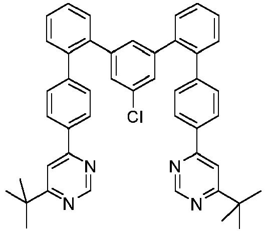 | 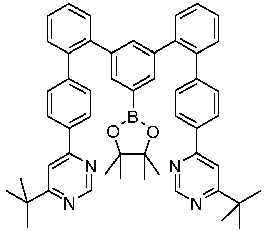 | 80% |
| | B138 | | |
| B174 | 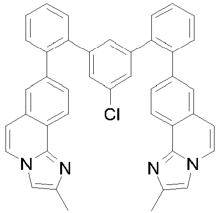 | 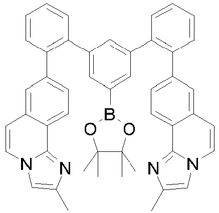 | 82% |
| | B139 | | |
| B175 | 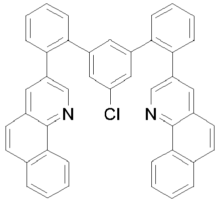 | 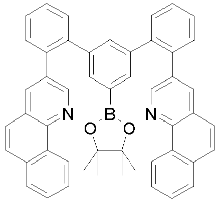 | 88% |
| | B50 | | |
| B176 | 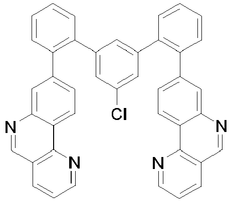 | 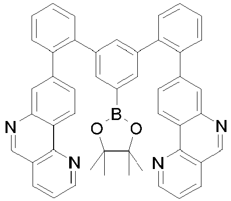 | 90% |
| | B141 | | |
| B177 | 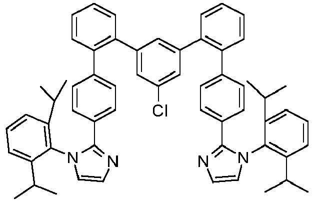 | 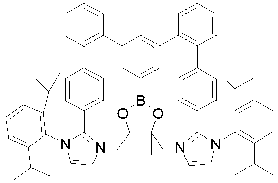 | 76% |
| | B142 | | |
| B178 | 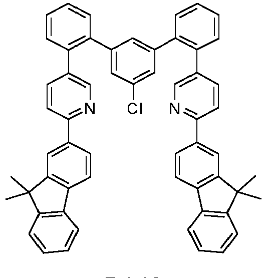 | 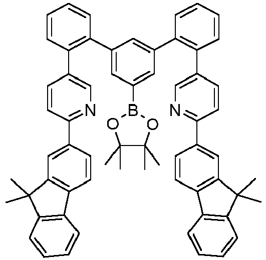 | 80% |
| | B143 | | |
| B179 | 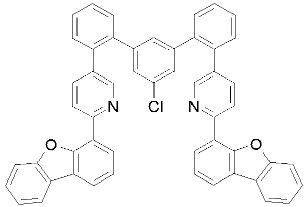 | 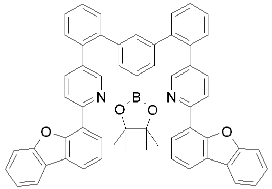 | 81% |
| | B144 | | |
| B180 | 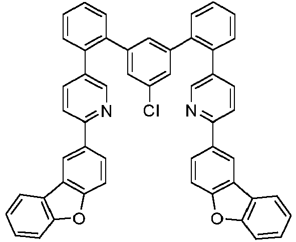 | 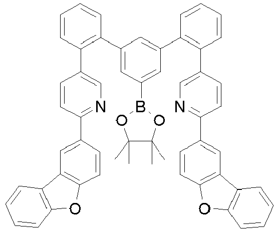 | 84 % |
| | B145 | | |
| B181 | 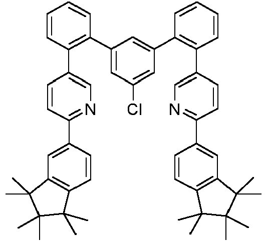 | 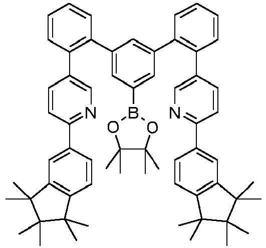 | 74% |
| | B146 | | |
| B182 | 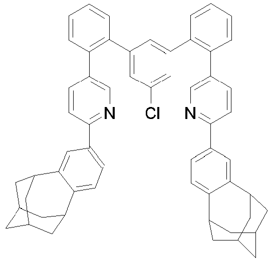 | 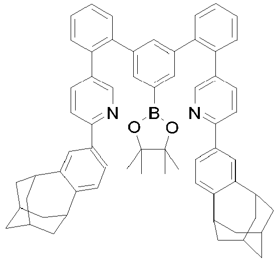 | 73% |
| | B147 | | |
| B183 | 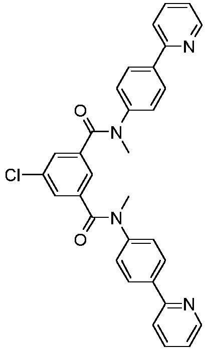 | 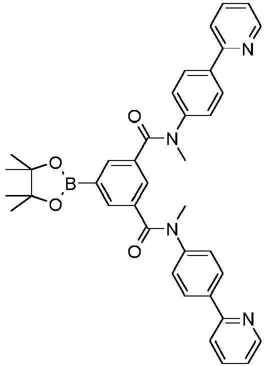 | 76% |
| | B132 | | |
| B184 | 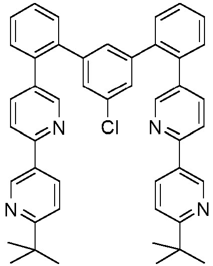 | 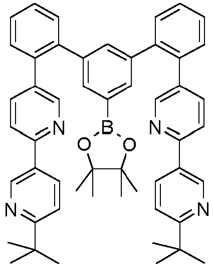 | 72% |
| | B148 | | |
| B185 | 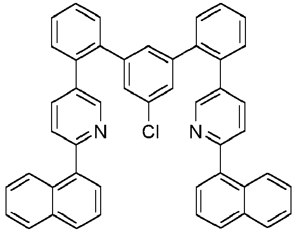 | 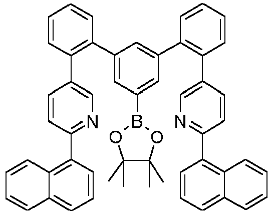 | 75% |
| | B149 | | |
| B203 | 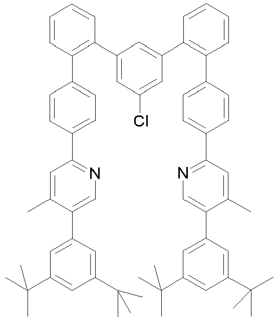 | 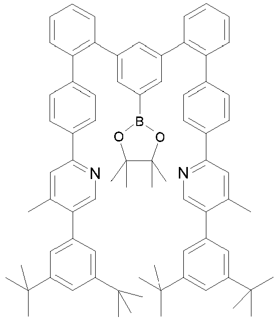 | 81% |
| | B202 | | |

### Beispiel B186:

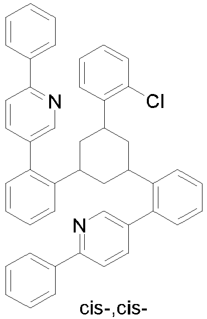

Ein Gemisch aus 54.5 g (100 mmol) B106, 59.0 g (210 mmol) 2-Phenyl-5-(4,4,5,5-tetramethyl-[1,3,2]dioxaborolan-2-yl)-pyridin [879291-27-7], 127.4 g (600 mmol) Trikaliumphosphat, 1.57 g (6 mmol) Triphenylphosphin und 449 mg (2 mmol) Palladium(II)acetat in 750 ml Toluol, 300 ml Dioxan und 500 ml Wasser wird 30 h unter Rückfluss erhitzt. Nach dem Erkalten trennt man die organische Phase ab, wäscht diese zweimal mit je 300 ml Wasser, einmal mit 300 ml gesättigter Kochsalzlösung und trocknet über Magnesiumsulfat. Man filtriert vom Magnesiumsulfat über ein mit Toluol vorgeschlämmtes Celite-Bett ab, engt das Filtrat im Vakuum zur Trockene ein und kristallisiert den verbliebenen Schaum aus Acetonitril / Ethylacetat um. Ausbeute: 41.8 g (64 mmol), 64 %. Reinheit: ca. 95 %ig n. ¹H-NMR.

Analog können folgende Verbindungen dargestellt werden

| Bsp. | Edukte | Produkt | Ausbeute |
|---|---|---|---|
| B187 | B106 | 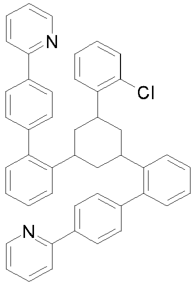 | 68 % |
| | 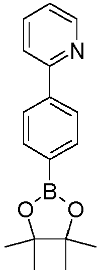 [908350-80-11 | | |
| B188 | B108 B70 | 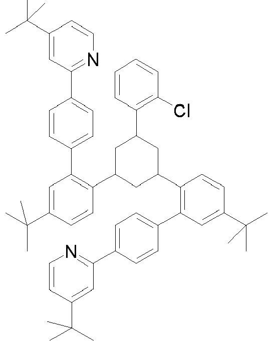 | 60 % |
| B189 | B108 B59 | 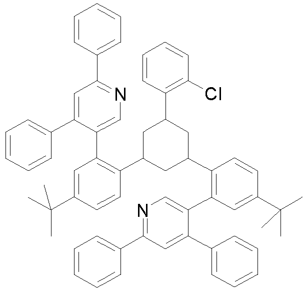 | 60 % |
| B190 | B108 B77 | 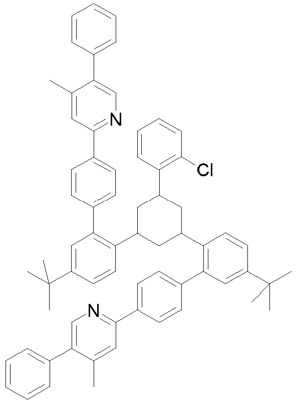 | 69 % |
| B191 | B109 B79 | 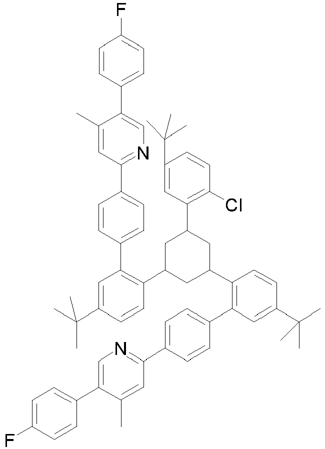 | 61 % |
| B192 | B107 B102 | 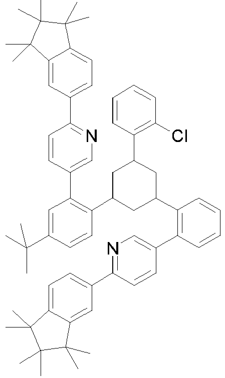 | 65% |

### Beispiel B193:

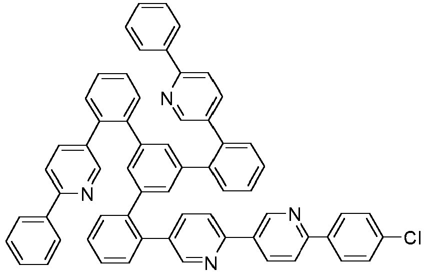

Ein Gemisch aus 42.1 g (100 mmol) B30, 66.3 g (100 mmol) B151, 31.8 g (300 mmol) Natriumcarbonat, 580 mg (2.6 mmol) Triphenylphosphin, 200 mg (0.88 mmol) Palladium(II)acetat, 500 ml Toluol, 250 ml Ethanol und 500 ml Wasser wird 26 h unter Rückfluss erhitzt. Nach Abkühlen wird der ausgefallene Feststoff abgesaugt und zweimal mit je 30 mL Ethanol gewaschen. Das Rohprodukt wird in 300 mL Dichlormethan gelöst und über ein Kieselgelbett filtriert. Das Kieselgelbett wird dreimal mit je 200 mL Dichlormethan/Ethylacetat 1:1 nachgewaschen. Das Filtrat wird zweimal mit Wasser und einmal mit gesättigter Kochsalzlösung gewaschen und über Natriumsulfat getrocknet. Das Dichlormethan wird am Rotationsverdampfer weitgehend abgezogen. Beim abrotieren des Dichlormethans fällt aus dem verbleibenden Ethylacetat ein Feststoff aus, dieser wird abgesaugt und mit Ethylacetat gewaschen. Das Rohprodukt wird nochmals aus Ethylacetat umkristallisiert. Ausbeute: 61.5 g (70 mmol), 70%. Reinheit: ca. 95 %ig n. ¹H-NMR.

### Beispiel B194:

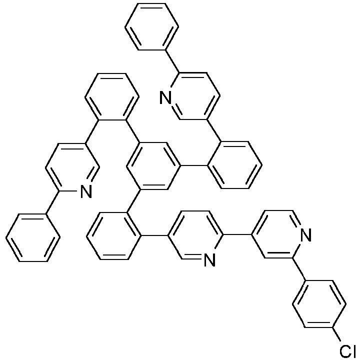

Durchführung analog zu der aus Beispiel B193, wobei statt B30 Baustein B31 verwendet wird. Ausbeute: 66%.

### Beispiel B195:

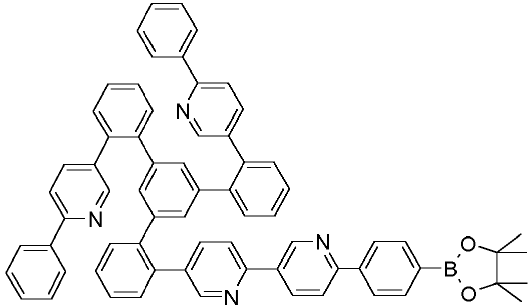

Ein Gemisch aus 87.7 g (100 mmol) B193, 25.4 g (100 mmol) Bis(pinaco-lato)diboran [73183-34-3], 49.1 g (500 mmol) Kaliumacetat, 2 mmol S-Phos [657408-07-6], 1 mmol Palladium(II)acetat, 100 g Glaskugeln (3 mm Durchmesser), 700 ml 1,4-Dioxan wird 16 h unter Rückfluss erhitzt. Nach Abkühlen wird die Suspension über ein Celite-Bett filtriert, das Celite 3x mit je 200 ml Dioxan nachgewaschen und das Lösemittel im Vakuum entfernt. Der schwarze Rückstand wird mit 1000 ml Ethylacetat digeriert, es wird noch heiß über ein Celite-Bett abfiltriert, dann auf ca. 200 ml eingeengt, wobei das Produkt zu kristallisieren beginnt. Die Kristallisation wird über Nacht im Kühlschrank vervollständigt, die Kristalle werden abfiltriert und mit wenig Ethylacetat gewaschen. Aus der Mutterlauge kann eine zweite Produktfraktion gewonnen werden. Ausbeute: 72.7 g (75 mmol), 75 %. Reinheit: ca. 97 %ig n. ¹H-NMR.

### Beispiel B196:

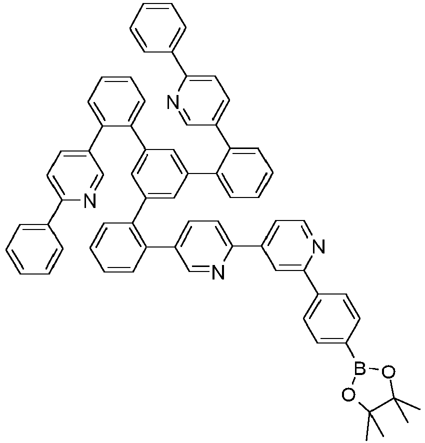

Durchführung analog zu der aus Beispiel B195. Statt B193 wird B194 eingestzt. Ausbeute: 80%.

### Beispiel B197:

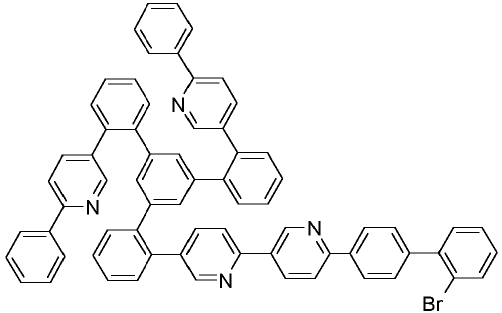

Ein Gemisch aus 48.5 g (50 mmol) B195, 14.1 g (50 mmol) 1-Brom-2-iodbenzol [583-55-1], 31.8 g (300 mmol) Natriumcarbonat, 2.3 g (2 mmol) Tetrakis(triphenylphosphin)palladium(0) [14221-01-3], 500 ml 1,2-Dimethoxyethan und 250 mL Wasser wird 60 h unter Rückfluss erhitzt. Nach dem Abkühlen wird der ausgefallene Feststoff abgesaugt und dreimal mit 100 mL Ethanol gewaschen. Das Rohprodukt wird in 300 mL Dichlormethan gelöst und über ein mit Dichlormethan vorgeschlämmtes Kieselgel-Bett filtriert. Das Kieselgel wird dreimal mit je 200 mL Ethylacetat nachgewaschen. Das Dichlorchmethan wird am Rotationsverdampfer bis 500 mbar bei 50 °C Badtemperatur abrotiert. Beim Abrotieren des Dichlormethans fällt aus dem verbleibenden Ethylacetat ein Feststoff aus, dieser wird abgesaugt und mit Ethylacetat gewaschen. Der erhaltene Feststoff wird nochmals aus Ethylacetat in der Siedehitze umkristallisiert. Ausbeute 31.9 g (32 mmol), 64%; Reinheit 95%ig nach ¹H-NMR.

### Beispiel B198:

Durchführung analog zu Beispiel B197. Ausbeute: 60%.

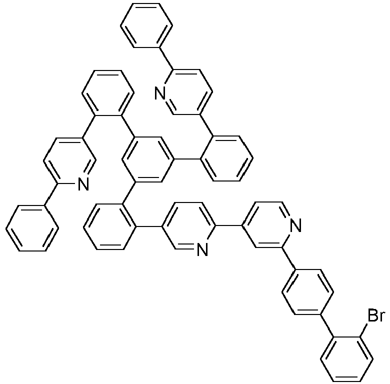

### B: Synthese der Liganden:

### Beispiel L1:

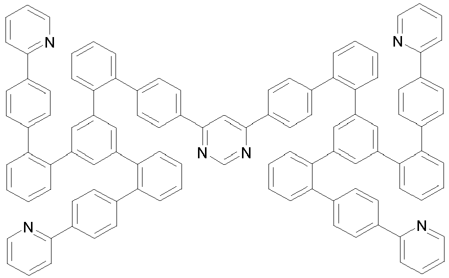

Ein Gemisch aus 7.9 g (14.5 mmol) B20, 20.2 g (30.5 mmol) B152, 63.7 g (87 mmol) Natriumcarbonat, 340 mg (1.3 mmol) Triphenylphosphin, 98 mg (0.44 mmol) Palladium(II)acetat, 200 ml Toluol, 100 ml Ethanol und 200 ml Wasser wird 40 h unter Rückfluss erhitzt. Nach Abkühlen wird der ausgefallene Feststoff abgesaugt und zweimal mit je 30 mL Ethanol gewaschen. Das Rohprodukt wird in 300 mL Dichlormethan gelöst und über ein Kieselgelbett filtriert. Das Kieselgelbett wird dreimal mit je 200 mL Dichlormethan/Ethylacetat 1:1 nachgewaschen. Das Filtrat wird zweimal mit Wasser und einmal mit gesättigter Kochsalzlösung gewaschen und über Natriumsulfat getrocknet. Das Dichlormethan wird am Rotationsverdampfer weitgehend abgezogen. Beim abrotieren des Dichlormethans fällt aus dem verbleibenden Ethylacetat ein Feststoff aus, dieser wird abgesaugt und mit Ethylacetat gewaschen. Ausbeute: 12.5 g (8.6 mmol), 59 %. Reinheit: ca. 98 %ig n. ¹H-NMR.

Analog können folgende Verbindungen dargestellt werden, wobei zur Umkristallisation Lösemittel, wie z. B. Ethylacetat, Cyclohexan, Toluol, Acetonitril, n-Heptan, Ethanol, DMF, DMAC oder Methanol verwendet werden können. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Edukte | Produkt/Reaktionsbedingungen, falls abweichend | Ausbeute |
|---|---|---|---|
| L2 | B157 + B20 | 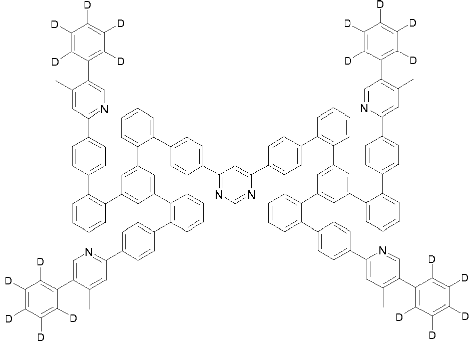 | 56% |
| L4 | B162 + B20 | 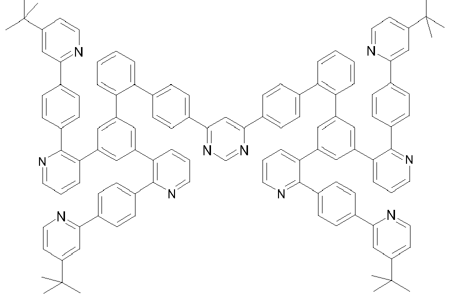 | 48% |
| L5 | B165 + B20 | 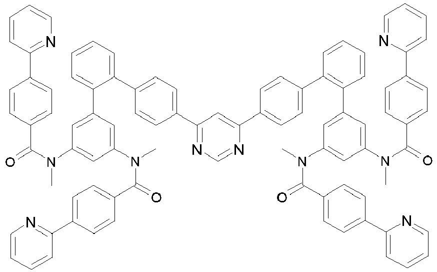 | 52% |
| L6 | B167 + B20 | 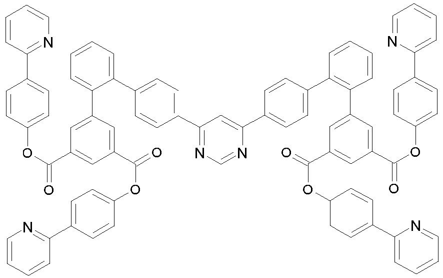 | 43% |
| L8 | B 170 + B20 | 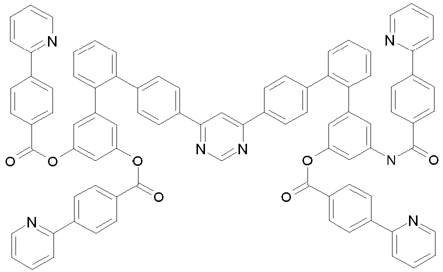 | 41% |
| L9 | B172 + B20 | 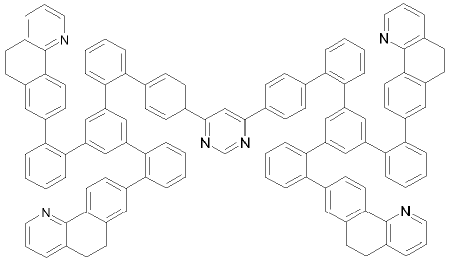 | 45% |
| L10 | B173 + B20 | 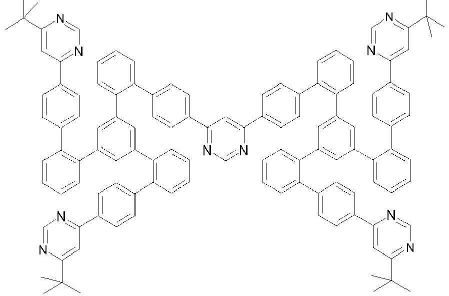 | 55% |
| L11 | B174 + B20 | 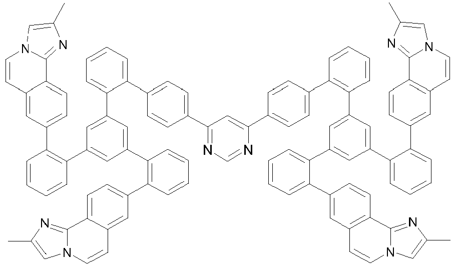 | 41% |
| L12 | B177 + B20 | 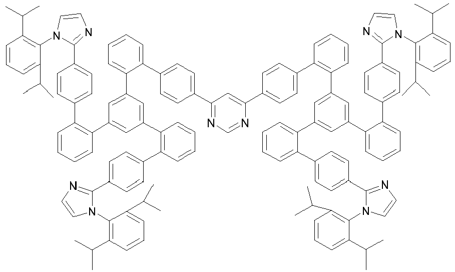 | 44% |
| L13 | B164 + B82 4.4 equiv B82, 12 eq. Base, 10 mol% Katalysator | 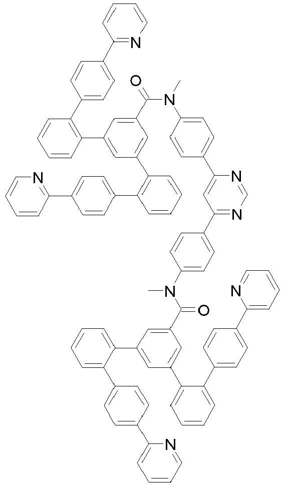 | 28% |
| L14 | B169 + B100 4.4 Equiv. B100, 12 Equiv. Base, 10 mol% Katalysator | 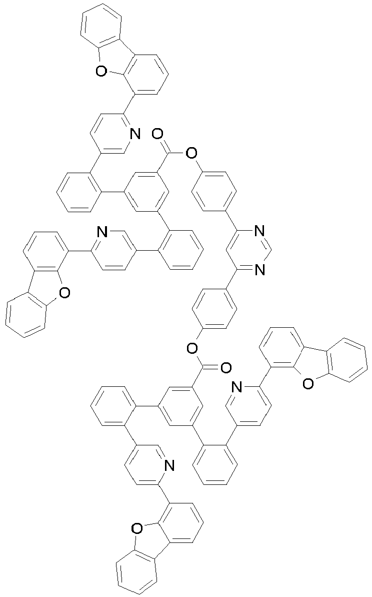 | 32% |
| L15 | B181 + B20 | 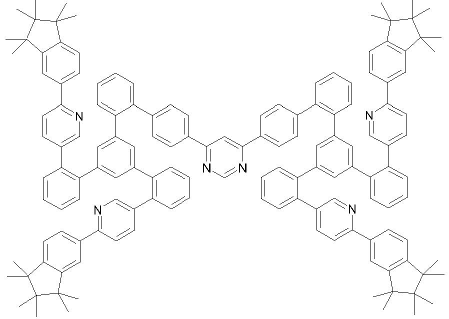 | 56% |
| L16 | B21 + B151 | 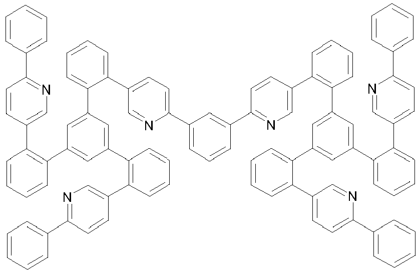 | 55% |
| L17 | B21 + B152 | 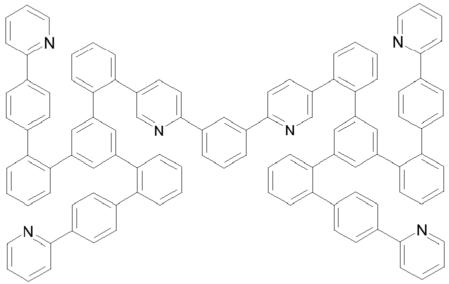 | 52% |
| L18 | B21 + B182 | 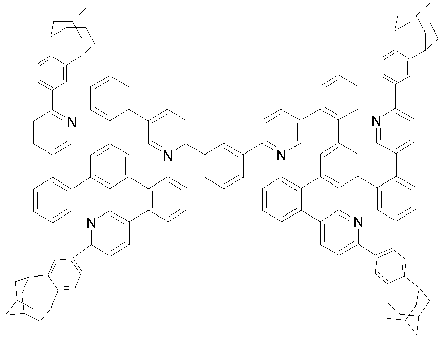 | 46% |
| L19 | B21 + B178 | 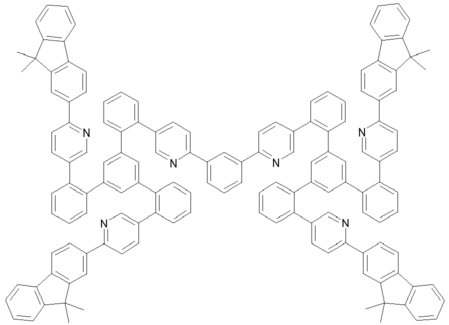 | 48% |
| L20 | S8 + B159 | 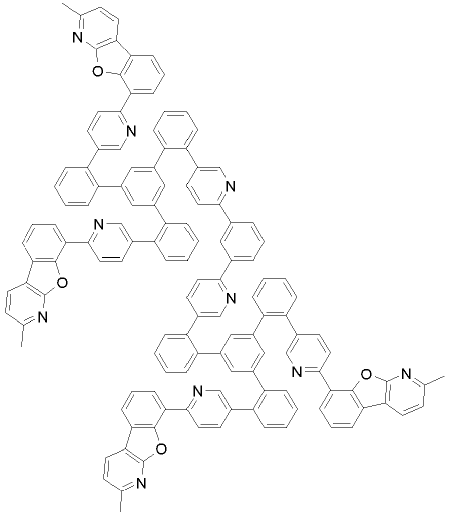 | 45% |
| L21 | B21 + B163 | 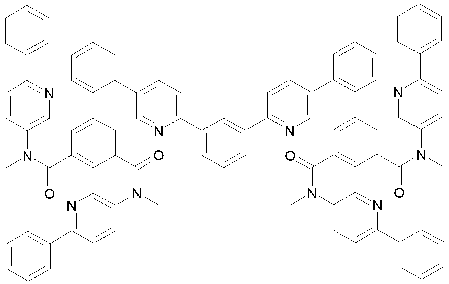 | 50% |
| L22 | B21 + B171 | 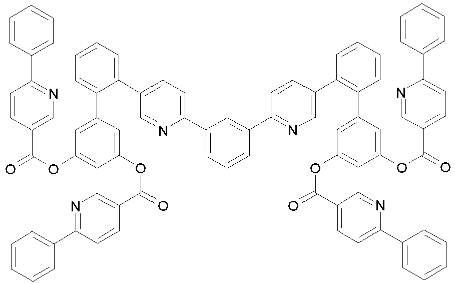 | 52% |
| L23 | B22 + B152 | 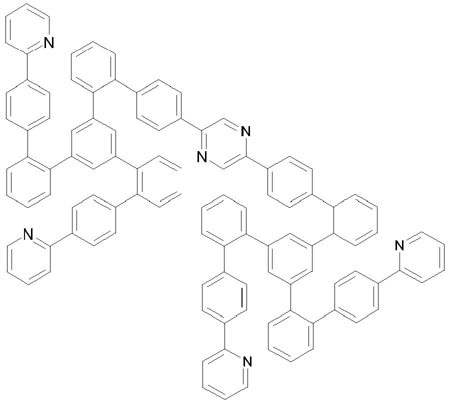 | 55% |
| L24 | B22 + B162 | 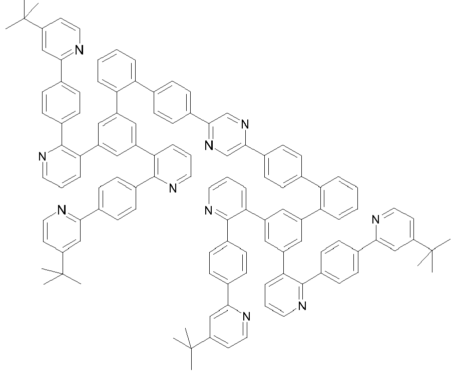 | 58% |
| L25 | B22 + B173 | 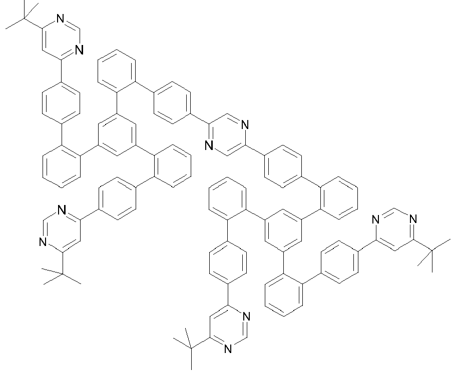 | 48% |
| L26 | B22 + B180 | 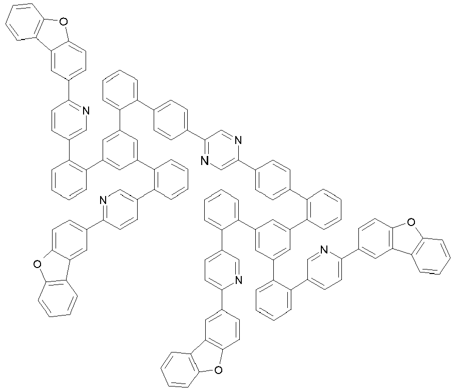 | 46% |
| L27 | B22 + B177 | 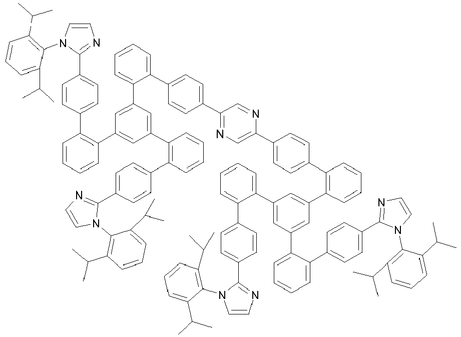 | 55% |
| L28 | B22 + B165 | 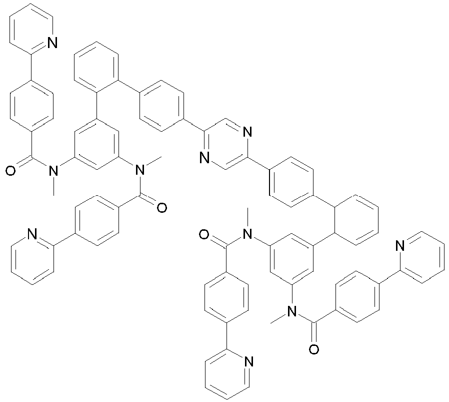 | 54% |
| L29 | B22 + B167 | 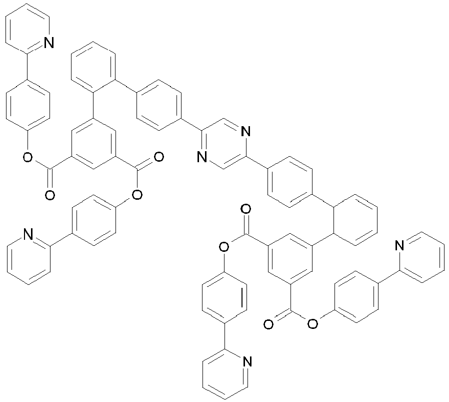 | 49% |
| L30 | B22 + B183 | 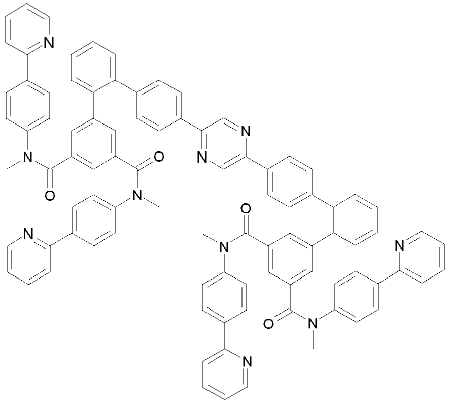 | 56% |
| L31 | B22 + B158 | 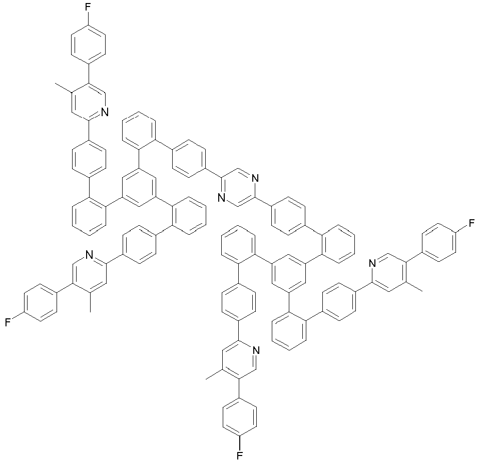 | 60% |
| L33 | B22 + B151 | 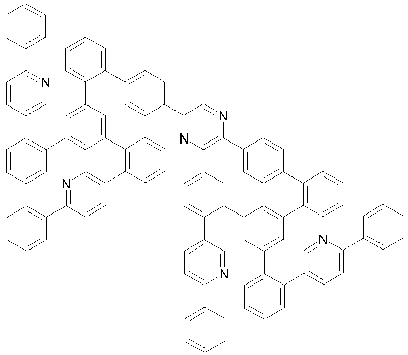 | 62% |
| L34 | B23 + B151 | 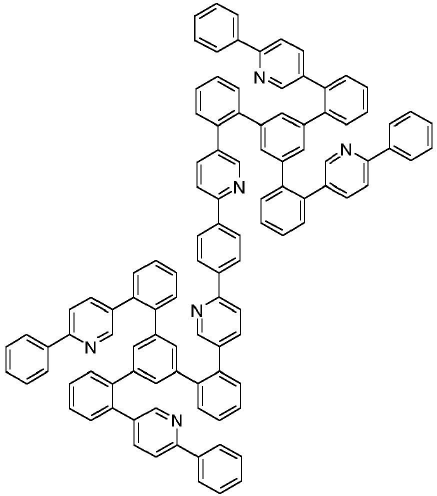 | 65% |
| L35 | B23 + S176 | 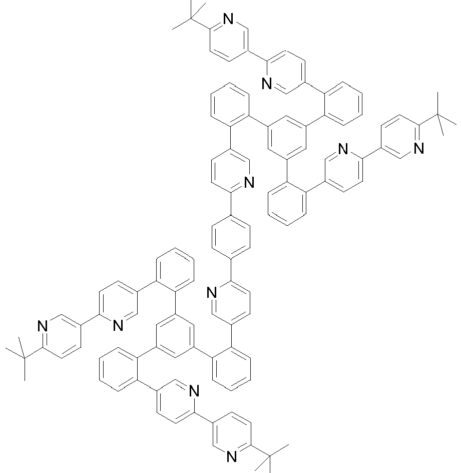 | 62% |
| L36 | B23 + B154 | 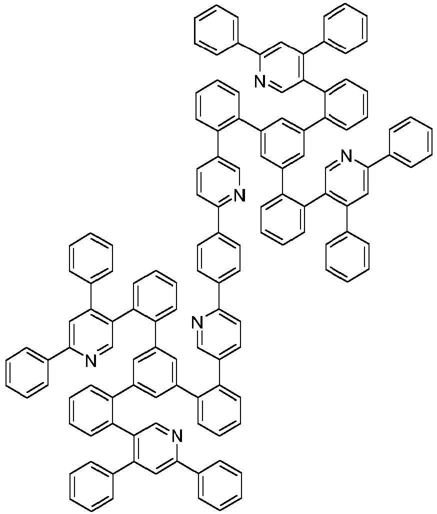 | 58% |
| L37 | B23 + B159 | 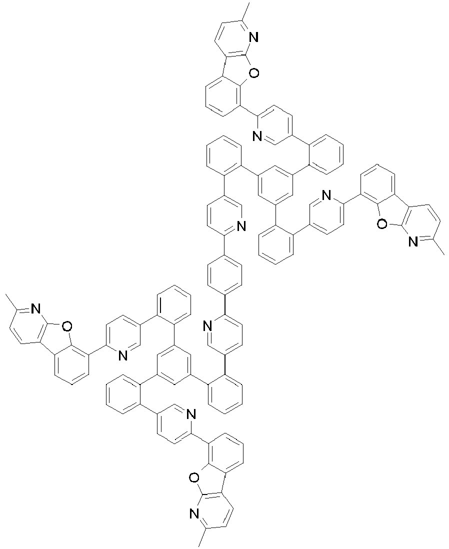 | 49% |
| L38 | B23 + B152 | 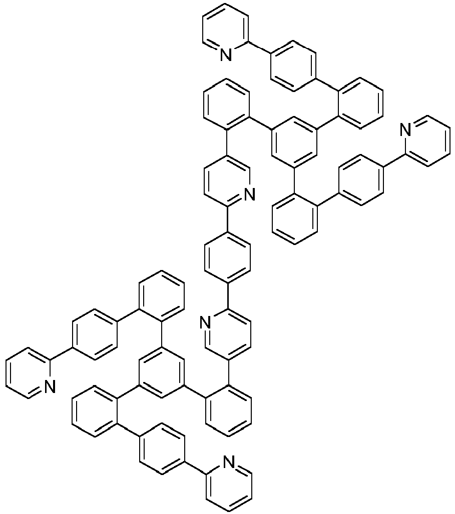 | 60% |
| L39 | B23 + B163 | 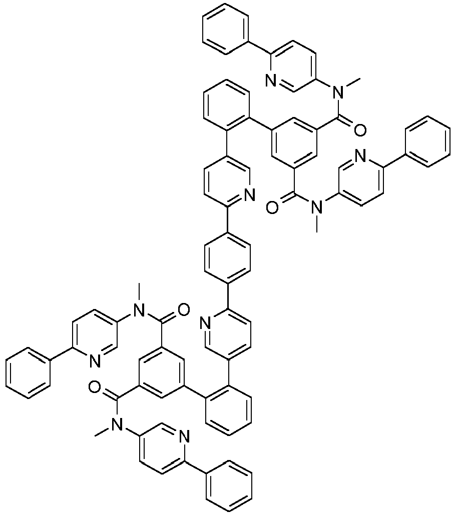 | 51% |
| L40 | B23 + 159 | 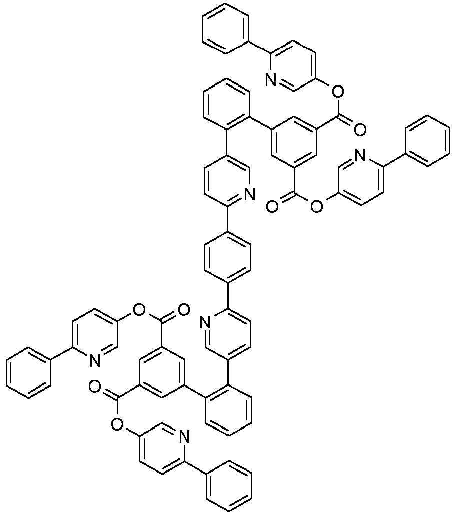 | 50% |
| L41 | B23 + B153 | 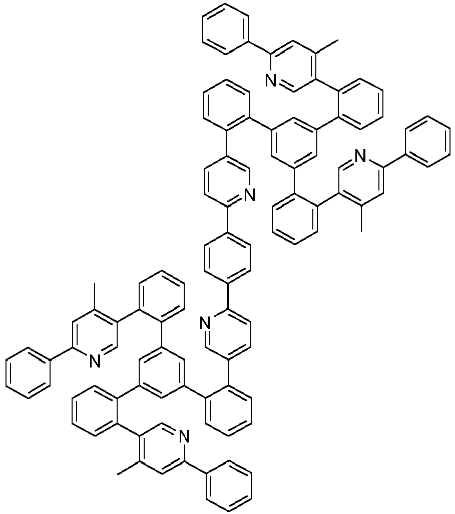 | 57% |
| L42 | B23 + B175 | 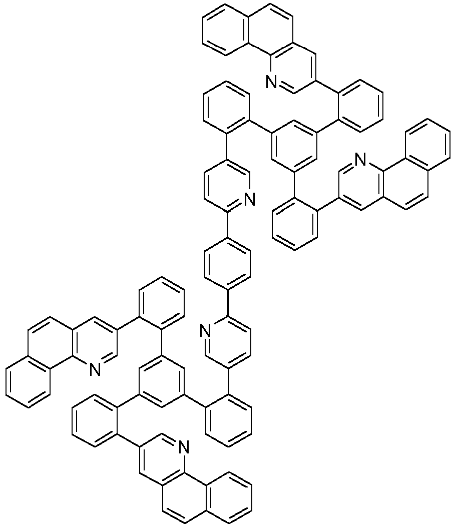 | 50 |
| L43 | B24 + B151 | 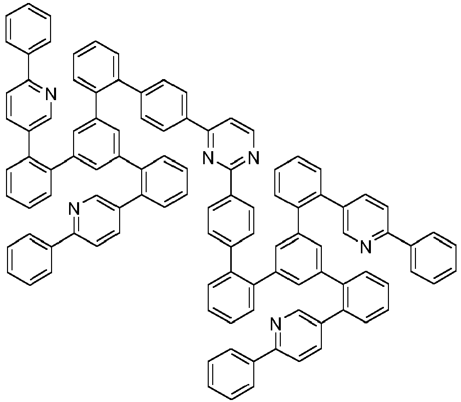 | 62% |
| L44 | B24 + B152 | 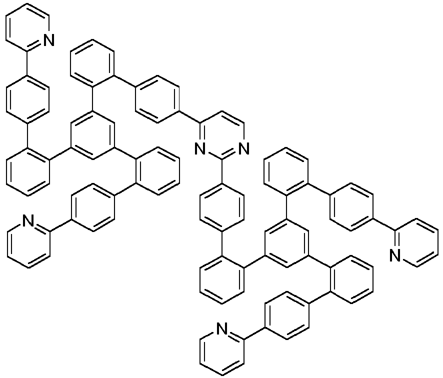 | 65% |
| L45 | B24 + B157 | 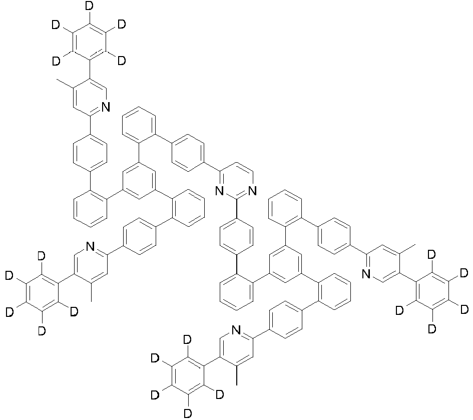 | 55% |
| L46 | B24 + B160 | 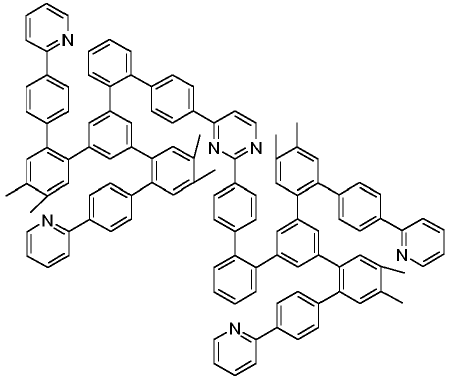 | 48% |
| L47 | B24 + B183 | 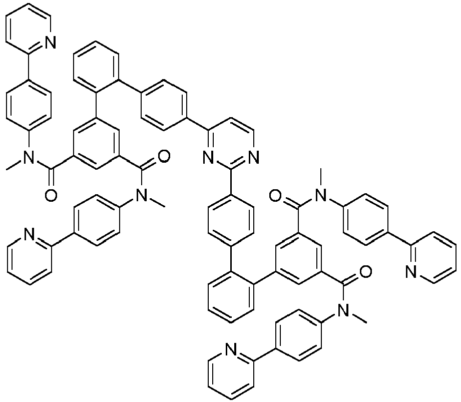 | 53% |
| L48 | B24 + B174 | 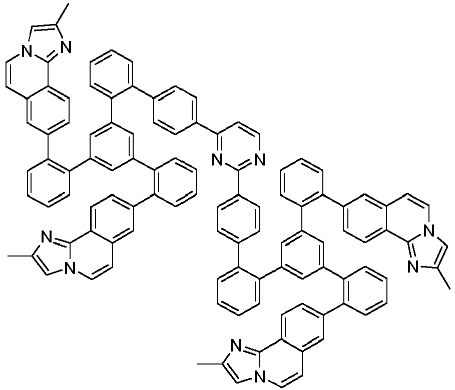 | 52% |
| L49 | B24 + S167 | 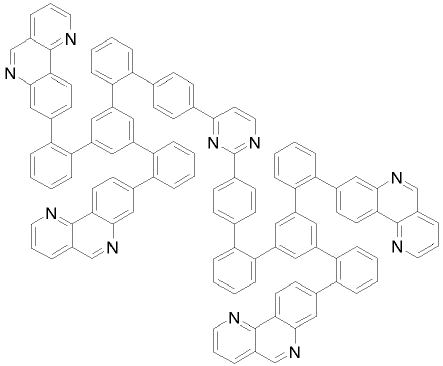 | 62% |
| L50 | B24 + 152 | 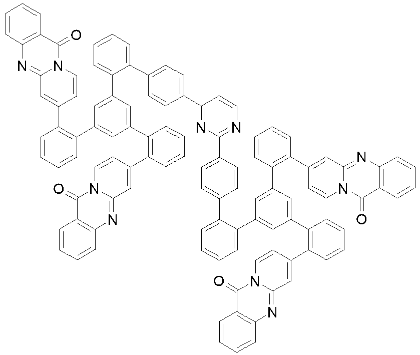 | 57% |
| L51 | B24 + B181 | 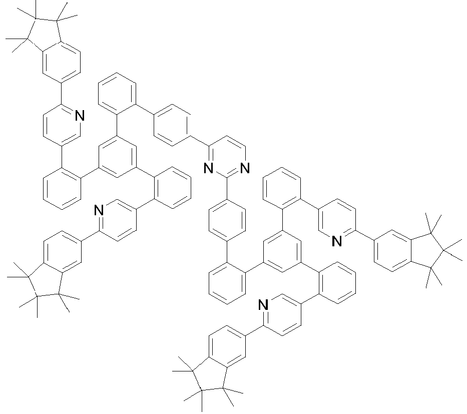 | 53% |
| L52 | B25 + B151 | 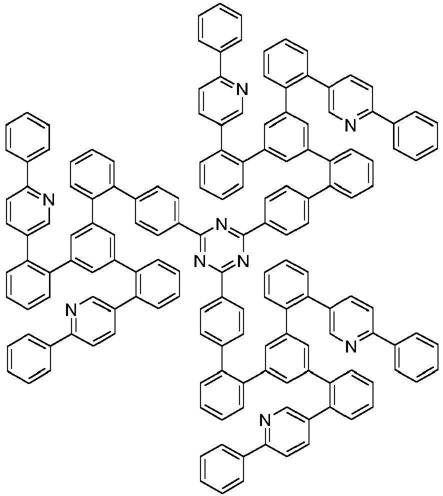 | 39% |
| | | 3.3 Equiv. B151, 9 Equiv. Na₂CO₃, 0.12 Equiv. PPh₃ und 0.04 Equiv. Pd(OAc)₂ | |
| L53 | B25 + B152 | 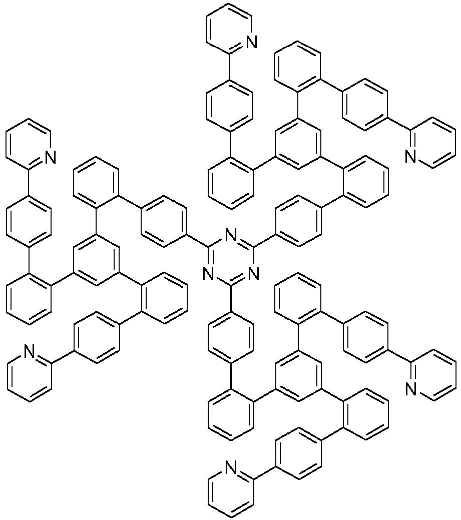 | 41% |
| | | 3.3 Equiv. B152, 9 Equiv. Na₂CO₃, 0.12 Equiv. PPh₃ und 0.04 Equiv. Pd(OAc)₂ | |
| L54 | B25 + S176 | 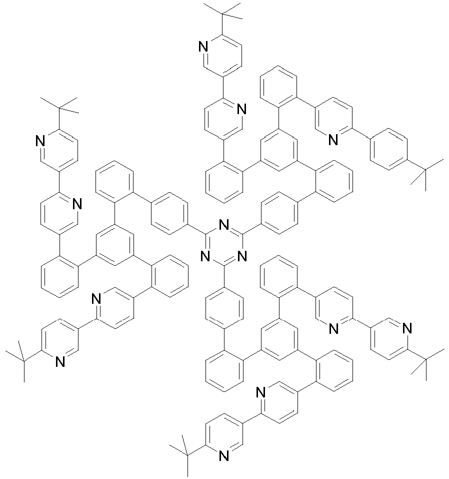 | 36% |
| | | 3.3 Equiv. S176, 9 Equiv. Na₂CO₃, 0.12 Equiv. PPh₃ und 0.04 Equiv Pd(OAc)₂ | |
| L55 | B25 + B172 | 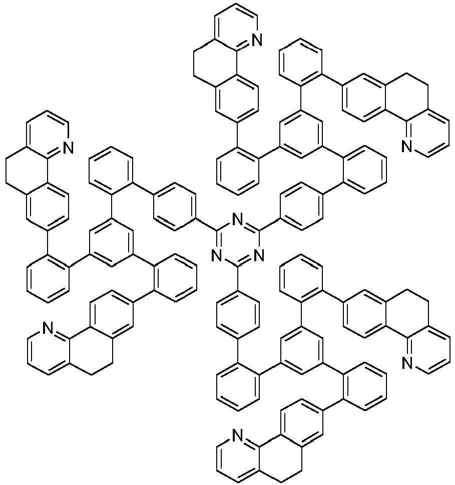 | 41% |
| | | 3.3 Equiv. B172, 9 Equiv. Na₂CO₃, 0.12 Equiv. PPh₃ und 0.04 Equiv. Pd(OAc)₂ | |
| L56 | B25 + B183 | 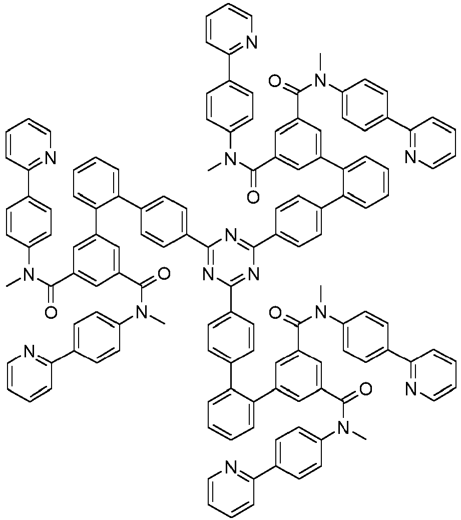 | 35% |
| | | 3.3 Equiv. B183, 9 Equiv. Na₂CO₃, 0.12 Equiv. PPh₃ und 0.04 Equiv. Pd(OAc)₂ | |
| L58 | B20 + B185 | 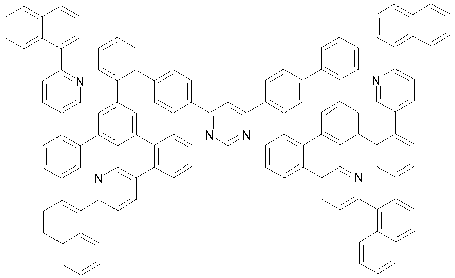 | 40% |
| L59 | B197 + 1 equiv. B152 | 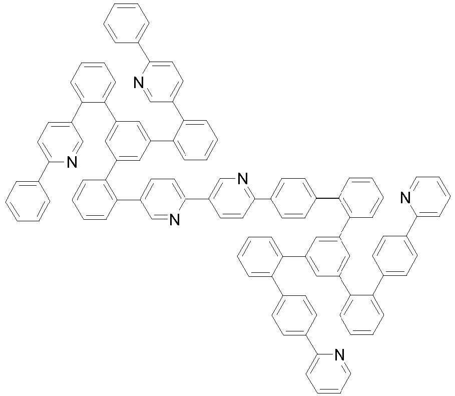 | 65% |
| L60 | B198 + 1 equiv. B152 | 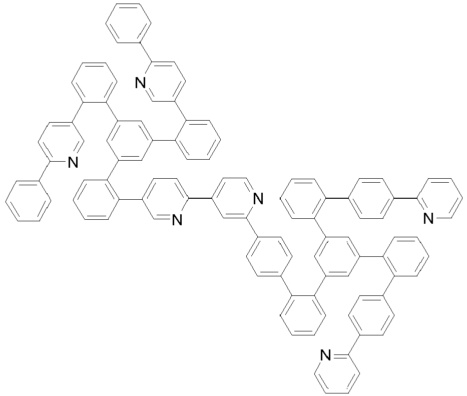 | 59% |
| L61 | B26 + B155 | 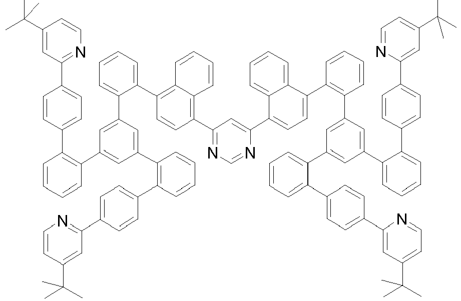 | 32% |
| L62 | B27 + B151 | 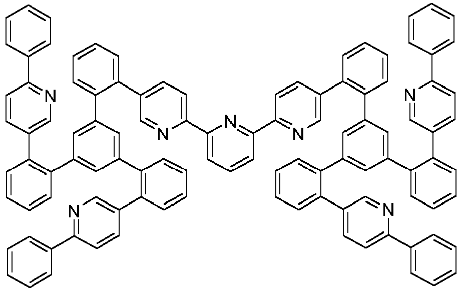 | 42% |
| L63 | B28 + B155 | 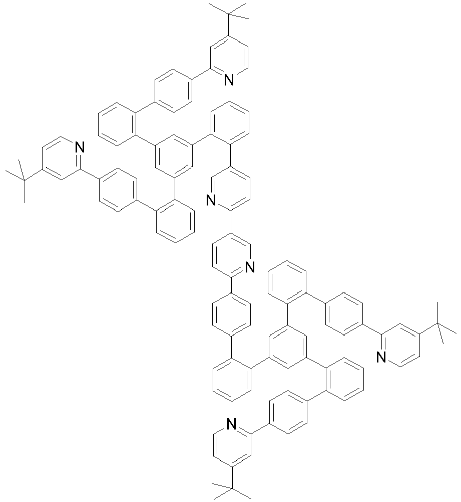 | 38% |
| L64 | B29 + B151 | 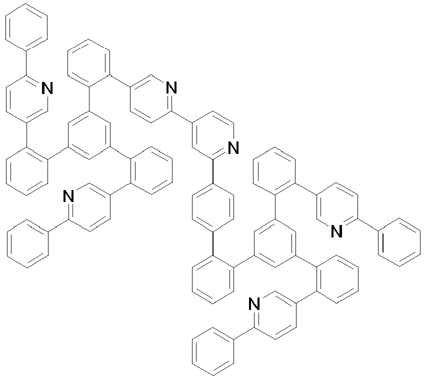 | 44% |
| L65 | B155 + B20 | 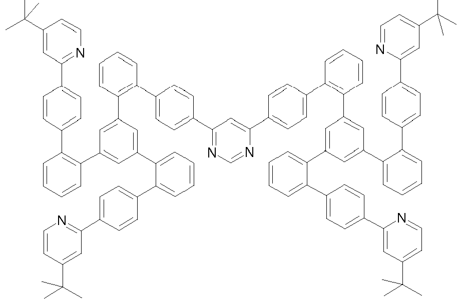 | 45% |
| L75 | B203+ B20 | 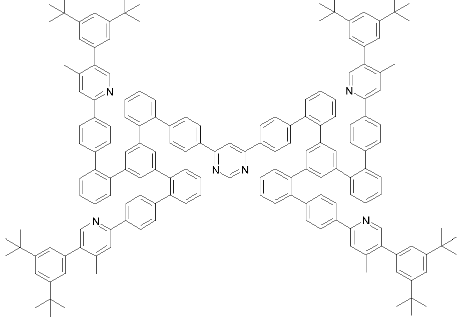 | 50% |
| L76 | B152 + B206 | 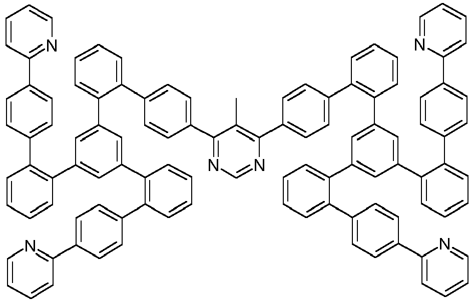 | 48% |

### Beispiel L66:

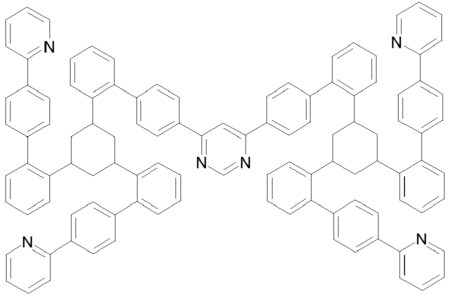

Ein Gemisch aus 13.7 g (21 mmol) B187, 4.8 g (10 mmol) B8, 12.7 g (60 mmol) Trikaliumphosphat, 250 mg (0.6 mmol) S-Phos [657408-07-6], 90 mg (4 mmol) Palladium(II)acetat, 100 ml Toluol, 60 ml Dioxan und 60 ml Wasser wird 6 h unter Rückfluss erhitzt. Nach Abkühlen wird die organische Phase abgetrennt, zweimal mit 50 ml Wasser und einmal mit 30 ml gesättigter Kochsalzlösung gewaschen, über Magnesiumsulfat getrocknet und über ein mit Toluol vorgeschlämmtes Celite-Bett filtriert, welches mit Toluol nachgewaschen wird. Das Filtrat wird zur Trockene eingeengt, und der Rückstand wird anschließend zweimal aus Ethylacetat umkristallisiert. Ausbeute: 56.5 g (4.5 mmol), 45 %. Reinheit: ca. 97 % n. ¹H-NMR.

Analog können folgende Verbindungen dargestellt werden, wobei zur Umkristallisation Lösemittel, wie z. B. Ethylacetat, Cyclohexan, Toluol, Acetonitril, n-Heptan, Ethanol, DMF, DMAC oder Methanol verwendet werden können. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Edukte | Produkt/Reaktionsbedingungen, falls abweichend | Ausbeute |
|---|---|---|---|
| L67 | B186 + B9 | 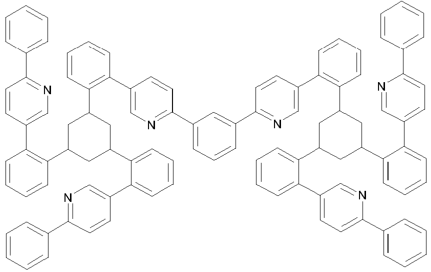 | 40% |
| L68 | B188 + B10 | 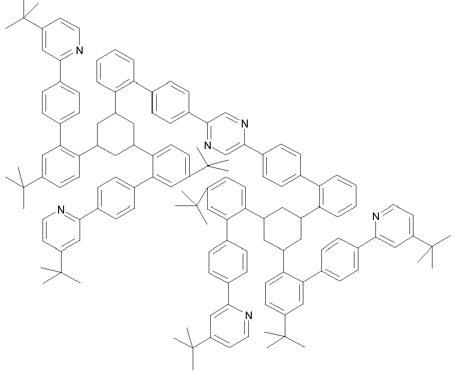 | 42% |
| L69 | B187 + B13 | 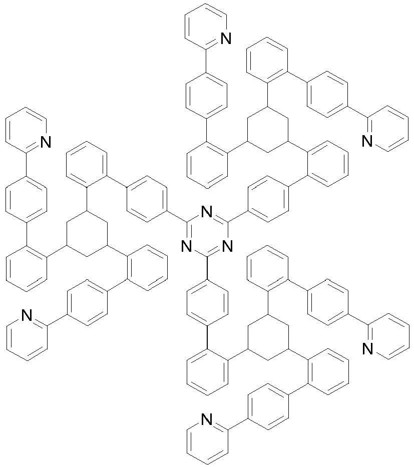 | 27% |
| L70 | B12 + B187 | 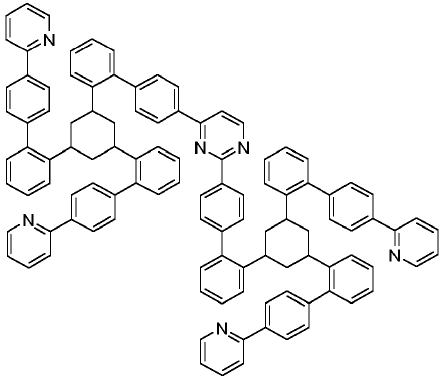 | 39% |
| L71 | B190 + B8 | 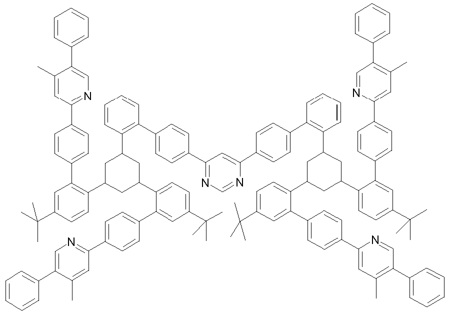 | 47% |
| L72 | B191 + B8 | 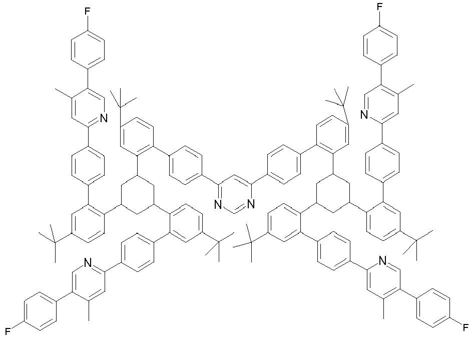 | 38% |
| L73 | B192 + B11 | 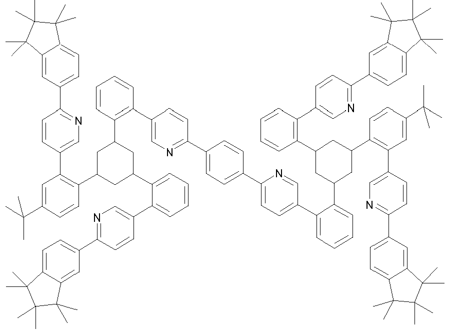 | 45% |
| L74 | B189 + B8 | 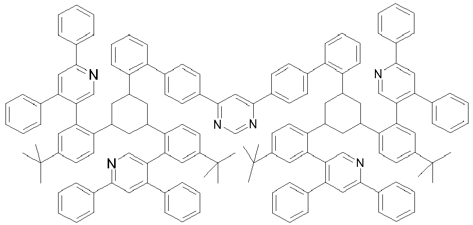 | 43% |

### C: Synthese der Metallkomplexe

### Beispiel Isomer 1-Ir₂(L1) und Isomer 2-Ir₂(L1) (nachfolgend als I1-Ir₂(L1) und I2-Ir₂(L1) abgekürzt):

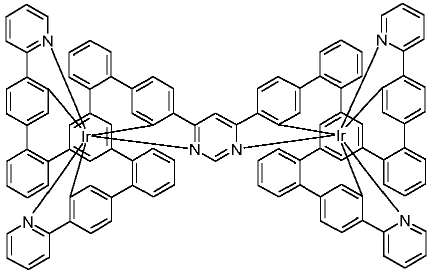

Ein Gemisch aus 14.5 g (10 mmol) des Liganden L1, 9.8 g (20 mmol) Tris-acetylacetonato-iridium(III) [15635-87-7] und 100 g Hydrochinon [123-31-9] wird in einem 1000 mL Zweihalsrundkolben mit einem glasum-mantelten Magnetkern vorgelegt. Der Kolben wird mit einem Wasserabscheider (für Medien geringerer Dichte als Wasser) und einem Luftkühler mit Argonüberlagerung versehen und in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Die Apparatur wird mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250 °C, gemessen am Pt-100 Thermofühler, der in die aufgeschmolzene, gerührte Reaktionsmischung eintaucht, erhitzt. Während der nächsten 2 h wird das Reaktionsgemisch bei 250 °C gehalten, wobei wenig Kondensat abdestilliert und sich im Wasserabscheider sammelt. Die Reaktionsmischung wird auf 190 °C abkühlen gelassen, dann werden 100 mL Ethylenglykol zugetropft. Man lässt weiter bis auf 80 °C abkühlen und tropft dann 500 mL Methanol zu, erhitzt 1 h unter Rückfluss. Die so erhaltene Suspension wird über eine Umkehrfritte filtriert, der Feststoff wird zweimal mit 50 ml Methanol gewaschen und dann im Vakuum getrocknet. Der so erhaltene Feststoff wird in 200 mL Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des diastereomeren Produktgemisches.

Die diastereomere Metallkomplexmischung enthaltend ΔΔ- und ΛΛ-Isomere (racemisch) sowie ΛΔ-Isomer (meso) im Stoffmengenverhältnis 1:1 (bestimmt durch ¹H-NMR) wird in 300 mL Dichlormethan gelöst, auf 100 g Kieselgel aufgezogen und über eine mit Toluol/Ethylacetat 95:5 vorgeschlämmte Kieselgelsäule (Kieselgelmenge ca. 1.7 kg) chromatographisch getrennt. Man eluiert zunächst den vorderen Spot und steigert dann schrittweise die Ethylacetatmenge bis zu einem Verhältnis von Toluol/Ethylacetat von 6:1. Man erhält 7.0 g (3.8 mmol, Reinheit 99%ig) des füher eluierenden Isomers, nachfolgend Isomer 1 (I1) genannt, und 7.7 g (4.2 mmol, Reinheit 98%ig) des später eluierenden Isomers, nachfolgend Isomer 2 (I2) genannt. Isomer 1 (I1) und Isomer 2 (I2) werden getrennt voneinander durch viermalige Heißextraktion mit Ethylacetat für Isomer 1 und Dichlormethan für Isomer 2 weiter aufgereinigt (Vorlagemenge jeweils ca. 150 ml, Extraktionshülse: standard Soxhletthülsen aus Cellulose der Fa. Whatman) unter sorgfältigem Luft- und Lichtausschluss. Abschließend werden die Produkte im Hochvakuum bei 280 °C getempert Ausbeute: **Isomer 1 (I1)** 5.3 g roter Feststoff (2.9 mmol), 29% bezogen auf die Menge an eingesetztem Liganden. Reinheit: > 99.9 % nach HPLC; **Isomer 2 (I2)** 4.9 g roter Feststoff (2.7 mmol), 27% bezogen auf die Menge an eingesetztem Liganden. Reinheit 99.8%ig nach HPLC.

Die nachfolged gezeigten Metallkomplexe können prinzipiell durch Chromatographie (typischerweise Verwendung eines Säulenautomaten (Torrent der Firma Axel Semrau), Umkristallisation oder Heißextraktion gereinigt werden. Restlösemittel kann durch Tempern im Vakuum / Hochvakuum bei typischerweise 250 - 330 °C oder durch Sublimation / fraktionierte Sublimation entfernt werden. Die angegebenen Ausbeuten für Isomer 1 (I1) bzw Isomer 2 (I2) beziehen sich immer auf die Menge an eingesetztem Liganden.

Im Folgenden aufgeführte Abbildungen von Komplexen zeigen üblicherweise nur ein Isomer. Die Isomerenmischung kann aufgetrennt werden, kann aber auch als Isomerengemisch im OLED Device eingesetzt werden. Es gibt jedoch auch Ligandensysteme, bei denen sich aus sterischen Gründen lediglich ein Diastereomerenpaar bildet.

Analog können folgende Verbindungen synthetisiert werden. Die Reaktionsbedingungen sind exemplarisch für das Isomer 1 (I1) angegeben. Die chromatographische Trennung der überlicherweise anfallenden Diastereomerenmischung erfolgt an Flash-Kieselgel auf einem Säulenautomaten (Torrent der Firma Axel Semrau).

| Bsp. | Edukt | Produkt/ Reaktionsbedingungen/ Heißextratkionsmittel (HE) | Ausbeute* |
|---|---|---|---|
| 11-Rh₂(L1) | L1 | 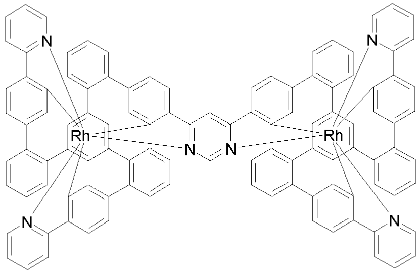 | 22% |
| | Rh(acac)₃ [14284-92-5] | | |
| | statt Ir(acac)₃ | | |
| | | I1-Rh₂(L1) | |
| | | 250°C; 2 h | |
| | | Heißextraktion: Toluol | |
| 12-Rh₂(L1) | L1 | 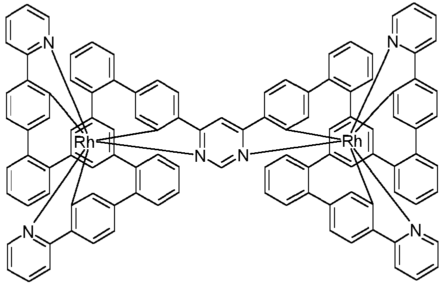 | 20% |
| | Rh(acac)₃ [14284-92-5] | | |
| | statt Ir(acac)₃ | | |
| | | I2-Rh₂(L1) | |
| | | Heißextraktion: Toluol | |
| I1-Ir₂(L2) | L2 | 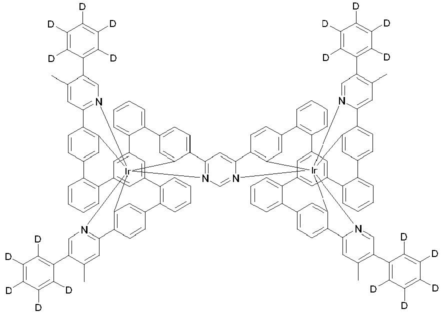 | 32% |
| | | I1-Ir₂(L2) | |
| | | 250°C; 2 h | |
| | | Heißextraktion: Ethylacetat | |
| I2-Ir₂(L2) | L2 | I2-Ir₂(L2) | 34% |
| | | Heißextraktion: Toluol | |
| Ir₂(L4) | L4 | 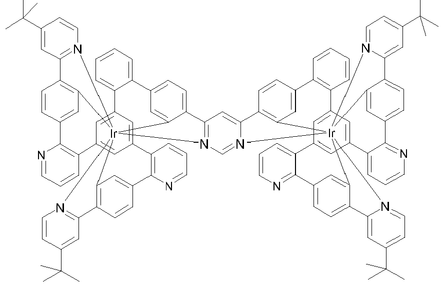 | 52% |
| | | Ir₂(L4) | |
| | | 250°C; 2 h | |
| | | Heißextraktion: Ethylacetat | |
| | | Es entsteht nur das Racemat aus ΛΛ- und ΔΔ-Isomer. | |
| Rh₂(L4) | L4 | | 40% |
| | Rh(acac)₃ [14284-92-5] | 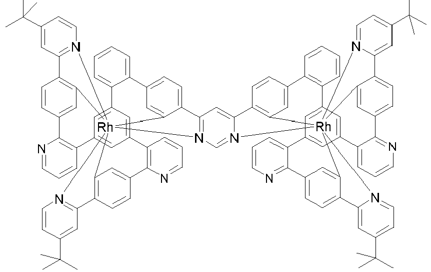 | |
| | statt Ir(acac)₃ | | |
| | | Rh₂(L4) | |
| | | 250°C; 2 h | |
| | | Heißextraktion: Ethylacetat | |
| | | Es entsteht nur das Racemat aus ΛΛ- und ΔΔ-Isomer. | |
| I1-Ir₂(L5) | L5 | 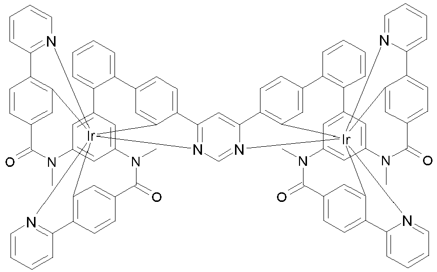 I1-Ir₂(L5) | 30%% |
| | | 250°C; 3 h | |
| | | Heißextraktion: n-Butylacetat | |
| I2-Ir₂(L5) | L5 | I2-Ir₂(L5) | 28%% |
| | | Heißextraktion: n-Butylacetat | |
| I1-Ir₂(L6) | L6 | 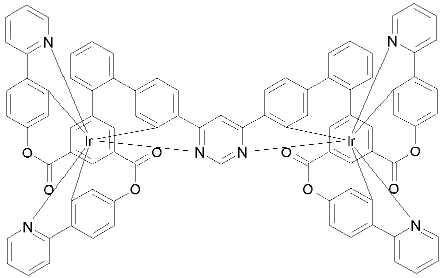 | 21% |
| | | I1-Ir₂(L6) | |
| | | 220°C; 5 h | |
| | | Heißextraktion: Butylacetat | |
| I2-Ir₂(L6) | L6 | I2-Ir₂(L6) | 24% |
| | | Heißextraktion: Ethylacetat | |
| I1-Ir₂(L8) | L8 | 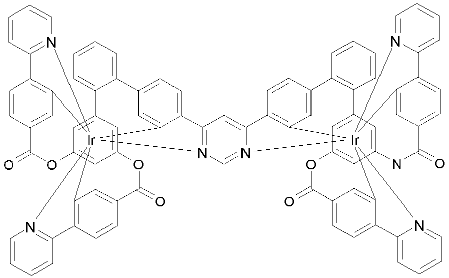 | 25% |
| | | I1-Ir₂(L8) | |
| | | 220°C; 5 h | |
| | | Heißextraktion: Toluol | |
| I2-Ir₂(L8) | L8 | I2-Ir₂(L8) | 25% |
| | | Heißextraktion: Toluol | |
| I1-Ir₂(L9) | L9 | 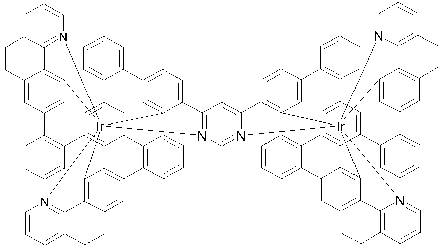 | 32% |
| | | I1-Ir₂(L9) | |
| | | 250°C; 3 h | |
| | | Heißextraktion: o-Xylol | |
| I2-Ir₂(L9) | L9 | I2-Ir₂(L9) | 26% |
| | | Heißextraktion: Toluol | |
| Ir₂(L10) | L10 | 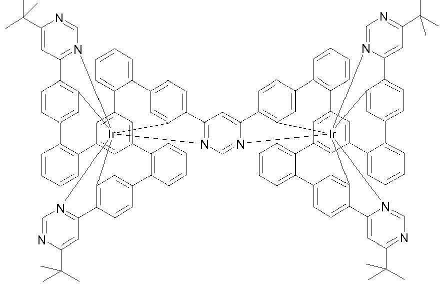 | 58% |
| | | I1 -Ir₂(L10) | |
| | | 250°C; 1.5 h | |
| | | Heißextraktion: Ethylacetat/Acetonitril 4:1 | |
| | | Es entsteht nur das Racemat aus ΛΛ- und ΔΔ-Isomer. | |
| I1-Ir₂(L 11) | L11 | 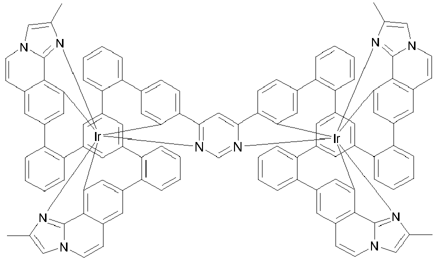 | 27% |
| | | I1-Ir₂(L11) | |
| | | 260°C; 2 h | |
| | | Heißextraktion: m-Xylol | |
| I2-Ir₂(L11) | L11 | I2-Ir₂(L11) | 30% |
| | | Heißextraktion: o-Xylol | |
| I1-Ir₂(L12) | L12 | 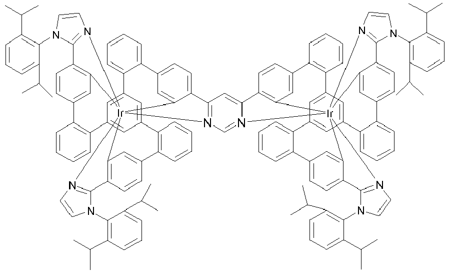 | 31% |
| | | I1 -Ir₂(L12) | |
| | | 265°C; 2 h | |
| | | Heißextraktion: Toluol | |
| I2-Ir₂(L12) | L12 | I2-Ir₂(L12) | 33% |
| | | Heißextraktion: Toluol | |
| I1-Ir₂(L13) | L13 | 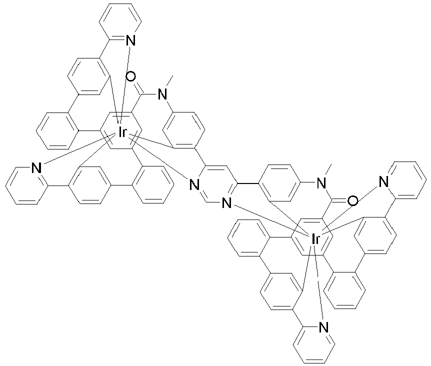 | 30% |
| | | I1 -Ir₂(L1 3) | |
| | | 250°C; 3 h | |
| | | Heißextraktion: Butylacetat | |
| I2-Ir₂(L13) | L13 | I1-Ir₂(L13) | 30% |
| | | Heißextraktion: Butylacetat | |
| I1-Ir₂(L14) | L14 | 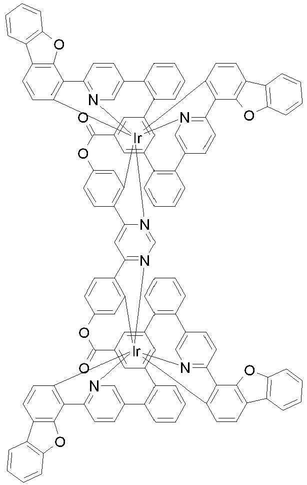 | 26% |
| | | I1 -Ir₂(L14) | |
| | | 250°C; 3 h | |
| | | Heißextraktion: Ethylacetat | |
| I2-Ir₂(L14) | L14 | I2-Ir₂(L14) | 23% |
| | | Heißextraktion: Ethylacetat | |
| I1-Ir₂(L15) | L15 | 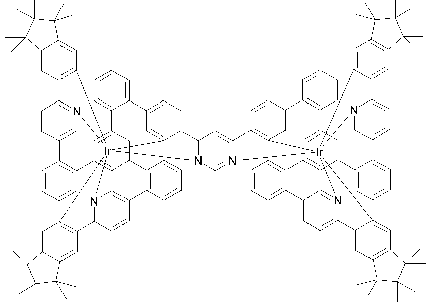 | 27% |
| | | I1 -Ir₂(L1 5) | |
| | | 250°C; 2 h | |
| | | Heißextraktion: Cyclohexan | |
| I2-Ir₂(L15) | L15 | I2-Ir₂(L15) | 33% |
| | | Heißextraktion: Toluol/Heptan 3:1 | |
| I1-Ir₂(L16) | L16 | 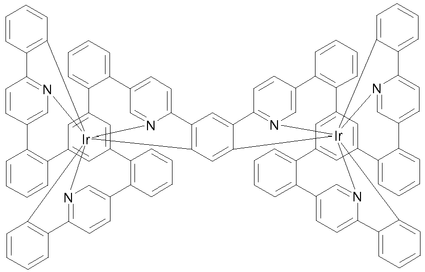 | 33% |
| | | I1 -Ir₂(L16) | |
| | | 270°C; 2 h | |
| | | Heißextraktion: Dichlormethan | |
| I2-Ir₂(L16) | L16 | I2-Ir₂(L16) | 30% |
| | | Heißextraktion: Dichlormethan | |
| I1-Ir₂(L17) | L17 | 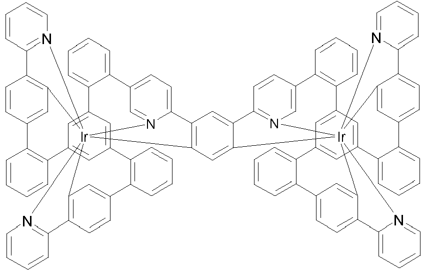 | 29% |
| | | I1 -Ir₂(L1 7) | |
| | | 265°C; 3 h | |
| | | Heißextraktion: Toluol | |
| I2-Ir₂(L17) | L17 | I2-Ir₂(L17) | 34% |
| | | Heißextraktion: *n*-Butylacetat | |
| I1-Ir₂(L18) | L18 | 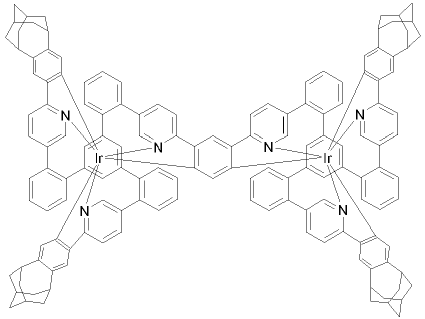 | 27% |
| | | I1 -Ir₂(L1 8) | |
| | | 265°C; 3.5 h | |
| | | Heißextraktion: Ethylacetat | |
| I2-Ir₂(L18) | L18 | I2-Ir₂(L18) | 25% |
| | | Heißextraktion: Ethylacetat/Acetoniril 4:1 | |
| I1-Ir₂(L19) | L19 | 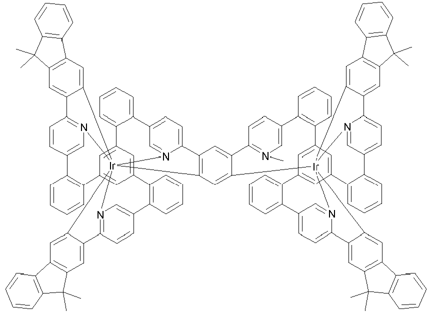 | 35% |
| | | I1 -Ir₂(L1 9) | |
| | | 270°C; 3 h | |
| | | Heißextraktion: Dichlormethan | |
| I2-Ir₂(L19) | L19 | I2-Ir₂(L19) | 30% |
| | | Heißextraktion: o-Xylol | |
| I1-Ir₂(L20) | L20 | 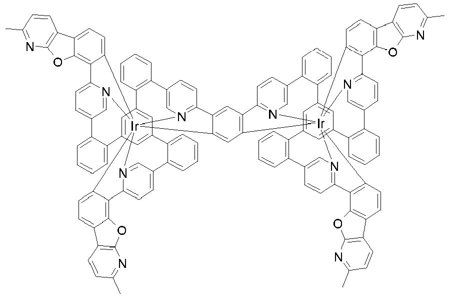 I1-Ir₂(L20) | 29% |
| | | 265°C; 5 h | |
| | | Heißextraktion: Dichlormethan | |
| I2-Ir₂(L20) | L20 | I2-Ir₂(L20) | 31% |
| | | Heißextraktion: Dichlormethan | |
| I1-Ir₂(L21) | L21 | 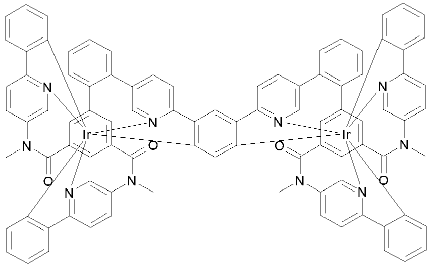 | 25% |
| | | I1-Ir₂(L21) | |
| | | 255°C; 3 h | |
| | | Heißextraktion: Ethylacetat | |
| I2-Ir₂(L21 ) | L21 | I2-Ir₂(L21) | 30% |
| | | Heißextraktion: Ethylacetat | |
| I1-Ir₂(L22) | L22 | 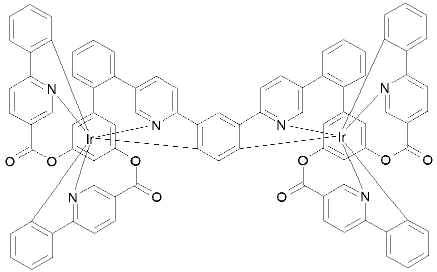 | 21% |
| | | I1-Ir₂(L22) | |
| | | 235°C; 3 h | |
| | | Umkristallisation aus DMF | |
| I-Ir₂(L22) | L22 | I2-Ir₂(L22) | 23% |
| | | Heißextraktion: n-Butylacetat | |
| I1-Ir₂(L23) | L23 | 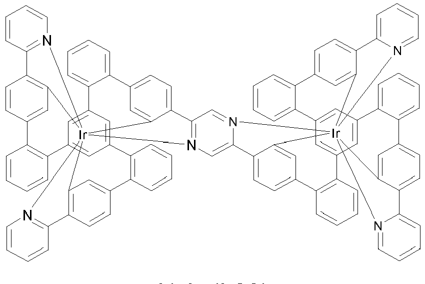 | 31% |
| | | I1-Ir₂(L23) | |
| | | 250°C; 2 h | |
| | | Heißextraktion: Toluol | |
| I2-Ir₂(L23) | L23 | I2-Ir₂(L23) | 38% |
| | | Heißextraktion: o-Xylol | |
| I1-Ir₂(L24) | L24 | 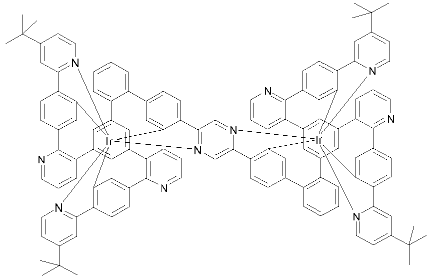 | 28% |
| | | I1-Ir₂(L24) | |
| | | 250°C; 2 h | |
| | | Heißextraktion: Toluol | |
| I2-Ir₂(L24) | L24 | I2-Ir₂(L24) | 27% |
| | | Heißextraktion: Toluol | |
| I1-Ir₂(L25) | L25 | 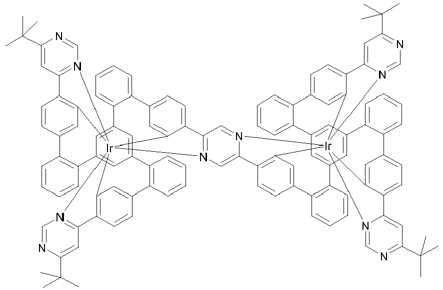 | 29% |
| | | I1-Ir₂(L25) | |
| | | 250°C; 2 h | |
| | | Heißextraktion: Ethylacetat | |
| I2-Ir₂(L25) | L25 | I2-Ir₂(L25) | 30% |
| | | Heißextraktion: Ethylacetat | |
| I1-Ir₂(L26) | L26 | 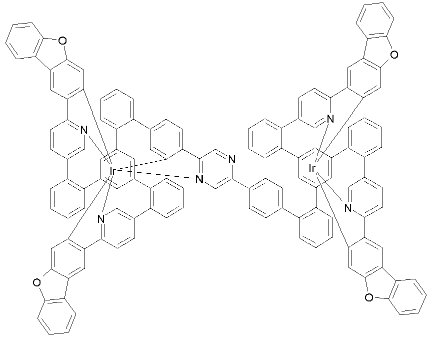 | 25% |
| | | I1-Ir₂(L26) | |
| | | 250°C; 3.5 h | |
| | | Heißextraktion: p-Xylol | |
| I2-Ir₂(L26) | L26 | I2-Ir₂(L26) | 25% |
| | | Heißextraktion: Toluol | |
| I1-Ir₂(L27) | L27 | 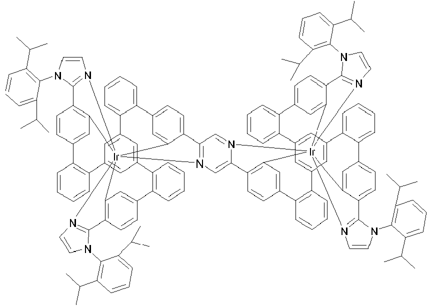 | 28% |
| | | I1-Ir₂(L27) | |
| | | 260°C; 3 h | |
| | | Heißextraktion: Toluol | |
| I2-Ir₂(L27) | L27 | I2-Ir₂(L27) | 32% |
| | | Heißextraktion: o-Xylol | |
| I1-Ir₂(L28) | L28 | 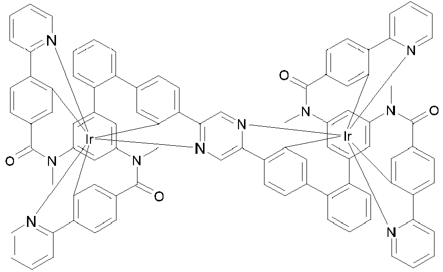 | 35% |
| | | I1-Ir₂(L28) | |
| | | 250°C; 3 h | |
| | | Umkristallisation aus DMSO | |
| I2-Ir₂(L28) | L28 | I2-Ir₂(L28) | 31% |
| | | Umkristallisation aus DMF | |
| I1-Ir₂(L-29) | L29 | 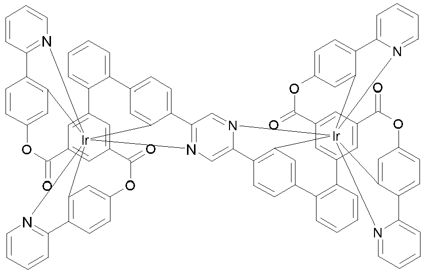 | 23% |
| | | I1-Ir₂(L29) | |
| | | 235°C; 2 h | |
| | | Heißextraktion: Ethylacetat | |
| I2-Ir₂(L29) | L29 | I2-Ir₂(L29) | 26% |
| | | Heißextraktion: Ethylacetat | |
| I1-Ir₂(L30) | L30 | 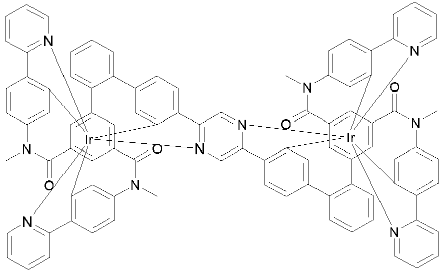 | 31% |
| | | I1-Ir₂(L30) | |
| | | 250°C; 2 h | |
| | | Umristallisation aus 1,4-Dioxan | |
| I2-Ir₂(L30) | L30 | I2-Ir₂(L30) | 31% |
| | | Umristallisation aus DMSO | |
| I1-Ir₂(L31 ) | L31 | 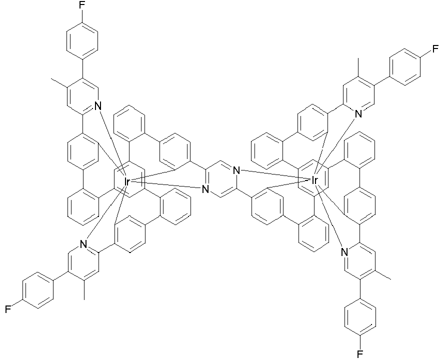 | 30% |
| | | I1-Ir₂(L31 ) | |
| | | 250°C; 2 h | |
| | | Heißextraktion: n-Butylacetat | |
| I2-Ir₂(L31 ) | L31 | I2-Ir₂(L31) | 27% |
| | | Heißextraktion: n-Butylacetat | |
| I1-Ir₂(L33) | L33 | 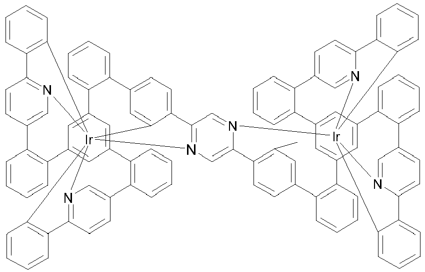 | 30% |
| | | I1-Ir₂(L33) | |
| | | 250°C; 2 h | |
| | | Heißextraktion: o-Xylol | |
| I2-Ir₂(L33) | L33 | I2-Ir₂(L33) | 24% |
| | | Heißextraktion: o-Xylol | |
| I1-Ir₂(L34) | L34 | 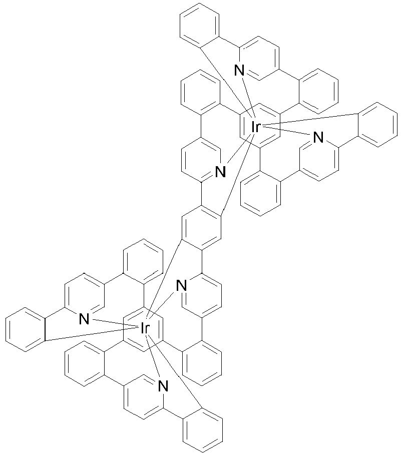 | 26% |
| | | I1 -Ir₂(L34) | |
| | | 270°C; 3 h | |
| | | Heißextraktion: Toluol | |
| I2-Ir₂(L34) | L34 | I2-Ir₂(L34) | 28% |
| | | Heißextraktion: p-Xylol | |
| I1-Ir₂(L35) | L35 | 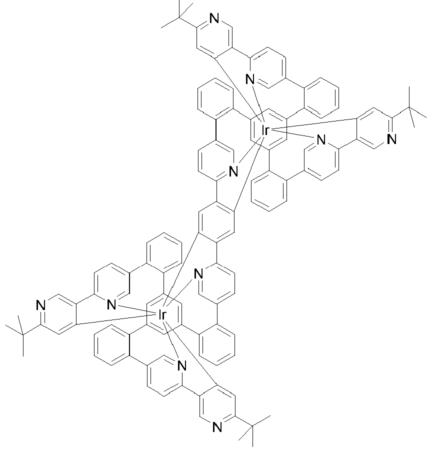 | 29% |
| | | I1-Ir₂(L35) | |
| | | 270°C; 3 h | |
| | | Heißextraktion: n-Butylacetat | |
| I2-Ir₂(L35) | L35 | I2-Ir₂(L35) | 29% |
| | | Heißextraktion: n-Butylacetat | |
| I1-Ir₂(L36) | L36 | 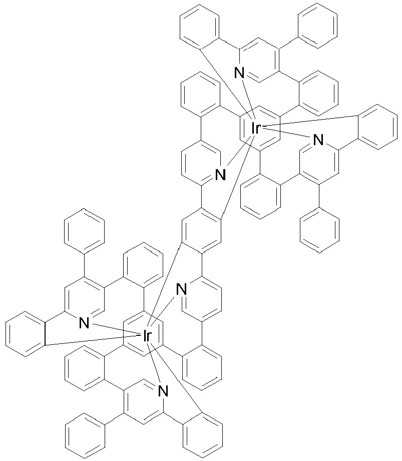 | 33% |
| | | I1 -Ir₂(L36) | |
| | | 270°C; 3 h | |
| | | Heißextraktion: Toluol | |
| I2-Ir₂(L36) | L36 | I2-Ir₂(L36) | 31% |
| | | Heißextraktion: Toluol | |
| I1-Ir₂(L37) + I2-Ir₂(L37) | L37 | 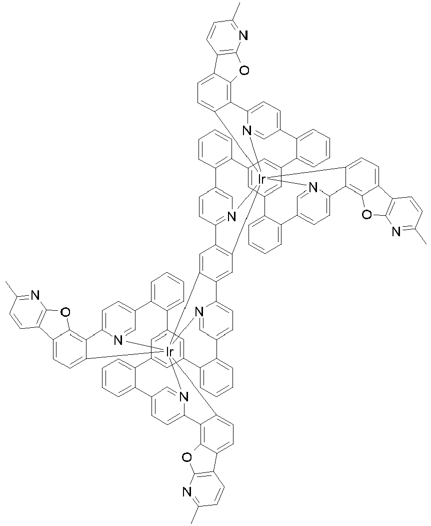 | 60% |
| | | I1-Ir₂(L37) + I2-Ir₂(L37) | |
| | | 270°C; 4 h | |
| | | Säule: keine Trennung möglich, | |
| | | als Isomerengemisch eingesetzt. | |
| | | Heißextraktion: Xylol | |
| I1-Ir₂(L-38) | L38 | 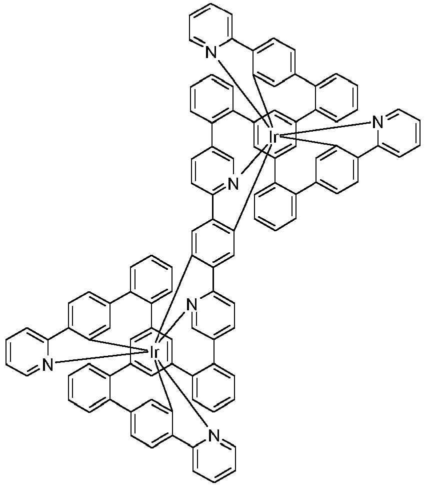 | 30% |
| | | I1-Ir₂(L38) | |
| | | 270°C; 3 h | |
| | | Heißextraktion: Toluol | |
| I2-Ir₂(L38) | L38 | I2-Ir₂(L38) | 26% |
| | | Heißextraktion: Dichlormethan | |
| I1-Ir₂(L39) | L39 | 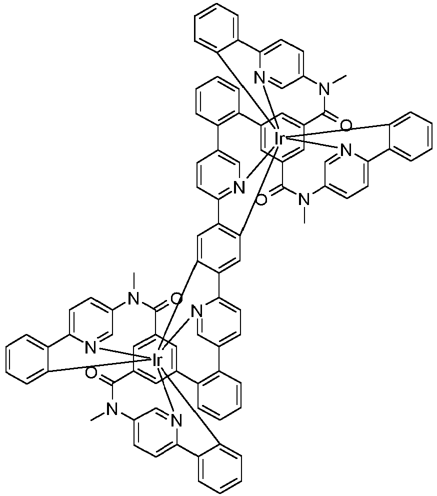 | 32% |
| | | I1-Ir₂(L39) | |
| | | 260°C; 3 h | |
| | | Umkristallisation aus DMF | |
| I2-Ir₂(L39) | L39 | I2-Ir₂(L39) | 24% |
| | | Umkristallisation aus DMF | |
| I1-Ir₂(L40) | L40 | 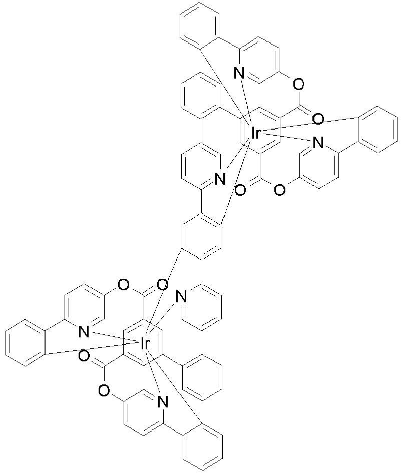 | 22% |
| | | I1-Ir₂(L40) | |
| | | 250°C; 3 h | |
| | | Umkristallsiation aus DMSO | |
| I2-Ir₂(L40) | L40 | I2-Ir₂(L40) | 30% |
| | | Heißextraktion: Ethylacetat | |
| I1-Ir₂(L41) | L41 | 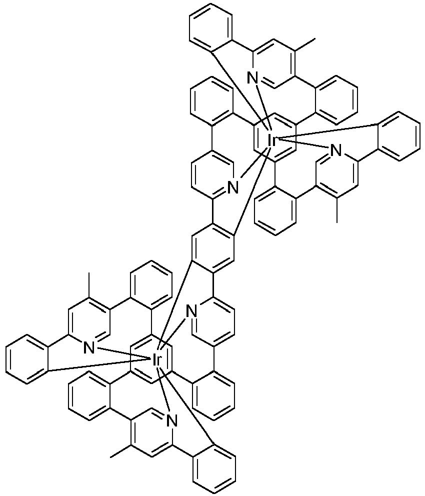 | 27% |
| | | I1-Ir₂(L41) | |
| | | 270°C; 2 h | |
| | | Heißextraktion: Toluol | |
| I2-Ir₂(L41) | L41 | I2-Ir₂(L41 ) | 32% |
| | | Heißextraktion: n-Butylacetat | |
| I1-Ir₂(L42) | L42 | 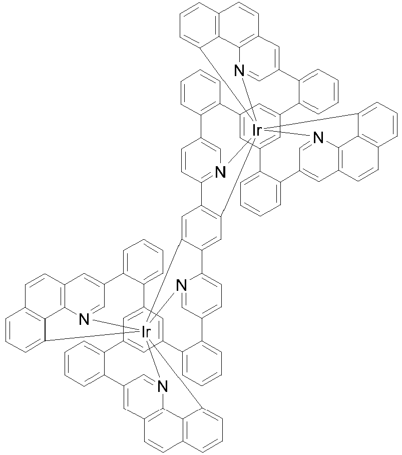 | 30% |
| | | I1-Ir₂(L42) | |
| | | 270°C; 6 h | |
| | | Heißextraktion: o-Xylol | |
| I2-Ir₂(L42) | L42 | I2-Ir₂(L42) | 35% |
| | | Heißextraktion: o-Xylol | |
| I1-Ir₂(L43) | L43 | 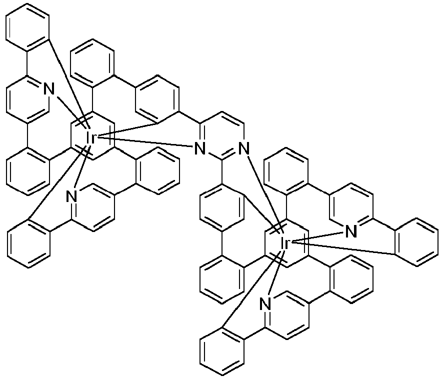 | 30% |
| | | I1-Ir₂(L43) | |
| | | 260°C; 2 h | |
| | | Heißextraktion: Butylacetat | |
| I2-Ir₂(L43) | L43 | I2-Ir₂(L43) | 28% |
| | | Heißextraktion: Toluol | |
| I1-Ir₂(L44) | L44 | 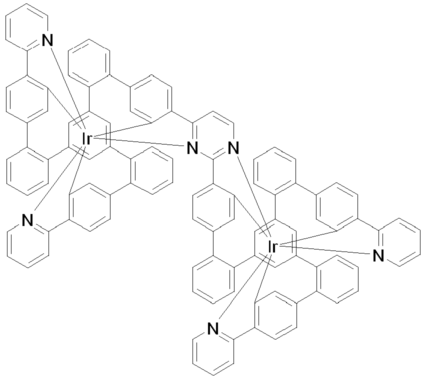 | 27% |
| | | I1-Ir₂(L44) | |
| | | 260°C; 2 h | |
| | | Heißextraktion: Toluol | |
| I2-Ir₂(L44) | L44 | I2-Ir₂(L44) | 33% |
| | | Heißextraktion: Toluol | |
| I1-Ir₂(L45) | L45 | 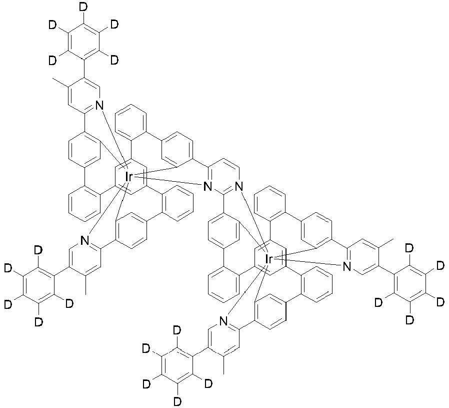 | 27% |
| | | I1-Ir₂(L45) | |
| | | 260°C; 2 h | |
| | | Heißextraktion: Ethylacetat | |
| I2-Ir₂(L45) | L45 | I2-Ir₂(L45) | 28% |
| | | Heißextraktion: n-Butylacetat | |
| I1-Ir₂(L46) | L46 | 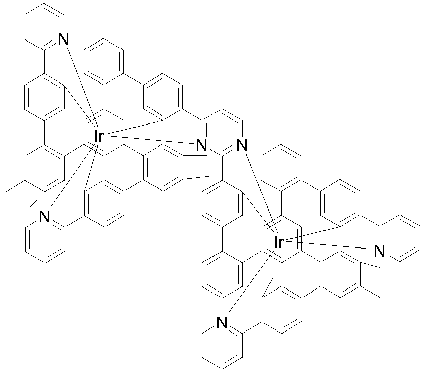 | 32% |
| | | I1-Ir₂(L46) | |
| | | 260°C; 2 h | |
| | | Heißextraktion: Ethylacetat | |
| I2-Ir₂(L46) | L46 | I2-Ir₂(L46) | 26% |
| | | Heißextraktion: Ethylacetat | |
| I1-Ir₂(L47) | L47 | 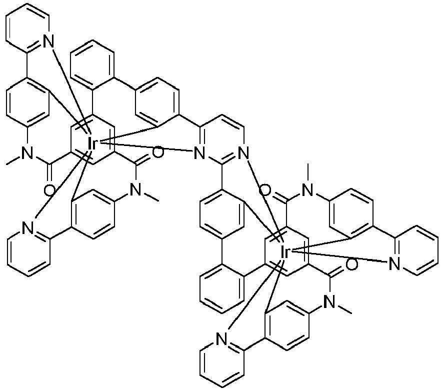 | 25% |
| | | I1-Ir₂(L47) | |
| | | 250°C; 2 h | |
| | | UK: DMF | |
| I2-Ir₂(L47) | L47 | I2-Ir₂(L47) | 28% |
| | | UK: DMF | |
| I1-Ir₂(L48) | L48 | 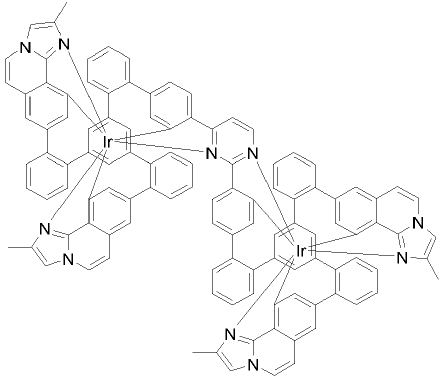 | 23% |
| | | I1-Ir₂(L48) | |
| | | 270°C; 2 h | |
| | | Heißextraktion: Butylacetat | |
| I2-Ir₂(L48) | L48 | I2-Ir₂(L48) | 21% |
| | | Heißextraktion: Ethylacetat | |
| I1-Ir₂(L49) | L49 | 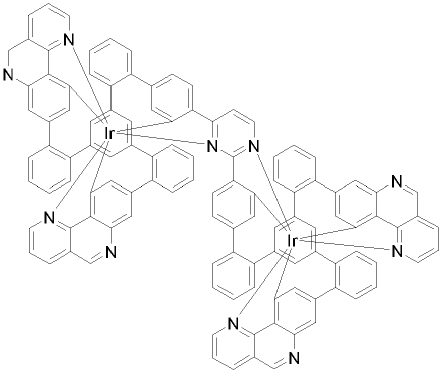 | 32% |
| | | I1-Ir₂(L49) | |
| | | 270°C; 2 h | |
| | | Heißextraktion: o-Xylol | |
| I2-Ir₂(L49) | L49 | I2-Ir₂(L49) | 30% |
| | | Heißextraktion: Toluol | |
| I1-Ir₂(L-50) | L50 | 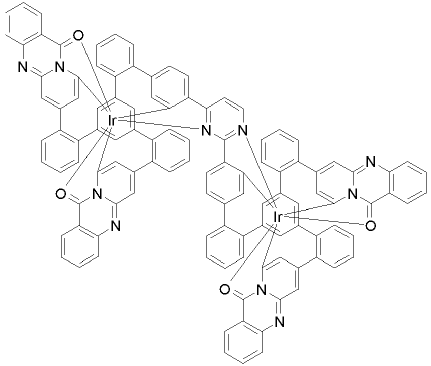 | 27% |
| | | I1-Ir₂(L50) | |
| | | 240°C; 2 h | |
| | | Heißextraktion: Etylacetat/Acetonitril 1:1 | |
| I2-Ir₂(L50) | L50 | I2-Ir₂(L50) | 25% |
| | | Heißextraktion: Etylacetat/Acetonitril 1:1 | |
| I1-Ir₂(L51 ) | L51 | 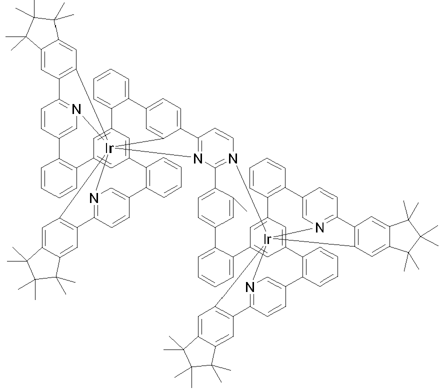 | 24% |
| | | I1-Ir₂(L51 ) | |
| | | 260°C; 2 h | |
| | | Heißextraktion: Cyclohexan | |
| I2-Ir₂(L51 ) | L51 | I2-Ir₂(L51) | 23% |
| | | Heißextraktion: Cyclohexan | |
| Ir₃(L52) | L52 | 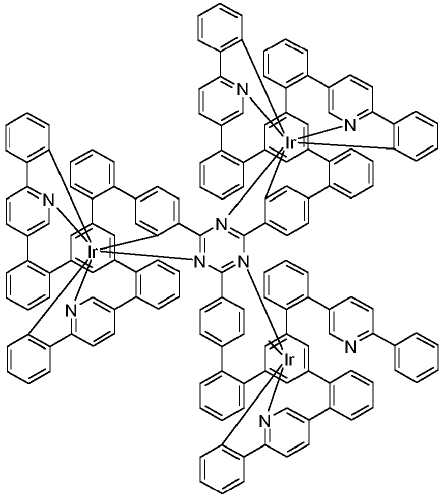 | 33% |
| | | Ir₂(L52) | |
| | | 3 equiv. Ir(acac)₃, 260°C; 7 h | |
| | | Es entsteht nur das Racemat aus ΛΛΛ- und ΔΔΔ-Isomer | |
| | | Heißextraktion: Toluol | |
| Ir₃(L53) | L53 | 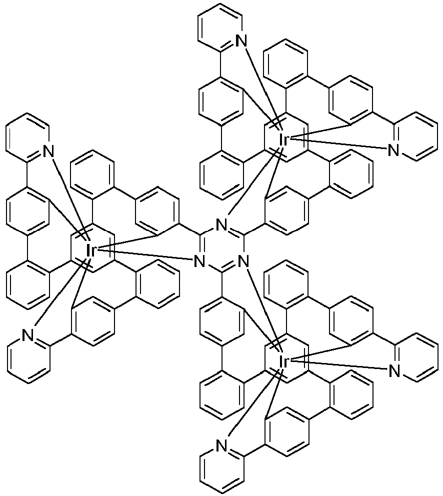 | 30% |
| | | Ir₂(L53) | |
| | | 3 equiv. Ir(acac)₃, 260°C; 7 h | |
| | | Heißextraktion: o-Xylol | |
| | | Es entsteht nur das Racemat aus ΛΛΛ- und ΔΔΔ-Isomer. | |
| Ir₃(L54) | L54 | 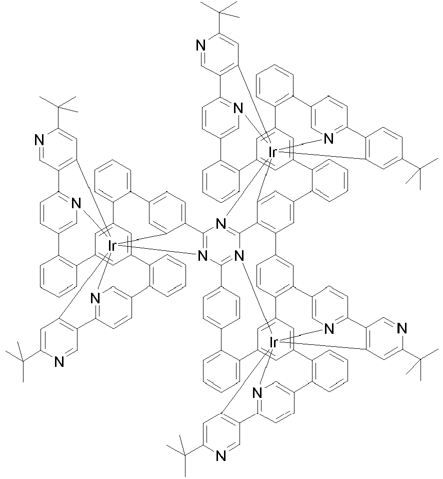 | 29% |
| | | Ir₂(L54) | |
| | | 3 equiv. Ir(acac)₃, 270°C; 6 h | |
| | | Heißextraktion: n-Butylacetat | |
| | | Es entsteht nur das Racemat aus ΛΛΛ- und ΔΔΔ-Isomer. | |
| Ir₃(L55) | L55 | 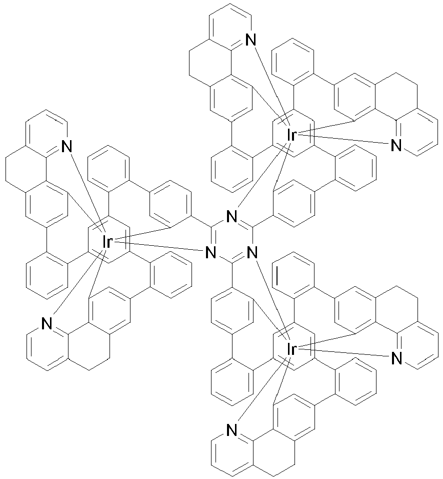 | 28% |
| | | Ir₂(L55) | |
| | | 3 equiv. Ir(acac)₃, 270°C; 6 h | |
| | | Heißextraktion: p-Xylol | |
| | | Es entsteht nur das Racemat aus ΛΛΛ- | |
| | | und ΔΔΔ-Isomer. | |
| Ir₃(L56) | L56 | 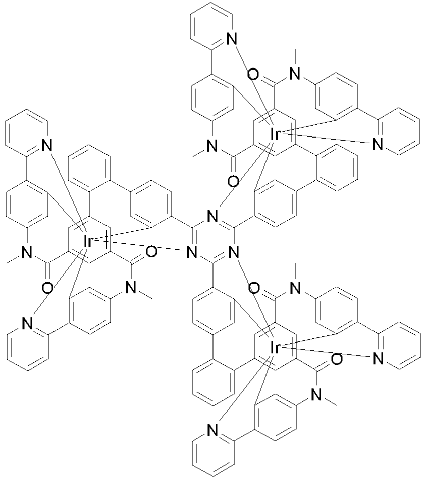 Ir₂(L56) | 26% |
| | | 3 equiv. Ir(acac)₃, 265°C; 6 h | |
| | | Umkristallisation: Dimethylacetamid | |
| | | Es entsteht nur das Racemat aus ΛΛΛ- und ΔΔΔ-Isomer. | |
| I1-Ir₂(L58) | L58 | 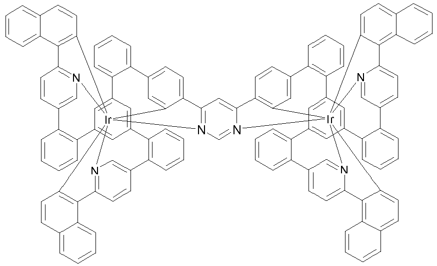 | 24% |
| | | I1-Ir₂(L58) | |
| | | 250°C, 2 h | |
| | | Heißextraktion: Toluol | |
| I2-Ir₂(L58) | L58 | I2-Ir₂(L58) | 27% |
| | | Heißextraktion: Toluol | |
| Ir₂(L59) | L59 | 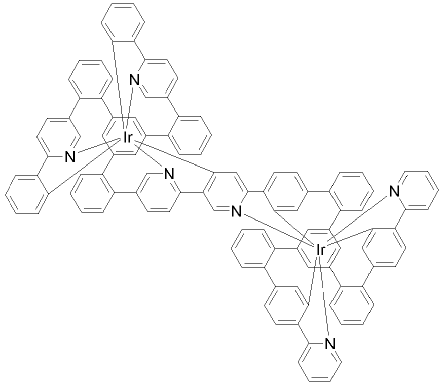 | 52% |
| | | Ir₂(L59) | |
| | | 265°C, 4 h | |
| | | Es ensteht ein Gemisch aus 8 | |
| | | Isomeren, welches nicht aufgetrennt, sondern als Mischung verwendet wird. | |
| | | Heißextraktion: Toluol | |
| Ir₂(L60) | L60 | 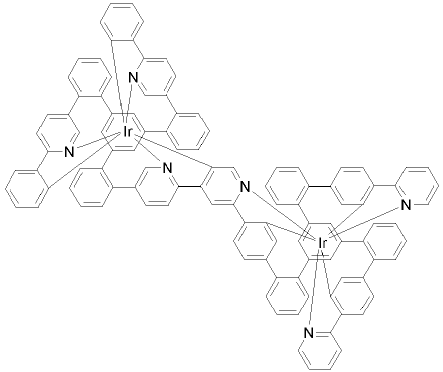 | 29% |
| | | Ir₂(L60) | |
| | | 260°C, 4 h | |
| | | Es ensteht ein Gemisch aus 8 | |
| | | Isomeren, wird nicht aufgetrennt sondern als Mischung weiter verwendet | |
| | | Heißextraktion: Ethylacetat | |
| Ir₂(L61 ) | L61 | 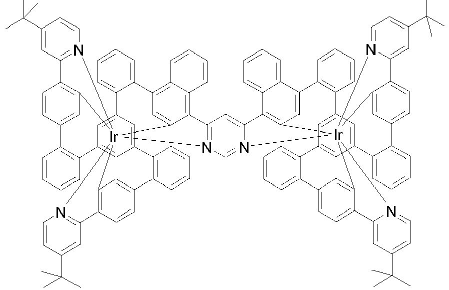 | 50% |
| | | Ir₂(L61) | |
| | | 250°C, 8 h | |
| | | Es bildet sich aus sterischen Gründen nur das Enantiomerenpaar aus ΔΔ und ΛΛ. | |
| I1-Ir₂(L62) | L62 | 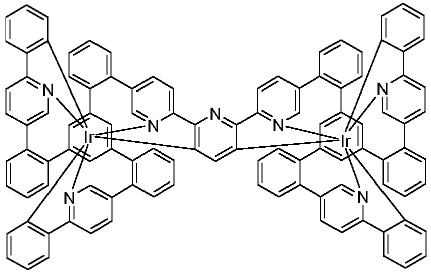 | 24% |
| | | I1-Ir₂(L62) | |
| | | 265°C, 6 h | |
| | | Heißextraktion: Dichlormethan | |
| I2-Ir₂(L62) | L62 | I2-Ir₂(L62) | 26% |
| | | Heißextraktion: Dichlormethan | |
| I1-Ir₂(L63) | L63 | 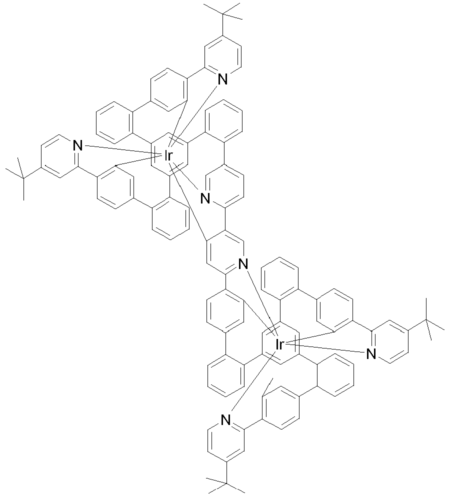 | 30% |
| | | I1-Ir₂(L63) | |
| | | 260°C, 4 h | |
| | | Heißextraktion: Ethylacetat | |
| I2-Ir₂(L63) | L63 | 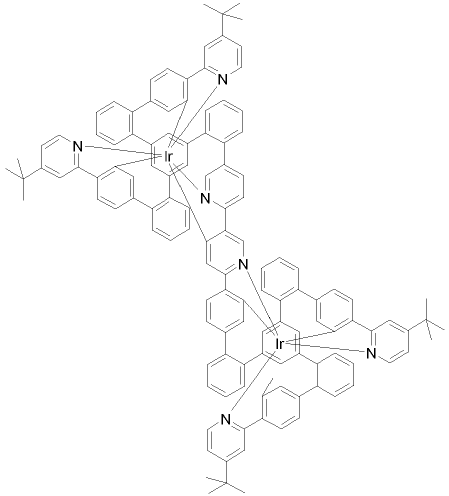 | 28% |
| | | I2-Ir₂(L63) | |
| | | Heißextraktion: Toluol | |
| I1-Ir₂(L64) | L64 | 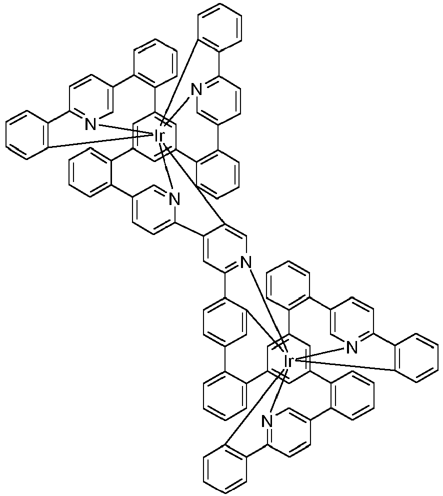 | 25% |
| | | I1-Ir₂(L64) | |
| | | 260°C, 4 h | |
| | | Heißextraktion: Toluol | |
| I2-Ir₂(L64) | L64 | I2-Ir₂(L64) | 26% |
| | | Heißextraktion: Toluol | |
| Ir₂(L65) | L65 | 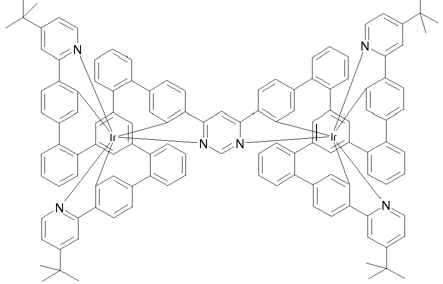 | 58% |
| | | Ir₂(L65) | |
| | | 250°C, 2 h | |
| | | Heißextraktion: Ethylacetat | |
| | | Es bildet sich aus sterischen Gründen nur das Enantiomerenpaar aus ΔΔ und ΛΛ. | |
| I1-Ir₂(L66) | L66 | 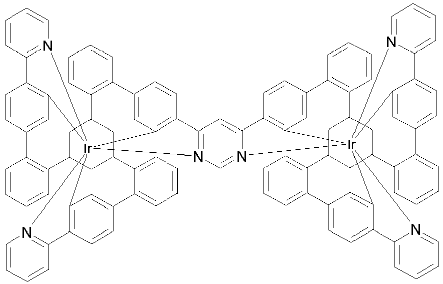 | 25% |
| | | I1-Ir₂(L66) | |
| | | 250°C, 2 h | |
| | | Heißextraktion: Toluol | |
| I2-Ir₂(L66) | L66 | I2-Ir₂(L66) | 25% |
| | | Heißextraktion: Toluol | |
| I1-Ir₂(L67) | L67 | 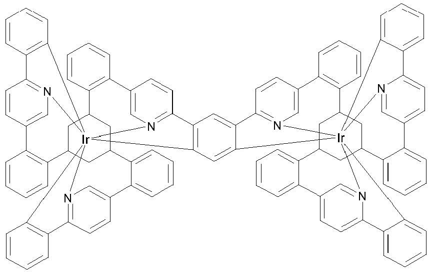 | 23% |
| | | I1-Ir₂(L67) | |
| | | 250°C, 2 h | |
| | | Heißextraktion: Ethylacetat | |
| I2-Ir₂(L67) | L67 | I2-Ir₂(L67) | 24% |
| | | Heißextraktion: n-Butylacetat | |
| I1-Ir₂(L68) | L68 | 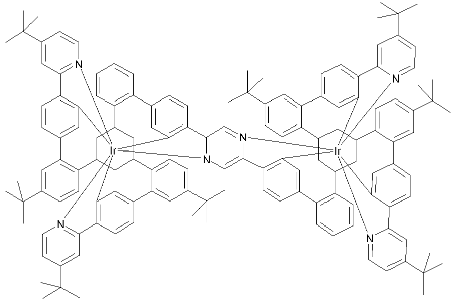 | 21% |
| | | I1-Ir₂(L68) | |
| | | 250°C, 2 h | |
| | | Heißextraktion: Ethylacetat | |
| I2-Ir₂(L68) | L68 | I2-Ir₂(L68) | 24% |
| | | Heißextraktion: Ethylacetat | |
| Ir₃(L69) | L69 | 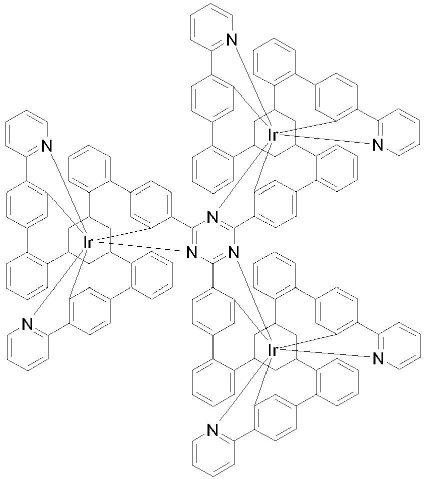 | 17% |
| | | Ir₂(L69) | |
| | | 3 equiv. Ir(acac)₃, 260°C; 5 h | |
| | | Heißextraktion: Toluol | |
| | | Es entsteht nur das Racemat aus ΛΛΛ- und ΔΔΔ-Isomer. | |
| I1-Ir₂(L70) | L70 | 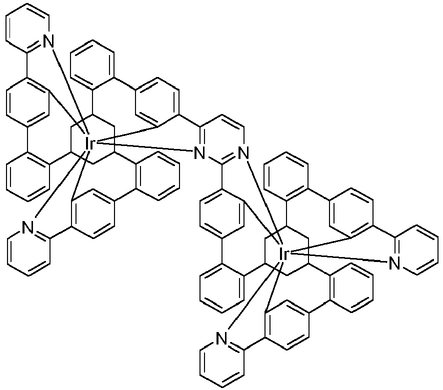 | 26% |
| | | I1-Ir₂(L70) | |
| | | 250°C; 2 h | |
| | | Heißextraktion: Ethylacetat | |
| I2-Ir₂(L-70) | L70 | I2-Ir₂(L70) | 28% |
| | | Heißextraktion: Ethylacetat | |
| I1-Ir₂(L71 ) | L71 | 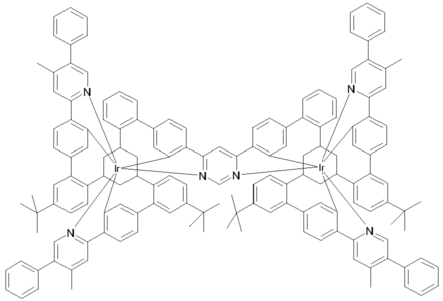 | 22% |
| | | I1-Ir₂(L71 ) | |
| | | 250°C, 2 h | |
| | | Heißextraktion: Ethylacetat | |
| I2-Ir₂(L71) | L71 | I2-Ir₂(L71) | 21% |
| | | Heißextraktion: Ethylacetat/Acetonitril | |
| | | 3:1 | |
| I1-Ir₂(L72) | L72 | 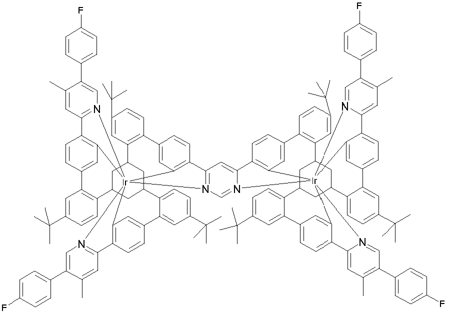 | 20% |
| | | I1-Ir₂(L72) | |
| | | 250°C, 2 h | |
| | | Heißextraktion: Toluol | |
| I2-Ir₂(L72) | L72 | I2-Ir₂(L72) | 25% |
| | | Heißextraktion: Toluol | |
| I1-Ir₂(L73) | L73 | 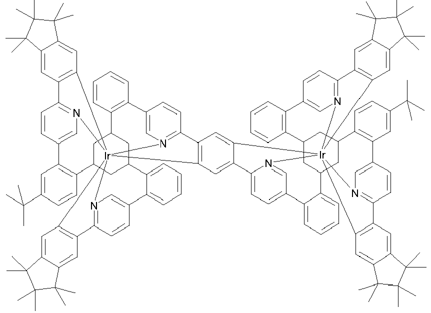 | 23% |
| | | I1-Ir₂(L73) | |
| | | 250°C, 2 h | |
| | | Heißextraktion: Cylcohexan | |
| I2-Ir₂(L73) | L73 | I2-Ir₂(L73) | 19% |
| | | Heißextraktion: Ethylacetat/Acetonitril 1:1 | |
| | | 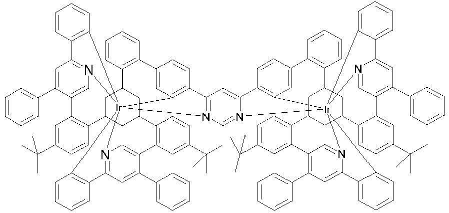 | |
| I1-Ir₂(L74) | L74 | I1-Ir₂(L74) | 21% |
| | | 250°C, 2 h | |
| | | Heißextraktion: Ethylacetat | |
| I2-Ir₂(L74) | L74 | I2-Ir₂(L74) | 24% |
| | | Heißextraktion: n-Butylacetat | |
| | | 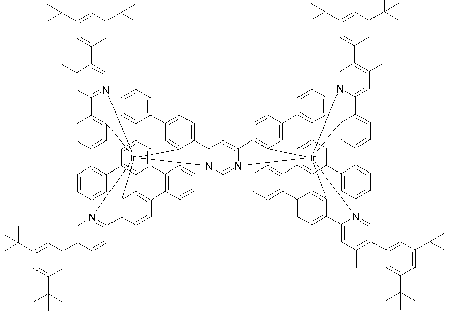 | |
| I1-Ir₂(L75) | L75 | I1-Ir₂(L75) | 22% |
| | | 265 °C, 4 h | |
| | | Heißextraktion: Ethylacetat/Acetonitril 2:1 | |
| I2-Ir₂(L75) | L75 | I2-Ir₂(L75) | 16% |
| | | Heißextraktion: n-Butylacetat | |
| I1-Ir₂(L76) | L76 | 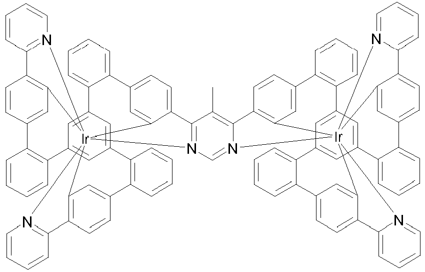 | 21% |
| | | I1-Ir₂(L76) | |
| | | 250°C, 3 h | |
| | | Heißextraktion: Toluol | |
| I2-Ir₂(L76) | L76 | I2-Ir₂(L76) | 19% |
| | | Heißextraktion: Toluol | |

### D: Funktionalisierung der Metallkomplexe

### 1) Halogenierung der Iridium-Komplexe:

Eine Lösung bzw. Suspension von 10 mmol eines Komplexes, der in para-Position zum Iridium A x C-H-Gruppen (mit A = 1-6) trägt, in 500 ml bis 2000 ml Dichlormethan (DCM), je nach Löslichkeit des Metallkomplexes, wird unter Licht- und Luftausschluss bei -30 bis +30 °C mit A x 10.5 mmol N-Halogensuccinimid (Halogen: Cl, Br, I) versetzt und 20 h gerührt. In DCM schlecht lösliche Komplexe können auch in anderen Lösungsmitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 100 ml Methanol ausgekocht, der Feststoff wird abgesaugt, dreimal mit 30 ml Methanol gewaschen und im Vakuum getrocknet. Man erhält so die in para-Position zum Iridium halogenierten Iridium-Komplexe. Komplexe mit einem HOMO (CV) von ca. -5.1 bis -5.0 eV und betragsmäßig kleiner neigen zur Oxidation (Ir(III) → Ir(IV)), wobei das Oxidationsmittel Brom, freigesetzt aus NBS, ist. Diese Oxidationsreaktion ist durch eine deutliche Grünfärbung oder Braunfärbung der ansonsten gelben bis roten Lösung/Suspension der Komplexe zu erkennen. In solchen Fällen werden 1-2 weitere Äquivalente NBS zugesetzt. Zur Aufarbeitung setzt man 300-500 ml Methanol und 4 ml HydrazinHydrat als Reduktionsmittel zu, wodurch sich die grüne bzw. braune Lösung/Suspension gelb bzw. rot verfärbt (Reduktion Ir(IV) → Ir(III)). Dann zieht man im Vakuum das Lösungsmittel weitgehend ab, versetzt mit 300 ml Methanol, saugt den Feststoff ab, wäscht dreimal mit je 100 ml Methanol und trocknet im Vakuum.

Unterstöchiometrische Bromierungen, z. B. Mono- und Dibromierungen von Komplexen mit 3 C-H-Gruppen para-Position zum Iridium, verlaufen meist weniger selektiv als die stöchiometrischen Bromierungen. Die Rohprodukte dieser Bromierungen können chromatographisch (CombiFlash Torrent der Fa. A. Semrau) getrennt werden.

### Synthese von I1-Ir₂(L1-6Br):

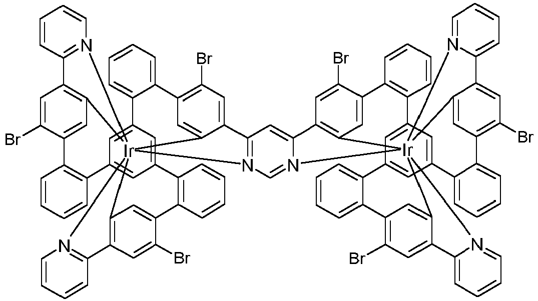

Eine Suspension von 18.3 g (10 mmol) I1-Ir₂(L1) in 2000 ml DCM wird auf einmal mit 8.9 g (80 mmol) N-Bromsuccinimid (NBS) versetzt und dann 20 h gerührt. Es werden 4 mL Hydrazinhydrat und anschließend 300 mL MeOH zugegeben. Das Dichlormethan wird im Vakuum weitgehend abgezogen. Beim Abrotieren des Dichlormethans fällt aus dem verbleibenden Methanol ein roter Feststoff aus, dieser wird abgesaugt und dreimal mit ca. 50 ml Methanol gewaschen und im Vakuum getrocknet. Ausbeute: 21.9 g (9.5 mmol) 95 %; Reinheit: > 99.0 %ig nach NMR.

Analog können folgende Verbindungen synthetisiert werden

| Bsp. | Edukt | Produkt Menge Halogensuccinimid | AusBeute* |
|---|---|---|---|
| I2-Ir₂(L1-6Br) | I1-Ir₂(L1) | 0.02 equiv HBr (aq), 10 equiv. NBS I2-Ir₂(L1-6Br): | 90% |
| I1-Ir₂(L2-6Br) | I1-Ir₂(L2) | 0.02 equiv. HBr (aq), 8 equiv. NBS | 92% |
| | | I2-Ir₂(L2-6Br) | |
| I2-Ir₂(L2-6Br) | I2-Ir₂(L2) | 0.02 equiv HBr (aq), 8 equiv. NBS I2-Ir₂(L2-6Br) | 91% |
| Ir₂(L4-6Br) | Ir₂(L4) | 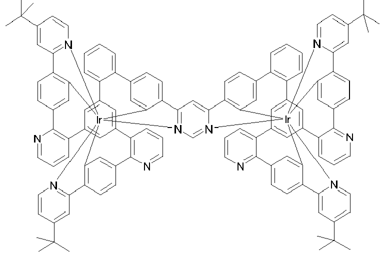 | 93% |
| | | Ir₂(L4-6Br) | |
| | | 8 equiv. NBS | |
| I1-Ir₂(L5-6Br) | I1-Ir₂(L5) | I1-Ir₂(L5-6Br) 6.6 equiv. NBS | 80% |
| I2-Ir₂(L5-6Br) | I2-Ir₂(L5) | I2-Ir₂(L5-6Br) 7.5 equiv. NBS | 82% |
| I1-Ir₂(L6-6Br) | I1-Ir₂(L6) | I1-Ir₂(L6-6Br) 6.6 equiv. NBS | 81% |
| I2-Ir₂(L6-6Br) | I2-Ir₂(L6) | I2-Ir₂(L6-6Br) 8 equiv. NBS | 77% |
| I1-Ir₂(L8-6Br) | I1-Ir₂(L8) | I1-Ir₂(L8-6Br) 8 equiv. NBS | 78% |
| I2-Ir₂(L8-6Br) | I2-Ir₂(L8) | I2-Ir₂(L8-6Br) 0.02 equiv HBr (aq), 7 equiv. NBS | 82% |
| I1-Ir₂(L9-6Br) | I1-Ir₂(L9) | I1-Ir₂(L9-6Br) 8 equiv. NBS | 90% |
| I2-Ir₂(L9-6Br) | I2-Ir₂(L9) | I2-Ir₂(L9-6Br) 8 equiv. NBS | 86% |
| Ir₂(L10-6Br) | Ir₂(L10) | 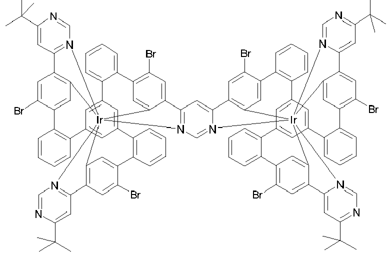 | 96%% |
| | | Ir₂(L10-6Br) | |
| | | 6.6 equiv. NBS | |
| I1-Ir₂(L 11-6Br) | I1-Ir₂(L11) | I1-Ir₂(L11-6Br) | 88% |
| | | 8 equiv. NBS | |
| I2-Ir₂(L11-6Br) | I2-Ir₂(L11) | I2-Ir₂(L11-6Br) | 88% |
| | | 0.02 equiv. HBr (aq), 7 equiv. NBS | |
| I1-Ir₂(L12-6Br) | I1-Ir₂(L12) | 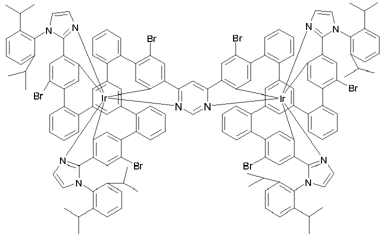 | 92% |
| | | I1-Ir₂(L12-6Br) | |
| | | 8 equiv. NBS | |
| I2-Ir₂(L12-6Br) | I2-Ir₂(L12) | I2-Ir₂(L12-6Br) 8 equiv. NBS | 90% |
| I1-Ir₂(L13-6Br) | I1-Ir₂(L13) | I1-Ir₂(L13-6Br) 10 equiv. NBS | 90% |
| I2-Ir₂(L13-6Br) | I2-Ir₂(L13) | I1-Ir₂(L13-6Br) 0.02 equiv. HBr (aq), 10 equiv. NBS | 94% |
| I1-Ir₂(L 15-2Br) | I1-Ir₂(L15) | 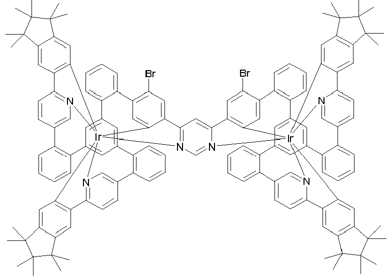 | 90% |
| | | I1-Ir₂(L15-2Br) | |
| | | 2.2 equiv. NBS | |
| I2-Ir₂(L15-2Br) | I2-Ir₂(L15) | I2-Ir₂(L15-2Br) 2.2 equiv. NBS | 83% |
| I1-Ir₂(L16-4Br) | I1-Ir₂(L16) | 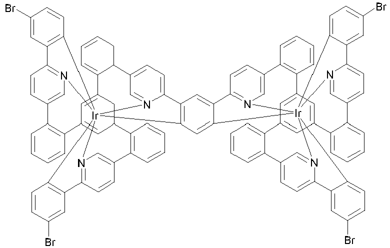 | 89% |
| | | I1-Ir₂(L16-4Br) | |
| | | 5 equiv. NBS | |
| I2-Ir₂(L16-4Br) | I2-Ir₂(L16) | I2-Ir₂(L16-4Br) 4.5equiv. NBS | 87% |
| I1-Ir₂(L17-4Br) | I1-Ir₂(L17) | 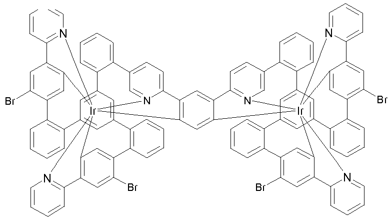 | 80% |
| | | I1-Ir₂(L17-4Br) | |
| | | 4.4 equiv. NBS | |
| I2-Ir₂(L17-4Br) | I2-Ir₂(L17) | I2-Ir₂(L17-4Br) | 82% |
| | | 4.4 equiv. NBS | |
| I1-Ir₂(L21-4Br) | I1-Ir₂(L21) | I1-Ir₂(L21-4Br) | 75% |
| | | 5 equiv. NBS | |
| I2-Ir₂(L21-4Br) | I2-Ir₂(L21) | I2-Ir₂(L21-4Br) | 72% |
| | | 5 equiv. NBS | |
| I1-Ir₂(L22-4Br) | I1-Ir₂(L22) | I1-Ir₂(L22-4Br) | 81% |
| | | 4.4 equiv. NBS | |
| I2-Ir₂(L22-4Br) | I2-Ir₂(L22) | I2-Ir₂(L22-4Br) | 79% |
| | | 4.4 equiv. NBS | |
| I1-Ir₂(L23-6Br) | I1-Ir₂(L23) | 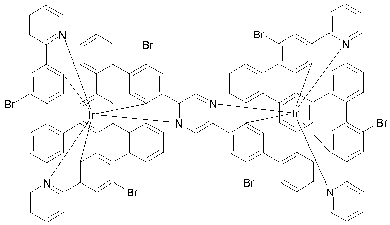 | 91% |
| | | I1-Ir₂(L23-6Br) | |
| | | 7 equiv. NBS | |
| I2-Ir₂(L23-6Br) | I2-Ir₂(L23) | 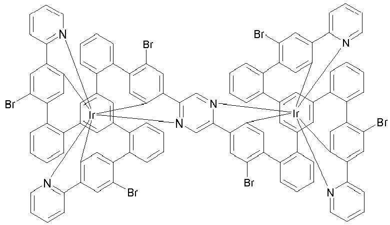 | 89% |
| | | I2-Ir₂(L23-6Br) | |
| | | 6.6 equiv. NBS | |
| I1-Ir₂(L24-6Br) | I1-Ir₂(L24) | I1-Ir₂(L24-6Br) | 84% |
| | | 7 equiv. NBS, 0.02 equiv. HBr (aq) | |
| I2-Ir₂(L24-6Br) | I2-Ir₂(L24) | I2-Ir₂(L24-6Br) | 80% |
| | | 7 equiv. NBS, 0.02 equiv. HBr (aq) | |
| I1-Ir₂(L25-6Br) | I1-Ir₂(L25) | I1-Ir₂(L25-6Br) | 90% |
| | | 7 equiv. NBS | |
| I2-Ir₂(L25-6Br) | I2-Ir₂(L25) | I2-Ir₂(L25-6Br) | 97% |
| | | 7 equiv. NBS | |
| I1-Ir₂(L27-6Br) | I1-Ir₂(L27) | I1-Ir₂(L27-6Br) | 82% |
| | | 7 equiv. NBS | |
| I2-Ir₂(L27-6Br) | I2-Ir₂(L27) | I2-Ir₂(L27-6Br) | 83% |
| | | 7 equiv. NBS | |
| I1-Ir₂(L28-6Br) | I1-Ir₂(L28) | I1-Ir₂(L28-6Br) | 81% |
| | | 8 equiv. NBS | |
| I2-Ir₂(L28-6Br) | I2-Ir₂(L28) | I2-Ir₂(L28-6Br) | 77% |
| | | 7.5 equiv. NBS | |
| I1-Ir₂(L29-6Br) | I1-Ir₂(L29) | I1-Ir₂(L29-6Br) | 84% |
| | | 10 equiv. NBS | |
| I2-Ir₂(L29-6Br) | I2-Ir₂(L29) | I2-Ir₂(L29-6Br) | 86% |
| | | 10 equiv. NBS | |
| I1-Ir₂(L30-6Br) | I1-Ir₂(L30) | I1-Ir₂(L30-6Br) | 81% |
| | | 8 equiv. NBS | |
| I2-Ir₂(L30-6Br) | I2-Ir₂(L30) | I2-Ir₂(L30-6Br) | 76% |
| | | 8 equiv. NBS | |
| I1-Ir₂(L31-6Br) | I1-Ir₂(L31 ) | I1-Ir₂(L31-6Br) | 92% |
| | | 8 equiv. NBS, 0.02 equiv. HBr (aq) | |
| I2-Ir₂(L31-6Br) | I2-Ir₂(L31) | I2-Ir₂(L31-6Br) | 95% |
| | | 8 equiv. NBS, 0.05 equiv. HBr (aq) | |
| I1-Ir₂(L33-6Br) | I1-Ir₂(L33) | I1-Ir₂(L33-6Br) | 91% |
| | | 8 equiv. NBS, 0.01 equiv. HBr (aq) | |
| I2-Ir₂(L33-6Br) | I2-Ir₂(L33) | I2-Ir₂(L33-6Br) | 94% |
| | | 8 equiv. NBS, 0.01 equiv. HBr (aq) | |
| I1-Ir₂(L34-4Br) | I1-Ir₂(L34) | 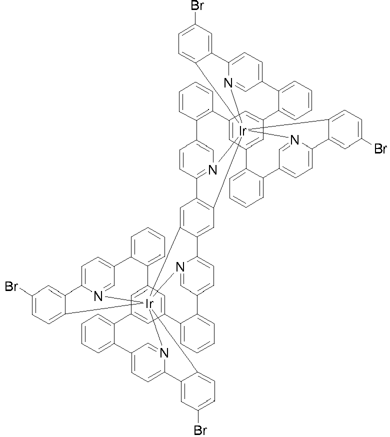 | 82% |
| | | I1-Ir₂(L34-4Br) | |
| | | 4.4 equiv NBS | |
| I2-Ir₂(L34-4Br) | I2-Ir₂(L34) | I2-Ir₂(L34-4Br) | 86% |
| | | 4.4 equiv NBS | |
| I1-Ir₂(L36-4Br) | I1-Ir₂(L36) | I1-Ir₂(L36-4Br) | 93% |
| | | 5 equiv. NBS, 0.02 equiv. HBr (aq) | |
| I2-Ir₂(L36-4Br) | I2-Ir₂(L36) | I2-Ir₂(L36-4Br) | 91% |
| | | 4.4 equiv. NBS | |
| I1-Ir₂(L38-4Br) | I1-Ir₂(L38) | I1-Ir₂(L38-4Br) | 85% |
| | | 4.4 equiv. NBS | |
| I2-Ir₂(L38-4Br) | I2-Ir₂(L38) | I2-Ir₂(L38-4Br) | 91% |
| | | 4.4 equiv. NBS | |
| I1-Ir₂(L39-4Br) | I1-Ir₂(L39) | I1-Ir₂(L39-4Br) | 75% |
| | | 4.4 equiv. NBS | |
| I2-Ir₂(L39-4Br) | I2-Ir₂(L39) | I2-Ir₂(L39-4Br) | 74% |
| | | 4.4 equiv. NBS | |
| I1-Ir₂(L40-4Br) | I1-Ir₂(L40) | I1-Ir₂(L40-4Br) | 78% |
| | | 5 equiv. NBS | |
| I2-Ir₂(L40-4Br) | I2-Ir₂(L40) | I2-Ir₂(L40-4Br) | 77% |
| | | 5 equiv. NBS | |
| I1-Ir₂(L41-4Br) | I1-Ir₂(L41) | I1-Ir₂(L41-4Br) | 85% |
| | | 5 equiv. NBS, 0.01 equiv. HBr (aq) | |
| I2-Ir₂(L41-4Br) | I2-Ir₂(L41) | I2-Ir₂(L41-4Br) | 88% |
| | | 6 equiv. NBS, 0.01 equiv. HBr (aq) | |
| I1-Ir₂(L42-4Br) | I1-Ir₂(L42) | I1-Ir₂(L42-4Br) | 90% |
| | | 4.4 equiv. NBS, 0.01 equiv. HBr (aq) | |
| I2-Ir₂(L42-4Br) | I2-Ir₂(L42) | I2-Ir₂(L42-4Br) | 86% |
| | | 4.4 equiv. NBS, 0.01 equiv. HBr (aq) | |
| I1-Ir₂(L43-6Br) | I1-Ir₂(L43) | 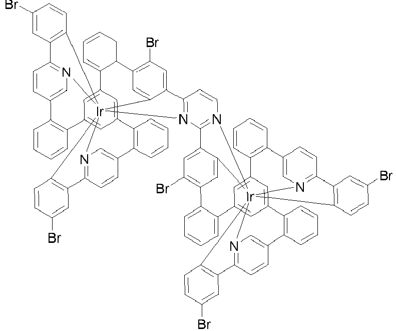 | 90% |
| | | I1-Ir₂(L43-6Br) | |
| | | 8 equiv. NBS, 0.01 equiv. HBr (aq) | |
| I2-Ir₂(L43-6Br) | I2-Ir₂(L43) | I2-Ir₂(L43-6Br) | 85% |
| | | 8 equiv. NBS, 0.01 equiv. HBr (aq) | |
| I1-Ir₂(L44-6Br) | I1-Ir₂(L44) | I1-Ir₂(L44-6Br) | 89% |
| | | 8 equiv. NBS | |
| I2-Ir₂(L44-6Br) | I2-Ir₂(L44) | I2-Ir₂(L44-6Br) | 93% |
| | | 8 equiv. NBS, 0.01 equiv. HBr (aq) | |
| I1-Ir₂(L47-6Br) | I1-Ir₂(L47) | I1-Ir₂(L47-6Br) | 82% |
| | | 8 equiv. NBS | |
| I2-Ir₂(L47 -6Br) | I2-Ir₂(L47) | I2-Ir₂(L47 -6Br) | 81% |
| | | 8 equiv. NBS, 0.01 equiv. HBr (aq) | |
| I1-Ir₂(L50-6Br) | I1-Ir₂(L50) | I1-Ir₂(L50-6Br) | 82% |
| | | 8 equiv. NBS | |
| I2-Ir₂(L50-6Br) | I2-Ir₂(L50) | I2-Ir₂(L50-6Br) | 81% |
| | | 8 equiv. NBS, 0.01 equiv. HBr (aq) | |
| I1-Ir₂(L66-6Br) | I1-Ir₂(L66) | 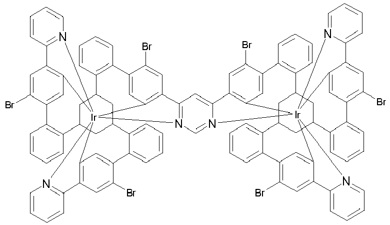 | 94% |
| | | I1-Ir₂(L66-6Br) | |
| | | 8 equiv. NBS | |
| I2-Ir₂(L66-6Br) | I2-Ir₂(L66) | I2-Ir₂(L66-6Br) 8 equiv. NBS, 0.1 equiv. HBr (aq) | 94% |
| I1-Ir₂(L91-4Br) | I1-Ir₂(L91 ) | 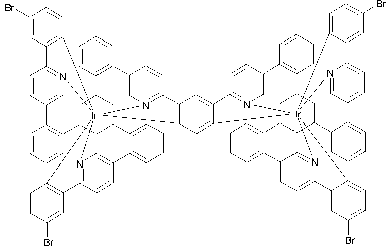 | 90% |
| | | I1-Ir₂(L91-4Br) | |
| | | 5 equiv. NBS | |
| I2-Ir₂(L91-4Br) | I2-Ir₂(L91) | I2-Ir₂(L91-4Br) | 92% |
| | | 5 equiv. NBS | |
| I1-Ir₂(L92-6Br) | | 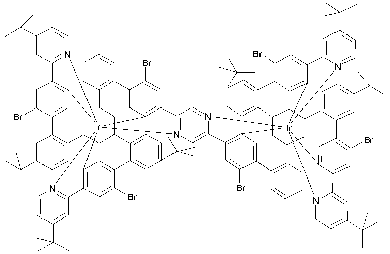 | 88% |
| | | I1-Ir₂(L92) | |
| | | 8 equiv. NBS | |
| I2-Ir₂(L92-6Br) | | I2-Ir₂(L92-6Br) | 86% |
| | | 8 equiv. NBS | |
| I1-Ir₂(L70-6Br) | I1-Ir₂(L70) | 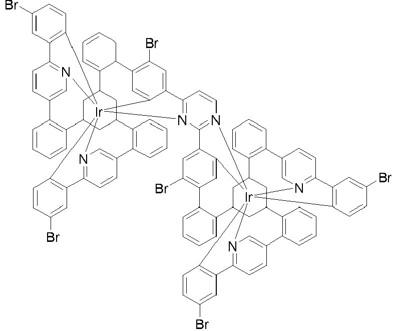 | 81% |
| | | I1-Ir₂(L70-6Br) | |
| | | 10 equiv. NBS, 0.02 equiv. HBr (aq) | |
| I2-Ir₂(L70-6Br) | I2-Ir₂(L70) | I2-Ir₂(L70-6Br) | 78% |
| | | 10 equiv. NBS | |
| I1-Ir₂(L71-6Br) | I1-Ir₂(L71 ) | 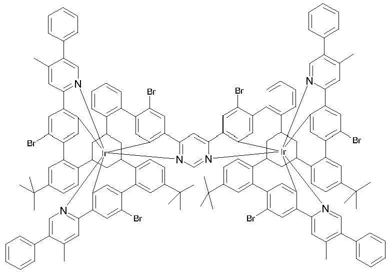 | 96% |
| | | I1-Ir₂(L71-6Br) | |
| | | 6.6 equiv. NBS | |
| I2-Ir₂(L71-6Br) | I2-Ir₂(L71) | I2-Ir₂(L71-6Br) | 96% |
| | | 6.6 equiv. NBS | |
| I1-Ir₂(L72-6Br) | I1-Ir₂(L72) | I1-Ir₂(L72-6Br) | 91% |
| | | 8 equiv. NBS | |
| I2-Ir₂(L72-6Br) | I2-Ir₂(L72) | I2-Ir₂(L72-6Br) | 92% |
| | | 8 equiv. NBS | |

### 2) Suzuki-Kupplung an den bromierten Iridium-Komplexen Variante A, zweiphasige Reaktionsmischung:

Eine Suspension von 10 mmol eines bromierten Komplexes, 12-20 mmol Boronsäure bzw. Boronsäureester pro Br-Funktion und 60-100 mmol Trikaliumphosphat in einem Gemisch aus 300 ml Toluol, 100 ml Dioxan und 300 ml Wasser wird mit 0.6 mmol Tri-o-tolylphosphin und dann mit 0.1 mmol Palladium(II)acetat versetzt und 16 h unter Rückfluss erhitzt. Nach Erkalten gibt man 500 ml Wasser und 200 ml Toluol zu, trennt die wässrige Phase ab, wäscht die organische Phase dreimal mit 200 ml Wasser und einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Methanol zu, saugt vom ausgefallenen Rohprodukt ab, wäscht dieses dreimal mit je 50 ml Methanol und trocknet im Vakuum. Das Rohprodukt wird an Kieselgel gesäult auf einem Säulenautomaten (Torrent der Firma Semrau). Anschließend wird der Komplex durch Heißextraktion in Lösungsmitteln wie Ethylacetat, Toluol, Dioxan, Acetonitril, Cyclohexan, ortho- oder para-Xylol, n-Butylacetat etc. weiter gereinigt. Alternativ kann aus diesen Lösungsmitteln sowie Hochsiedern wie Dimethylformamid, Dimethylsulfoxid oder Mesitylen umkristallisiert werden. Der Metallkomplex wird abschließend getempert oder sublimiert. Das Tempern erfolgt im Hochvakuum (p ca. 10⁻⁶ mbar) im Temperaturbereich von ca. 200-300 °C.

### Variante B, einphasige Reaktionsmischung:

Eine Suspension von 10 mmol eines bromierten Komplexes, 12-20 mmol Boronsäure bzw. Boronsäureester pro Br-Funktion und 100-180 mmol einer Base (Kaliumfluorid, Trikaliumphosphat (wasserfrei oder Monohydrat oder Trihydrat), Kaliumcarbonat, Cäsiumcarbonat, etc.) und 100 g Glaskugeln (3 mm Durchmesser) in 100-500 ml eines aprotischen Lösungsmittels (THF, Dioxan, Xylol, Mesitylen, Dimethylacetamid, NMP, DMSO, etc.) wird mit 0.2 mmol Tetrakis(triphenylphosphin)palladium(0) [14221-01-3] versetzt und 24 h unter Rückfluss erhitzt. Alternativ können andere Phosphine wie Triphenylphosphin, Tri-tert-butylphosphin, Sphos, Xphos, RuPhos, XanthPhos, etc. in Kombination mit Pd(OAc)₂ eingesetzt werden, wobei bei diesen Phosphinen das bevorzugte Phosphin:Palladium Verhältnis 3:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt, wie unter Variante A beschrieben.

### Synthese von Ir₂100:

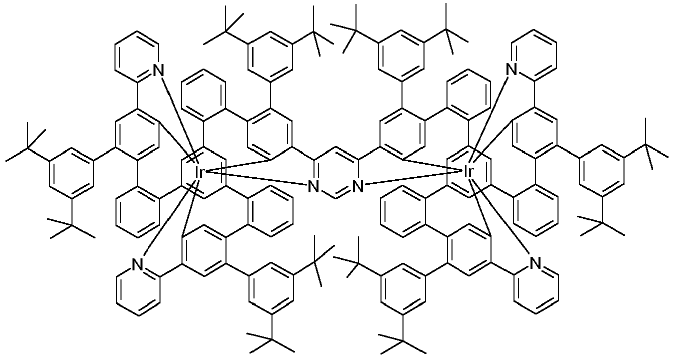

### Variante B:

Einsatz von 23.1 g (10.0 mmol) I1-Ir(L1-6Br) und 38.0 g (120.0 mmol) 2-(3,5-Di-tert-butylphenyl)-4,4,5,5-tetramethyl-1,3,2-dioxaborolan [1071924-13-4], 17.7 g (180 mmol) Trikaliumphosphat Monohydrat, 231 mg Tetrakis-(triphenylphosphin)palladium(0), 500 mL trockenes Dimethylsulfoxid, Rückfluss, 16 h. Zweimalige chromatographische Trennung an Kieselgel mit Toluol/Heptan (Säulenautomat, Torrent der Firma Axel Semrau), anschließend fünfmalige Heißextraktion mit Ethylacetat/Acetonitril 1:1. Ausbeute: 15.4 g (5.2 mmol) 52 %; Reinheit: ca. 99.9 %ig nach HPLC.

Analog können folgende Verbindungen dargestellt werden:

| Bsp. | **Edukt Variante/ Reaktionsbedingungen Boronsäure** | Produkt/Heißextratkionsmittel (HE) bzw. Umkristallisationsmittel (UK) | Ausbeute |
|---|---|---|---|
| Ir₂101 | I2-Ir(L1-6Br) Variante B Pd(OAc)₂/SPhos, 1:1.3, Cs₂CO₃, Dioxan | 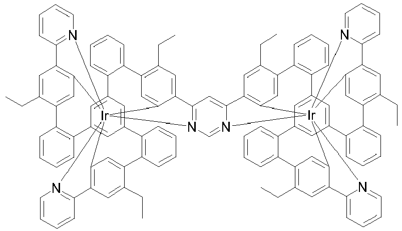 | 30% |
| | 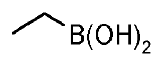 | | |
| | [4433-63-0] | HE: Ethylacetat | |
| Ir₂102 | I1-Ir(L2-6Br) Variante A wie in A beschrieben | 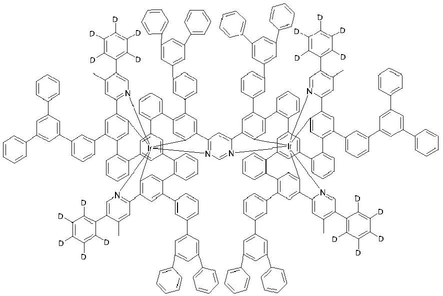 | 50% |
| | 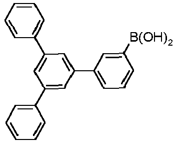 | | |
| | [1233200-59-3] | HE: Ethylacetat | |
| Ir₂105 | Ir₂(L4-6Br) Variante A | 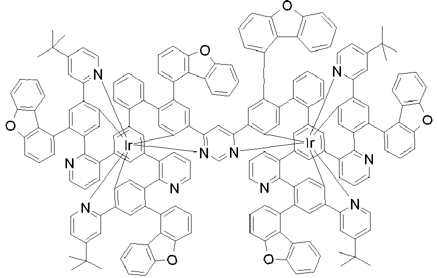 | 39% |
| | 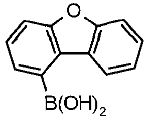 | | |
| | [162607-19-4] | HE:Toluol | |
| Ir₂107 | I1-Ir₂(L5-6Br) Variante A | 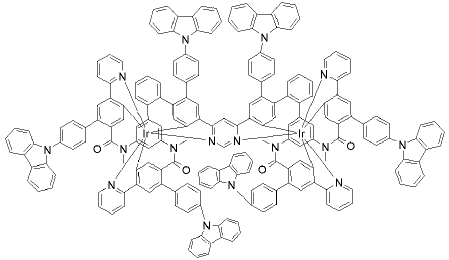 | 44% |
| | 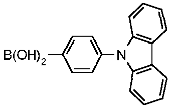 | | |
| | [419536-33-7] | HE: n-Butylacetat | |
| Ir₂108 | I2-Ir₂(L5-6Br) Variante A | 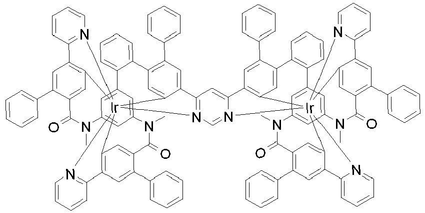 | 40% |
| | 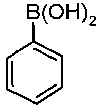 | | |
| | [98-80-6] | HE: n-Butylacetat | |
| Ir₂109 | I1-Ir₂(L6-6Br) Variante B Pd(OAc)₂/SPhos, 1:1.3, Cs₂CO₃, Dioxan | 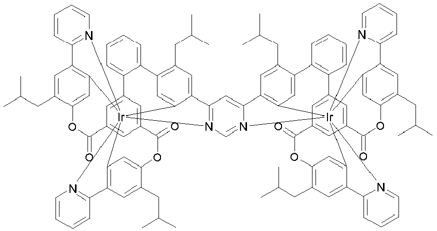 | 23% |
| | 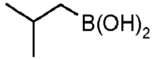 | | |
| | [84110-40-7] | Umkristallisaton: DMF | |
| Ir₂110 | I1-Ir₂(L8-6Br) | 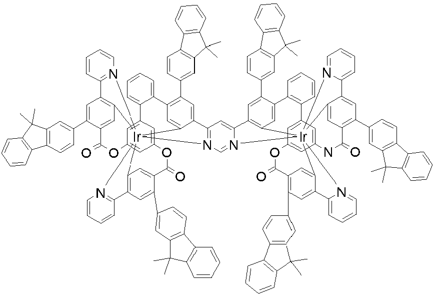 | 45% |
| | 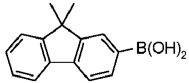 | | |
| | [333432-28-3] | HE: Toluol | |
| Ir₂111 | I1-Ir₂(L9-6Br) Variante B | 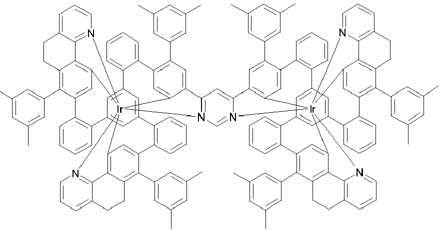 | 56% |
| | 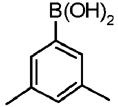 | | |
| | [172975-69-8] | HE: o-Xylol | |
| Ir₂112 | I2-Ir₂(L9-6Br) Variante B | 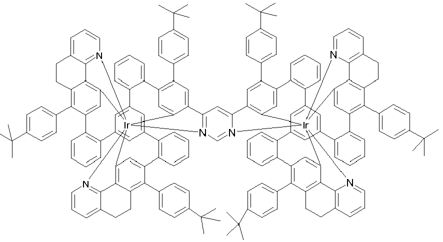 | 52% |
| | 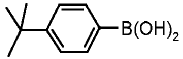 | | |
| | [123324-71-0] | HE:Toluol | |
| Ir₂113 | Ir₂(L10-6Br) Variante A | 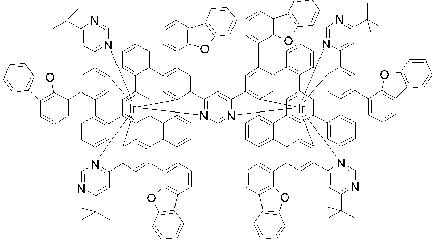 | 36% |
| | 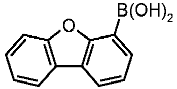 | | |
| | [100124-06-9] | HE:Toluol | |
| Ir₂115 | I2-Ir₂(L11-6Br) Variante B | 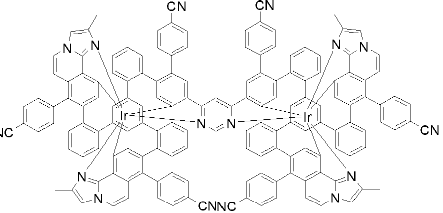 | 40% |
| | 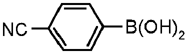 | | |
| | [126747-14-6] | I1-Ir₂(L11) UK: DMSO | |
| Ir₂116 | I1-Ir₂(L12-6Br) Variante B Pd(OAc)₂/Xanth phos, 1:1.3, K₂CO₃, Dioxan | 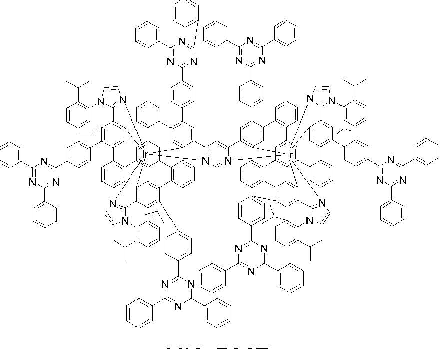 | 36% |
| | 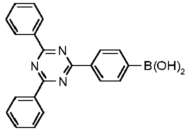 | | |
| | [1313018-07-3] | UK: DMF | |
| Ir₂117 | I1-Ir₂(L13-6Br) Variante B | 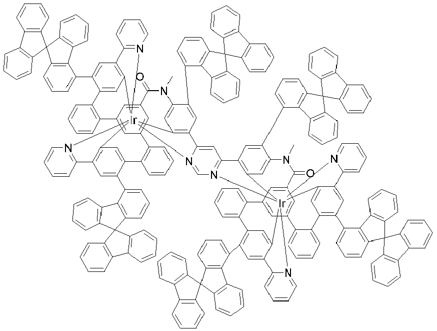 | 40% |
| | 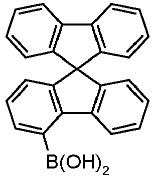 | | |
| | [1421789-05-0] | HE: Butylacetat | |
| Ir₂118 | I2-Ir₂(L13-6Br) Variante B P(o-Tol)₃/ Pd(OAc)₂ 6:1 | 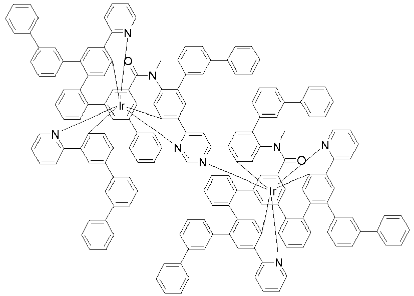 | 55% |
| | 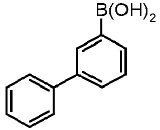 | | |
| | [5122-95-2] | HE:Toluol | |
| Ir₂119 | I1-Ir₂(L15-2Br) Pd(OAc)₂/S-Phos 1:1.3, KF, Dioxan | 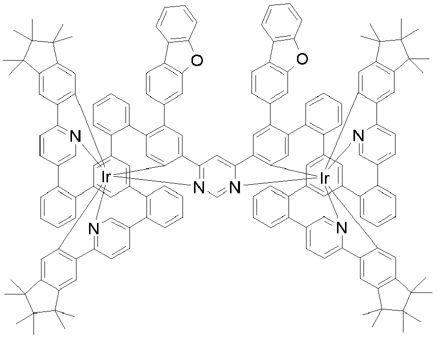 | 60% |
| | 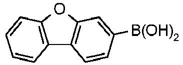 | | |
| | [395087-89-5] | HE: Ethylacetat | |
| Ir₂120 | I2-Ir₂(L15-2Br) Variante A: | 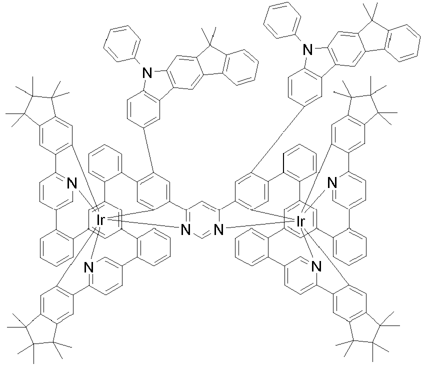 | 52% |
| | 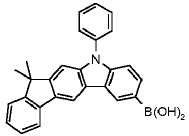 | | |
| | [1379585-25-7] | Heißextraktion: Toluol/Heptan 3:1 | |
| Ir₂121 | I1-Ir₂(L16-4Br) Variante A | 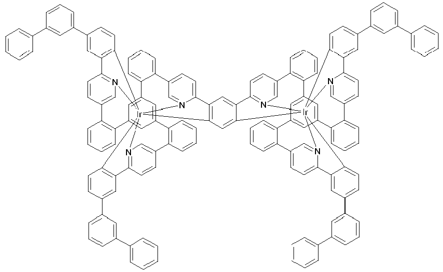 | 51% |
| | 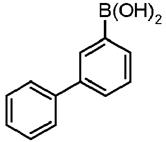 | | |
| | [5122-95-2] | Heißextraktion: Toluol | |
| Ir₂122 | I2-Ir₂(L16-4Br) Variante A | 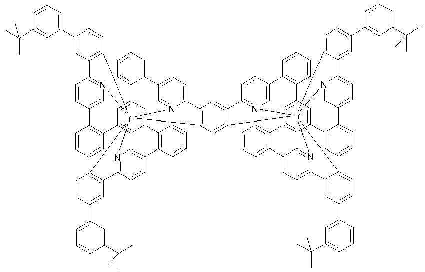 | 57% |
| | 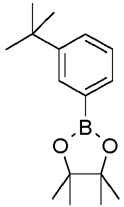 | | |
| | [627526-15-2] | Heißextraktion: Ethylacetat | |
| Ir₂123 | I1-Ir₂(L17-4Br) Variante B | 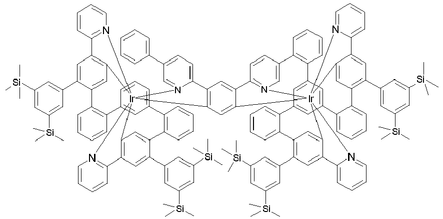 | 51% |
| | 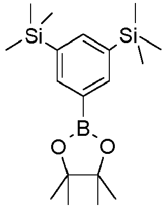 | | |
| | [1111096-37-7] | Heißextraktion: Ethylacetat | |
| Ir₂124 | I2-Ir₂(L17-4Br) Variante B | 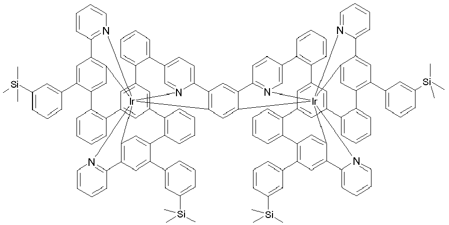 | 56% |
| | 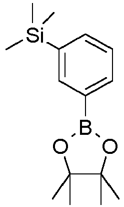 | | |
| | [1208070-18-1] | Heißextraktion:n-Butylacetat | |
| Ir₂125 | I1-Ir₂(L21-4Br) Variante B | 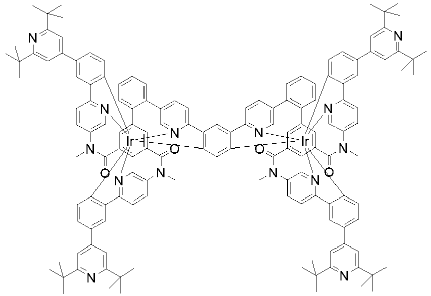 | 46% |
| | 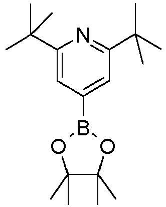 | | |
| | [1392146-23-4] | UK: Dioxan | |
| Ir₂126 | I2-Ir₂(L22-4Br) Variante B | 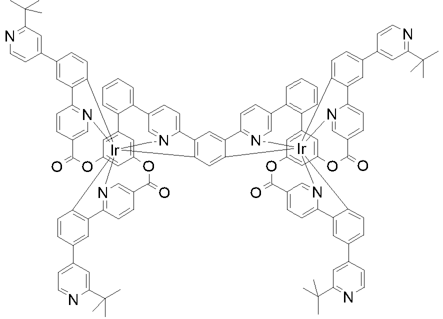 | 44% |
| | 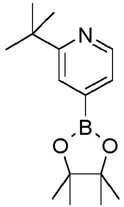 | | |
| | [1627722-65-9] | UK: DMF | |
| Ir₂127 | I1-Ir₂(L23-6Br) Variante B | 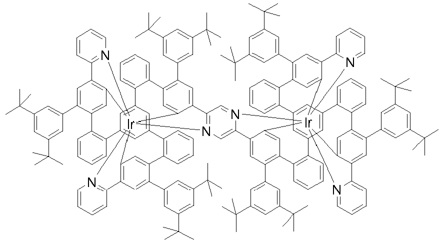 | 51% |
| | 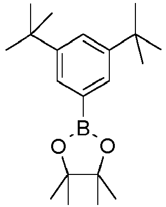 | | |
| | [1071924-13-4] | Heißextraktion: Cyclohexan | |
| Ir₂128 | I2-Ir₂(L23-6Br) Variante A | 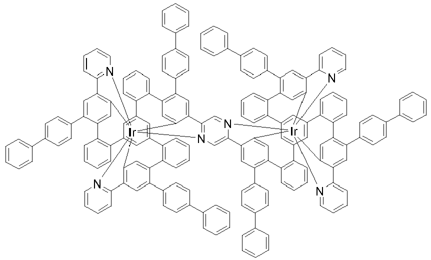 | 46% |
| | 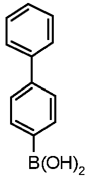 | | |
| | [5122-94-1] | Heißextraktion: Dichlormethan | |
| Ir₂129 | I1-Ir₂(L24-6Br) Variante A | 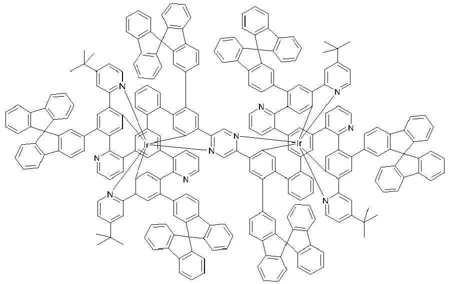 | 42% |
| | 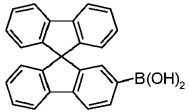 | | |
| | [236389-21-2] | Heißextraktion: Toluol | |
| Ir₂130 | I2-Ir₂(L24-6Br) Variante A | 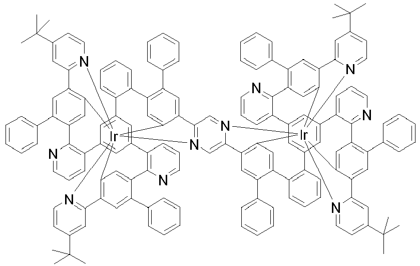 | 49% |
| | 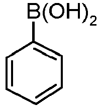 | | |
| | [98-80-6] | Heißextraktion: n-Butylacetat | |
| Ir₂131 | I1-Ir₂(L25-6Br) Variante A | 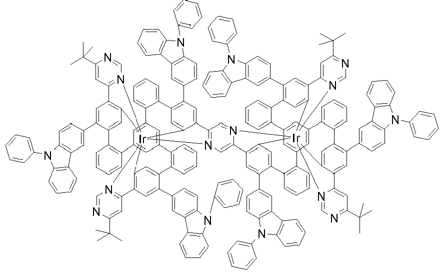 | 52% |
| | 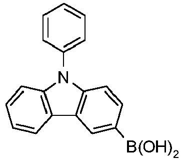 | | |
| | [854952-58-2] | Heißextraktion: Toluol | |
| Ir₂132 | I1-Ir₂(L25-6Br) Variante B Pd(OAc)₂/SPhos 1:1.3, Cs₂CO₃, Toluol | 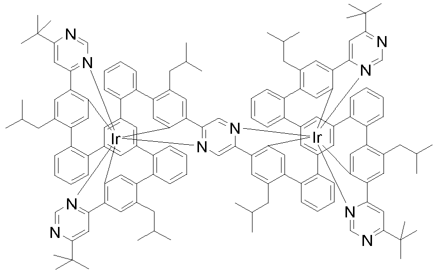 | 24% |
| | 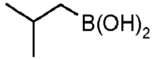 | | |
| | [84110-40-7] | HE: Ethylacetat/Acetonitril 3:1 | |
| Ir₂133 | I1-Ir₂(L28-6Br) Variante B | 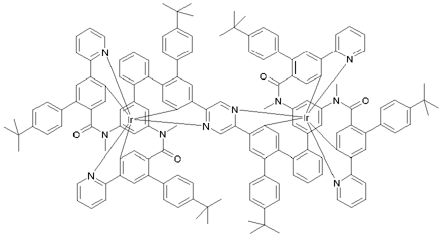 | 45% |
| | 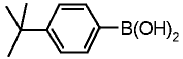 | | |
| | [123324-71-0] | I1-Ir₂(L28) HE: n-Butylacetat | |
| Ir₂134 | I2-Ir₂(L29-6Br) Pd(OAc)₂/SPhos, 1:1.3, Cs₂CO₃, Dioxan | 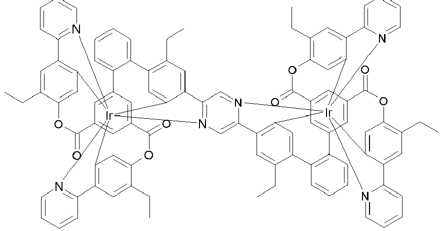 | 22% |
| | 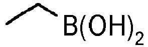 | | |
| | [4433-63-0] | Heißextraktion: Ethylacetat | |
| Ir₂135 | I1-Ir₂(L30-6Br) Variante A | 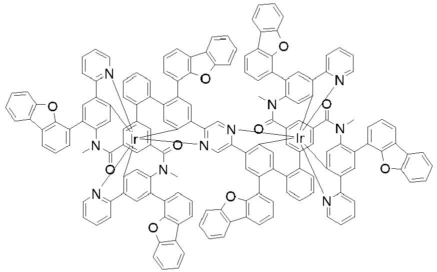 | 35% |
| | 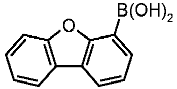 | | |
| | [100124-06-9] | HE: 1,4-Dioxan | |
| Ir₂136 | I1-Ir₂(L31-6Br) Variante A | 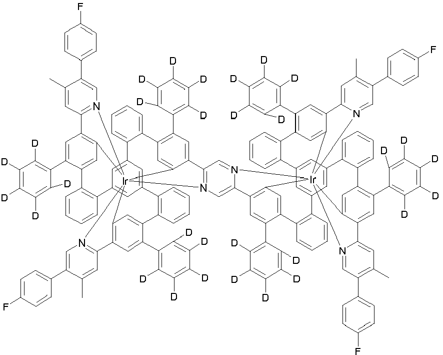 | 50% |
| | 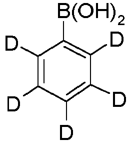 | | |
| | [215527-70-1] | Heißextraktion: Toluol | |
| Ir₂137 | I2-Ir₂(L31-6Br) Variante A | 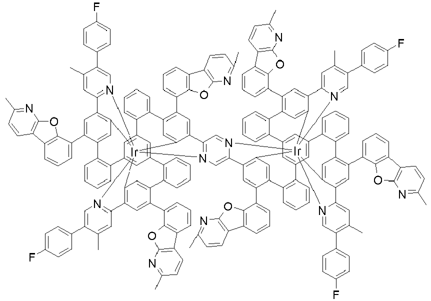 | 41% |
| | 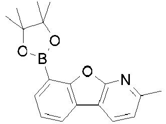 | | |
| | [1609374-04-0] | Heißextraktion: p-Xylol | |
| Ir₂139 | I1-Ir₂(L33-6Br) Variante A | 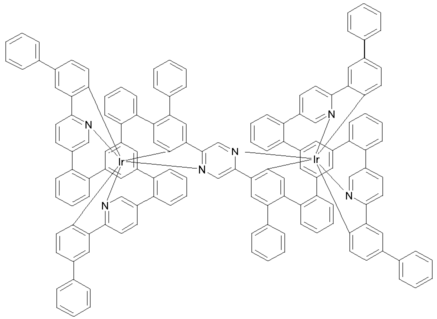 | 51% |
| | 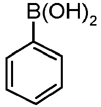 | | |
| | [98-80-6] | Heißextraktion: Toluol | |
| Ir₂140 | I1-Ir₂(L34-4Br) Variante B | 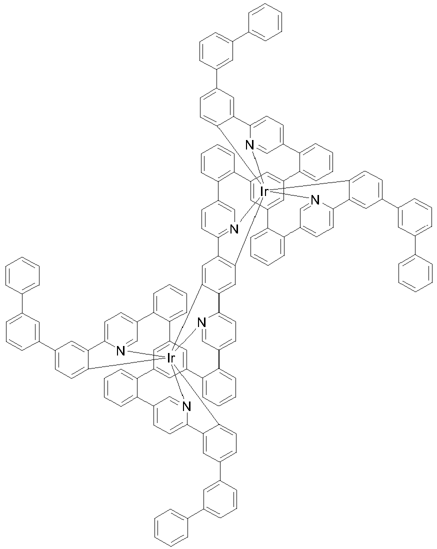 | 57% |
| | 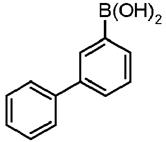 | | |
| | [5122-95-2] | Heißextraktion: n-Butylacetat | |
| Ir₂141 | I2-Ir₂(L34-4Br) Variante B Pd(OAc)₂/SPhos 1:1.3, K₃PO₄ x 3 H₂O, Toluol | 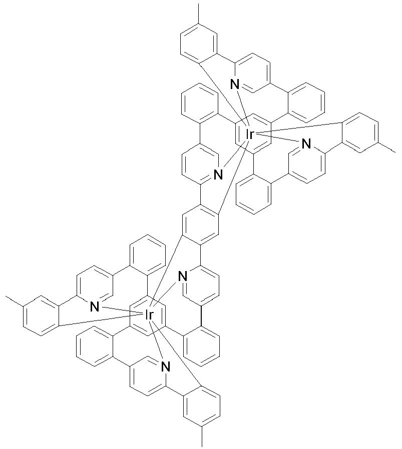 | 26% |
| | 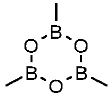 | | |
| | [823-96-1] | Heißextraktion: Ethylacetat | |
| Ir₂142 | I2-Ir₂(L38-4B3) Variante B | 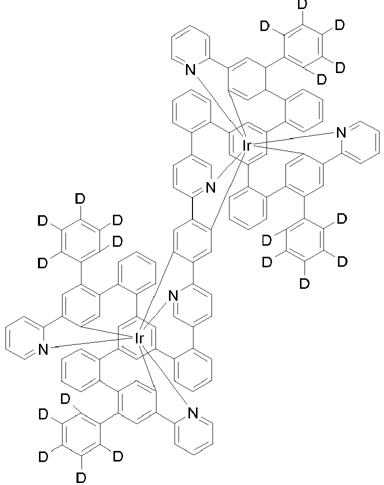 | 45% |
| | 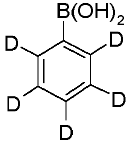 | | |
| | [215527-70-1] | Heißextraktion: Toluol | |
| Ir₂143 | I1-Ir₂(L39-4Br) Variante B | 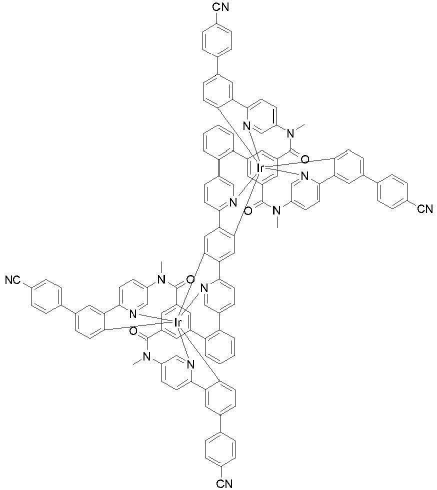 | 38% |
| | 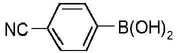 | | |
| | [126747-14-6] | | |
| | | UK: DMF | |
| Ir₂144 | I2-Ir₂(L40-4Br) Pd(OAc)₂/SPhos, 1:1.3, CsCO₃, Dioxan | 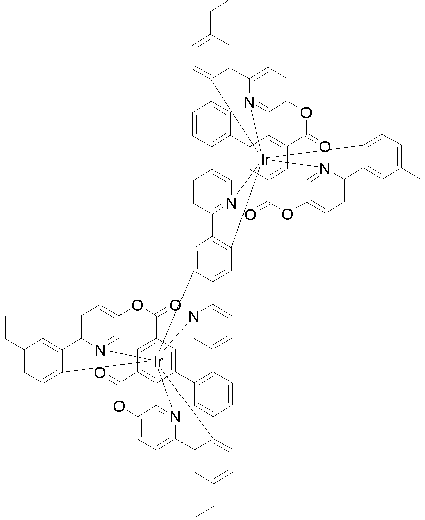 | 22% |
| | 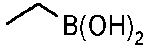 | | |
| | [4433-63-0] | | |
| | | UK: Dimethylacetamid | |
| Ir₂145 | I1-Ir₂(L41-4Br) Variante A | 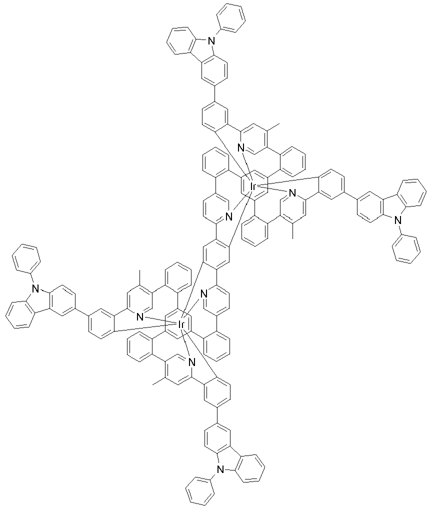 | 53% |
| | 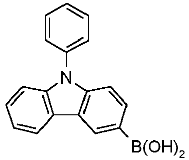 | | |
| | [854952-58-2] | Heißextraktion: Toluol | |
| Ir₂146 | I1-Ir₂(L42-4Br) Variante A | 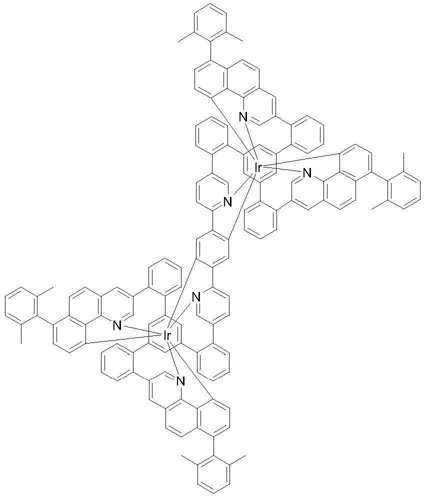 | 42% |
| | 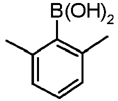 | | |
| | [100379-00-8] | Heißextraktion: Toluol | |
| Ir₂147 | I2-Ir₂(L42-4Br) Variante A | 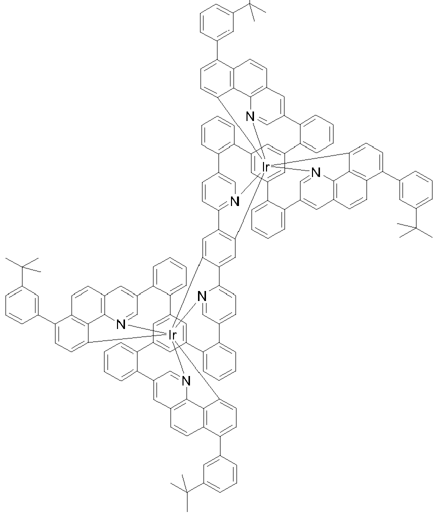 | 55% |
| | 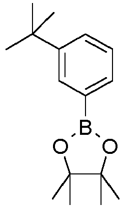 | | |
| | [627526-15-2] | I2-Ir₂(L42-4Br) Heißextraktion: Toluol | |
| Ir₂148 | I1-Ir₂(L43-6Br) Variante B | 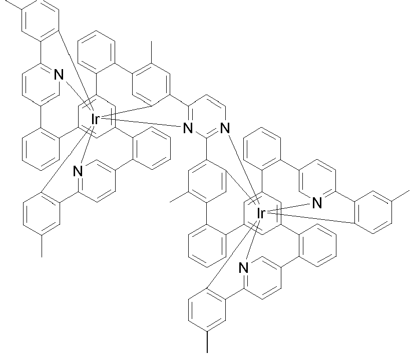 | 22% |
| | 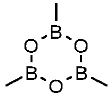 | | |
| | [823-96-1] | Heißextraktion: n-Butylacetat | |
| Ir₂149 | I1-Ir₂(L44-6Br) Variante B Pd(OAc)₂/SPhos, 1:1.3, Cs₂CO₃, Dioxan | 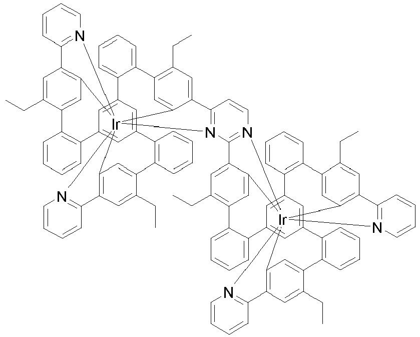 | 24% |
| | 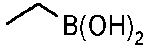 | | |
| | [4433-63-0] | Heißextraktion: n-Butylacetat | |
| Ir₂150 | I2-Ir₂(L44-6Br) Variante B | 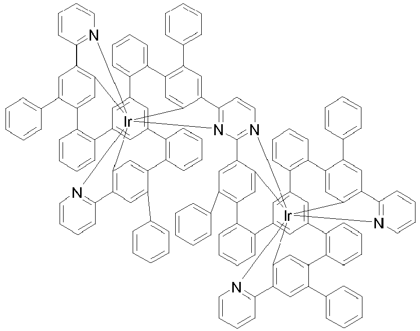 | 40% |
| | 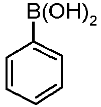 | | |
| | [98-80-6] | Heißextraktion: Toluol | |
| Ir₂151 | I2-Ir₂(L47-6Br) Variante B Pd(OAc)₂/SPhos 1:1.3, Cs₂CO₃, Toluol | 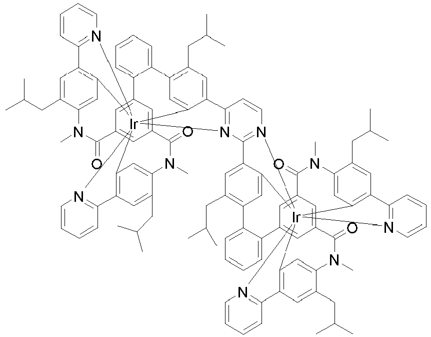 | 20% |
| | 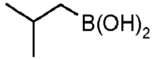 | | |
| | [84110-40-7] | Heißextraktion: Ethylacetat | |
| | I1-Ir₂(L66-6Br) Variante A | 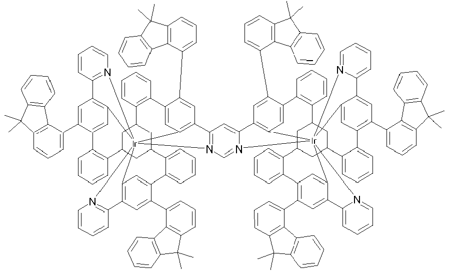 | 43% |
| Ir₂152 | 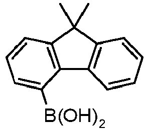 | | |
| | [1246022-50-3] | Heißextraktion: n-Butylacetat | |
| Ir₂153 | I2-Ir₂(L66-6Br) Variante B | 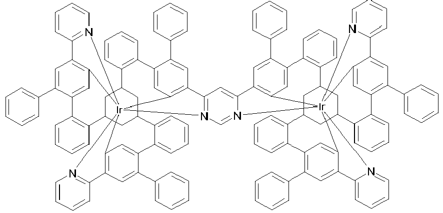 | 40% |
| | 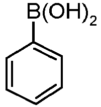 | | |
| | [98-80-6] | Heißextraktion:Toluol | |
| Ir₂154 | I1-Ir₂(L91-4Br) Variante B | 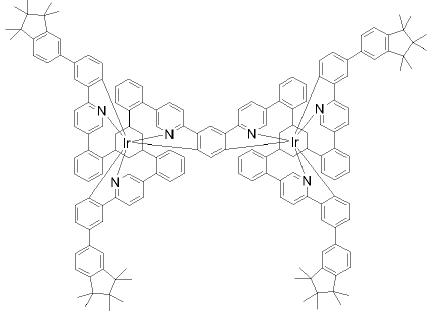 | 50% |
| | 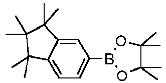 | | |
| | [1562418-16-9] | Heißextraktion: Ethylacetat | |
| Ir₂155 | I2-Ir₂(L91-4Br) Variante B | 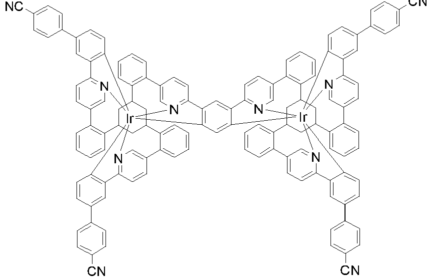 | 44% |
| | 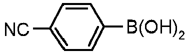 | | |
| | [126747-14-6] | Heißextraktion: n-Butylacetat | |
| Ir₂156 | I1-Ir₂(L92-6Br) Variante A | 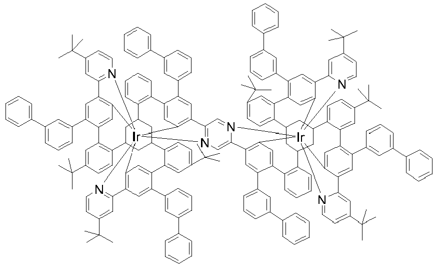 | 25% |
| | 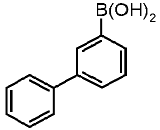 | | |
| | [5122-95-2] | I1-Ir₂(L92) Heißextraktion: Ethylacetat | |
| Ir₂157 | I2-Ir₂(L92-6Br) Variante B Pd(OAc)₂/SPhos 1:1.3, CsCO₃, Toluol | 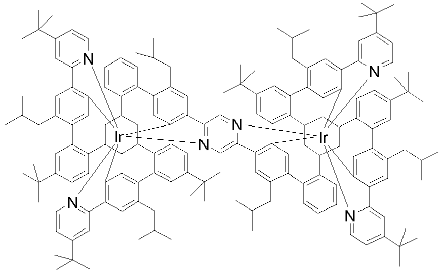 | 24% |
| | 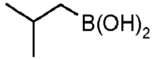 | | |
| | [84110-40-7] | Heißextraktion: Cyclohexan | |
| Ir₂158 | I1-Ir₂(L70-6Br) Variante A | 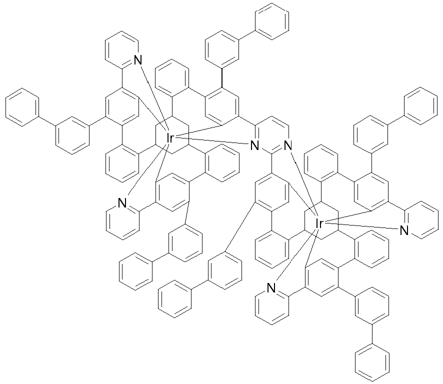 | 33% |
| | 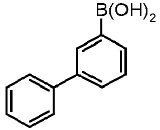 | | |
| | [5122-95-2] | Heißextraktion: n-Butylacetat | |
| Ir₂159 | I1-Ir₂(L71-6Br) Variante A | 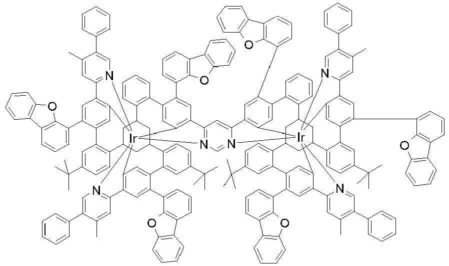 | |
| | 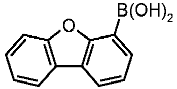 | | 36% |
| | [100124-06-9] | Heißextraktion: Toluol | |
| Ir₂160 | I1-Ir₂(L72-6Br) Variante B | 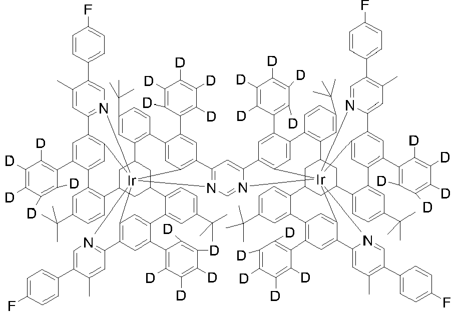 | 49% |
| | 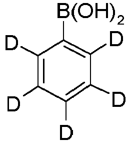 | | |
| | [215527-70-1] | Heißextraktion: Toluol | |
| Ir₂161 | I2-Ir₂(L72-6Br) Variante A | 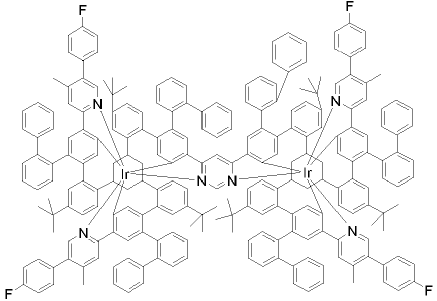 | 29% |
| | 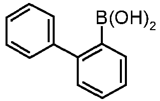 | | |
| | [4688-76-0] | Heißextraktion: Ethylacetat | |
| Ir₂162 | I1-Ir₂(L50-6Br) Variante A | 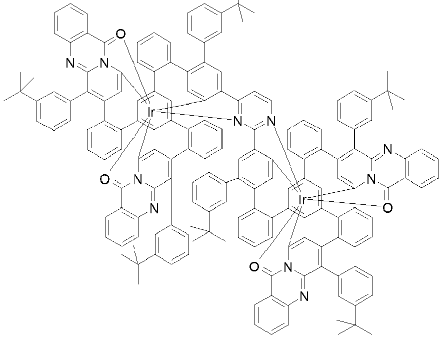 | |
| | 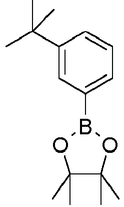 | | 38% |
| | [627526-15-2] | Heißextraktion: Cyclohexan | |
| Ir₂163 | I2-Ir₂(L33-6Br) Variante A | 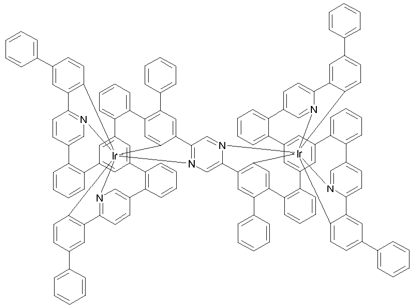 | 55% |
| | 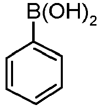 | | |
| | [98-80-6] | Heißextraktion: n-Butylacetat | |

Allgemeines Syntheseschema zur Darstellung weiterer Metallkomplexe P1 bis P240:

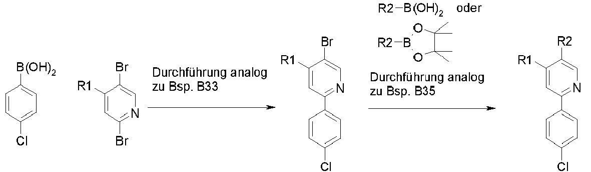

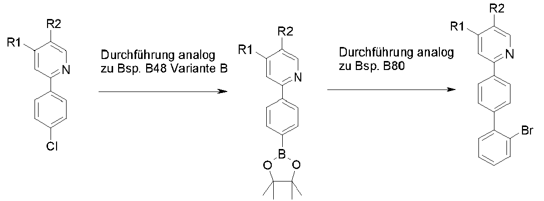

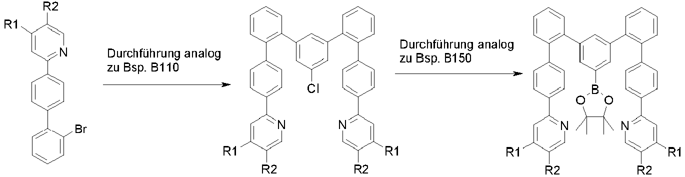

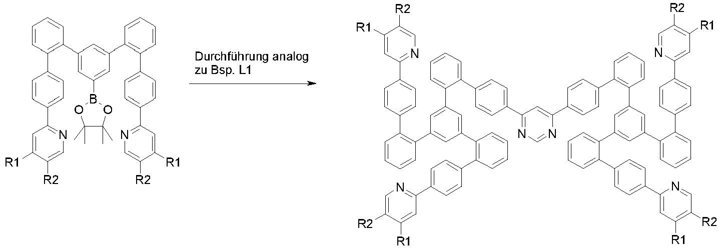

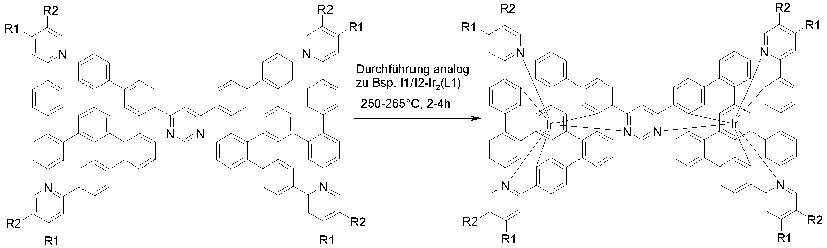

Die im Folgenden tabellarisch abgebildeten Metallkomplexe können ausgehend von den angegebenen Ausgangsmaterialien nach dem oben abgebildeten Syntheseschema dargestellt werden:

| Bsp. | Edukte | Produkt(e) |
|---|---|---|
| P1 | 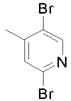 | 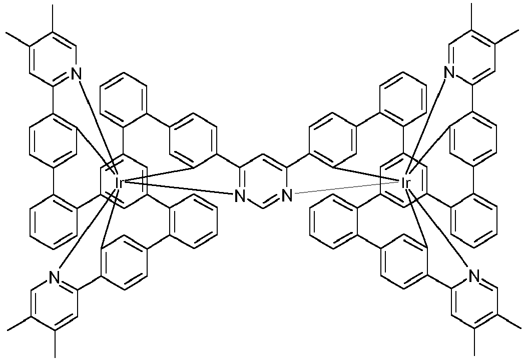 |
| | [3430-26-0] | |
| | 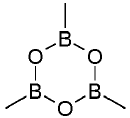 | |
| | [823-96-1] | |
| P2 | [3430-26-0] | 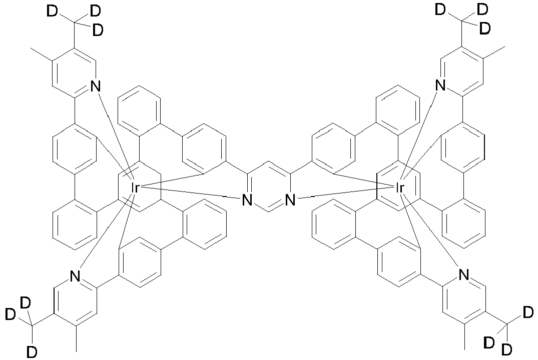 |
| | 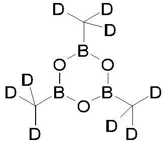 | |
| | [1321518-31-3] | |
| P3 | [3430-26-0] | 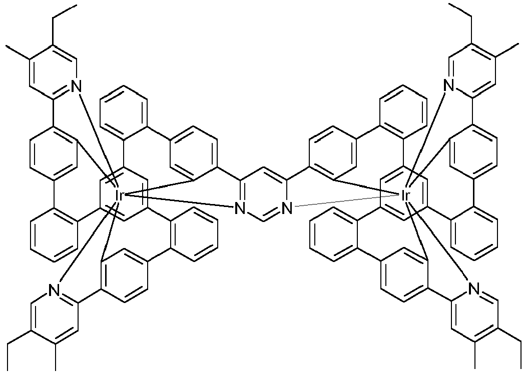 |
| | 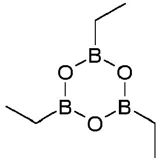 | |
| | [3043-60-5] | |
| P4 | [3430-26-0] | 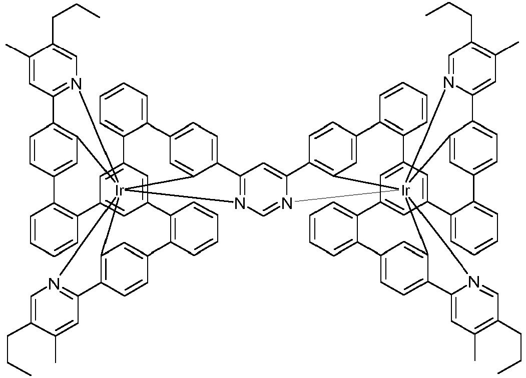 |
| | 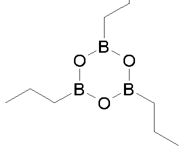 | |
| | [7325-08-8] | 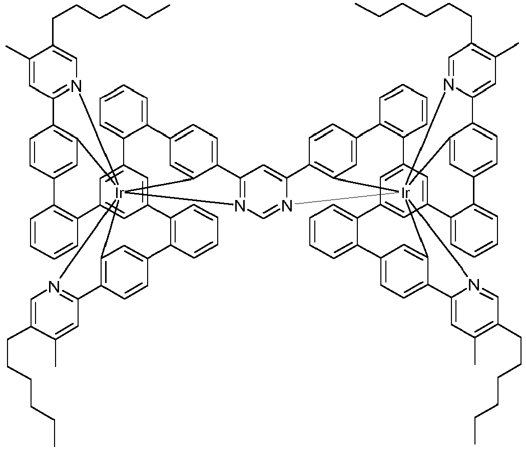 |
| P5 | [3430-26-0] | |
| | 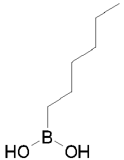 | |
| | [16343-08-1] | |
| P6 | [3430-26-0] | 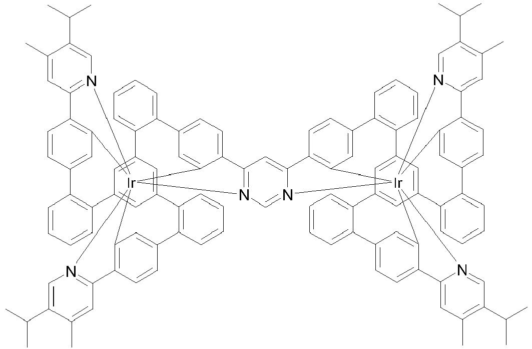 |
| | 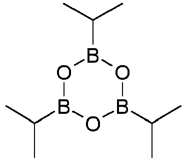 | |
| | [66740-05-4] | |
| P7 | [3430-26-0] | 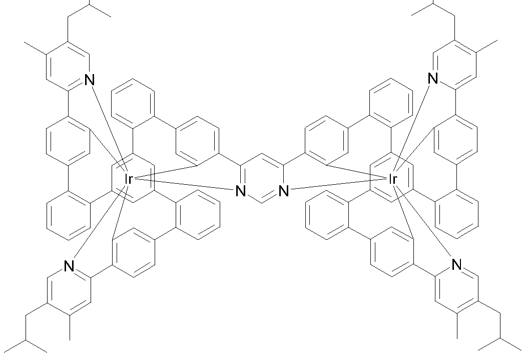 |
| | 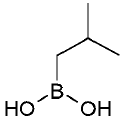 | |
| | [84110-40-7] | |
| P8 | [3430-26-0] | 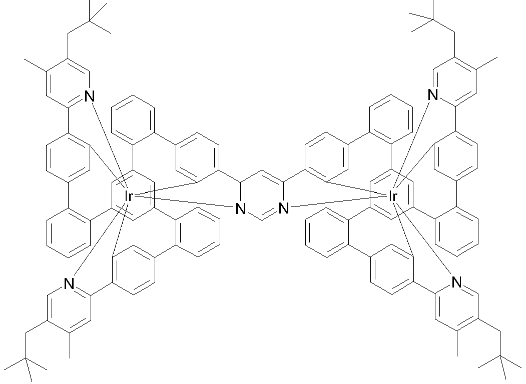 |
| | 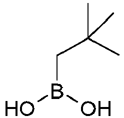 | |
| | [701261-35-0] | |
| P9 | [3430-26-0] | 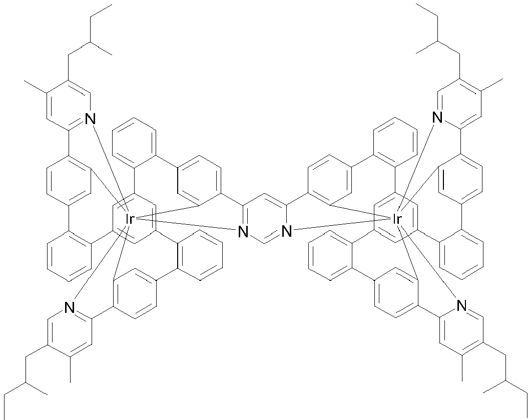 |
| | 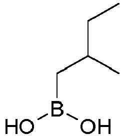 | |
| | [125228-70-8] | |
| P10 | [3430-26-0] | 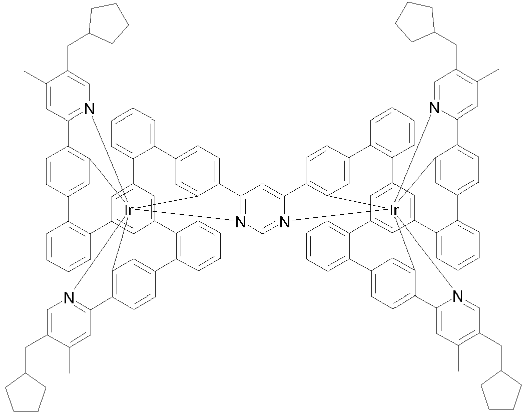 |
| | 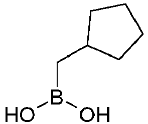 | |
| | [848029-29-8] | |
| P11 | [3430-26-0] | 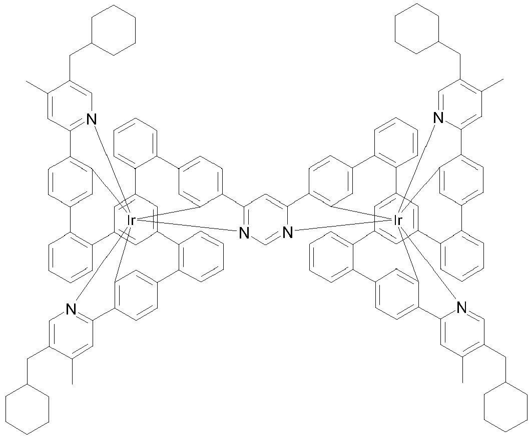 |
| | 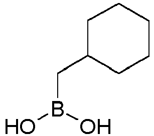 | |
| | [27762-64-7] | |
| P12 | [3430-26-0] | 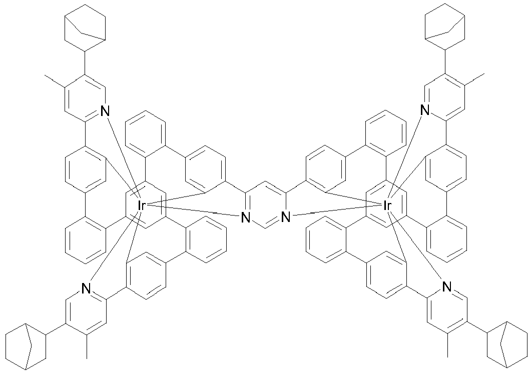 |
| | 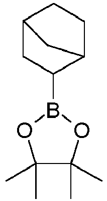 | |
| | [141091-39-6] | |
| P13 | [3430-26-0] | 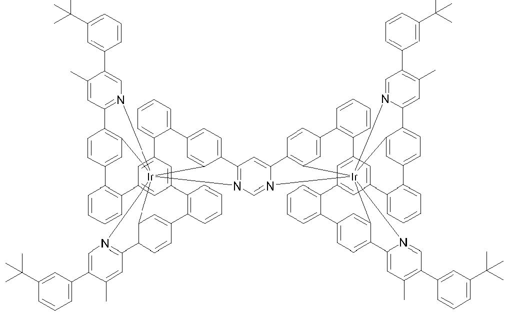 |
| | 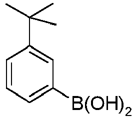 | |
| | [560132-24-3] | |
| P14 | [3430-26-0] | 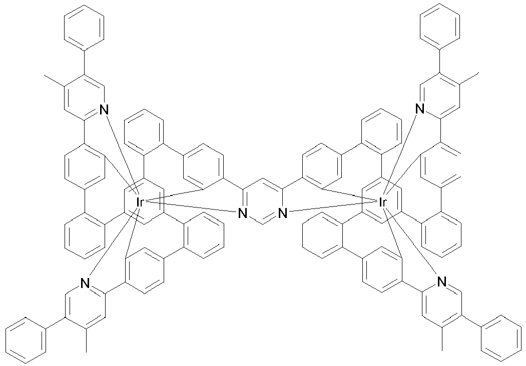 |
| | 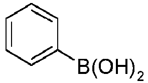 | |
| | [98-80-6] | |
| P15 | [3430-26-0] | 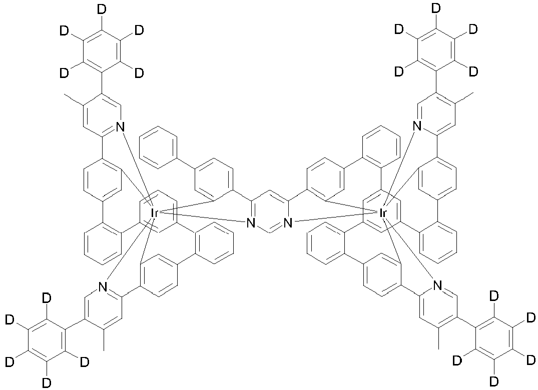 |
| | 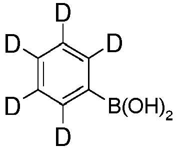 | |
| | [215527-70-1] | |
| P16 | [3430-26-0] | 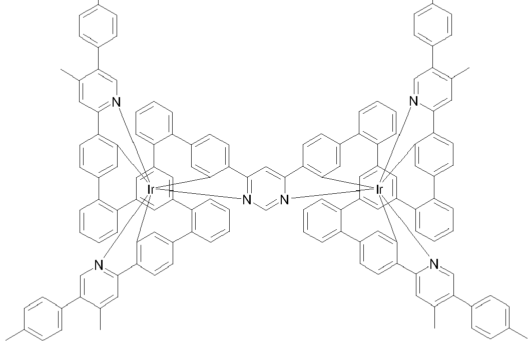 |
| | 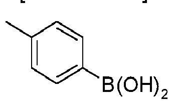 | |
| | [5720-05-8] | |
| P17 | [3430-26-0] | 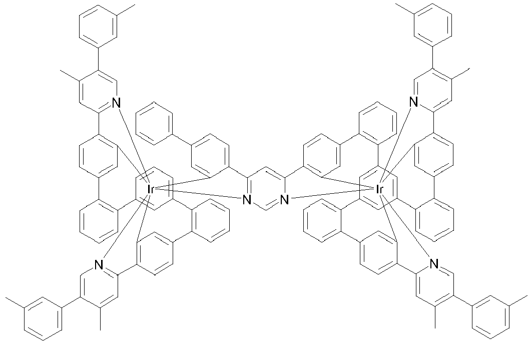 |
| | 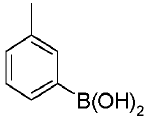 | |
| | [17933-03-8] | |
| P18 | [3430-26-0] | 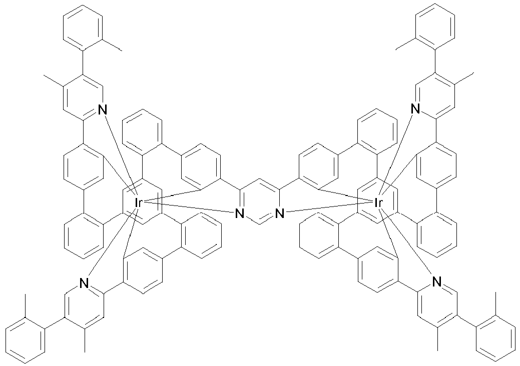 |
| | 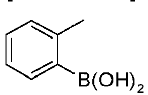 | |
| | [16419-60-6] | |
| P19 | [3430-26-0] | 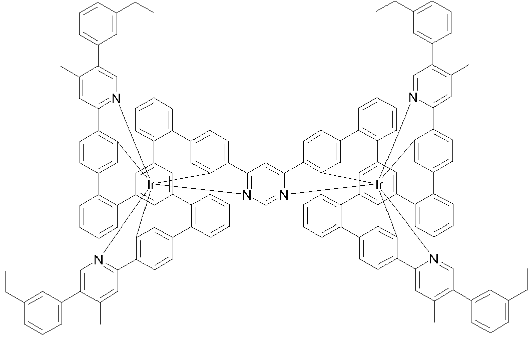 |
| | 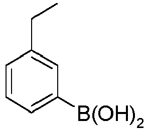 | |
| | [90555-65-0] | |
| P20 | [3430-26-0] | 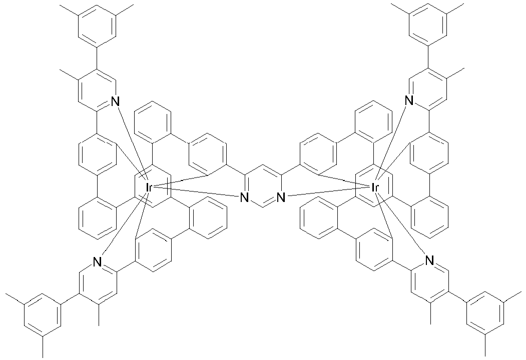 |
| | 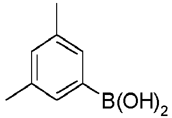 | |
| | [172975-69-8] | |
| P21 | [3430-26-0] | 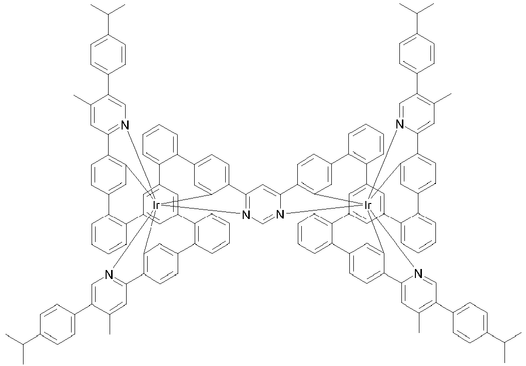 |
| | 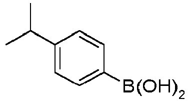 | |
| | [16152-51-5] | |
| P22 | [3430-26-0] | 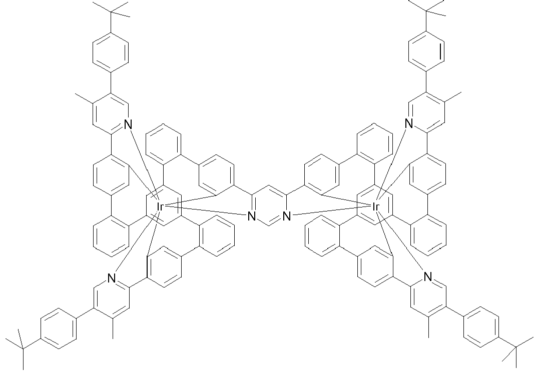 |
| | 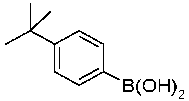 | |
| | [123324-71-0] | |
| P23 | [3430-26-0] | 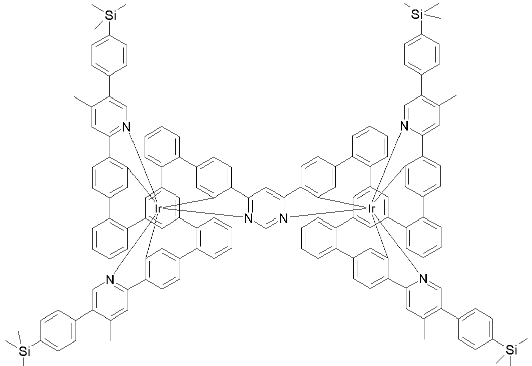 |
| | 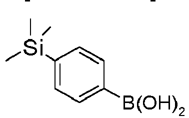 | |
| | [17865-11-1] | |
| P24 | [3430-26-0] | 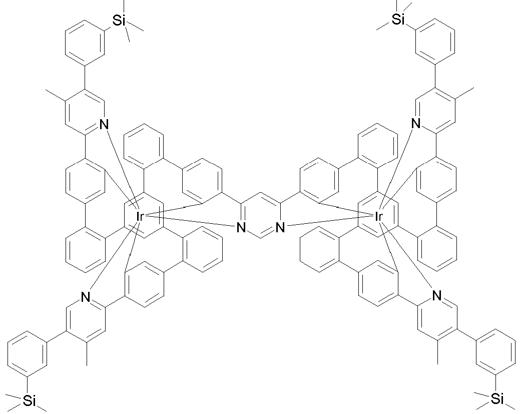 |
| | 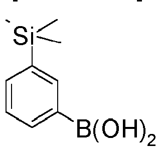 | |
| | [177171-16-3] | |
| P25 | [3430-26-0] | 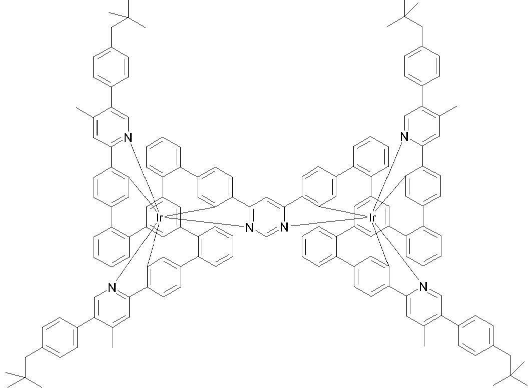 |
| | 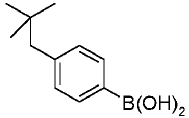 | |
| | [186498-04-4] | |
| P26 | [3430-26-0] | 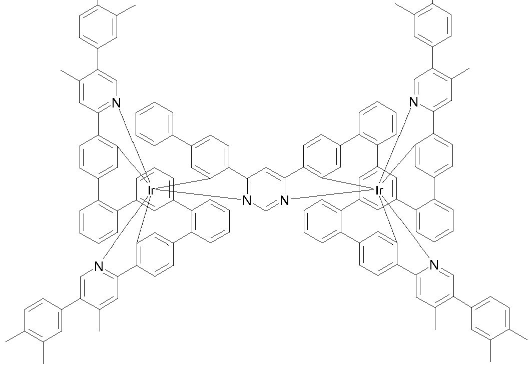 |
| | 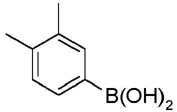 | |
| | [55499-43-9] | |
| P27 | [3430-26-0] | 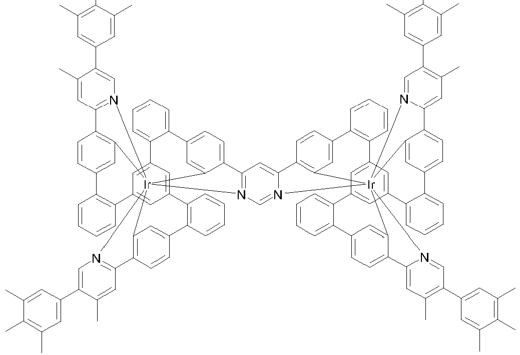 |
| | 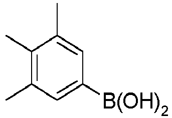 | |
| | [1246022-53-6] | |
| P28 | [3430-26-0] | 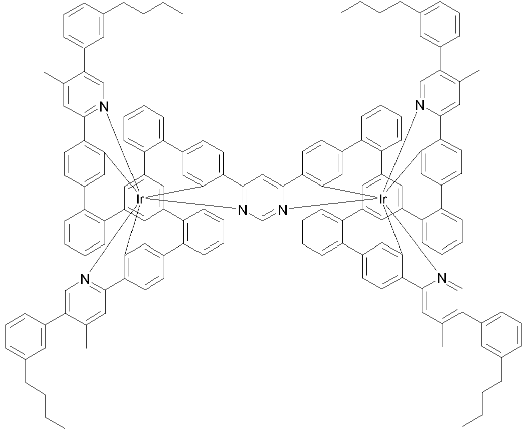 |
| | 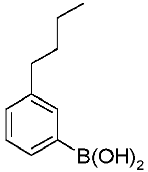 | |
| | [743437-84-5] | |
| P29 | [3430-26-0] | 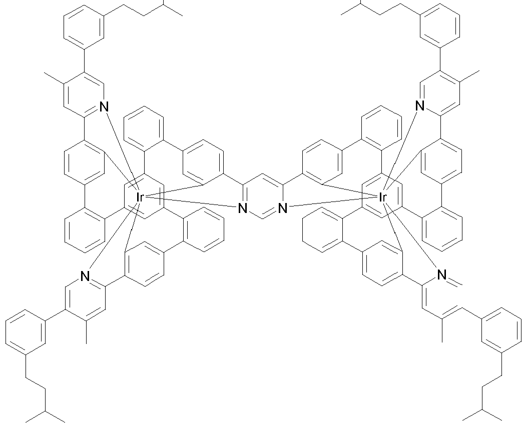 |
| | 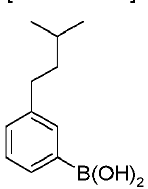 | |
| | [179251-20-8] | |
| P30 | [3430-26-0] | 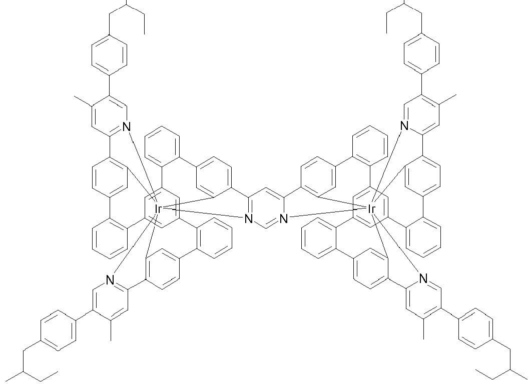 |
| | 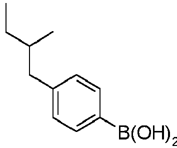 | |
| | [179251-35-5] | |
| P31 | [3430-26-0] | 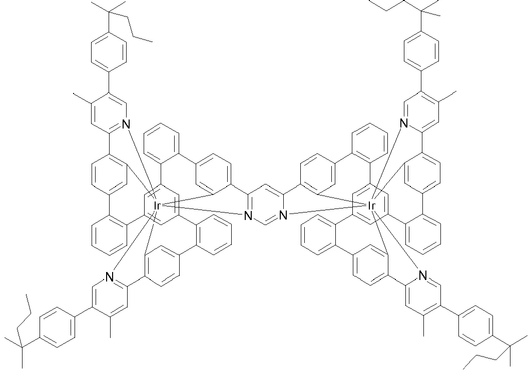 |
| | 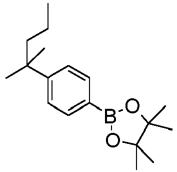 | |
| | [851231-31-7] | |
| P32 | [3430-26-0] | 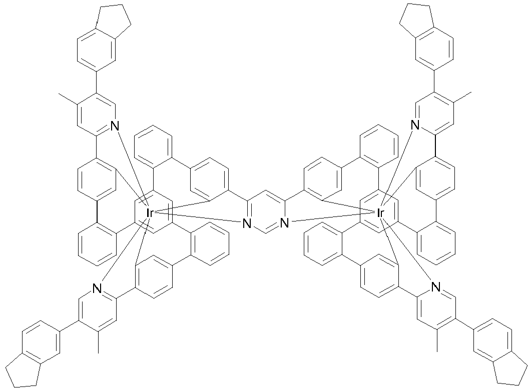 |
| | 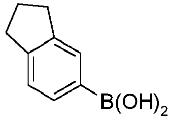 | |
| | [196861-31-1] | |
| P33 | | 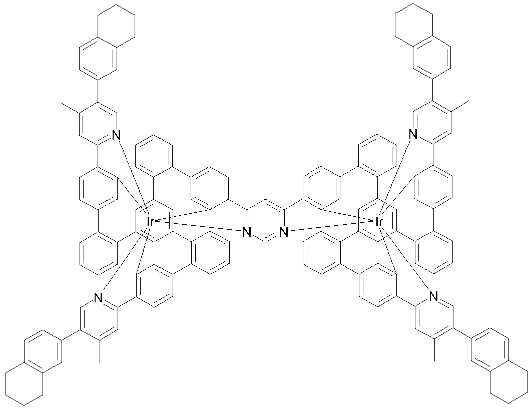 |
| | 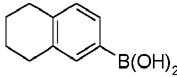 [3430-26-0] | |
| | [405888-56-4] | |
| P34 | [3430-26-0] | 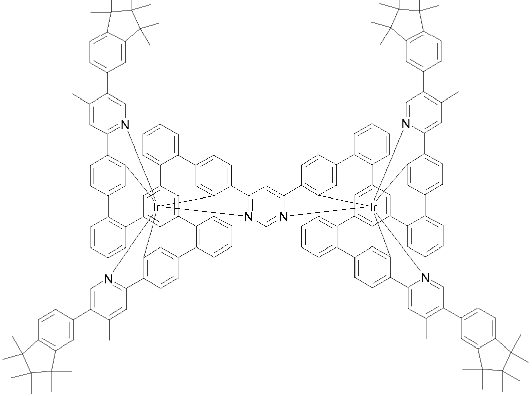 |
| | 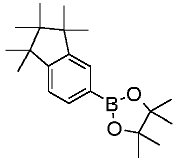 | |
| | [1562418-16-9] | |
| P35 | [3430-26-0] | 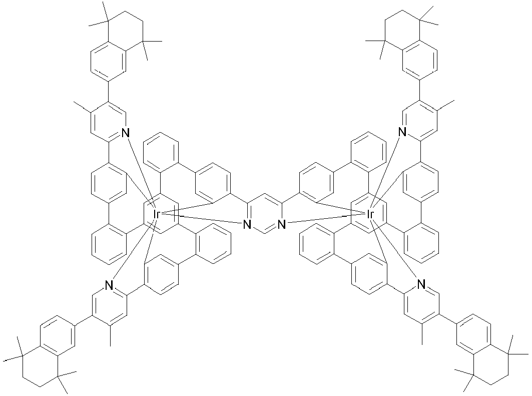 |
| | 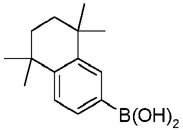 | |
| | [169126-63-0] | |
| P36 | [3430-26-0] | 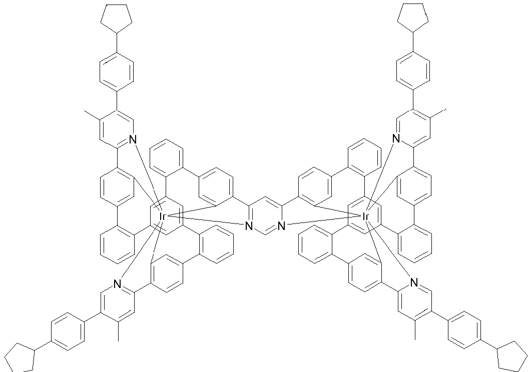 |
| | 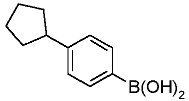 | |
| | [945837-57-0] | |
| P37 | [3430-26-0] | 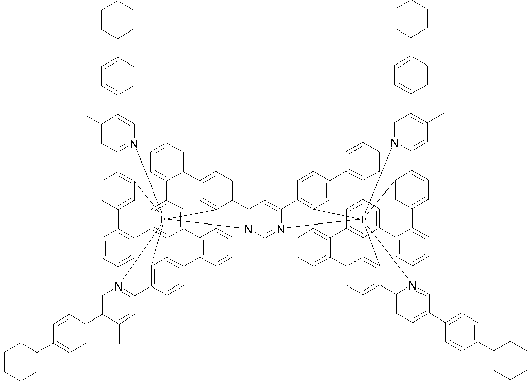 |
| | 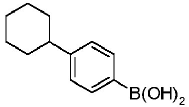 | |
| | [374538-04-2] | |
| P38 | [3430-26-0] | 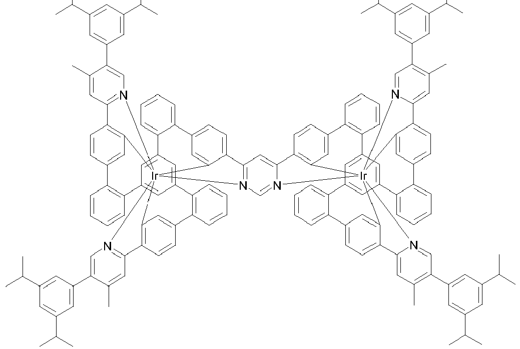 |
| | 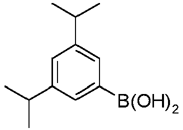 | |
| | [263397-82-6] | |
| P39 | [3430-26-0] | 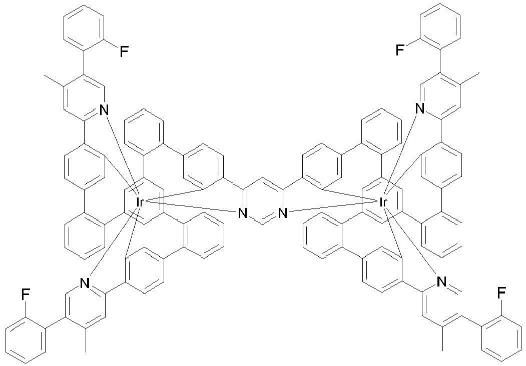 |
| | 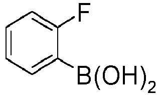 | |
| | [1993-03-9] | |
| P40 | [3430-26-0] | 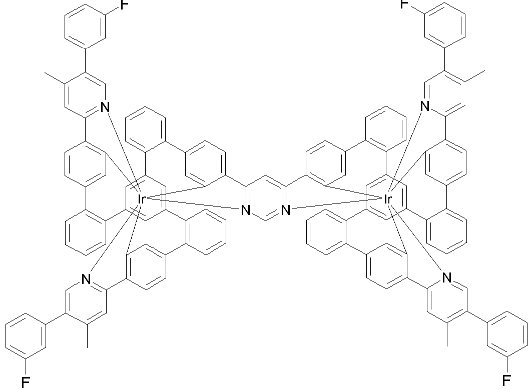 |
| | 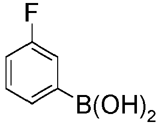 | |
| | [768-35-4] | |
| P41 | [3430-26-0] | 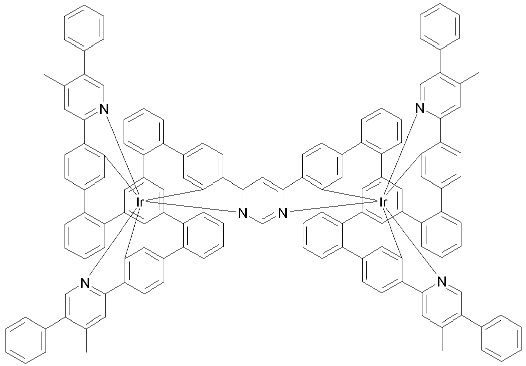 |
| | 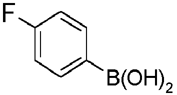 | |
| | [1765-93-1] | |
| P42 | [3430-26-0] | 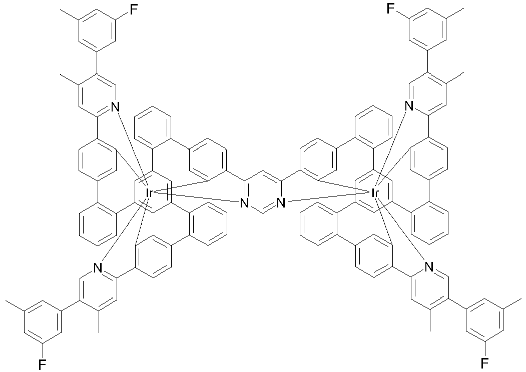 |
| | 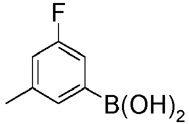 | |
| | [850593-06-5] | |
| P43 | [3430-26-0] | 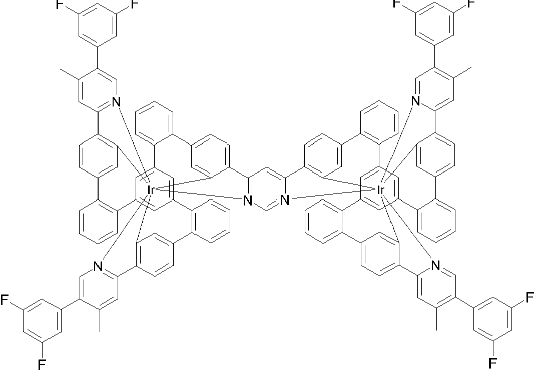 |
| | 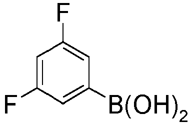 | |
| | [156545-07-2] | |
| P44 | [3430-26-0] | 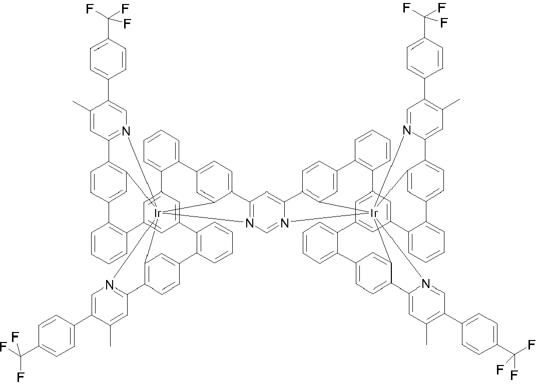 |
| | 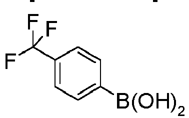 | |
| | [128796-39-4] | |
| P45 | [3430-26-0] | 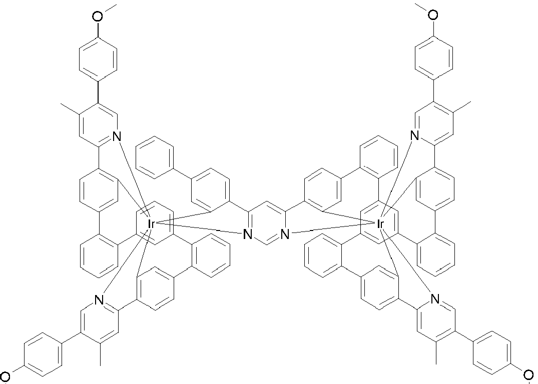 |
| | 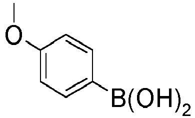 | |
| | [5720-07-0] | |
| P46 | [3430-26-0] | 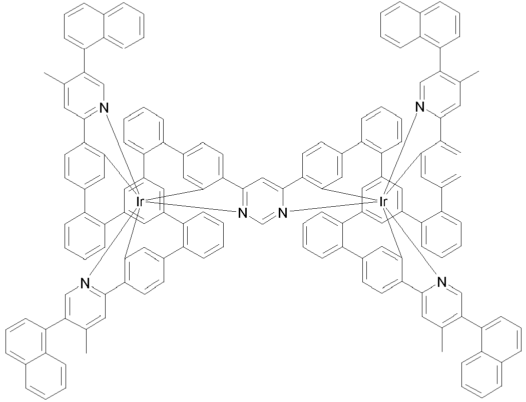 |
| | 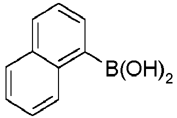 | |
| | [13922-41-3] | |
| P47 | [3430-26-0] | 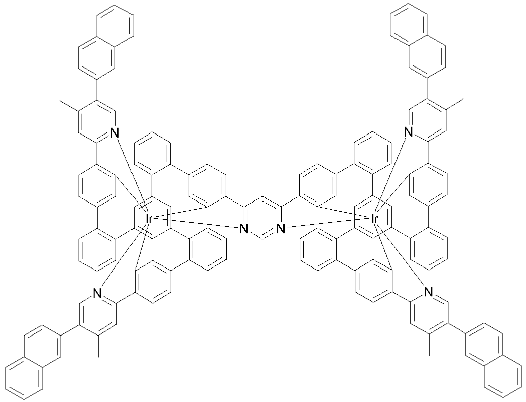 |
| | 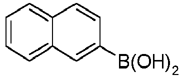 | |
| | [32316-92-0] | |
| O48 | [3430-26-0] | 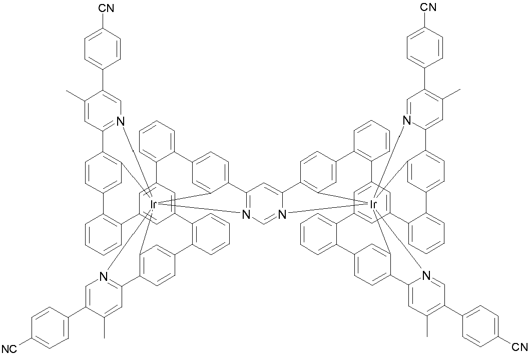 |
| | 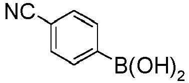 | |
| | [161664-51-3] | |
| P49 | [3430-26-0] | 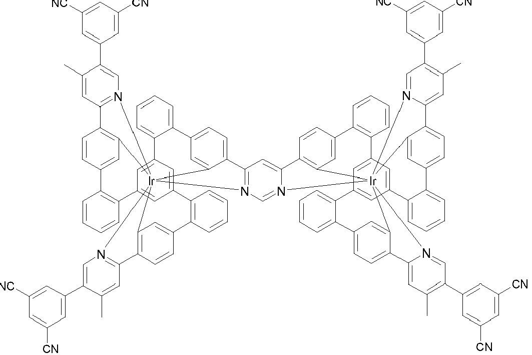 |
| | 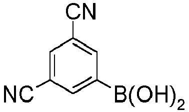 | |
| | [1212021-54-9] | |
| P50 | [3430-26-0] | 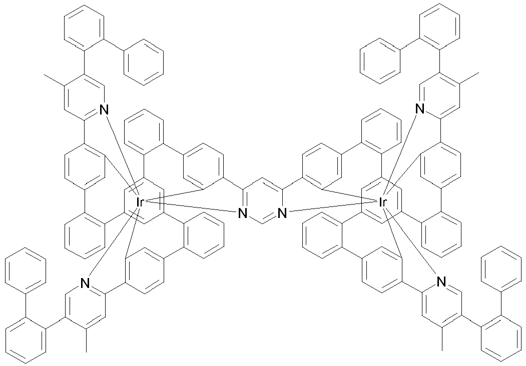 |
| | 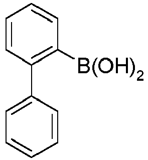 | |
| | [4688-76-0] | |
| P51 | [3430-26-0] | 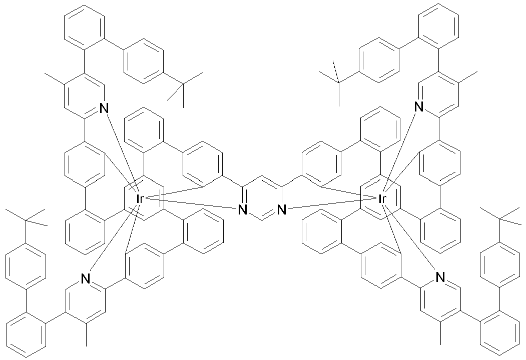 |
| | 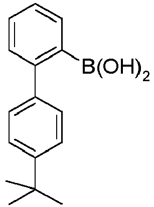 | |
| | [1228458-46-5] | |
| P52 | [3430-26-0] | 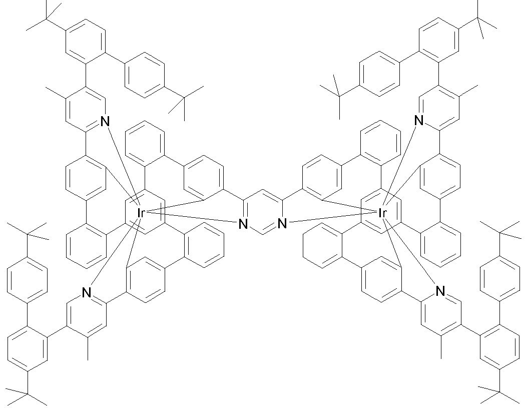 |
| | 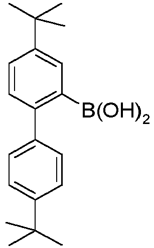 | |
| | [1252935-66-2] | |
| P53 | [3430-26-0] | 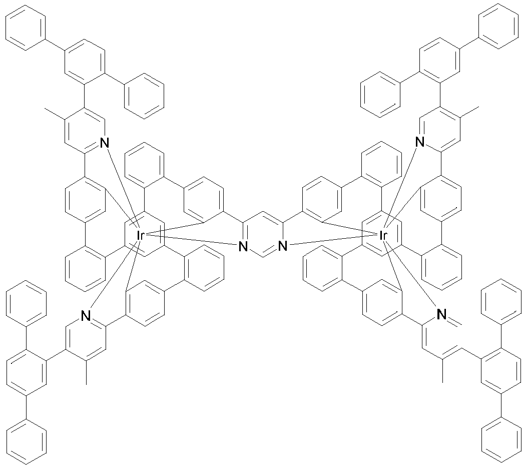 |
| | 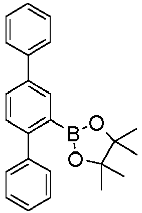 | |
| | [1283088-35-6] | |
| P54 | [3430-26-0] | 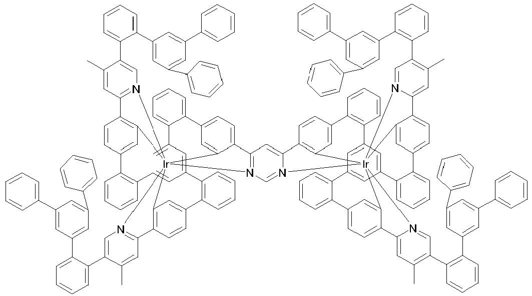 |
| | 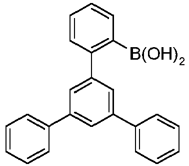 | |
| | [1891052-65-5] | |
| P55 | [3430-26-0] | 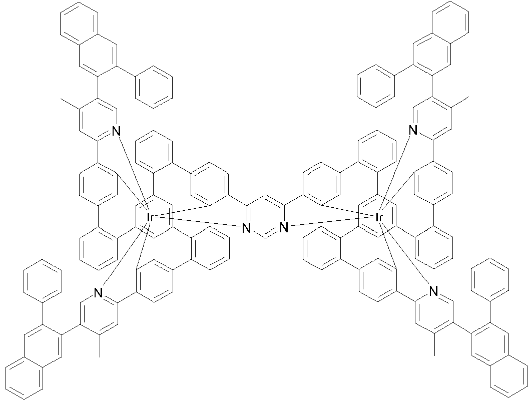 |
| | 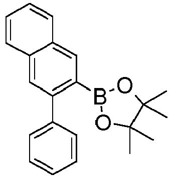 | |
| | [1166381-29-8] | |
| P56 | [3430-26-0] | 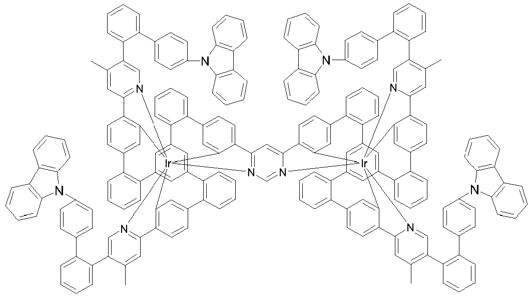 |
| | 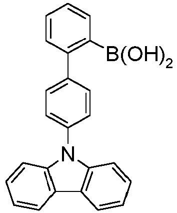 | |
| | [1215228-59-3] | |
| P57 | [3430-26-0] | 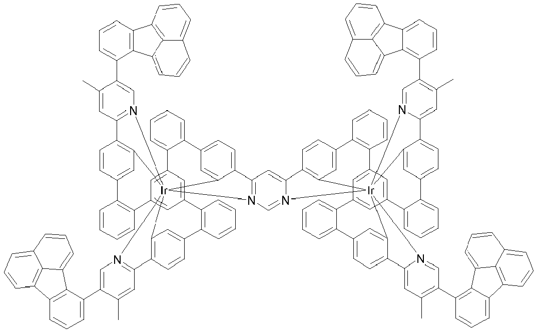 |
| | 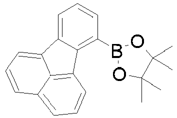 | |
| | [1005770-96-6] | |
| P58 | [3430-26-0] | 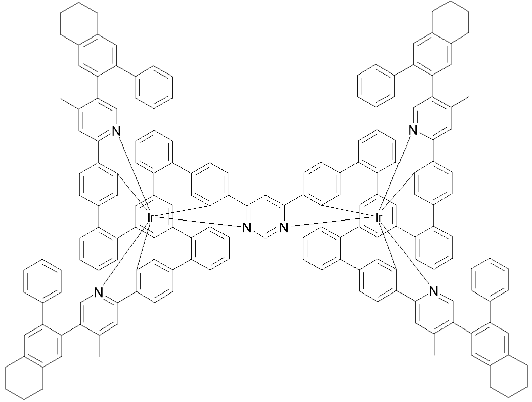 |
| | 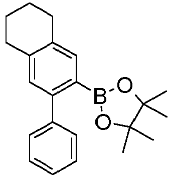 | |
| | [781645-71-4] | |
| P59 | [3430-26-0] | 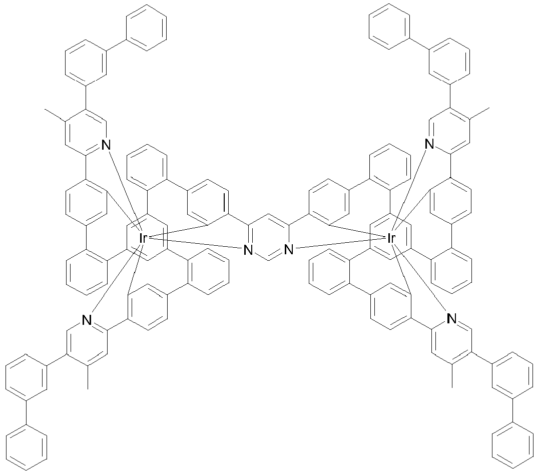 |
| | 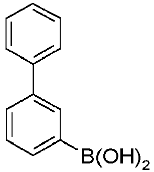 | |
| | [5122-95-2] | |
| P60 | [3430-26-0] | 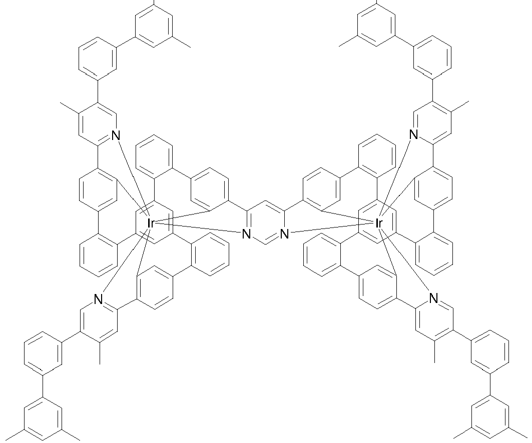 |
| | 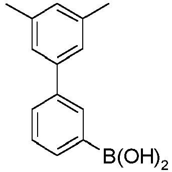 | |
| | [1265312-42-2] | |
| P61 | [3430-26-0] | 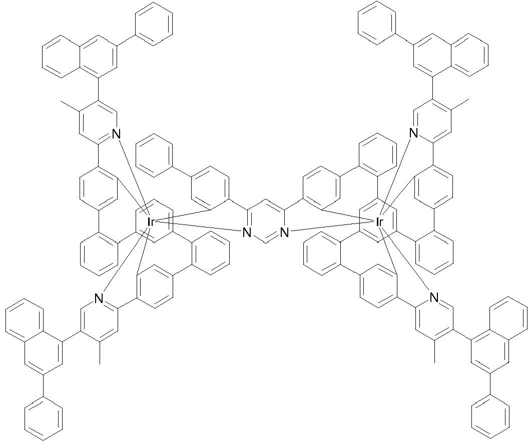 |
| | 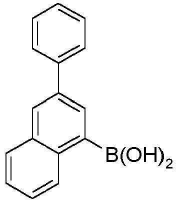 | |
| | [1922905-62-1] | |
| P62 | [3430-26-0] | 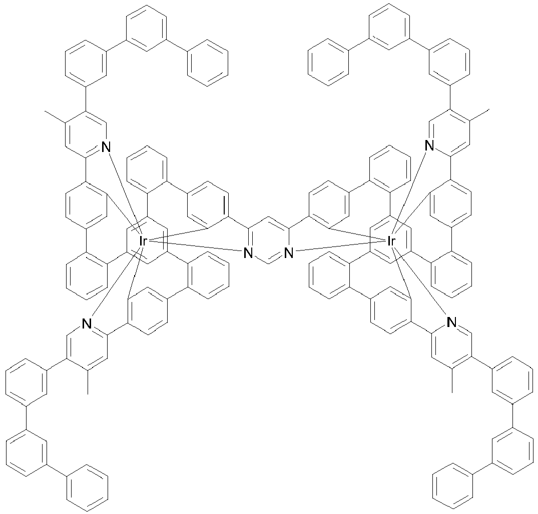 |
| | 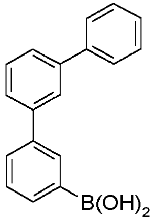 | |
| | [934603-99-3] | |
| P63 | [3430-26-0] | 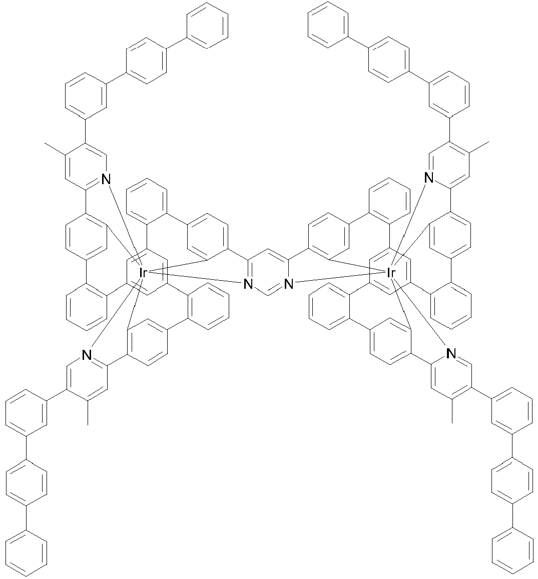 |
| | 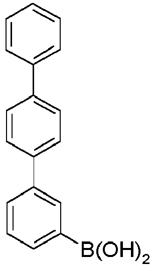 | |
| | [881911-81-5] | |
| P64 | [3430-26-0] | 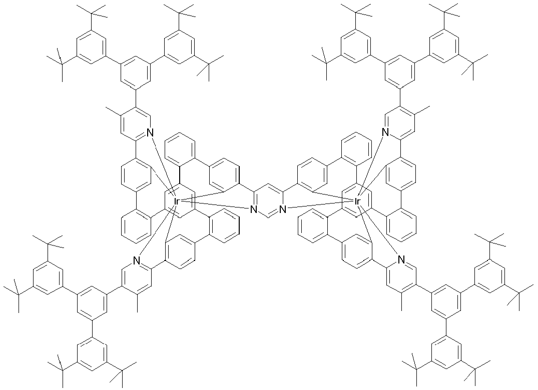 |
| | 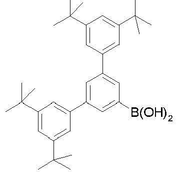 | |
| | [501928-23-0] | |
| P65 | [3430-26-0] | 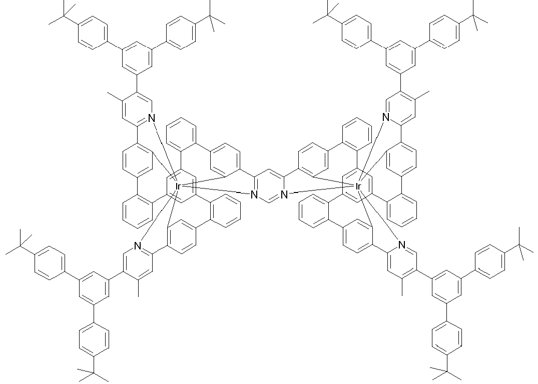 |
| | 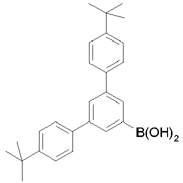 | |
| | [253280-21-6] | |
| P66 | [3430-26-0] | 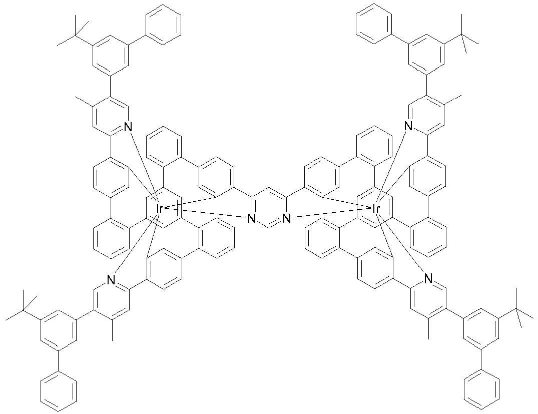 |
| | 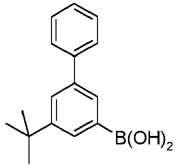 | |
| | [1345508-82-8] | |
| P67 | [3430-26-0] | 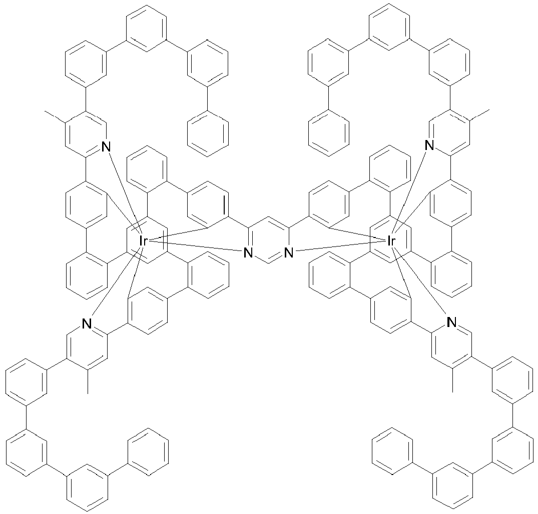 |
| | 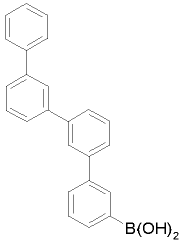 | |
| | [865265-35-6] | |
| P68 | [3430-26-0] | 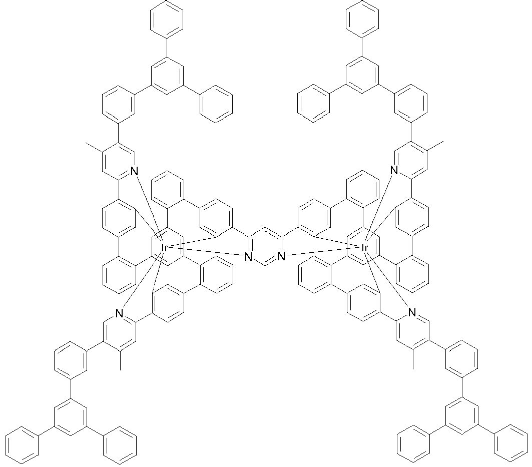 |
| | 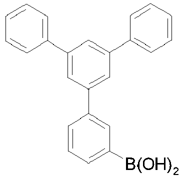 | |
| | [1233200-59-3] | |
| P69 | [3430-26-0] | 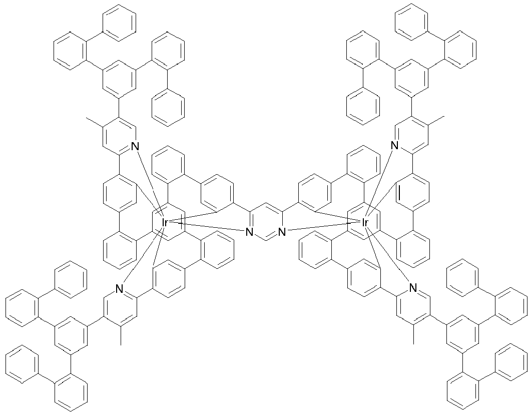 |
| | 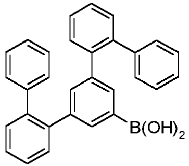 | |
| | [1821431-53-1] | |
| P70 | [3430-26-0] | 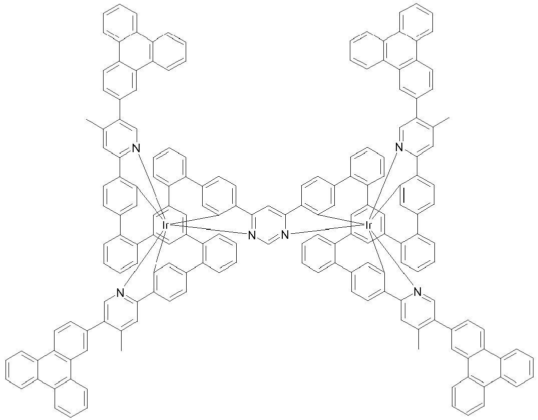 |
| | 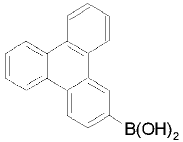 | |
| | [654664-63-8] | |
| P71 | [3430-26-0] | 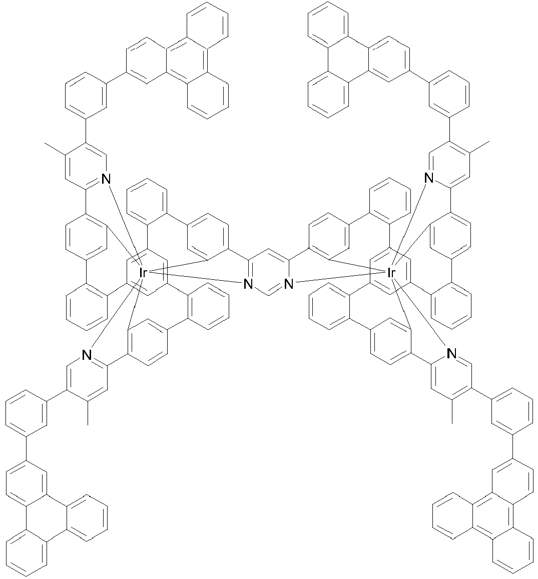 |
| | 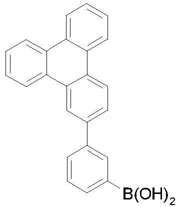 | |
| | [1235876-72-8] | |
| P72 | [3430-26-0] | 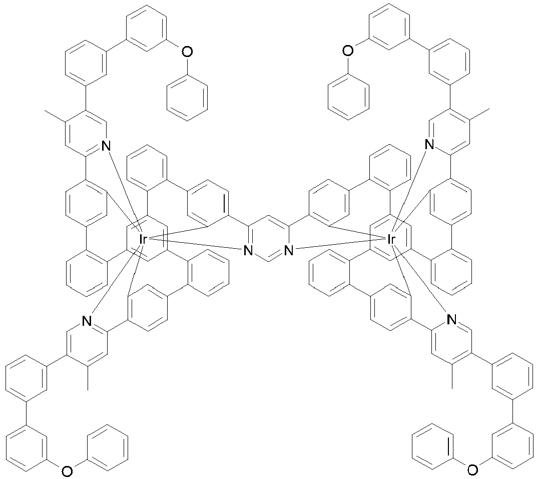 |
| | 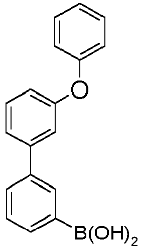 | |
| | [346418-36-8] | |
| P73 | [3430-26-0] | 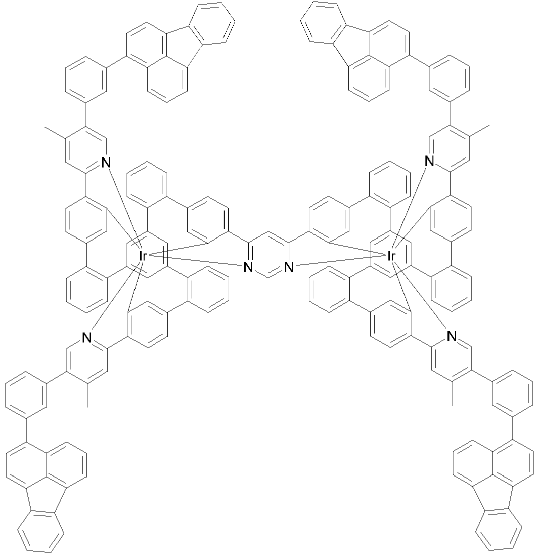 |
| | 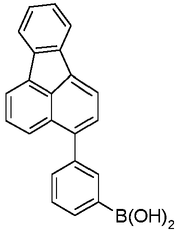 | |
| | [1096686-55-3] | |
| P74 | [3430-26-0] | 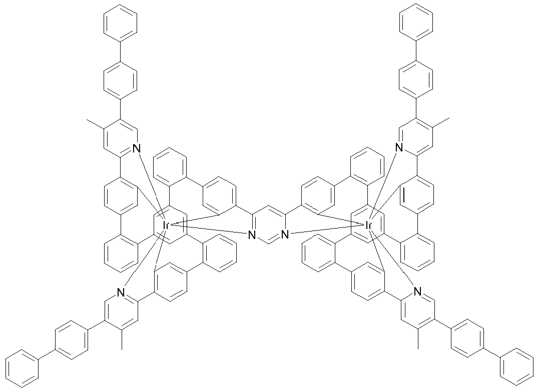 |
| | 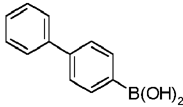 | |
| | [5122-94-1] | |
| P75 | [3430-26-0] | 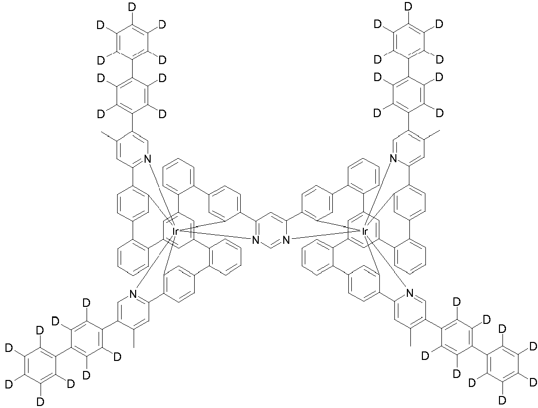 |
| | 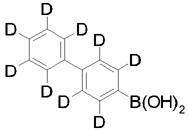 | |
| | [1489259-11-1] | |
| P76 | [3430-26-0] | 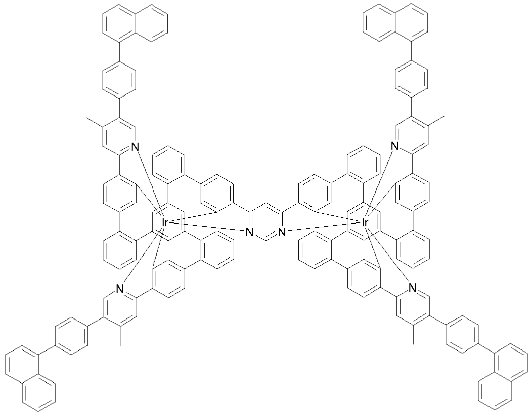 |
| | 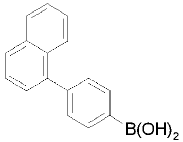 | |
| | [5122-95-2] | |
| P77 | [3430-26-0] | 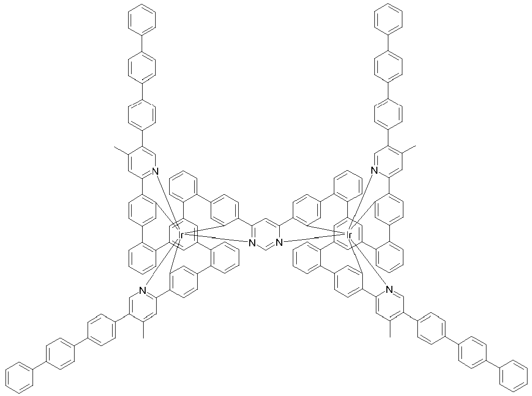 |
| | 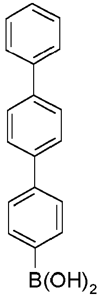 | |
| | [877993-09-4] | |
| P78 | [3430-26-0] | 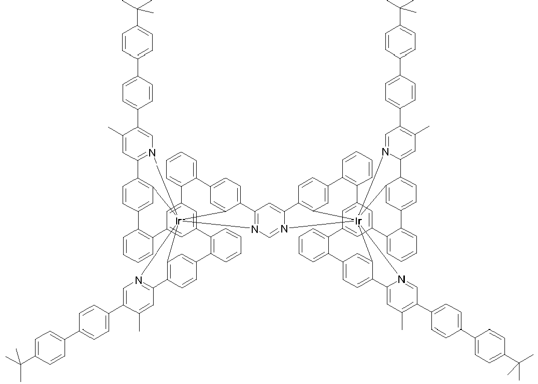 |
| | 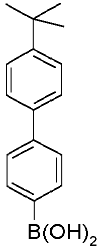 | |
| | [5122-95-2] | |
| P79 | [3430-26-0] | 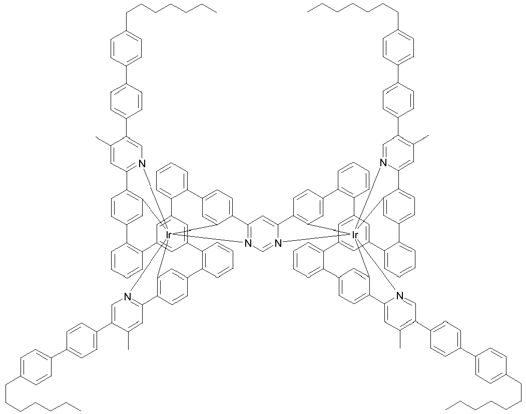 |
| | 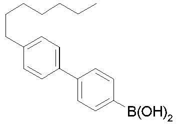 | |
| | [159381-67-6] | |
| P80 | [3430-26-0] | 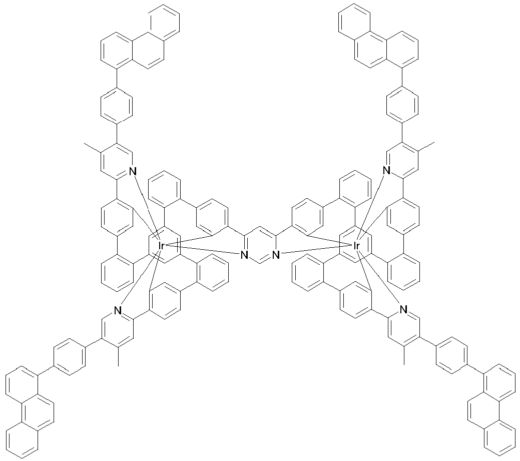 |
| | 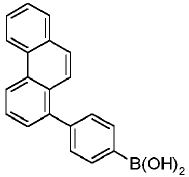 | |
| | [1430392-53-2] | |
| P81 | [3430-26-0] | 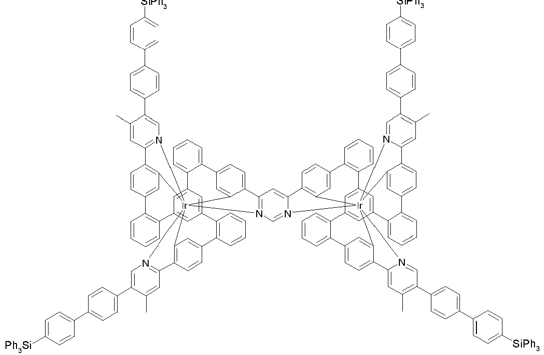 |
| | 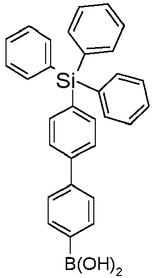 | |
| | [1265312-63-7] | |
| P82 | [3430-26-0] | 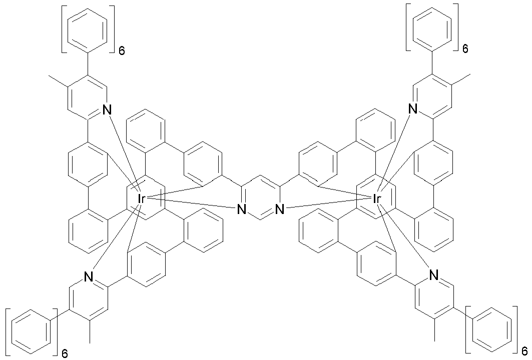 |
| | 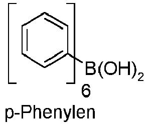 | |
| | [1388226-18-3] | |
| P83 | [3430-26-0] | 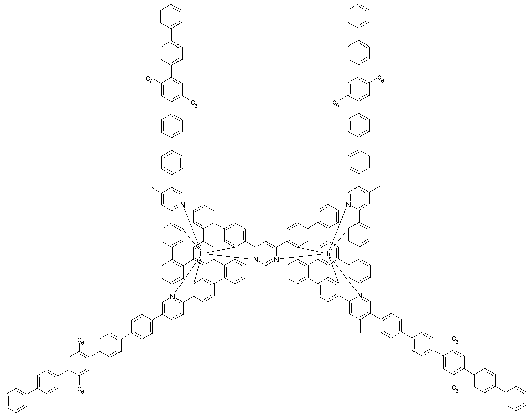 |
| | 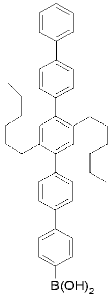 | |
| | [178426-80-7] | |
| P84 | [3430-26-0] | 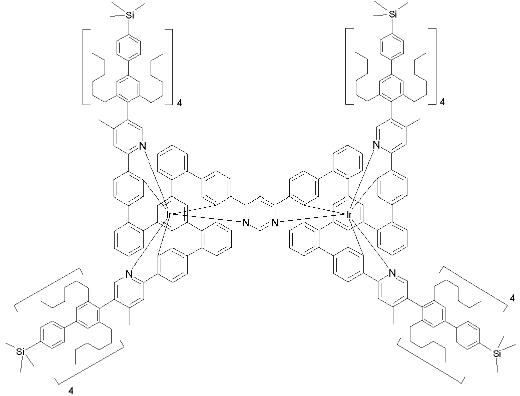 |
| | 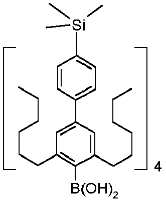 | |
| | [180802-97-5] | |
| P85 | [3430-26-0] | 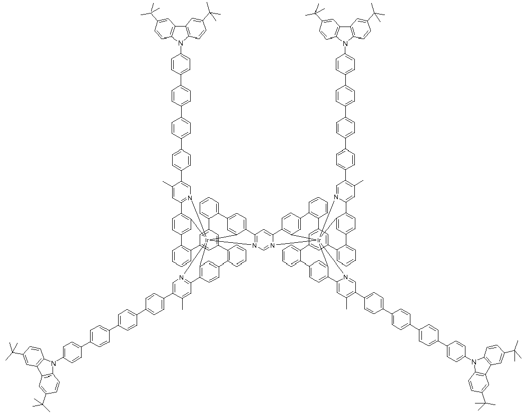 |
| | 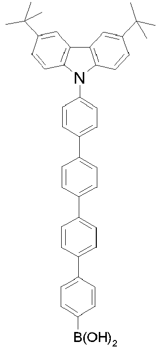 | |
| | [1639930-93-0] | |
| P86 | [3430-26-0] | 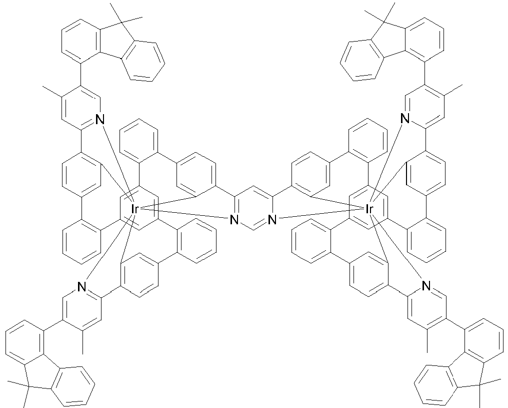 |
| | 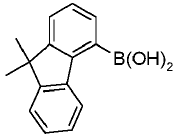 | |
| | [1246022-50-3] | |
| P87 | [3430-26-0] | 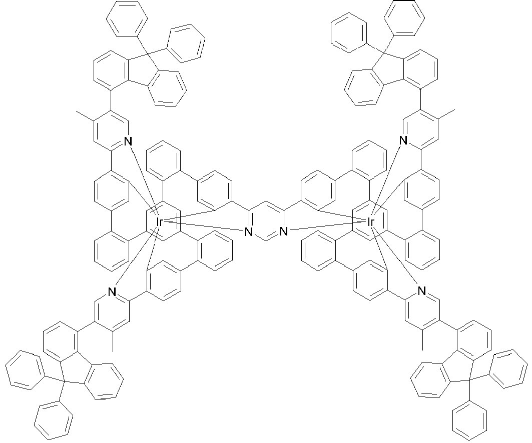 |
| | 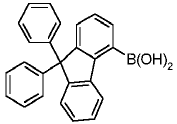 | |
| | [1224976-40-2] | |
| P88 | [3430-26-0] | 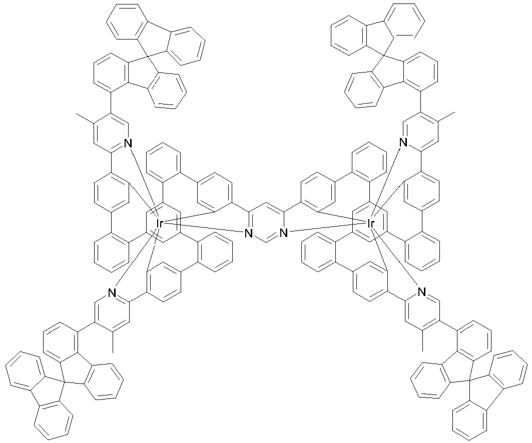 |
| | 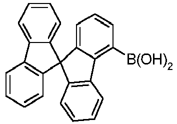 | |
| | [1421789-050] | |
| P89 | [3430-26-0] | 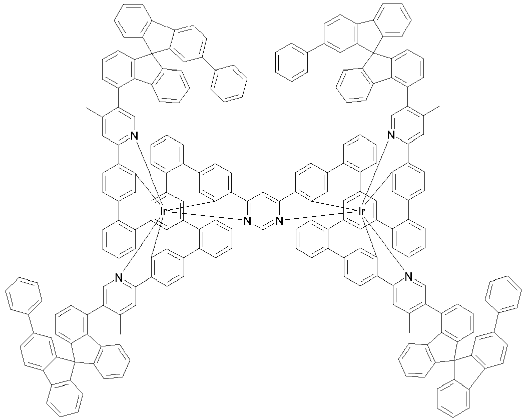 |
| | 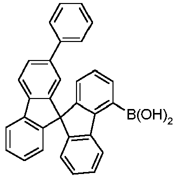 | |
| | [1421789-050] | |
| P90 | [3430-26-0] | 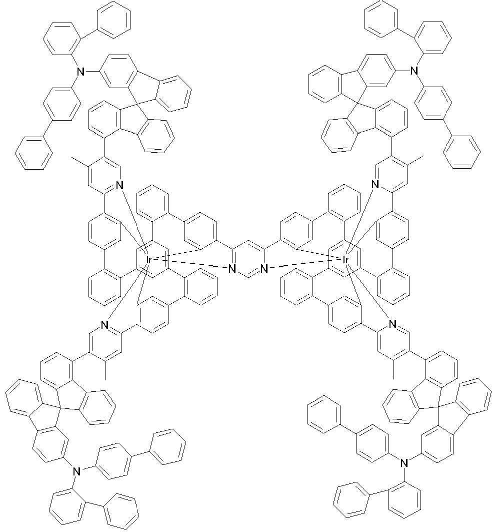 |
| | 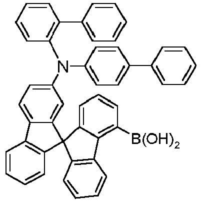 | |
| | [1998100-77-8] | |
| P91 | [3430-26-0] | 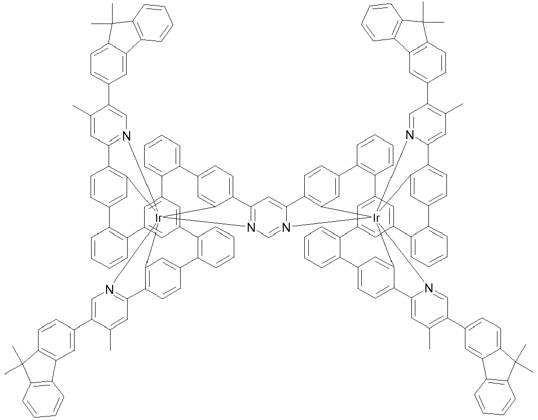 |
| | 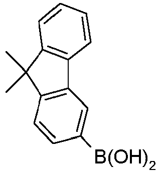 | |
| | [1251773-34-8] | |
| P92 | [3430-26-0] | 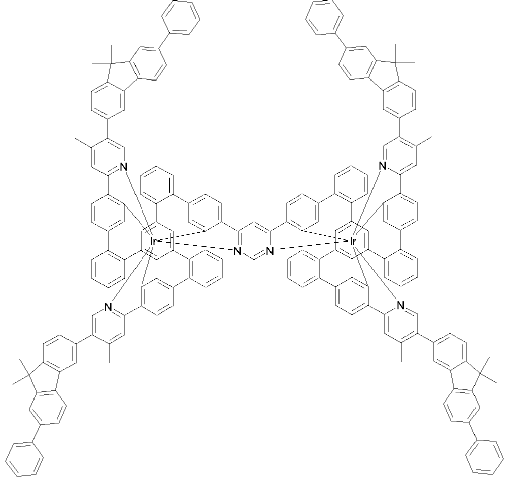 |
| | 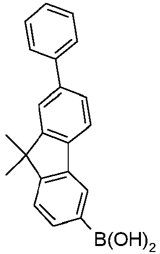 | |
| | [1899049-45-6] | |
| P93 | [3430-26-0] | 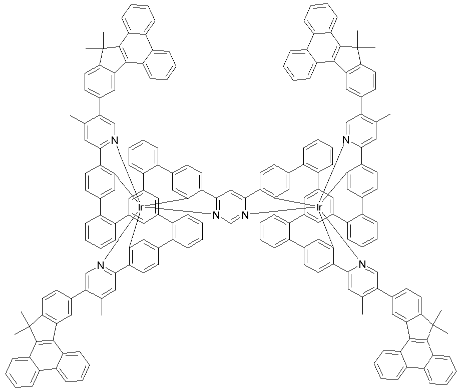 |
| | 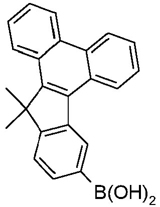 | |
| | [1955546-97-0] | |
| P94 | [3430-26-0] | 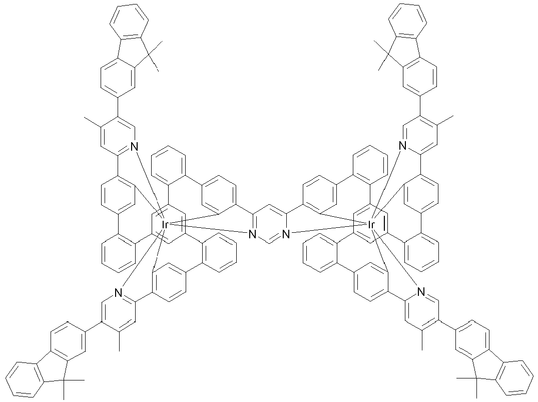 |
| | 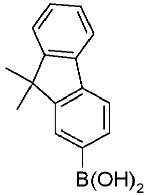 | |
| | [333432-28-3] | |
| P95 | [3430-26-0] | 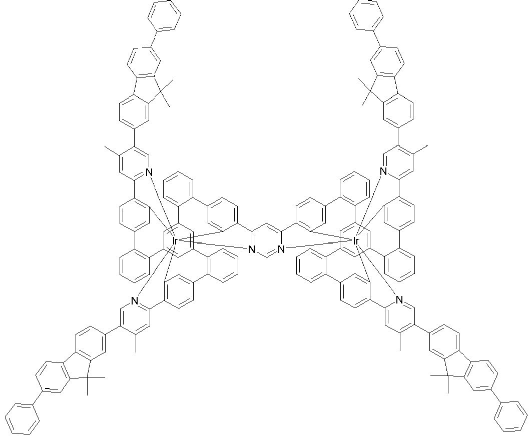 |
| | 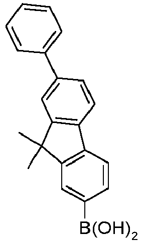 | |
| | [1154751-26-4] | |
| P96 | [3430-26-0] | 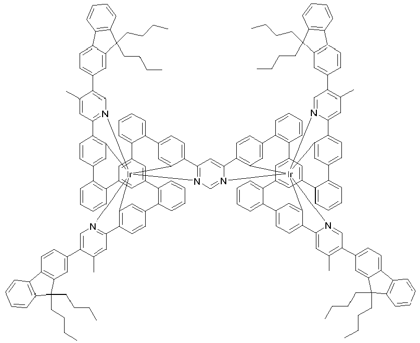 |
| | 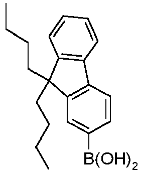 | |
| | [400607-56-9] | |
| P97 | [3430-26-0] | 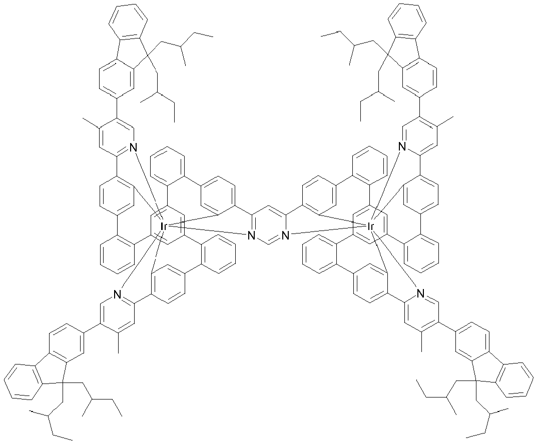 |
| | 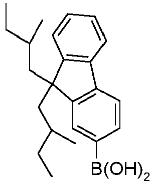 | |
| | [446878-93-9] | |
| P98 | [3430-26-0] | 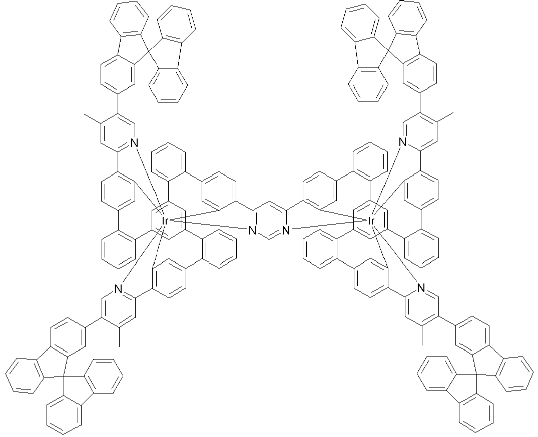 |
| | 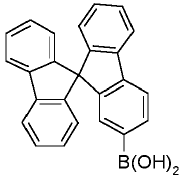 | |
| | [236389-21-2] | |
| P99 | [3430-26-0] | 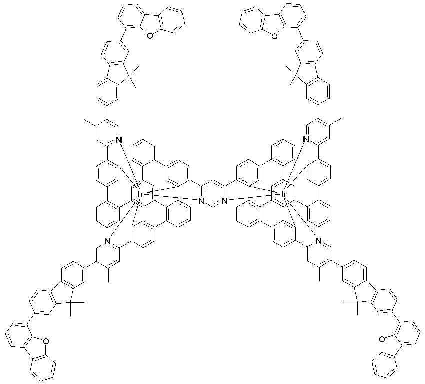 |
| | 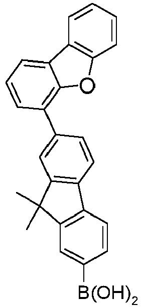 | |
| | [1373264-53-9] | |
| P100 | [3430-26-0] | 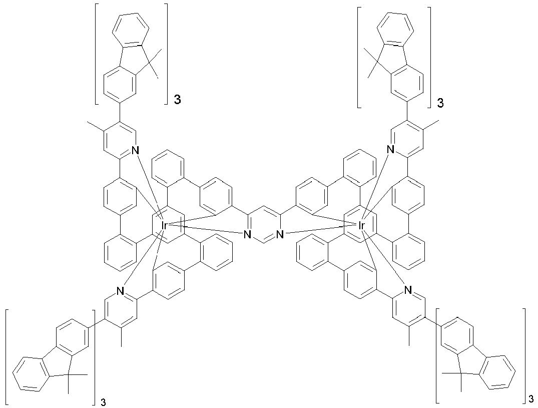 |
| | 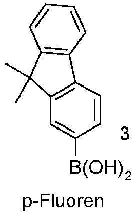 | |
| | [333432-28-3] | |
| P101 | [3430-26-0] | 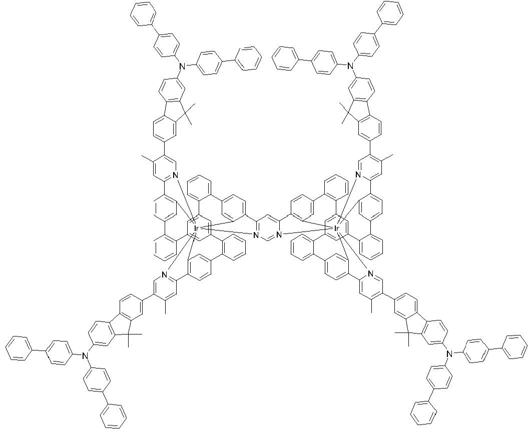 |
| | 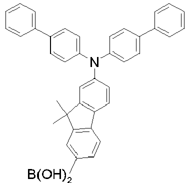 | |
| | [1265177-39-6] | |
| P102 | [3430-26-0] | 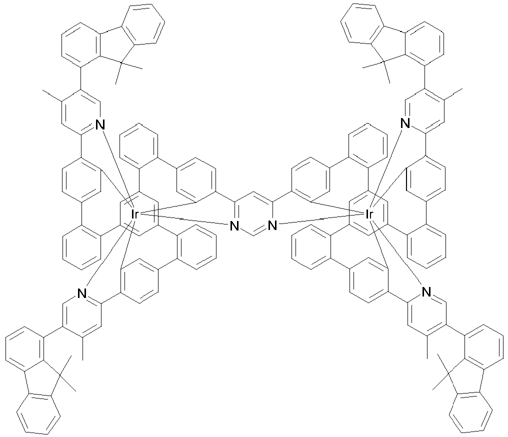 |
| | 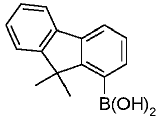 | |
| | [1251825-71-4] | |
| P103 | [3430-26-0] | 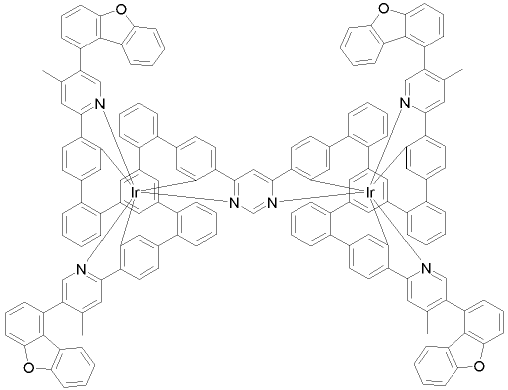 |
| | 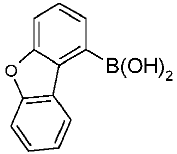 | |
| | [162607-19-4] | |
| P104 | [3430-26-0] | 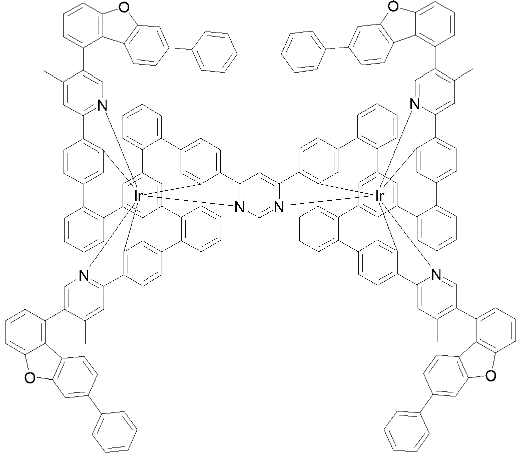 |
| | 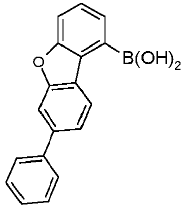 | |
| | [162607-19-4] | |
| P105 | [3430-26-0] | 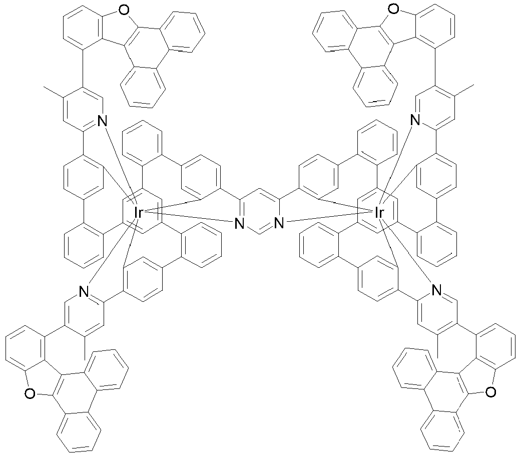 |
| | 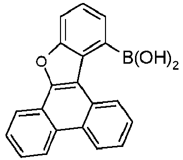 | |
| | [162607-19-4] | |
| P106 | [3430-26-0] | 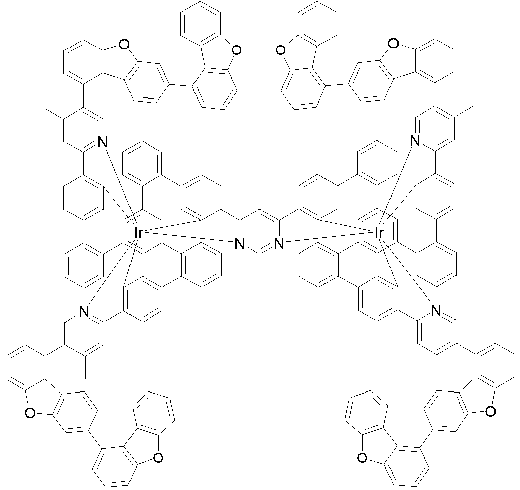 |
| | 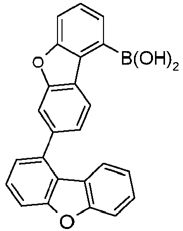 | |
| | [1822320-55-7] | |
| P107 | [3430-26-0] | 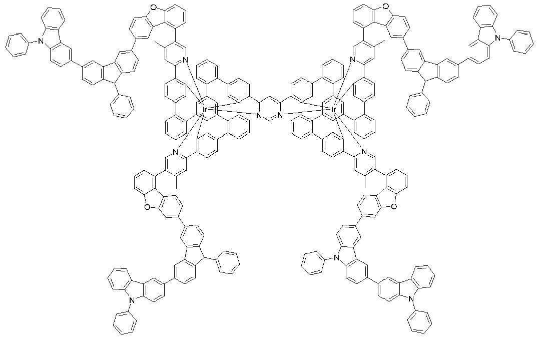 |
| | 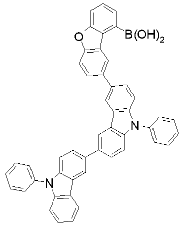 | |
| | [1822311-31-8] | |
| P108 | [3430-26-0] | 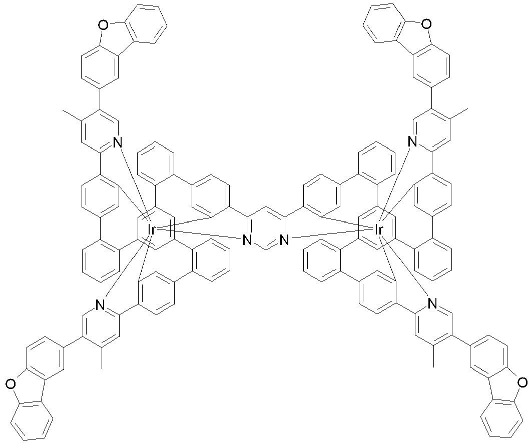 |
| | 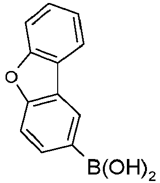 | |
| | [402936-15-6] | |
| P109 | [3430-26-0] | 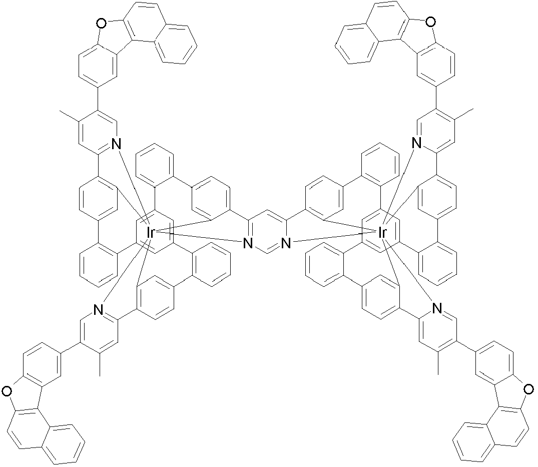 |
| | 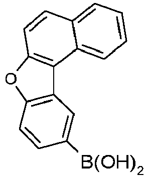 | |
| | [1256544-74-7] | |
| P110 | [3430-26-0] | 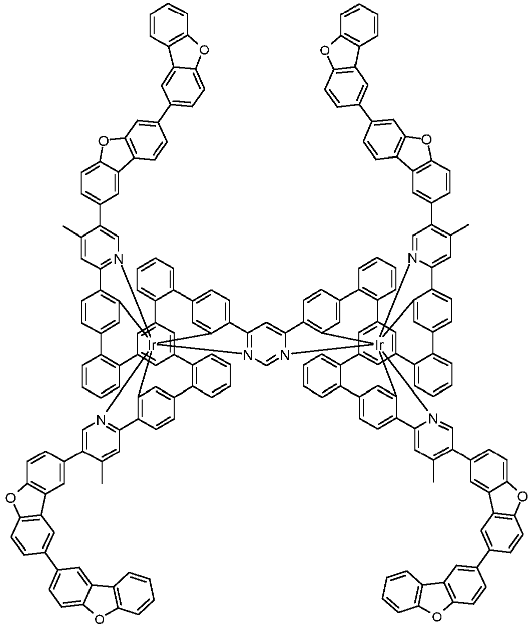 |
| | 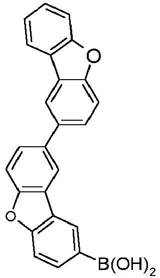 | |
| | [1427560-52-8] | |
| P111 | [3430-26-0] | 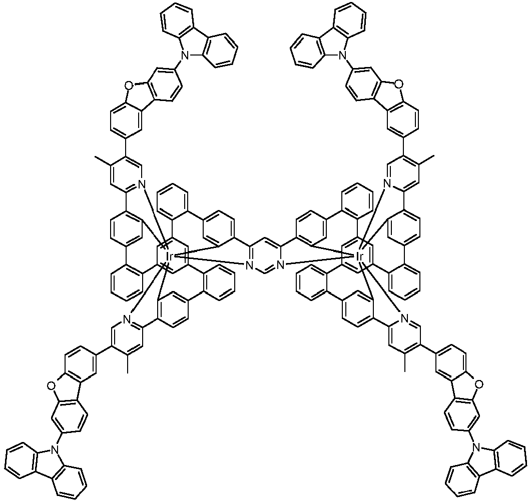 |
| | 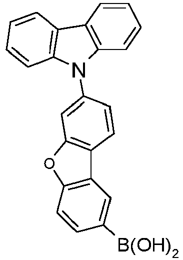 | |
| | [1426818-76-9] | |
| P112 | [3430-26-0] | 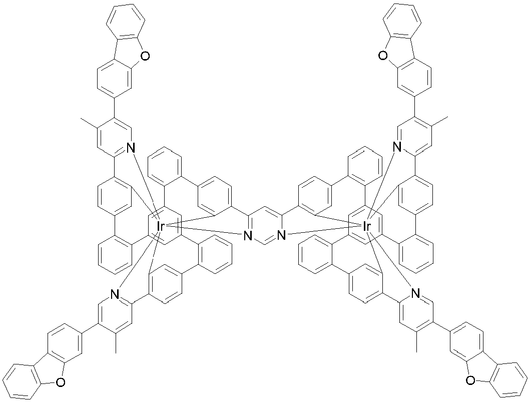 |
| | 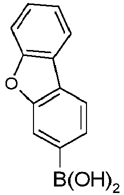 | |
| | [395087-89-5] | |
| P113 | [3430-26-0] | 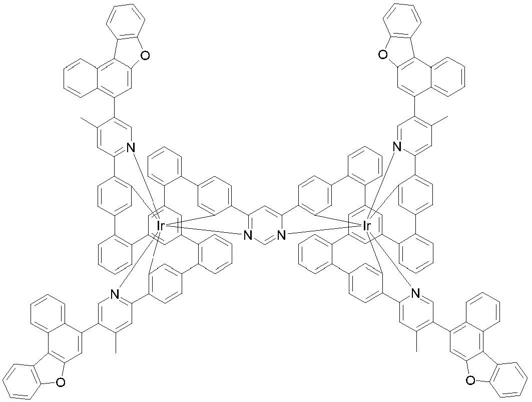 |
| | 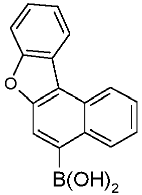 | |
| | [2035080-71-6] | |
| P114 | [3430-26-0] | 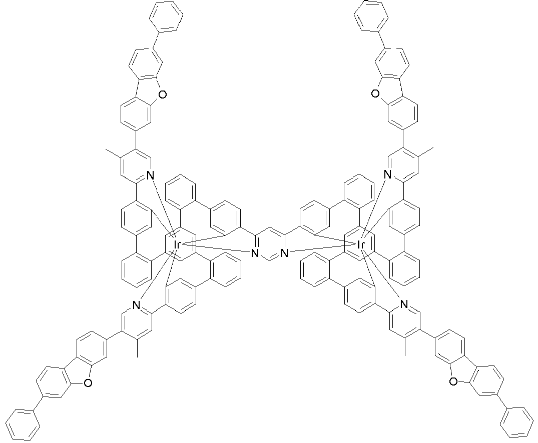 |
| | 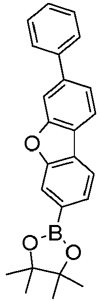 | |
| | [1959608-16-2] | |
| P115 | [3430-26-0] | 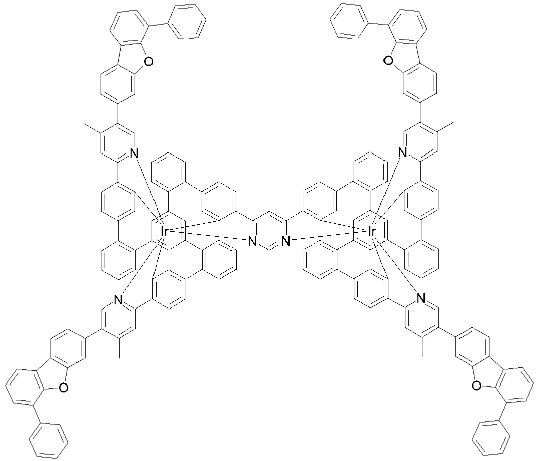 |
| | 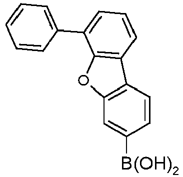 | |
| | [1899872-63-9] | |
| P116 | [3430-26-0] | 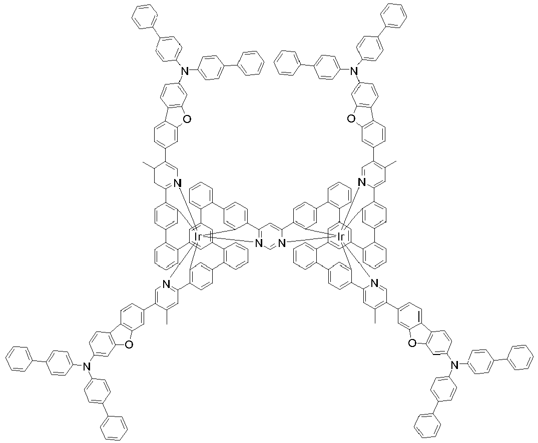 |
| | 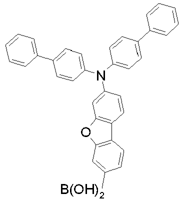 | |
| | [1889263-25-5] | |
| P117 | [3430-26-0] | 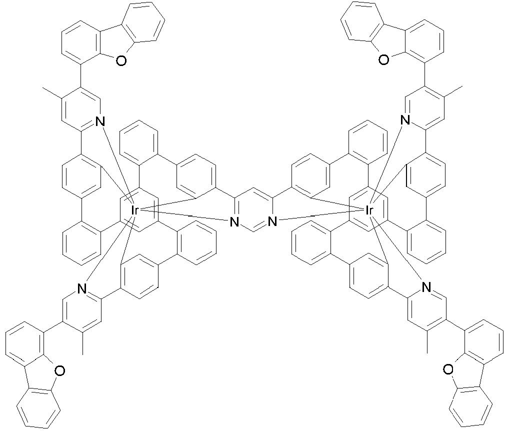 |
| | 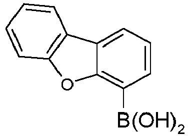 | |
| | [100124-06-9] | |
| P118 | [3430-26-0] | 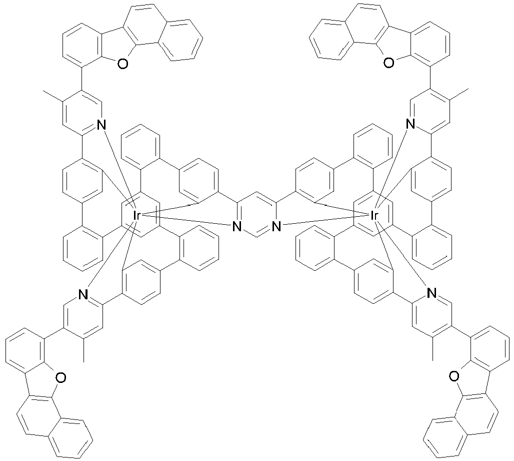 |
| | 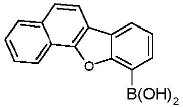 | |
| | [1548470-92-3] | |
| P119 | [3430-26-0] | 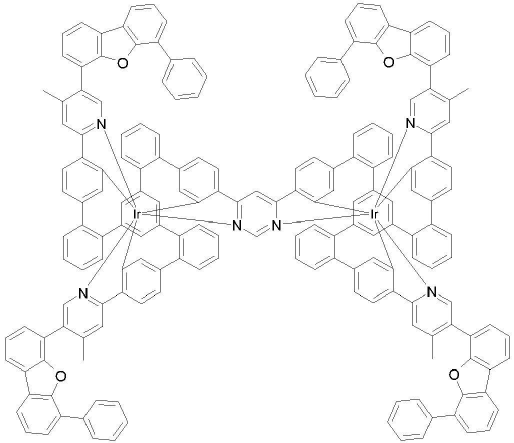 |
| | 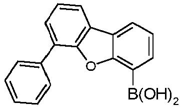 | |
| | [1010068-85-5] | |
| P120 | [3430-26-0] | 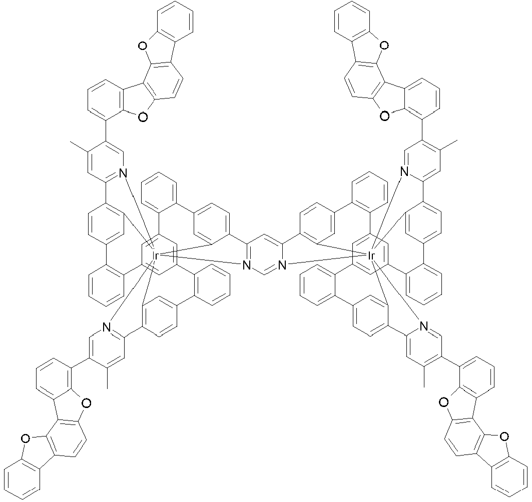 |
| | 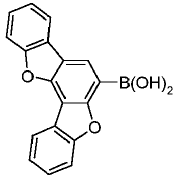 | |
| | [1377187-97-7] | |
| P121 | [3430-26-0] | 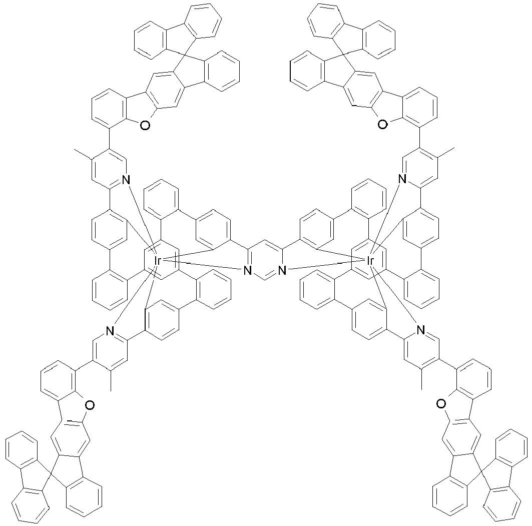 |
| | 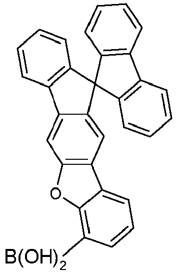 | |
| | [1799406-60-2] | |
| P122 | [3430-26-0] | 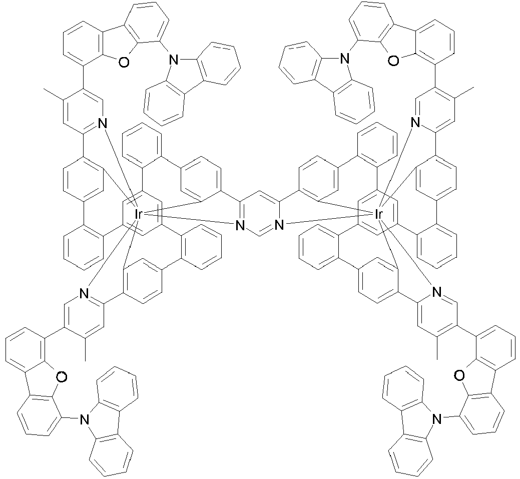 |
| | 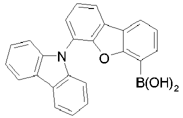 | |
| | [1651195-16-2] | |
| P123 | [3430-26-0] | 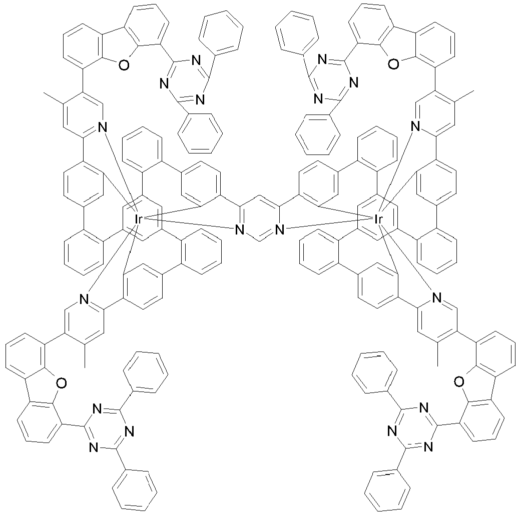 |
| | 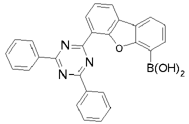 | |
| | [1449739-29-0] | |
| P124 | [3430-26-0] | 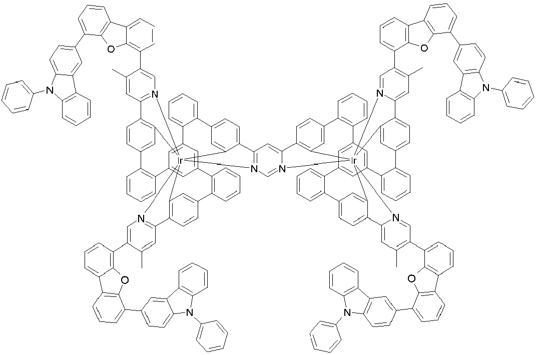 |
| | 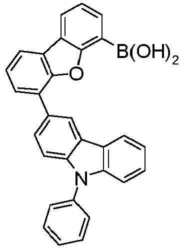 | |
| | [100124-06-9] | |
| P125 | [3430-26-0] | 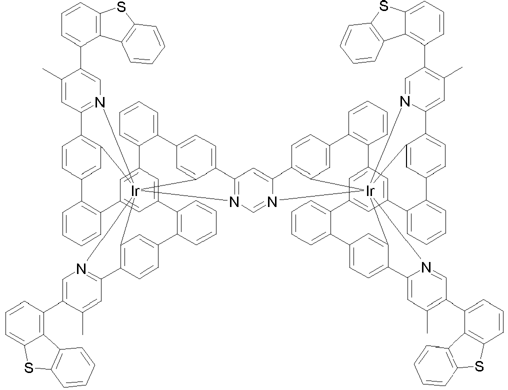 |
| | 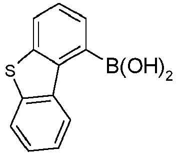 | |
| | [1245943-60-5] | |
| P126 | [3430-26-0] | 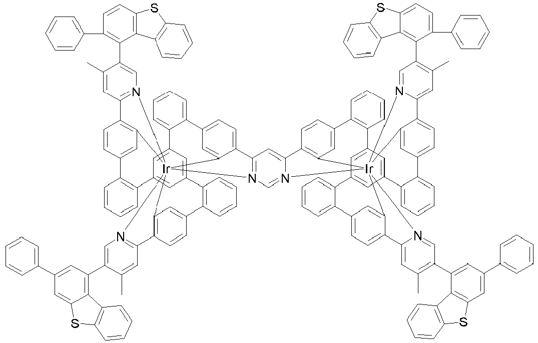 |
| | 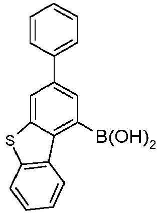 | |
| | [1245943-60-5] | |
| P127 | [3430-26-0] | 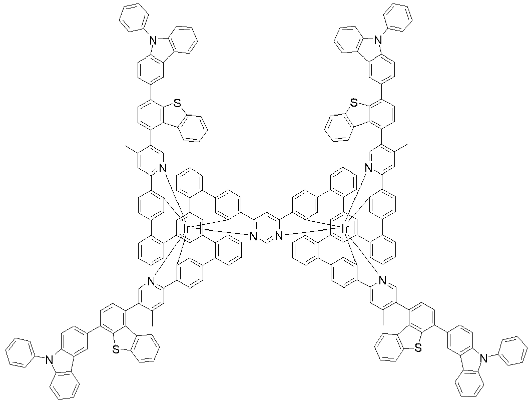 |
| | 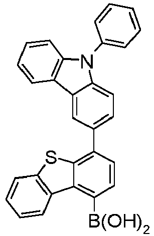 | |
| | [1822310-32-6] | |
| P128 | [3430-26-0] | 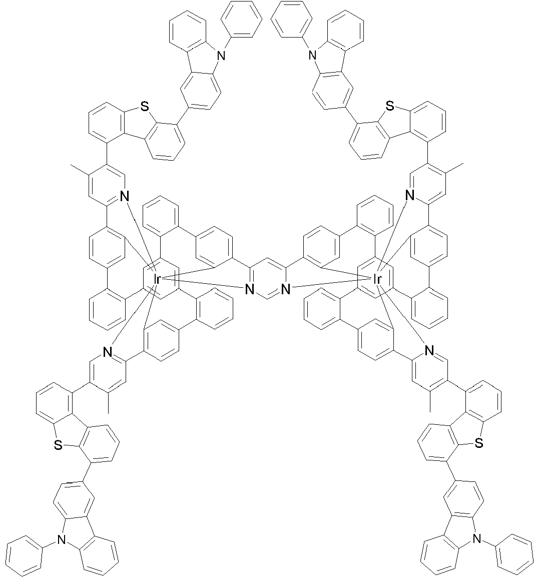 |
| | 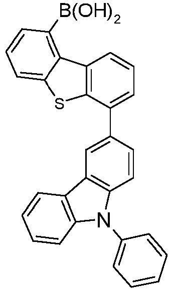 | |
| | [1821233-93-5] | |
| P129 | [3430-26-0] | 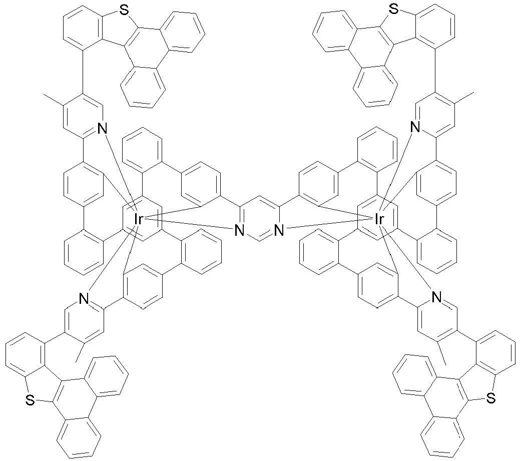 |
| | 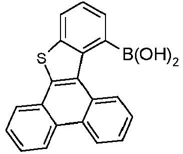 | |
| | [20017912-88-9] | |
| P130 | [3430-26-0] | 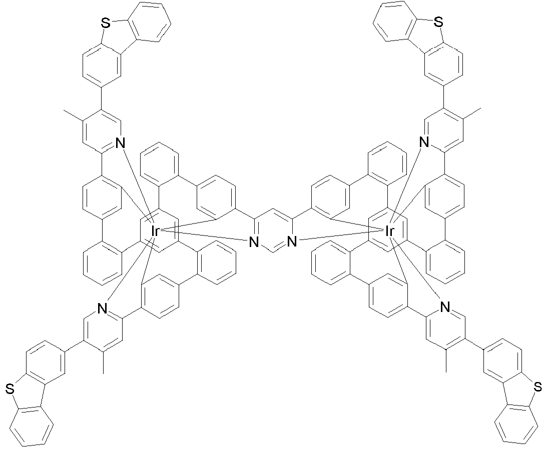 |
| | 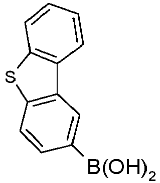 | |
| | [668983-97-9] | |
| P131 | [3430-26-0] | 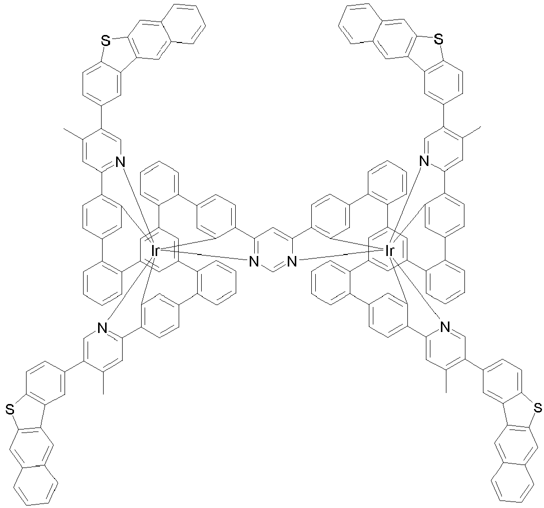 |
| | 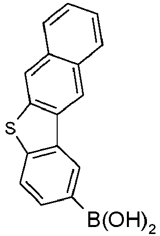 | |
| | [2035080-66-9] | |
| P132 | [3430-26-0] | 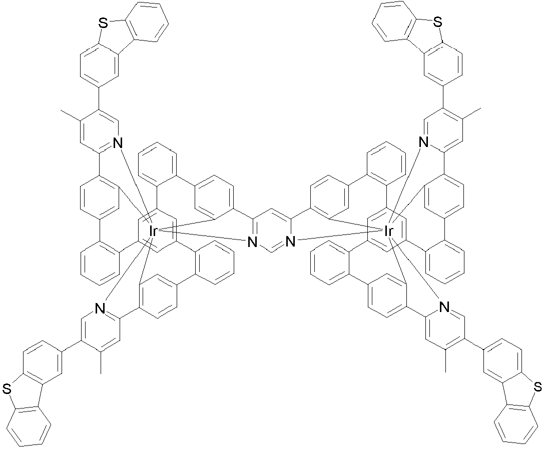 |
| | 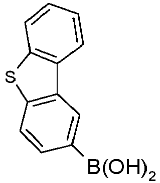 | |
| | [668983-97-9] | |
| P133 | [3430-26-0] | 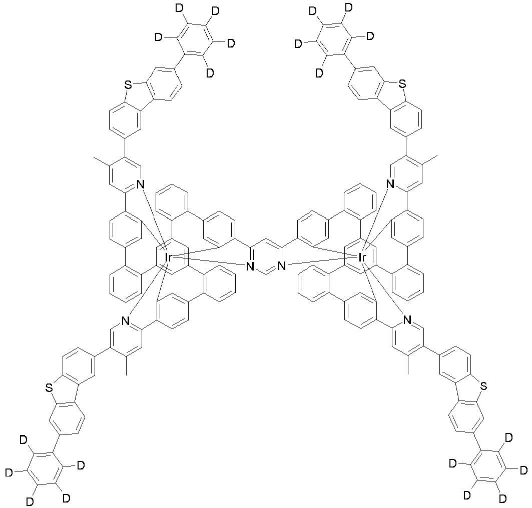 |
| | 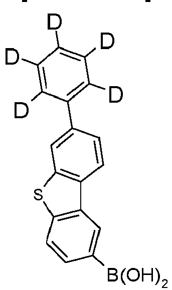 | |
| | [1385875-03-5] | |
| P134 | [3430-26-0] | 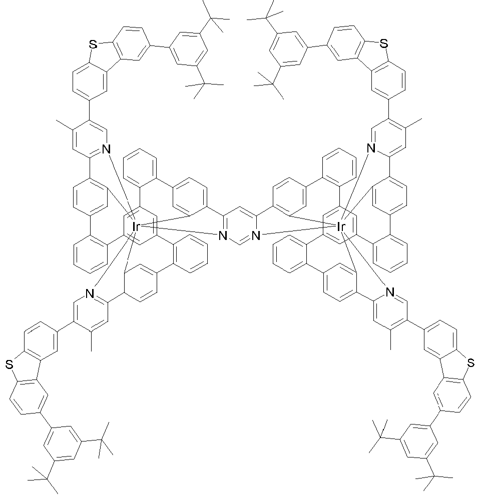 |
| | 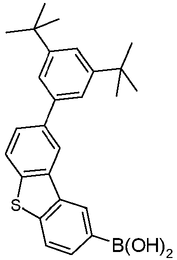 | |
| | [1616662-] | |
| P135 | [3430-26-0] | 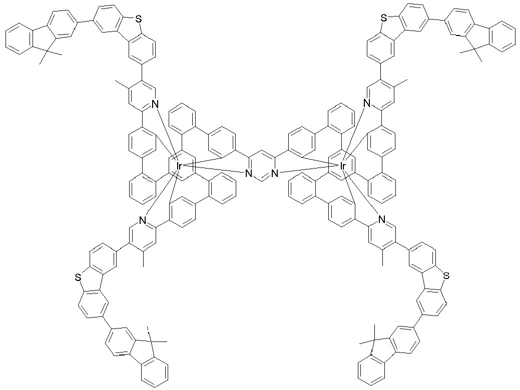 |
| | 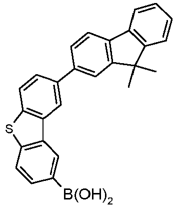 | |
| | [668983-97-9] | |
| P136 | [3430-26-0] | 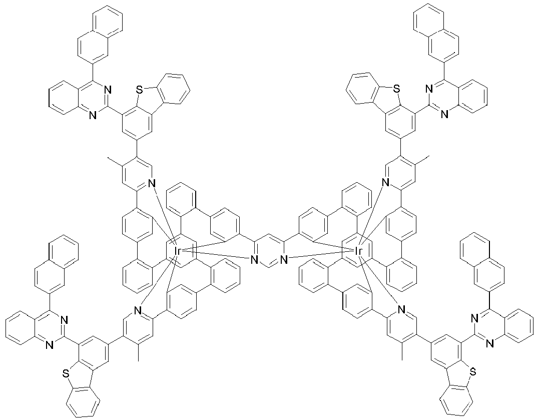 |
| | 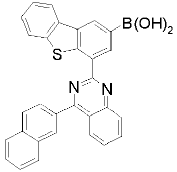 | |
| | [1852465-42-9] | |
| P137 | [3430-26-0] | 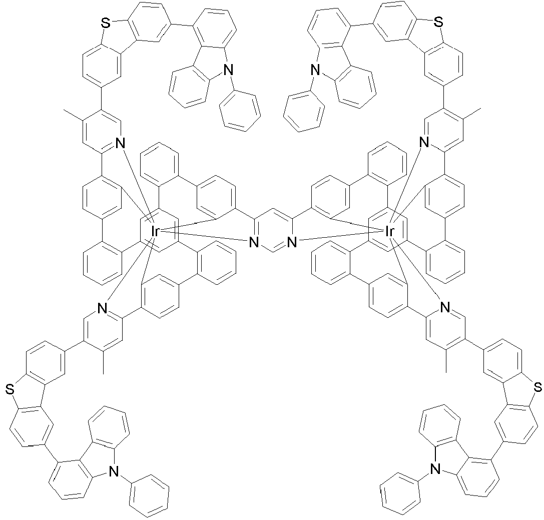 |
| | 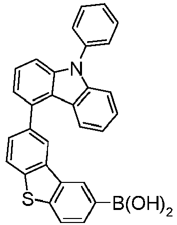 | |
| | [1885113-51-8] | |
| P138 | [3430-26-0] | 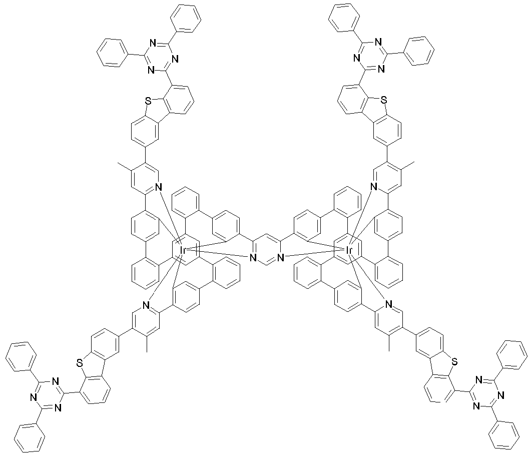 |
| | 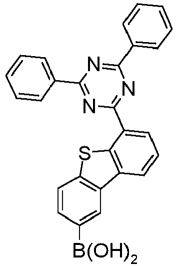 | |
| | [1964481-29-5] | |
| P139 | [3430-26-0] | 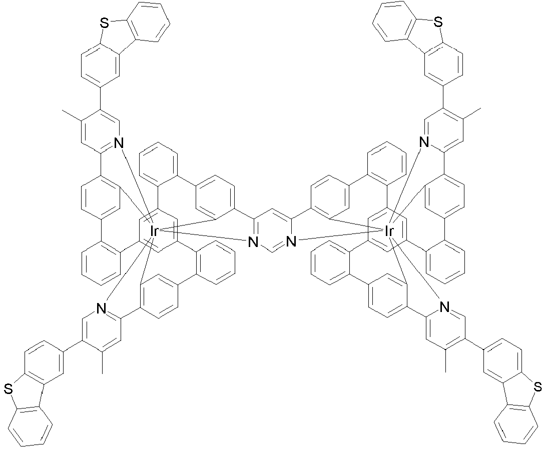 |
| | 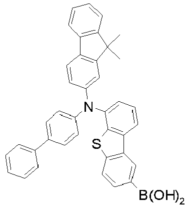 | |
| | [1946844-63-8] | |
| P140 | [3430-26-0] | 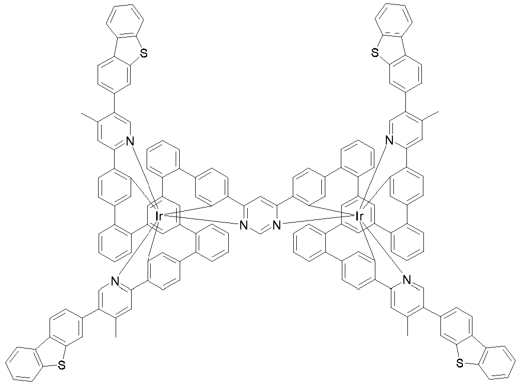 |
| | 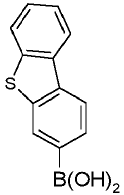 | |
| | [108847-24-1] | |
| P141 | [3430-26-0] | 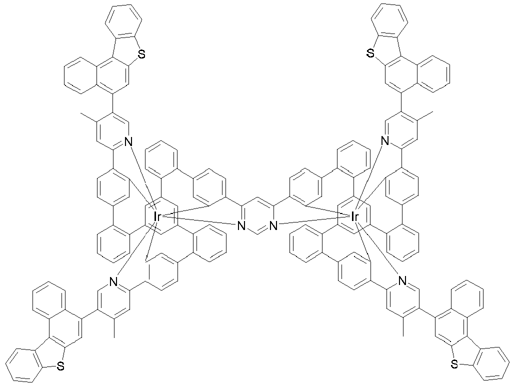 |
| | 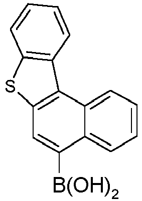 | |
| | [1447709-01-4] | |
| P142 | [3430-26-0] | 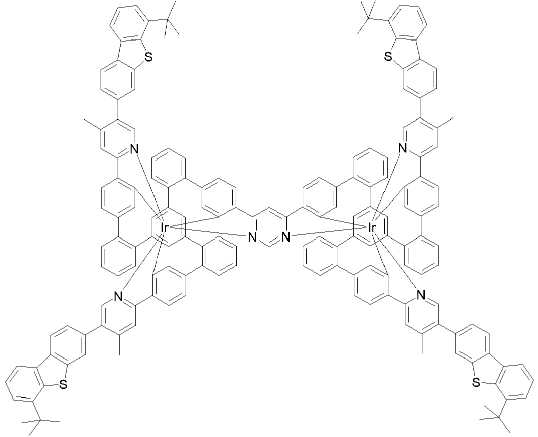 |
| | 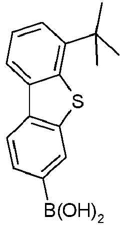 | |
| | [1947347-65-0] | |
| P143 | [3430-26-0] | 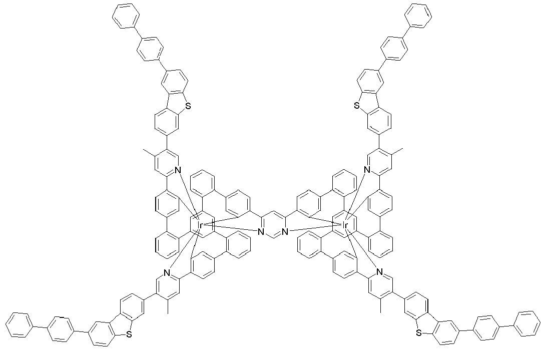 |
| | 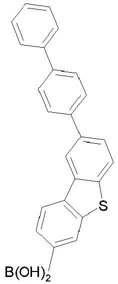 | |
| | [1947347-51-4] | |
| P144 | [3430-26-0] | 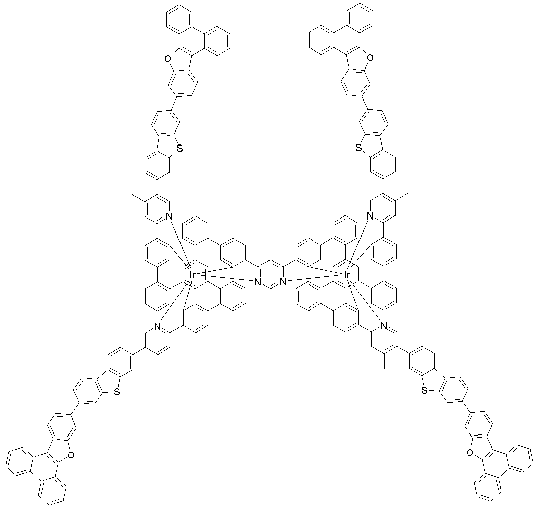 |
| | 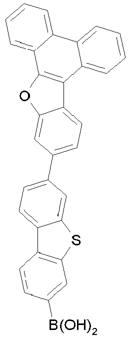 | |
| | [2007912-81-2] | |
| P145 | [3430-26-0] | 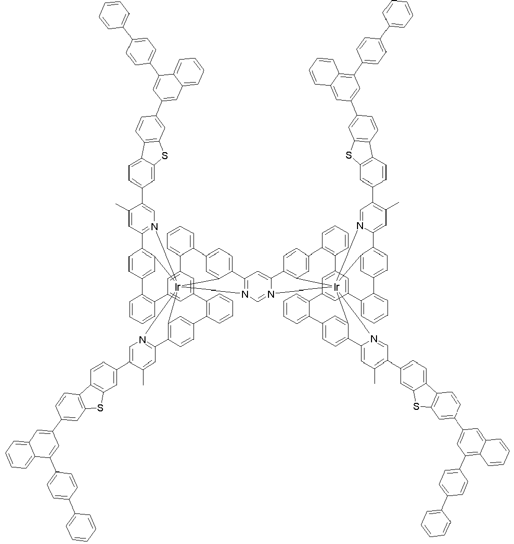 |
| | 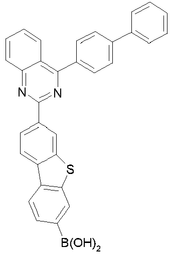 | |
| | [1852465-41-8] | |
| P146 | [3430-26-0] | 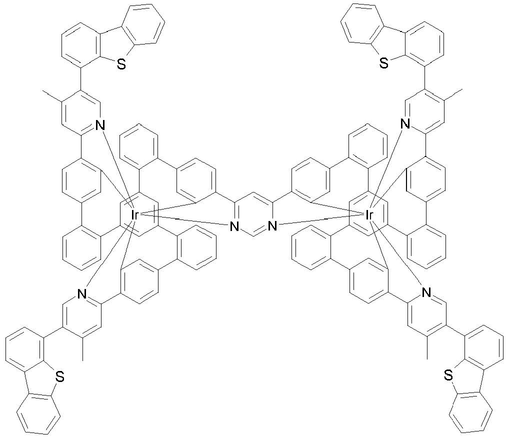 |
| | 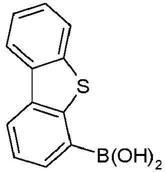 | |
| | [108847-20-7] | |
| P146 | [3430-26-0] | 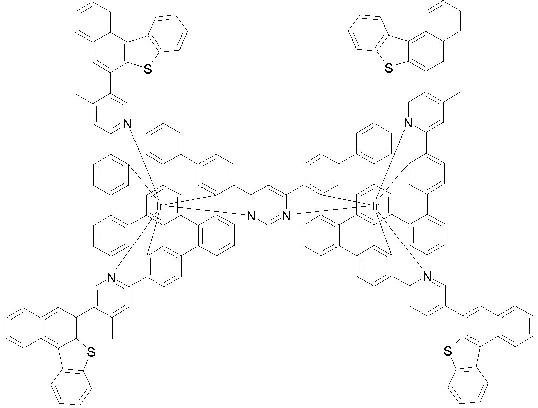 |
| | 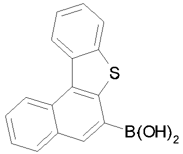 | |
| | [1383607-09-7] | |
| P147 | [3430-26-0] | 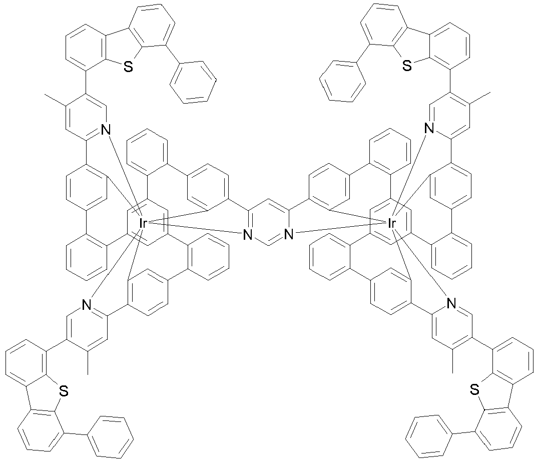 |
| | 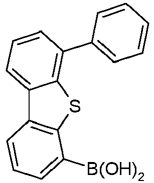 | |
| | [1115640-18-0] | |
| P148 | [3430-26-0] | 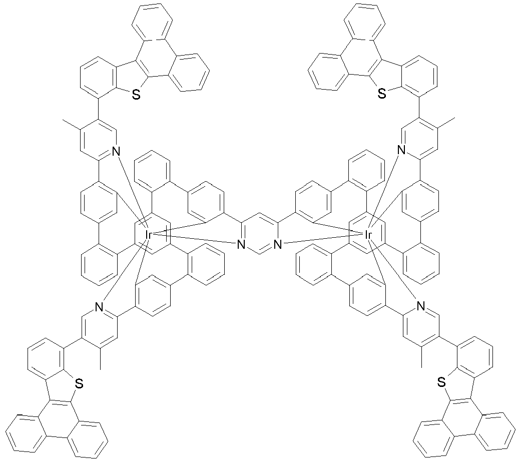 |
| | 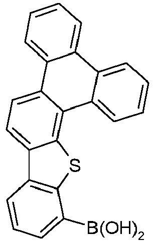 | |
| | [1644606-69-8] | |
| P149 | [3430-26-0] | 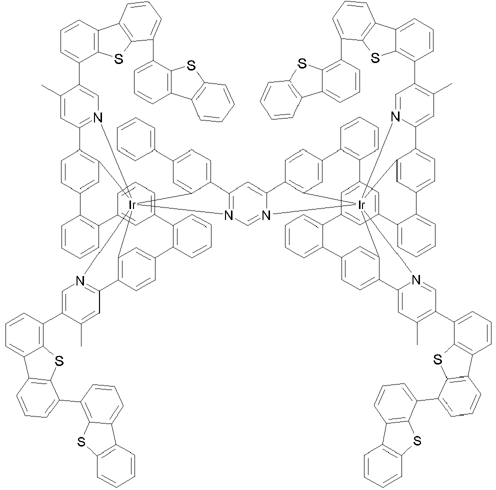 |
| | 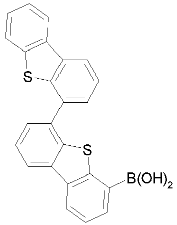 | |
| | [1673534-11-6] | |
| P150 | [3430-26-0] | 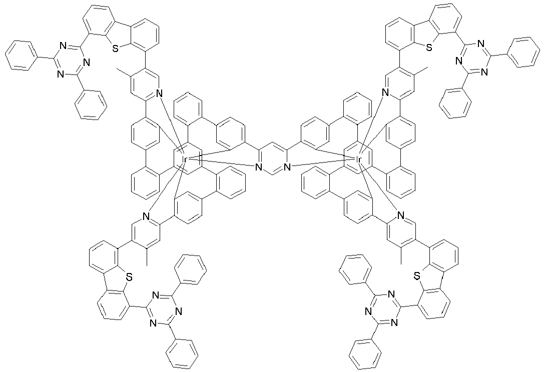 |
| | 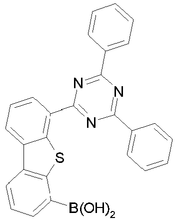 | |
| | [1883282-22-1] | |
| P151 | [3430-26-0] | 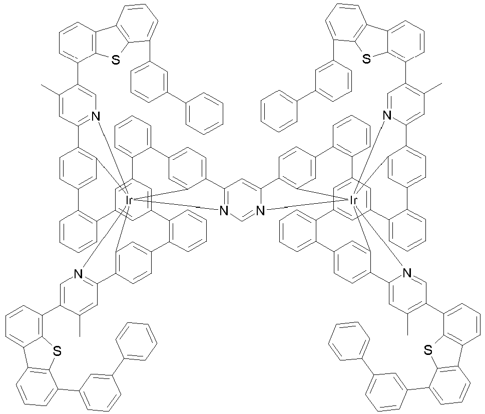 |
| | 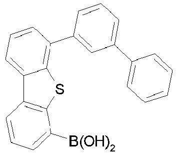 | |
| | [1858289-64-1] | |
| P152 | [3430-26-0] | 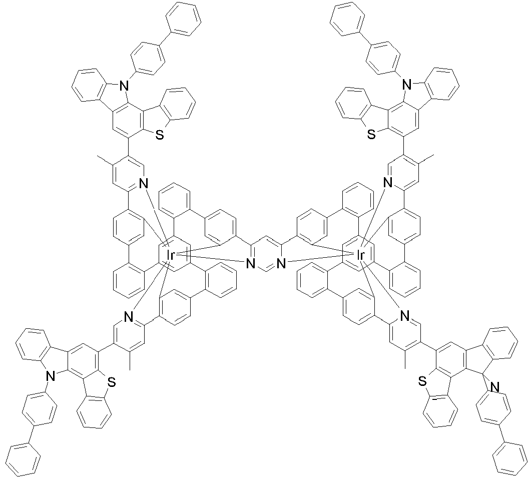 |
| | 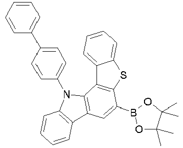 | |
| | [2012551-71-0] | |
| P153 | [3430-26-0] | 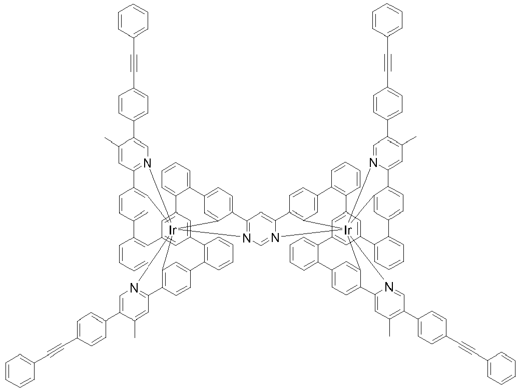 |
| | 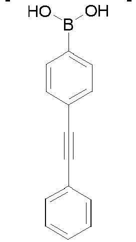 | |
| | [702699-63-6] | |
| P154 | [3430-26-0] | 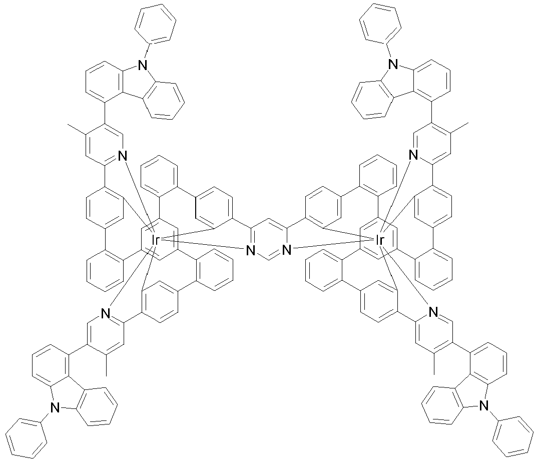 |
| | 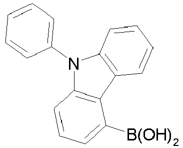 | |
| | [1370555-65-9] | |
| P155 | [3430-26-0] | 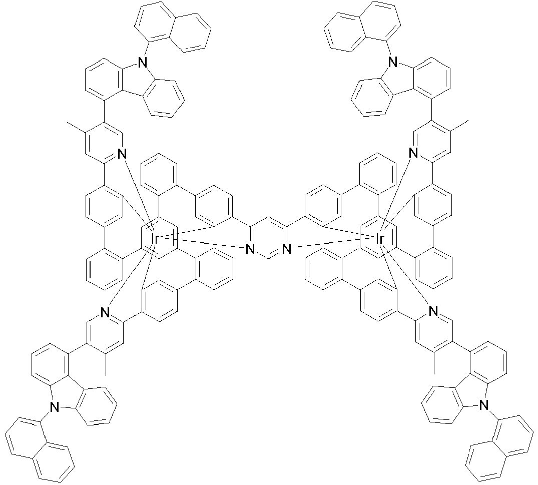 |
| | 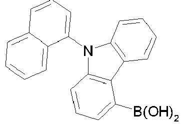 | |
| | [1686100-07-1] | |
| P156 | [3430-26-0] | 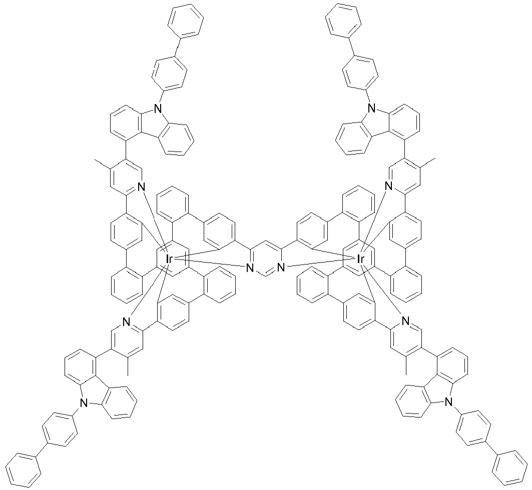 |
| | 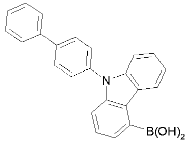 | |
| | [1686100-09-3] | |
| P157 | [3430-26-0] | 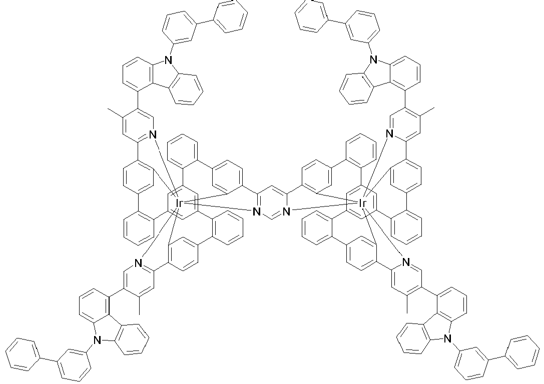 |
| | 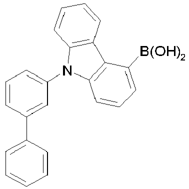 | |
| | [1843213-11-6] | |
| P158 | [3430-26-0] | 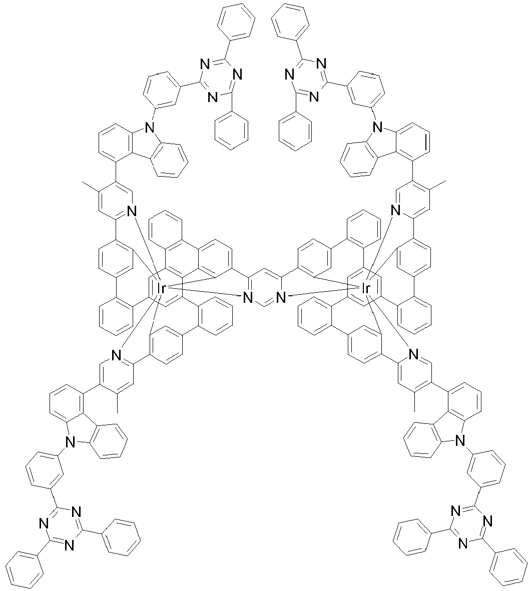 |
| | 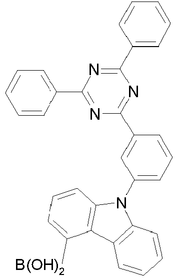 | |
| | [1843213-15-9] | |
| P159 | [3430-26-0] | 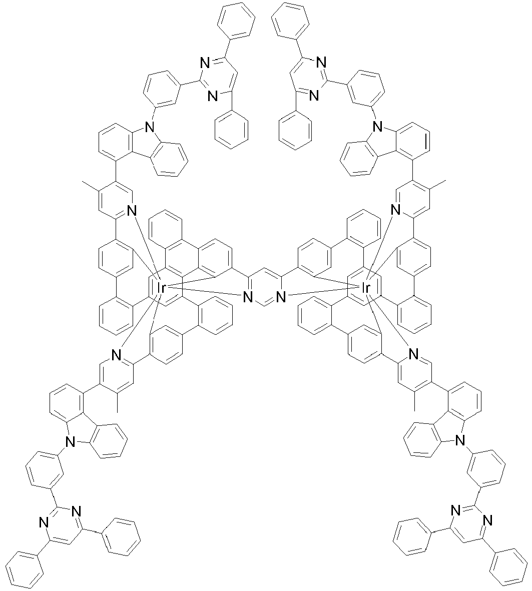 |
| | 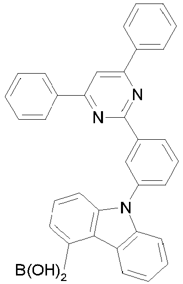 | |
| | [1843213-17-1] | |
| P160 | [3430-26-0] | 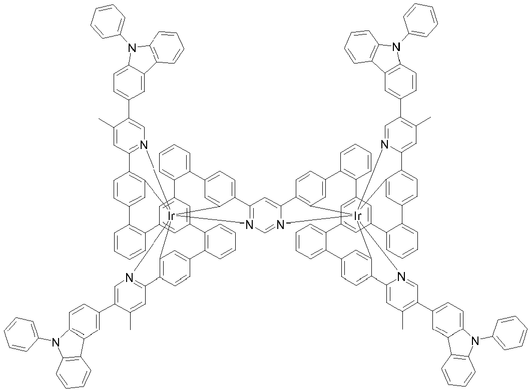 |
| | 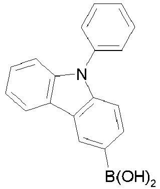 | |
| | [854952-58-2] | |
| P161 | [3430-26-0] | 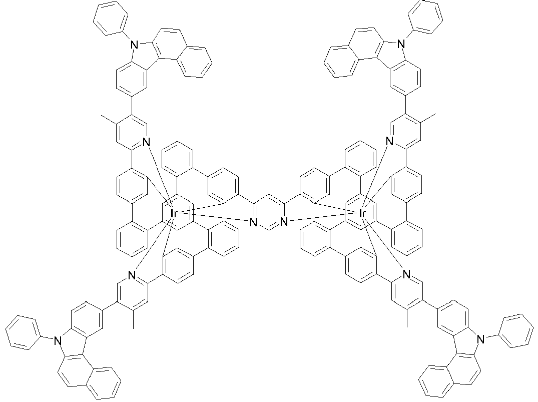 |
| | 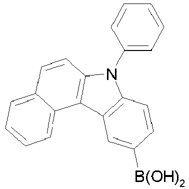 | |
| | [1246562-39-9] | |
| P162 | [3430-26-0] | 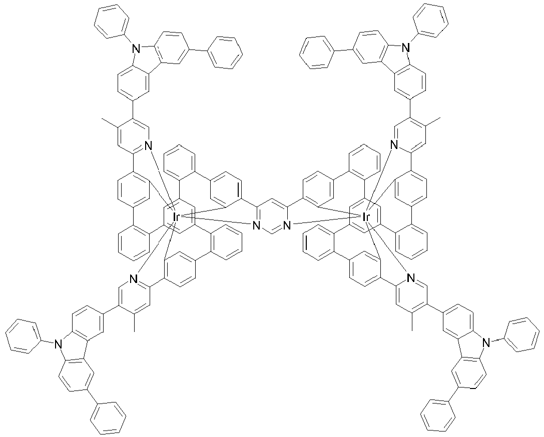 |
| | 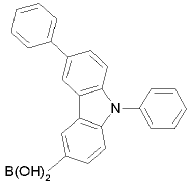 | |
| | [1133058-06-6] | |
| P163 | [3430-26-0] | 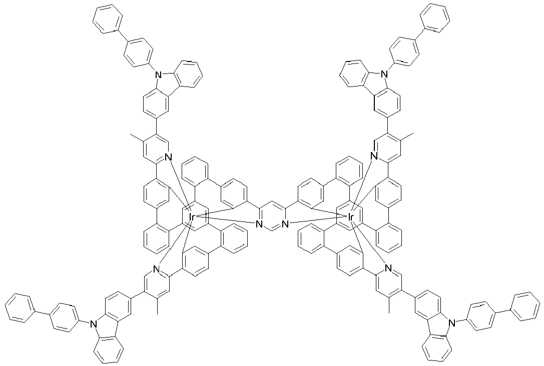 |
| | 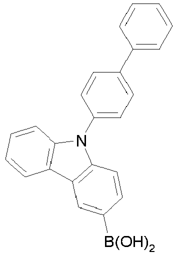 | |
| | [1026848-22-7] | |
| P164 | [3430-26-0] | 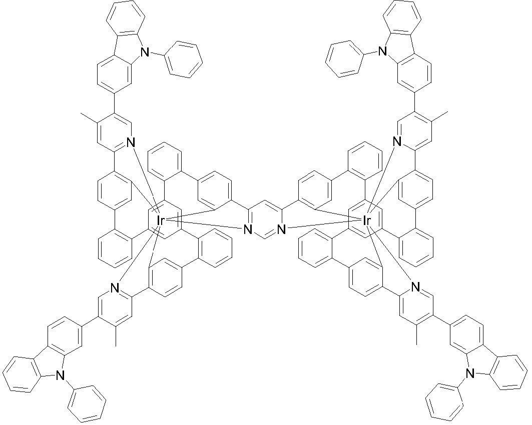 |
| | 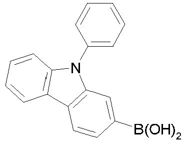 | |
| | [1001911-63-2] | |
| P165 | [3430-26-0] | 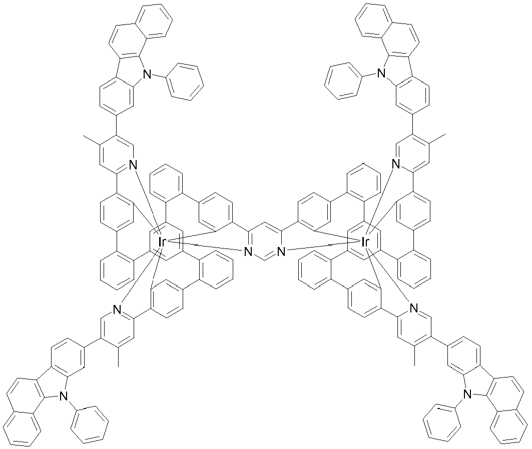 |
| | 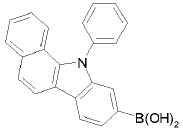 | |
| | [1379595-37-5] | |
| P166 | [3430-26-0] | 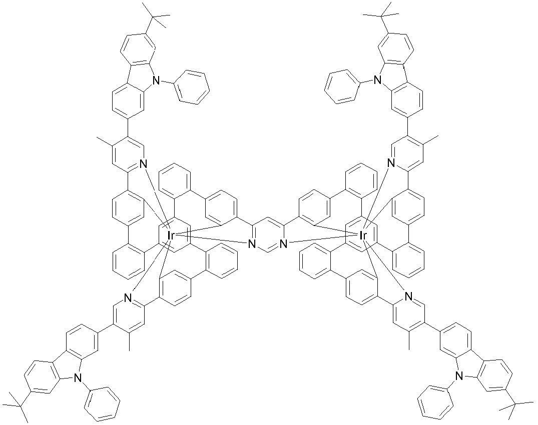 |
| | 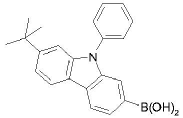 | |
| | [1637323-17-1] | |
| P167 | [3430-26-0] | 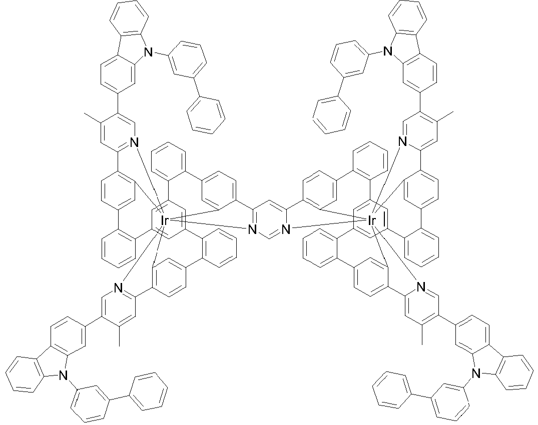 |
| | 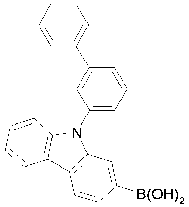 | |
| | [1835251-21-2] | |
| P168 | [3430-26-0] | 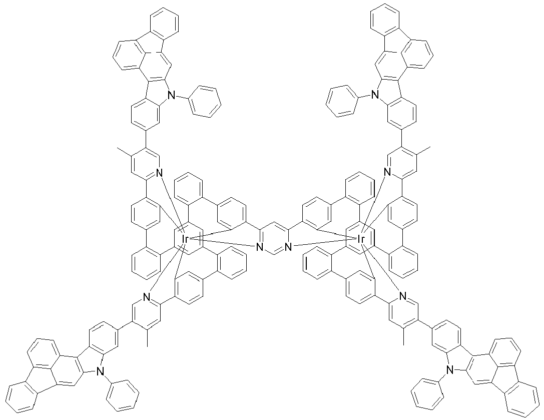 |
| | 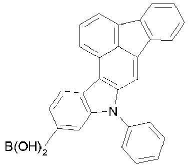 | |
| | [1364751-66-5] | |
| P169 | [3430-26-0] | 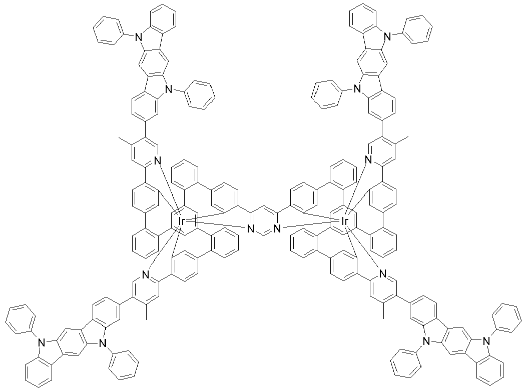 |
| | 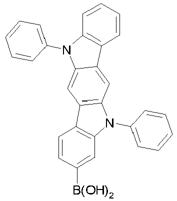 | |
| | [1314019-74-3] | |
| P170 | [3430-26-0] | 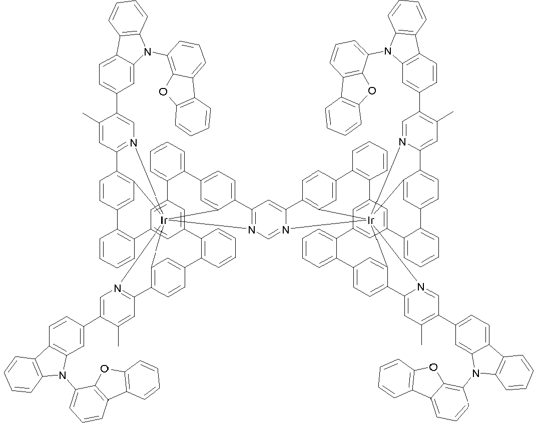 |
| | 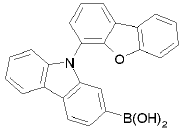 | |
| | [1637388-04-5] | |
| P171 | [3430-26-0] | 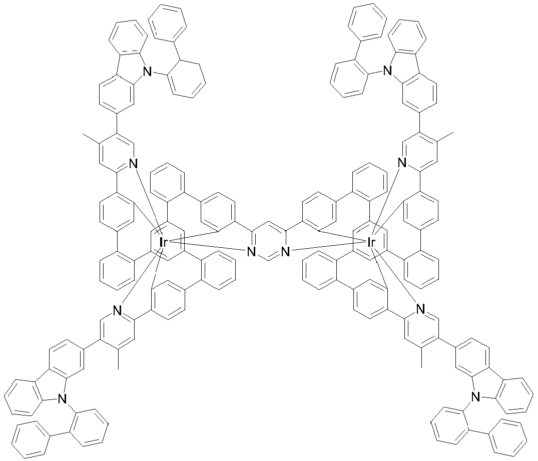 |
| | 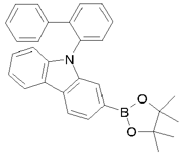 | |
| | [1801609-61-9] | |
| P172 | [3430-26-0] | 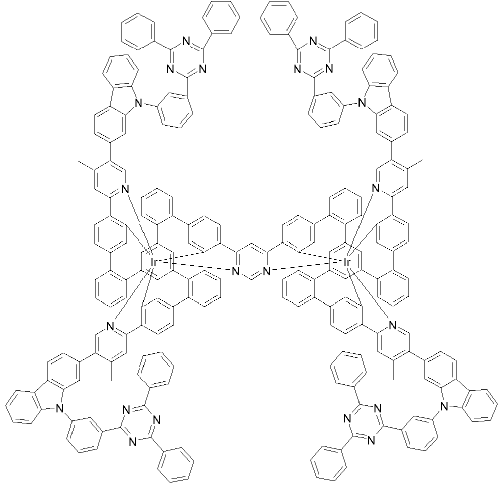 |
| | 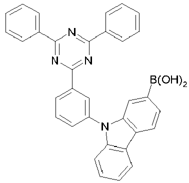 | |
| | [1642121-56-9] | |
| P173 | [3430-26-0] | 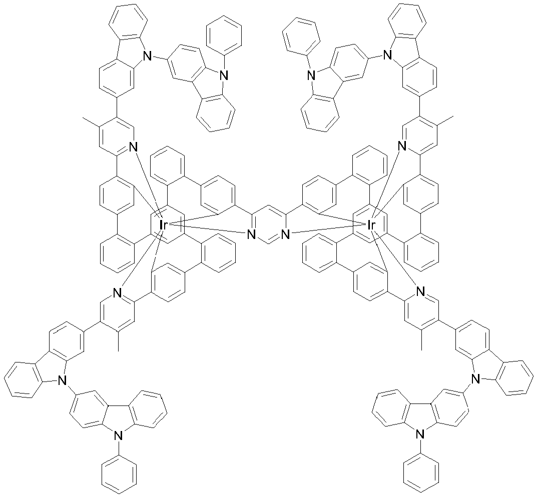 |
| | 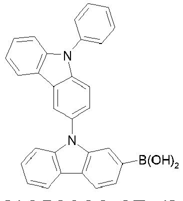 | |
| | [1656982-87-4] | |
| P174 | [3430-26-0] | 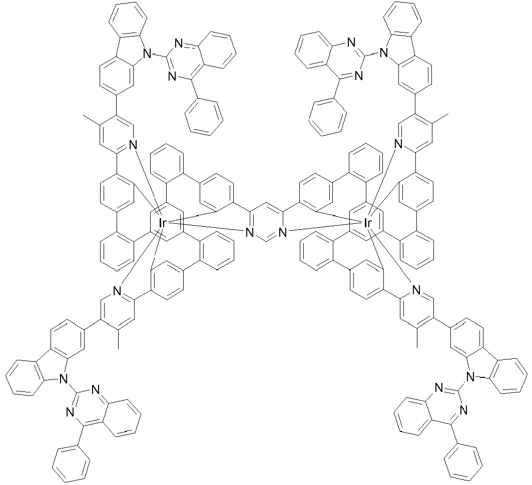 |
| | 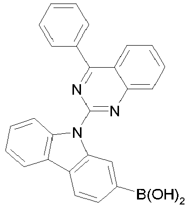 | |
| | [1642121-59-2] | |
| P175 | [3430-26-0] | 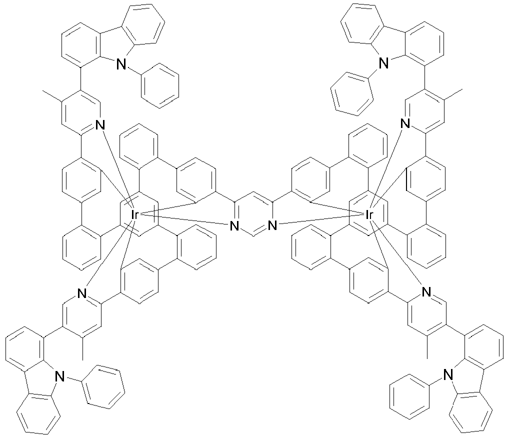 |
| | 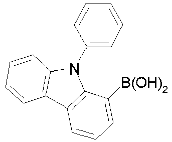 | |
| | [1333002-41-7] | |
| P176 | [3430-26-0] | 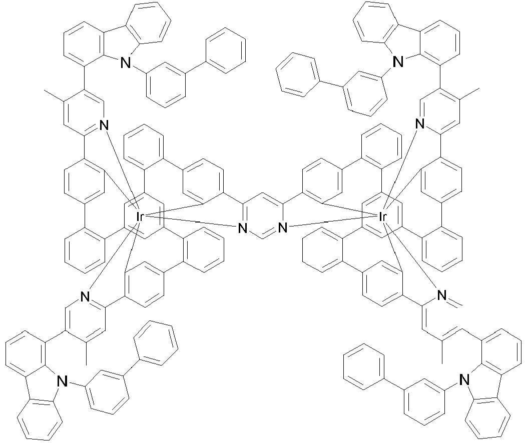 |
| | 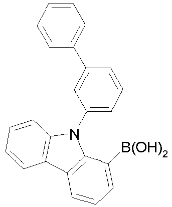 | |
| | [1796546-51-4] | |
| P177 | [3430-26-0] | 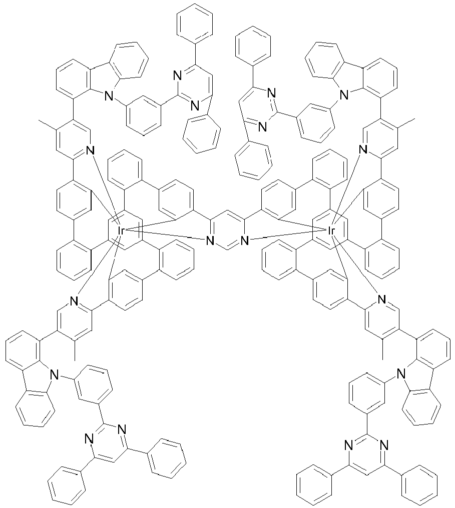 |
| | 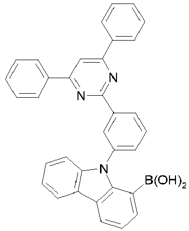 | |
| | [1843211-08-4] | |
| P178 | 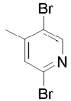 | 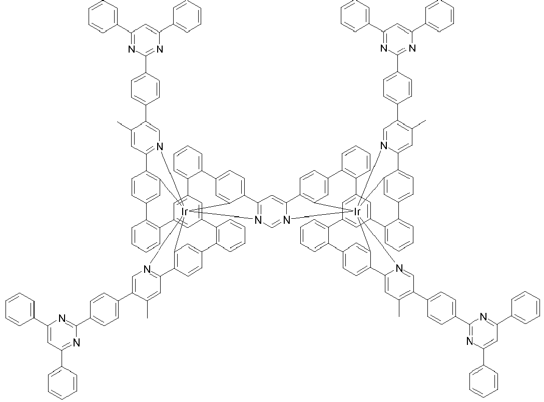 |
| | [3430-26-0] | |
| | 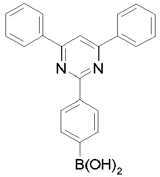 | |
| | [1260393-76-7] | |
| P179 | 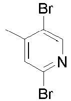 | 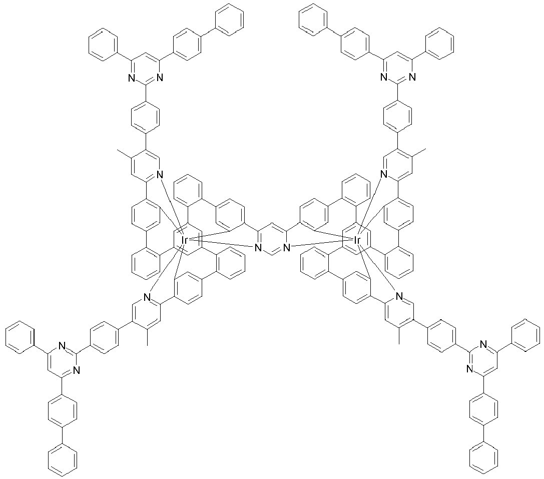 |
| | [3430-26-0] | |
| | 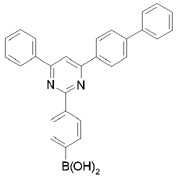 | |
| | [1689538-49-5] | |
| P180 | 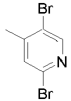 | 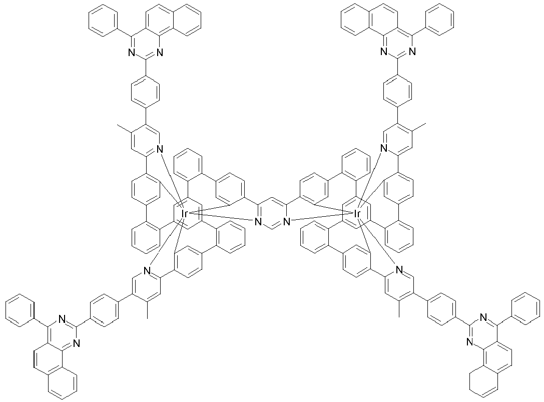 |
| | [3430-26-0] | |
| | 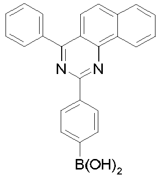 | |
| | [1616841-80-5] | |
| P181 | 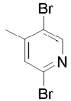 | 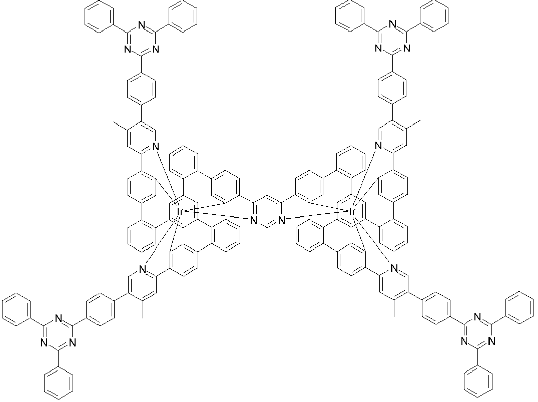 |
| | [3430-26-0] | |
| | 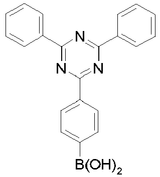 | |
| | [1313018-07-3] | |
| P182 | 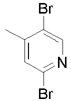 | 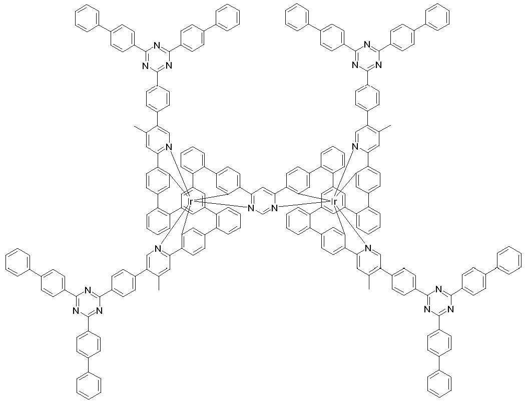 |
| | [3430-26-0] | |
| | 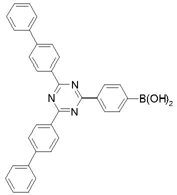 | |
| | [1821675-79-9] | |
| P183 | 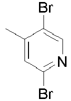 | 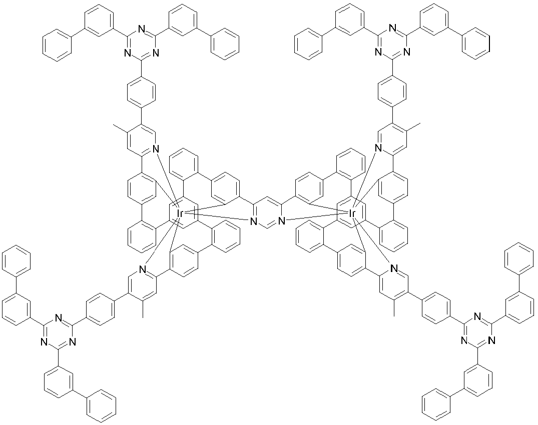 |
| | [3430-26-0] | |
| | 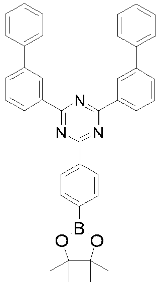 | |
| | [1835206-27-3] | |
| P184 | 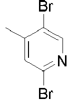 | 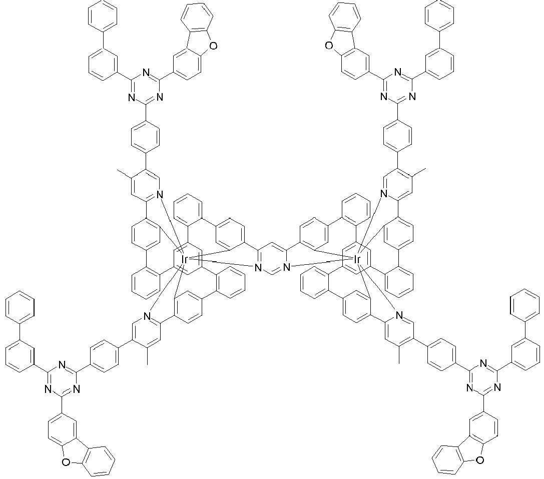 |
| | [3430-26-0] | |
| | 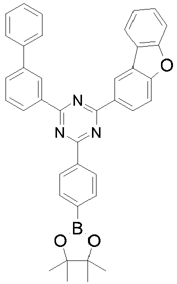 | |
| | [1835206-50-2] | |
| P185 | 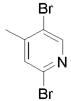 | 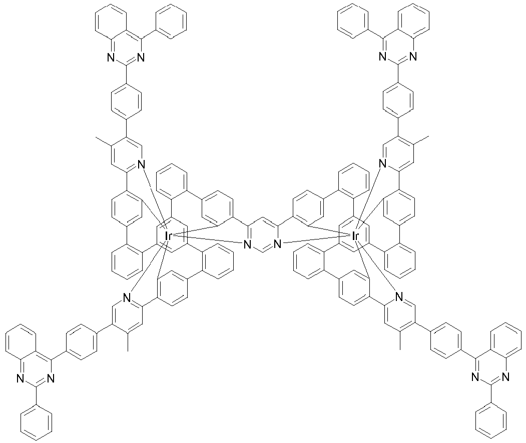 |
| | [3430-26-0] | |
| | 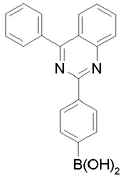 | |
| | [1801285-72-2] | |
| P186 | 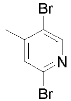 | 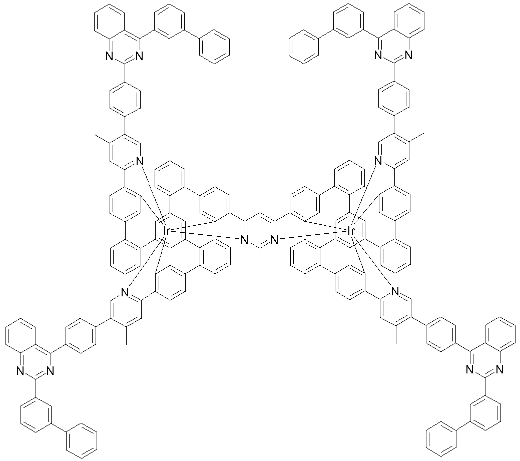 |
| | [3430-26-0] | |
| | 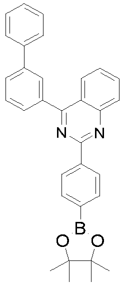 | |
| | [1637377-59-3] | |
| P187 | 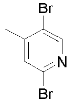 | 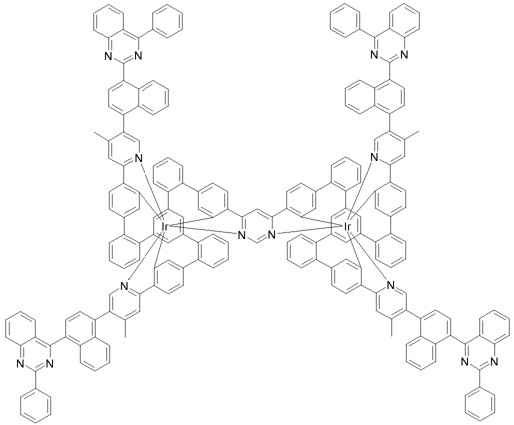 |
| | [3430-26-0] | |
| | 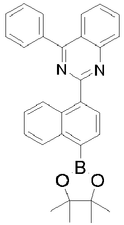 | |
| | [1621468-52-7] | |
| P188 | 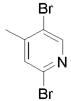 | 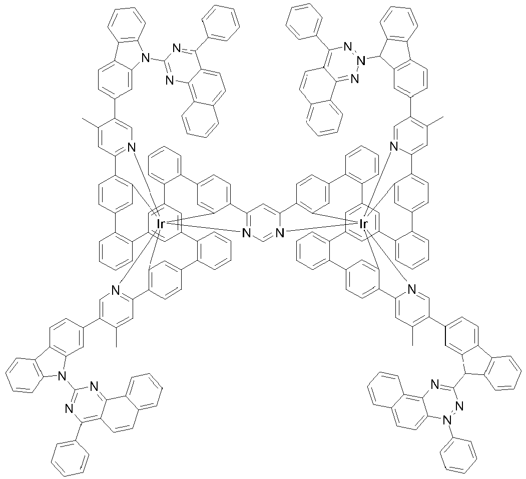 |
| | [3430-26-0] | |
| | 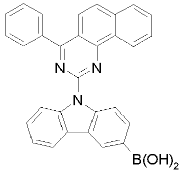 | |
| | [1813537-15-3] | |
| P189 | 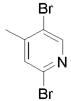 | 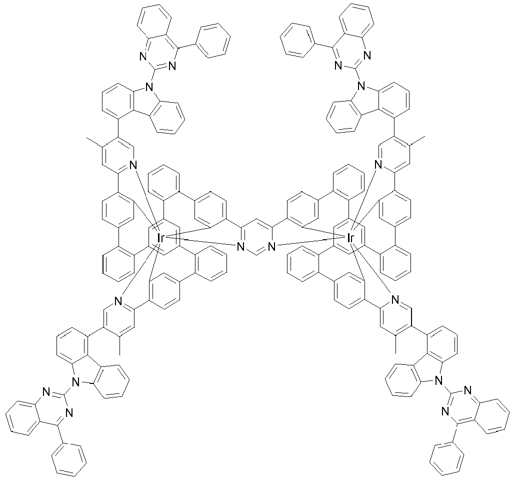 |
| | [3430-26-0] | |
| | 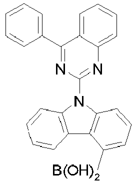 | |
| | [1813537-15-3] | |
| P190 | 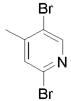 | 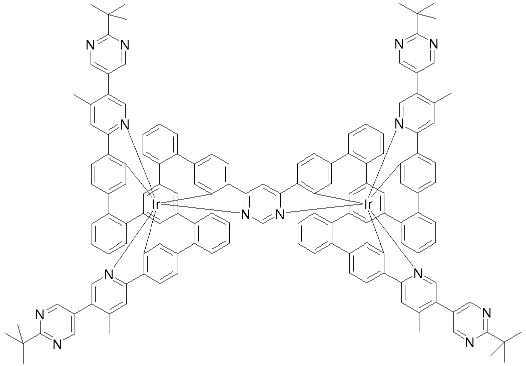 |
| | [3430-26-0] | |
| | 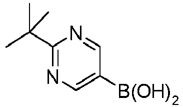 | |
| | [1352570-51-4] | |
| P191 | 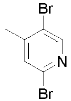 | 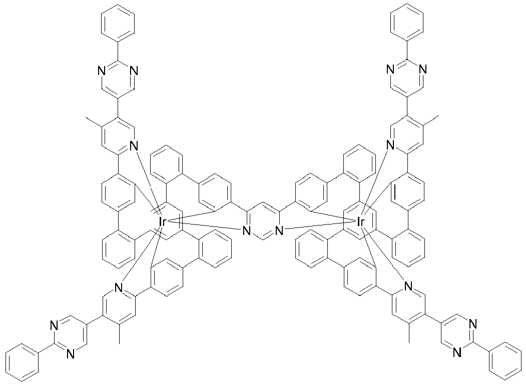 |
| | [3430-26-0] | |
| | 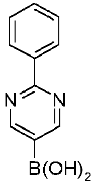 | |
| | [1264510-78-2] | |
| P192 | 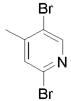 | 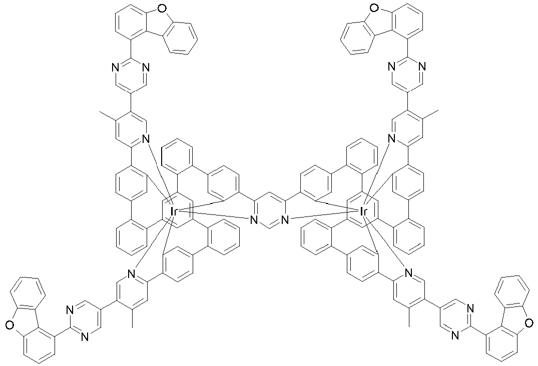 |
| | [3430-26-0] | |
| | 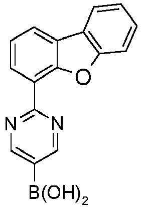 | |
| | [1621690-58-1] | |
| P193 | 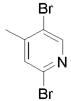 | 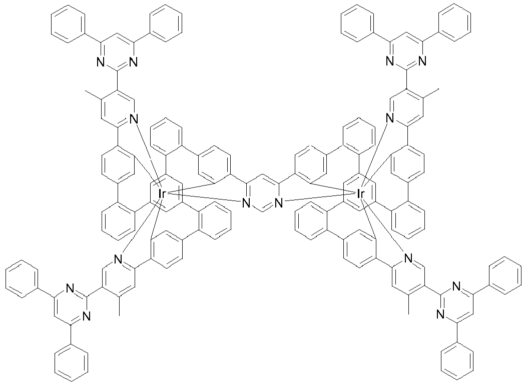 |
| | [3430-26-0] | |
| | 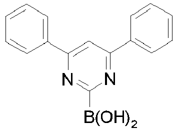 | |
| | [1314221-56-1] | |
| P194 | 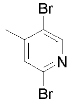 | 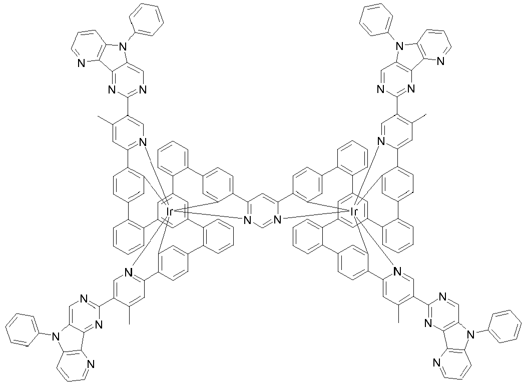 |
| | [3430-26-0] | |
| | 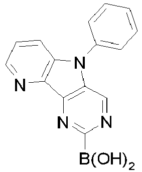 | |
| | [1632351-02-0] | |
| P195 | 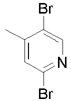 | 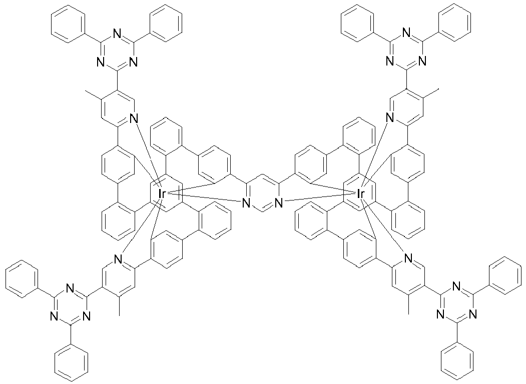 |
| | [3430-26-0] | |
| | 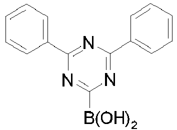 | |
| | [1251825-65-6] | |
| P196 | 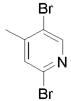 | 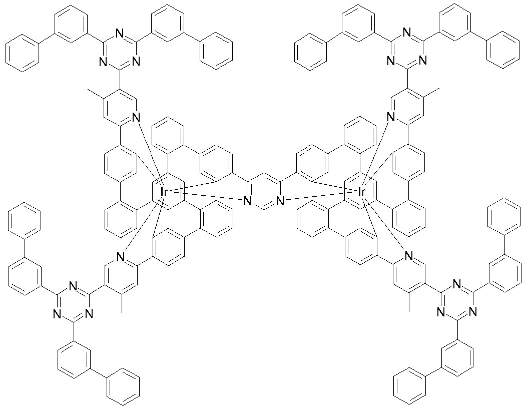 |
| | [3430-26-0] | |
| | 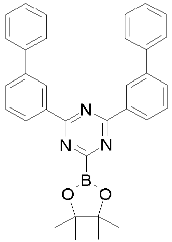 | |
| | [1946760-59-3] | |
| P197 | 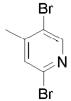 | 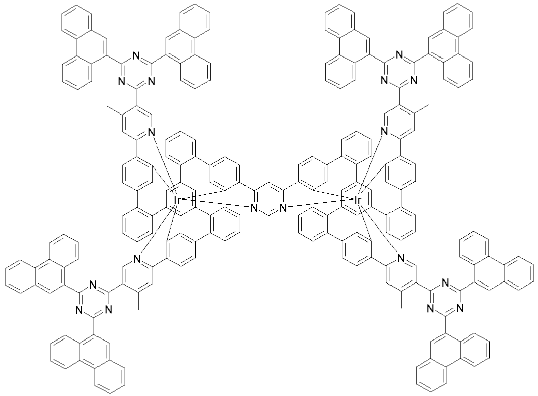 |
| | [3430-26-0] | |
| | 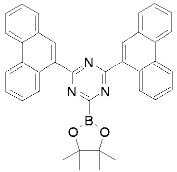 | |
| | [1646151-66-7] | |
| P198 | 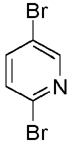 | 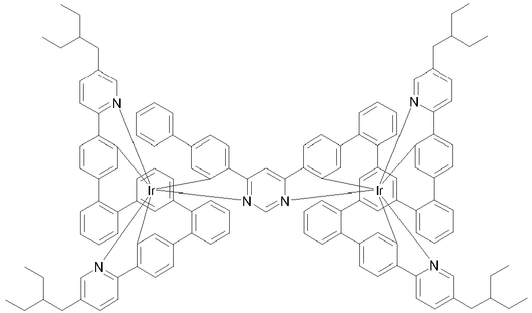 |
| | [624-28-2] | |
| | 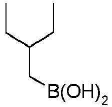 | |
| | [140614-19-3] | |
| P199 | 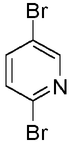 | 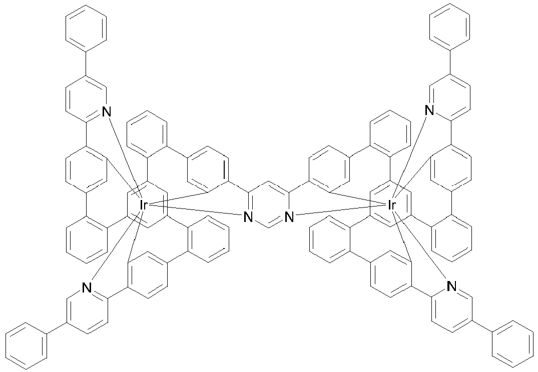 |
| | [624-28-2] | |
| | 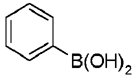 | |
| | [98-80-6] | |
| P200 | 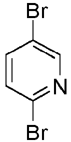 | 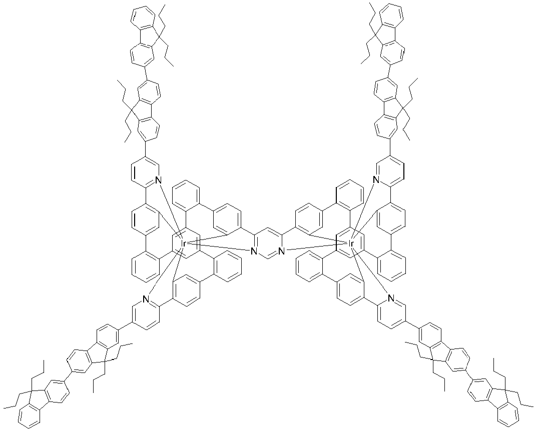 |
| | [624-28-2] | |
| | 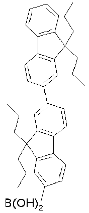 | |
| | [409093-94-3] | |
| P201 | 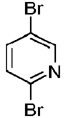 | 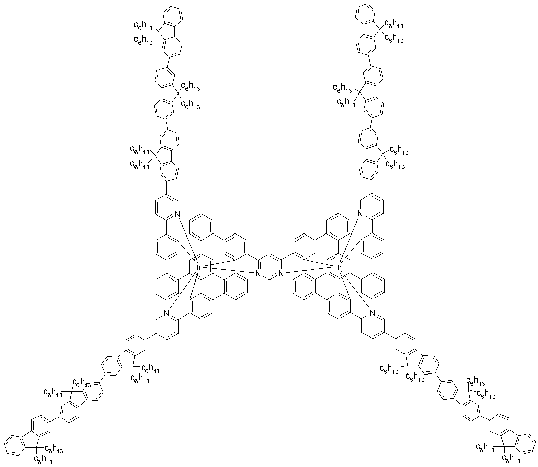 |
| | [624-28-2] | |
| | 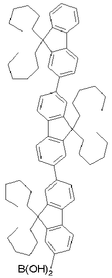 | |
| | [797789-74-3] | |
| P202 | 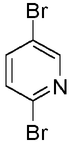 | 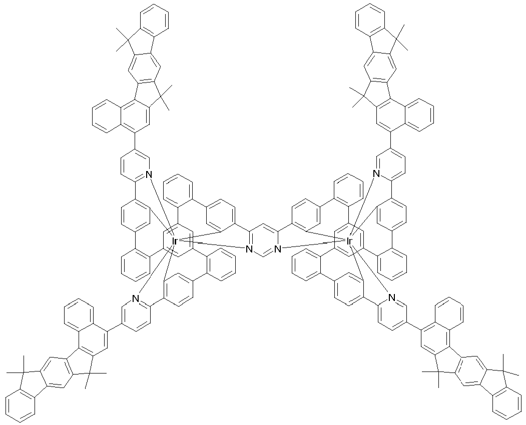 |
| | [624-28-2] | |
| | 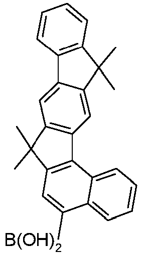 | |
| | [1001911-29-0] | |
| P203 | 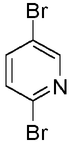 | 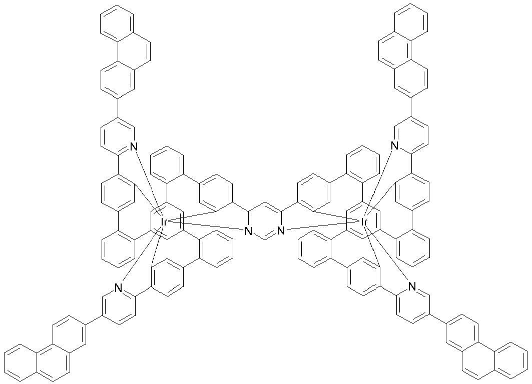 |
| | [624-28-2] | |
| | 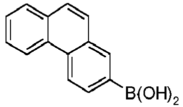 | |
| | [1188094-10-1] | |
| P204 | 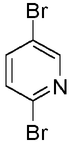 | 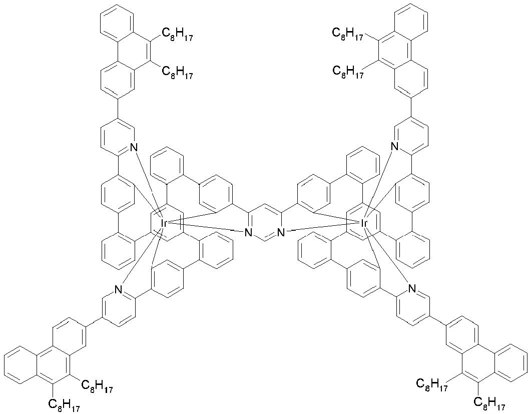 |
| | [624-28-2] | |
| | 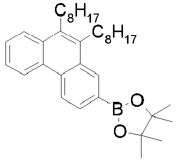 | |
| | [1616106-39-8] | |
| P205 | 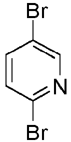 | 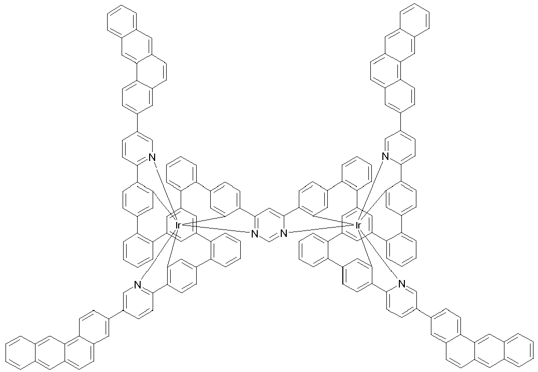 |
| | [624-28-2] | |
| | 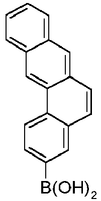 | |
| | [1087346-77-7] | |
| P206 | 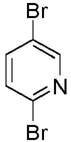 | 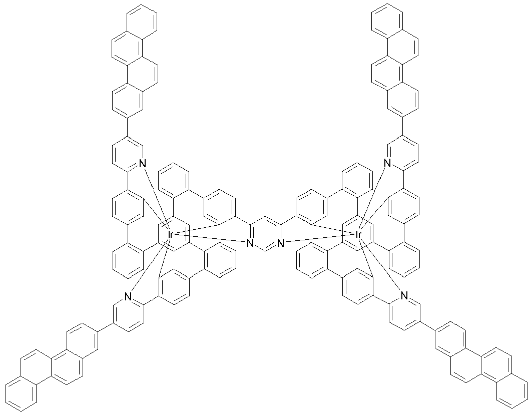 |
| | [624-28-2] | |
| | 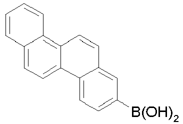 | |
| | [1922905-61-0] | |
| P207 | 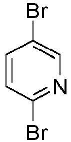 | 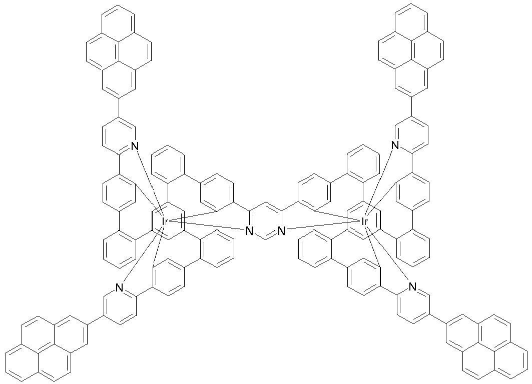 |
| | [624-28-2] | |
| | 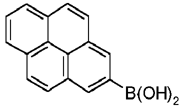 | |
| | [1195975-05-3] | |
| P208 | 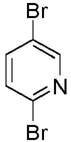 | 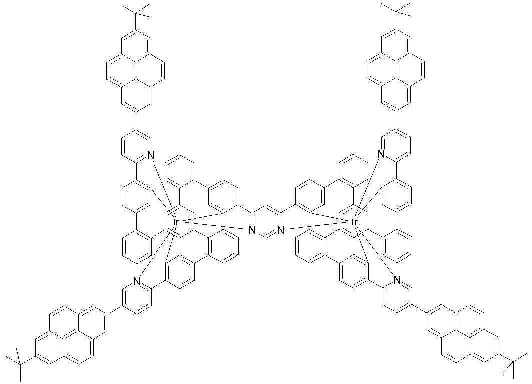 |
| | [624-28-2] | |
| | 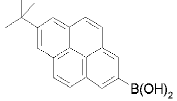 | |
| | [1962181-43-6] | |
| P209 | 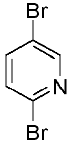 | 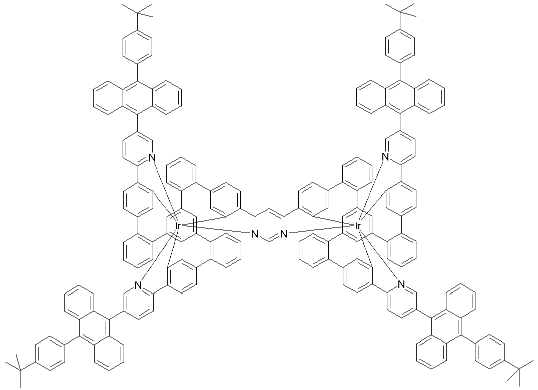 |
| | [624-28-2] | |
| | 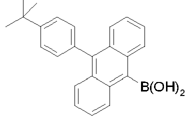 | |
| | [870119-38-3] | |
| P210 | 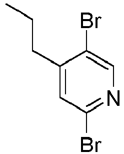 | 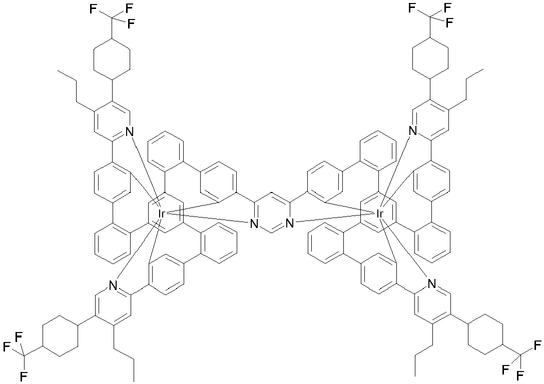 |
| | [1254043-54-3] | |
| | 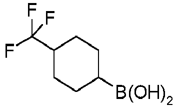 | |
| | [1895004-33-7] | |
| P211 | 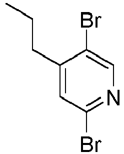 | 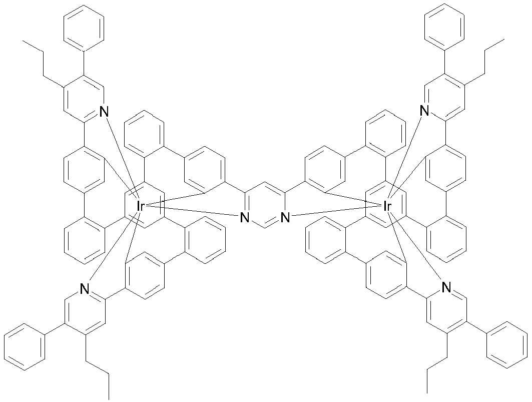 |
| | [1254043-54-3] | |
| | 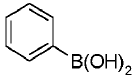 | |
| | [98-80-6] | |
| P212 | 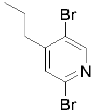 | 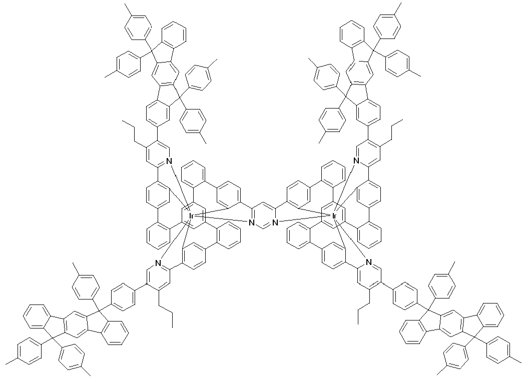 |
| | [1254043-54-3] | |
| | 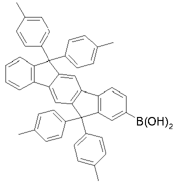 | |
| | [1193104-86-7] | |
| P213 | 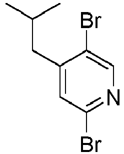 | 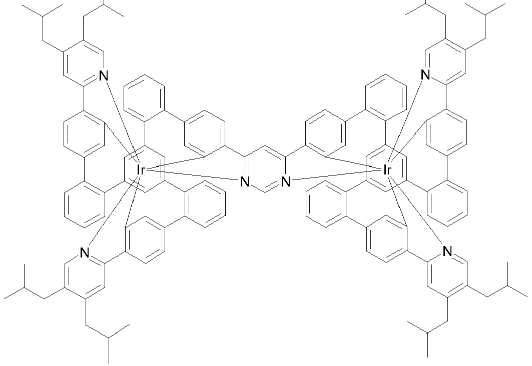 |
| | [1957986-14-9] | |
| | 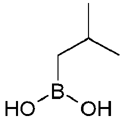 | |
| | [84110-40-7] | |
| P214 | 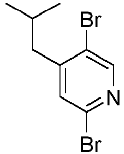 | 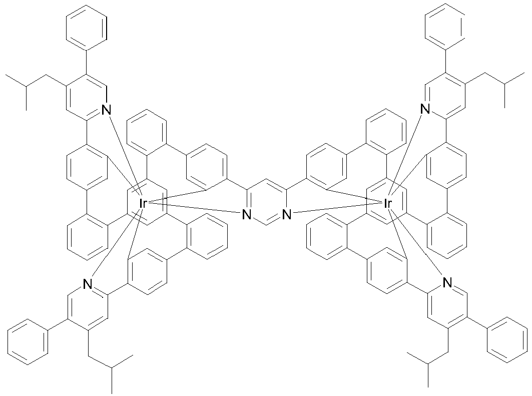 |
| | [1957986-14-9] | |
| | 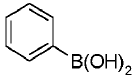 | |
| | [98-80-6] | |
| P215 | 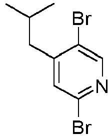 | 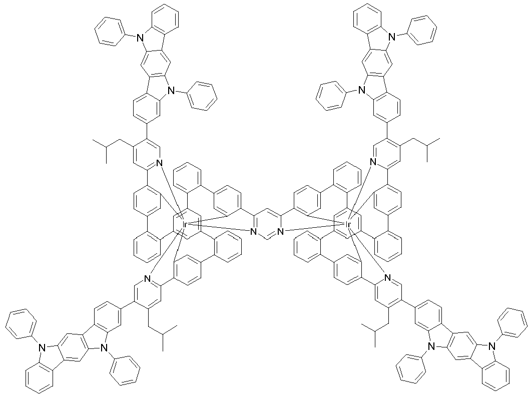 |
| | [1957986-14-9] | |
| | 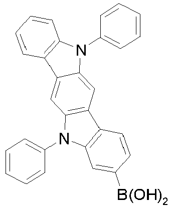 | |
| | [1314019-74-3] | |
| P216 | 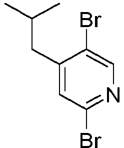 | 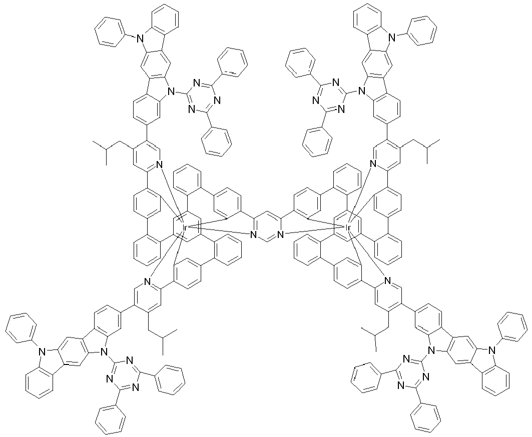 |
| | [1957986-14-9] | |
| | 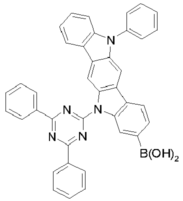 | |
| | [1314019-71-0] | |
| P217 | 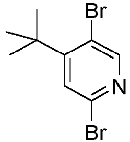 | 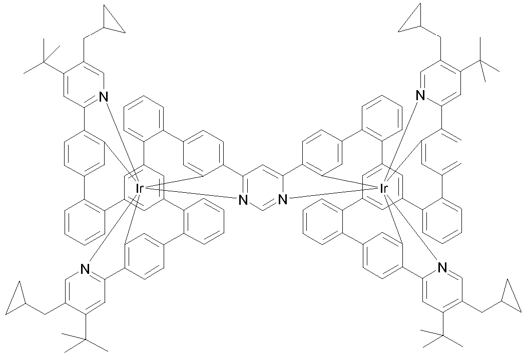 |
| | [1256798-90-8] | |
| | 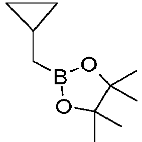 | |
| | [1344115-77-0] | |
| P218 | 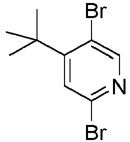 | 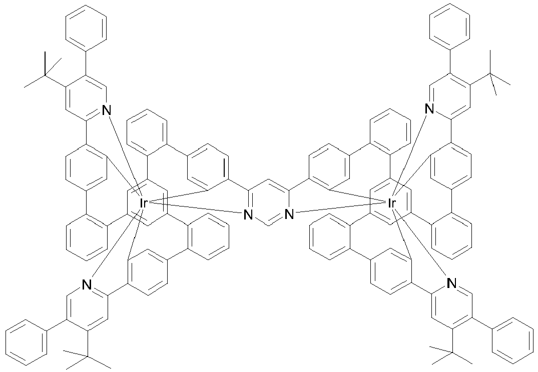 |
| | [1256798-90-8] | |
| | 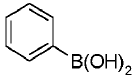 | |
| | [98-80-6] | |
| P219 | 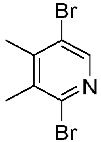 | 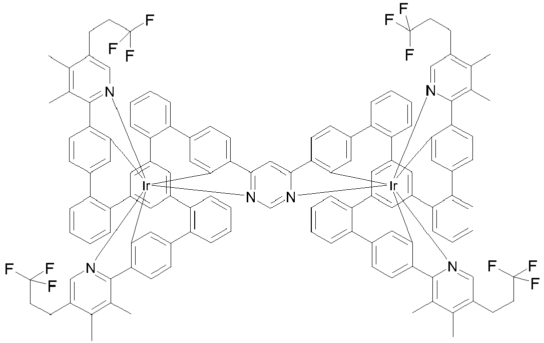 |
| | [125419-92-3] | |
| | 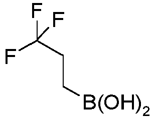 | |
| | [1148113-74-9] | |
| P220 | 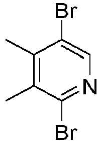 | 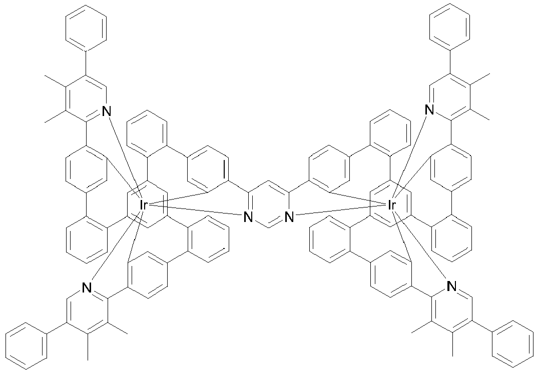 |
| | [125419-92-3] | |
| | 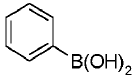 | |
| | [98-80-6] | |
| P221 | 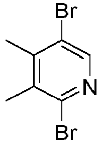 | 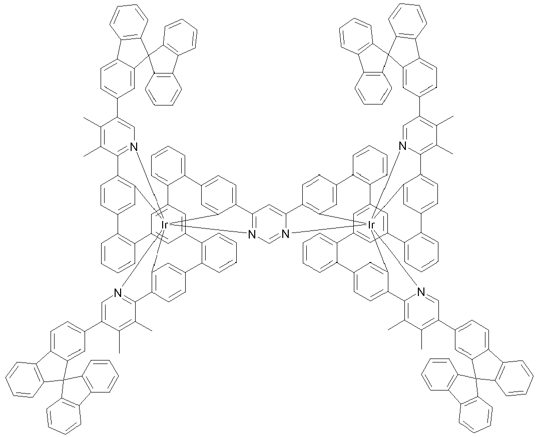 |
| | [125419-92-3] | |
| | 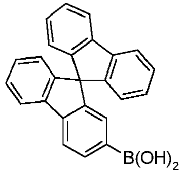 | |
| | [236389-21-2] | |
| P222 | 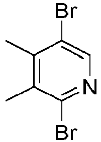 | 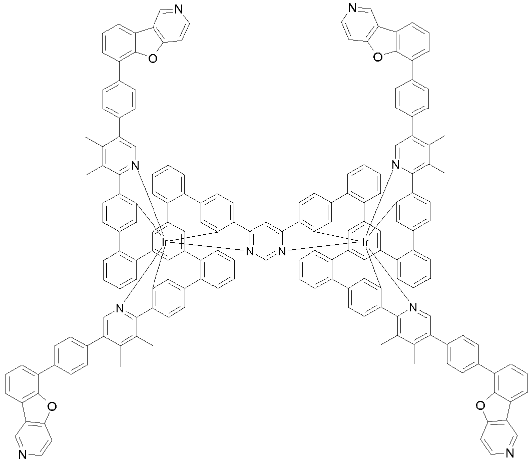 |
| | [125419-92-3] | |
| | 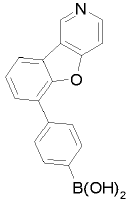 | |
| | [2055375-26-1] | |
| P223 | 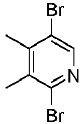 | 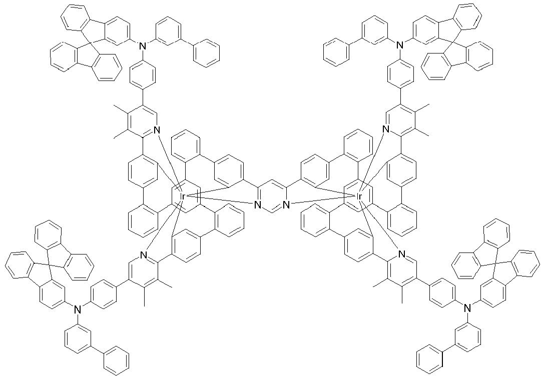 |
| | [125419-92-3] | |
| | 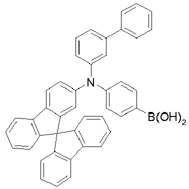 | |
| | [2020399-15-7] | |
| P224 | 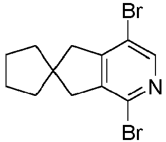 | 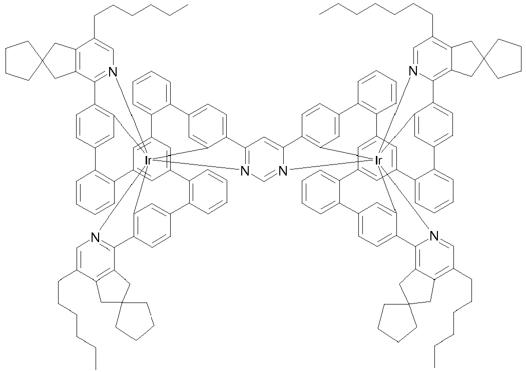 |
| | [11612855-00-1] | |
| | 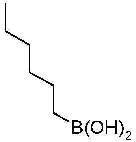 | |
| | [16343-08-1] | |
| P225 | 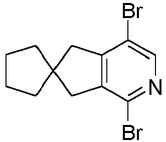 | 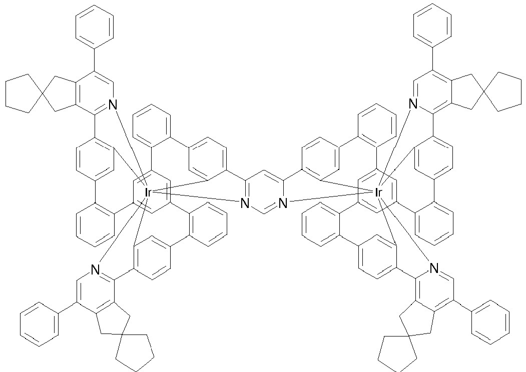 |
| | [11612855-00-1] | |
| | 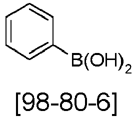 | |
| P226 | 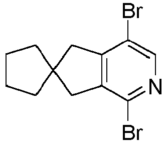 | 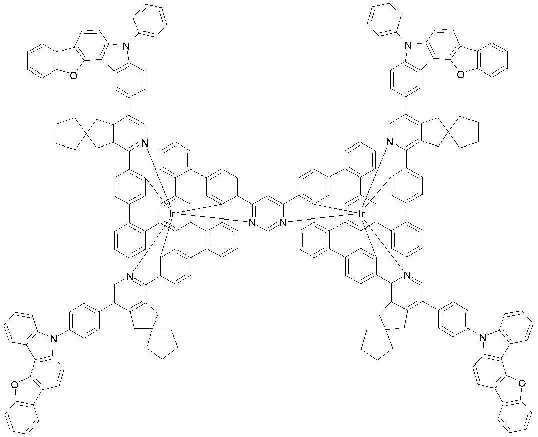 |
| | [11612855-00-1] | |
| | 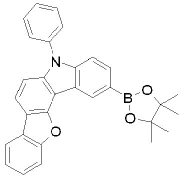 | |
| | [1993414-82-6] | |
| P227 | 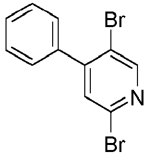 | 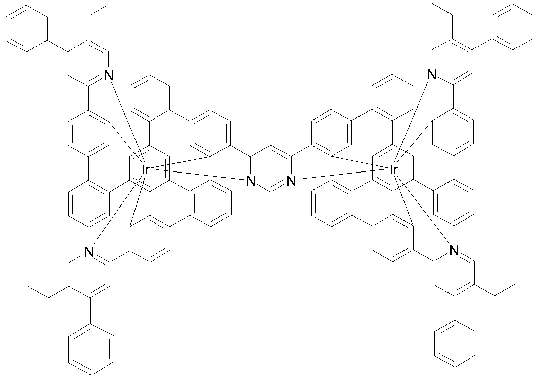 |
| | [1381937-40-1] | |
| | 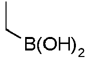 | |
| | [4433-63-0] | |
| P228 | 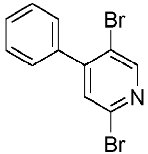 | 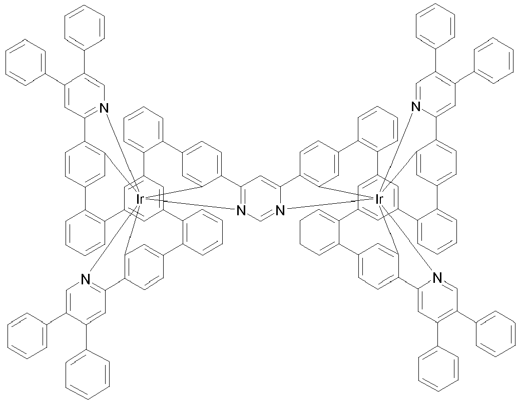 |
| | [1381937-40-1] | |
| | 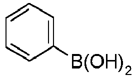 | |
| | [98-80-6] | |
| P229 | 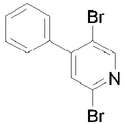 | 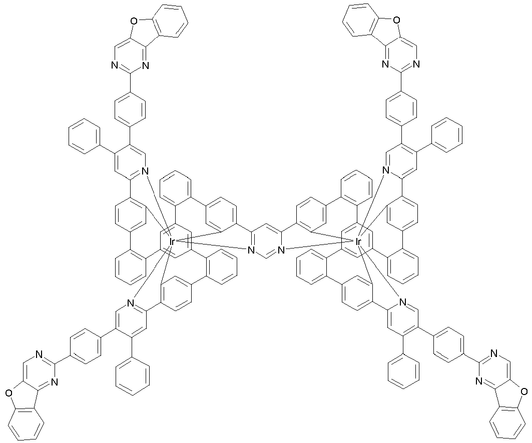 |
| | [1381937-40-1] | |
| | 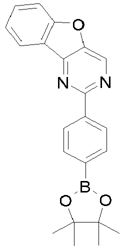 | |
| | [1989603-59-9] | |
| P230 | 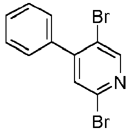 | 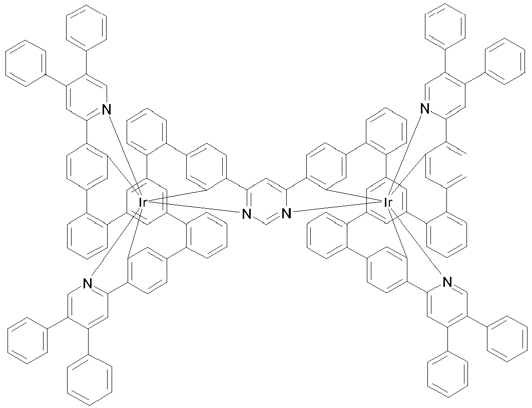 |
| | [1381937-40-1] | |
| | 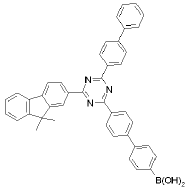 | |
| | [1987895-27 -1] | |
| P231 | 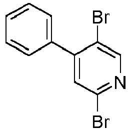 | 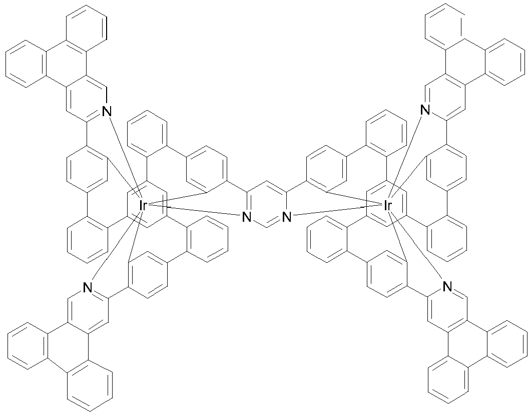 |
| | [1381937-40-1] | |
| | 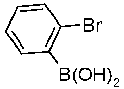 | |
| | [244205-40-1] | |
| | 300 mmol K₂CO₃ und Zusatz von 150 mmol Pivalinsäure | |
| P232 | 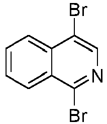 | 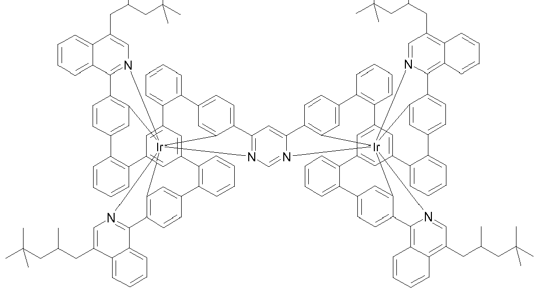 |
| | [51206-40-7] | |
| | 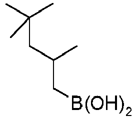 | |
| | [98-80-6] | |
| P233 | 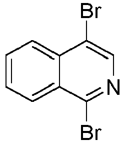 | 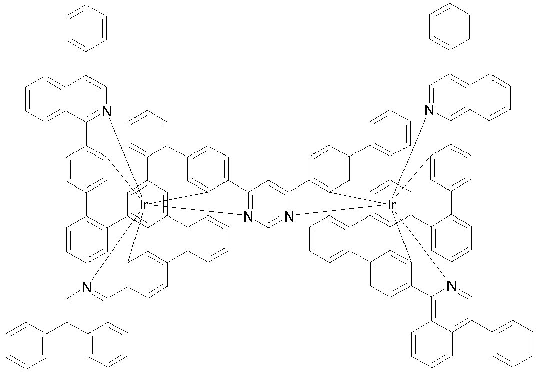 |
| | [51206-40-7] | |
| | 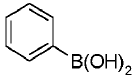 | |
| | [98-80-6] | |
| P234 | 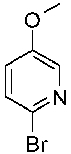 | 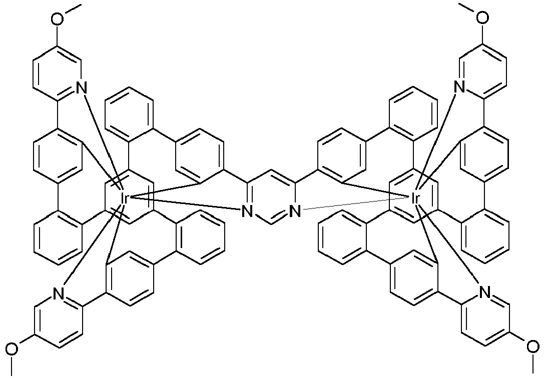 |
| | [105170-27-2] | |
| P235 | 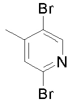 | 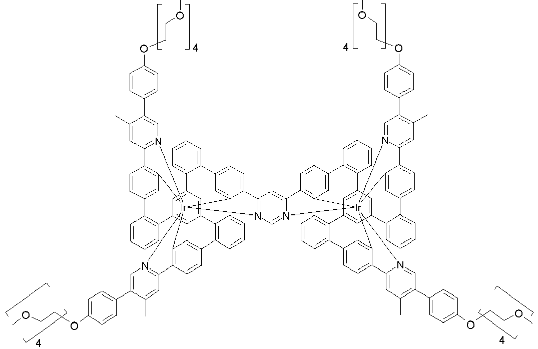 |
| | [3430-26-0] | |
| | 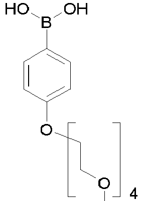 | |
| | [1181210-13-8] | |
| P236 | 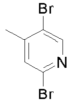 | 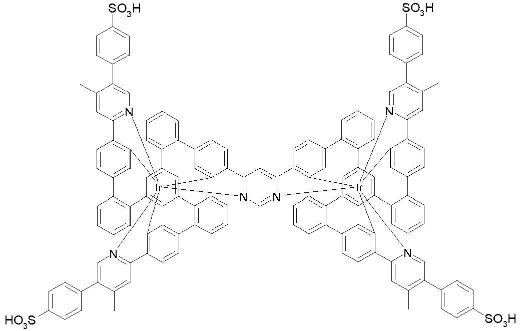 |
| | [3430-26-0] | |
| | 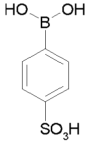 | |
| | [913836-00-7] | |
| P237 | 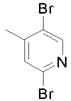 | 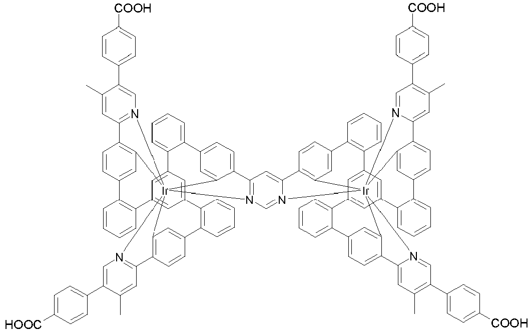 |
| | [3430-26-0] | |
| | 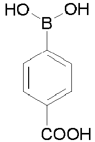 | |
| | [14047-29-1] | |
| P238 | 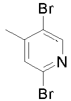 | 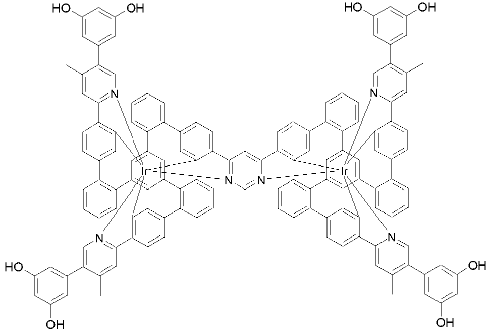 |
| | [3430-26-0] | |
| | 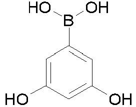 | |
| | [1285507-23-4] | |
| P239 | 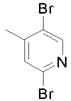 | 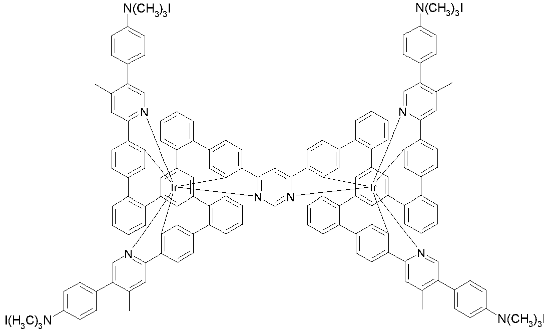 |
| | [3430-26-0] | |
| | 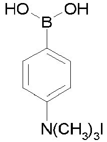 | |
| | [1704122-17-7] | |
| P240 | 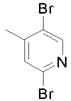 | 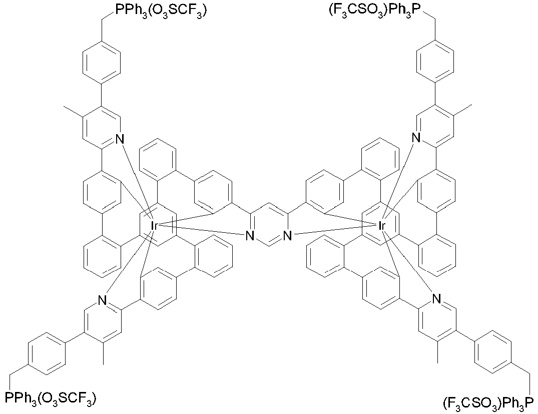 |
| | [3430-26-0] | |
| | 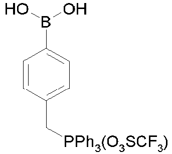 | |
| | [2000202-05-9] | |

Völlig analog zu den Beispielen P1 bis P240 können auch folgende Boronsäuren bzw. -ester der di-, tri- und oligo-Phenylene, -Fluorene, -Dibenzo-furane,- Dibenzothiophene und -Carbazole eingesetzt werden:
CAS: [439120-88-4], [881912-24-9], [952586-63-9], [797780-74-3], [875928-51-1], [1056044-60-0], [1268012-82-3], [1356465-28-5], [1860030-34-7], [2007912-81-2], [1343990-89-5], [1089154-61-9].

In den Ligandensynthesen L1 bis L76 können die Boronsäuren bzw. -ester der Beispiele P1 bis P240 eingesetzt werden und aus den so erhaltenen Liganden, nach dem für die Synthese von I1-Ir₂(L1) und I2-Ir₂(L1) ausgefürten Verfahren, die abgeleiteten Metallkomplexe erhalten werden.

### Allgemeines Syntheseschema zur Darstellung weiterer Metallkomplexe:

Ausgehend von 2-Brom-4-R¹-5-methoxypyridinen gelangt man analog zur oben gezeigten Reaktionssequenz zu vierfach Methoxy-substituierten Metallkomplexen, z. B. P234. Diese können mit Pyridiniumhydrochlorid bei 200 °C in der Schmelze oder mit BBr₃ in Dichlormethan nach allgemein bekannten Standardmethoden demethyliert werden. Die so erhaltenen Tetrahydroxy-Komplexe können nach Standardmethoden durch Umsetzung mit Trifluormethansulfonsäure in Gegenwart einer Base (z. B. Triethylamin) in Dichlormethan zu Tetra-Triflaten umgesetzt werden, welche mit Boronsäuren oder Boronsäureestern nach Standardmethoden (Suzuki-Kupplung) zu erfindungsgemäßen Verbindungen gekuppelt werden können. Die Tetra-Triflate können außerdem in weiteren Übergangsmetallvermittelten Kupplungsreaktionen, z. B. Negisgi-, Yamamoto-, Stille-, Sonogashira-, Glaser-, Ullmann-, Grignard-Cross oder Buchwald-Kupplungen, mit Alkyl-, Silyl-, Germanyl-, Stannyl-, Aryl-, Heteroaryl-, Alkoxy-, Amino- oder Carbazolyl-Resten funktionalisiert werden.

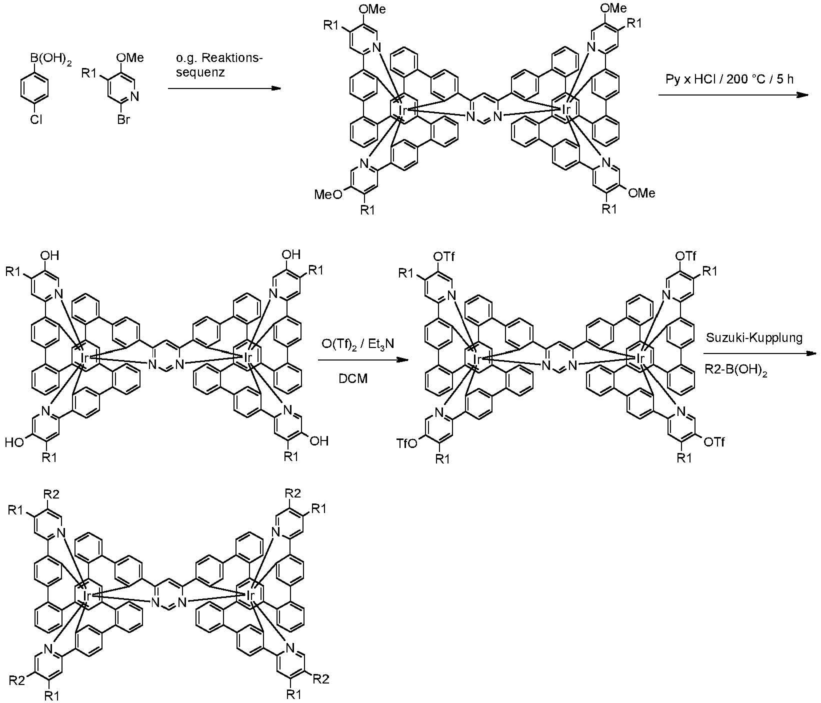

### Deuterierung der Komplexe:

### Beispiel P1-D25:

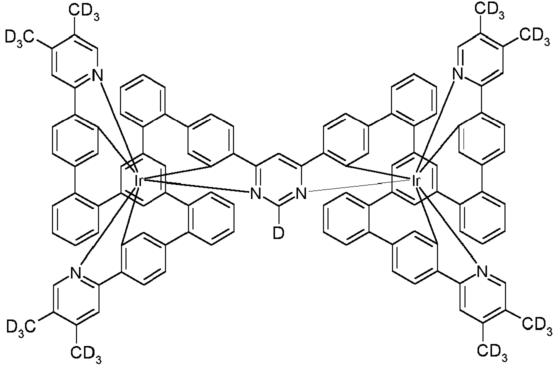

Ein Gemisch von 1.95 g (1 mmol) P1, 68 mg (1 mmol) Natriumethanolat, 3 ml Ethanol-D1 und 50 ml DMSO-D6 wird 8 h auf 120 °C erhitzt. Nach Erkalten versetzt man mit einem Gemisch aus 0.5 ml DCI in D₂O, 5 molar und 3 ml Ethanol-D1, entfernt dann das Lösungsmittel im Vakuum und chromatographiert den Rückstand mit DCM an Kieselgel. Ausbeute: 1.78 g (0.9 mmol), 90 %, Deuterierungsgrad > 95%.

Analog können folgende Verbindungen dargestellt werden:

| Bsp. | Edukt | Produkt |
|---|---|---|
| P4-D21 | P4 | 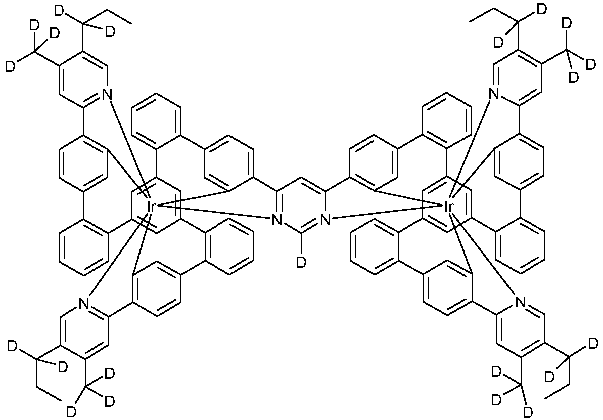 |
| P6-D17 | P6 | 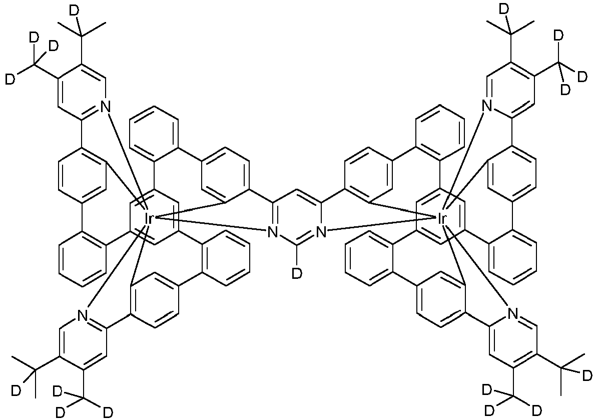 |
| P7-D21 | P7 | 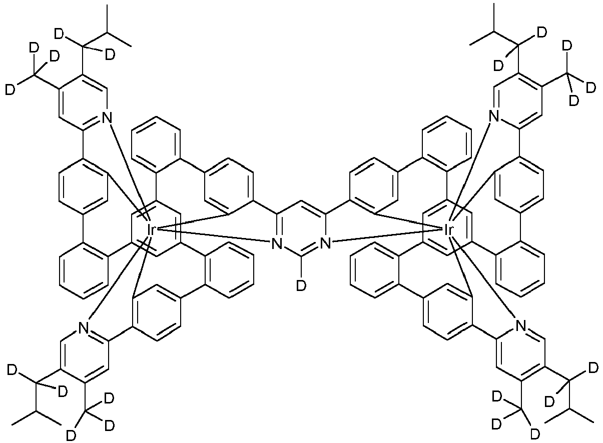 |
| P14-D13 | P14 | 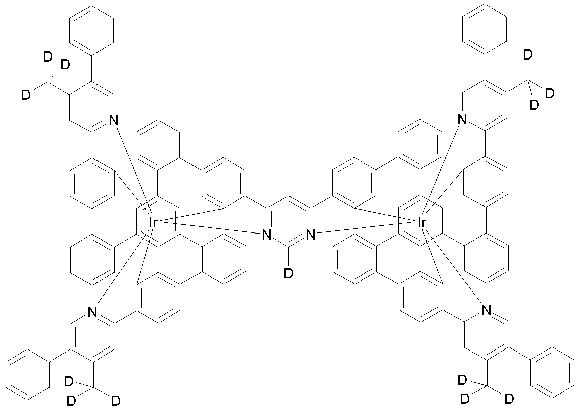 |
| P15-D13 | P15 | 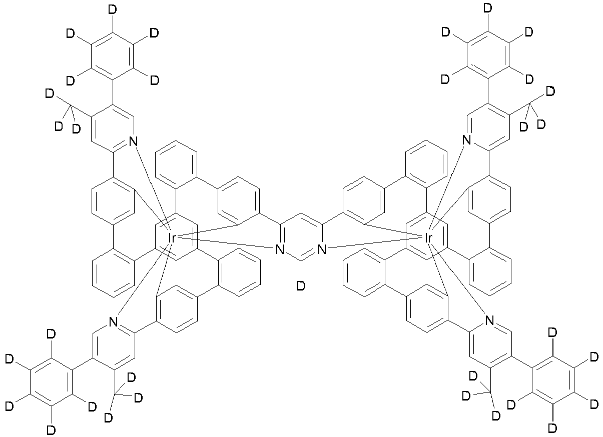 |
| P34-D13 | P34 | 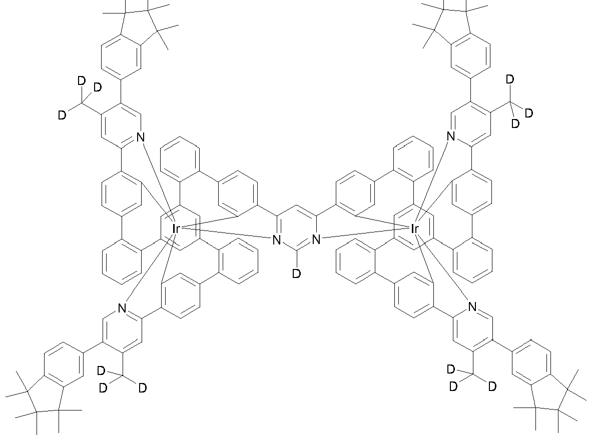 |
| P50-D13 | P50 | 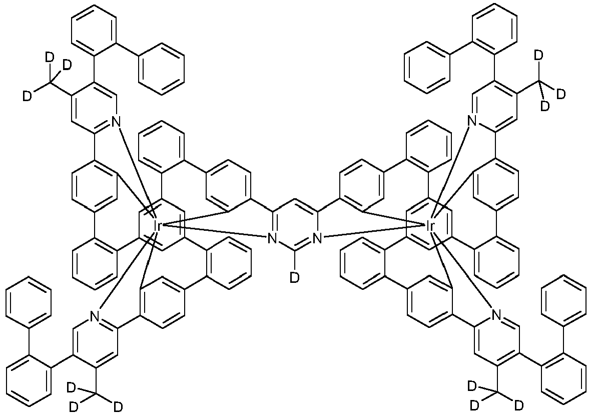 |
| P77-D13 | P77 | 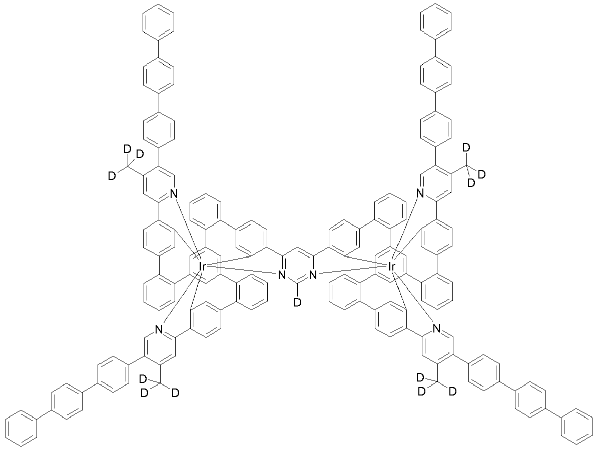 |
| P104-D13 | P104 | 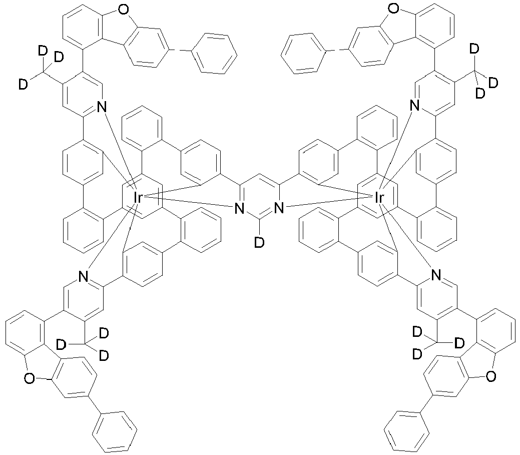 |
| P160-D13 | P160 | 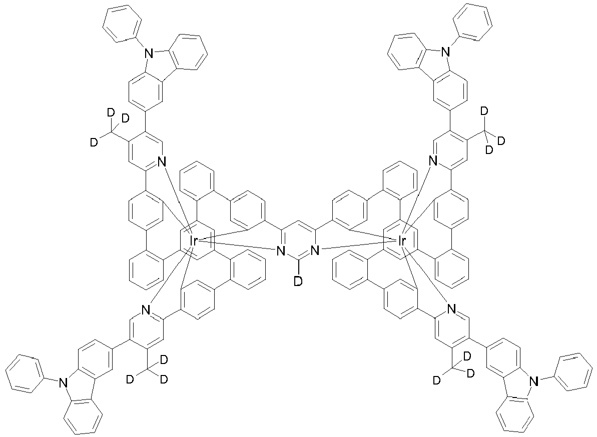 |
| P198-D9 | P198 | 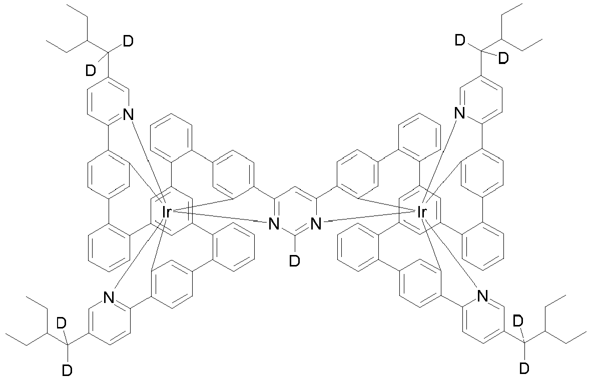 |
| P222-D33 | P222 | 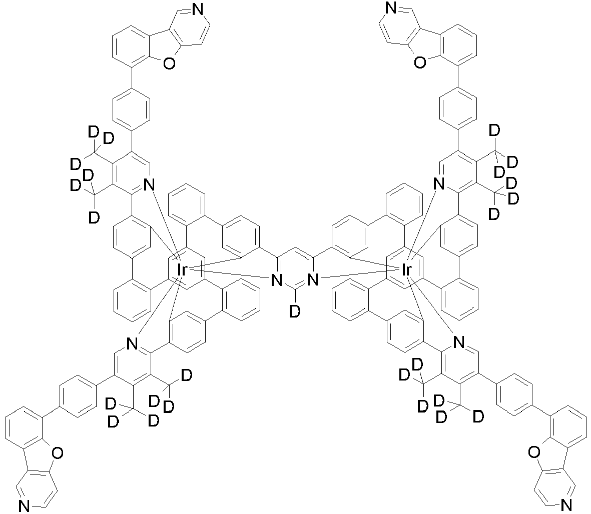 |

### Synthese der Komplexe durch sequenzielle Orthometallierung:

### 1) Sequenzielle Orthometallierung zur Darstellung von bimetallischen Komplexen

Die bimetallischen Komplexe lassen sich auch durch sequenzielle Orthometallierung erhalten. Dabei lässt sich zunächst gezielt ein monometallischer Komplex Ir(L1) bzw. Rh(L1) isolieren. Die nachfolgende Umsetzung mit einem weiteren Äquivalent Ir(acac)₃ bzw. Rh(acac)₃ liefert die zweikernigen homo- bzw. hetereometallischen Komplexe Ir2(L1), Rh2(L1) oder Ir-Rh(L1). Die bimetallischen Komplexe fallen hierbei ebenfalls als Gemisch aus ΛΛ- und ΔΔ-Isomeren sowie ΔΛ- ΛΔ-Isomeren an. ΛΛ- und ΔΔ-Isomer bilden ein Enantiomerenpaar ebenso wie die ΔΛ- und ΛΔ-Isomere. Die Diastereomerenpaare können mit herkömmlichen Methoden, z. B. chromatographisch oder durch fraktionierte Kristallisation, getrennt werden. Je nach Symmetrie der Liganden können auch Stereozentren zusammenfallen, so dass auch Mesoformen möglich sind. So fallen z. B. bei der ortho-Metallierung von C₂ᵥ oder Cₛ symmetrischen Liganden ΛΛ- und ΔΔ-Isomere (Racemat, C₂-symmetrisch) und ein ΛΔ-Isomer (Mesoverbindung, Cₛ-symmetrisch) an.

### Schritt 1: Monometallische Komplexe

Zur Darstellung der monometallischen Komplexe werden 25 g (11 mmol) des Liganden L1, 4.9 g (11 mmol) Tris-acetylacetonato-iridium(III) [15635-87-7] und 200 g Hydrochinon [123-31-9] in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen und in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250 °C, gemessen am Pt-100 Thermofühler, der in die aufgeschmolzene, gerührte Reaktionsmischung eintaucht, erhitzt. Während der nächsten 2 h wird das Reaktionsgemisch bei 250 °C gehalten, wobei wenig Kondensat abdestilliert und sich im Wasserabscheider sammelt. Die Reaktionsmischung wird bis auf 190 °C abkühlen gelassen, dann werden 100 mL Ethylenglykol zugetropft. Man lässt weiter bis auf 80 °C abkühlen und tropft dann 500 mL Methanol zu, erhitzt 1 h auf Rückfluss. Die so erhaltene Suspension wird über eine Umkehrfritte filtriert, der Feststoff wird zweimal mit 50 ml Methanol gewaschen und dann im Vakuum getrocknet. Der so erhaltene Feststoff wird in 200 mL Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erhält man den einfach metallierten Komplex Ir(L1). Analog kann der Rhodiumkomplex Rh(L1) ausgehend von Rh(acac)₃ [14284-92-5] dargestellt werden.

Sämtliche in dieser Erfindung gezeigten Liganden können durch die Verwendung von 1 Äquivalent Ir(acac)₃ bzw. Rh(acac)₃ in monometallische Komplexe vom Typ Ir(L1) bzw. Rh(L1) überführt werden. Im Folgenden sind nur einige Beispiele gezeigt.

| Verb. | Edukt | Produkt/ Reaktionsbedingungen/ Heißextraktionsmittel (HE) | AusBeute* |
|---|---|---|---|
| Ir(L1 ) | L1 Ir(acac)₃ [15635-87-7] | 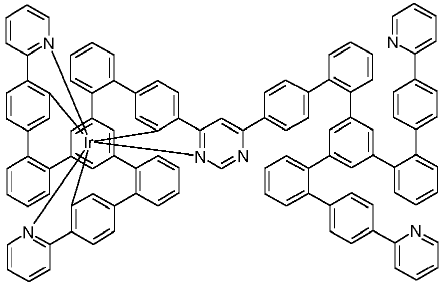 Ir(L1) 250°C; 2 h Heißextraktion: Toluol | 48% |
| Rh(L1) | L1 Rh(acac)₃ [14284-92-5] | 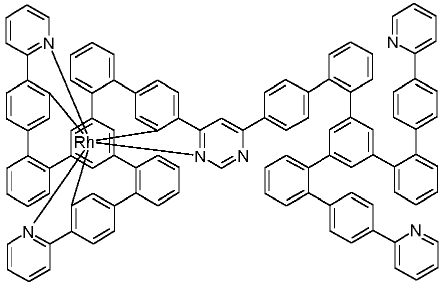 Ir(L1) 250°C; 2 h Heißextraktion: Toluol | 43% |
| Ir(L57) | L1 Ir(acac)₃ [15635-87-7] | 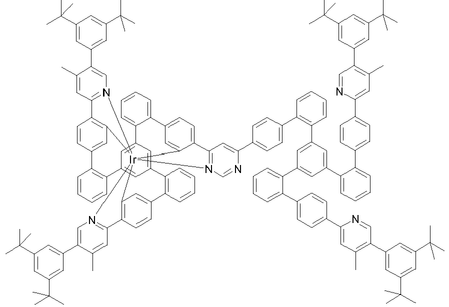 | 40% |
| | | Ir(L57) | |
| | | 250°C; 2 h | |
| | | Heißextraktion: Heptan | |
| Rh(L57) | L1 Rh(acac)₃ [14284-92-5] | 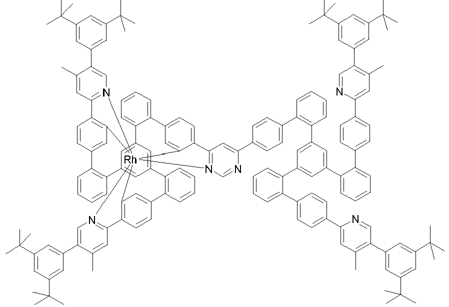 | 45% |
| | | Rh(L57) | |
| | | 250°C; 2 h | |
| | | Heißextraktion: Heptan | |

Die Komplexe Ir(L1) bzw. Rh(L1) können nun mit einem weiteren Äquivalent Ir(acac)₃ bzw. Rh(acac)₃ zu den bimetallischen Komplexen I1-Ir₂(L1), I2-Ir₂(L1), I1-Rh₂(L1), I2-Rh(L1), I1-Ir-Rh(L1) oder I2- Ir-Rh(L1) umgesetzt werden. Dabei ist es unerheblich, welches Metall zuerst eingeführt wird.

### Schritt 2: Bimetallische Komplex

Zur Darstellung der bimetallischen Komplexe aus den monometallischen Komplexen werden 24.5 g (10 mmol) des Komplexes Ir1(L1), 4.9 g (10 mmol) Tris-acetylacetonato-iridium(III) [15635-87-7] und 200 g Hydrochinon [123-31-9] in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen und in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250 °C, gemessen am Pt-100 Thermofühler, der in die aufgeschmolzene, gerührte Reaktionsmischung eintaucht, erhitzt. Während der nächsten 2 h wird das Reaktionsgemisch bei 250 °C gehalten, wobei wenig Kondensat abdestilliert und sich im Wasserabscheider sammelt. Die Reaktionsmischung wird bis auf 190 °C abkühlen gelassen, dann werden 100 mL Ethylenglykol zugetropft. Man lässt weiter bis auf 80 °C abkühlen und tropft dann 500 mL Methanol zu, erhitzt 1 h auf Rückfluss. Die so erhaltene Suspension wird über eine Umkehrfritte filtriert, der Feststoff wird zweimal mit 50 ml Methanol gewaschen und dann im Vakuum getrocknet. Der so erhaltene Feststoff wird in 200 mL Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des diastereomeren Produktgemisches.

Die bimetallischen Komplexe, die durch sequenzielle Orthometallierung erhalten werden, fallen ebenfalls als Gemisch aus ΛΛ- und ΔΔ-Isomeren sowie ΔΛ- ΛΔ-Isomeren an. ΛΛ- und ΔΔ-Isomer bilden ein Enantiomerenpaar, ebenso wie die ΔΛ- und ΔΔ-Isomere. Die Diastereomerenpaare können mit herkömmlichen Methoden, z. B. chromatographisch oder durch fraktionierte Kristallisation, getrennt werden. Je nach Symmetrie der Liganden können auch Stereozentren zusammenfallen, so dass auch Mesoformen möglich sind. So fallen z. B. bei der ortho-Metallierung von C₂ᵥ oder Cₛ symmetrischen Liganden ΛΛ- und ΔΔ-Isomere (Racemat, C₂-symmetrisch) und ein ΔΔ-Isomer (Mesoverbidnung, Cₛ-symmetrisch) an.

Sämtliche in dieser Erfindung für zwei Iridium- bzw. Rhodiumatome gezeigten Komplexe der hierin gezeigten Liganden können auch durch sequenzielle Orthometallierung dargestellt werden. Ebenso können aus sämtlichen in dieser Erfindung gezeigten Liganden durch sequenzielle Orthometallierung heterometallische Komplexe vom Typ Ir-Rh(L) dargestellt werden.

Die sequenzielle Orthometallierung kann auch als Eintopfreaktion durchgeführt werden. Dazu wird zunächst Schritt 1 zu den monometallischen Komplexen durchgeführt. Nach 2 h Reaktionszeit wird ein weiteres Äquivalent Ir(acac)₃ bzw. Rh(acac)₃ zugesetzt. Nach weiteren 2 h Reaktionszeit bei 250 °C wird wie oben in Schritt 2 beschrieben aufgearbeitet und die so erhaltenen Rohprodukte gereinigt.

Im Folgenden werden nur einige ausgewählte Beispiele gezeigt. Die Abbildungen von Komplexen zeigen üblicherweise nur ein Isomer. Die Isomerenmischung kann aufgetrennt werden, kann aber genausogut als Isomerengemisch im OLED Device eingesetzt werden. Es gibt jedoch auch Ligandensysteme, bei denen sich aus sterischen Gründen lediglich ein Diastereomerenpaar bildet.

| Bsp. | Edukt | Produkt/ Reaktionsbedingungen/ Heißextratkionsmittel (HE) | AusBeute* |
|---|---|---|---|
| I1-Ir-Rh(L1) | Ir(L1) bzw. Rh(L1 ) Rh(acac)₃ bzw. Ir(acac)₃ [14284-92-5] bzw. [15635-87-7] | 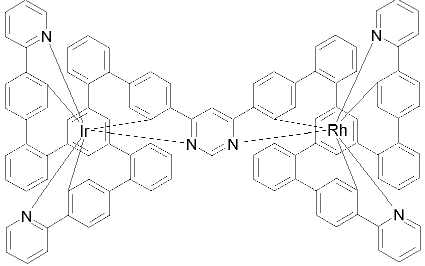 | 20% |
| | | I1-Ir-Rh₂(L1) | |
| | | 250°C; 2 h | |
| | | Heißextraktion: Toluol | |
| I2-Ir-Rh(L1) | Ir(L1) bzw. Rh(L1 ) Rh(acac)₃ bzw. Ir(acac)₃ [14284-92-5] bzw. [15635-87-7] | 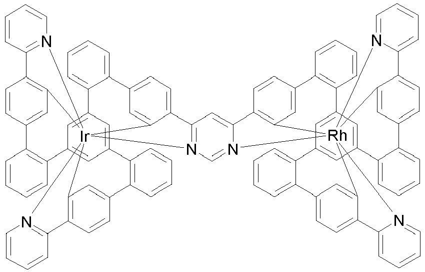 | 20% |
| | | I2-Ir-Rh(L1) | |
| | | 250°C; 2 h | |
| | | Heißextraktion: Toluol | |
| Ir-Rh(L57) | Ir(L1) bzw. Rh(L1 ) Rh(acac)₃ bzw. Ir(acac)₃ [14284-92-5] bzw. [15635-87-7] | 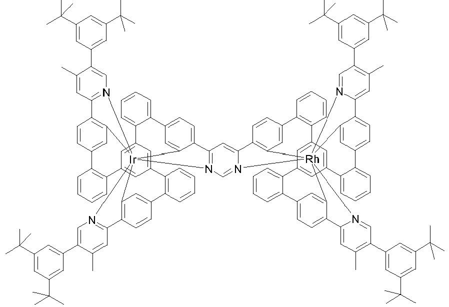 | 20% |
| | | Ir-Rh₂(L57) | |
| | | 250°C; 2 h | |
| | | Heißextraktion: Toluol | |
| Ir-Rh(L57) | Ir(L1) bzw. Rh(L1 ) Rh(acac)₃ bzw. Ir(acac)₃ [14284-92-5] bzw. [15635-87-7] | 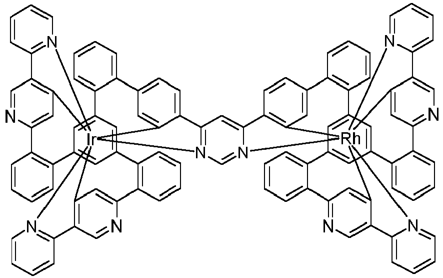 | 20% |
| | | Ir-Rh₂(L57) | |
| | | 250°C; 2 h | |
| | | Heißextraktion: Toluol | |

### 2) Sequenzielle Orthometallierung zur Darstellung von trimetallischen Komplexen

### Einführung des ersten Metalls

Die sequenzielle Orthometallierung kann auch zur Aufbau von trimetallischen Komplexen des Typs Ir₃(L52), Ir-Rh₂(L52), Ir₂-Rh(L52) oder Rh₃(L52) genutzt werden. Dazu werden 22 g (10 mmol) des Komplexes Ir(L1), 4.9 g (10 mmol) Tris-acetylacetonato-iridium(III) [15635-87-7] und 200 g Hydrochinon [123-31-9] in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen und in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 260 °C, gemessen am Pt-100 Thermofühler, der in die aufgeschmolzene, gerührte Reaktionsmischung eintaucht, erhitzt. Während der nächsten 2 h wird das Reaktionsgemisch bei 260 °C gehalten, wobei wenig Kondensat abdestilliert und sich im Wasserabscheider sammelt. Die Reaktionsmischung wird bis auf 190 °C abkühlen gelassen, dann werden 100 mL Ethylenglykol zugetropft. Man lässt weiter bis auf 80 °C abkühlen und tropft dann 500 mL Methanol zu, erhitzt 1 h auf Rückfluss. Die so erhaltene Suspension wird über eine Umkehrfritte filtriert, der Feststoff wird zweimal mit 50 ml Methanol gewaschen und dann im Vakuum getrocknet. Der so erhaltene Feststoff wird in 400 mL Toluol gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erhält man den monometallischen Komplex Ir(L52).

### Einführung des zweiten Metalls

Der Komplex Ir(L52) wird mit 4.9 g (10 mmol) Tris-acetylacetonatoiridium(III) [15635-87-7] und 200 g Hydrochinon [123-31-9] in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen und in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 260 °C, gemessen am Pt-100 Thermofühler, der in die aufgeschmolzene, gerührte Reaktionsmischung eintaucht, erhitzt. Während der nächsten 2 h wird das Reaktionsgemisch bei 260 °C gehalten, wobei wenig Kondensat abdestilliert und sich im Wasserabscheider sammelt. Die Reaktionsmischung wird bis auf 190 °C abkühlen gelassen, dann werden 100 mL Ethylenglykol zugetropft. Man lässt weiter bis auf 80 °C abkühlen und tropft dann 500 mL Methanol zu, erhitzt 1 h auf Rückfluss. Die so erhaltene Suspension wird über eine Umkehrfritte filtriert, der Feststoff wird zweimal mit 50 ml Methanol gewaschen und dann im Vakuum getrocknet. Der so erhaltene Feststoff wird in 400 mL Toluol gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erhält man den bimetallischen Komplex Ir₂(L52).

### Einführung des dritten Metalls

Der Komplex Ir₂(L52) wird mit 4.9 g (10 mmol) Tris-acetylacetonatoiridium(III) [15635-87-7] und 200 g Hydrochinon [123-31-9] in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen und in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 260 °C, gemessen am Pt-100 Thermofühler, der in die aufgeschmolzene, gerührte Reaktionsmischung eintaucht, erhitzt. Während der nächsten 2 h wird das Reaktionsgemisch bei 260 °C gehalten, wobei wenig Kondensat abdestilliert und sich im Wasserabscheider sammelt. Die Reaktionsmischung wird bis auf 190 °C abkühlen gelassen, dann werden 100 mL Ethylenglykol zugetropft. Man lässt weiter bis auf 80 °C abkühlen und tropft dann 500 mL Methanol zu, erhitzt 1 h auf Rückfluss. Die so erhaltene Suspension wird über eine Umkehrfritte filtriert, der Feststoff wird zweimal mit 50 ml Methanol gewaschen und dann im Vakuum getrocknet. Der so erhaltene Feststoff wird in 400 mL Toluol gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erhält man den trimetallischen Komplex Ir₃(L52).Der trimetallische Komplex wird per Heißextraktion weiter aufgereinigt.

Der im Folgenden gezeigte trimetallische Komplex Ir₃(L52) kann durch sequenzielle Metallierung nach obige Reaktionssequenz oder durch Umsetzung von L52 mit 3 Äquivalenten Ir(acac)₃ bzw. Rh(acac)₃ dargestellt werden.

Zur Darstellung eines hetereotrimetallischen Komplexes wie beispielsweise Ir-Rh₂(L52) oder Ir₂-Rh(L52) wird entsprechend der obigen Reaktionssequenz in einem oder zwei Schritten Rh(acac)₃ anstatt Ir(acac)₃ verwenden. In welcher Reihenfolge die Metalle eingeführt werden, ist dabei unerheblich.

| Bsp. | Edukt | Produkt/ Reaktionsbedingungen/Heißextraktionsmittel (HE) | AusBeute* |
|---|---|---|---|
| Ir₃(L52) | L52 Ir(acac)₃ [15635-87-7] | 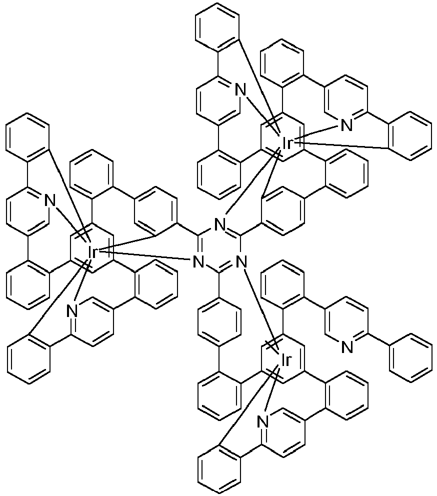 | 33% |
| | | Ir₃(L52) 3 equiv. Ir(acac)₃, 260°C; 7 h Es entsteht nur das Racemat aus ΛΛΛ- und ΔΔΔ-Isomer Heißextraktion: Toluol | |
| Rh₃(L52) | L52 Rh(acac)₃ [14284-92-5] | 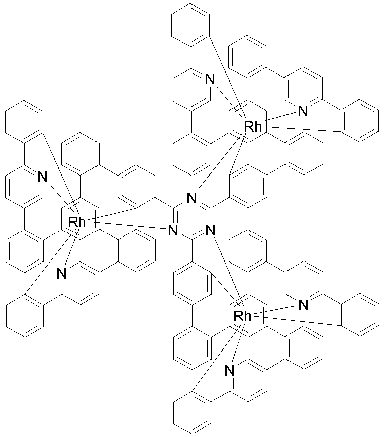 | 32% |
| | | Ir₃(L52) 3 equiv. Rh(acac)₃, 260°C; 7 h Es entsteht nur das Racemat aus ΛΛΛ- und ΔΔΔ-Isomer Heißextraktion: Toluol | |
| Ir₃(L53) | L53 Ir(acac)₃ [15635-87-7] | 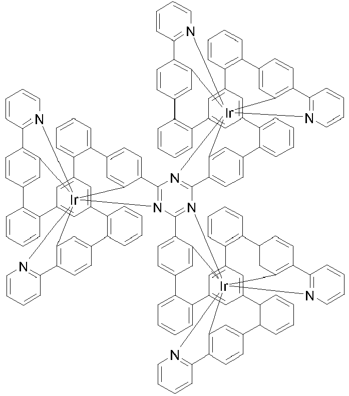 | 29% |
| | | Ir₃(L53) 3 equiv. Ir(acac)₃, 260°C; 7 h Es entsteht nur das Racemat aus ΛΛΛ- und ΔΔΔ-Isomer Heißextraktion: Toluol | |
| Rh₃(L53) | L53 Rh(acac)₃ [14284-92-5] | 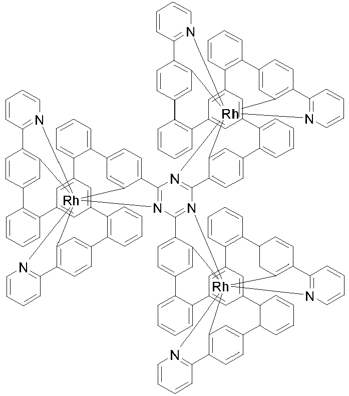 | 33% |
| | | Rh₃(L53) 3 equiv. Rh(acac)₃, 260°C; 7 h Es entsteht nur das Racemat aus ΛΛΛ- und ΔΔΔ-Isomer Heißextraktion: Toluol | |
| Ir₂-Rh(L53) | L53 Rh(acac)₃ bzw. Ir(acac)₃ [14284-92-5] bzw. [15635-87-7] | 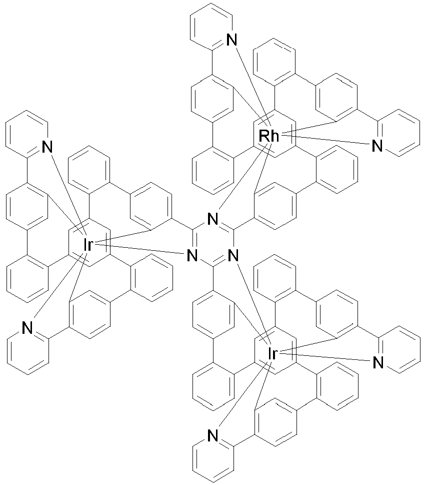 | 30% |
| | | Ir₂-Rh(L53) Sequenziell 2 equiv. Ir(acac)₃, 1 equiv. Rh(acac)₃, 260°C; 7 h Heißextraktion: o-Xylol Es entsteht nur das Racemat aus ΛΛΛ- und ΔΔΔ-Isomer | |
| Ir-Rh₂(L53) | L53 Rh(acac)₃ bzw. Ir(acac)₃ [14284-92-5] bzw. [15635-87-7] | 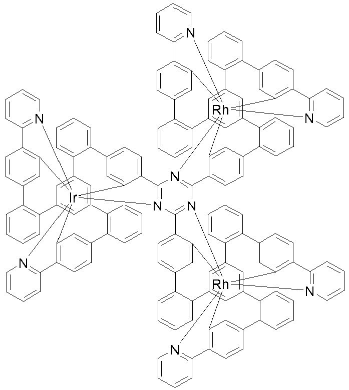 | 29% |
| | | Ir-Rh₂(L53) Sequenziell 1 equiv. Ir(acac)₃, 2 equiv. Rh(acac)₃, 260°C; 7 h Heißextraktion: o-Xylol Es entsteht nur das Racemat aus ΛΛΛ- und ΔΔΔ-Isomer | |
| Ir₂-Rh(L54) | L54 Rh(acac)₃ bzw. Ir(acac)₃ [14284-92-5] bzw. [15635-87-7] | 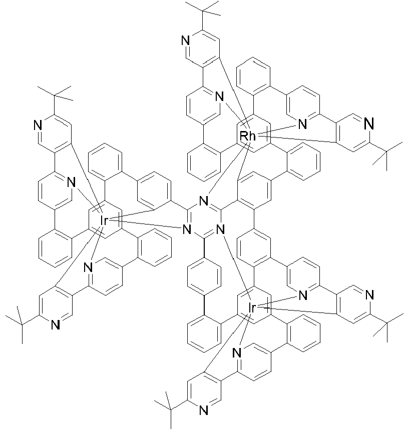 | 20% |
| | | Ir₂-Rh(L54) Sequenziell 2 equiv. Ir(acac)₃, 1 equiv. Rh(acac)₃, 260°C; 7 h Heißextraktion: n-Butylacetat Es entsteht nur das Racemat aus ΛΛΛ- und ΔΔΔ-Isomer | |
| Ir-Rh₂(L54) | L54 Rh(acac)₃ bzw. Ir(acac)₃ [14284-92-5] bzw. [15635-87-7] | 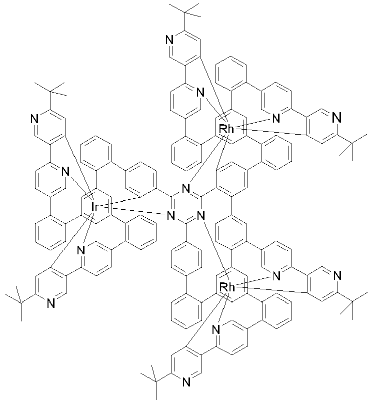 | 18% |
| | | Ir₂-Rh(L54) Sequenziell 1 equiv. Ir(acac)₃, 2 equiv. Rh(acac)₃, 260°C; 7 h Heißextraktion: n-Butylacetat Es entsteht nur das Racemat aus ΛΛΛ- und ΔΔΔ-Isomer | |
| Ir₂-Rh(L55) | L55 Rh(acac)₃ bzw. Ir(acac)₃ [14284-92-5] bzw. [15635-87-7] | 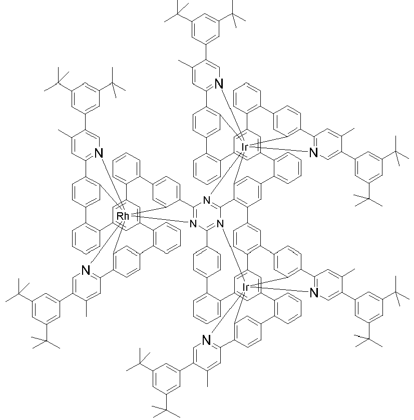 | 21% |
| | | Ir₂-Rh(L55) Sequenziell 2 equiv. Ir(acac)₃, 1 equiv. Rh(acac)₃, 260°C; 7 h Heißextraktion: Toluol Es entsteht nur das Racemat aus ΛΛΛ- und ΔΔΔ-Isomer | |
| Ir-Rh₂(L55) | L55 Rh(acac)₃ bzw. Ir(acac)₃ [14284-92-5] bzw. [15635-87-7] | 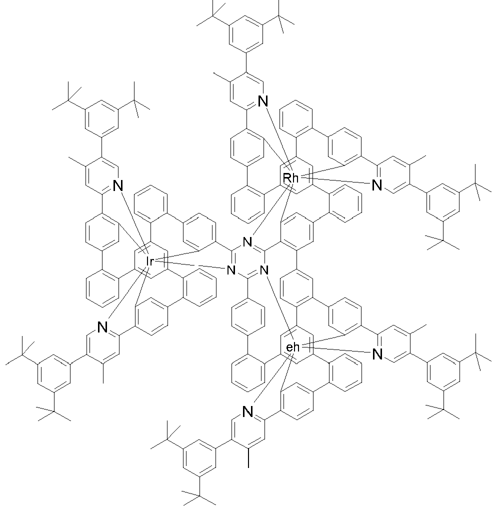 | 19% |
| | | Ir-Rh₂(L55) Sequenziell 1 equiv. Ir(acac)₃, 2 equiv. Rh(acac)₃, 260°C; 7 h Heißextraktion: Toluol Es entsteht nur das Racemat aus ΛΛΛ- und ΔΔΔ-Isomer | |

### Beispiel 1: Thermische und photophysikalische Eigenschaften sowie Oxidations- und Reduktionspotentiale

Tabelle 1 fasst die thermischen und photochemischen Eigenschaften, sowie Oxidations- und Reduktionspotentiale der Vergleichsmaterialien und die ausgewählter erfindungsgemäßer Materialien zusammen. Die erfindungsgemäßen Verbindungen weisen eine im Vergleich zu den nicht-polypodalen Materialien gemäß dem Stand der Technik verbesserte thermische Stabilität und Photostabilität auf. Während nicht-polypodale Materialien nach Stand der Technik nach siebentägiger thermischer Auslagerung bei 380 °C Braunverfärbungen und Veraschung zeigen und man im ¹H-NMR Nebenkomponenten im Bereich > 2 mol% nachweisen kann, sind die erfindungsgemäßen Komplexe unter diesen Bedingungen inert. Außerdem weisen die erfindungsgemäßen Verbindungen eine sehr gute Photostabilität in wasserfreier C₆D₆-Lösung unter Bestrahlung mit Licht der Wellenlänge von ca. 455 nm auf. Insbesondere ist im Gegensatz zu nicht-polypodalen Komplexen nach Stand der Technik, welche zweizähnige Liganden enthalten, im ¹H-NMR keine facial-meridional Isomerisierung nachzuweisen. Wie Tabelle 1 entnommen werden kann, zeichnen sich die erfindungsgemäßen Verbindungen in Lösung durchweg durch sehr hohe PL-Quanteneffizienzen aus.

### Strukturen in Photolumineszenz untersuchter erfindungsgemäßer Komplexe sowie zugehöriger Vergleichskomplexe

(die Zahlen in eckigen Klammern geben die entsprechende CAS-Nummer an; die Synthese von Komplexen ohne CAS-Nummer ist in den zitierten Patentanmeldungen beschrieben). Synthese Ref15 und Ref16 analog zur Synthesedurchführung für Komplexe Ref13 und Ref14 beschrieben in US 2003/0152802. Ausgehend von den folgenden Startmaterialien:

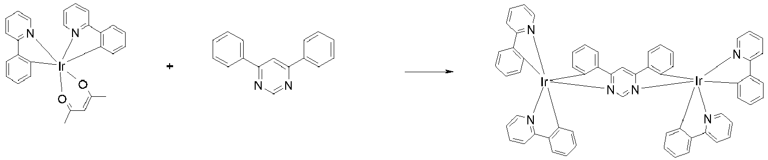

Ein Gemisch aus 2.3 g (10 mmol) 4,6-diphenylpyrimidine [3977-48-8] und 12.0 g (20 mmol) (Acetylacetonato)bis(2-phenylpyridinato-N,C2')iridium [945028-21-7] wird in 500 mL Glycerol suspensiert, 30 min durch Argon-Durchleiten entgast und dann für 3 h bei 180 °C gerührt. Nach dem Abkühlen werden 1000 mL Methanol zur Reaktionsmischung gegeben und der ausgefallene Feststoff abgesaugt. Die Trennung der Diastereomeren erfolgt durch Säulenchromatographie auf einem Säulenautomaten der Fa. Axel Semrau auf Flash-Kieselgel mit Toluol/Ethylacetat als Eluentengemisch. Anschließend werden die Verbindungen Ref15 und Ref16 getrennt durch Heißextraktion weiter aufgereinigt. Für Ref15 fünfmalige Heißextraktion aus Ethylacetat, für Ref16 3-malige Heißextraktion aus n-Butylacetat. Abschließend werden die Verbindungen im Hochvakuum getrempert. Ausbeute: Ref15: 1.2 g (1.0 mmol), 10%. Ausbeute Ref16: 1.5 g (1.2 mmol), 12%. Die Ausbeute bezieht sich auf die Menge an eingesetztem Liganden.

| Komplex | |
|---|---|
| 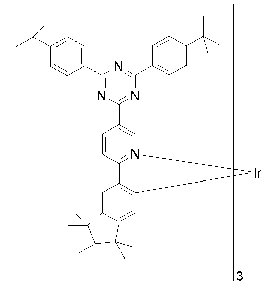 | 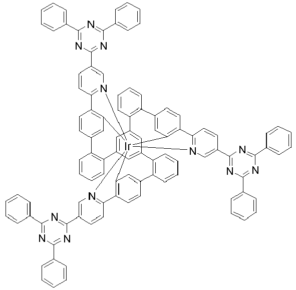 |
| Ref1 [1870013-87-8] | Ref2 Siehe WO 2016/124304 |
| 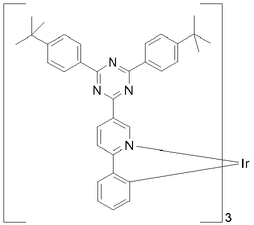 | 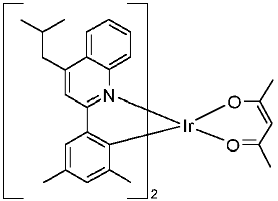 |
| Ref3 | Ref4 [1935740-05-8] |
| [1202823-72-0] | |
| 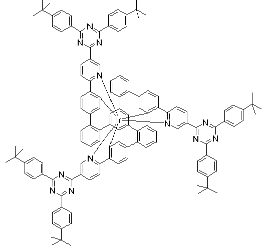 | 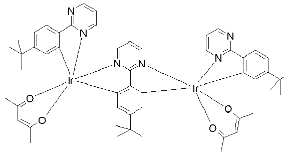 |
| Siehe WO 2016/124304 Ref5 | [1859110-77 -2] Ref6* |
| 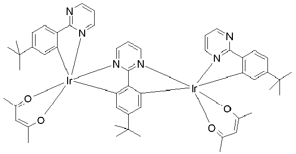 | 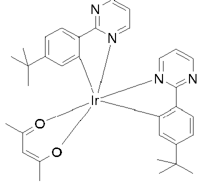 |
| [1859924-65-4] Ref7^{*} | [1904599-30-9] Ref8 |
| 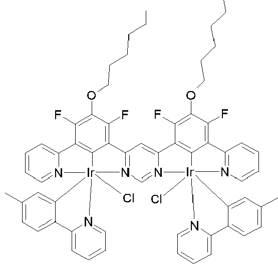 | 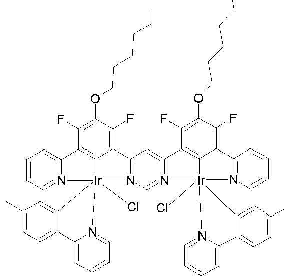 |
| [1562104-35-1] Ref9* | [1562395-58-7] Ref10* |
| 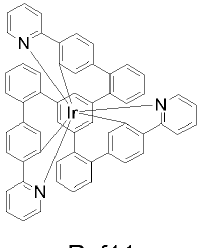 | 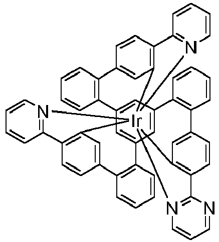 |
| Ref11 Siehe WO 2016/124304 | Ref12 Siehe WO 2016/124304 |
| 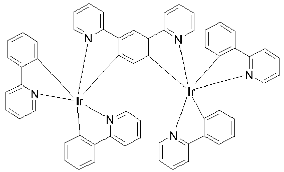 | 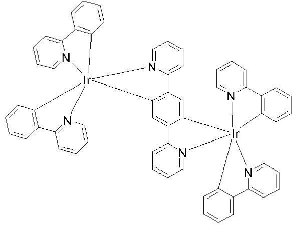 |
| Ref13 Siehe Compound 166 in US 2003/0152802 | Ref14 [501097-40-1] |
| 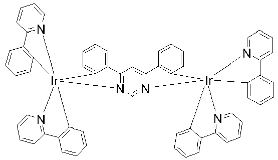 | 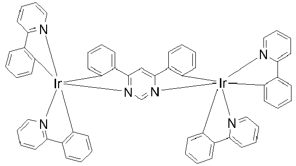 |
| Ref15 | Ref16 |

| | |
|---|---|
| *Ref6 und Ref7 bilden ein Diastereomerenpaar, genauso wie Ref9 und Ref10. | |

**Tabelle 1**

| **Komplex** | **HOMO [eV] LUMO [eV].** | **PL-max [nm]. FWHM [nm]** | **PLQE Lösungsmittel** | **Abklingzeit τ [µs]** | **Therm. Stabilität Photochem. Stab.** |
|---|---|---|---|---|---|
| **Vergleichsbeispiele, Strukturen s. Tabelle 13** | | | | | |
| **Ref1** | -4.96 | 619 | 0.80 | 0.71 | Zersetzung |
| | -2.60 | 48 | Toluol | | Zersetzung |
| **Ref2** | -5.21 | 605 | 0.84 | 0.70 | Keine Zers. |
| | -2.80 | 49 | Toluol | | Keine Zers |
| **Ref 3** | -5.18 | 595 | 0.82 | 0.72 | Zersetzung |
| | -2.70 | 63 | Toluol | | Zersetzung |
| **Ref 4** | -5.00 | 615 | 0.86 | 1.38 | Zersetzung |
| | -2.32 | 55 | Toluol | | Zersetzung |
| **Ref5** | -5.17 | 599 | 0.86 | 0.75 | Keine Zers. |
| | -2.70 | 51 | Toluol | | Keine Zers. |
| **Ref6*1** | -5.25 | 606 | 0.61 | 0.18 | -- |
| | -2.59 | --- | DCM | | -- |
| **Ref7*1** | -5.30 | 607 | 0.49 | 0.18 | -- |
| | -2.64 | --- | DCM | | -- |
| **Ref8*1** | -5.45 | 525 | 0.99 | 1.02 | -- |
| | -2.51 | --- | DCM | | -- |
| **Ref9^{*2}** | - | 622 | 0.65 | 0.75 | -- |
| | | --- | DCM | | -- |
| **Ref10^{*2}** | - | 625 | 0.65 | 0.73 | -- |
| | | --- | DCM | | -- |
| **Ref11** | -- | 520 | 0.98 | 1.65 | Keine Zers. |
| | -- | 64 | Toluol | | Keine Zers. |
| **Ref12** | -5.11 | 528 | 0.81 | 1.6 | Keine Zers. |
| | -2.24 | 70 | Toluol | | Keine Zers. |
| **Ref13** | -- | 570 | -- | -- | Zers. |
| | -- | 69 | -- | | Zers. |
| **Ref14*** | -- | 651 | 0.67 | -- | Zers. |
| | -- | 52 | Toluol | | Zers. |
| **Ref15** | -5.12 | 607 | 0.84 | | Zers. |
| | -2.52 | 65 | Toluol | | Zers. |
| **Ref16** | -5.10 | 603 | 0.85 | | Zers. |
| | -2.55 | 67 | Toluol | | Zers. |

| **Erfindungsgemäße Beispiele** | | | | | |
|---|---|---|---|---|---|
| **I1-Ir₂(L1)** | -5.12 | 608 | 0.91 | 0.43 | Keine Zers. |
| | -2.56. | 58 | Toluol | | Keine Zers. |
| **I2-Ir₂(L1**) | -5.11 | 609 | 0.92 | 0.41 | Keine Zers. |
| | -2.63 | 56 | Toluol | | Keine Zers. |
| **I1-Ir₂(L75)** | -5.08 | 626 | 0.90 | 0.53 | Keine Zers. |
| | -2.48 | 49 | Toluol | | |
| **I2-Ir₂(L75)** | | 614 | 0.85 | 0.49 | Keine Zers. |
| | | 52 | Toluol | | |
| **Ir₂100** | -5.09 | 612 | 0.93 | 0.39 | --- |
| | -2.53 | 45 | Toluol | | --- |
| **I1-Ir₂(L16)** | -- | 576 | -- | -- | -- |
| | -- | 61 | -- | | -- |
| **I1-Ir₂(L44)** | | 601 | -- | -- | -- |
| | -- | 54 | -- | | -- |
| **Ir₃(L53)** | -- | 626 | -- | -- | -- |
| | -- | 43 | -- | | -- |
| **I2-Ir₂(L23)** | -- | 672 | -- | -- | -- |
| | -- | 41 | | | -- |
| **Ir₂101** | -- | 617 | -- | -- | -- |
| | -- | 44 | | | -- |
| **I1-Ir₂(L66)** | -- | 602 | -- | -- | -- |
| | -- | 49 | | | -- |
| **Ir₂(L59)** | -- | 613 | -- | -- | -- |
| | -- | 48 | | | -- |
| **Ir₂(L60)** | -- | 682 | -- | -- | -- |
| | -- | 62 | | | -- |
| **I1-Ir₂(L76)** | -- | 621 | -- | -- | -- |
| | -- | 71 | | | |
| **I2-Ir₂(L76)** | -- | 619 | -- | -- | -- |
| | -- | 66 | | | |

| | | | | | |
|---|---|---|---|---|---|
| *1 Werte aus Inorg. Chem., 2016, 55, 1720-1727. *2 Werte aus Chem. Commun, 2014, 50, 6831. | | | | | |

### Legende:

### - Therm. Stab. (thermische Stabilität):

Auslagerung in unter Vakuum abgeschmolzenen Ampullen, 7 Tage bei 380 °C. Visuelle Begutachtung auf Farbveränderung / Braunverfärbung / Veraschung und Analyse mittels ¹H-NMR Spektroskopie.

### - Photo. Stab. (photochemische Stabilität):

Bestrahlung ca. 1 mmolarer Lösung in wasserfreiem C₆D₆ (entgastes und abgeschmolzenes NMR-Röhrchen) mit blauem Licht (ca. 455 nm, 1.2 W Lumispot der Fa. Dialight Corporation, USA) bei Raumtemperatur.

### - PL-max.:

Maximum des PL-Spektrums in nm einer entgasten ca. 10⁻⁵ molaren Lösung bei Raumtemperatur, Anregungswellenlänge 370 nm, Lösungsmittel: s. Spalte PLQE.

### - FWHM:

Halbwertsbreite des PL-Spektrums in nm bei Raumtemperatur.

### - PLQE:

Absolute Photolumisenzenz-Quanteneffizienz einer entgasten, ca. 10⁻⁵ molaren Lösung im angegebenen Lösungsmittel bei Raumtemperatur, gemessen als Absolutwert via Ulbrichtkugel.

### - Abklingzeit:

Bestimmung der T₁-Lebensdauer durch time correlated single photon counting einer entgasten 10⁻⁵ molaren Lösung in Toluol bei Raumtemperatur.

### - HOMO, LUMO:

Wert in eV vs. Vakuum, bestimmt in Dichlormethan-Lösung (Oxidation) bzw. THF (Reduktion) mit interner Ref. Ferrocen (- 4.8 eV vs. Vakuum).

### Device Beispiele

### Beispiel 1: Herstellung der OLEDs

Die erfindungsgemäßen Komplexe können aus Lösung verarbeitet werden. Die Herstellung vollständig lösungsbasierter OLEDs ist in der Literatur bereits vielfach beschrieben, z. B. in WO 2004/037887 mittels Spin-Coating. Die Herstellung vakuumbasierter OLEDs ist ebenfalls vielfach vorbeschrieben, u.a. in WO 2004/058911. In den im Folgenden diskutierten Beispielen werden lösungsbasiert und vakuumbasiert aufgebrachte Schichten innerhalb einer OLED kombiniert, so dass die Prozessierung bis einschließlich zur Emissionsschicht aus Lösung und in den darauf folgenden Schichten (Lochblockierschicht und Elektronentransportschicht) aus dem Vakuum erfolgt. Die vorbeschriebenen allgemeinen Verfahren werden dafür wie folgt auf die hier beschriebenen Gegebenheiten (Schichtdickenvariation, Materialien) angepasst und kombiniert. Der generelle Aufbau ist wie folgt: Substrat / ITO (50 nm) / Lochinjektionsschicht (HIL) / Lochtransportschicht (HTL) / Emissionsschicht (EML) / Lochblockierschicht (HBL) / Elektronentransportschicht (ETL) / Kathode (Aluminium, 100nm). Als Substrat dienen Glasplättchen, die mit strukturiertem ITO (Indium Zinn Oxid) der Dicke 50 nm beschichtet sind. Zur besseren Prozessierung werden diese mit PEDOT:PSS beschichtet (Poly(3,4-ethylendioxy-2,5-thiophen) : Polystyrolsulfonat, bezogen von Heraeus Precious Metals GmbH & Co. KG, Deutschland). PEDOT:PSS wird an Luft aus Wasser aufgeschleudert und nachfolgend an Luft bei 180 °C für 10 Minuten ausgeheizt, um Restwasser zu entfernen. Auf diese beschichteten Glasplättchen werden die Lochtransportschicht sowie die Emissionsschicht aufgebracht. Die verwendete Lochtransportschicht ist vernetzbar. Es wird ein Polymer gemäß der nachfolgend abgebildeten Strukturen verwendet, das gemäß WO 2010/097155 bzw. WO 2013/156130 synthetisiert werden kann:

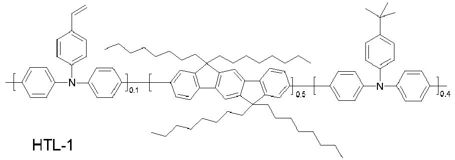

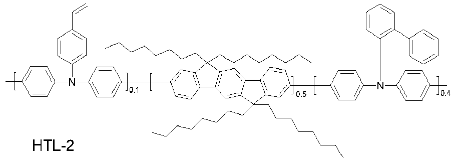

Das Lochtransport-Polymer wird in Toluol gelöst. Der typische Feststoffgehalt solcher Lösungen liegt bei ca. 5 g/l, wenn, wie hier, die für eine Device typische Schichtdicke von 20 nm mittels Spincoating erzielt werden soll. Die Schichten werden in einer Inertgasatmosphäre, im vorliegenden Fall Argon, aufgeschleudert und 60 Minuten bei 180 °C ausgeheizt.

Die Emissionsschicht setzt sich immer aus mindestens einem Matrixmaterial (Hostmaterial, Wirtsmaterial) und einem emittierenden Dotierstoff (Dotand, Emitter) zusammen. Weiterhin können Mischungen aus mehreren Matrixmaterialien sowie Co-Dotanden verwendet werden. Eine Angabe wie TMM-A (92%) : Dotand (8%) bedeutet hierbei, dass das Material TMM-A in einem Gewichtsanteil von 92% und Dotand in einem Gewichtsanteil von 8% in der Emissionsschicht vorliegt. Die Mischung für die Emissionsschicht wird in Toluol oder ggf. Chlorbenzol gelöst. Der typische Feststoffgehalt solcher Lösungen liegt bei ca. 17 g/l, wenn, wie hier, die für eine Device typische Schichtdicke von 60 nm mittels Spin-coating erzielt werden soll. Die Schichten werden in einer Inertgasatmosphäre, im vorliegenden Fall Argon, aufgeschleudert und 10 Minuten bei 150 °C ausgeheizt. Die im vorliegenden Fall verwendeten Materialien sind in Tabelle 2 gezeigt.

**Tabelle 2: Verwendete EML-Materialien**

| | | |
|---|---|---|
| 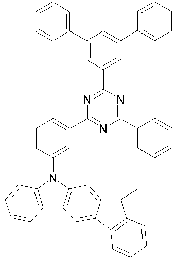 | 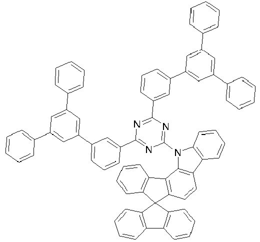 | 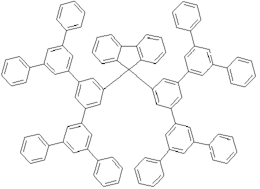 |
| A-1 [1616231-83-4] | A-2 Siehe WO14094963 | B-1 [1257248-89-7] |
| 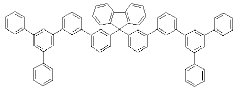 | 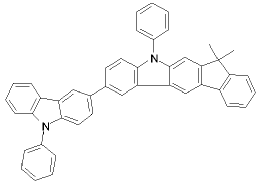 | 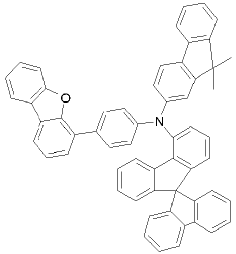 |
| B-2 [2047361-36-2] | B-3 [1357150-54-99] | B-4 1906885-65-1 |
| 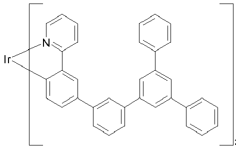 | 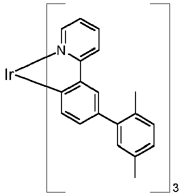 | 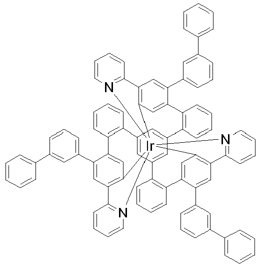 |
| C-1 [1269508-30-6] | C-2 [1338784-40-9] | C-3 Siehe WO 2016/124304 |

Die Materialien für die Lochblockierschicht und Elektronentransportschicht werden in einer Vakuumkammer thermisch aufgedampft. Dabei kann z. B. die Elektronentransportschicht aus mehr als einem Material bestehen, die einander durch Co-Verdampfung in einem bestimmten Volumenanteil beigemischt werden. Eine Angabe wie ETM1:ETM2 (50%:50%) bedeutet hierbei, dass die Materialien ETM1 und ETM2 in einem Volumenanteil von je 50% in der Schicht vorliegen. Die im vorliegenden Fall verwendeten Materialien sind in Tabelle 3 gezeigt.

**Tabelle 3: Verwendete HBL- und ETL-Materialien**

| | | |
|---|---|---|
| 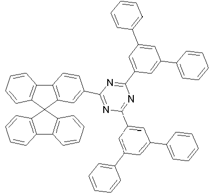 | 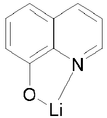 | 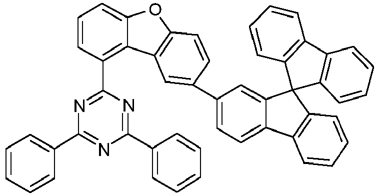 |
| ETM1 [1233200-52-6] | ETM2 [25387-93-3] | ETM3 [1822310-88-29] |

Die Kathode wird durch die thermische Verdampfung einer 100 nm Aluminiumschicht gebildet. Die OLEDs werden standardmäßig charakterisiert. Hierfür werden die Elektrolumineszenzspektren, Strom-Spannungs-Leuchtdichte-Kennlinien (IUL-Kennlinien) unter Annahme einer Lambert'schen Abstrahlcharakteristik sowie die (Betriebs-)Lebensdauer bestimmt. Aus den IUL-Kennlinien werden Kennzahlen bestimmt wie die Betriebsspannung (in V) und die Effizienz (cd/A) bei einer bestimmten Helligkeit. Die Elektrolumineszenzspektren werden bei einer Leuchtdichte von 1000 cd/m² gemessen und daraus die CIE 1931 x und y Farbkoordinaten berechnet. Die EML-Mischungen und Aufbauten der untersuchten OLED-Bauteile sind in Tabelle 4 und Tabelle 5 dargestellt. Die zugehörigen Ergebnisse finden sich in Tabelle 6.

**Tabelle 4: EML-Mischungen der untersuchten OLED-Bauteile**

| Bsp. | Matrix A | | Co-Matrix B | | Co-Dotand C | | Dotand D | | Weitere Co-Matrix B | |
|---|---|---|---|---|---|---|---|---|---|---|
| | Material | % | Material | % | Material | % | Material | % | Material | % |
| V1 | A-2 | 30 | B-1 | 47 | C-1 | 17 | Ref1 | 6 | --- | --- |
| V2 | A-2 | 30 | B-1 | 45 | C-1 | 17 | Ref1 | 8 | --- | --- |
| V3 | A-2 | 30 | B-1 | 34 | C-1 | 30 | Ref2 | 6 | --- | --- |
| E-1 | A-2 | 30 | B-1 | 47 | C-1 | 17 | I1-Ir₂(L1) | 6 | --- | --- |
| E-2 | A-2 | 30 | B-1 | 45 | C-1 | 17 | I1-Ir₂(L1) | 8 | --- | --- |
| E-3 | A-2 | 30 | B-1 | 47 | C-1 | 17 | I2-Ir₂(L1) | 6 | --- | --- |
| E-4 | A-2 | 30 | B-1 | 47 | C-1 | 17 | Ir₂100 | 6 | --- | --- |
| E-5 | A-2 | 30 | B-1 | 47 | C-1 | 17 | I1-Ir₂(L44) | 6 | --- | --- |
| E-6 | A-2 | 30 | B-1 | 47 | C-2 | 17 | Ir₃(L53) | 6 | --- | --- |
| E-7 | A-2 | 30 | B-1 | 45 | C-1 | 17 | Ir₂101 | 8 | --- | --- |
| E-8 | A-2 | 30 | B-1 | 47 | C-2 | 17 | I1-Ir₂(L66) | 6 | --- | --- |
| E-9 | A-2 | 30 | B-1 | 47 | C-1 | 17 | Ir₂(L59) | 6 | --- | --- |
| V4 | A-1 | 40 | B-1 | 45 | --- | --- | Ref1 | 15 | --- | --- |
| V5 | A-1 | 40 | B-1 | 55 | --- | --- | Ref2 | 5 | --- | --- |
| E-10 | A-1 | 40 | B-1 | 45 | --- | --- | I1-Ir₂(L1) | 15 | --- | --- |
| E-11 | A-1 | 40 | B-1 | 45 | --- | --- | I2-Ir₂(L1) | 15 | --- | --- |
| E-12 | A-1 | 40 | B-1 | 45 | --- | --- | Ir₂100 | 15 | --- | --- |
| E-13 | A-1 | 40 | B-1 | 55 | --- | --- | I1-Ir₂(L44) | 5 | --- | --- |
| E-14 | A-1 | 40 | B-1 | 45 | --- | --- | I1-Ir₂(L16) | 15 | --- | --- |
| E-15 | A-1 | 40 | B-1 | 45 | --- | --- | I1-Ir₂(L66) | 15 | --- | --- |
| E-16 | A-1 | 40 | B-1 | 45 | --- | --- | Ir₂(L59) | 15 | --- | --- |
| E-17 | A-2 | 30 | B-1 | 47 | C-3 | 17 | I1-Ir₂(L1) | 6 | --- | --- |
| E-18 | A-2 | 30 | B-1 | 47 | C-1 | 17 | Ref14 | 6 | --- | --- |
| E-19 | A-1 | 40 | B-1 | 45 | --- | --- | Ref13 | 15 | --- | --- |
| E-20 | A-2 | 40 | B-1 | 40 | --- | --- | Ir2(100) | 20 | --- | --- |
| E-21 | A-2 | 40 | B-1 | 40 | --- | --- | I1-Ir₂(L75) | 20 | --- | --- |
| E-22 | A-2 | 30 | B-1 | 47 | --- | --- | I2-Ir₂(L75) | 6 | --- | --- |
| E-23 | A-2 | 30 | B-1 | 37 | C-1 | 25 | I1-Ir₂(L75) | 8 | --- | --- |
| E-24 | A-2 | 30 | B-1 | 40 | C-1 | 22 | I1-Ir₂(L75) | 8 | --- | --- |
| E-25 | A-2 | 30 | B-1 | 32 | C-1 | 20 | I1-Ir₂(L75) | 8 | B-3 | 10 |
| E-26 | A-2 | 30 | B-1 | 27 | C-1 | 20 | I1-Ir₂(L75) | 8 | B-4 | 15 |

**Tabelle 5: Aufbau der untersuchten OLED-Bauteile**

| Bsp. | HIL (Dicke) | HTL (Dicke) | EML-Dicke | HBL (Dicke) | ETL (Dicke) |
|---|---|---|---|---|---|
| V1 | PEDOT (60nm) | HTL2 (20nm) | 60nm | ETM-1 (10nm) | ETM-1 (50%) : ETM-2 (50%) (40nm) |
| V2 | PEDOT (60nm) | HTL2 (20nm) | 60nm | ETM-1 (10nm) | ETM-1 (50%) : ETM-2 (50%) (40nm) |
| V3 | PEDOT (60nm) | HTL2 (20nm) | 60nm | ETM-1 (10nm) | ETM-1 (50%) : ETM-2 (50%) (40nm) |
| E-1 | PEDOT (60nm) | HTL2 (20nm) | 60nm | ETM-1 (10nm) | ETM-1 (50%) : ETM-2 (50%) (40nm) |
| E-2 | PEDOT (60nm) | HTL2 (20nm) | 60nm | ETM-1 (10nm) | ETM-1 (50%) : ETM-2 (50%) (40nm) |
| E-3 | PEDOT (60nm) | HTL2 (20nm) | 60nm | ETM-1 (10nm) | ETM-1 (50%) : ETM-2 (50%) (40nm) |
| E-4 | PEDOT (60nm) | HTL2 (20nm) | 60nm | ETM-1 (10nm) | ETM-1 (50%) : ETM-2 (50%) (40nm) |
| E-5 | PEDOT (60nm) | HTL2 (20nm) | 60nm | ETM-1 (10nm) | ETM-1 (50%) : ETM-2 (50%) (40nm) |
| E-6 | PEDOT (60nm) | HTL2 (20nm) | 60nm | ETM-1 (10nm) | ETM-1 (50%) : ETM-2 (50%) (40nm) |
| E-7 | PEDOT (80nm) | HTL1 (20nm) | 60nm | ETM-1 (10nm) | ETM-1 (50%) : ETM-2 (50%) (40nm) |
| E-8 | PEDOT (60nm) | HTL1 (20nm) | 60nm | ETM-1 (10nm) | ETM-1 (50%) : ETM-2 (50%) (40nm) |
| E-9 | PEDOT (60nm) | HTL2 (20nm) | 60nm | ETM-1 (10nm) | ETM-1 (50%) : ETM-2 (50%) (40nm) |
| V4 | PEDOT (70nm) | HTL1 (20nm) | 60nm | ETM-1 (10nm) | ETM-1 (50%) : ETM-2 (50%) (40nm) |
| V5 | PEDOT (70nm) | HTL1 (20nm) | 60nm | ETM-1 (10nm) | ETM-1 (50%) : ETM-2 (50%) (40nm) |
| E-10 | PEDOT (70nm) | HTL1 (20nm) | 60nm | ETM-1 (10nm) | ETM-1 (50%) : ETM-2 (50%) (40nm) |
| E-11 | PEDOT (70nm) | HTL1 (20nm) | 60nm | ETM-1 (10nm) | ETM-1 (50%) : ETM-2 (50%) (40nm) |
| E-12 | PEDOT (70nm) | HTL1 (20nm) | 60nm | ETM-1 (10nm) | ETM-1 (50%) : ETM-2 (50%) (40nm) |
| E-13 | PEDOT (70nm) | HTL1 (20nm) | 60nm | ETM-1 (10nm) | ETM-1 (50%) : ETM-2 (50%) (40nm) |
| E-14 | PEDOT (70nm) | HTL1 (20nm) | 60nm | ETM-1 (10nm) | ETM-1 (50%) : ETM-2 (50%) (40nm) |
| E-15 | PEDOT (70nm) | HTL1 (20nm) | 60nm | ETM-1 (10nm) | ETM-1 (50%) : ETM-2 (50%) (40nm) |
| E-16 | PEDOT (70nm) | HTL1 (20nm) | 60nm | ETM-1 (10nm) | ETM-1 (50%) : ETM-2 (50%) (40nm) |
| E-17 | PEDOT (60nm) | HTL2 (20nm) | 60nm | ETM-1 (10nm) | ETM-1 (50%) : ETM-2 (50%) (40nm) |
| E-18 | PEDOT (60nm) | HTL2 (20nm) | 60nm | ETM-1 (10nm) | ETM-1 (50%) : ETM-2 (50%) (40nm) |
| E-19 | PEDOT (70nm) | HTL1 (20nm) | 60nm | ETM-1 (10nm) | ETM-1 (50%) : ETM-2 (50%) (40nm) |
| E-20 | PEDOT (60nm) | HTL2 (20nm) | 60nm | ETM-1 (10nm) | ETM-1 (50%) : ETM-2 (50%) (40nm) |
| E-21 | PEDOT (60nm) | HTL2 (20nm) | 60nm | ETM-1 (10nm) | ETM-1 (50%) : ETM-2 (50%) (40nm) |
| E-22 | PEDOT (60nm) | HTL2 (20nm) | 60nm | ETM-1 (10nm) | ETM-1 (50%) : ETM-2 (50%) (40nm) |
| E-23 | PEDOT (60nm) | HTL2 (20nm) | 60nm | ETM-1 (10nm) | ETM-1 (50%) : ETM-2 (50%) (40nm) |
| E-24 | PEDOT (60nm) | HTL2 (20nm) | 60nm | ETM-3 (10nm) | ETM-1 (50%) : ETM-2 (50%) (40nm) |
| E-25 | PEDOT (60nm) | HTL2 (20nm) | 60nm | ETM-3 (10nm) | ETM-1 (50%) : ETM-2 (50%) (60nm) |
| E-26 | PEDOT (60nm) | HTL2 (20nm) | 60nm | ETM-3 (10nm) | ETM-1 (50%) : ETM-2 (50%) (40nm) |

**Tabelle 6: Ergebnisse lösungsprozessierter OLEDs (bei einer Helligkeit von 1000 cd/m² gemessen)**

| Bsp. | EQE [%] | CIE x | CIE y | LT90 @60mA/cm² |
|---|---|---|---|---|
| V1 | 16.2 | 0.66 | 0.34 | 276 |
| V2 | 15.7 | 0.67 | 0.33 | 123 |
| V3 | 18.2 | 0.64 | 0.36 | 298 |
| E-1 | 20.0 | 0.65 | 0.35 | 359 |
| E-2 | 19.9 | 0.66 | 0.34 | 317 |
| E-3 | 18.6 | 0.66 | 0.34 | 315 |
| E-4 | 18.6 | 0.64 | 0.35 | 304 |
| E-5 | 20.1 | 0.63 | 0.37 | 277 |
| E-6 | 19.8 | 0.68 | 0.32 | 221 |
| E-7 | 18.7 | 0.68 | 0.32 | 298 |
| E-8 | 19.7 | 0.63 | 0.37 | 248 |
| E-9 | 18.4 | 0.67 | 0.33 | 199 |
| V4 | 15.0 | 0.68 | 0.33 | 70 |
| V5 | 8.6 | 0.65 | 0.35 | 34 |
| E-10 | 19.1 | 0.67 | 0.33 | 171 |
| E-11 | 18.9 | 0.67 | 0.33 | 165 |
| E-12 | 18.8 | 0.67 | 0.33 | 154 |
| E-13 | 16.7 | 0.65 | 0.35 | 93 |
| E-14 | 18.5 | 0.55 | 0.45 | 137 |
| E-15 | 19.4 | 0.65 | 0.35 | 133 |
| E-16 | 18.8 | 0.68 | 0.32 | 85 |
| E-17 | 19.8 | 0.65 | 0.35 | 348 |
| E18 | 10.2 | 0.71 | 0.28 | 112 |
| E-19 | 14.8 | 0.55 | 0.44 | 84 |
| E-20 | 18.2 | 0.68 | 0.32 | 16 |
| E-21 | 18.0 | 0.70 | 0.31 | 92 |
| E-22 | 13.3 | 0.65 | 0.35 | 111 |
| E-23 | 21.6 | 0.68 | 0.32 | 569 |
| E-24 | 24.6 | 0.68 | 0.32 | 493 |
| E-25 | 23.6 | 0.68 | 0.32 | 93 |
| E-26 | 23.8 | 0.68 | 0.32 | 236 |

Alle oben aufgeführten Verbindungen P1 bis P234 sowie die oben aufgeführten deuterierten Verbindungen können analog eingesetzt werden und führen zu vergleichbaren Ergebnissen.

Alternativ zur Herstellung mittels Spin-Coating können die lösungsprozessierten Schichten unter anderem auch mittels InkJet-Printing hergestellt werden. In den im Folgenden diskutierten Beispielen werden wiederum lösungsbasiert und vakuumbasiert aufgebrachte Schichten innerhalb einer OLED kombiniert, so dass die Prozessierung bis einschließlich zur Emissionsschicht aus Lösung und in den darauf folgenden Schichten (Lochblockierschicht und Elektronentransportschicht) aus dem Vakuum erfolgt. Der generelle Aufbau ist weiterhin wie folgt: Substrat / ITO (50 nm) / Lochinjektionsschicht (HIL) / Lochtransportschicht (HTL) / Emissionsschicht (EML) / Lochblockierschicht (HBL) / Elektronentransportschicht (ETL) / Kathode (Aluminium, 100nm). Als Substrat dienen Glasplättchen, die mit strukturiertem ITO (Indium Zinn Oxid) der Dicke 50 nm sowie pixelliertem Bank-Material beschichtet sind.

Die Lochinjektionsschicht wird auf das Substrat gedruckt, im Vakuum getrocknet und nachfolgend an Luft bei 180 °C für 30 Minuten ausgeheizt. Die Lochtransportschicht wird auf die Lochinjektionsschicht gedruckt, im Vakuum getrocknet und nachfolgend in der Glovebox bei 230 °C für 30 Minuten ausgeheizt. Nachfolgend wird die Emissionsschicht gedruckt, im Vakuum getrocknet und in der Glovebox bei 160 °C für 10 Minuten ausgeheizt. Alle Druckschritte werden an Luft unter Gelblicht durchgeführt. Als Lochinjektionsmaterial wird eine Komposition aus einem Polymer (z.B. Polymer P2) und einem Salz (z.B. Salz D1) gemäß PCT/EP2015/002476 verwendet. Es wird in 3-Phenoxytoluol und Diethylenglycolbutylmethylether im Verhältnis 7:3 in Lösung gebracht. Das Lochtransportmaterial wird aus demselben Lösungsmittelgemisch verarbeitet. Die Emissionsschicht wird aus reinem 3-Phenoxytoluol gedruckt.

Die EML-Mischungen und Aufbauten der untersuchten OLED-Bauteile sind in Tabelle 7 und Tabelle 8 dargestellt. Die zugehörigen Ergebnisse finden sich in Tabelle 9. Es werden gute Pixel-Homogenitäten erreicht.

**Tabelle 7: EML-Mischungen der untersuchten OLED-Bauteile**

| Bsp. | Matrix A | | Co-Matrix B | | Co-Dotand C | | Dotand D | | Weitere Co-Matrix B | |
|---|---|---|---|---|---|---|---|---|---|---|
| | Material | % | Material | % | Material | % | Material | % | Material | % |
| E-28 | A-2 | 30 | B-1 | 47 | C-1 | 17 | I1-Ir2(L1) | 6 | --- | --- |
| E-29 | A-2 | 40 | B-1 | 40 | --- | --- | I1-Ir2(L1) | 20 | --- | --- |
| E-30 | A-2 | 30 | B-1 | 40 | C-1 | 22 | I1-Ir₂(L75) | 8 | | |

**Tabelle 8: Aufbau der untersuchten OLED-Bauteile**

| Bsp. | HIL (Dicke) | HTL (Dicke) | EML-Dicke | HBL (Dicke) | ETL (Dicke) |
|---|---|---|---|---|---|
| E-28 | HIL (60nm) | HTL2 (20nm) | 60nm | ETM-1 (10nm) | ETM-1 (50%) : ETM-2 (50%) (40nm) |
| E-29 | HIL (60nm) | HTL2 (20nm) | 60nm | ETM-1 (10nm) | ETM-1 (50%) : ETM-2 (50%) (40nm) |
| E-30 | HIL (60nm) | HTL2 (20nm) | 60nm | ETM-1 (10nm) | ETM-1 (50%) : ETM-2 (50%) (40nm) |

**Tabelle 9: Ergebnisse lösungsprozessierter OLEDs (bei einer Helligkeit von 1000 cd/m² gemessen)**

| Bsp. | EQE [%] | CIE x | CIE y | LT90 @60mA/cm² |
|---|---|---|---|---|
| E-28 | 21.0 | 0.66 | 0.34 | 503 |
| E-29 | 19.4 | 0.67 | 0.33 | 64 |
| E-30 | 20.8 | 0.68 | 0.32 | 156 |

### Beschreibung der Figuren

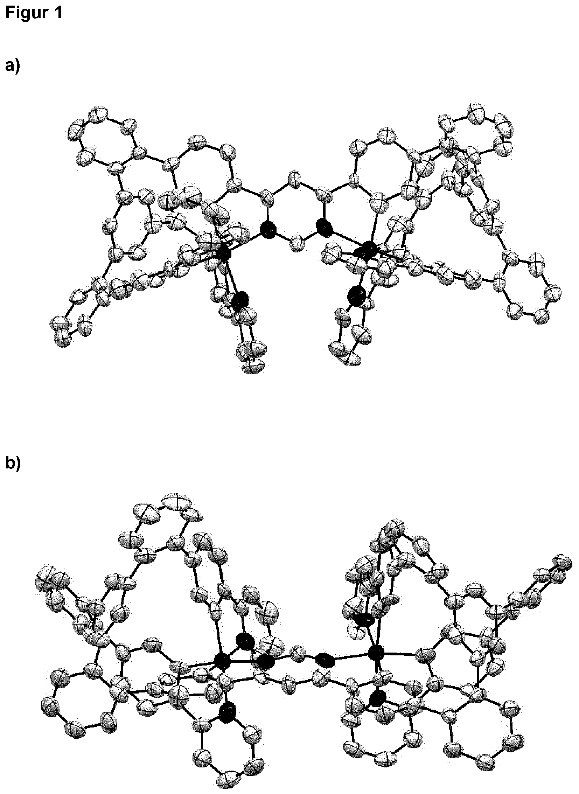

### Figur 1: Einkristallstruktur von Verbindung I2-Ir₂(L1)

### (ORTEP-Darstellung mit 50% Wahrscheinlichkeitslevel)

a) Blick seitlich auf den die Iridiumzentren verbrückenden Liganden.
b) Blick von oben auf den die Iridiumzentren verbrückenden Liganden.

Die Wasserstoffatome sind zur besseren Übersichtlichkeit nicht dargestellt.

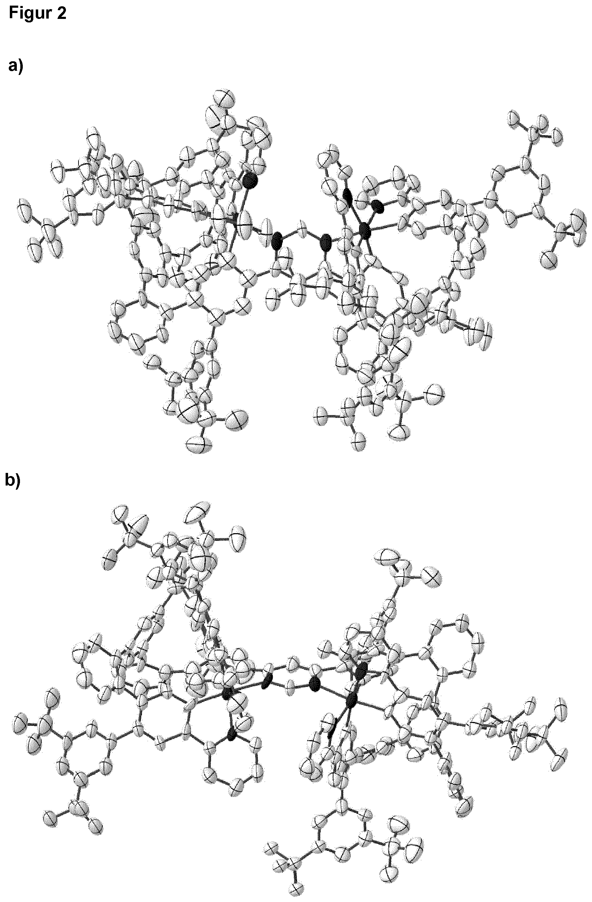

### Figur 2: Einkristallstruktur von Verbindung Ir₂100

### (ORTEP-Darstellung mit 50% Wahrscheinlichkeitslevel)

a) Blick seitlich auf den die Iridiumzentren verbrückenden Liganden.
b) Blick von oben auf den die Iridiumzentren verbrückenden Liganden.

Die Wasserstoffatome sind zur besseren Übersichtlichkeit nicht dargestellt.

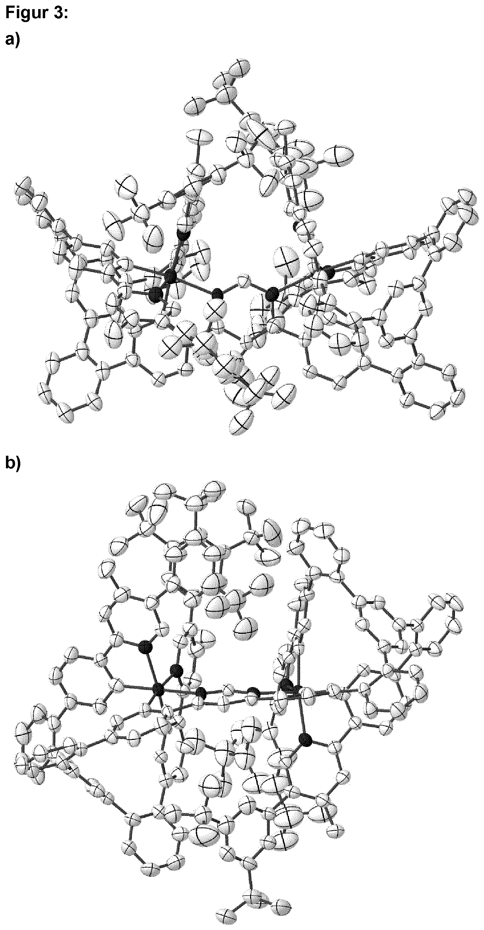

### Figur 3: Einkristallstruktur von Verbindung I1-Ir₂(L75)

### (ORTEP-Darstellung mit 50% Wahrscheinlichkeitslevel)

a) Blick seitlich auf den die Iridiumzentren verbrückenden Liganden.
b) Blick von oben auf den die Iridiumzentren verbrückenden Liganden.

Die Wasserstoffatome sind zur besseren Übersichtlichkeit nicht dargestellt.

## Patentansprüche

1. Verbindung gemäß Formel (1) oder Formel (2), 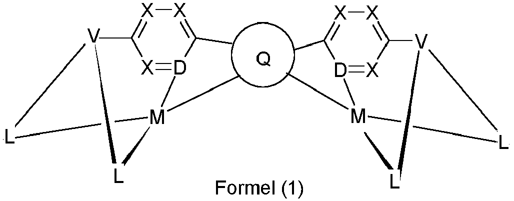 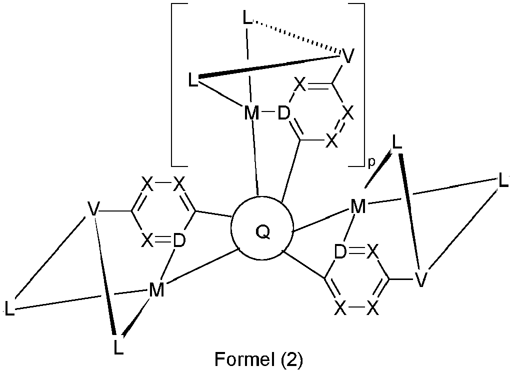 wobei für die verwendeten Symbole und Indizes gilt:
M ist bei jedem Auftreten gleich oder verschieden Iridium oder Rhodium;
Q ist eine Aryl- oder Heteroarylgruppe mit 6 oder 10 aromatischen Ringatomen, welche gleich oder verschieden über jeweils ein Kohlenstoff- oder Stickstoffatom an jedes der beiden bzw. drei M koordiniert und welche mit einem oder mehreren Resten R substituiert sein kann; dabei sind die koordinierenden Atome in Q nicht in ortho-Position zueinander gebunden;
D ist bei jedem Auftreten gleich oder verschieden C oder N;
X ist gleich oder verschieden bei jedem Auftreten und ist CR oder N;
p ist 0 oder 1;
V ist bei jedem Auftreten gleich oder verschieden eine Gruppe der Formel (3) oder (4), 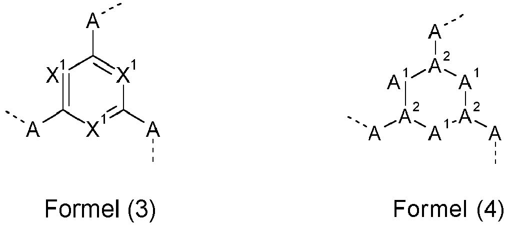 wobei eine der gestrichelten Bindungen die Bindung an die entsprechende in Formel (1) bzw. (2) dargestellte 6-Ring-Aryl- bzw. Heteroarylgruppe darstellt und die beiden anderen gestrichelten Bindungen jeweils die Bindungen an die Teilliganden L darstellen;
L ist bei jedem Auftreten gleich oder verschieden ein bidentater, monoanionischer Teilligand, ausgewählt aus den Strukturen der Formeln (L-1), (L-2) oder (L-3), 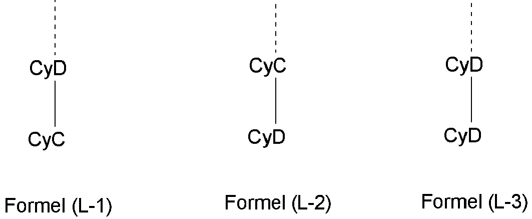 wobei die gestrichelte Bindung die Bindung des Teilliganden L an die Gruppe der Formel (3) bzw. (4) darstellt und für die weiteren verwendeten Symbole gilt:
CyC ist gleich oder verschieden bei jedem Auftreten eine substituierte oder unsubstituierte Aryl- oder Heteroarylgruppe mit 5 bis 14 aromatischen Ringatomen, welche über ein Kohlenstoffatom an M koordiniert und welche über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an M koordiniert und welche über eine kovalente Bindung mit CyC verbunden ist;
dabei können mehrere der optionalen Substituenten miteinander ein Ringsystem bilden;
X¹ ist bei jedem Auftreten gleich oder verschieden CR oder N;
A¹ ist bei jedem Auftreten gleich oder verschieden C(R)₂;
A² ist bei jedem Auftreten gleich oder verschieden CR;
A ist bei jedem Auftreten gleich oder verschieden -CR=CR-, -C(=O)-NR'-, -C(=O)-O-, -CR₂-CR₂-, -CR₂-O- oder eine Gruppe der Formel (5), 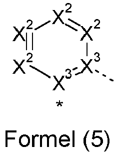 wobei die gestrichelte Bindung die Position der Bindung eines bidentaten Teilliganden L bzw. der entsprechenden in Formel (1) bzw. (2) abgebildeten 6-Ring-Aryl- bzw. Heteroarylgruppe an diese Struktur darstellt und * die Position der Verknüpfung der Einheit der Formel (5) mit der zentralen cyclischen Gruppe darstellt, die explizit in Formel (3) bzw. (4) aufgeführt ist;
X² ist bei jedem Auftreten gleich oder verschieden CR oder N oder zwei benachbarte Gruppen X² stehen zusammen für NR, O oder S, so dass ein Fünfring entsteht, und die verbleibenden X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² für N stehen;
X³ ist bei jedem Auftreten C, oder eine Gruppe X³ steht für N und die andere Gruppe X³ in demselben Cyclus steht für C; mit der Maßgabe, dass zwei benachbarte Gruppen X² zusammen für CR oder N stehen, wenn in dem Cyclus eine der Gruppen X³ für N steht;
R ist bei jedem Auftreten gleich oder verschieden H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, COO(Kation), SO₃(Kation), OSO₃(Kation), OPO₃(Kation)₂, O(Kation), N(R¹)₃(Anion), P(R¹)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
R' ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann;
R¹ ist bei jedem Auftreten gleich oder verschieden H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², COO(Kation), SO₃(Kation), OSO₃(Kation), OPO₃(Kation)₂, O(Kation), N(R²)₃(Anion), P(R²)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können;
Kation ist bei jedem Auftreten gleich oder verschieden ausgewählt aus der Gruppe bestehend aus Proton, Deuteron, Alkaliionen, Erdalkaliionen, Ammonium, Tetraalkylammonium und Tetraalkylphosphonium;
Anion ist bei jedem Auftreten gleich oder verschieden ausgewählt aus der Gruppe bestehend aus Halogeniden, Carboxylaten R²-COO⁻, Cyanid, Cyanat, Isocyanat, Thiocyanat, Thioisocyanat, Hydroxid, BF₄⁻, PF₆⁻, B(C₆F₅)₄⁻, Carbonat und Sulfonaten.

2. Verbindung nach Anspruch 1, gewählt aus den Verbindungen der Formeln (1a) und (2a), 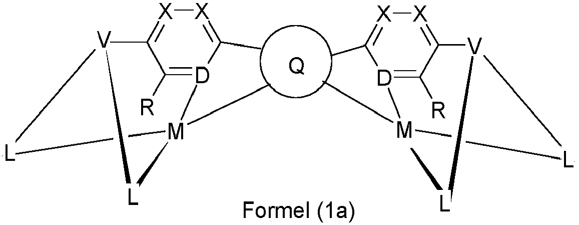 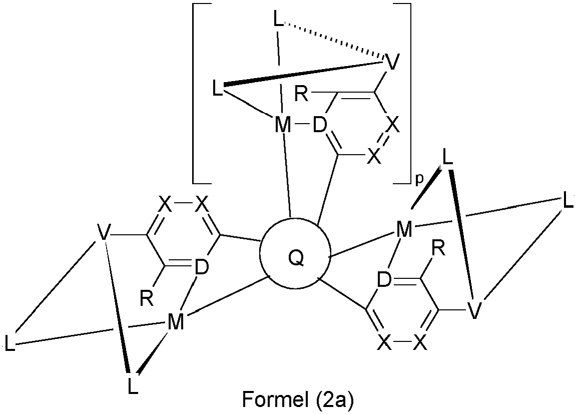 wobei der explizit eingezeichnete Rest R in ortho-Position zu D jeweils gleich oder verschieden bei jedem Auftreten ausgewählt ist aus der Gruppe bestehend aus H, D, F, CH₃ und CD₃ und die weiteren Symbole und Indizes die in Anspruch 1 aufgeführten Bedeutungen aufweisen.

3. Verbindung nach Anspruch 1 oder 2, **dadurch gekennzeichnet, dass** Q in Formel (1) für eine Gruppe gemäß einer der Formeln (Q-1) bis (Q-3) und in Formel (2) für eine Gruppe gemäß einer der Formeln (Q-4) bis (Q-15) für p = 0 bzw. für eine Gruppe gemäß Formel (Q-16) bis (Q-19) für p = 1 steht, 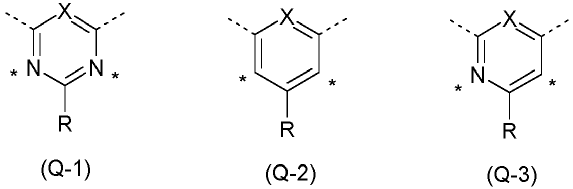 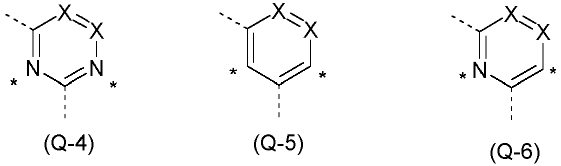 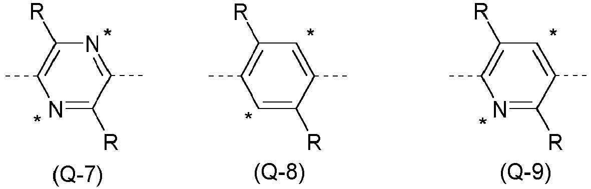 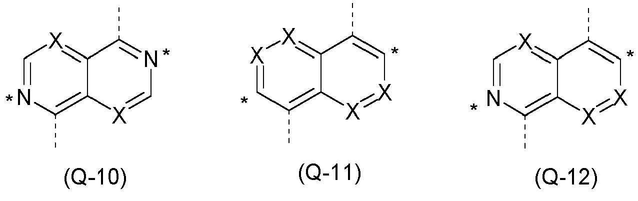 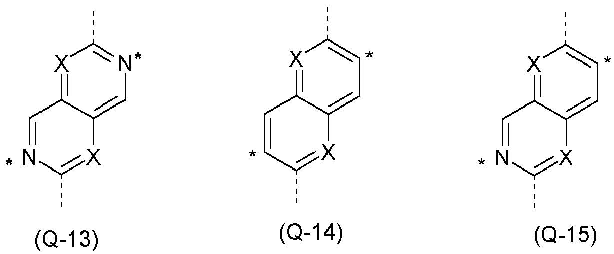 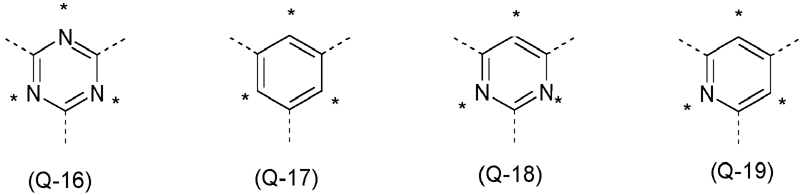 wobei die gestrichelte Bindung jeweils die Verknüpfung innerhalb der Formel (1) bzw. (2) andeutet, * die Position markiert, an der diese Gruppe an M koordiniert ist, und X und R die in Anspruch 1 genannten Bedeutungen aufweisen.

4. Verbindung nach einem oder mehreren der Ansprüche 1 bis 3, **dadurch gekennzeichnet, dass** die Gruppe der Formel (3) ausgewählt ist aus den Strukturen der Formeln (6) bis (9), 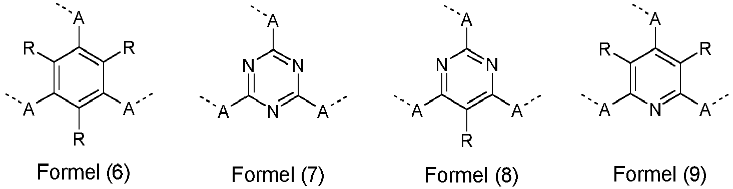 wobei die Symbole die in Anspruch 1 genannten Bedeutungen aufweisen.

5. Verbindung nach einem oder mehreren der Ansprüche 1 bis 4, **dadurch gekennzeichnet, dass** die Gruppe der Formel (3) eine Struktur der Formel (6') aufweist, 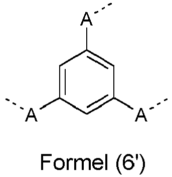 wobei die Symbole die in Anspruch 1 genannten Bedeutungen aufweisen.

6. Verbindung nach einem oder mehreren der Ansprüche 1 bis 5, **dadurch gekennzeichnet, dass** A gleich oder verschieden bei jedem Auftreten ausgewählt ist aus der Gruppe bestehend aus -C(=O)-O-, -C(=O)-NR'- oder einer Gruppe der Formel (5), wobei die Gruppe der Formel (5) ausgewählt ist aus den Strukturen der Formeln (15) bis (39), 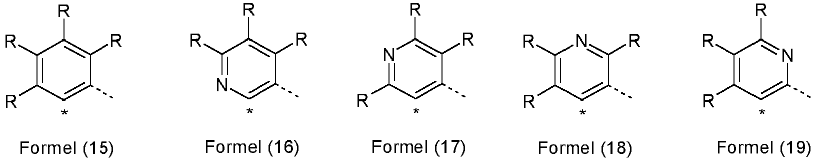 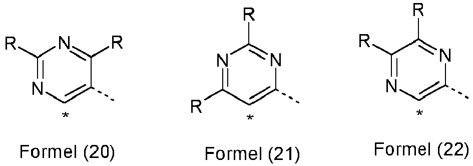 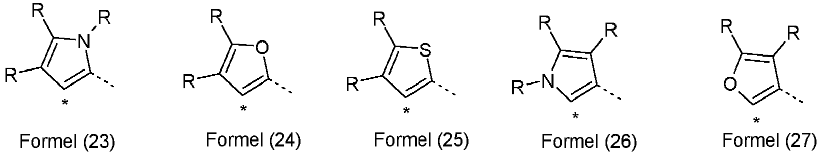 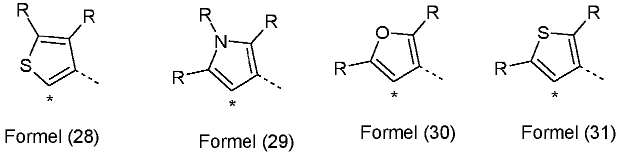 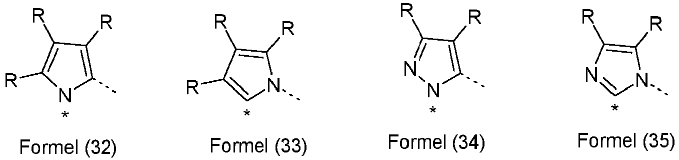 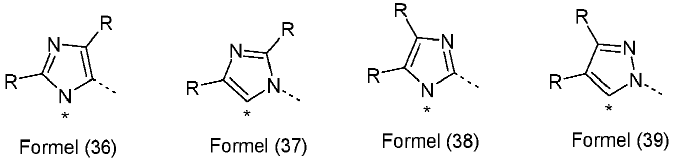 wobei die Symbole die in Anspruch 1 genannten Bedeutungen aufweisen.

7. Verbindung nach einem oder mehreren der Ansprüche 1 bis 6, **dadurch gekennzeichnet, dass** die Gruppe der Formel (3) ausgewählt ist aus den Formeln (3a) bis (3m) und die Gruppe der Formel (4) ausgewählt ist aus den Formeln (4a) bis (4m), 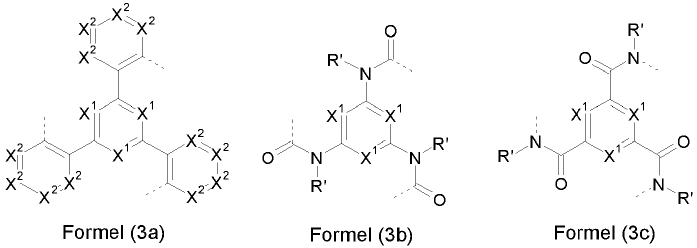 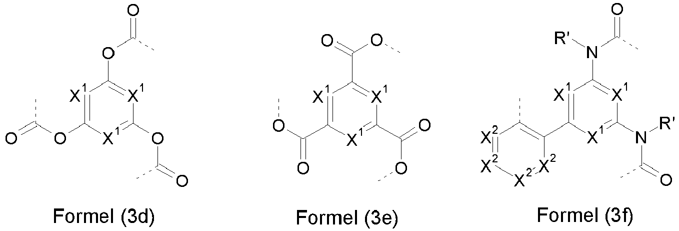 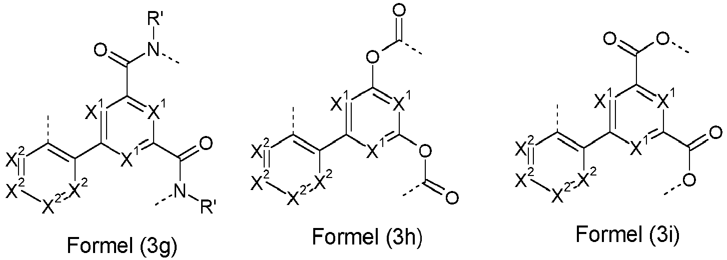 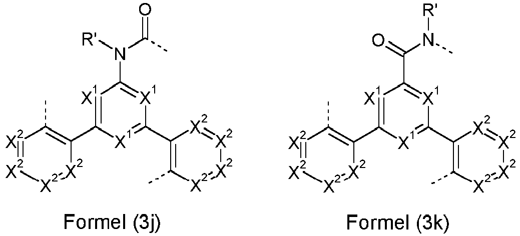 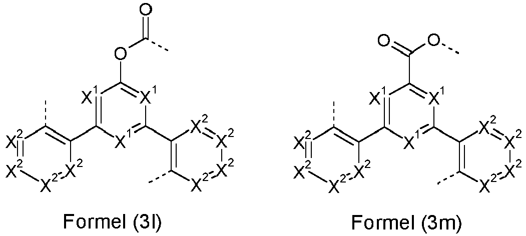 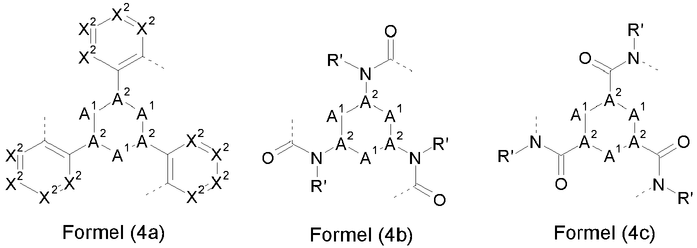 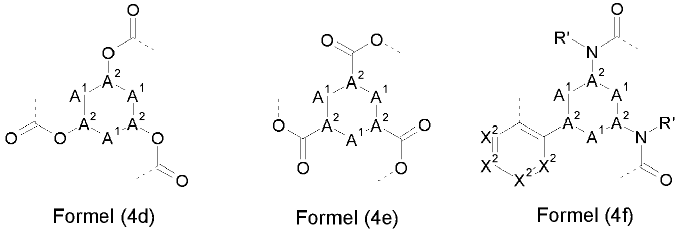 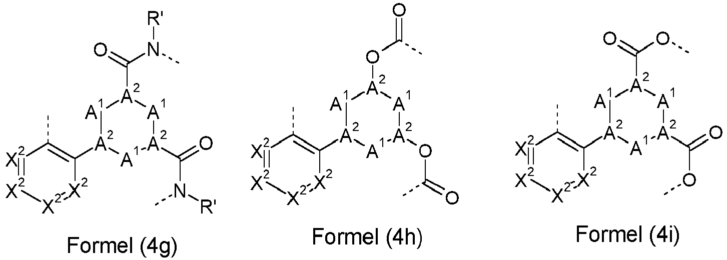 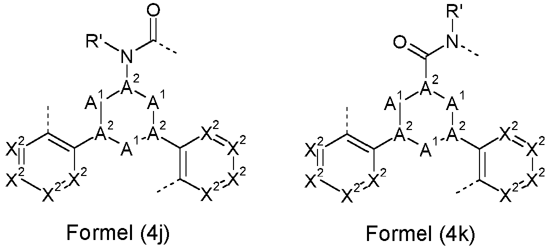 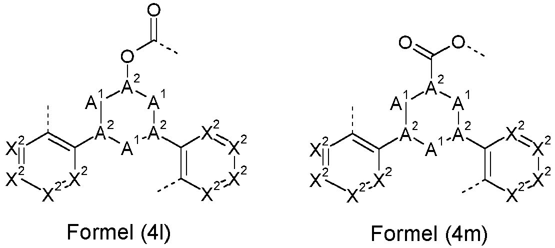 wobei die Symbole die in Anspruch 1 genannten Bedeutungen aufweisen.

8. Verbindung nach einem oder mehreren der Ansprüche 1 bis 7, **dadurch gekennzeichnet, dass** die Gruppe der Formel (3) eine Gruppe der Formel (6a'") ist, 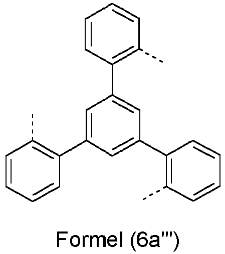 wobei die Symbole die in Anspruch 1 genannten Bedeutungen aufweisen.

9. Verbindung nach einem oder mehreren der Ansprüche 1 bis 8, **dadurch gekennzeichnet, dass** alle vier Teilliganden L für p = 0 bzw. alle sechs Teilliganden L für p = 1 gleich sind und gleich substituiert sind.

10. Verfahren zur Herstellung einer Verbindung nach einem oder mehreren der Ansprüche 1 bis 9 durch Umsetzung des freien Liganden mit Metallalkoholaten der Formel (58), mit Metallketoketonaten der Formel (59), mit Metallhalogeniden der Formel (60) oder mit Metallcarboxylaten der Formel (61) oder mit Iridium- bzw. Rhodiumverbindungen, die sowohl Alkoholat- und/oder Halogenid- und/oder Hydroxy- wie auch Ketoketonatreste tragen, 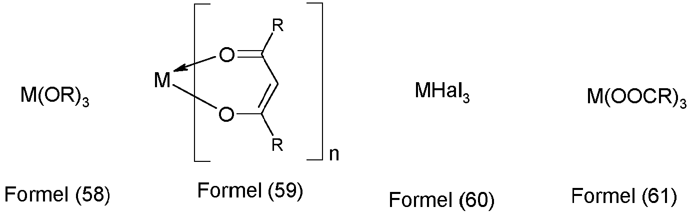 wobei M und R die in Anspruch 1 angegebenen Bedeutungen aufweisen, Hal = F, Cl, Br oder I ist und die Iridium- bzw. Rhodiumedukte auch als die entsprechenden Hydrate vorliegen können.

11. Mischung, enthaltend mindestens eine Verbindung nach einem oder mehreren der Ansprüche 1 bis 9 und mindestens eine weitere Verbindung, insbesondere ein Hostmaterial.

12. Formulierung, enthaltend mindestens eine Verbindung nach einem oder mehreren der Ansprüche 1 bis 9 oder mindestens eine Mischung nach Anspruch 11 und mindestens ein Lösemittel.

13. Verwendung einer Verbindung nach einem oder mehreren der Ansprüche 1 bis 9 oder einer Mischung nach Anspruch 11 in einer elektronischen Vorrichtung oder als Sauerstoff-Sensibilisator.

14. Elektronische Vorrichtung enthaltend mindestens eine Verbindung nach einem oder mehreren der Ansprüche 1 bis 9 oder mindestens eine Mischung nach Anspruch 11.

15. Elektronische Vorrichtung nach Anspruch 14, wobei es sich um eine organische Elektrolumineszenzvorrichtung handelt, **dadurch gekennzeichnet, dass** die Verbindung nach einem oder mehreren der Ansprüche 1 bis 9 als emittierende Verbindung in einer oder mehreren emittierenden Schichten eingesetzt wird.

## Claims

1. Compound of the formula (1) or formula (2), 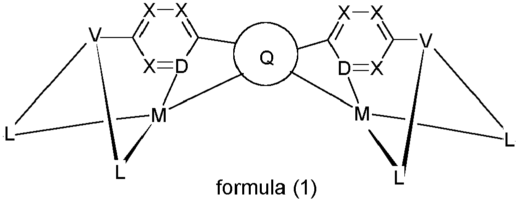 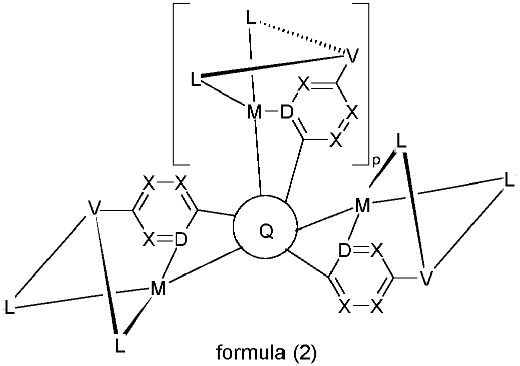 where the following applies to the symbols and indices used:
M is on each occurrence, identically or differently, iridium or rhodium;
Q is an aryl or heteroaryl group having 6 to 10 aromatic ring atoms, which is coordinated, identically or differently, to each of the two or three M via in each case a carbon or nitrogen atom and which may be substituted by one or more radicals R; the coordinating atoms in Q are not bonded in the ortho position to one another;
D is on each occurrence, identically or differently, C or N;
X is identical or different on each occurrence and is CR or N;
p is 0 or 1;
V is on each occurrence, identically or differently, a group of the formula (3) or (4), 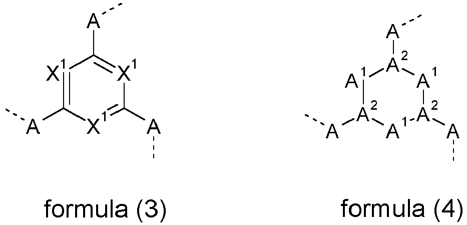 where one of the dashed bonds represents the bond to the corresponding 6-membered aryl or heteroaryl ring group depicted in formula (1) or (2) and the two other dashed bonds in each case represent the bonds to the part-ligands L;
L is on each occurrence, identically or differently, a bidentate, monoanionic part-ligand selected from the structures of the formulae (L-1), (L-2) or (L-3), 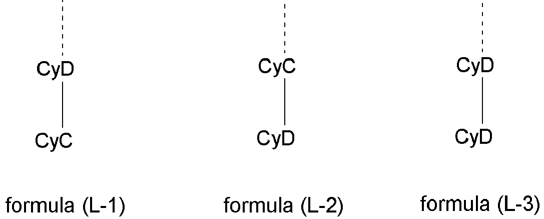 where the dashed bond represents the bond from the part-ligand L to the group of the formula (3) or (4) and the following applies to the other symbols used:
CyC is, identically or differently on each occurrence, a substituted or unsubstituted aryl or heteroaryl group having 5 to 14 aromatic ring atoms, which is coordinated to M via a carbon atom and which is bonded to CyD via a covalent bond;
CyD is, identically or differently on each occurrence, a substituted or unsubstituted heteroaryl group having 5 to 14 aromatic ring atoms, which is coordinated to M via a nitrogen atom or via a carbene carbon atom and which is bonded to CyC via a covalent bond;
a plurality of the optional substituents may form a ring system with one another;
X¹ is on each occurrence, identically or differently, CR or N;
A¹ is on each occurrence, identically or differently, C(R)₂;
A² is on each occurrence, identically or differently, CR;
A is on each occurrence, identically or differently, -CR=CR-, -C(=O)-NR'-, -C(=O)-O-, -CR₂-CR₂-, -CR₂-O- or a group of the formula (5), 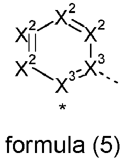 where the dashed bond represents the position of the bond from a bidentate part-ligand L or the corresponding 6-membered aryl or heteroaryl ring group depicted in formula (1) or (2) to this structure and * represents the position of the linking of the unit of the formula (5) to the central cyclic group which is explicitly shown in formula (3) or (4);
X² is on each occurrence, identically or differently, CR or N or two adjacent groups X² together stand for NR, O or S, so that a five-membered ring is formed, and the remaining X² stand, identically or differently on each occurrence, for CR or N; or two adjacent groups X² together stand for CR or N if one of the groups X³ in the ring stands for N, so that a five-membered ring forms; with the proviso that a maximum of two adjacent groups X² stand for N, with the proviso that a maximum of two adjacent groups X² stand for N;
X³ is on each occurrence C, or one group X³ stands for N and the other group X³ in the same ring stands for C; with the proviso that two adjacent groups X² together stand for CR or N if one of the groups X³ in the ring stands for N;
R is on each occurrence, identically or differently, H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, COO(cation), SO₃(cation), OSO₃(cation), OPO₃(cation), O(cation), N(R¹)₃(anion), P(R¹)₃(anion), a straight-chain alkyl group having 1 to 20 C atoms or an alkenyl or alkynyl group having 2 to 20 C atoms or a branched or cyclic alkyl group having 3 to 20 C atoms, where the alkyl, alkenyl or alkynyl group may in each case be substituted by one or more radicals R¹, where one or more non-adjacent CH₂ groups may be replaced by Si(R¹)₂, C=O, NR¹, O, S or CONR¹, or an aromatic or heteroaromatic ring system having 5 to 40 aromatic ring atoms, which may in each case be substituted by one or more radicals R¹; two radicals R may also form a ring system with one another;
R' is on each occurrence, identically or differently, H, D, a straight-chain alkyl group having 1 to 20 C atoms or a branched or cyclic alkyl group having 3 to 20 C atoms, where the alkyl group may in each case be substituted by one or more radicals R¹ and where one or more non-adjacent CH₂ groups may be replaced by Si(R¹)₂, or an aromatic or heteroaromatic ring system having 5 to 40 aromatic ring atoms, which may in each case be substituted by one or more radicals R¹;
R¹ is on each occurrence, identically or differently, H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², COO(cation), SO₃(cation), OSO₃(cation), OPO₃(cation), O(cation), N(R¹)₃(anion), P(R¹)₃(anion), a straight-chain alkyl group having 1 to 20 C atoms or an alkenyl or alkynyl group having 2 to 20 C atoms or a branched or cyclic alkyl group having 3 to 20 C atoms, where the alkyl, alkenyl or alkynyl group may in each case be substituted by one or more radicals R², where one or more non-adjacent CH₂ groups may be replaced by Si(R²)₂, C=O, NR², O, S or CONR², or an aromatic or heteroaromatic ring system having 5 to 40 aromatic ring atoms, which may in each case be substituted by one or more radicals R²; two or more radicals R¹ may form a ring system with one another;
R² is on each occurrence, identically or differently, H, D, F or an aliphatic, aromatic or heteroaromatic organic radical, in particular a hydrocarbon radical, having 1 to 20 C atoms, in which, in addition, one or more H atoms may be replaced by F;
cation is selected on each occurrence, identically or differently, from the group consisting of proton, deuteron, alkali metal ions, alkaline-earth metal ions, ammonium, tetraalkylammonium and tetraalkylphosphonium;
anion is selected on each occurrence, identically or differently, from the group consisting of halides, carboxylates R²-COO⁻, cyanide, cyanate, isocyanate, thiocyanate, thioisocyanate, hydroxide, BF₄⁻, PF₆⁻, B(C₆F₅)₄⁻, carbonate and sulfonates.

2. Compound according to Claim 1, selected from the compounds of the formulae (1a) and (2a), 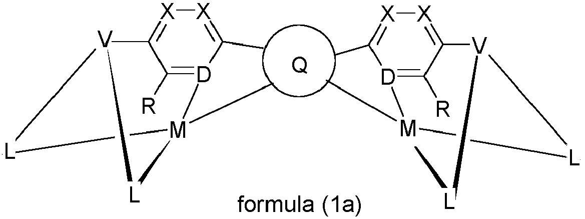 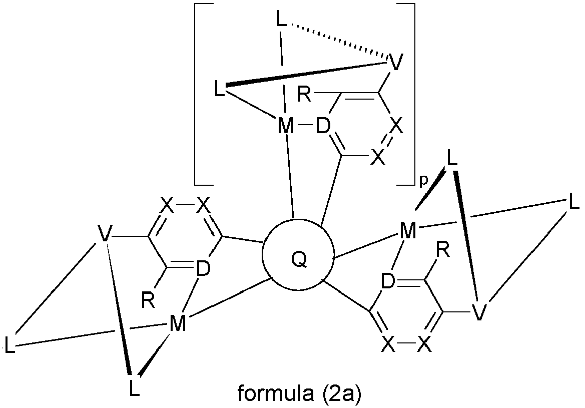 where the explicitly drawn-in radical R in the ortho position to D is in each case selected, identically or differently on each occurrence, from the group consisting of H, D, F, CH₃ and CD₃ and the other symbols and indices used have the meanings given in Claim 1.

3. Compound according to Claim 1 or 2, **characterised in that** Q in formula (1) stands for a group of one of the formulae (Q-1) to (Q3) and in formula (2) stands for a group of one of the formulae (Q-4) to (Q-15) for p = 0 or for a group of the formulae (Q-16) to (Q-19) for p = 1, 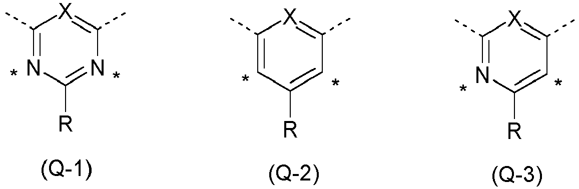 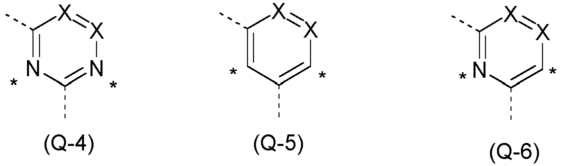 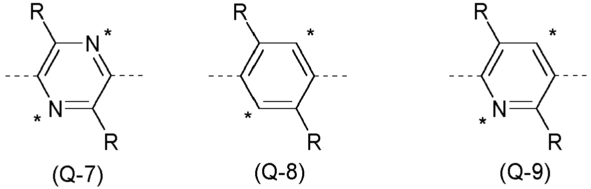 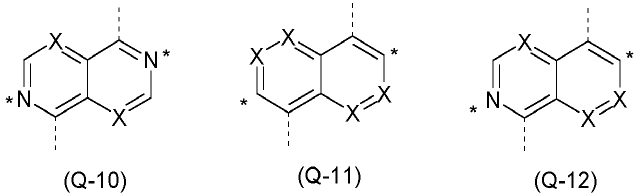 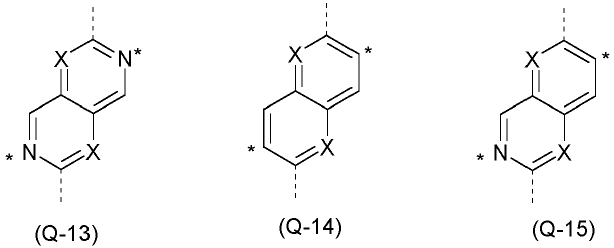 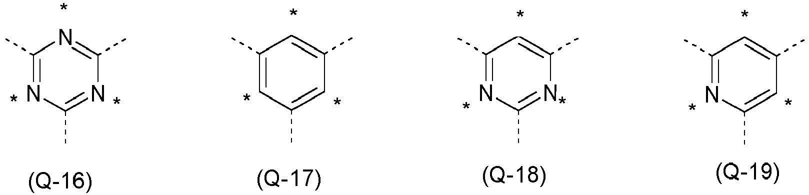 where the dashed bond in each case indicates the linking within the formula (1) or (2), * marks the position at which this group is coordinated to M, and X and R have the meanings given in Claim 1.

4. Compound according to one or more of Claims 1 to 3, **characterised in that** the group of the formula (3) is selected from the structures of the formulae (6) to (9), 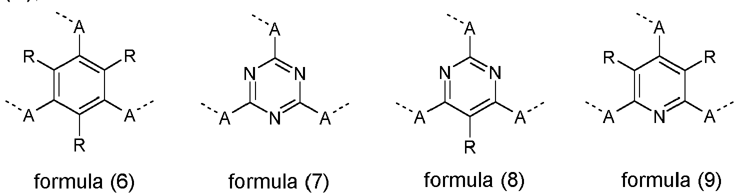 where the symbols have the meanings given in Claim 1.

5. Compound according to one or more of Claims 1 to 4, **characterised in that** the group of the formula (3) has a structure of the formula (6'), 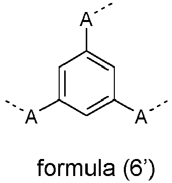 wh formula (12) ols have the meanings given in Claim 1.

6. Compound according to one or more of Claims 1 to 5, **characterised in that** A is selected, identically or differently on each occurrence, from the group consisting of -C(=O)-O-, -C(=O)-NR'- or a group of the formula (5), where the group of the formula (5) is selected from the structures of the formulae (15) to (39), 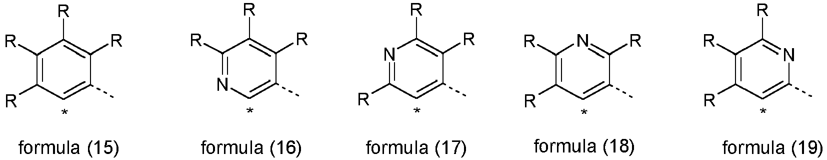 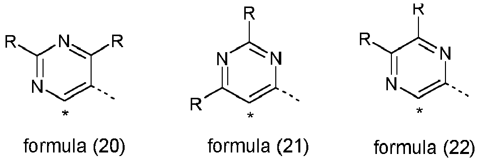 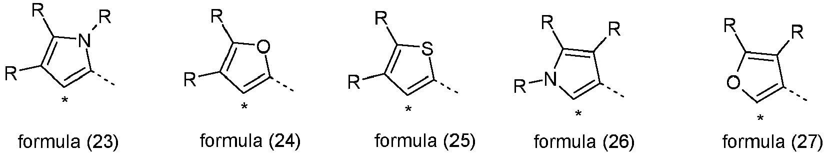 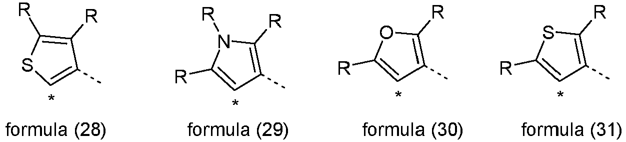 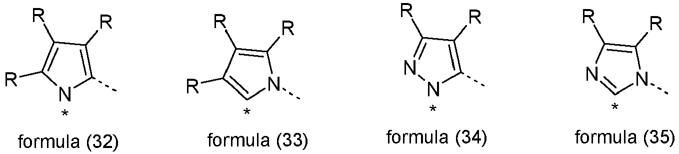 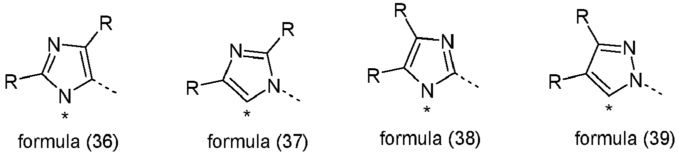 where the symbols have the meanings given in Claim 1.

7. Compound according to one or more of Claims 1 to 6, **characterised in that** the group of the formula (3) is selected from the formulae (3a) to (3m) and the group of the formula (4) is selected from the formulae (4a) to (4m), 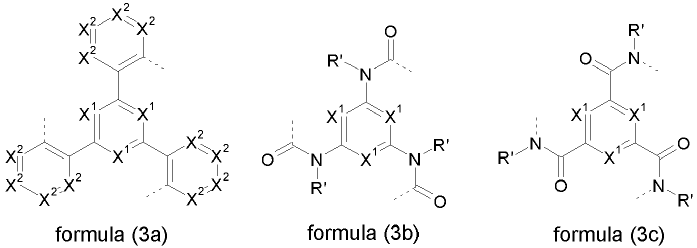 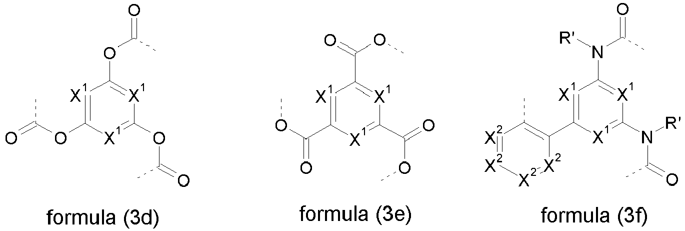 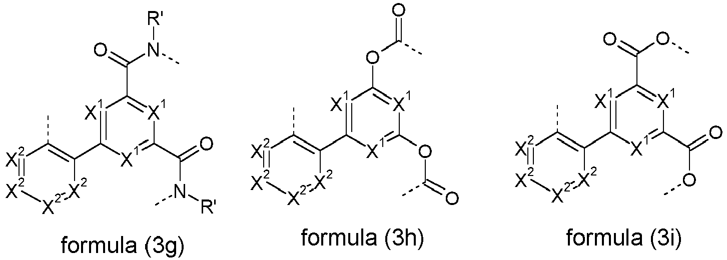 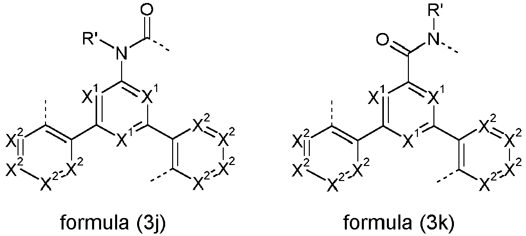 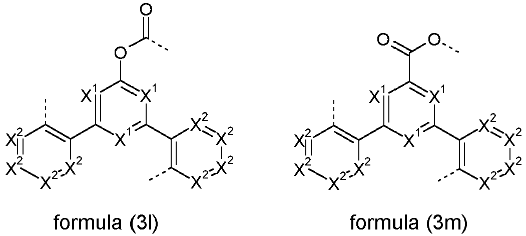 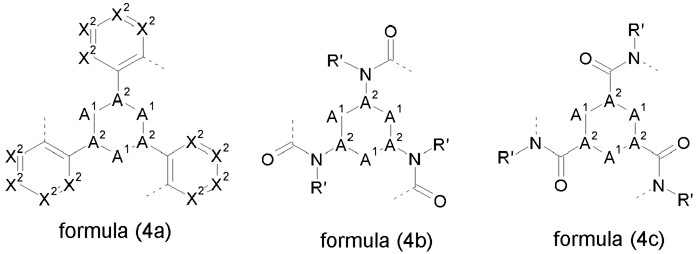 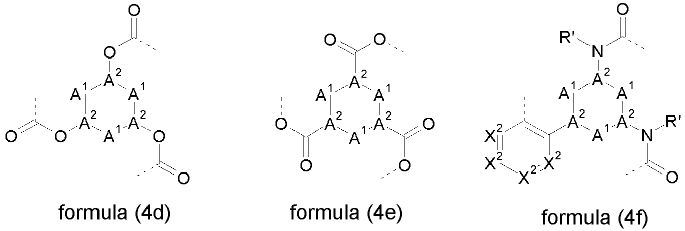 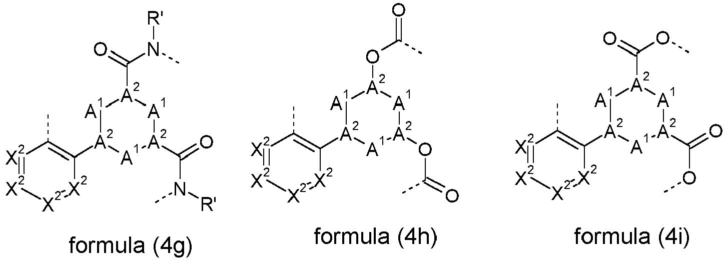 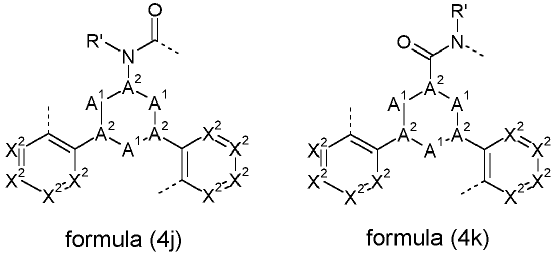 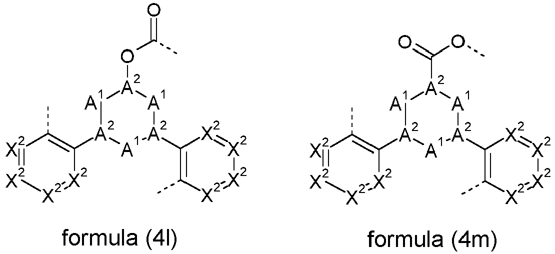 where the symbols have the meanings given in Claim 1.

8. Compound according to one or more of Claims 1 to 7, **characterised in that** the group of the formula (3) is a group of the formula (6a'"), 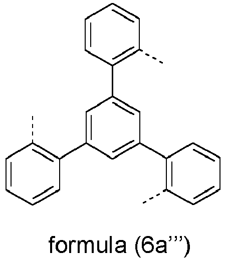 where the symbols have the meanings given in Claim 1.

9. Compound according to one or more of Claims 1 to 8, **characterised in that** all four part-ligands L for p = 0 or all six part-ligands L for p = 1 are identical and are identically substituted.

10. Process for the preparation of a compound according to one or more of Claims 1 to 9 by reaction of the free ligand with metal alcoholates of the formula (58), with metal ketoketonates of the formula (59), with metal halides of the formula (60) or with metal carboxylates of the formula (61) or with iridium or rhodium compounds which carry both alcoholate and/or halide and/or hydroxyl radicals as well as ketoketonate radicals, 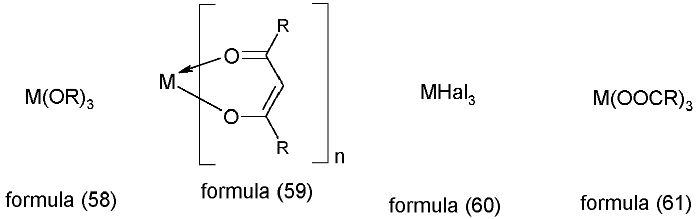 where M and R have the meanings indicated in Claim 1, Hal = F, Cl, Br or I and the iridium or rhodium starting materials may also be in the form of the corresponding hydrates.

11. Mixture comprising at least one compound according to one or more of Claims 1 to 9 and at least one further compound, in particular a host material.

12. Formulation comprising at least one compound according to one or more of Claims 1 to 9 or at least one mixture according to Claim 11 and at least one solvent.

13. Use of a compound according to one or more of Claims 1 to 9 or a mixture according to Claim 11 in an electronic device or as oxygen sensitiser.

14. Electronic device containing at least one compound according to one or more of Claims 1 to 9 or at least one mixture according to Claim 11.

15. Electronic device according to Claim 14, which is an organic electroluminescent device, **characterised in that** the compound according to one or more of Claims 1 to 9 is employed as emitting compound in one or more emitting layers.

## Revendications

1. Composé de la formule (1) ou de la formule (2), 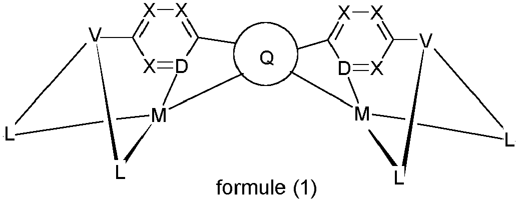 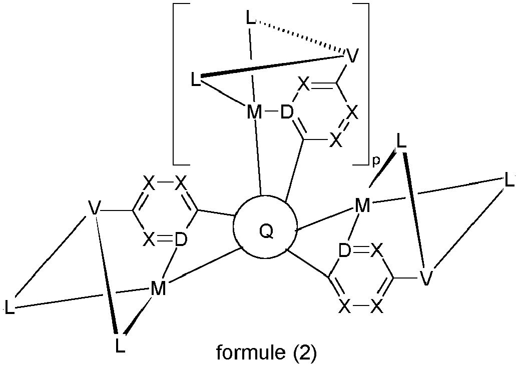 dans lesquelles ce qui suit s'applique aux symboles et aux indices qui sont utilisés :
M est pour chaque occurrence, de manière identique ou différente, iridium ou rhodium ;
Q est un groupe aryle ou hétéroaryle qui comporte de 6 à 10 atomes de cycle aromatique, lequel est coordonné, de manière identique ou différente, vis-à-vis de chacun des deux ou trois M via dans chaque cas un atome de carbone ou d'azote et lequel peut être substitué par un radical ou par plusieurs radicaux R ; les atomes de coordination dans Q ne sont pas liés à la position ortho les uns aux autres ;
D est pour chaque occurrence, de manière identique ou différente, C ou N ;
X est identique ou différent pour chaque occurrence et est CR ou N ; p est 0 ou 1 ;
V est pour chaque occurrence, de manière identique ou différente, un groupe de la formule (3) ou (4), 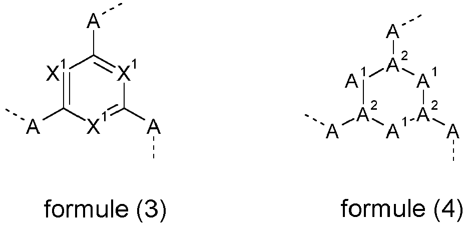 dans lesquelles l'une des liaisons en pointillés représente la liaison sur le groupe cyclique aryle ou hétéroaryle à 6 éléments correspondant qui est représenté selon la formule (1) ou (2) et les deux autres liaisons en pointillés représentent dans chaque cas les liaisons sur les ligands partiels L ;
L est pour chaque occurrence, de manière identique ou différente, un ligand partiel monoanionique bidenté qui est sélectionné parmi les structures des formules (L-1), (L-2) ou (L-3), 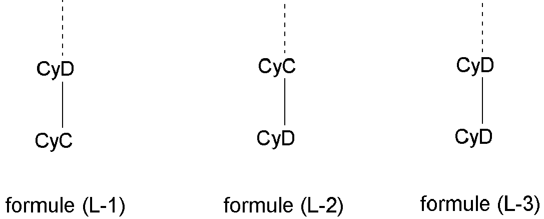 dans lesquelles la liaison en pointillés représente la liaison depuis le ligand partiel L sur le groupe de la formule (3) ou (4) et ce qui suit s'applique aux autres symboles qui sont utilisés :
CyC est, de manière identique ou différente pour chaque occurrence, un groupe aryle ou hétéroaryle substitué ou non substitué qui comporte de 5 à 14 atomes de cycle aromatique, lequel est coordonné vis-à-vis de M via un atome de carbone et lequel est lié à CyD via une liaison covalente ;
CyD est, de manière identique ou différente pour chaque occurrence, un groupe hétéroaryle substitué ou non substitué qui comporte de 5 à 14 atomes de cycle aromatique, lequel est coordonné vis-à-vis de M via un atome d'azote et lequel est lié à CyC via une liaison covalente ;
les substituants d'une pluralité des substituants optionnels peuvent former un système de cycle les uns avec les autres ;
X¹ est pour chaque occurrence, de manière identique ou différente, CR ou N ;
A¹ est pour chaque occurrence, de manière identique ou différente, C(R)₂ ;
A² est pour chaque occurrence, de manière identique ou différente, CR ;
A est pour chaque occurrence, de manière identique ou différente, -CR=CR-, -C(=O)-NR'-, -C(=O)-O-, -CR₂-CR₂-, -CR₂-O- ou un groupe de la formule (5), 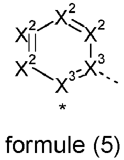 dans laquelle la liaison en pointillés représente la position de la liaison depuis un ligand partiel bidenté L ou le groupe cyclique aryle ou hétéroaryle à 6 éléments correspondant dans la formule (1) ou (2) jusqu'à cette structure et * représente la position du lien de l'unité de la formule (5) sur le groupe cyclique central qui est représenté de façon explicite selon la formule (3) ou (4) ;
X² est pour chaque occurrence, de manière identique ou différente, CR ou N ou deux groupes adjacents X² représentent en association NR, O ou S, de telle sorte qu'un cycle à 5 éléments soit formé, et les X² restants représentent, de manière identique ou différente pour chaque occurrence, CR ou N ; ou deux groupes adjacents X² représentent en association CR ou N si l'un des groupes X³ dans le cycle représente N, de telle sorte qu'un cycle à 5 éléments soit formé ; étant entendu qu'un maximum de deux groupes adjacents X² représentent N ;
X³ est pour chaque occurrence C, ou un groupe X³ représente N et l'autre groupe X³ dans le même cycle représente C ; étant entendu que deux groupes adjacents X² représentent en association CR ou N si l'un des groupes X³ dans le cycle représente N ;
R est pour chaque occurrence, de manière identique ou différente, H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)², S(=O)^{R1}, S(=O)₂R¹, OSO₂R¹, COO(cation), SO₃(cation), OSO₃(cation), OPO₃(cation), O(cation), N(R¹)₃(anion), P(R¹)₃(anion), un groupe alkyle en chaîne droite qui comporte de 1 à 20 atome(s) de C ou un groupe alkényle ou alkynyle qui comporte de 2 à 20 atomes de C ou un groupe alkyle ramifié ou cyclique qui comporte de 3 à 20 atomes de C, où le groupe alkyle, alkényle ou alkynyle peut dans chaque cas être substitué par un radical ou par plusieurs radicaux R¹, où un ou plusieurs groupe(s) CH₂ non adjacents peut/peuvent être remplacé(s) par Si(R¹)₂, C=O, NR¹, O, S, ou CONR¹, ou un système de cycle aromatique ou hétéroaromatique qui comporte de 5 à 40 atomes de cycle aromatique, lequel peut dans chaque cas être substitué par un radical ou par plusieurs radicaux R¹ ; deux radicaux R peuvent également former un système de cycle l'un avec l'autre ;
R' est pour chaque occurrence, de manière identique ou différente, H, D, un groupe alkyle en chaîne droite qui comporte de 1 à 20 atome(s) de C ou un groupe alkyle ramifié ou cyclique qui comporte de 3 à 20 atomes de C, où le groupe alkyle peut dans chaque cas être substitué par un radical ou par plusieurs radicaux R¹ et où un ou plusieurs groupe(s) CH₂ non adjacents peut/ peuvent être remplacé(s) par Si(R¹)₂, ou un système de cycle aromatique ou hétéroaromatique qui comporte de 5 à 40 atomes de cycle aromatique, lequel peut dans chaque cas être substitué par un radical ou par plusieurs radicaux R¹ ;
R¹ est pour chaque occurrence, de manière identique ou différente, H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², COO(cation), SO₃(cation), OSO₃(cation), OPO₃(cation), O(cation), N(R¹)₃(anion), P(R¹)₃(anion), un groupe alkyle en chaîne droite qui comporte de 1 à 20 atome(s) de C ou un groupe alkényle ou alkynyle qui comporte de 2 à 20 atomes C ou un groupe alkyle ramifié ou cyclique qui comporte de 3 à 20 atomes de C, où le groupe alkyle, alkényle ou alkynyle peut dans chaque cas être substitué par un radical ou par plusieurs radicaux R², où un ou plusieurs groupe(s) CH₂ non adjacents peut/peuvent être remplacé(s) par Si(R²)₂, C=O, NR², O, S ou CONR², ou un système de cycle aromatique ou hétéroaromatique qui comporte de 5 à 40 atomes de cycle aromatique, lequel peut dans chaque cas être substitué par un radical ou par plusieurs radicaux R² ; deux radicaux R¹ ou plus peuvent former un système de cycle l'un avec l'autre ou les uns avec les autres ;
R² est pour chaque occurrence, de manière identique ou différente, parmi H, D, F ou un radical organique aliphatique, aromatique ou hétéroaromatique, en particulier un radical hydrocarbone, qui comporte de 1 à 20 atome(s) de C, où, en outre, un ou plusieurs atome(s) de H peut/peuvent être remplacé(s) par F ;
cation est sélectionné pour chaque occurrence, de manière identique ou différente, parmi le groupe qui est constitué par les protons, les deutérons, les ions de métaux alcalins, les ions de métaux alcalino-terreux, l'ammonium, le tétraalkylammonium et le tétraalkylphosphonium ;
anion est sélectionné pour chaque occurrence, de manière identique ou différente, parmi le groupe qui est constitué par les halogénures, les carboxylates R²-COO⁻, le cyanure, le cyanate, l'isocyanate, le thiocyanate, le thioisocyanate, l'hydroxyde, le BF₄⁻, le PF₆⁻, le B(C₆F₅)₄⁻, le carbonate et les sulfonates.

2. Composé selon la revendication 1, sélectionné parmi les composés des formules (1a) et (2a), 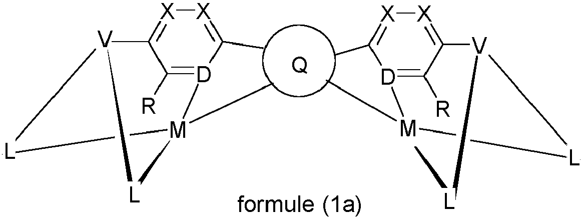 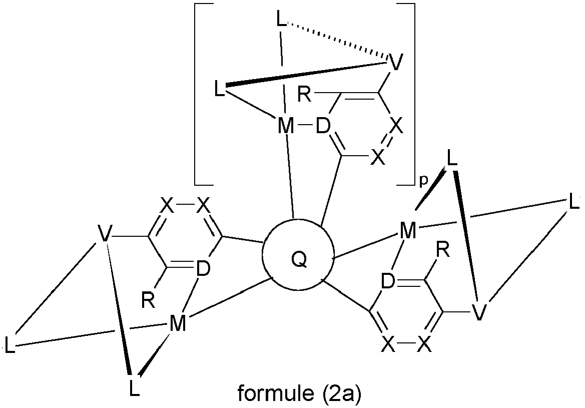 dans lesquelles le radical R qui est représenté de façon explicite à la position ortho par rapport à D est dans chaque cas sélectionné, de manière identique ou différente pour chaque occurrence, parmi le groupe qui est constitué par H, D, F, CH₃ et CD₃ et les autres symboles et les autres indices qui sont utilisés présentent les significations qui ont été données selon la revendication 1.

3. Composé selon la revendication 1 ou 2, **caractérisé en ce que** Q dans la formule (1) représente un groupe de l'une des formules (Q-1) à (Q3) et dans la formule (2), représente un groupe de l'une des formules (Q-4) à (Q-15) pour p = 0 ou un groupe des formules (Q-16) à (Q-19) pour p = 1, 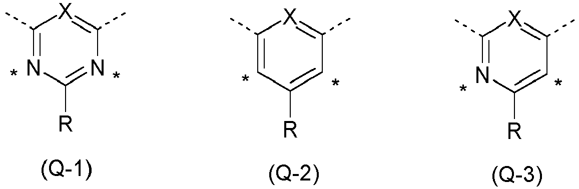 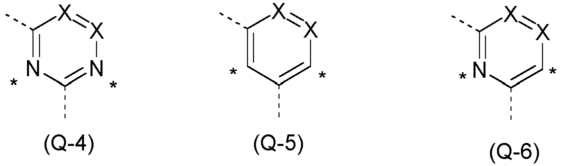 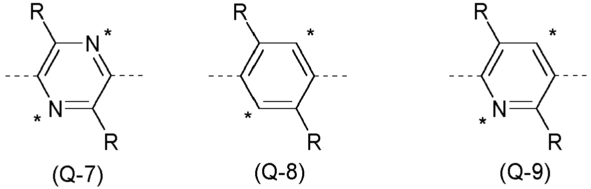 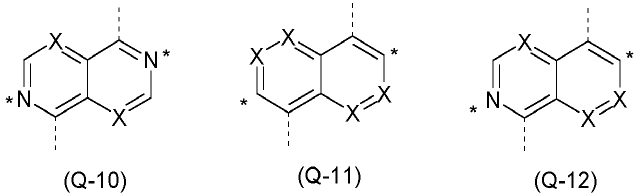 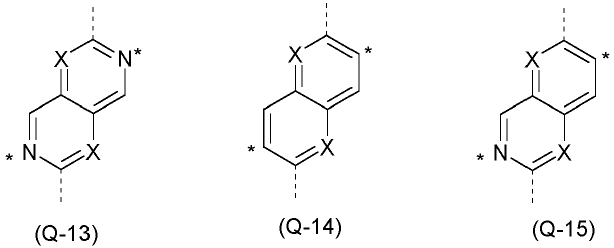 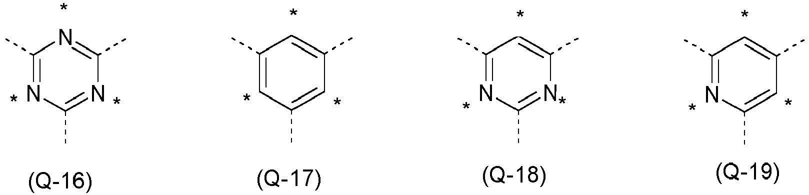 dans lesquelles la liaison en pointillés indique dans chaque cas le lien à l'intérieur de la formule (1) ou (2), * permet de repérer la position au niveau de laquelle ce groupe est coordonné vis-à-vis de M, et X et R présentent les significations qui ont été données selon la revendication 1.

4. Composé selon une ou plusieurs des revendications 1 à 3, **caractérisé en ce que** le groupe de la formule (3) est sélectionné parmi les structures des formules (6) à (9), 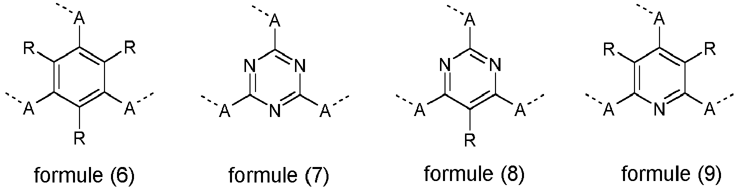 dans lesquelles les symboles présentent les significations qui ont été données selon la revendication 1.

5. Composé selon une ou plusieurs des revendications 1 à 4, **caractérisé en ce que** le groupe de la formule (3) présente une structure de la formule (6'), 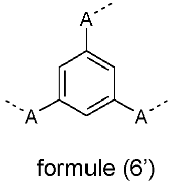 dans laquelle les symboles présentent les significations qui ont été données selon la revendication 1.

6. Composé selon une ou plusieurs des revendications 1 à 5, **caractérisé en ce que** A est sélectionné, de manière identique ou différente pour chaque occurrence, parmi le groupe qui est constitué par -C(=O)-O-, -C(=O)-NR'- ou un groupe de la formule (5), où le groupe de la formule (5) est sélectionné parmi les structures des formules (15) à (39), 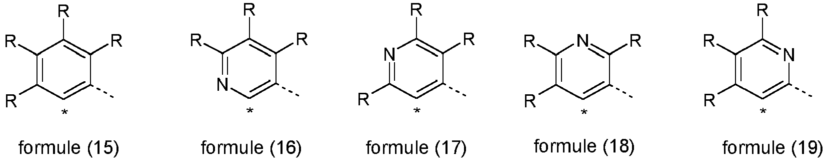 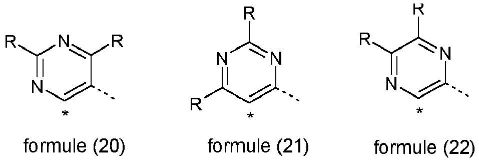 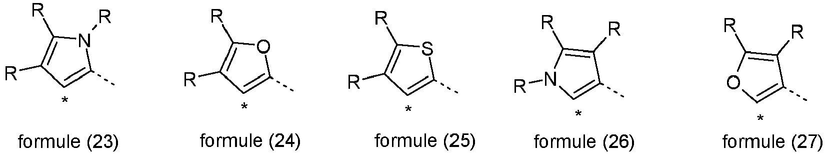 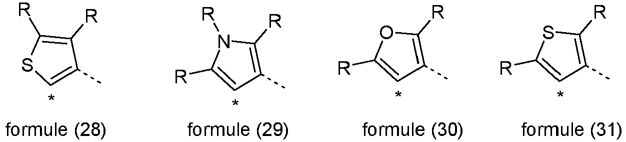 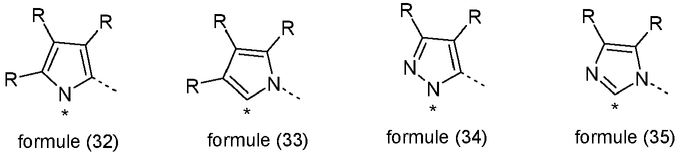 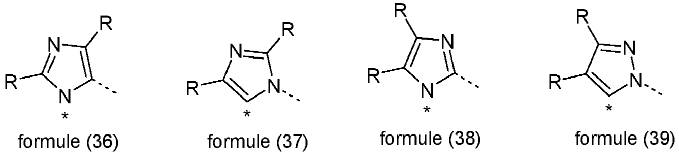 dans lesquelles les symboles présentent les significations qui ont été données selon la revendication 1.

7. Composé selon une ou plusieurs des revendications 1 à 6, **caractérisé en ce que** le groupe de la formule (3) est sélectionné parmi les formules (3a) à (3m) et le groupe de la formule (4) est sélectionné parmi les formules (4a) à (4m), 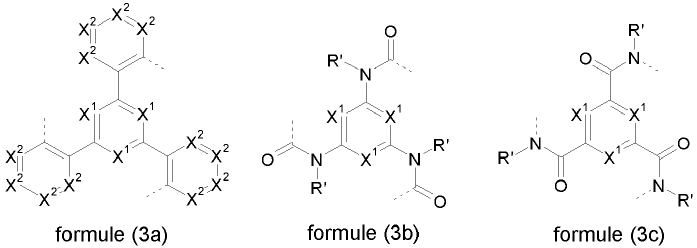 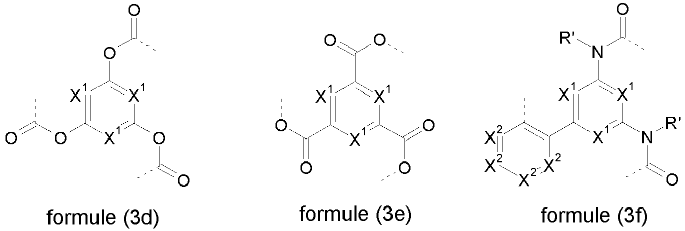 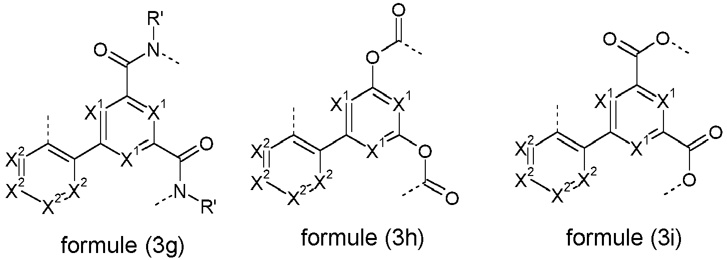 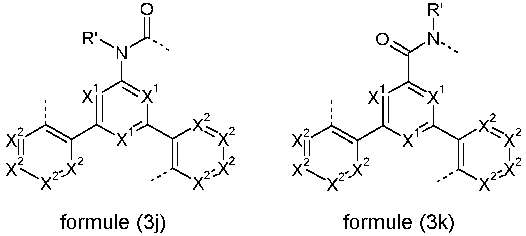 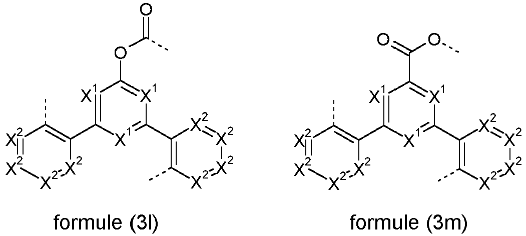 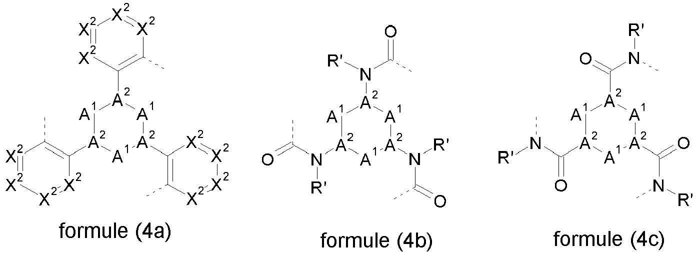 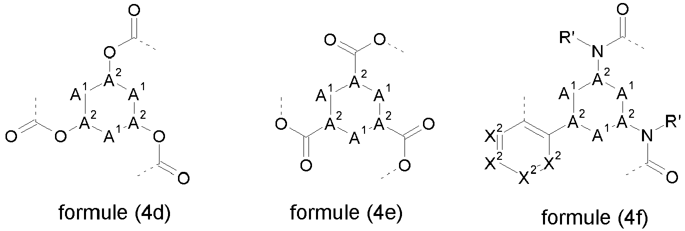 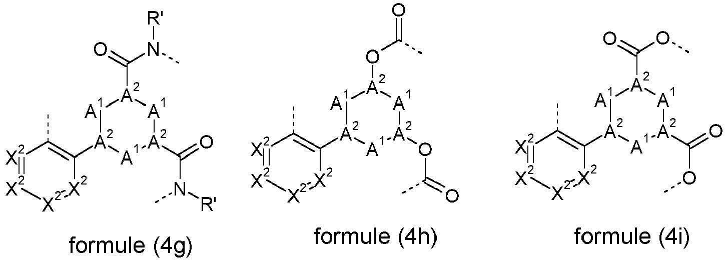 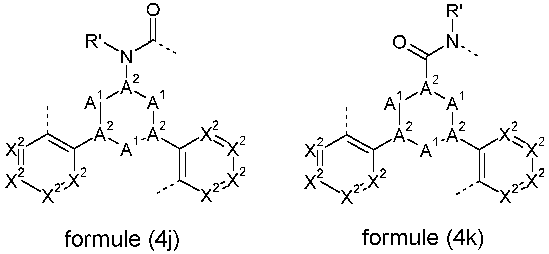 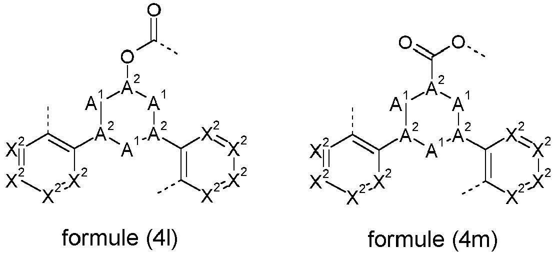 dans lesquelles les symboles présentent les significations qui ont été données selon la revendication 1.

8. Composé selon une ou plusieurs des revendications 1 à 7, **caractérisé en ce que** le groupe de la formule (3) est un groupe de la formule (6a"'), 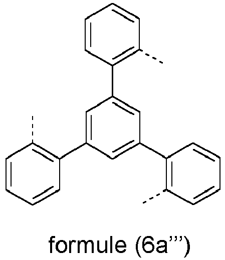 dans laquelle les symboles présentent les significations qui ont été données selon la revendication 1.

9. Composé selon une ou plusieurs des revendications 1 à 8, **caractérisé en ce que** les quatre ligands partiels L pour p = 0 ou les six ligands partiels L pour p = 1 sont tous identiques et sont tous substitués de manière identique.

10. Procédé pour la préparation d'un composé selon une ou plusieurs des revendications 1 à 9 par réaction du ligand libre avec des alcoolates métalliques de la formule (58), avec des cétocétonates métalliques de la formule (59), avec des halogénures métalliques de la formule (60) ou avec des carboxylates métalliques de la formule (61) ou avec des composés d'iridium ou de rhodium, lesquels sont porteurs à la fois de radicaux alcoolate et/ou halogénure et/ou hydroxyle de même que de radicaux cétocétonate, 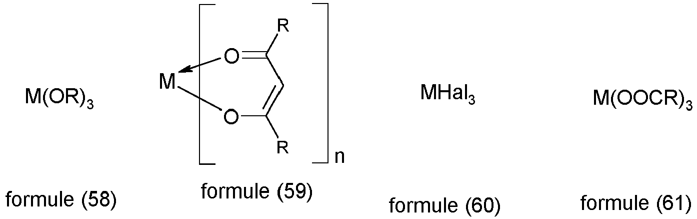 dans lesquelles M et R présentent les significations qui ont été indiquées selon la revendication 1, Hal = F, Cl, Br ou I et les matériaux de départ à base d'iridium ou de rhodium peuvent également être sous la forme des hydrates correspondants.

11. Mélange comprenant au moins un composé selon une ou plusieurs des revendications 1 à 9 et au moins un autre composé, en particulier un matériau hôte.

12. Formulation comprenant au moins un composé selon une ou plusieurs des revendications 1 à 9 ou au moins un mélange selon la revendication 11 et au moins un solvant.

13. Utilisation d'un composé selon une ou plusieurs des revendications 1 à 9 ou d'un mélange selon la revendication 11 dans un dispositif électronique ou en tant que moyen de sensibilisation à l'oxygène.

14. Dispositif électronique contenant au moins un composé selon une ou plusieurs des revendications 1 à 9 ou au moins un mélange selon la revendication 11.

15. Dispositif électronique selon la revendication 14, lequel est un dispositif électroluminescent organique, **caractérisé en ce que** le composé selon une ou plusieurs des revendications 1 à 9 est utilisé en tant que composé d'émission dans une ou plusieurs couche(s) d'émission.
